# EUROPÄISCHE PATENTSCHRIFT

(11) **EP 3 254 317 B1**
(45) Veröffentlichungstag und Bekanntmachung des Hinweises auf die Patenterteilung: **31.07.2019**
(21) Anmeldenummer: 16700140.3
(22) Anmeldetag: 07.01.2016
(51) Int. Cl.: H01L 51/50, C07F 15/00, C07F 15/02, C07F 15/06

(54) **METALLKOMPLEXE**
METAL COMPLEXES
COMPLEXES MÉTALLIQUES

(30) Priorität: 03.02.2015 EP 15000307
(43) Veröffentlichungstag der Anmeldung: 13.12.2017
(73) Patentinhaber: Merck Patent GmbH, 64293 Darmstadt (DE)
(72) Erfinder: STOESSEL, Philipp, 60389 Frankfurt am Main (DE); KOENEN, Nils, 64347 Griesheim (DE); HARBACH, Philipp, 64367 Muehltal (DE); EHRENREICH, Christian, 64285 Darmstadt (DE)
(86) Internationale Anmeldenummer: PCT/EP2016/000010
(87) Internationale Veröffentlichungsnummer: WO 2016/124304

(56) Entgegenhaltungen:
- WO-A1-2012/013271
- STILBRANY ET AL.: "A Tris(pyrazolyl) eta6-Arene Ligand That Selects Cu(I) over Cu(II)", INORGANIC CHEMISTRY, Bd. 45, Nr. 24, 2008, Seiten 9713-9720, XP002755868,

## Beschreibung

Die vorliegende Erfindung betrifft Metallkomplexe, welche sich für den Einsatz in organischen Elektrolumineszenzvorrichtungen, insbesondere als Emitter, eignen.

Gemäß dem Stand der Technik werden in phosphoreszierenden organischen Elektrolumineszenzvorrichtungen (OLEDs) als Triplettemitter vor allem Iridiumkomplexe eingesetzt, insbesondere bis- und tris-ortho-metallierte Komplexe mit aromatischen Liganden, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenyl-pyridyl)iridium(III) und Derivate davon (z. B. gemäß US 2002/0034656 oder WO 2010/027583). Aus der Literatur ist eine Vielzahl verwandter Liganden und Iridiumkomplexe bekannt, wie beispielsweise Komplexe mit 1- oder 3-Phenylisochinolinliganden (z. B. gemäß EP 1348711 oder WO 2011/028473), mit 2-Phenyl-chinolinen (z. B. gemäß WO 2002/064700 oder WO 2006/095943) oder mit Phenyl-carbenen (z. B. gemäß WO 2005/019373).

Eine Verbesserung der Stabilität der Komplexe konnte durch die Verwendung polypodaler Liganden erreicht werden, wie beispielsweise in WO 2004/081017, WO 2006/008069 oder US 7,332,232 beschrieben. Auch wenn diese Komplexe mit polypodalen Liganden Vorteile gegenüber den Komplexen zeigen, die ansonsten die gleiche Ligandenstruktur aufweisen, deren einzelne Liganden jedoch nicht polypodal verbrückt sind, gibt es jedoch auch noch Verbesserungsbedarf. Dieser liegt insbesondere in der aufwändigeren Synthese der Verbindungen, so dass beispielsweise die Komplexierungsreaktion sehr lange Reaktionszeiten und hohe Reaktionstemperaturen erfordert. Weiterhin sind auch bei den Komplexen mit polypodalen Liganden noch Verbesserungen in Bezug auf die Eigenschaften bei Verwendung in einer organischen Elektrolumineszenzvorrichtung, insbesondere in Bezug auf Effizienz, Spannung und/oder Lebensdauer, wünschenswert. Aus WO 2012/013271 sind Komplexe mit Imidazoisochinolin und verwandten Strukturen als Ligand bekannt, wobei auch mehrere der Liganden miteinander verknüpft sein können und so ein hexadentates Ligandensystem aufspannen können. Komplexe, in denen die Liganden über eine Gruppe der Formel (1) miteinander verknüpft sind, sind nicht offenbart.

Aufgabe der vorliegenden Erfindung ist daher die Bereitstellung neuer Metallkomplexe, welche sich als Emitter für die Verwendung in OLEDs eignen. Insbesondere ist die Aufgabe, Emitter bereitzustellen, welche verbesserte Eigenschaften in Bezug auf Effizienz, Betriebsspannung und/oder Lebensdauer zeigen. Weiterhin ist es die Aufgabe der vorliegenden Erfindung, Metallkomplexe bereitzustellen, deren Synthese bei milderen Synthesebedingungen, insbesondere in Bezug auf Reaktionsdauer und Reaktionstemperatur, durchgeführt werden kann, jeweils verglichen mit Komplexen, die strukturell vergleichbare Liganden aufweisen. Weiterhin ist es die Aufgabe der vorliegenden Erfindung, Metallkomplexe bereitzustellen, die keine facial-meridional-Isomerisierung zeigen, was bei Komplexen gemäß dem Stand der Technik ein Problem darstellen kann.

Überraschend wurde gefunden, dass Metallkomplexe mit einem hexadentaten tripodalen Liganden, wobei die Brücke des Liganden, die die einzelnen Teilliganden verknüpft, die nachfolgend beschriebene Struktur aufweist, diese Aufgabe lösen und sich sehr gut für die Verwendung in einer organischen Elektrolumineszenzvorrichtung eignen. Diese Metallkomplexe und organische Elektrolumineszenzvorrichtungen, welche diese Komplexe enthalten, sind daher der Gegenstand der vorliegenden Erfindung.

Gegenstand der Erfindung ist somit ein monometallischer Metallkomplex enthaltend einen hexadentaten tripodalen Liganden, in dem drei bidentate Teilliganden an ein Metall koordinieren und die drei bidentaten Teilliganden, die gleich oder verschieden sein können, über eine Brücke der folgenden Formel (1) verknüpft sind: 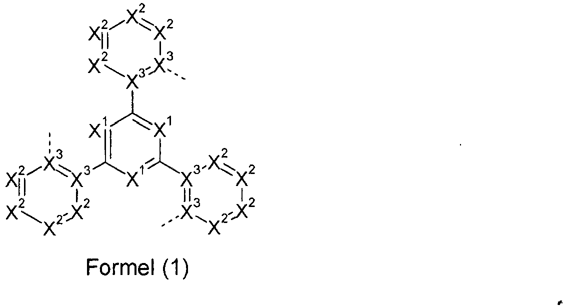 wobei die gestrichelte Bindung die Bindung der bidentaten Teilliganden an diese Struktur darstellt und für die verwendeten Symbole gilt:
- X¹: ist bei jedem Auftreten gleich oder verschieden C, welches auch substituiert sein kann, oder N;
- X²: ist bei jedem Auftreten gleich oder verschieden C, welches auch substituiert sein kann, oder N oder zwei benachbarte Gruppen X² stehen zusammen für N, welches auch substituiert sein kann, O oder S, so dass ein Fünfring entsteht; oder zwei benachbarte Gruppen X² stehen zusammen für C, welches auch substituiert sein kann, oder N, wenn in dem Cyclus eine der Gruppen X³ für N steht, so dass ein Fünfring entsteht; mit der Maßgabe, dass maximal zwei benachbarte Gruppen X² in jedem Ring für N stehen; dabei können gegebenenfalls vorhandene Substituenten auch miteinander oder mit Substituenten, die an X¹ gebunden sind, ein Ringsystem bilden;
- X³: ist bei jedem Auftreten in einem Cyclus C oder eine Gruppe X³ steht für N und die andere Gruppe X³ in demselben Cyclus steht für C; dabei können die Gruppen X³ in den drei Cyclen unabhängig voneinander gewählt werden; mit der Maßgabe, dass zwei benachbarte Gruppen X² zusammen für C, welches auch substituiert sein kann, oder N stehen, wenn in dem Cyclus eine der Gruppen X³ für N steht;
dabei können die drei bidentaten Liganden außer durch die Brücke der Formel (1) auch noch durch eine weitere Brücke zu einem Kryptat geschlossen sein.

Wenn X¹ oder X² für C steht, dann trägt dieses C-Atom entweder ein Wasserstoffatom, oder es ist substituiert mit einem Substituenten ungleich Wasserstoff. Wenn zwei benachbarte Gruppen X² zusammen für N stehen und die Gruppen X³ in demselben Cyclus beide für C stehen, dann trägt dieses N-Atom entweder ein Wasserstoffatom oder es ist substituiert mit einem Substituenten ungleich Wasserstoff. Bevorzugt ist das N-Atom substituiert mit einem Substituenten ungleich Wasserstoff. Wenn zwei benachbarte Gruppen X² zusammen für N stehen und eine der Gruppen X³ in demselben Cyclus für N steht, dann ist das N-Atom, das für zwei benachbarte Gruppen X² steht, unsubstituiert.

Bei dem Liganden handelt es sich erfindungsgemäß somit um einen hexadentaten, tripodalen Liganden mit drei bidentaten Teilliganden. Die Struktur des hexadentaten, tripodalen Liganden wird schematisch durch die folgende Formel (Lig) dargestellt: 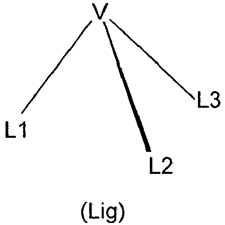 wobei V die Brücke gemäß Formel (1) darstellt und L1, L2 und L3 gleich oder verschieden bei jedem Auftreten jeweils bidentate Teilliganden darstellen. Dabei bedeutet bidentat, dass der jeweilige Teilligand im Komplex über zwei Koordinationsstellen an das Metall koordiniert bzw. bindet. Tripodal bedeutet, dass der Ligand drei Teilliganden aufweist, die an die Brücke V bzw. die Brücke der Formel (1) gebunden sind. Da der Ligand drei bidentate Teilliganden aufweist, ergibt sich insgesamt ein hexadentater Ligand, also ein Ligand, der über sechs Koordinationsstellen an das Metall koordiniert bzw. bindet. Der Begriff "bidentater Teilligand" bedeutet im Sinne dieser Anmeldung, dass es sich bei dieser Einheit um einen bidentaten Liganden handeln würde, wenn die Brücke der Formel (1) nicht vorhanden wäre. Durch die formale Abstraktion eines Wasserstoffatoms von diesem bidentaten Liganden und die Anknüpfung an die Brücke der Formel (1) ist dieser jedoch kein separater Ligand mehr, sondern ein Teil des so entstehenden hexadentaten Liganden, so dass hierfür der Begriff "Teilligand" verwendet wird.

Der mit diesem Liganden der Formel (Lig) gebildete Metallkomplex M-(Lig) kann somit schematisch durch die folgende Formel dargestellt werden: 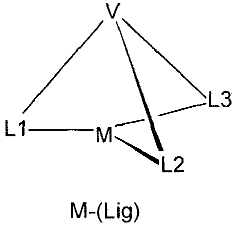 wobei V die Brücke gemäß Formel (1) darstellt, L1, L2 und L3 gleich oder verschieden bei jedem Auftreten jeweils bidentate Teilliganden darstellen und M für ein Metall steht.

Monometallisch im Sinne der vorliegenden Erfindung bedeutet, dass der Metallkomplex nur ein einziges Metallatom enthält, wie auch durch M-(Lig) schematisch dargestellt. Metallkomplexe, in denen beispielsweise jeder der drei bidentaten Teilliganden an ein anderes Metallatom koordiniert ist, sind somit nicht von der Erfindung umfasst.

Die Bindung des Liganden an das Metall kann sowohl eine Koordinationsbindung als auch eine kovalente Bindung sein bzw. der kovalente Anteil an der Bindung kann je nach Ligand und Metall variieren. Wenn in der vorliegenden Anmeldung die Rede davon ist, dass der Ligand bzw. der Teilligand an das Metall koordiniert oder bindet, so bezeichnet dies im Sinne der vorliegenden Anmeldung jede Art der Bindung von dem Liganden bzw. Teilliganden an das Metall, unabhängig vom kovalenten Anteil der Bindung.

Bevorzugt sind die erfindungsgemäßen Verbindungen dadurch gekennzeichnet, dass diese nicht geladen, d. h. elektrisch neutral, sind. Dies wird auf einfache Weise dadurch erreicht, dass die Ladungen der drei bidentaten Teilliganden so gewählt werden, dass sie die Ladung des komplexierten Metallatoms kompensieren.

Im Folgenden werden bevorzugte Ausführungsformen der Brücke der Formel (1) ausgeführt.

Wenn X¹ bzw. X² für ein substituiertes Kohlenstoffatom stehen bzw. wenn zwei benachbarte Gruppen X² für ein substituiertes Stickstoffatom bzw. ein substituiertes Kohlenstoffatom stehen, dann ist der Substituent bevorzugt ausgewählt aus den folgenden Substituenten R:
- R: ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können, oder ein aromatisches oder heteroaromatisches Ring-system mit 5 bis 40 aromatischen Ringatomen, das jeweils durch einen oder mehrere Reste R¹ substituiert sein kann, oder eine Aryloxy- oder Heteroaryloxygruppe mit 5 bis 40 aromatischen Ring-atomen, die durch einen oder mehrere Reste R¹ substituiert sein kann; dabei können zwei Reste R auch miteinander ein Ringsystem bilden;
- R¹: ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann, oder eine Aryloxy- oder Heteroaryl-oxygruppe mit 5 bis 40 aromatischen Ringatomen, die durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer und/oder heteroaromatischer organischer Rest, insbesondere ein Kohlenwasserstoffrest, mit 1 bis 20 C-Atomen, in dem auch ein oder mehrere H-Atome durch F ersetzt sein können.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können diese Reste, die miteinander ein Ringsystem bilden, benachbart sein, d.h. dass diese Reste an dasselbe Kohlenstoffatom oder an Kohlenstoffatome, die direkt aneinander gebunden sind, gebunden sind, oder sie können weiter voneinander entfernt sein. So ist beispielsweise auch die Ringbildung eines Restes R, der an der Gruppe X² gebunden ist, mit einem Rest R, der an der Gruppe X¹ gebunden ist, möglich. Wenn eine solche Ringbildung zwischen einem Rest R, der an der Gruppe X² gebunden ist, mit einem Rest R, der an der Gruppe X¹ gebunden ist, erfolgt, so erfolgt diese Ringbildung bevorzugt durch eine Gruppe mit drei Brückenatomen, bevorzugt mit drei Kohlenstoffatomen und besonders bevorzugt durch eine Gruppe -(CR₂)₃-. Wie eine solche Ringbildung erfolgen kann, kann beispielsweise den Synthesebeispielen entnommen werden.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

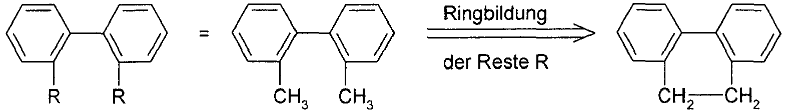

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

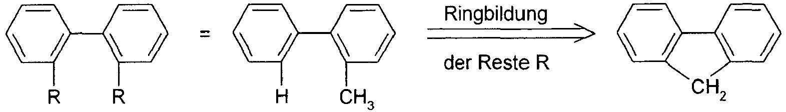

Wie oben beschrieben, kann diese Ringbildung an Resten erfolgen, die an direkt aneinander gebundene Kohlenstoffatome gebunden sind, oder an Resten, die an weiter entfernt liegende Kohlenstoffatome gebunden sind. Bevorzugt ist eine solche Ringbildung aber bei Resten, die an direkt aneinander gebundene Kohlenstoffatome gebunden sind.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei enthält die Heteroarylgruppe bevorzugt maximal drei Heteroatome. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Geeignete Ausführungsformen der Gruppe der Formel (1) sind die Strukturen der folgenden Formeln (2) bis (5), 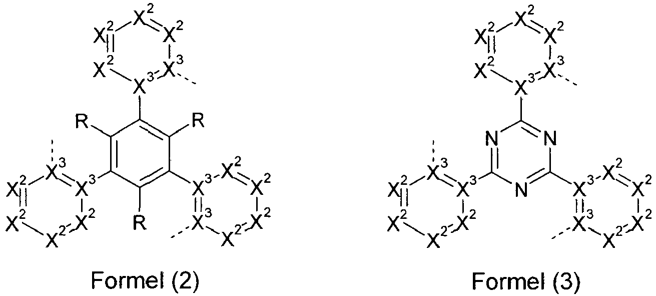 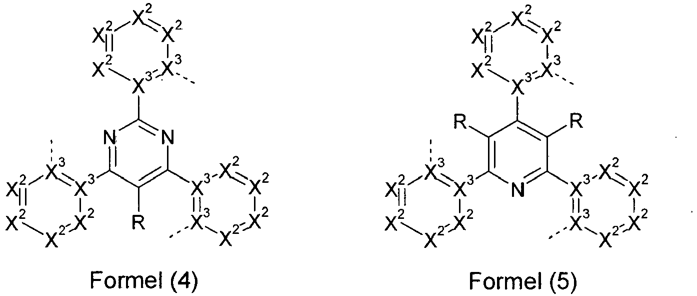 wobei die verwendeten Symbole die oben genannten Bedeutungen aufweisen.

In einer bevorzugten Ausführungsform der Erfindung stehen entweder alle Gruppen X¹ in der Gruppe der Formel (1) für ein gegebenenfalls substituiertes Kohlenstoffatom, wobei der Substituent bevorzugt ausgewählt ist aus den oben genannten Gruppen R, so dass der zentrale trivalente Cyclus der Formel (1) ein Benzol darstellt. Besonders bevorzugt stehen alle Gruppen X¹ in den Formeln (2), (4) und (5) für CH. In einer weiteren bevorzugten Ausführungsform der Erfindung stehen alle Gruppen X¹ für ein Stickstoffatom, so dass der zentrale trivalente Cyclus der Formel (1) ein Triazin darstellt. Bevorzugte Ausführungsformen der Formel (1) sind somit die Strukturen der Formeln (2) und (3).

Für bevorzugte Reste R am trivalenten zentralen Benzolring der Formel (2) gilt:
- R: ist bei jedem Auftreten gleich oder verschieden H, D, F, CN, eine geradkettige Alkyl- oder Alkoxygruppe mit 1 bis 10 C-Atomen oder eine Alkenylgruppe mit 2 bis 10 C-Atomen oder eine verzweigte oder cyclische Alkyl- oder Alkoxygruppe mit 3 bis 10 C-Atomen, die jeweils mit einem oder mehreren Resten R¹ substituiert sein kann, bevorzugt aber unsubstituiert ist, oder ein aromatisches oder heteroaromatisches Ringsystem mit 5 bis 24 aromatischen Ringatomen, das jeweils durch einen oder mehrere Reste R¹ substituiert sein kann; dabei kann der Rest R auch mit einem Rest R an X² ein Ringsystem bilden;
- R¹: ist bei jedem Auftreten gleich oder verschieden H, D, F, CN, eine geradkettige Alkyl- oder Alkoxygruppe mit 1 bis 10 C-Atomen oder eine Alkenylgruppe mit 2 bis 10 C-Atomen oder eine verzweigte oder cyclische Alkyl- oder Alkoxygruppe mit 3 bis 10 C-Atomen, die jeweils mit einem oder mehreren Resten R² substituiert sein kann, bevorzugt aber unsubstituiert ist, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch F ersetzt sein können.

Für besonders bevorzugte Reste R am trivalenten zentralen Benzolring der Formel (2) gilt:
- R: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R¹ substituiert sein kann, bevorzugt aber unsubstituiert ist, oder ein aromatisches oder heteroaromatisches Ringsystem mit 6 bis 12 aromatischen Ringatomen, das jeweils durch einen oder mehrere Reste R¹ substituiert sein kann; dabei kann der Rest R auch mit einem Rest R an X² ein Ringsystem bilden;
- R¹: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R² substituiert sein kann, bevorzugt aber unsubstituiert ist, oder ein aromatisches oder heteroaromatisches Ringsystem mit 6 bis 12 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer oder aromatischer Kohlenwasserstoffrest mit 1 bis 12 C-Atomen.

Besonders bevorzugt ist die Struktur der Formel (2) eine Struktur der folgenden Formel (2'), 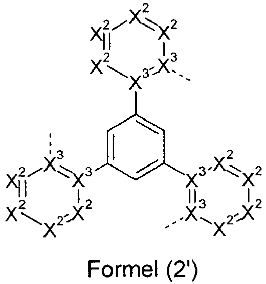 wobei die verwendeten Symbole die oben genannten Bedeutungen aufweisen.

Im Folgenden werden bevorzugte bivalente Arylen- bzw. Heteroaryleneinheiten beschrieben, wie sie in den Strukturen der Formeln (1) bis (5) vorkommen. Wie aus den Strukturen der Formeln (1) bis (5) ersichtlich, enthalten diese Strukturen drei ortho-verknüpfte bivalente Arylen- bzw. Heteroaryleneinheiten.

In einer bevorzugten Ausführungsform der Erfindung steht das Symbol X³ für C, so dass die Gruppen der Formeln (1) bis (5) durch die folgenden Formeln (1a) bis (5a) dargestellt werden können: 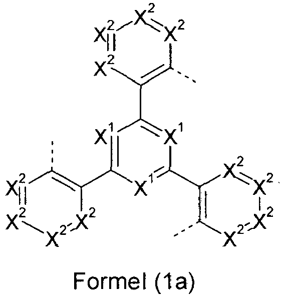 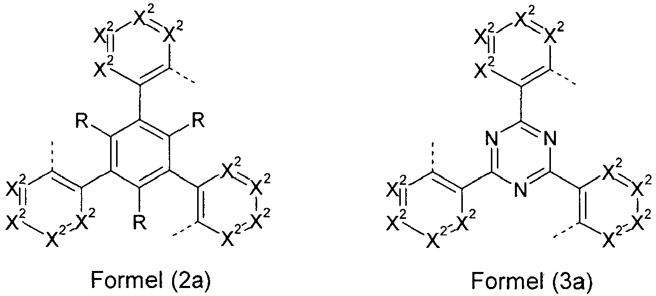 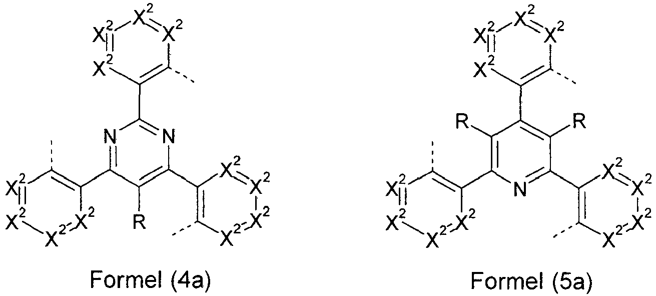 wobei die Symbole die oben aufgeführten Bedeutungen aufweisen.

Die Einheit der Formel (1) kann formal durch die folgende Formel (1') dargestellt werden, wobei die Formeln (1) und (1') dieselben Strukturen umfassen: 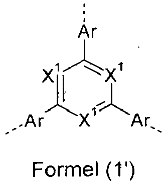 wobei Ar jeweils gleich oder verschieden für eine Gruppe der folgenden Formel (6) steht: 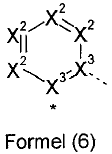 wobei die gestrichelte Bindung jeweils die Position der Bindung der bidentaten Teilliganden an diese Struktur darstellt, * die Position der Verknüpfung der Einheit der Formel (6) mit der zentralen trivalenten Aryl- bzw. Heteroarylgruppe darstellt und X² die oben genannten Bedeutungen aufweist. Dabei sind bevorzugte Substituenten an der Gruppe der Formel (6) ausgewählt aus den oben beschriebenen Substituenten R.

Die Gruppe der Formel (6) kann erfindungsgemäß einen heteroaromatischen Fünfring oder einen aromatischen oder heteroaromatischen Sechsring darstellen. In einer bevorzugten Ausführungsform der Erfindung enthält die Gruppe der Formel (6) maximal zwei Heteroatome in der Aryl- bzw. Heteroarylgruppe, besonders bevorzugt maximal ein Heteroatom. Dies schließt nicht aus, dass Substituenten, die gegebenenfalls an dieser Gruppe gebunden sind, auch Heteroatome enthalten können. Weiterhin schließt diese Definition nicht aus, dass durch die Ringbildung von Substituenten kondensierte aromatische oder heteroaromatische Strukturen entstehen, wie beispielsweise Naphthalin, Benzimidazol, etc.. Die Gruppe der Formel (6) ist somit bevorzugt ausgewählt aus Benzol, Pyridin, Pyrimidin, Pyrazin, Pyridazin, Pyrrol, Furan, Thiophen, Pyrazol, Imidazol, Oxazol und Thiazol.

Wenn beide Gruppen X³ in einem Cyclus für Kohlenstoffatome stehen, sind bevorzugte Ausführungsformen der Gruppe der Formel (6) die Strukturen der folgenden Formeln (7) bis (23), 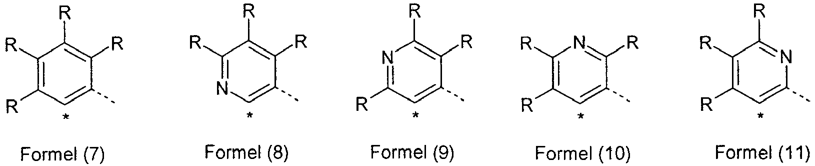 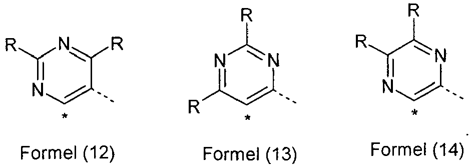 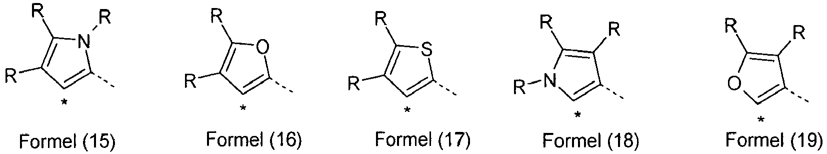 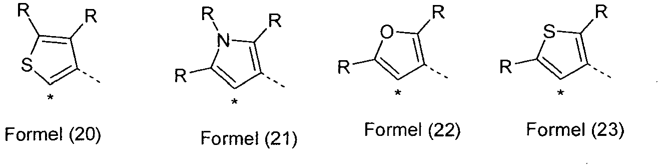 wobei die verwendeten Symbole die oben genannten Bedeutungen aufweisen.

Wenn eine Gruppe X³ in einem Cyclus für ein Kohlenstoffatom und die andere Grupp X³ in demselben Cyclus für ein Stickstoffatom steht, sind bevorzugte Ausführungsformen der Gruppe der Formel (6) die Strukturen der folgenden Formeln (24) bis (31), 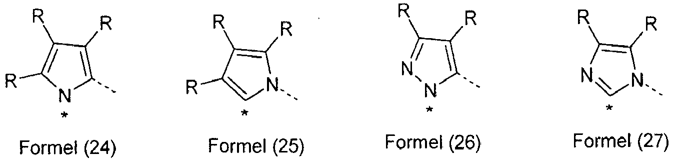 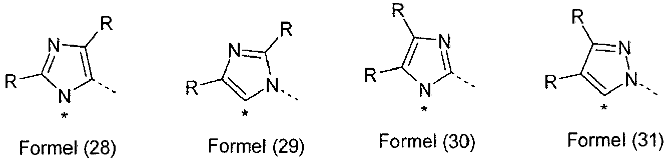 wobei die verwendeten Symbole die oben genannten Bedeutungen aufweisen.

Besonders bevorzugt sind die gegebenenfalls substituierten Sechsring-Aromaten und Sechsring-Heteroaromaten der oben abgebildeten Formeln (7) bis (11). Ganz besonders bevorzugt ist ortho-Phenylen, also eine Gruppe der oben genannten Formel (7).

Dabei können, wie auch oben bei der Beschreibung des Substituenten beschrieben, auch benachbarte Substituenten miteinander ein Ringsystem bilden, so dass kondensierte Strukturen, auch kondensierte Aryl- und Heteroarylgruppen, wie beispielsweise Naphthalin, Chinolin, Benzimidazol, Carbazol, Dibenzofuran oder Dibenzothiophen, entstehen können. Eine solche Ringbildung ist im Folgenden schematisch an Gruppen der oben genannten Formel (7) aufgeführt, was zu Gruppen der folgenden Formeln (7a) bis (7j) führt: 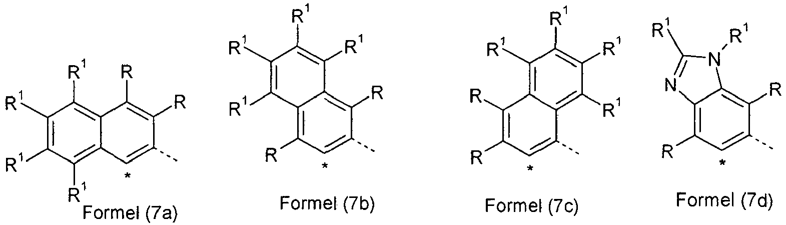 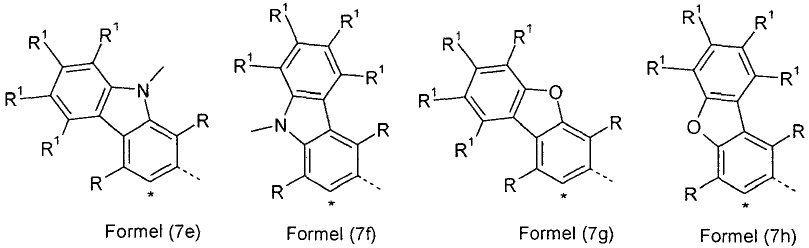 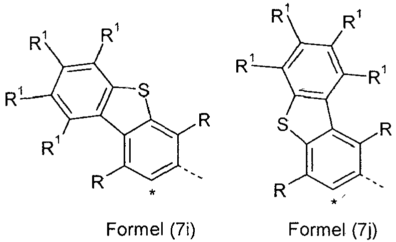 wobei die verwendeten Symbole die oben genannten Bedeutungen aufweisen.

Generell können die ankondensierten Gruppen an jeder Position der Einheit gemäß Formel (6) ankondensiert sein, wie durch die ankondensierte Benzogruppe in den Formeln (7a) bis (7c) dargestellt. Die Gruppen, wie sie in den Formeln (7d) bis (7j) an die Einheit der Formel (6) ankondensiert sind, können daher auch an andere Positionen der Einheit der Formel (6) ankondensiert werden.

Dabei können die drei Gruppen der Formel (6), die in der Einheit der Formeln (1) bis (5) bzw. Formel (1') vorhanden sind, gleich oder verschieden sein. In einer bevorzugten Ausführungsform der Erfindung sind alle drei Gruppen der Formel (6) in der Einheit der Formeln (1) bis (5) bzw. Formel (1') gleich und sind auch gleich substituiert.

Besonders bevorzugt sind die Gruppen der Formel (2) bis (5) ausgewählt aus den Gruppen der folgenden Formeln (2b) bis (5b), 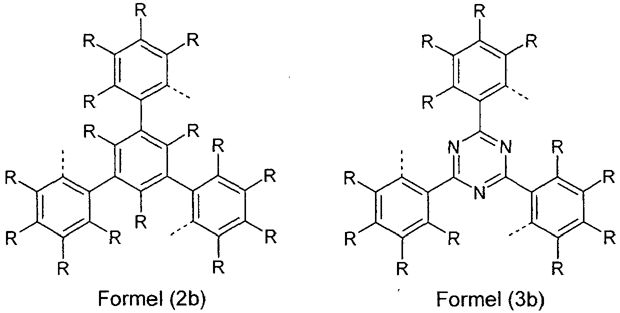 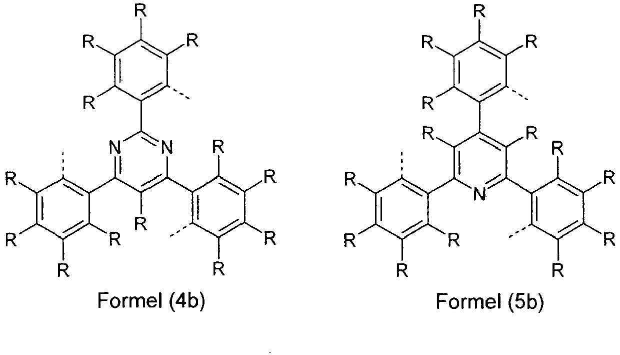 wobei die verwendeten Symbole die oben genannten Bedeutungen aufweisen.

Eine bevorzugte Ausführungsform der Formel (2b) ist die Gruppe der folgenden Formel (2b'), 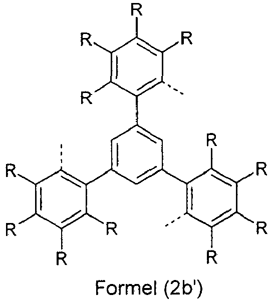 wobei die verwendeten Symbole die oben genannten Bedeutungen aufweisen.

Besonders bevorzugt sind die Gruppen R in den Formeln (1) bis (5) bei jedem Auftreten gleich oder verschieden H, D oder eine Alkylgruppe mit 1 bis 4 C-Atomen. Ganz besonders bevorzugt ist R = H. Ganz besonders bevorzugt sind also die Strukturen der folgenden Formeln (2c) bzw. (3c), 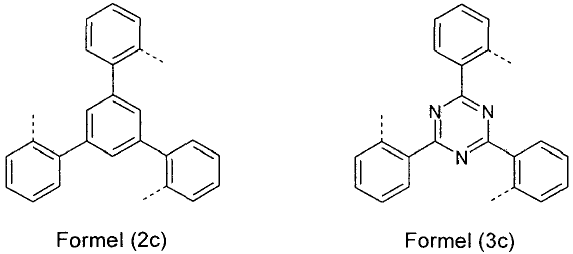 wobei die verwendeten Symbole die oben genannten Bedeutungen aufweisen.

Im Folgenden werden die bevorzugten Metalle des erfindungsgemäßen Metallkomplexes beschrieben. In einer bevorzugten Ausführungsform der Erfindung ist das Metall ein Übergangsmetall, wobei Übergangsmetalle im Sinne der vorliegenden Erfindung nicht die Lanthanide und Actinide umfassen, oder ein Hauptgruppenmetall. In einer weiteren bevorzugten Ausführungsform der Erfindung handelt es sich bei dem Metall um ein dreiwertiges Metall. Wenn das Metall für ein Hauptgruppenmetall steht, dann ist es bevorzugt ausgewählt aus Metallen der dritten oder vierten Hauptgruppe, bevorzugt Al(III), In(III), Ga(III) oder Sn(IV), insbesondere Al(III). Wenn das Metall für ein Übergangsmetall steht, dann ist es bevorzugt ausgewählt aus der Gruppe bestehend aus Chrom, Molybdän, Wolfram, Rhenium, Ruthenium, Osmium, Rhodium, Iridium, Eisen, Cobalt, Nickel, Palladium, Platin, Kupfer, Silber und Gold, insbesondere Molybdän, Wolfram, Rhenium, Ruthenium, Osmium, Iridium, Kupfer, Platin und Gold. Ganz besonders bevorzugt ist Iridium. Die Metalle können dabei in verschiedenen Oxidationsstufen vorliegen. Bevorzugt sind dabei die oben genannten Metalle in den Oxidationsstufen Cr(0), Cr(III), Cr(VI), Mo(0), Mo(III), Mo(VI), W(0), W(III), W(VI), Re(I), Re(III), Re(IV), Ru(II), Ru(III), Os(II), Os(III), Os(IV), Rh(III), Ir(III), Ir(IV), Fe(II), Fe(III), Co(II), Co(III), Ni(II), Ni(IV), Pt(IV), Cu(II), Cu(III), Au(III) und Au(V). Besonders bevorzugt sind Mo(0), W(0), Re(I), Ru(II), Os(II), Rh(III) und Ir(III). Ganz besonders bevorzugt ist Ir(III).

Es ist besonders bevorzugt, wenn die bevorzugten Ausführungsformen des Liganden und der Brücke der Formel (1) mit den bevorzugten Ausführungsformen des Metalls kombiniert werden. Besonders bevorzugt sind also Metallkomplexe, bei denen das Metall Ir(III) ist und in denen der Ligand eine Brücke der Formel (2) bis (5) bzw. (2a) bis (5a) bzw. (2b) bis (5b) bzw. (2c) bzw. (3c) aufweist und die als bivalente Arylen- bzw. Heteroarylengruppe in der Gruppe der Formel (2) bis (5) bzw. den bevorzugten Ausführungsformen gleich oder verschieden bei jedem Auftreten eine Gruppe der Formeln (7) bis (31), insbesondere eine Gruppe der Formel (7), aufweisen.

Im Folgenden werden die bidentaten Teilliganden beschrieben, die mit der Brücke der Formel (1) bzw. den oben genannten bevorzugten Ausführungsformen verknüpft sind.

Die bevorzugten Ausführungsformen der bidentaten Teilliganden hängen insbesondere von dem jeweiligen verwendeten Metall ab. Die drei bidentaten Teilliganden können gleich sein, oder sie können unterschiedlich sein. Wenn alle drei bidentaten Teilliganden gleich gewählt sind, entstehen dadurch, C₃-symmetrische Metallkomplexe, wenn auch die Einheit der Formel (1) C₃-symmetrisch ist, was vorteilhaft bezüglich der Synthese der Liganden sein kann. Es kann aber auch vorteilhaft sein, die drei bidentaten Teilliganden unterschiedlich zu wählen bzw. zwei Teilliganden gleich und den dritten Teilliganden davon verschieden zu wählen, so dass C₁-symmetrische Metallkomplexe entstehen, weil dies größere Variationsmöglichkeiten der Liganden zulässt, so dass sich die gewünschten Eigenschaften des Komplexes, wie beispielsweise die Lage von HOMO und LUMO bzw. die Emissionsfarbe, leichter variieren lassen. Außerdem lässt sich so auch die Löslichkeit der Komplexe verbessern, ohne lange aliphatische oder aromatische, löslichkeitsvermittelnde Gruppen anbringen zu müssen. Weiterhin weisen unsymmetrische Komplexe häufig eine geringere Sublimationstemperatur auf als ähnliche symmetrische Komplexe.

In einer bevorzugten Ausführungsform der Erfindung sind die drei bidentaten Teilliganden entweder gleich gewählt oder zwei der bidentaten Teilliganden sind gleich gewählt und der dritte bidentate Teilligand ist unterschiedlich von den ersten beiden bidentaten Teilliganden.

In einer bevorzugten Ausführungsform der Erfindung ist jeder der bidentaten Teilliganden gleich oder verschieden entweder monoanionisch oder neutral. Besonders bevorzugt ist jeder der bidentaten Teilliganden monoanionisch.

In einer weiteren bevorzugten Ausführungsform der Erfindung sind die koordinierenden Atome der bidentaten Teilliganden gleich oder verschieden bei jedem Auftreten ausgewählt aus C, N, P, O, S, wobei die bevorzugten koordinierenden Atome vom verwendeten Metall abhängig sind.

Wenn das Metall ausgewählt ist aus den Hauptgruppenmetallen, dann sind die koordinierenden Atome der bidentaten Teilliganden bevorzugt gleich oder verschieden bei jedem Auftreten ausgewählt aus N, O und/oder S. Besonders bevorzugt weisen die bidentaten Teilliganden zwei Stickstoffatome oder zwei Sauerstoffatome oder ein Stickstoffatom und ein Sauerstoffatom pro Teilligand auf. Dabei können die koordinierenden Atome von jedem der drei Teilliganden gleich sein, oder sie können unterschiedlich sein.

Wenn das Metall ausgewählt ist aus den Übergangsmetallen, dann sind die koordinierenden Atome der bidentaten Teilliganden bevorzugt gleich oder verschieden bei jedem Auftreten ausgewählt aus C, N, O und/oder S, besonders bevorzugt C, N und/oder O und ganz besonders bevorzugt C und/oder N. Dabei weisen die bidentaten Teilliganden bevorzugt ein Kohlenstoffatom und ein Stickstoffatom oder zwei Kohlenstoffatome oder zwei Stickstoffatome oder zwei Sauerstoffatome oder ein Sauerstoffatom und ein Stickstoffatom als koordinierende Atome auf. Dabei können die koordinierenden Atome von jedem der drei Teilliganden gleich sein, oder sie können unterschiedlich sein. Besonders bevorzugt weist mindestens einer der bidentaten Teilliganden ein Kohlenstoffatom und ein Stickstoffatom oder zwei Kohlenstoffatome als koordinierende Atome auf, insbesondere ein Kohlenstoffatom und ein Stickstoffatom. Ganz besonders bevorzugt weisen mindestens zwei der bidentaten Teilliganden ein Kohlenstoffatom und ein Stickstoffatom oder zwei Kohlenstoffatome als koordinierende Atome auf, insbesondere ein Kohlenstoffatom und ein Stickstoffatom. Dies gilt insbesondere, wenn das Metall Ir(III) ist. Wenn das Metall Ru, Co, Fe, Os, Cu oder Ag ist, sind als koordinierende Atome der bidentaten Teilliganden auch zwei Stickstoffatome besonders bevorzugt.

In einer besonders bevorzugten Ausführungsform der Erfindung ist das Metall Ir(III) und zwei der bidentaten Teilliganden koordinieren an das Iridium über jeweils ein Kohlenstoffatom und ein Stickstoffatom und der dritte der bidentaten Teilliganden koordiniert an das Iridium über ein Kohlenstoffatom und ein Stickstoffatom oder über zwei Stickstoffatome oder über ein Stickstoffatom und ein Sauerstoffatom oder über zwei Sauerstoffatome, insbesondere über ein ein Kohlenstoffatom und ein Stickstoffatom. Besonders bevorzugt handelt es sich somit um einen Iridiumkomplex, in dem alle drei bidentaten Teilliganden ortho-metalliert sind, d. h. mit dem Iridium einen Metallacyclus bilden, in dem eine Metall-Kohlenstoff-Bindung vorliegt.

Es ist weiterhin bevorzugt, wenn es sich bei dem Metallacyclus, der aus dem Metall und dem bidentaten Teilliganden aufgespannt wird, um einen Fünfring handelt, der vor allem dann bevorzugt ist, wenn die koordinierenden Atome C und N, N und N oder N und O sind. Wenn es sich bei den koordinierenden Atomen um O handelt, kann auch ein Metallasechsring bevorzugt sein. Dies wird im Folgenden schematisch dargestellt: 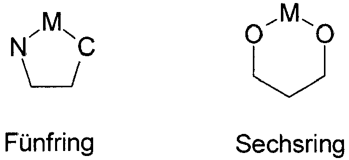 wobei M das Metall, N ein koordinierendes Stickstoffatom, C ein koordinierendes Kohlenstoffatom und O koordinierende Sauerstoffatome darstellen und die eingezeichneten Kohlenstoffatome Atome des bidentaten Liganden darstellen.

Im Folgenden werden die Strukturen der bidentaten Teilliganden beschrieben, die bevorzugt sind, wenn das Metall ein Übergangsmetall ist.

In einer bevorzugten Ausführungsform der Erfindung steht mindestens einer der bidentaten Teilliganden, besonders bevorzugt mindestens zwei der bidentaten Teilliganden, ganz besonders bevorzugt alle drei der bidentaten Teilliganden gleich oder verschieden bei jedem Auftreten für eine Struktur gemäß den folgenden Formeln (L-1), (L-2), (L-3) oder (L-4), 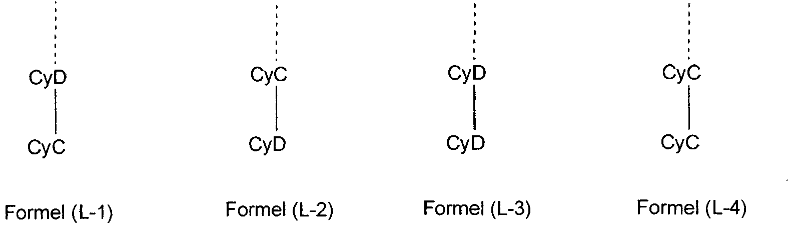 wobei die gestrichelte Bindung die Bindung des Teilliganden an die Brücke der Formeln (1) bis (5) bzw. die bevorzugten Ausführungsformen darstellt und für die weiteren verwendeten Symbole gilt:
- CyC: ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche in (L-1) und (L-2) über eine kovalente Bindung mit CyD verbunden ist und in (L-4) über eine kovalente Bindung mit einer weiteren Gruppe CyC verbunden ist;
- CyD: ist gleich oder verschieden bei jedem Auftreten eine substituierte oder unsubstituierte Heteroarylgruppe mit 5 bis 14 aromatischen Ring-atomen, welche über ein Stickstoffatom oder über ein Carben-Kohlenstoffatom an das Metall koordiniert und welche in (L-1) und (L-2) über eine kovalente Bindung mit CyC verbunden ist und in (L-3) über eine kovalente Bindung mit einer weiteren Gruppe CyD verbunden ist;
dabei können mehrere der optionalen Substituenten miteinander ein Ringsystem bilden; die optionalen Reste sind bevorzugt ausgewählt aus den oben genannten Resten R.

Dabei koordiniert CyD in den Teilliganden der Formeln (L-1) und (L-2) bevorzugt über ein neutrales Stickstoffatom oder über ein Carben-Kohlenstoffatom. Weiterhin bevorzugt koordiniert eine der beiden Gruppen CyD in dem Liganden der Formel (L-3) über ein neutrales Stickstoffatom und und die andere der beiden Gruppen CyD über ein anionisches Stickstoffatom. Weiterhin bevorzugt koordiniert CyC in den Teilliganden der Formeln (L-1), (L-2) und (L-4) über anionische Kohlenstoffatome.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD in den Formeln (L-1) und (L-2) bzw. die Substituenten an den beiden Gruppen CyD in Formel (L-3) bzw. die Substituenten an den beiden Gruppen CyC in Formel (L-4) miteinander einen Ring bilden, wodurch CyC und CyD bzw. die beiden Gruppen CyD bzw. die beiden Gruppen CyC auch zusammen eine einzige kondensierte Aryl- bzw. Heteroarylgruppe als bidentaten Liganden bilden können.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, welche über ein Kohlenstoffatom an das Metall koordiniert, welche mit einem oder mehreren Resten R substituiert sein kann und welche in (L-1) und (L-2) über eine kovalente Bindung mit CyD verbunden ist und in (L-4) über eine kovalente Bindung mit einer weiteren Gruppe CyC verbunden ist.

Bevorzugte Ausführungsformen der Gruppe CyC sind die Strukturen der folgenden Formeln (CyC-1) bis (CyC-19), wobei die Gruppe CyC jeweils an der durch # gekennzeichneten Position an CyD in (L-1) und (L-2) bzw. an CyC in (L-4) bindet und an der durch * gekennzeichneten Position an das Metall koordiniert, 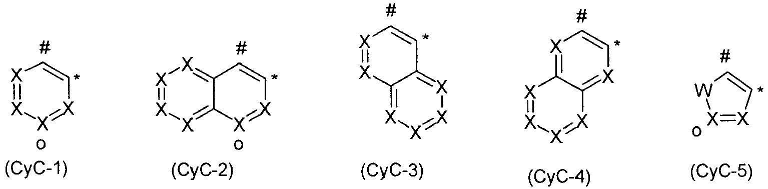 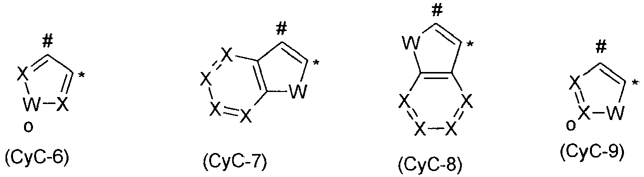 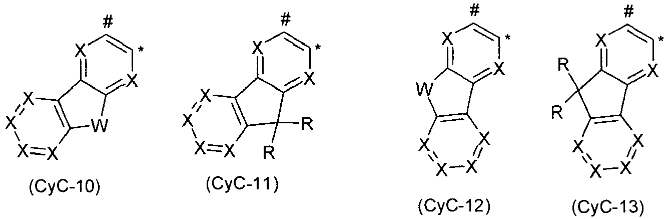 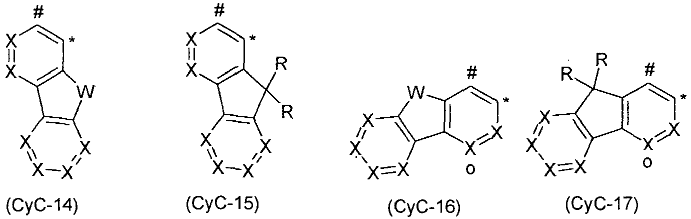 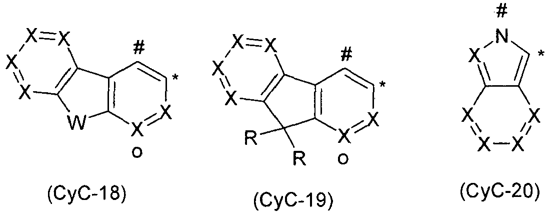 wobei R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist bei jedem Auftreten gleich oder verschieden NR, O oder S;
mit der Maßgabe, dass, wenn die Brücke der Formeln (1) bis (5) bzw. die bevorzugten Ausführungsformen an CyC gebunden ist, ein Symbol X für C steht und die Brücke der Formeln (1) bis (5) bzw. die bevorzugten Ausführungsformen an dieses Kohlenstoffatom gebunden ist. Wenn die Gruppe CyC an die Brücke der Formeln (1) bis (5) bzw. die bevorzugten Ausführungsformen gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Brücke der Formeln (1) bis (5) bzw. die bevorzugten Ausführungsformen gebunden, da eine solche Bindung an die Brücke aus sterischen Gründen nicht vorteilhaft ist.

Bevorzugt stehen insgesamt maximal zwei Symbole X in CyC für N, besonders bevorzugt steht maximal ein Symbol X in CyC für N, ganz besonders bevorzugt stehen alle Symbole X für CR, mit der Maßgabe, dass, wenn die Brücke der Formeln (1) bis (5) bzw. die bevorzugten Ausführungsformen an CyC gebunden ist, ein Symbol X für C steht und die Brücke der Formeln (1) bis (5) bzw. die bevorzugten Ausführungsformen an dieses Kohlenstoffatom gebunden ist.

Besonders bevorzugte Gruppen CyC sind die Gruppen der folgenden Formeln (CyC-1a) bis (CyC-20a), 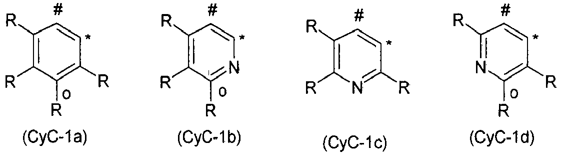 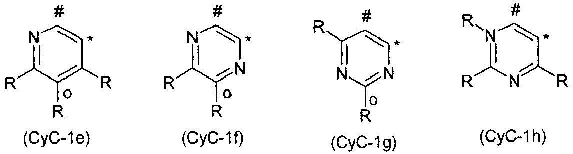 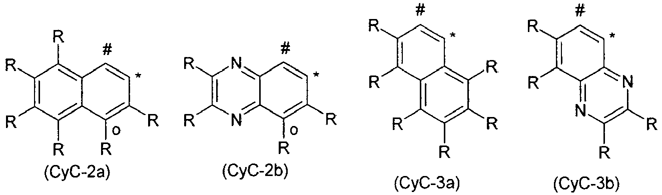 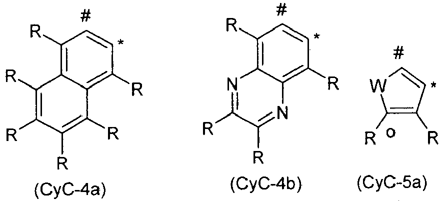 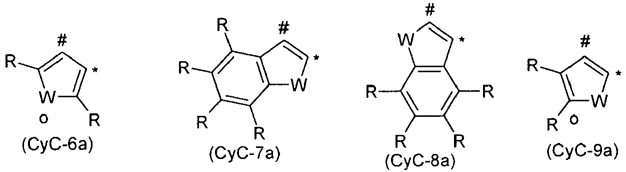 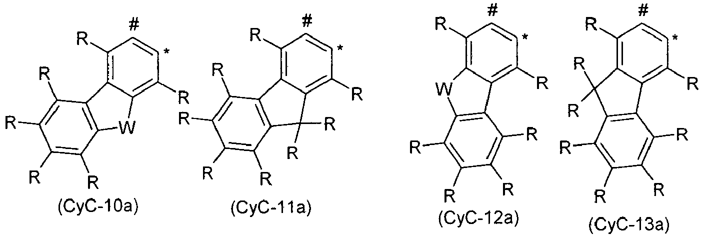 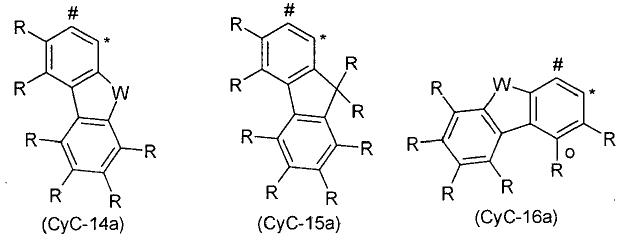 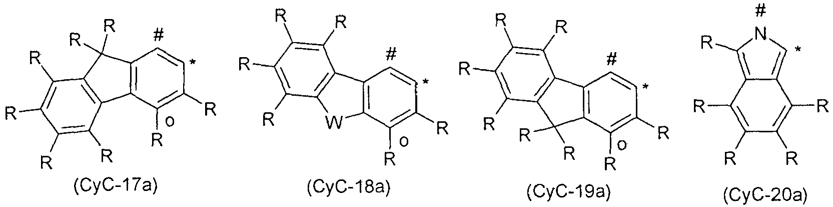 wobei die verwendeten Symbole die oben genannten Bedeutungen aufweisen und, wenn die Brücke der Formeln (1) bis (5) bzw. die bevorzugten Ausführungsformen an CyC gebunden ist, ein Rest R nicht vorhanden ist und die Brücke der Formeln (1) bis (5) bzw. die bevorzugten Ausführungsformen an das entsprechende Kohlenstoffatom gebunden ist. Wenn die Gruppe CyC an die Brücke der Formeln (1) bis (5) bzw. die bevorzugten Ausführungsformen gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Brücke der Formeln (1) bis (5) bzw. die bevorzugten Ausführungsformen gebunden.

Bevorzugte Gruppen unter den Gruppen (CyC-1) bis (CyC-19) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe mit 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC in (L-1) und (L-2) bzw. mit CyD in (L-3) verbunden ist.

Bevorzugte Ausführungsformen der Gruppe CyD sind die Strukturen der folgenden Formeln (CyD-1) bis (CyD-14), wobei die Gruppe CyD jeweils an der durch # gekennzeichneten Position an CyC in (L-1) und (L-2) bzw. an CyD in (L-3) bindet und an der durch * gekennzeichneten Position an das Metall koordiniert, 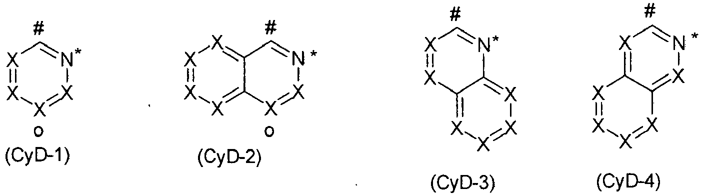 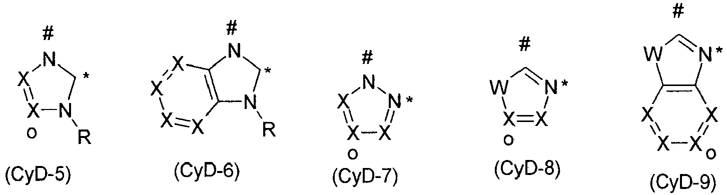 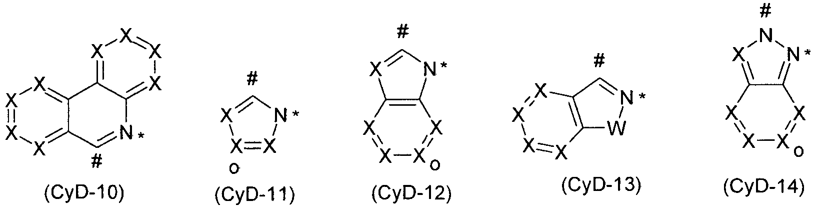 wobei X, W und R die oben genannten Bedeutungen aufweisen, mit der Maßgabe, dass, wenn die Brücke der Formeln (1) bis (5) bzw. die bevorzugten Ausführungsformen an CyD gebunden ist, ein Symbol X für C steht und die Brücke der Formeln (1) bis (5) bzw. die bevorzugten Ausführungsformen an dieses Kohlenstoffatom gebunden ist. Wenn die Gruppe CyD an die Brücke der Formeln (1) bis (5) bzw. die bevorzugten Ausführungsformen gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Brücke der Formeln (1) bis (5) bzw. die bevorzugten Ausführungsformen gebunden, da eine solche Bindung an die Brücke aus sterischen Gründen nicht vorteilhaft ist.

Dabei koordinieren die Gruppen (CyD-1) bis (CyD-4), (CyD-7) bis (CyD-10), (CyD-13) und (CyD-14) über ein neutrales Stickstoffatom, (CyD-5) und (CyD-6) über ein Carben-Kohlenstoffatom und (CyD-11) und (CyD-12) über ein anionisches Stickstoffatom an das Metall.

Bevorzugt stehen insgesamt maximal zwei Symbole X in CyD für N, besonders bevorzugt steht maximal ein Symbol X in CyD für N, insbesondere bevorzugt stehen alle Symbole X für CR, mit der Maßgabe, dass, wenn die Brücke der Formeln (1) bis (5) bzw. die bevorzugten Ausführungsformen an CyD gebunden ist, ein Symbol X für C steht und die Brücke der Formeln (1) bis (5) bzw. die bevorzugten Ausführungsformen an dieses Kohlenstoffatom gebunden ist.

Besonders bevorzugte Gruppen CyD sind die Gruppen der folgenden Formeln (CyD-1a) bis (CyD-14b), 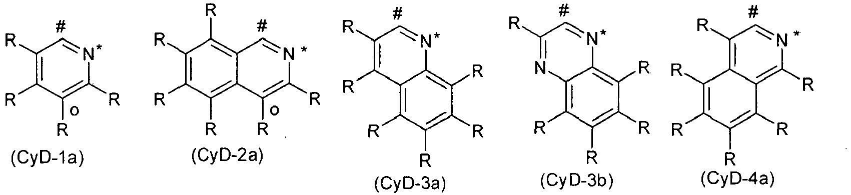 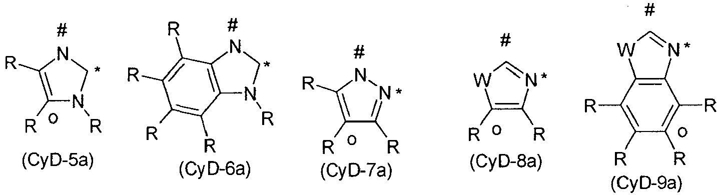 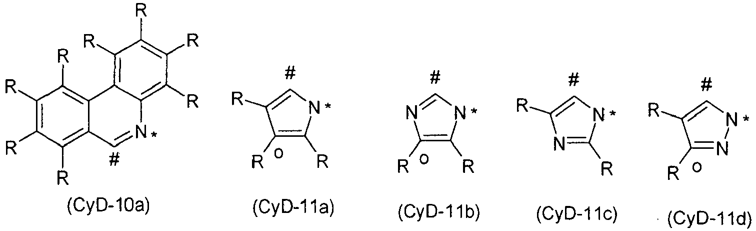 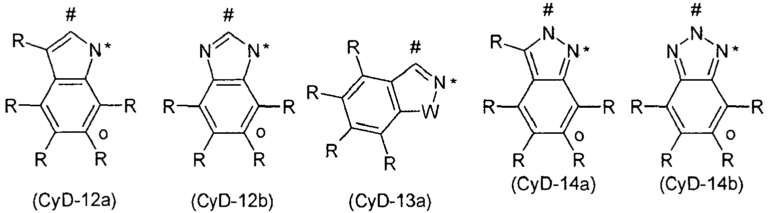 wobei die verwendeten Symbole die oben genannten Bedeutungen aufweisen und, wenn die Brücke der Formeln (1) bis (5) bzw. die bevorzugten Ausführungsformen an CyD gebunden ist, ein Rest R nicht vorhanden ist und die Brücke der Formel (1) bis (5) bzw. die bevorzugten Ausführungsformen an das entsprechende Kohlenstoffatom gebunden ist. Wenn die Gruppe CyD an die Brücke der Formeln (1) bis (5) bzw. die bevorzugten Ausführungsformen gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Brücke der Formeln (1) bis (5) bzw. die bevorzugten Ausführungsformen gebunden.

Bevorzugte Gruppen unter den Gruppen (CyD-1) bis (CyD-10) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1a), (CyD-2a), (CyD-3a), (CyD-4a), (CyD-5a) und (CyD-6a), insbesondere (CyD-1a), (CyD-2a) und (CyD-3a).

In einer bevorzugten Ausführungsform der vorliegenden Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen und CyD eine Heteroarylgruppe mit 6 bis 10 aromatischen Ringatomen. Dabei können CyC und CyD mit einem oder mehreren Resten R substituiert sein.

Die oben genannten bevorzugten Gruppen (CyC-1) bis (CyC-20) und (CyD-1) bis (CyD-14) können in den Teilliganden der Formeln (L-1) und (L-2) beliebig miteinander kombiniert werden, sofern mindestens eine der Gruppen CyC bzw. CyD eine geeignete Anknüpfungsstelle an die Brücke der Formel (1) bis (5) bzw. die bevorzugten Ausführungsformen aufweist, wobei geeignete Anknüpfungsstellen in den oben genannten Formeln mit "o" gekennzeichnet sind.

Insbesondere bevorzugt ist es, wenn die oben als besonders bevorzugt genannten Gruppen CyC und CyD, also die Gruppen der Formeln (CyC-1a) bis (CyC-20a) und die Gruppen der Formeln (CyD1-a) bis (CyD-14b) miteinander kombiniert werden, sofern mindestens eine der bevorzugten Gruppen CyC bzw. CyD eine geeignete Anknüpfungsstelle an die Brücke der Formel (1) bis (5) bzw. die bevorzugten Ausführungsformen aufweist, wobei geeignete Anknüpfungsstellen in den oben genannten Formeln mit "o" gekennzeichnet sind. Kombinationen, in denen weder CyC noch CyD eine solche geeignete Anknüpfungsstelle für die Brücke der Formel (1) bis (5) bzw. die bevorzugten Ausführungsformen aufweist, sind daher nicht bevorzugt.

Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1a), (CyD-2a) und (CyD-3a), kombiniert wird.

Bevorzugte Teilliganden (L-1) sind die Strukturen der folgenden Formeln (L-1-1) und (L-1-2), und bevorzugte Teilliganden (L-2) sind die Strukturen der folgenden Formeln (L-2-1) bis (L-2-3), 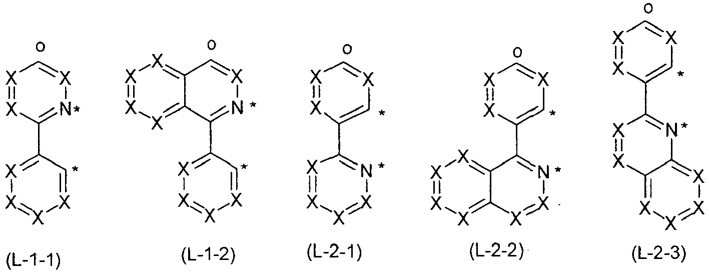 wobei die verwendeten Symbole die oben genannten Bedeutungen aufweisen und "o" die Position der Bindung an die Brücke der Formel (1) bis (5) bzw. die bevorzugten Ausführungsformen darstellt.

Besonders bevorzugte Teilliganden (L-1) sind die Strukturen der folgenden Formeln (L-1-1a) und (L-1-2b), und besonders bevorzugte Teilliganden (L-2) sind die Strukturen der folgenden Formeln (L-2-1a) bis (L-2-3a), 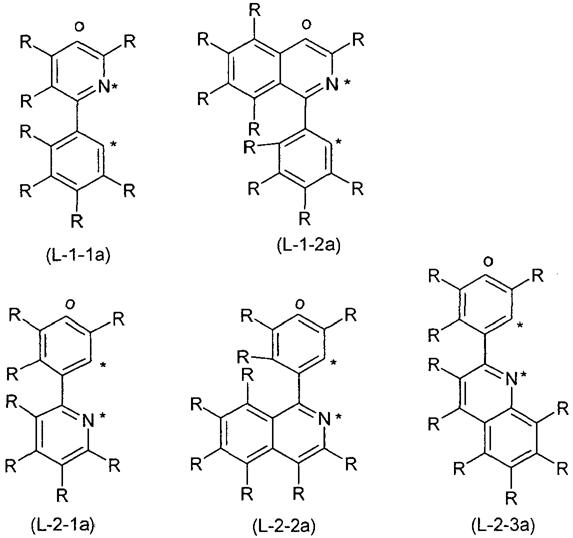 wobei die verwendeten Symbole die oben genannten Bedeutungen aufweisen und "o" die Position der Bindung an die Brücke der Formel (1) bis (5) bzw. die bevorzugten Ausführungsformen darstellt.

Ebenso können die oben genannten bevorzugten Gruppen CyD in den Teilliganden der Formel (L-3) beliebig miteinander kombiniert werden, wobei es bevorzugt ist, eine neutrale Gruppe CyD, also eine Gruppe (CyD-1) bis (CyD-10), (CyD-13) oder (CyD-14), mit einer anionischen Gruppe CyD, also einer Gruppe (CyD-11) oder CyD-12), zu kombinieren, sofern mindestens eine der bevorzugten Gruppen CyD eine geeignete Anknüpfungsstelle an die Brücke der Formel (1) bis (5) bzw. die bevorzugten Ausführungsformen aufweist, wobei geeignete Anknüpfungsstellen in den oben genannten Formeln mit "o" gekennzeichnet sind.

Ebenso können die oben genannten bevorzugten Gruppen CyC in den Teilliganden der Formel (L-4) beliebig miteinander kombiniert werden, sofern mindestens eine der bevorzugten Gruppen CyC eine geeignete Anknüpfungsstelle an die Brücke der Formel (1) bis (5) bzw. die bevorzugten Ausführungsformen aufweist, wobei geeignete Anknüpfungsstellen in den oben genannten Formeln mit "o" gekennzeichnet sind.

Wenn zwei Reste R, von denen einer an CyC und der andere an CyD in den Formeln (L-1) und (L-2) gebunden sind bzw. von denen einer an die eine Gruppe CyD und der andere an die andere Gruppe CyD in Formel (L-3) gebunden sind bzw. von denen einer an die eine Gruppe CyC und der andere an die andere Gruppe CyC in Formel (L-4) gebunden sind, miteinander ein aromatisches Ringsystem bilden, können sich überbrückte Teilliganden und beispielsweise auch Teilliganden ergeben, die insgesamt eine einzige größere Heteroarylgruppe darstellen, wie beispielsweise Benzo[h]chinolin, etc.. Die Ringbildung zwischen den Substituenten an CyC und CyD in den Formeln (L-1) und (L-2) bzw. zwischen den Substituenten an den beiden Gruppen CyD in Formel (L-3) bzw. zwischen den Substituenten an den beiden Gruppen (CyC) in Formel (L-4) erfolgt dabei bevorzugt durch eine Gruppe gemäß einer der folgenden Formeln (32) bis (41), 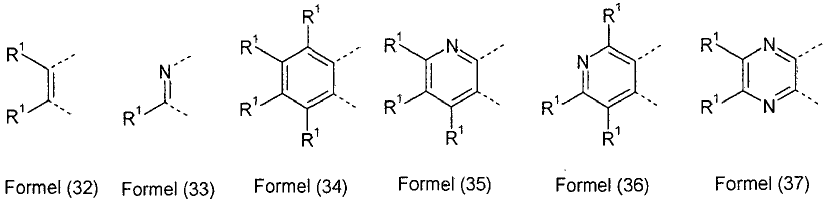 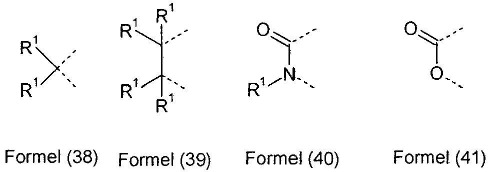 wobei R¹ die oben genannten Bedeutungen aufweist und die gestrichelten Bindungen die Bindungen an CyC bzw. CyD andeuten. Dabei können die unsymmetrischen der oben genannten Gruppen in jeder der beiden Möglichkeiten eingebaut werden, beispielsweise kann bei der Gruppe der Formel (41) das Sauerstoffatom an die Gruppe CyC und die Carbonylgruppe an die Gruppe CyD binden, oder das Sauerstoffatom kann an die Gruppe CyD und die Carbonylgruppe an die Gruppe CyC binden.

Dabei ist die Gruppe der Formel (38) besonders dann bevorzugt, wenn sich dadurch die Ringbildung zu einem Sechsring ergibt, wie beispielsweise unten durch die Formeln (L-23) und (L-24) dargestellt.

Bevorzugte Liganden, die durch Ringbildung zweier Reste R an den unterschiedlichen Cyclen entstehen, sind die im Folgenden aufgeführten Strukturen der Formeln (L-5) bis (L-32), 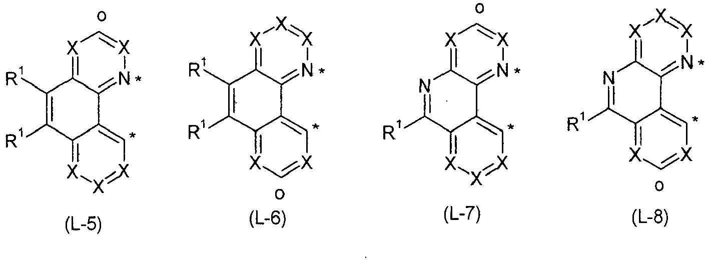 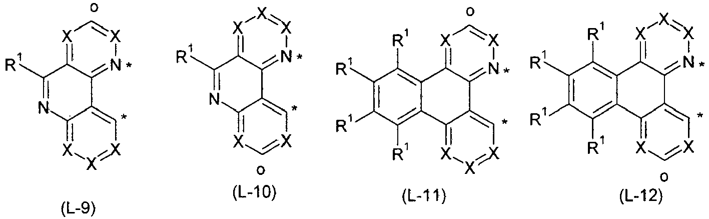 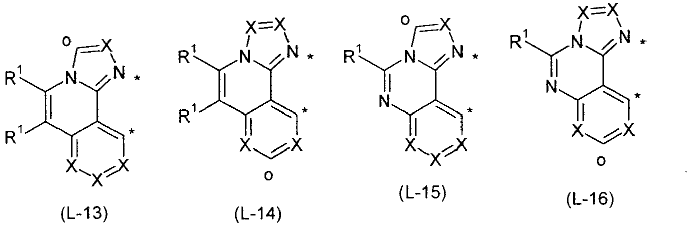 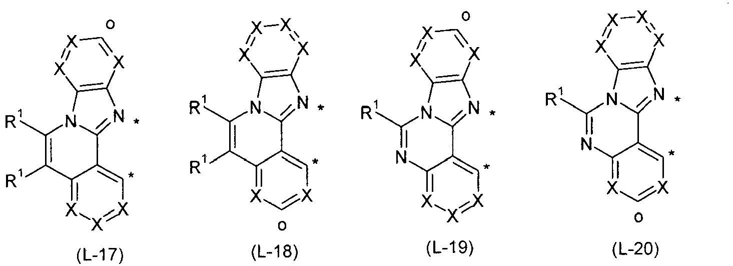 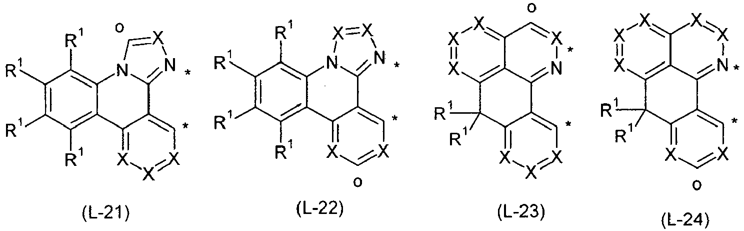 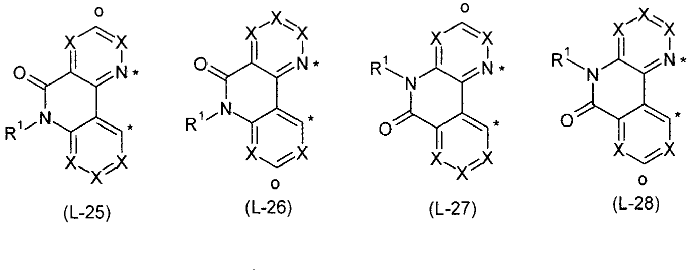 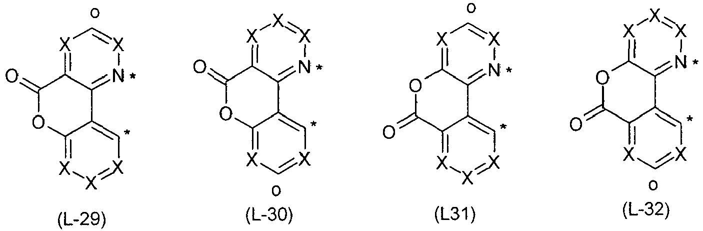 wobei die verwendeten Symbole die oben genannten Bedeutungen aufweisen und "o" die Position angibt, an denen dieser Teilligand mit der Gruppe der Formel (1) bis (5) bzw. den bevorzugten Ausführungsformen verknüpft ist.

In einer bevorzugten Ausführungsform der Teilliganden der Formeln (L-5) bis (L-32) steht insgesamt ein Symbol X für N und die anderen Symbole X stehen für CR, oder alle Symbole X stehen für CR.

In einer weiteren Ausführungsform der Erfindung ist es bevorzugt, falls in den Gruppen (CyC-1) bis (CyC-20) oder (CyD-1) bis (CyD-14) oder in den Teilliganden (L-5) bis (L-3) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1a) bis (CyD-14b), in denen bevorzugt benachbart zu einem nicht koordinierenden Stickstoffatom eine Gruppe R als Substituent gebunden ist, welche ungleich Wasserstoff oder Deuterium ist

Dabei ist dieser Substituent R bevorzugt eine Gruppe, ausgewählt aus CF₃, OCF₃, Alkyl- oder Alkoxygruppen mit 1 bis 10 C-Atomen, insbesondere verzweigten oder cyclischen Alkyl- oder Alkoxygruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Ein weiterer geeigneter bidentater Teilligand für Metallkomplexe, in denen das Metall ein Übergangsmetall ist, ist ein Teilligand der folgenden Formel (L-33) oder (L-34), 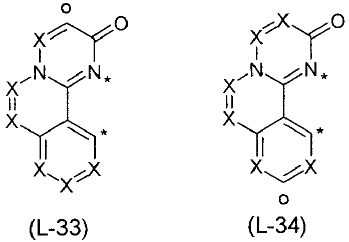 wobei R die oben genannten Bedeutungen aufweist, * die Position der Koordination an das Metall darstellt, "o" die Position der Verknüpfung des Teilliganden mit der Gruppe der Formeln (1) bis (5) bzw. den bevorzugten Ausführungsformen darstellt und für die weiteren verwendeten Symbole gilt:
- X: ist bei jedem Auftreten gleich oder verschieden CR oder N mit der Maßgabe, dass maximal ein Symbol X pro Cyclus für N steht.

Wenn zwei Reste R, die in den Teilliganden (L-33) bzw. (L-34) an benachbarten Kohlenstoffatomen gebunden sind, miteinander einen aromatischen Cyclus bilden, so ist dieser zusammen mit den beiden benachbarten Kohlenstoffatomen bevorzugt eine Struktur der folgenden Formel (42), 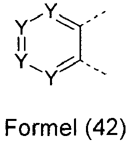 wobei die gestrichelten Bindungen die Verknüpfung dieser Gruppe im Teilliganden symbolisieren und Y gleich oder verschieden bei jedem Auftreten für CR¹ oder N steht und bevorzugt maximal ein Symbol Y für N steht.

In einer bevorzugten Ausführungsform des Teilliganden (L-33) bzw. (L-34) ist maximal eine Gruppe der Formel (42) vorhanden. Es handelt sich also bevorzugt um Teilliganden der folgenden Formeln (L-35) bis (L-40), 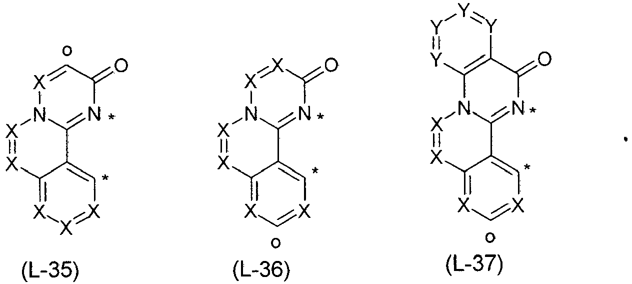 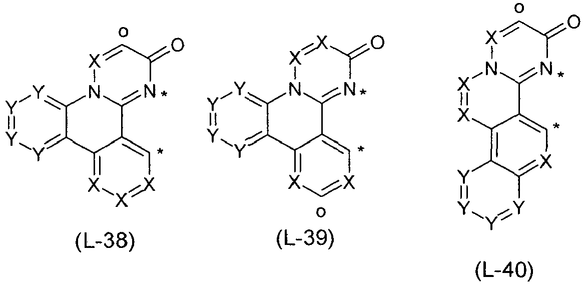 wobei X bei jedem Auftreten gleich oder verschieden für CR oder N steht, jedoch die Reste R nicht miteinander ein aromatisches oder heteroaromatisches Ringsystem bilden und die weiteren Symbole die oben genannten Bedeutungen aufweisen.

In einer bevorzugten Ausführungsform der Erfindung stehen im Teilliganden der Formel (L-33) bis (L-40) insgesamt 0, 1 oder 2 der Symbole X und, falls vorhanden, Y für N. Besonders bevorzugt stehen insgesamt 0 oder 1 der Symbole X und, falls vorhanden, Y für N.

Bevorzugte Ausführungsformen der Formeln (L-35) bis (L-40) sind die Strukturen der folgenden Formeln (L-35a) bis (L-40f), 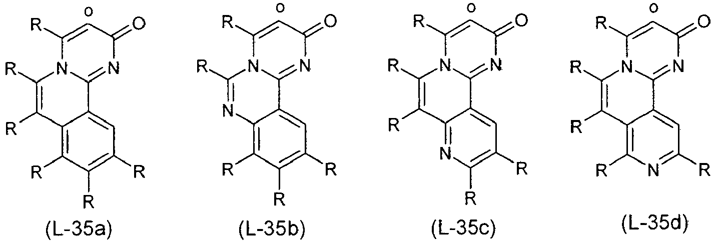 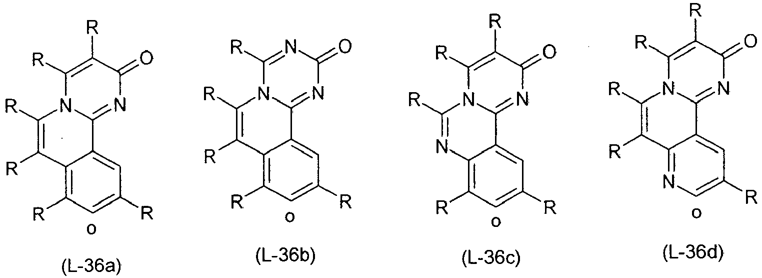 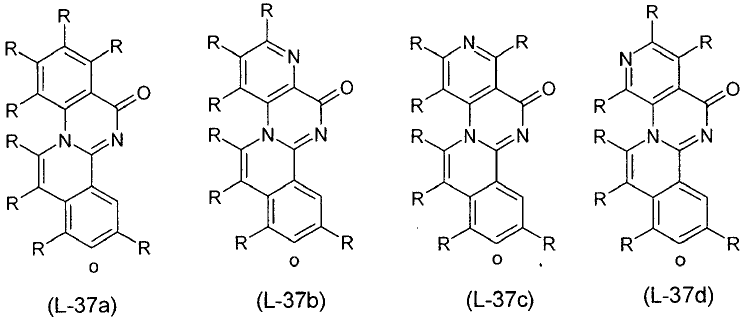 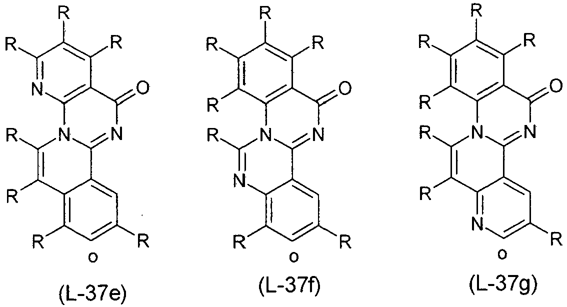 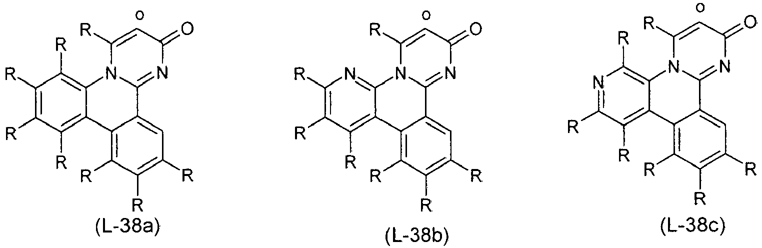 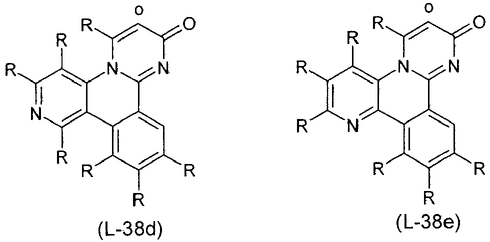 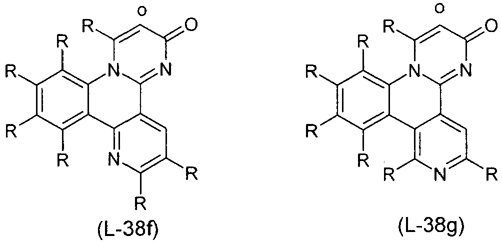 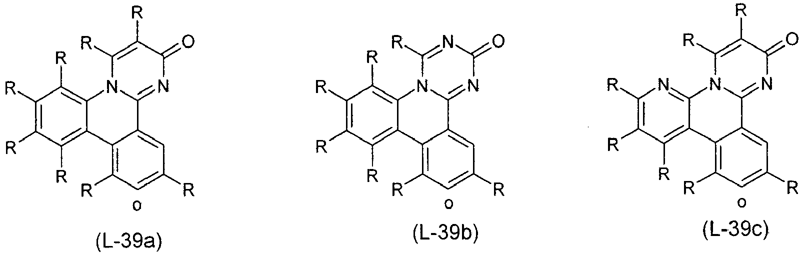 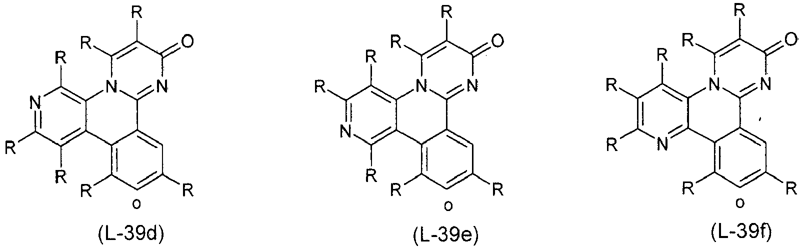 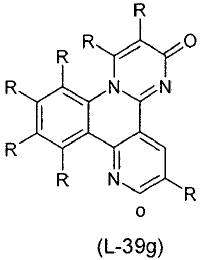 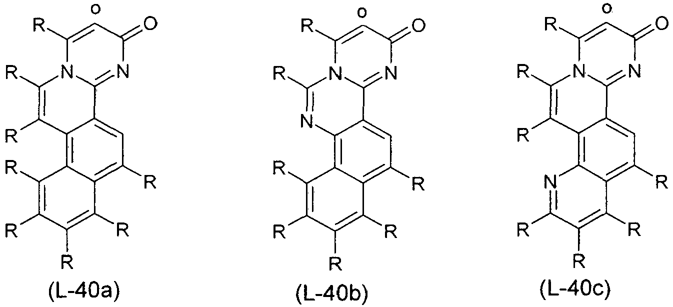 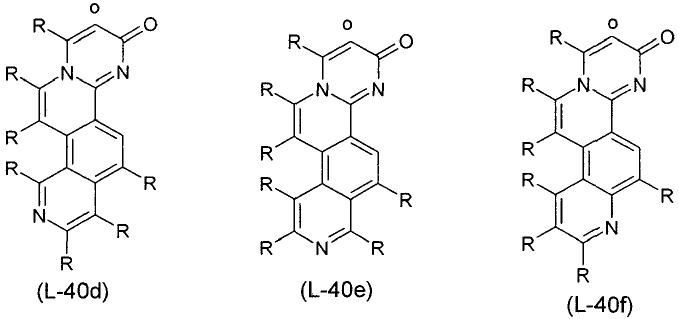 wobei die verwendeten Symbole die oben genannten Bedeutungen aufweisen und "o" die Position der Verknüpfung mit der Gruppe der Formeln (1) bis (5) bzw. den bevorzugten Ausführungsformen anzeigt.

In einer bevorzugten Ausführungsform der Erfindung steht die Gruppe X, die in ortho-Position zur Koordination an das Metall vorliegt, für CR. Dabei ist in dieser Rest R, der in ortho-Position zur Koordination an das Metall gebunden ist, bevorzugt ausgewählt aus der Gruppe bestehend aus H, D, F und Methyl.

In einer weiteren Ausführungsform der Erfindung ist es bevorzugt, falls eines der Atome X oder, wenn vorhanden, Y für N steht, wenn benachbart zu diesem Stickstoffatom eine Gruppe R als Substituent gebunden ist, welche ungleich Wasserstoff oder Deuterium ist.

Dabei ist dieser Substituent R bevorzugt eine Gruppe, ausgewählt aus CF₃, OCF₃, Alkyl- oder Alkoxygruppen mit 1 bis 10 C-Atomen, insbesondere verzweigten oder cyclischen Alkyl- oder Alkoxygruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Wenn das Metall des erfindungsgemäßen Komplexes für ein Hauptgruppenmetall, insbesondere für Al, steht, so ist bevorzugt mindestens einer der bidentaten Teilliganden bei jedem Auftreten, bevorzugt mindestens zwei der bidentaten Teilliganden, besonders bevorzugt alle drei bidentaten Teilliganden, gleich oder verschieden ausgewählt aus den Teilliganden der folgenden Formeln (L-41) bis (L-44), 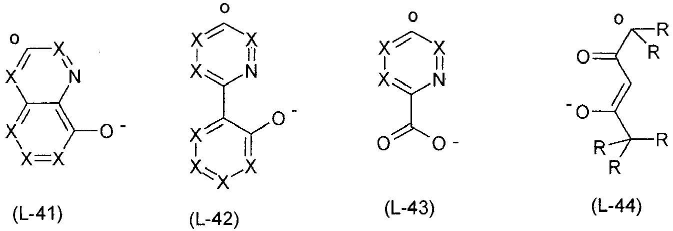 wobei die Teilliganden (L-41) bis (L-43) jeweils über das explizit eingezeichnete Stickstoffatom und das negativ geladene Sauerstoffatom und der Teilligand (L-44) über die beiden Sauerstoffatome an das Metall koordinieren, X die oben genannten Bedeutungen aufweist und "o" die Position angibt, über die der Teilligand mit der Gruppe der Formel (1) bis (5) bzw. den bevorzugten Ausführungsformen verknüpft ist.

Die oben ausgeführten bevorzugten Ausführungsformen für X sind auch bevorzugt für die Teilliganden der Formeln (L-41) bis (L-43).

Bevorzugte Teilliganden der Formeln (L-41) bis (L-43) sind daher die Teilliganden der folgenden Formeln (L-41a) bis (L-43a), 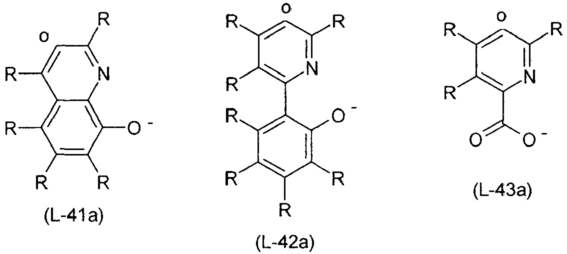 wobei die verwendeten Symbole die oben genannten Bedeutungen aufweisen und "o" die Position angibt, über die der Teilligand mit der Gruppe der Formel (1) bis (5) bzw. den bevorzugten Ausführungsformen verknüpft ist.

Besonders bevorzugt steht in diesen Formeln R für Wasserstoff, wobei "o" die Position angibt, über die der Teilligand mit der Gruppe der Formel (1) bis (5) bzw. den bevorzugten Ausführungsformen verknüpft ist, so dass es sich um die Strukturen der folgenden Formeln (L-41b) bis (L-43b) handelt, 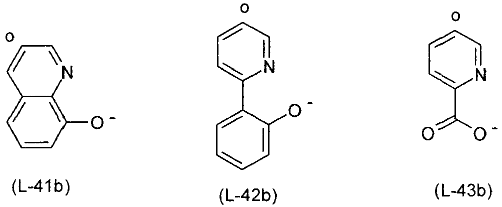 wobei die verwendeten Symbole die oben genannten Bedeutungen aufweisen.

Die Gruppen der Formel (L-41) bzw. (L-41a) bzw. (L-41b) und (L-44) sind weiterhin auch bevorzugt als einer der Teilliganden, wenn das Metall ein Übergangsmetall ist, bevorzugt in Kombination mit einem oder mehreren Teilliganden, die über ein Kohlenstoffatom und ein Stickstoffatom an das Metall binden, insbesondere wie sie durch die vorne aufgeführten Teilliganden der Formeln (L-1) bis (L-40) beschrieben sind.

Im Folgenden werden bevorzugte Substituenten beschrieben, wie sie an den oben beschriebenen Teilliganden, aber auch an der bivalenten Arylen- oder Heteroarylengruppe in der Struktur der Formeln (1) bis (5), also in der Struktur der Formel (6), vorliegen können.

In einer bevorzugten Ausführungsform der Erfindung enthält der erfindungsgemäße Metallkomplex zwei Substituenten R oder zwei Substituenten R¹, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an der Brücke der Formeln (1) bis (5) bzw. den bevorzugten Ausführungsformen vorliegen und/oder an einem oder mehreren der bidentaten Teilliganden vorliegen. Der aliphatische Ring, der durch die Ringbildung von zwei Substituenten R miteinander oder von zwei Substituenten R¹ miteinander gebildet wird, wird bevorzugt durch eine der folgenden Formeln (43) bis (49) beschrieben, 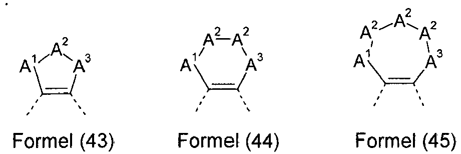 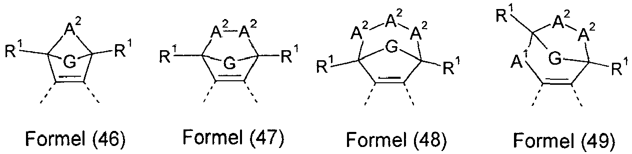 wobei R¹ und R² die oben genannten Bedeutungen aufweisen, die gestrichelten Bindungen die Verknüpfung der beiden Kohlenstoffatome im Liganden andeuten und weiterhin gilt:
- A¹, A³: ist gleich oder verschieden bei jedem Auftreten C(R³)₂, O, S, NR³ oder C(=O);
- A²: ist C(R¹)₂, O, S, NR³ oder C(=O);
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten H, F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryl-oxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

In den oben abgebildeten Strukturen der Formeln (43) bis (49) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (43) bis (45) dadurch erreicht, dass A¹ und A³, wenn diese für C(R³)₂ stehen, so definiert sind, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (46) bis (49) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (46) bis (49) für H steht, handelt es sich dabei daher um ein nicht-azides Proton im Sinne der vorliegenden Anmeldung.

In einer bevorzugten Ausführungsform der Erfindung ist R³ ungleich H.

In einer bevorzugten Ausführungsform der Struktur gemäß Formel (43) bis (49) steht maximal eine der Gruppen A¹, A² und A³ für ein Heteroatom, insbesondere für O oder NR³, und die anderen Gruppen stehen für C(R³)₂ bzw. C(R¹)₂ oder A¹ und A³ stehen gleich oder verschieden bei jedem Auftreten für O oder NR³ und A² steht für C(R¹)₂. In einer besonders bevorzugten Ausführungsform der Erfindung stehen A¹ und A³ gleich oder verschieden bei jedem Auftreten für C(R³)₂ und A² steht für C(R¹)₂ und besonders bevorzugt für C(R³)₂ oder CH₂.

Bevorzugte Ausführungsformen der Formel (43) sind somit die Strukturen der Formel (43-A), (43-B), (43-C) und (43-D), und eine besonders bevorzugte Ausführungsform der Formel (43-A) sind die Strukturen der Formel (43-E) und (43-F), 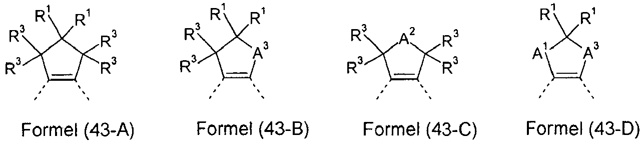 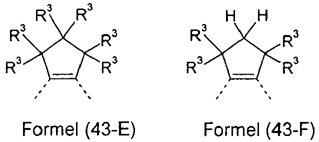 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (44) sind die Strukturen der folgenden Formeln (44-A) bis (44-F), 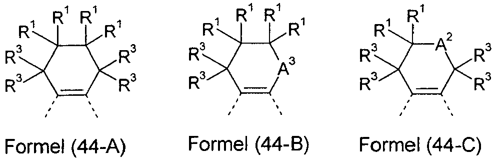 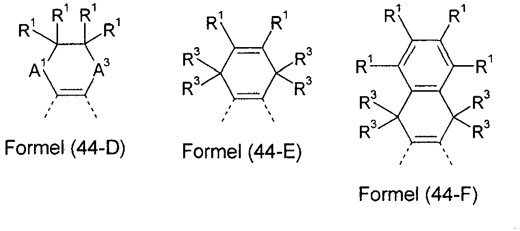 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (45) sind die Strukturen der folgenden Formeln (45-A) bis (45-E), 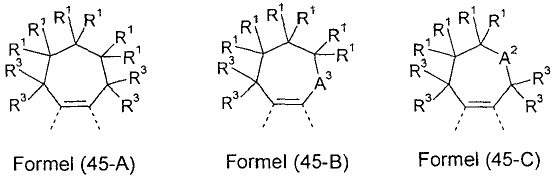 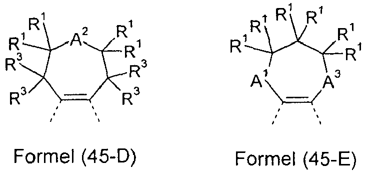 wobei R¹ und R³ die oben genannten Bedeutungen aufweisen und A¹, A² und A³ gleich oder verschieden bei jedem Auftreten für O oder NR³ steht.

In einer bevorzugten Ausführungsform der Struktur gemäß Formel (46) stehen die Reste R¹, die an den Brückenkopf gebunden sind, für H, D, F oder CH₃. Weiterhin bevorzugt steht A² für C(R¹)₂ oder O, und besonders bevorzugt für C(R³)₂. Bevorzugte Ausführungsformen der Formel (46) sind somit Strukturen der Formel (46-A) und (46-B), und eine besonders bevorzugte Ausführungsform der Formel (46-A) ist eine Struktur der Formel (46-C), 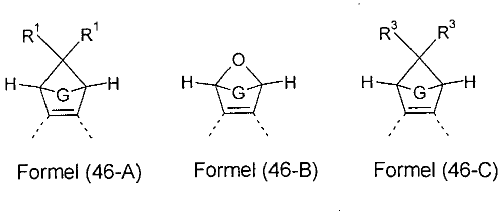 wobei die verwendeten Symbole die oben genannten Bedeutungen aufweisen.

In einer bevorzugten Ausführungsform der Struktur gemäß Formel (47), (48) und (49) stehen die Reste R¹, die an den Brückenkopf gebunden sind, für H, D, F oder CH₃. Weiterhin bevorzugt steht A² für C(R¹)₂. Bevorzugte Ausführungsformen der Formel (47), (48) und (49) sind somit die Strukturen der Formeln (47-A), (48-A) und (49-A), 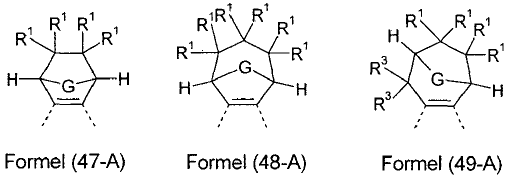 wobei die verwendeten Symbole die oben genannten Bedeutungen aufweisen.

Weiterhin bevorzugt steht die Gruppe G in den Formeln (46), (46-A), (46-B), (46-C), (47), (47-A), (48), (48-A), (49) und (49-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (43) bis (49) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (43) bis (49) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (43) sind die im Folgenden aufgeführten Gruppen (43-1) bis (43-71):

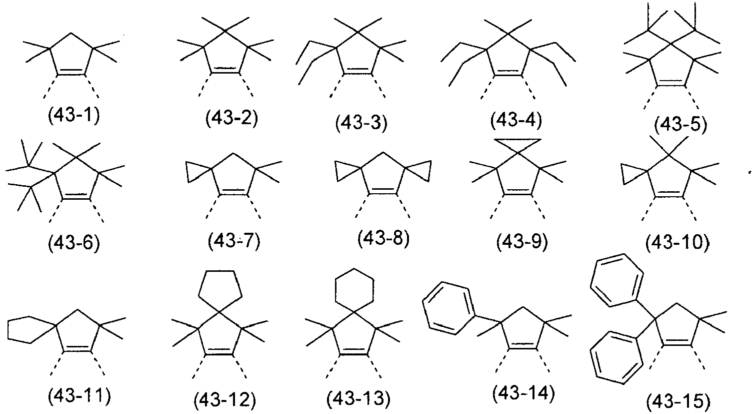

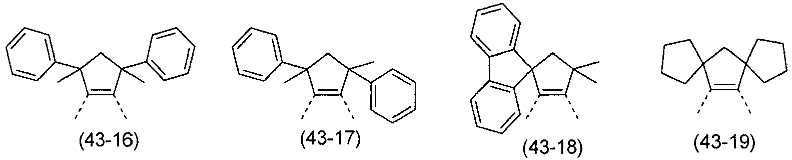

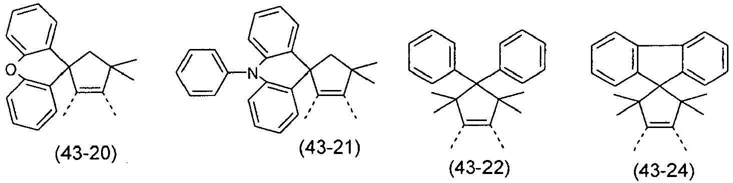

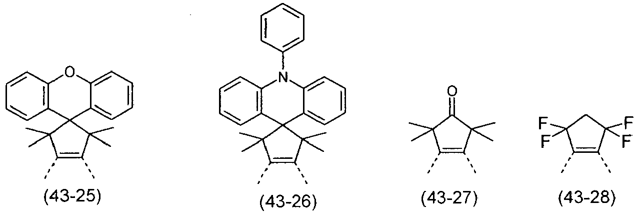

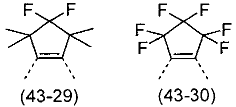

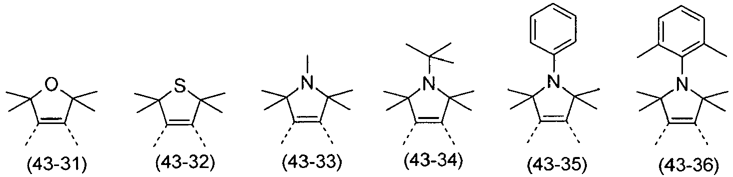

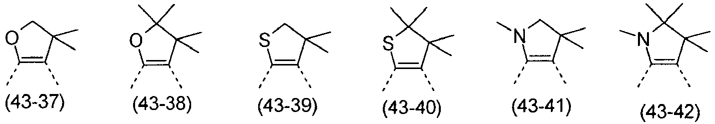

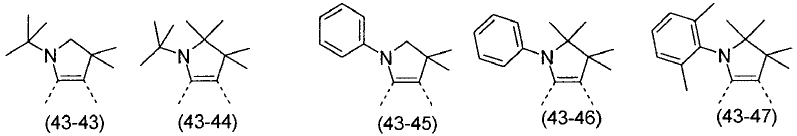

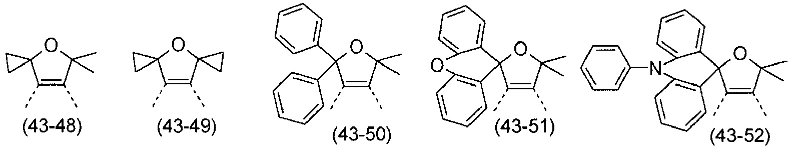

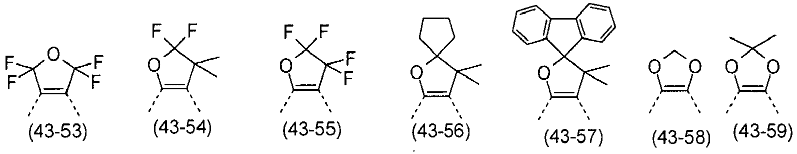

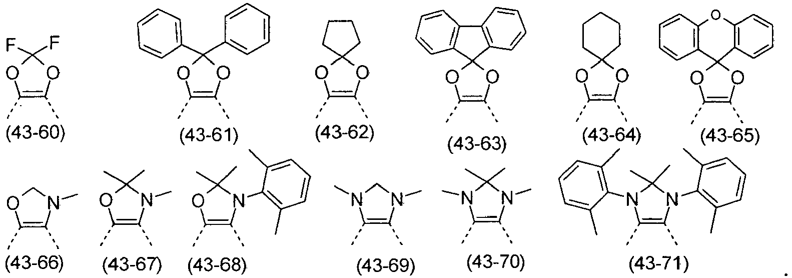

Beispiele für besonders geeignete Gruppen der Formel (44) sind die im Folgenden aufgeführten Gruppen (44-1) bis (44-14):

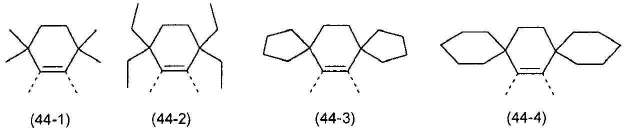

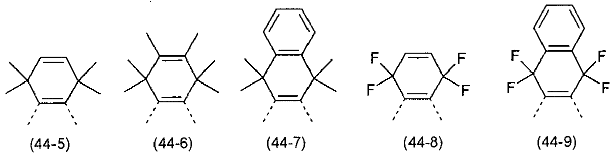

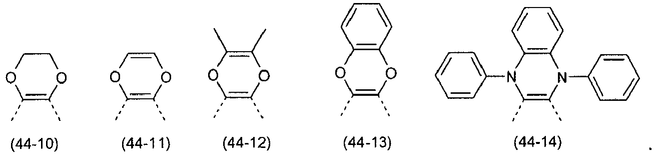

Beispiele für besonders geeignete Gruppen der Formel (45), (48) und (49) sind die im Folgenden aufgeführten Gruppen (45-1), (48-1) und (49-1):

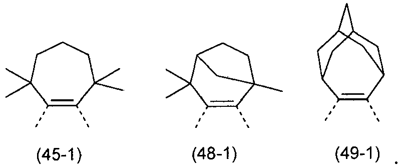

Beispiele für besonders geeignete Gruppen der Formel (46) sind die im Folgenden aufgeführten Gruppen (46-1) bis (46-22):

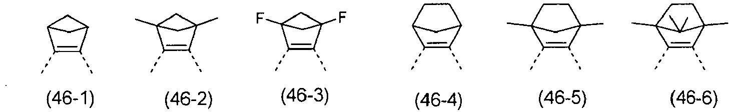

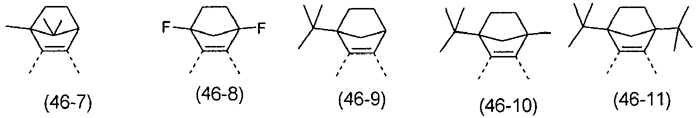

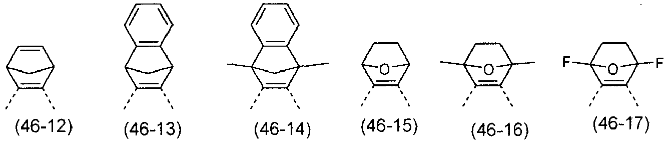

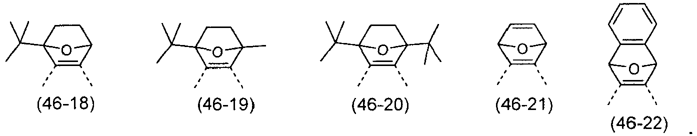

Beispiele für besonders geeignete Gruppen der Formel (47) sind die im Folgenden aufgeführten Gruppen (47-1) bis (47-5):

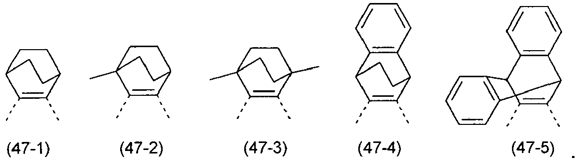

Wenn in den bidentaten Teilliganden bzw. in den bivalenten Arylen- bzw. Heteroarylengruppen der Formel (6), welche in den Formeln (1) bis (5) bzw. den bevorzugten Ausführungsformen gebunden sind, Reste R gebunden sind, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Bevorzugte Reste R¹, die an R gebunden sind, sind bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono- oder polycyclisches, aliphatisches Ringsystem bilden.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Wie oben beschrieben, können die erfindungsgemäßen Metallkomplexe auch durch eine weitere Brücke zu einem Kryptat geschlossen sein. Beispiele für geeignete Kryptate sind hinten bei den Beispielen aufgeführt. Eine besonders geeignete Brücke, die zur Bildung von Kryptaten verwendet werden kann, ist eine Brücke der oben genannten Formel (1) bzw. den bevorzugten Ausführungsformen. Weitere Beispiele für geeignete Brücken, die zur Bildung von Kryptaten verwendet werden können, sind die im Folgenden abgebildeten Strukturen:

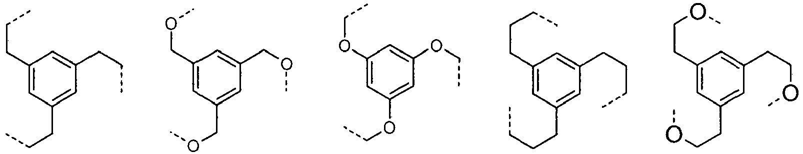

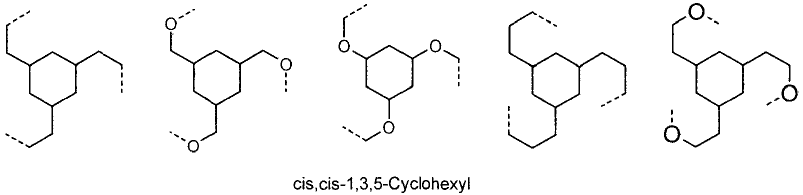

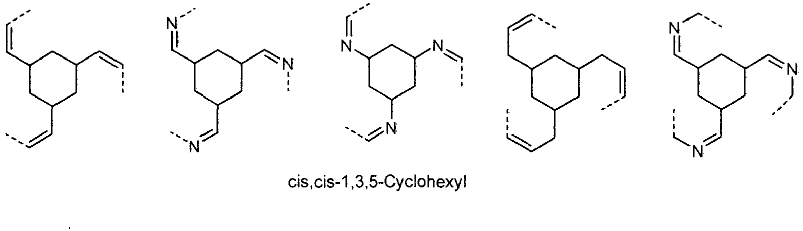

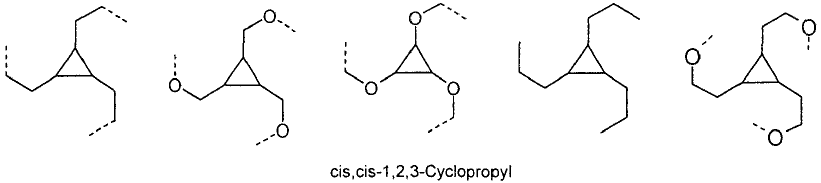

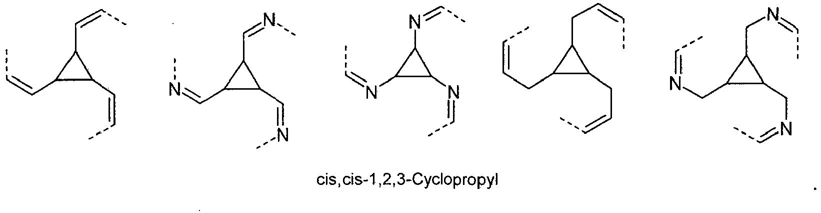

Dabei sind diese Brücken für die Bildung von Kryptaten bevorzugt jeweils am Liganden in der meta-Position zur Koordination an das Metall gebunden. Wenn also die Teilliganden die Strukturen (CyC-1) bis (CyC-20) bzw. (CyD-1) bis (CyD-20) bzw. die bevorzugten Ausführungsformen dieser Gruppen enthalten, dann sind die oben genannten Brücken zur Bildung von Kryptaten bevorzugt jeweils in den mit "o" gekennzeichneten Positionen gebunden.

Bei den erfindungsgemäßen Metallkomplexen handelt es sich um chirale Strukturen. Wenn zusätzlich auch der tripodale Ligand der Komplexe chiral ist, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Werden in der ortho-Metallierung C₃- bzw. C₃ᵥ-symmetrische Liganden eingesetzt, fällt üblicherweise ein racemisches Gemisch der C₃-symmetrischen Komplexe, also des Δ- und des Λ-Enantiomers, an. Diese können durch gängige Methoden (Chromatographie an chiralen Materialien / Säulen oder Racemattrennung durch Kristallisation) getrennt werden. Dies ist im folgenden Schema am Beispiel eines C₃-symmetrischen Liganden, der drei Phenylpyridin-Teilliganden trägt, gezeigt und gilt in analoger Form auch für alle anderen C₃- bzw. C₃ᵥ-symmetrischen Liganden.

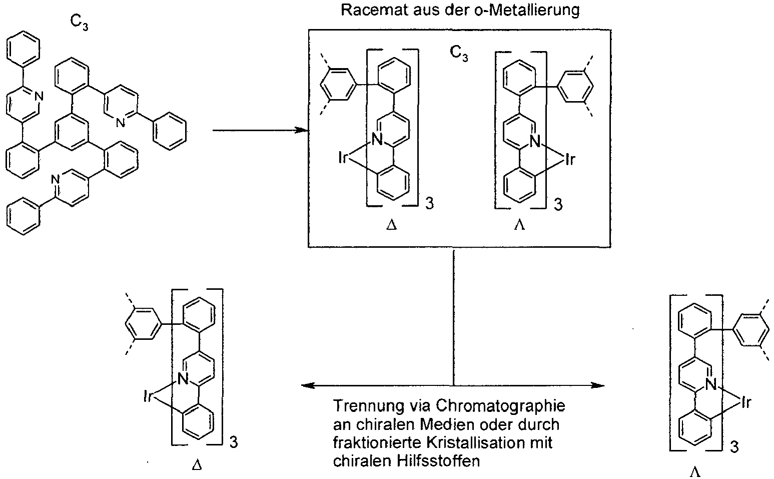

Die Racemattrennung via fraktionierter Kristallisation von diastereomeren Salzpaaren kann nach üblichen Methoden erfolgen. Hierzu bietet es sich an, die neutralen Ir(III)-Komplexe zu oxidieren (z. B. mit Peroxiden, H₂O₂ oder elektrochemisch), die so erzeugten kationischen Ir(IV)-Komplexe mit dem Salz einer enantiomerenreinen, monoanionischen Base (chirale Base) zu versetzen, die so erzeugten diasteromeren Salze durch fraktionierte Kristallisation zu trennen und diese dann mit Hilfe eines Reduktionsmittels (z. B. Zink, Hydrazinhydrat, Ascorbinsäure, etc.) zu den enantiomerenreinen neutralen Komplex zu reduzieren, wie im Folgenden schematisch dargestellt.

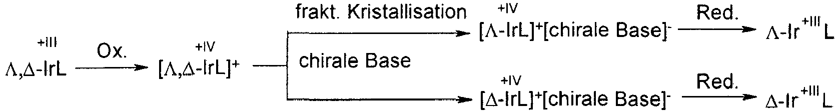

Daneben ist eine enantiomerenreine bzw. enantiomerenanreichernde Synthese durch Komplexierung in einem chiralen Medium (z. B. R- oder S-1,1-Binaphthol) möglich.

Analoge Verfahren können auch mit Komplexen C1- bzw. Cₛ-symmetrischer Liganden durchgeführt werden.

Werden in der Komplexierung C₁- symmetrische Liganden eingesetzt, fällt üblicherweise ein Diastereomerengemisch der Komplexe an, das durch gängige Methoden (Chromatographie, Kristallisation) getrennt werden kann.

Enantiomerenreine C₃-symmetrische Komplexe können auch gezielt synthetisiert werden, wie im folgenden Schema dargestellt. Dazu wird ein enantiomerenreiner, C₃-symmetrischer Ligand dargestellt, komplexiert, das erhaltene Diasteroemerengemisch wird getrennt und anschließend wird die chirale Gruppe abgespalten.

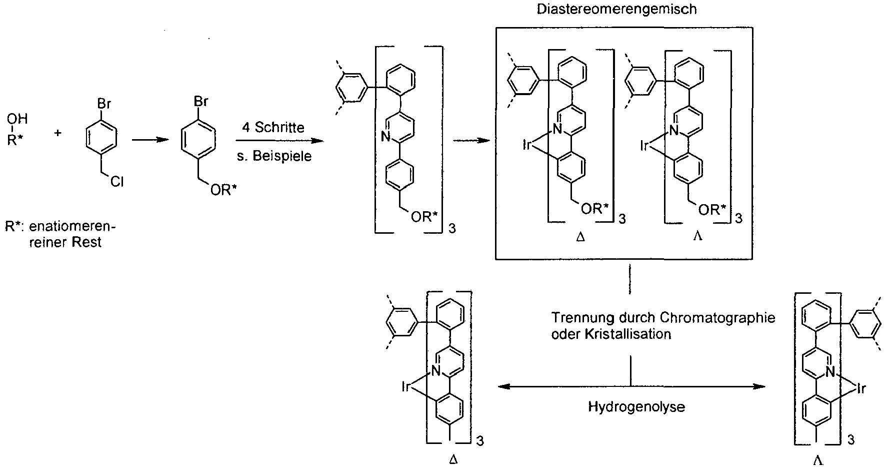

Die erfindungsgemäßen Metallkomplexe sind prinzipiell durch verschiedene Verfahren darstellbar. Generell wird hierzu ein Metallsalz mit dem entsprechenden freien Liganden umgesetzt.

Daher ist ein weiterer Gegenstand der vorliegenden Erfindung ein Verfahren zur Herstellung der erfindungsgemäßen Metallkomplexe durch Umsetzung der entsprechenden freien Liganden mit Metallalkoholaten der Formel (50), mit Metallketoketonaten der Formel (51), mit Metallhalogeniden der Formel (52) oder mit Metallcarboxylaten der Formel (53), 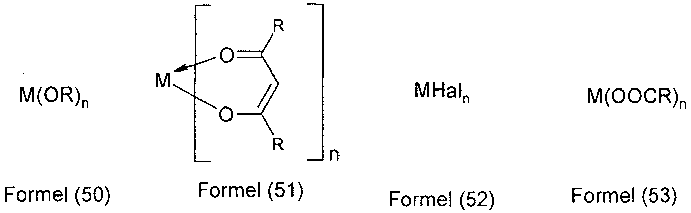 wobei M für das Metall des erfindungsgemäßen Metallkomplexes, der synthetisiert wird, steht, n für die Wertigkeit des Metalls M steht, R die oben angegebenen Bedeutungen hat, Hal = F, Cl, Br oder I ist und die Metalledukte auch als die entsprechenden Hydrate vorliegen können. Dabei steht R bevorzugt für eine Alkylgruppe mit 1 bis 4 C-Atomen.

Es können ebenfalls Metallverbindungen, insbesondere Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht.

Die Synthese der Komplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können auch Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bis-phenoxybenzol, Triphenylphosphinoxid, 18-Krone-6, Phenol, 1-Naphthol, Hydrochinon, etc.. Dabei ist die Verwendung von Hydrochinon besonders bevorzugt.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Metallkomplexe können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (43) bis (49) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Die erfindungsgemäßen Metallkomplexe können auch mit einem Polymer gemischt werden. Ebenso ist es möglich, diese Metallkomplexe kovalent in ein Polymer einzubauen. Dies ist insbesondere möglich mit Verbindungen, welche mit reaktiven Abgangsgruppen, wie Brom, Iod, Chlor, Boronsäure oder Boronsäureester, oder mit reaktiven, polymerisierbaren Gruppen, wie Olefinen oder Oxetanen, substituiert sind. Diese können als Monomere zur Erzeugung entsprechender Oligomere, Dendrimere oder Polymere Verwendung finden. Die Oligomerisation bzw. Polymerisation erfolgt dabei bevorzugt über die Halogenfunktionalität bzw. die Boronsäurefunktionalität bzw. über die polymerisierbare Gruppe. Es ist weiterhin möglich, die Polymere über derartige Gruppen zu vernetzen. Die erfindungsgemäßen Verbindungen und Polymere können als vernetzte oder unvernetzte Schicht eingesetzt werden.

Weiterer Gegenstand der Erfindung sind daher Oligomere, Polymere oder Dendrimere enthaltend eine oder mehrere der oben aufgeführten erfindungsgemäßen Metallkomplexe, wobei statt eines oder mehrerer Wasserstoffatome und/oder Substituenten ein oder mehrere Bindungen des erfindungsgemäßen Metallkomplexes zum Polymer, Oligomer oder Dendrimer vorhanden sind. Je nach Verknüpfung des erfindungsgemäßen Metallkomplexes bildet diese daher eine Seitenkette des Oligomers oder Polymers oder ist in der Hauptkette verknüpft. Die Polymere, Oligomere oder Dendrimere können konjugiert, teilkonjugiert oder nicht-konjugiert sein. Die Oligomere oder Polymere können linear, verzweigt oder dendritisch sein. Für die Wiederholeinheiten der erfindungsgemäßen Metallkomplexe in Oligomeren, Dendrimeren und Polymeren gelten dieselben Bevorzugungen, wie oben beschrieben.

Zur Herstellung der Oligomere oder Polymere werden die erfindungsgemäßen Monomere homopolymerisiert oder mit weiteren Monomeren copolymerisiert. Bevorzugt sind Copolymere, wobei die erfindungsgemäßen Metallkomplexe zu 0.01 bis 99.9 mol%, bevorzugt 5 bis 90 mol%, besonders bevorzugt 5 bis 50 mol% vorhanden sind. Geeignete und bevorzugte Comonomere, welche das Polymergrundgerüst bilden, sind gewählt aus Fluorenen (z. B. gemäß EP 842208 oder WO 2000/022026), Spirobifluorenen (z. B. gemäß EP 707020, EP 894107 oder WO 2006/061181), Para-phenylenen (z. B. gemäß WO 92/18552), Carbazolen (z. B. gemäß WO 2004/070772 oder WO 2004/113468), Thiophenen (z. B. gemäß EP 1028136), Dihydrophenanthrenen (z. B. gemäß WO 2005/014689), cis- und trans-Indenofluorenen (z. B. gemäß WO 2004/041901 oder WO 2004/113412), Ketonen (z. B. gemäß WO 2005/040302), Phenanthrenen (z. B. gemäß WO 2005/104264 oder WO 2007/017066) oder auch mehreren dieser Einheiten. Die Polymere, Oligomere und Dendrimere können noch weitere Einheiten enthalten, beispielsweise Lochtransporteinheiten, insbesondere solche basierend auf Triarylaminen, und/oder Elektronentransporteinheiten.

Für die Verarbeitung der erfindungsgemäßen Metallkomplexe aus flüssiger Phase, beispielsweise durch Spin-Coating oder durch Druckverfahren, sind Formulierungen der erfindungsgemäßen Metallkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan oder Mischungen dieser Lösemittel.

Ein weiterer Gegenstand der vorliegenden Erfindung ist daher eine Formulierung, enthaltend mindestens einen erfindungsgemäßen Metallkomplex bzw. mindestens ein erfindungsgemäßes Oligomer, Polymer oder Dendrimer und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Der oben beschriebene erfindungsgemäße Metallkomplex bzw. die oben aufgeführten bevorzugten Ausführungsformen können in der elektronischen Vorrichtung als aktive Komponente, bevorzugt als Emitter in der emissiven Schicht oder als Loch- oder Elektronentransportmaterial in einer loch- bzw. elektronentransportierenden Schicht, oder als Sauerstoff-Sensibilisatoren oder als Photoinitiator oder Photokatalysator verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator oder als Photoinitiator oder Photokatalysator. Enantiomerenreine erfindungsgemäße Metallkoplexe eignen sich als Photokatalysatoren für chirale photoinduzierte Synthesen.

Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Metallkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens einen erfindungsgemäßen Metallkomplex. Besonders bevorzugt sind organische Elektrolumineszenzvorrichtungen. Dies gilt insbesondere, wenn das Metall Iridium oder Aluminium ist. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden. Insbesondere wenn das Metall Ruthenium ist, ist der Einsatz als Photosensibilisator in einer farbstoffsensibilisierten Solarzelle ("Grätzel-Zelle") bevorzugt.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃, oder mit (per)fluorierten elektronenarmen Aromaten oder mit elektronenarmen Cyano-substituieren Heteroaromaten (z. B. gemäß JP 4747558, JP 2006-135145, US 2006/0289882, WO 2012/095143), oder mit chinoiden Systemen (z. B. gemäß EP1336208) oder mit Lewis-Säuren, oder mit Boranen (z. B. gemäß US 2003/0006411, WO 2002/051850, WO 2015/049030) oder mit Carboxylaten der Elemente der 3., 4. oder 5. Hauptgruppe (WO 2015/018539) und/oder dass eine oder mehrere Elektronentransportschichten n-dotiert sind.

Geeignete Ladungstransportmaterialien, wie sie in der Lochinjektions- bzw. Lochtransportschicht bzw. Elektronenblockierschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden.

Bevorzugt sind als Lochtransportmaterialien, die in einer Lochtransport-, Lochinjektions- oder Elektronenblockierschicht in der erfindungsgemäßen Elektrolumineszenzvorrichtung verwendet werden können, Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449), Dibenzoindenofluorenamine (z. B. gemäß WO 07/140847), Spirobifluoren-Amine (z. B. gemäß WO 2012/034627, WO2014/056565), Fluoren-Amine (z. B. gemäß EP 2875092, EP 2875699 und EP 2875004), Spiro-Dibenzopyran-Amine (z. B. EP 2780325) und Dihydroacridin-Derivate (z. B. gemäß WO 2012/150001).

Beispiele für geeignete Lochinjektions- und -transportmaterialien bzw. Elektronenblockiermaterialien sind die in der folgenden Tabelle abgebildeten Strukturen.

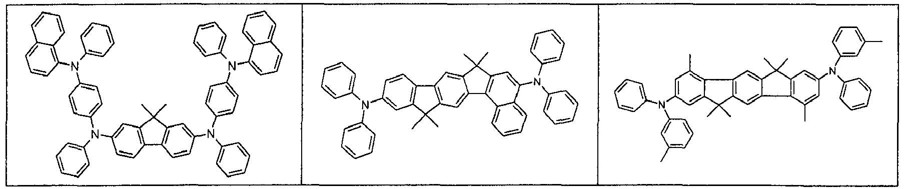

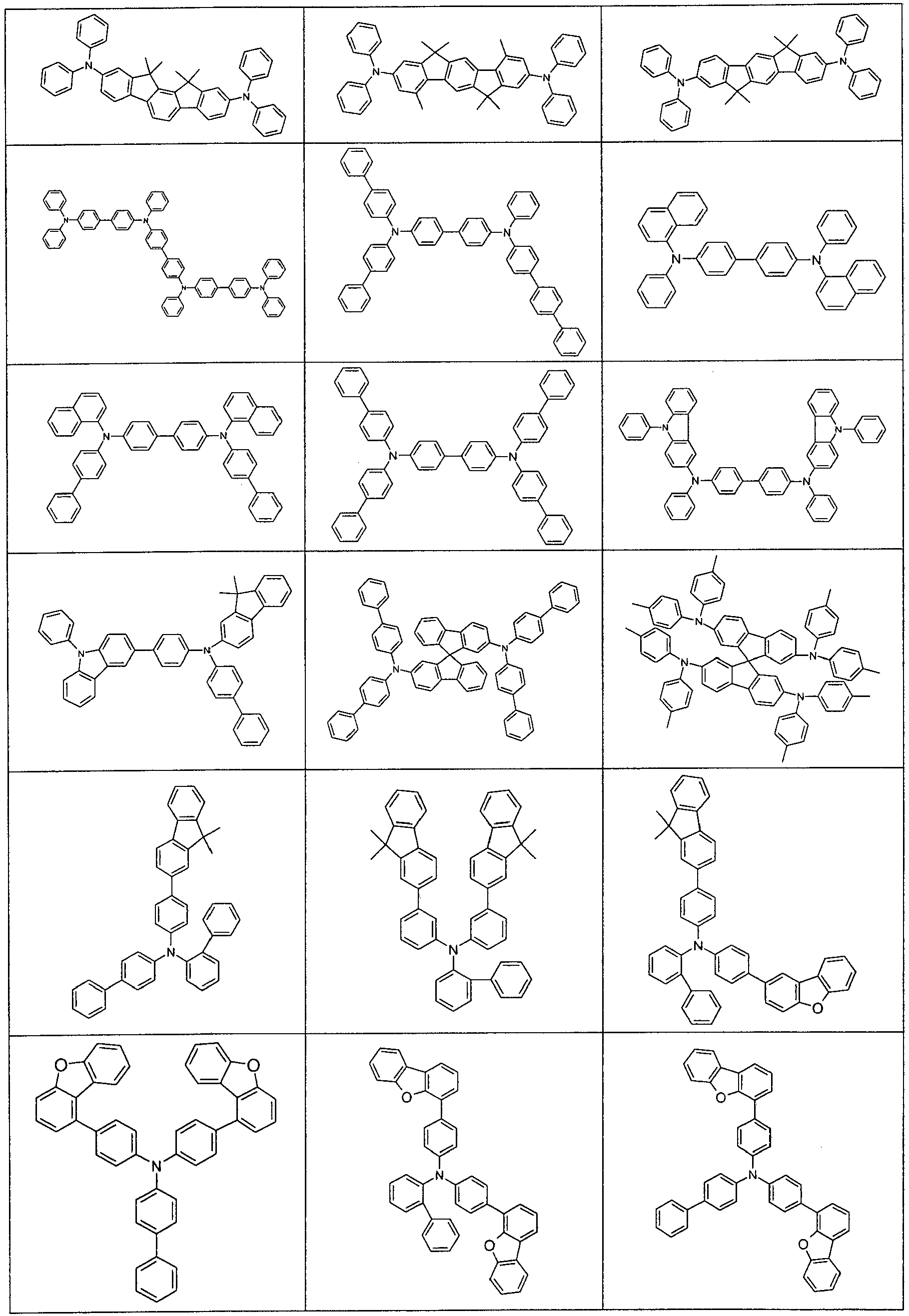

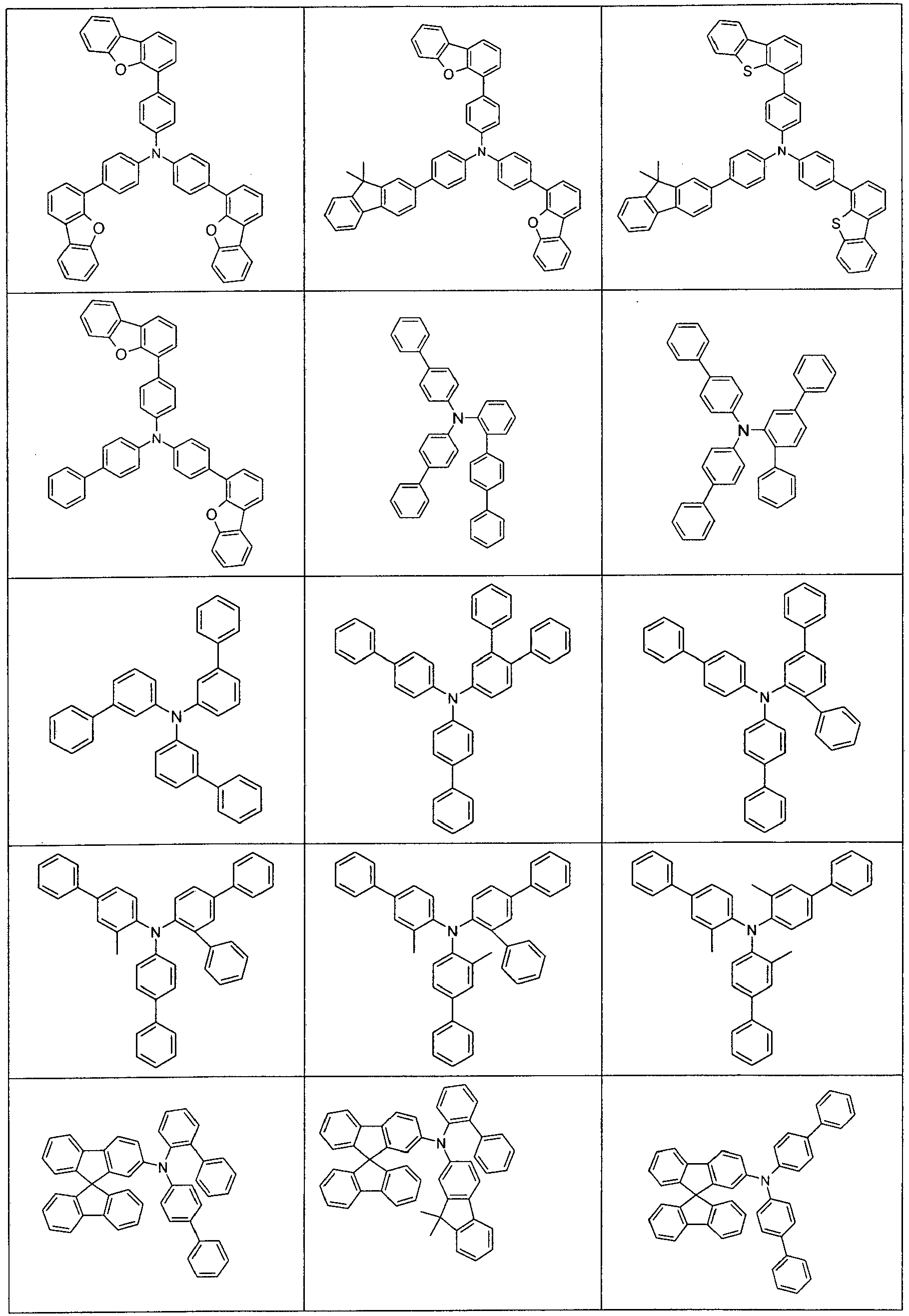

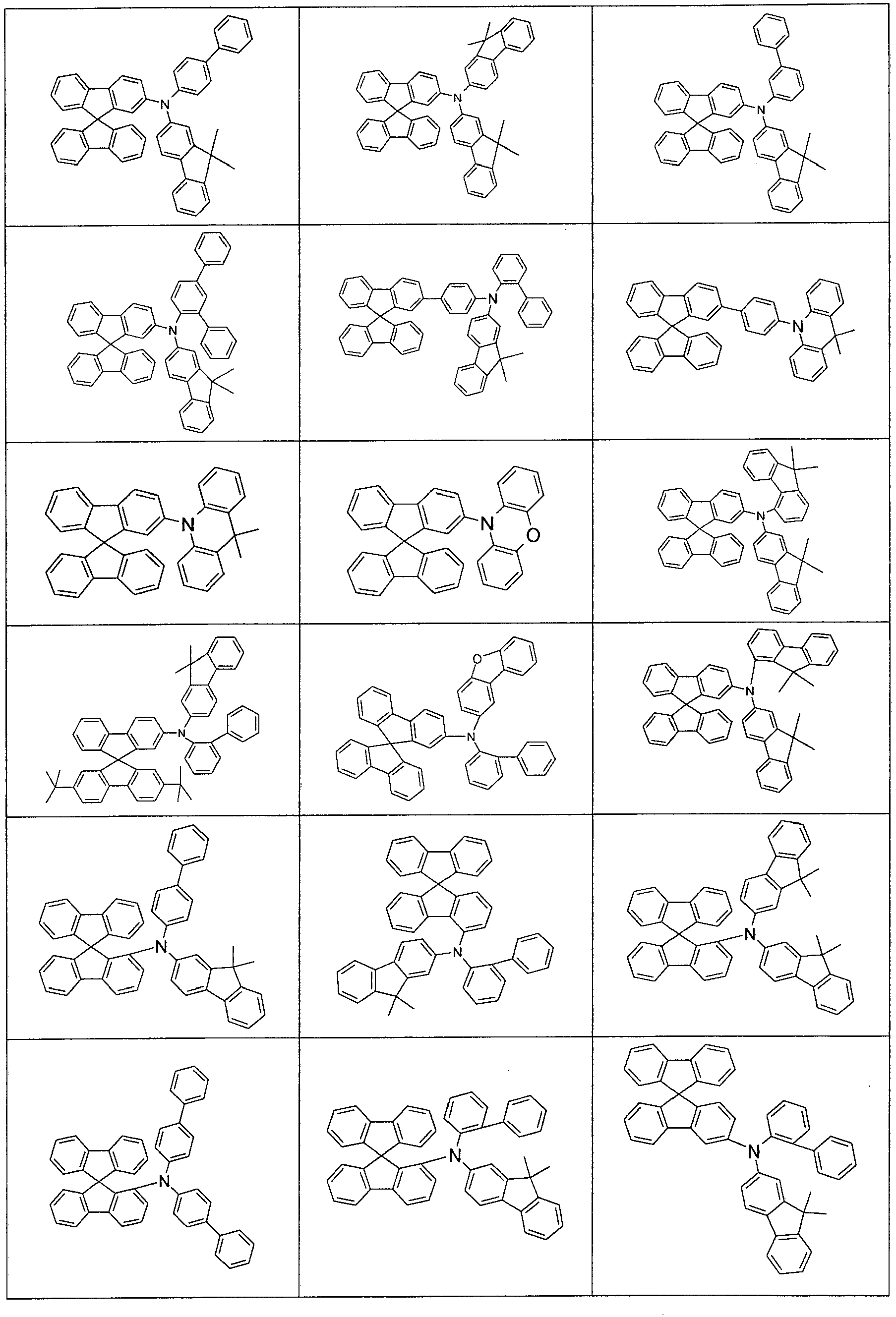

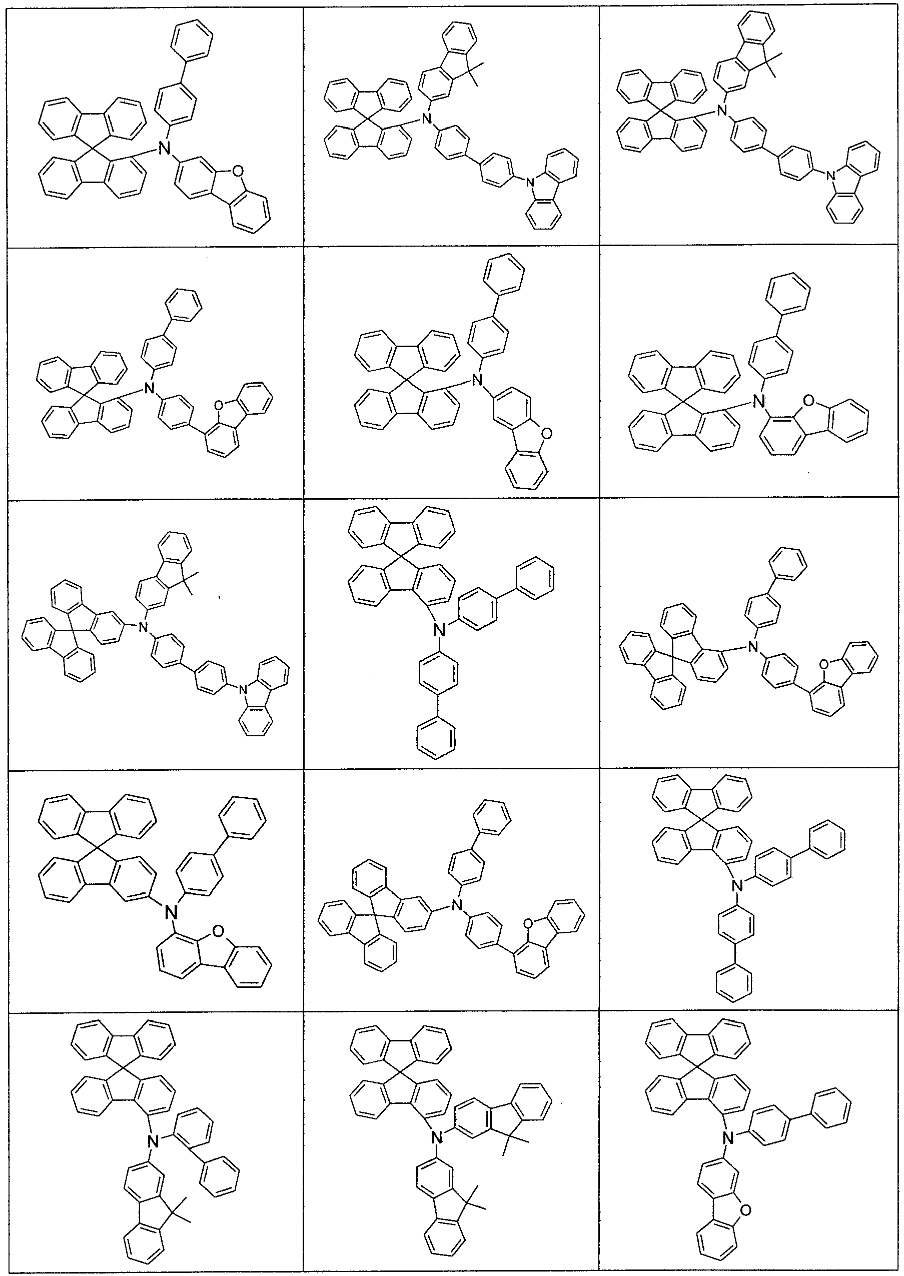

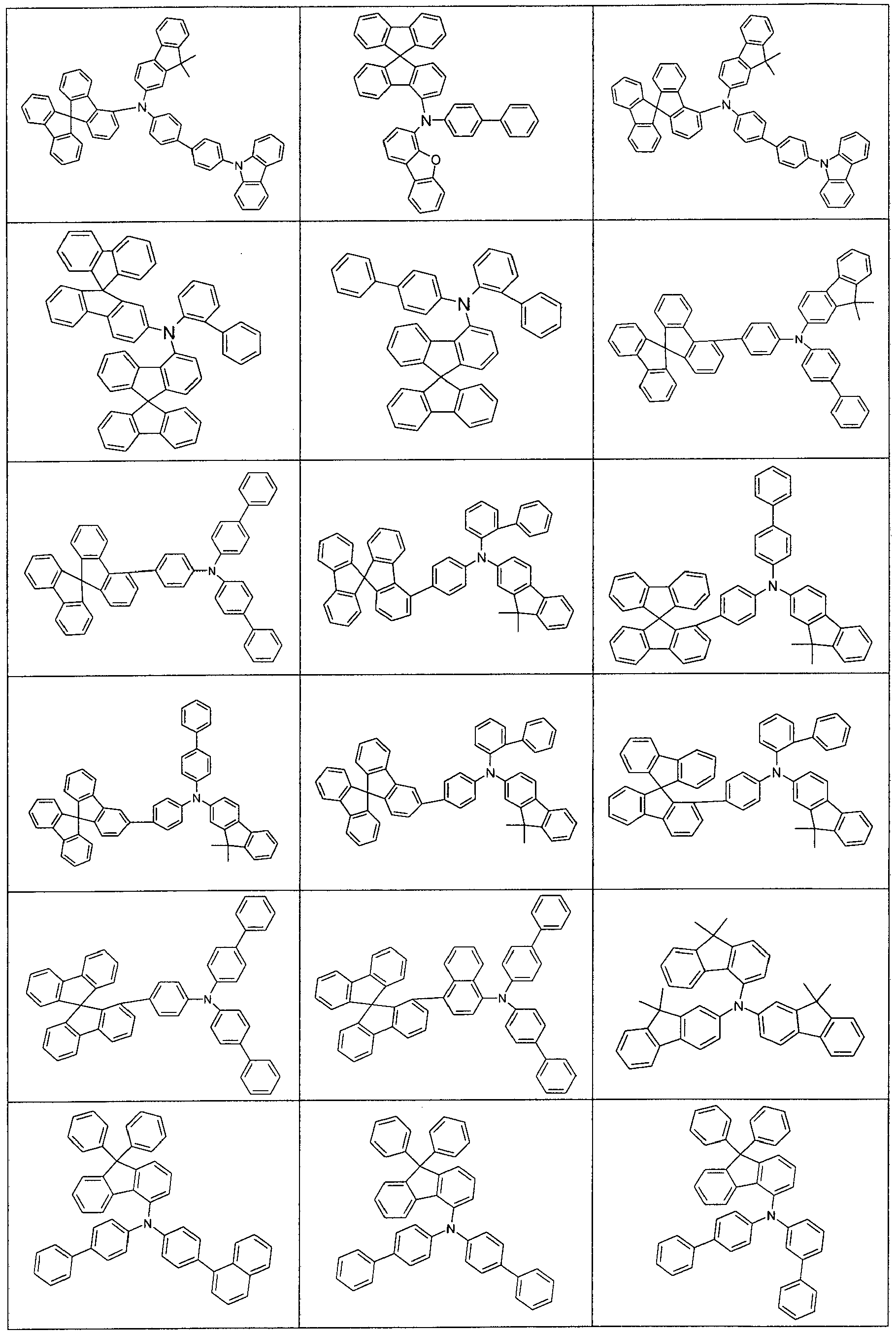

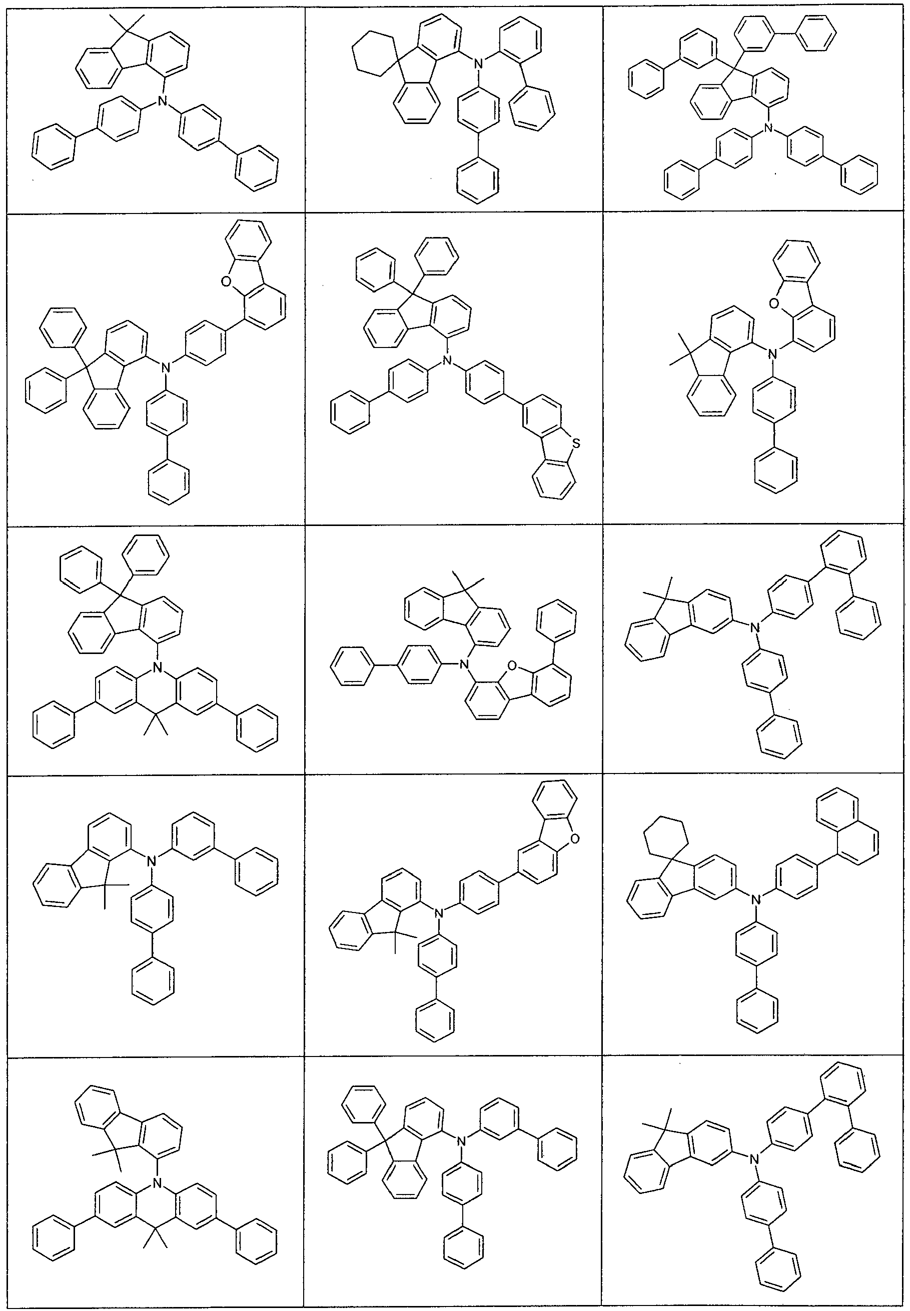

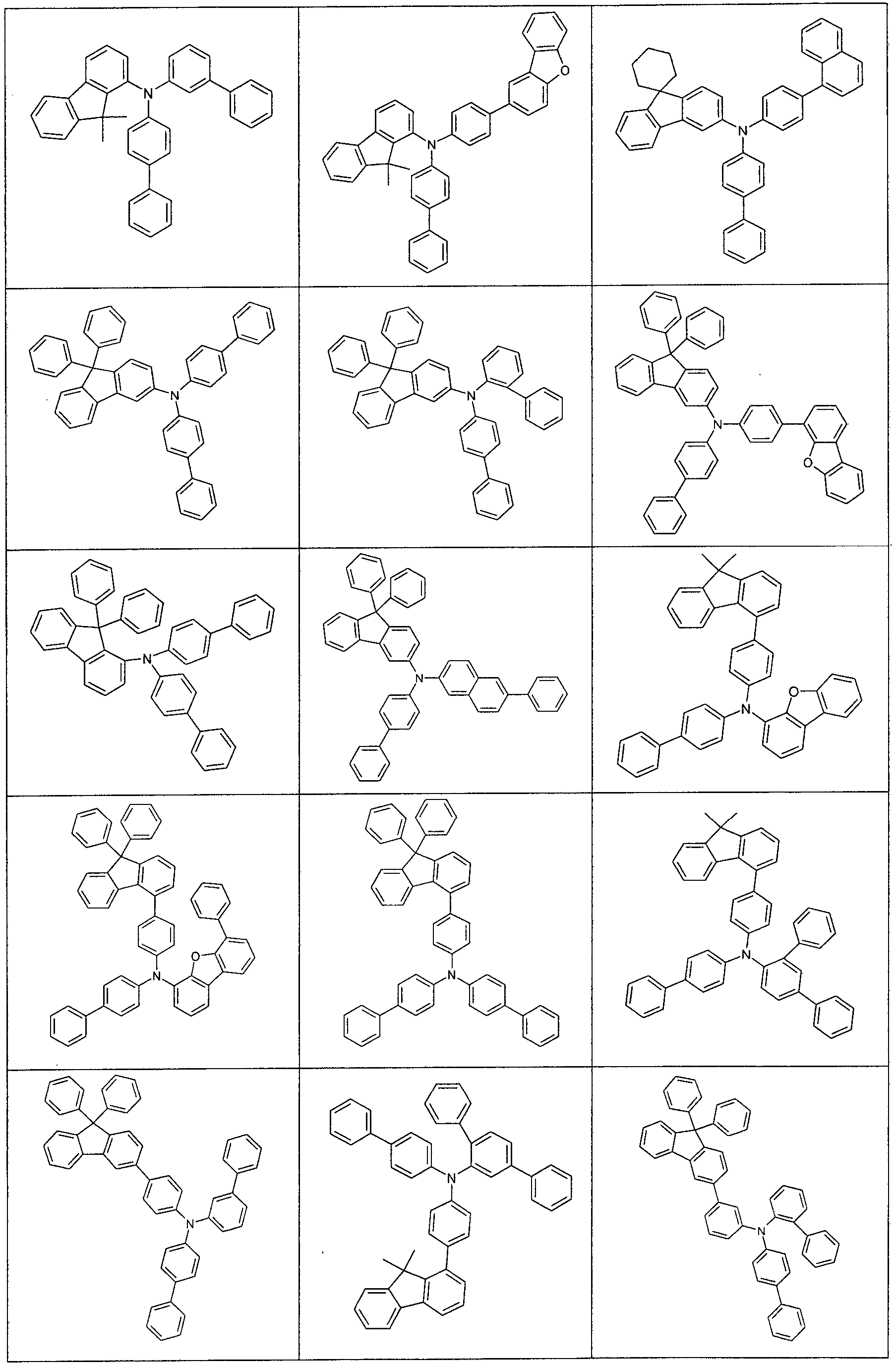

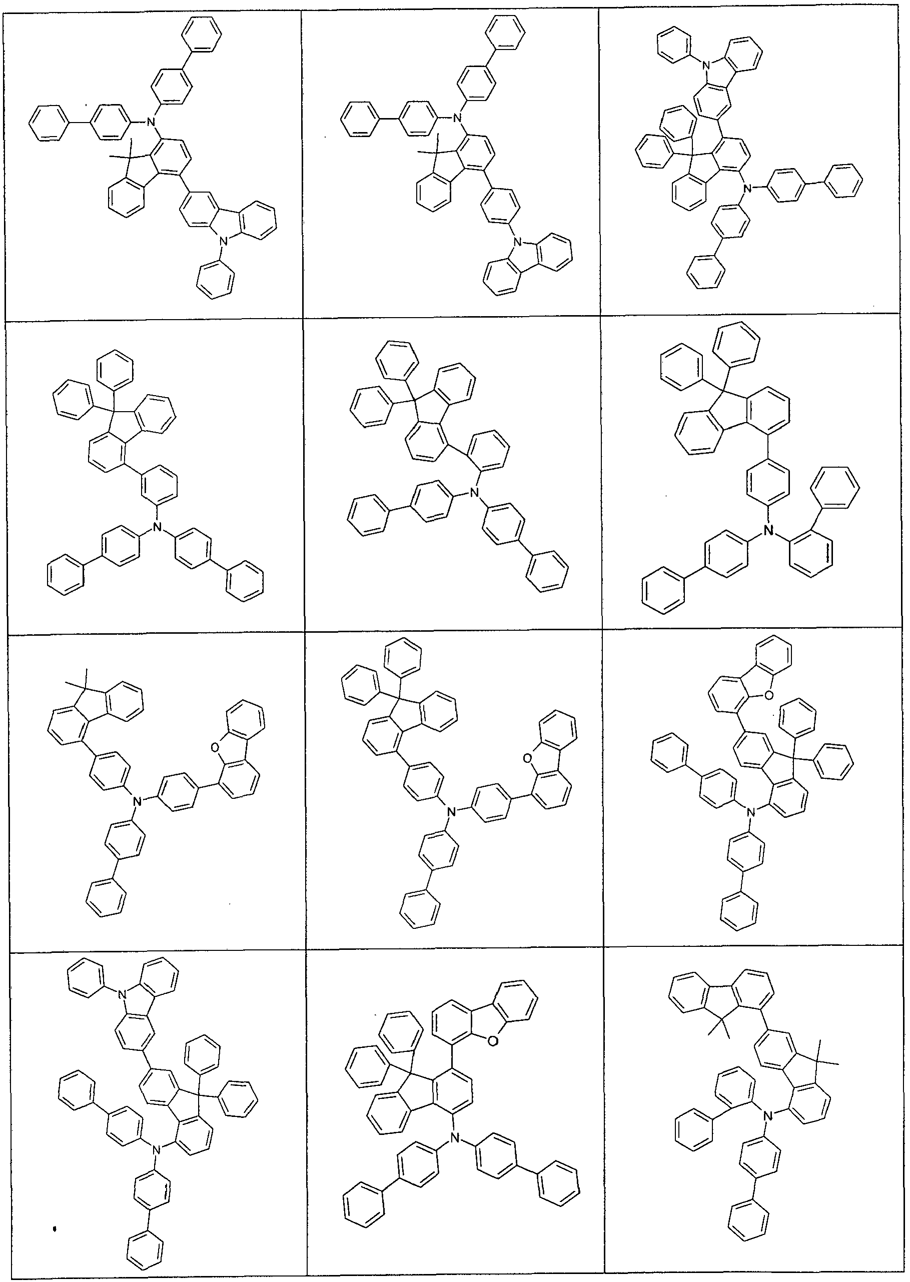

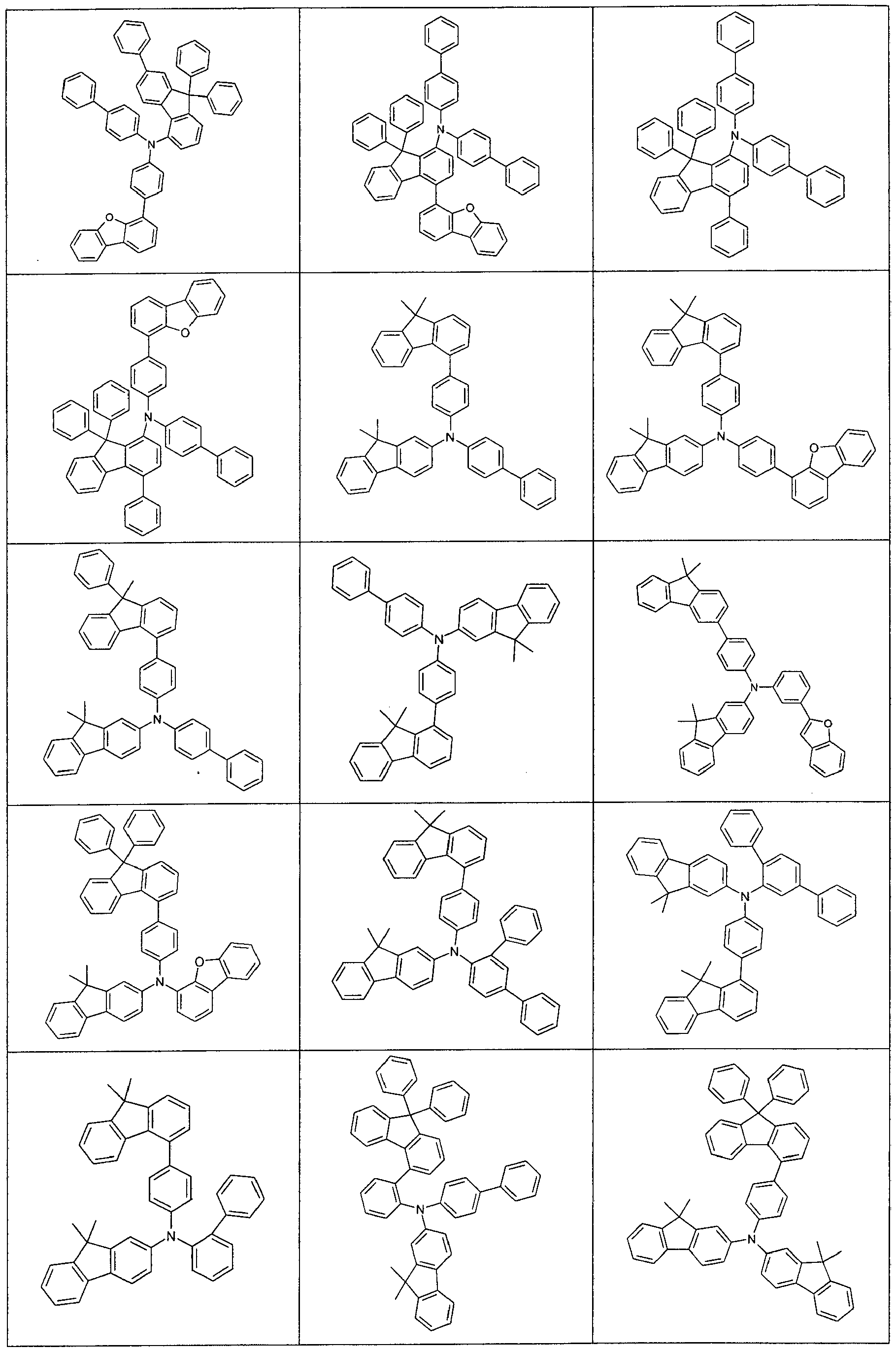

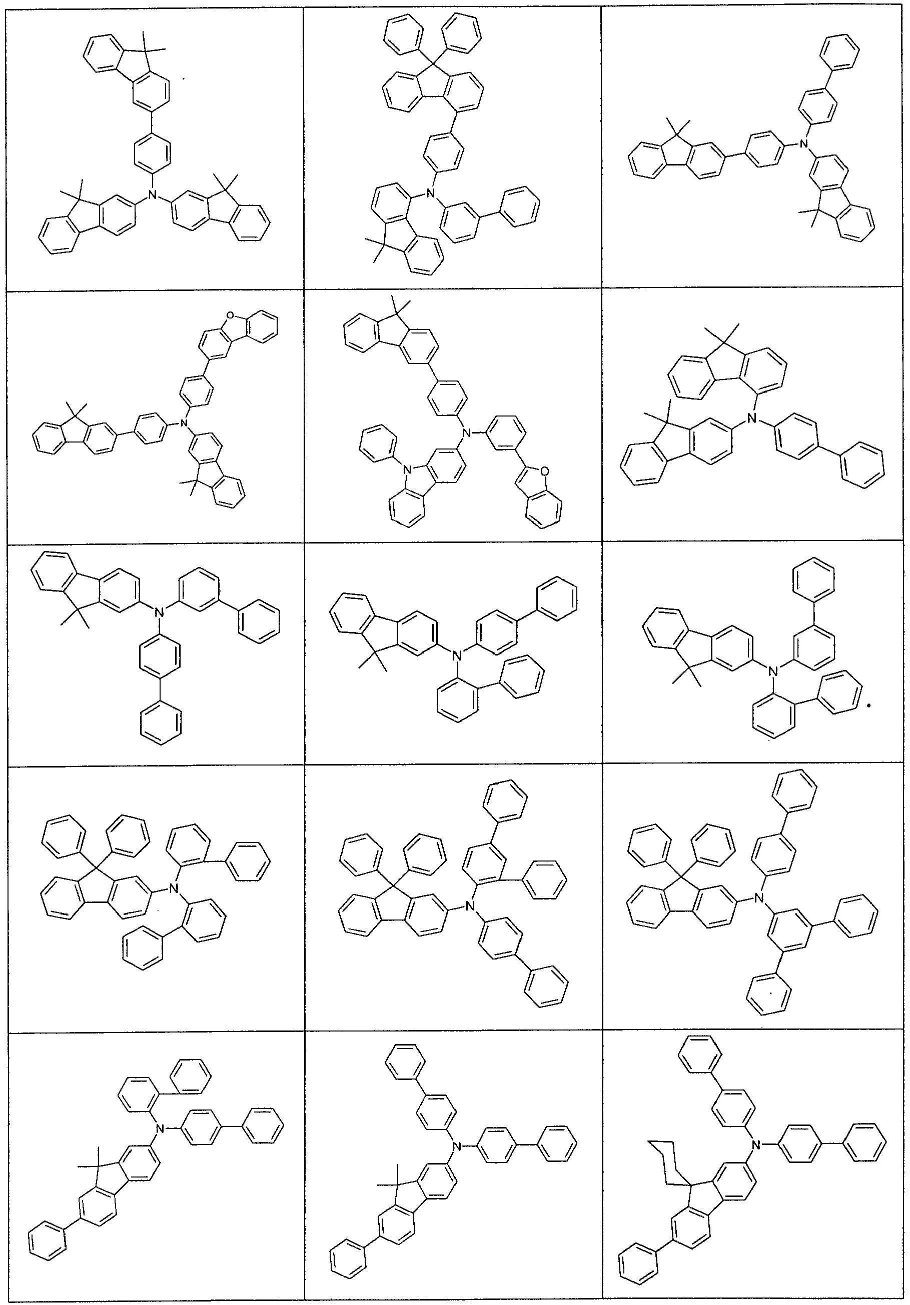

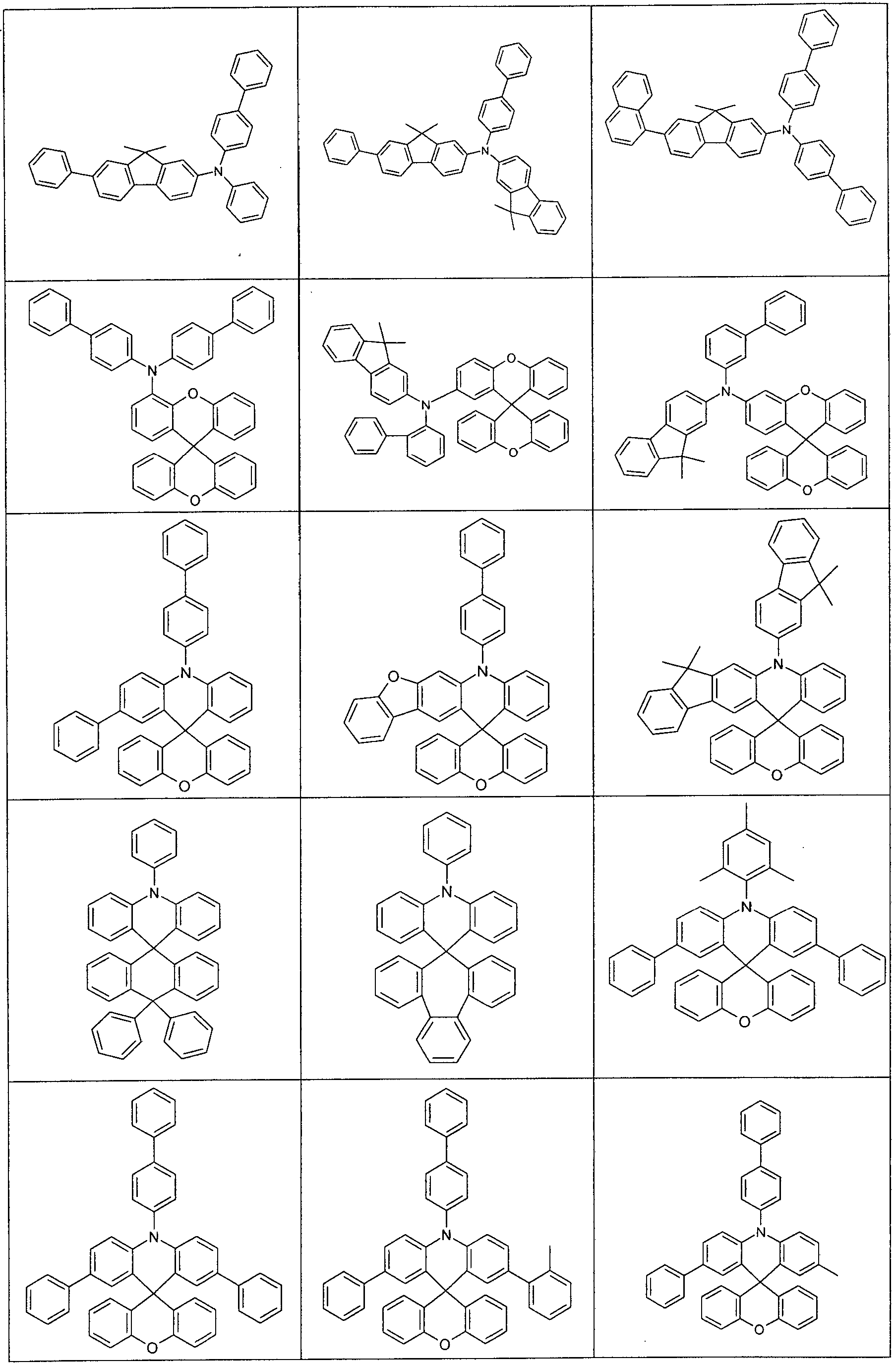

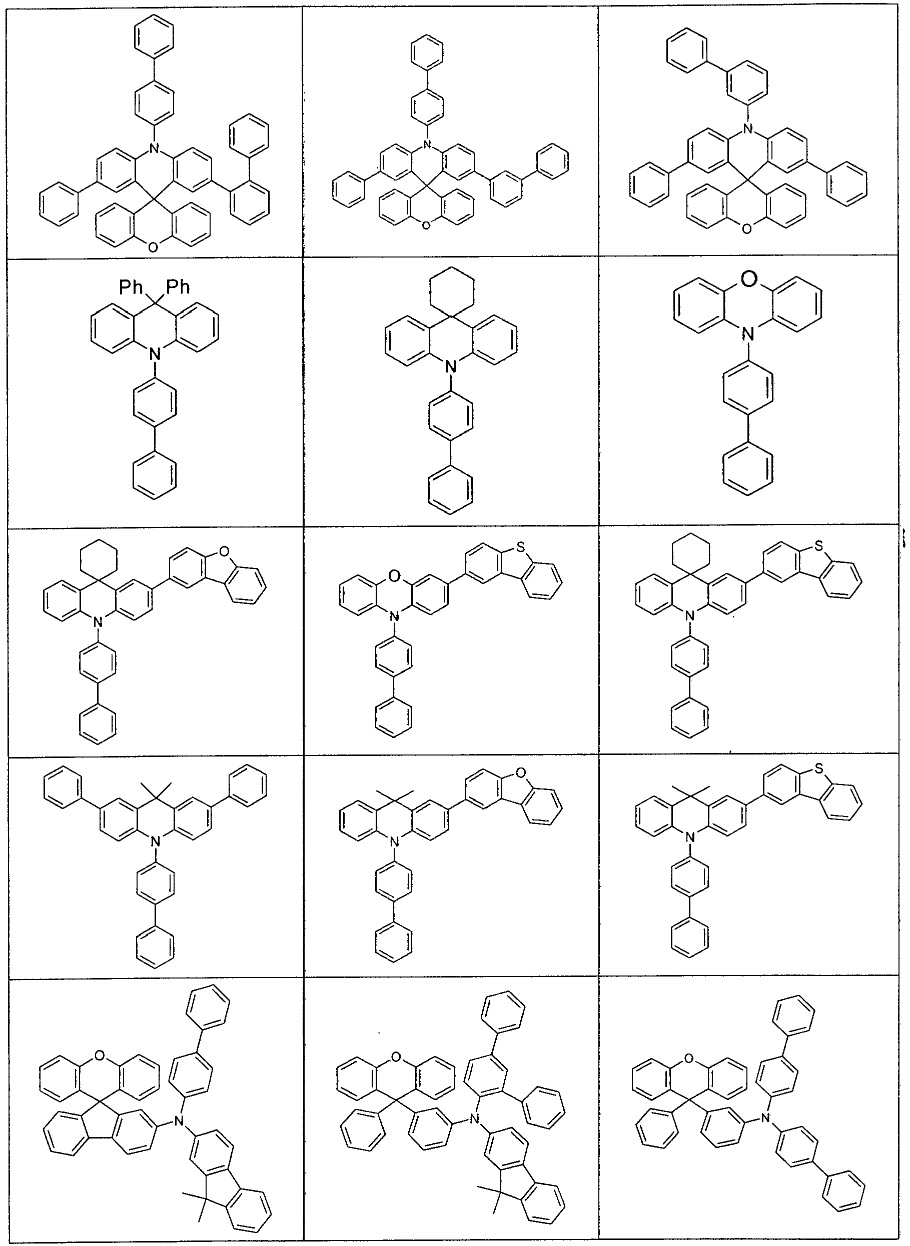

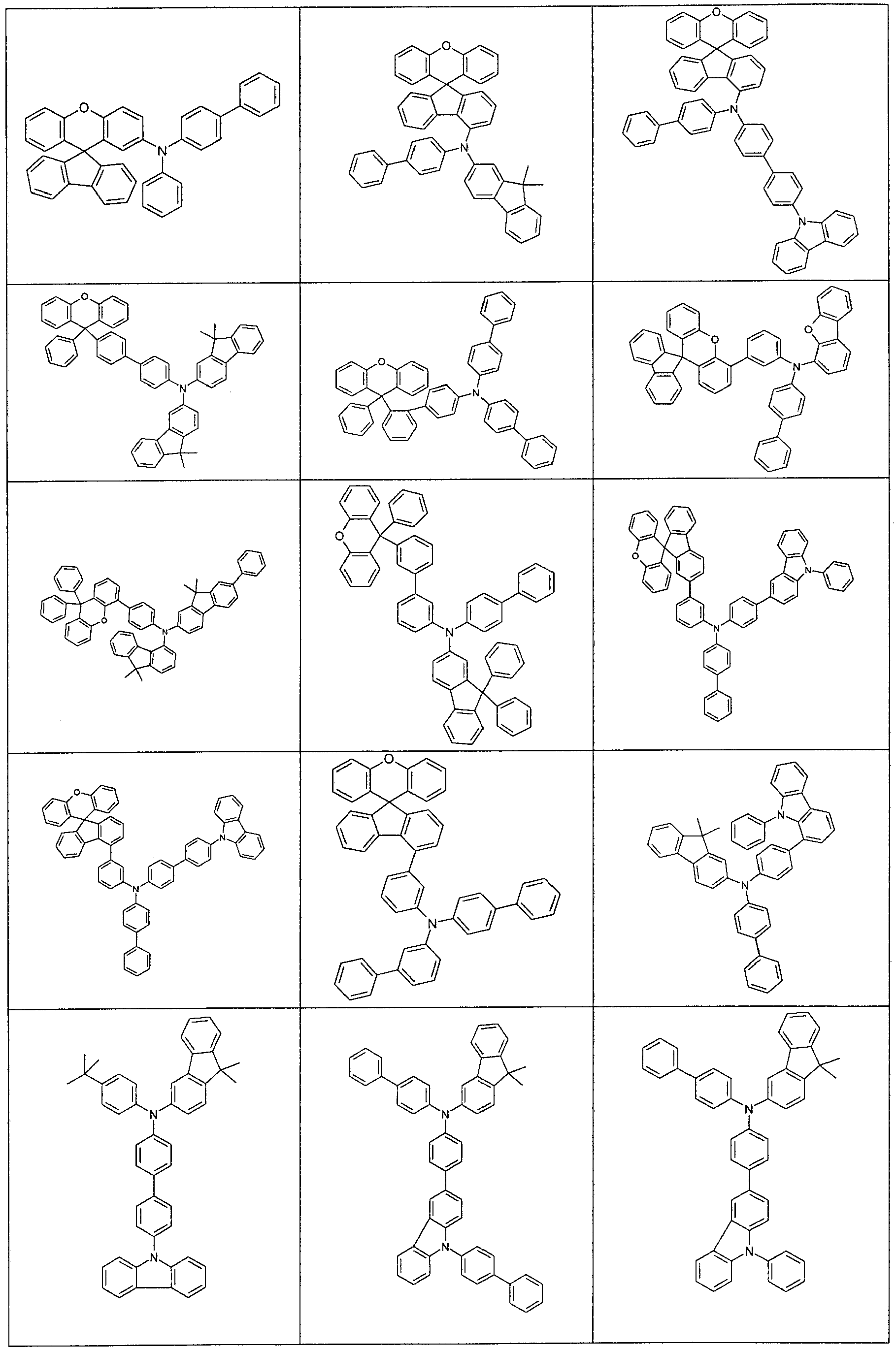

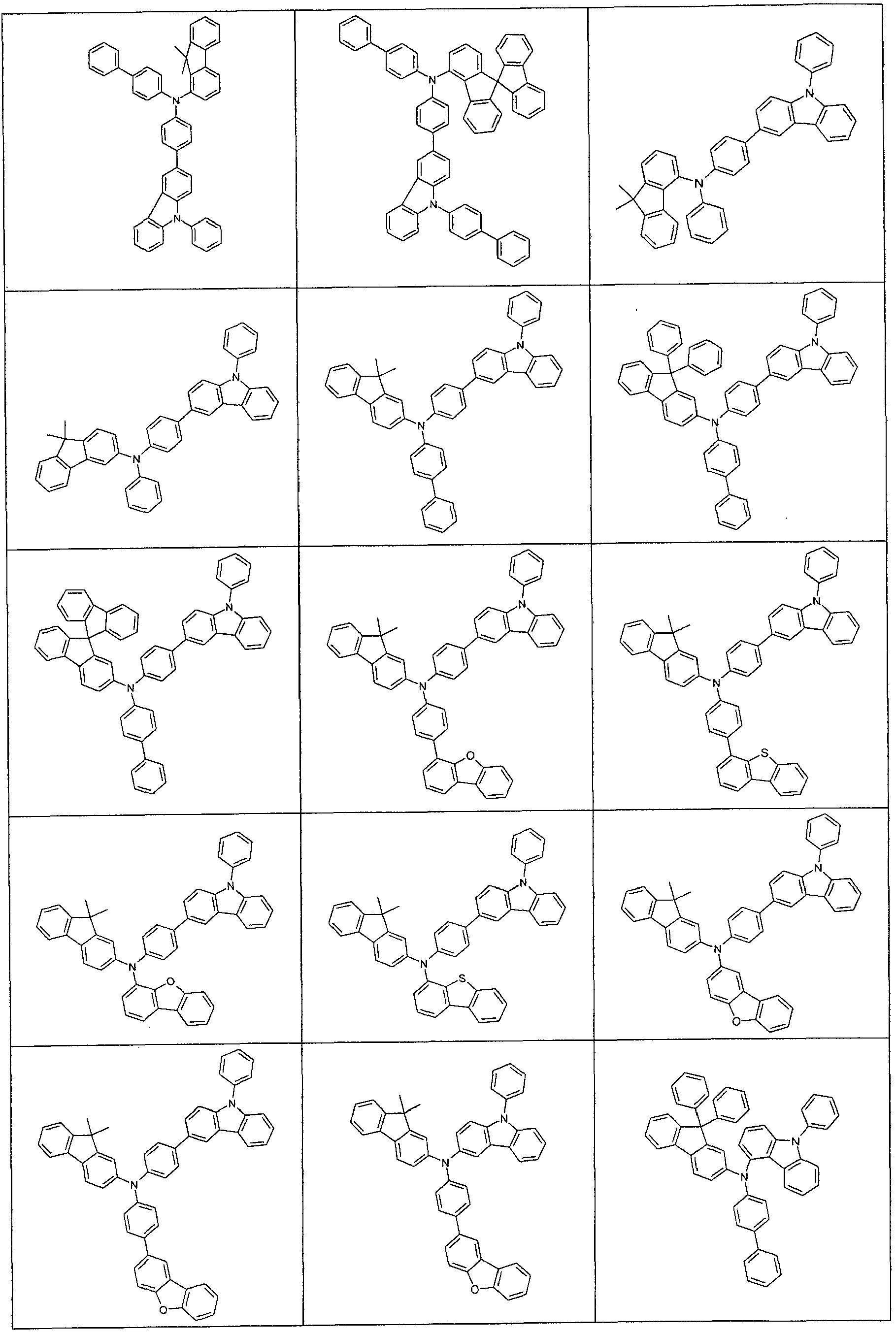

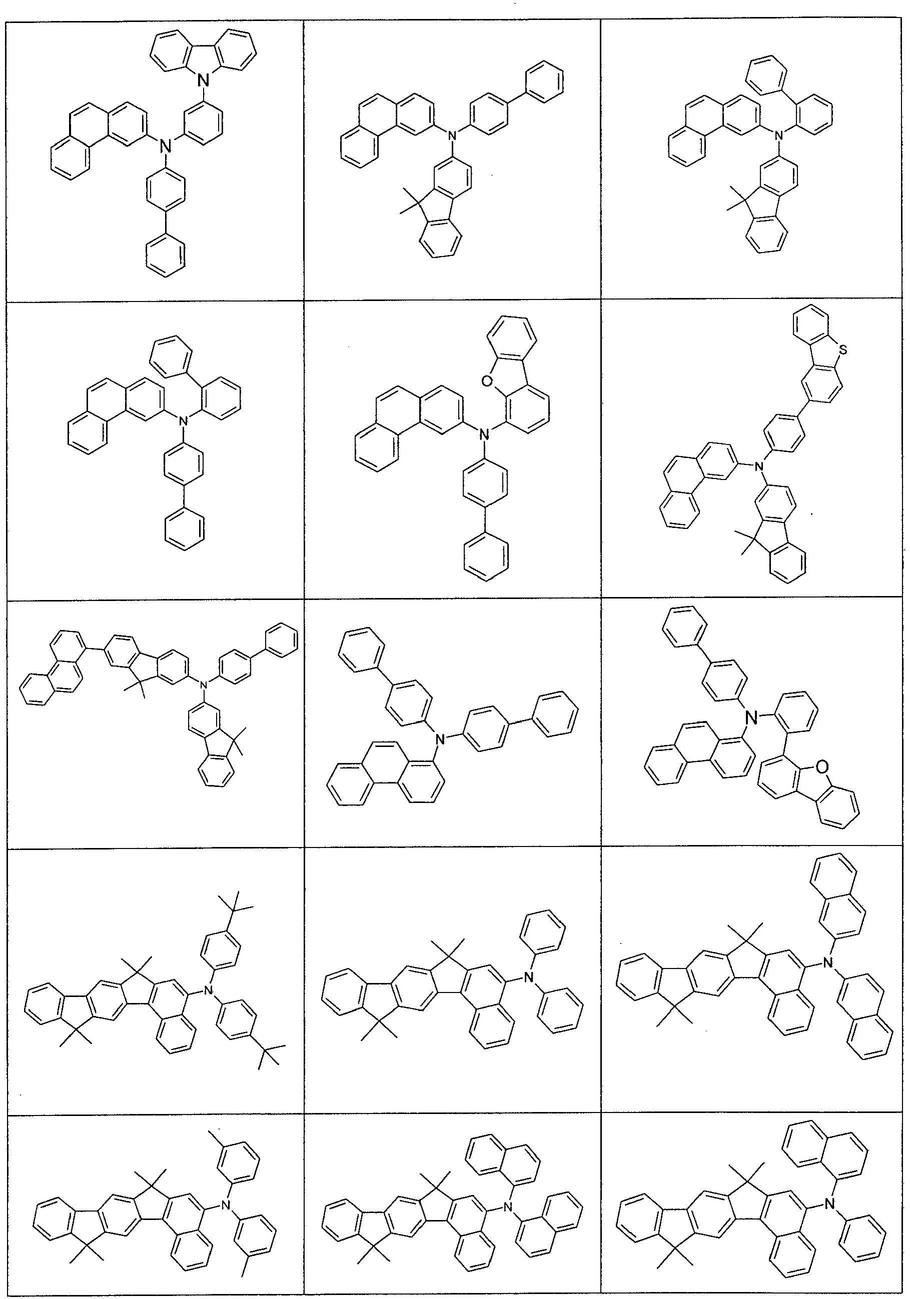

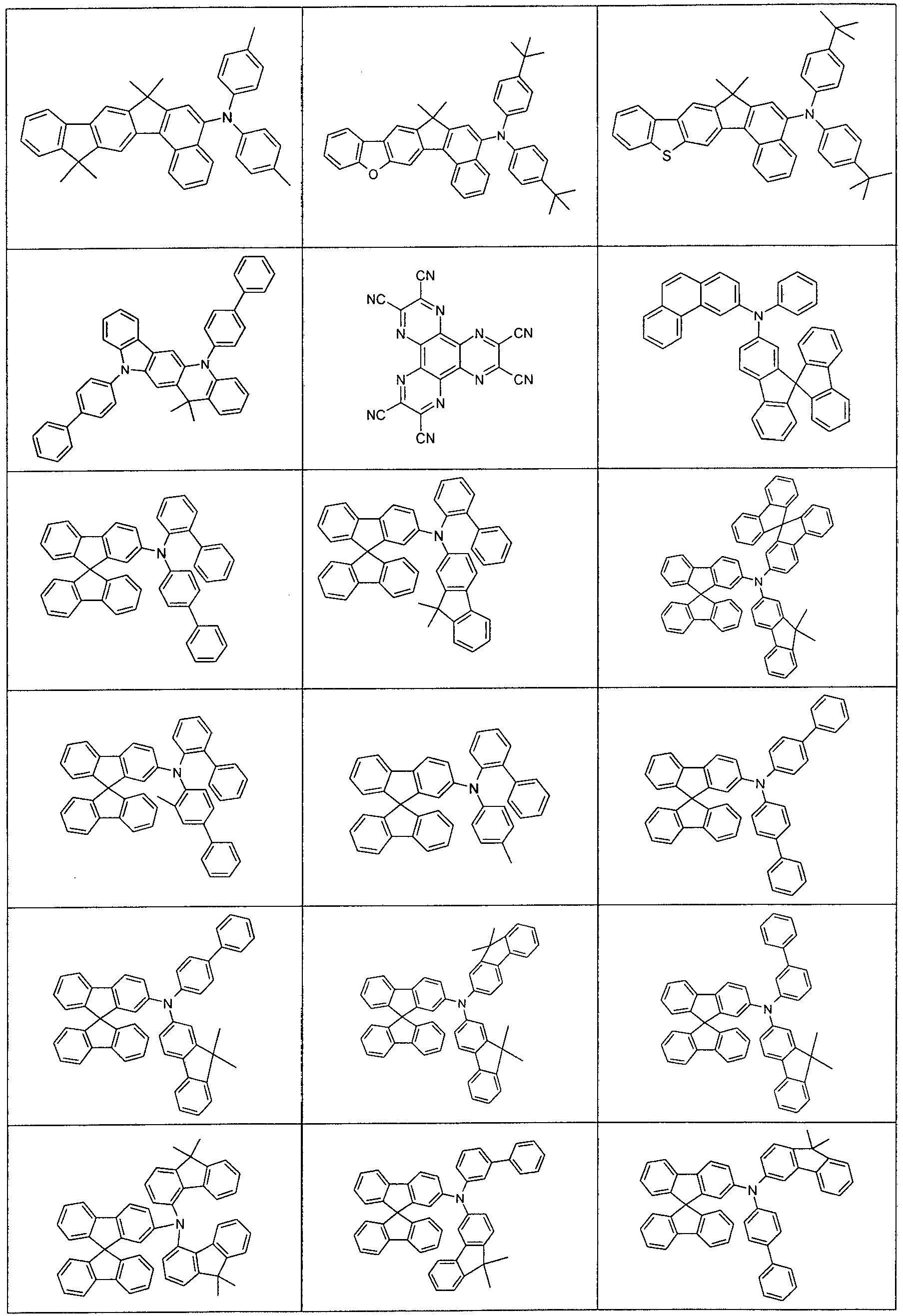

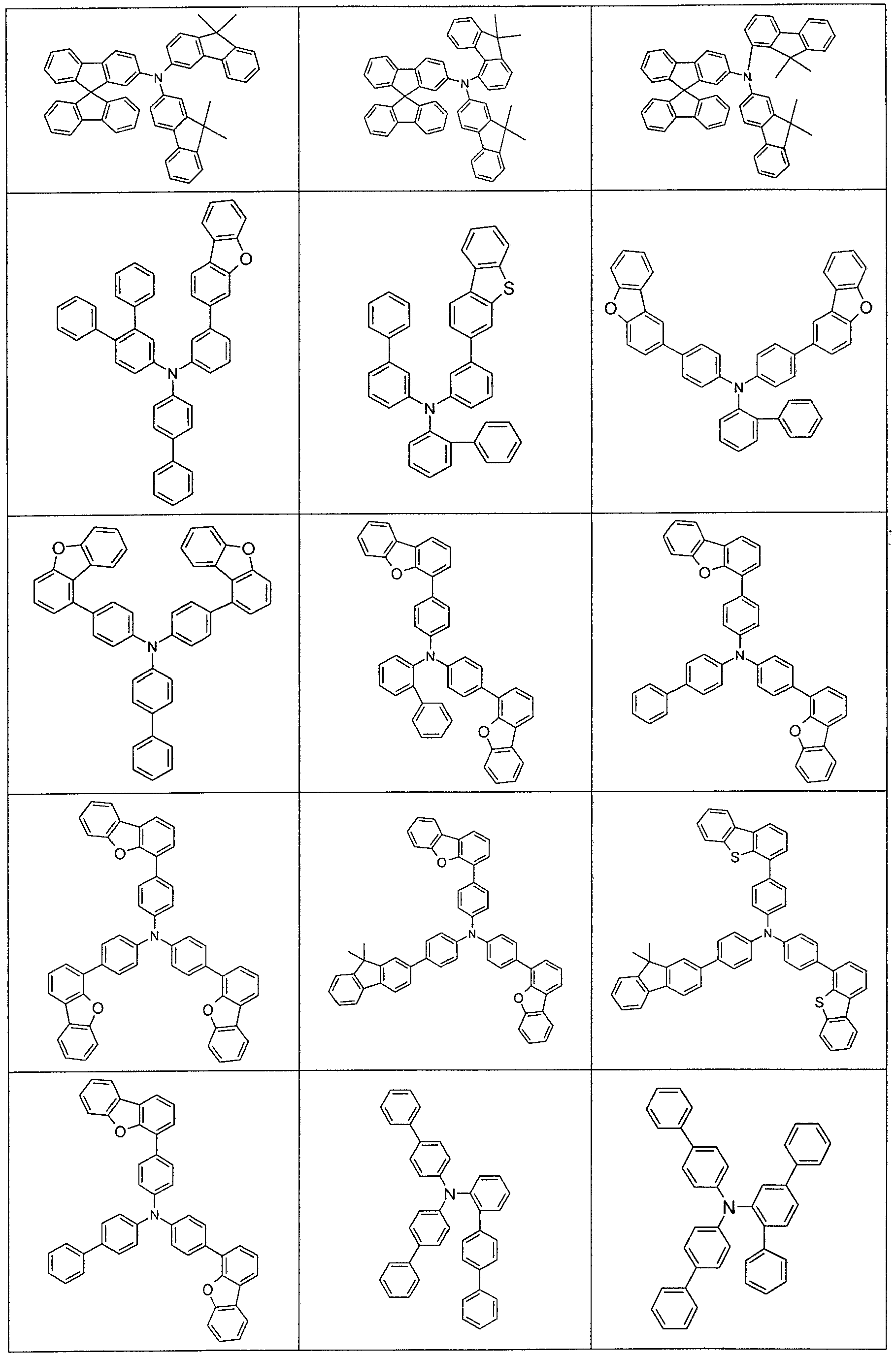

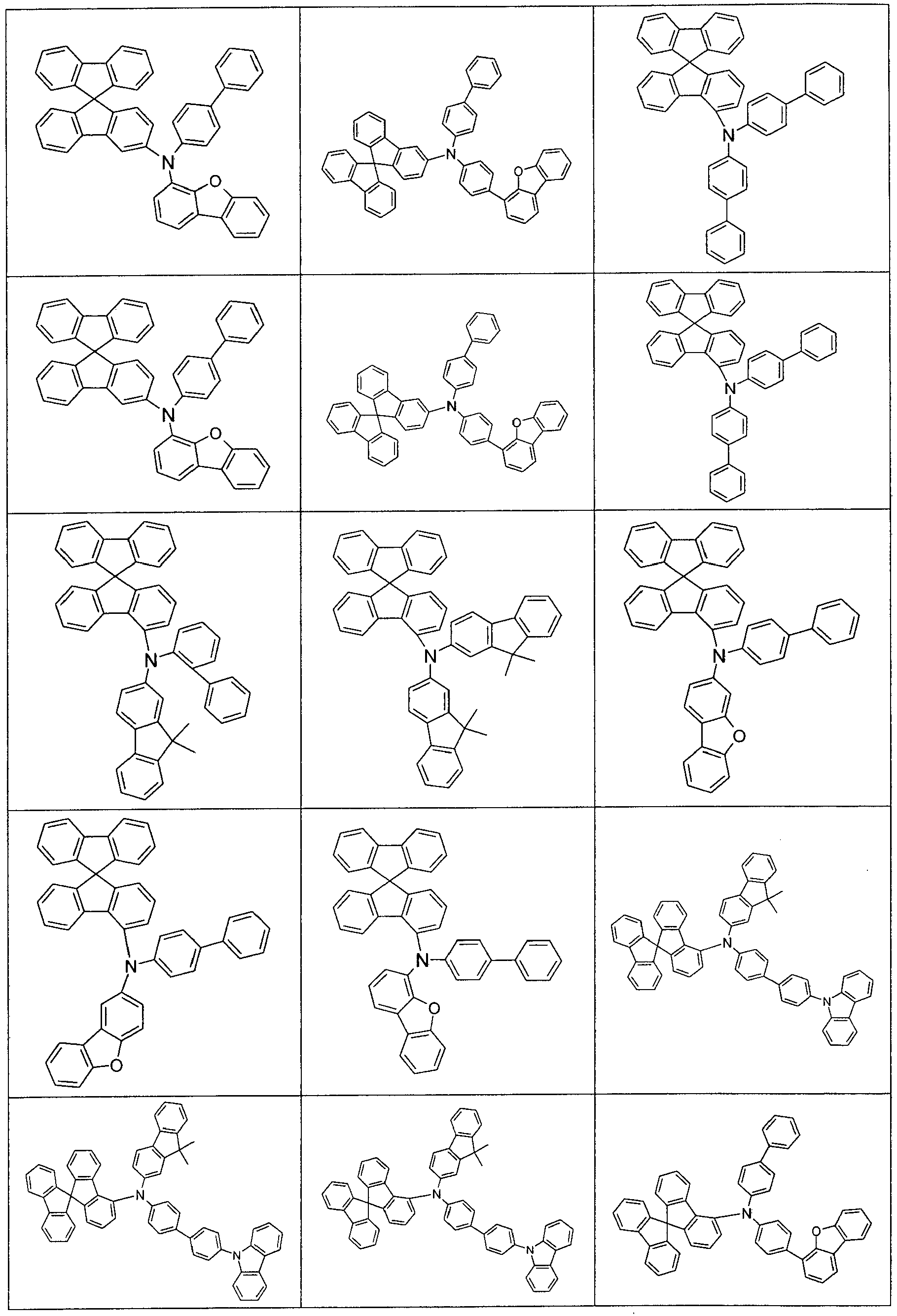

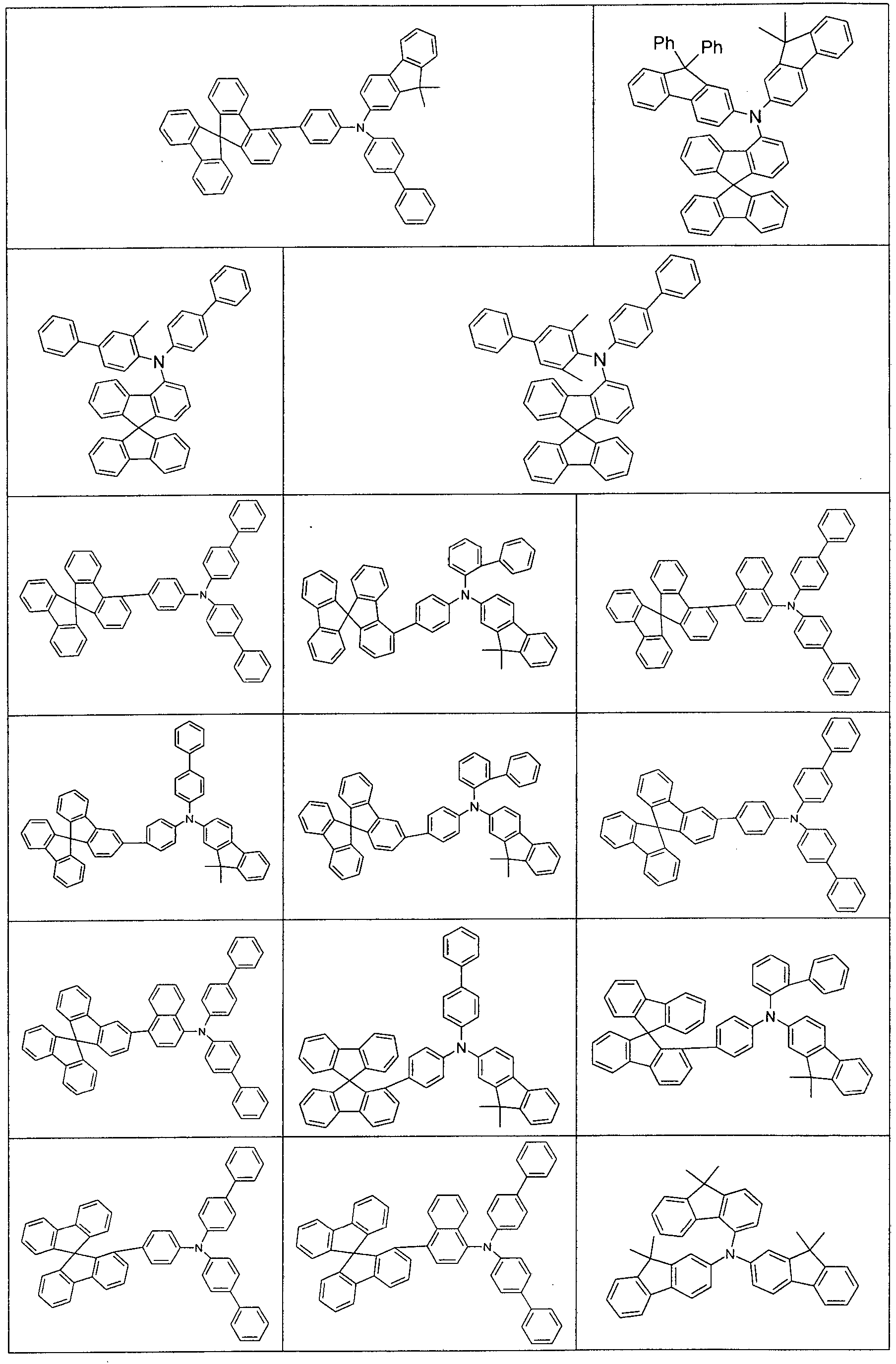

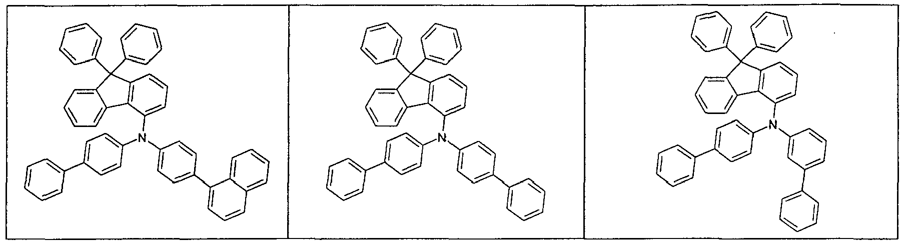

Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern und/oder Ladungen erzeugen (Charge-Generation-Layer, z. B. in Schichtsystemen mit mehreren emittierenden Schichten, z. B. in weiß emittierenden OLED-Bauteilen) . Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung den erfindungsgemäßen Metallkomplex als emittierende Verbindung in einer oder mehreren emittierenden Schichten.

Wenn der erfindungsgemäße Metallkomplex als emittierende Verbindung in einer emittierenden Schicht eingesetzt wird, wird er bevorzugt in Kombination mit einem oder mehreren Matrixmaterialien eingesetzt. Die Mischung aus dem erfindungsgemäßen Metallkomplex und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% des erfindungsgemäßen Metallkomplexes bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Kombinationen aus Triazinen und Carbazolen, z. B. gemäß WO 2011/057706 oder WO 2014/015931, Indolocarbazolderivate, z. B. gemäß WO 2007/063754 oder WO 2008/056746, Indenocarbazolderivate, z. B. gemäß WO 2010/136109, WO 2011/000455, WO 2013/041176 oder WO 2013/056776, Spiroindenocarbazolderivate, z. B. gemäß WO 2014/094963 oder WO 2015/124255, Azacarbazole, z. B. gemäß EP 1617710, EP 1617711, EP 1731584, JP 2005/347160, bipolare Matrixmaterialien, z. B. gemäß WO 2007/137725, Lactame, z. B. gemäß WO 2011/116865, WO 2011/137951, WO 2013/064206 oder WO 2014/056567, Silane, z. B. gemäß WO 2005/111172, Azaborole oder Boronester, z. B. gemäß WO 2006/117052 oder WO 2013/091762, Diazasilolderivate, z. B. gemäß WO 2010/054729, Diazaphospholderivate, z. B. gemäß WO 2010/054730, Triazinderivate, z. B. gemäß WO 2010/015306, WO 2007/063754, WO 2008/056746 oder WO 2014/023388, Zinkkomplexe, z. B. gemäß EP 652273 oder WO 2009/062578, Dibenzofuranderivate, z. B. gemäß WO 2009/148015 oder den nicht offen gelegten Anmeldungen EP 14001573.6, EP 14002642.8 oder EP 14002819.2, verbrückte Carbazolderivate, z. B. gemäß US 2009/0136779, WO 2010/050778, WO 2011/042107 oder WO 2011/088877, oder Triphenylenderivate, z. B. gemäß WO 2012/048781.

Beispiele für geeignete Triplett-Matrixmaterialien sind in den folgenden Tabellen aufgeführt.

Beispiele für geeignete Triazin- und Pyrimidinderivate sind die folgenden Strukturen:

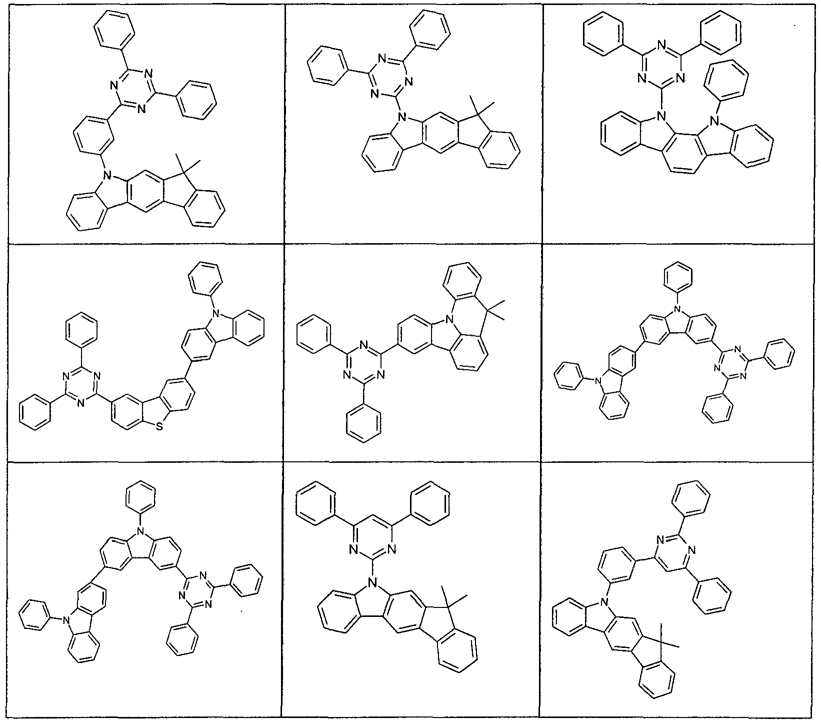

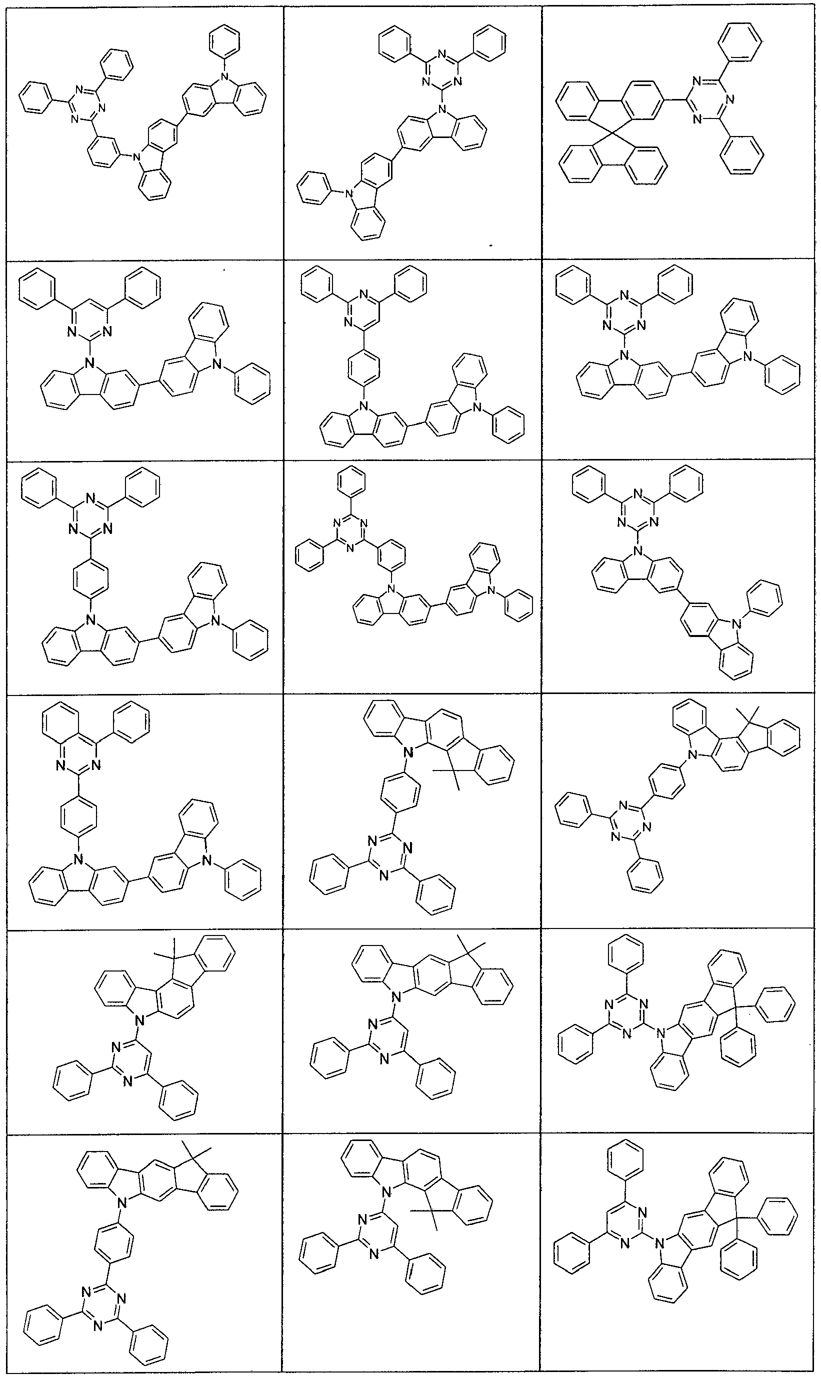

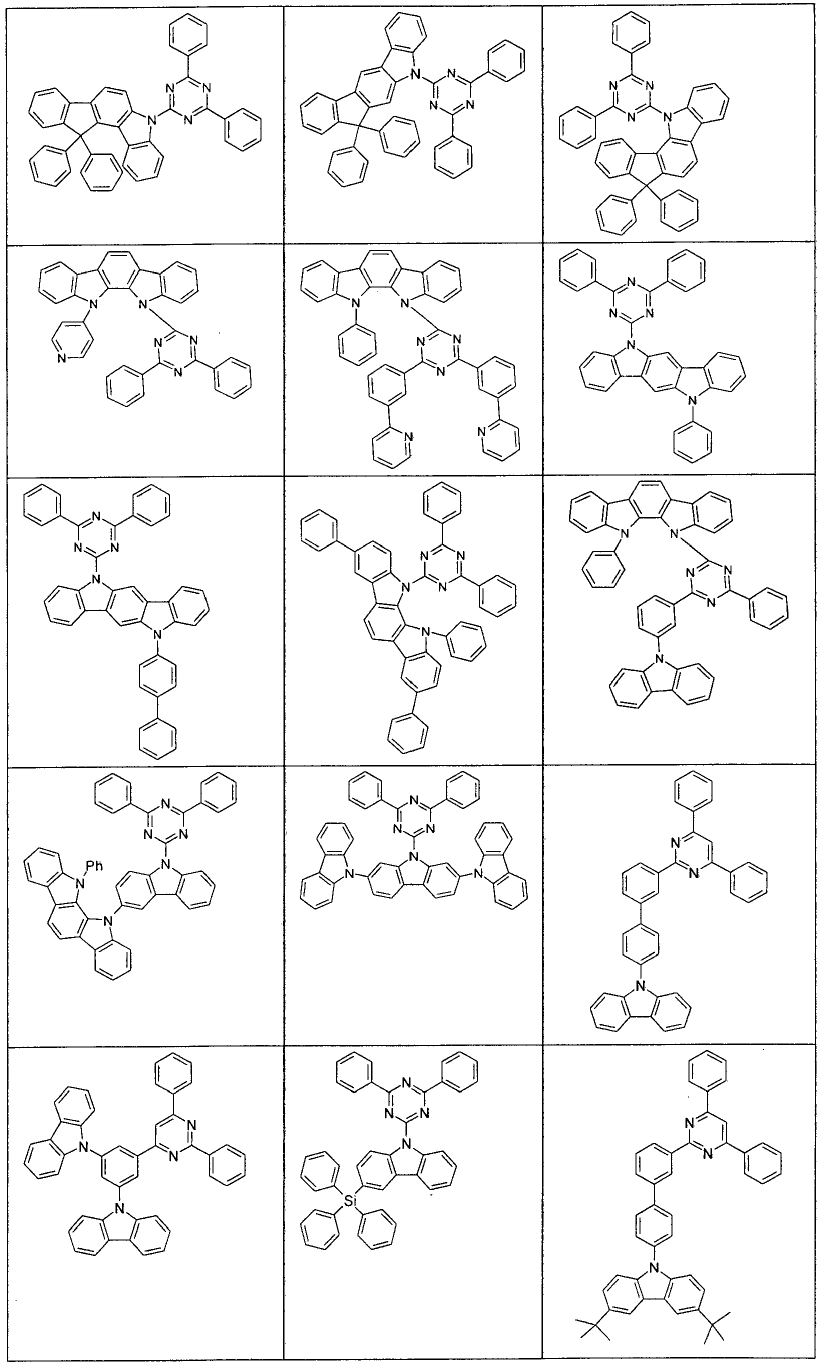

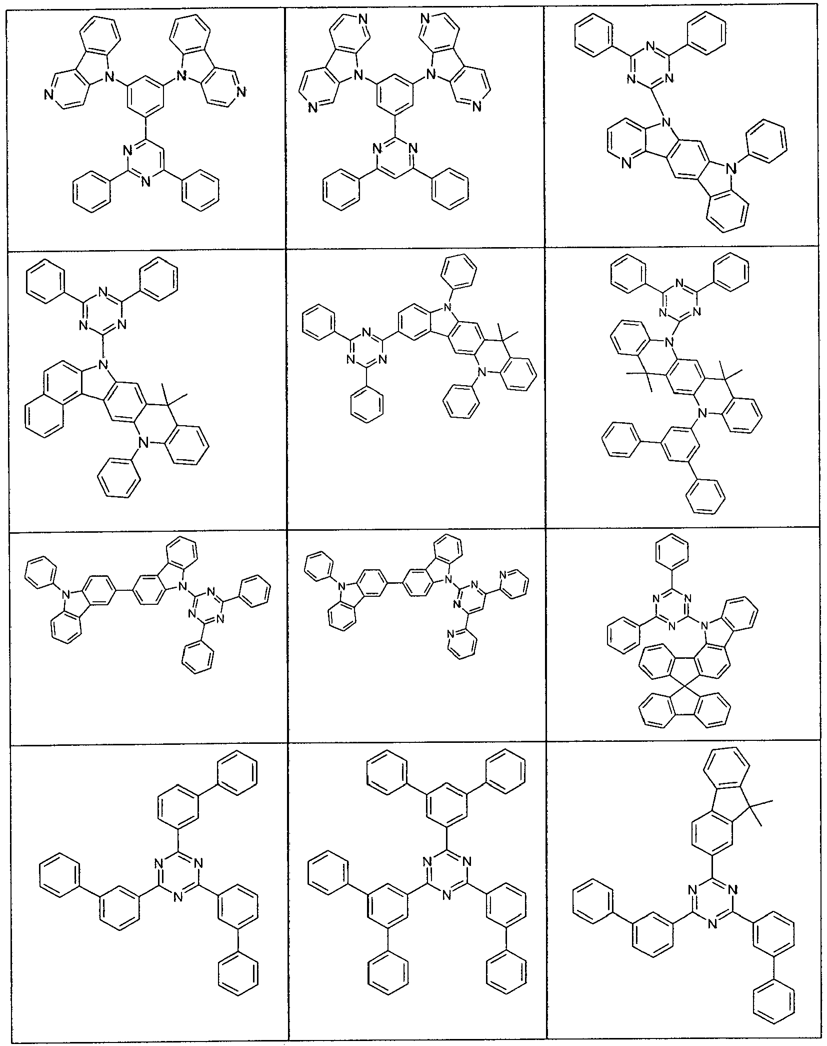

Beispiele für geeignete Lactamderivate sind die folgenden Strukturen:

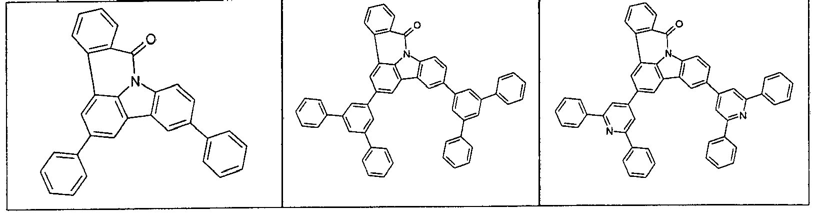

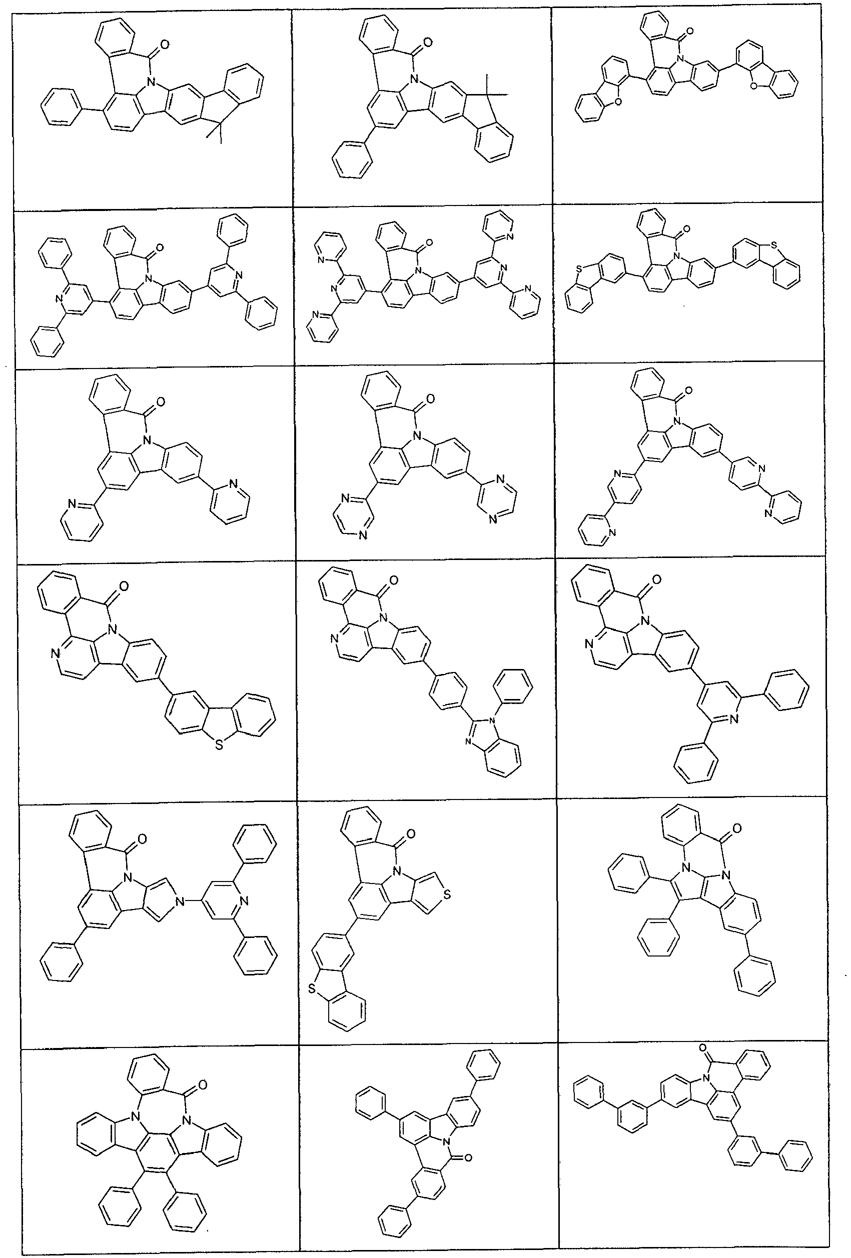

Beispiele für geeignete Ketonderivate sind die folgenden Strukturen:

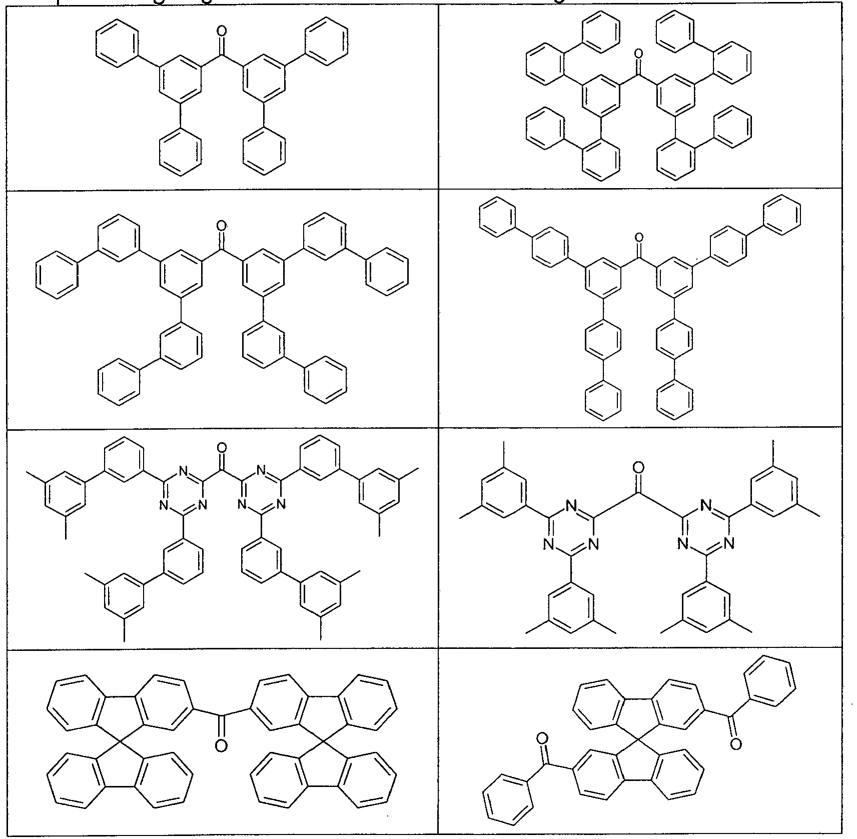

Beispiele für geeignete Metallkomplexe sind die folgenden Strukturen:

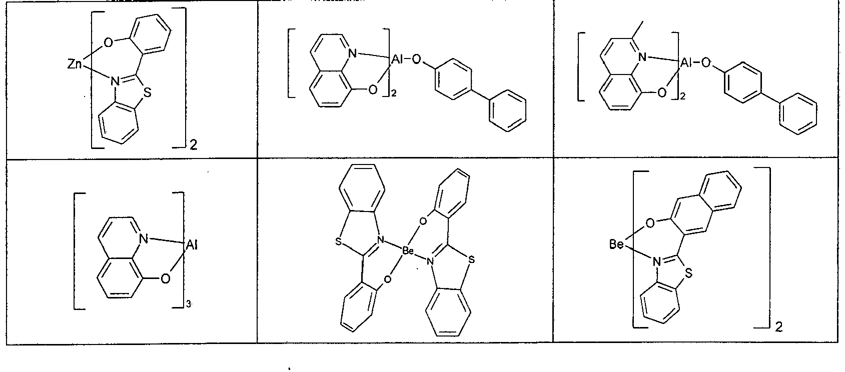

Beispiele für geeignete Indeno- und Indolocarbazolderivate sind die folgenden Strukturen:

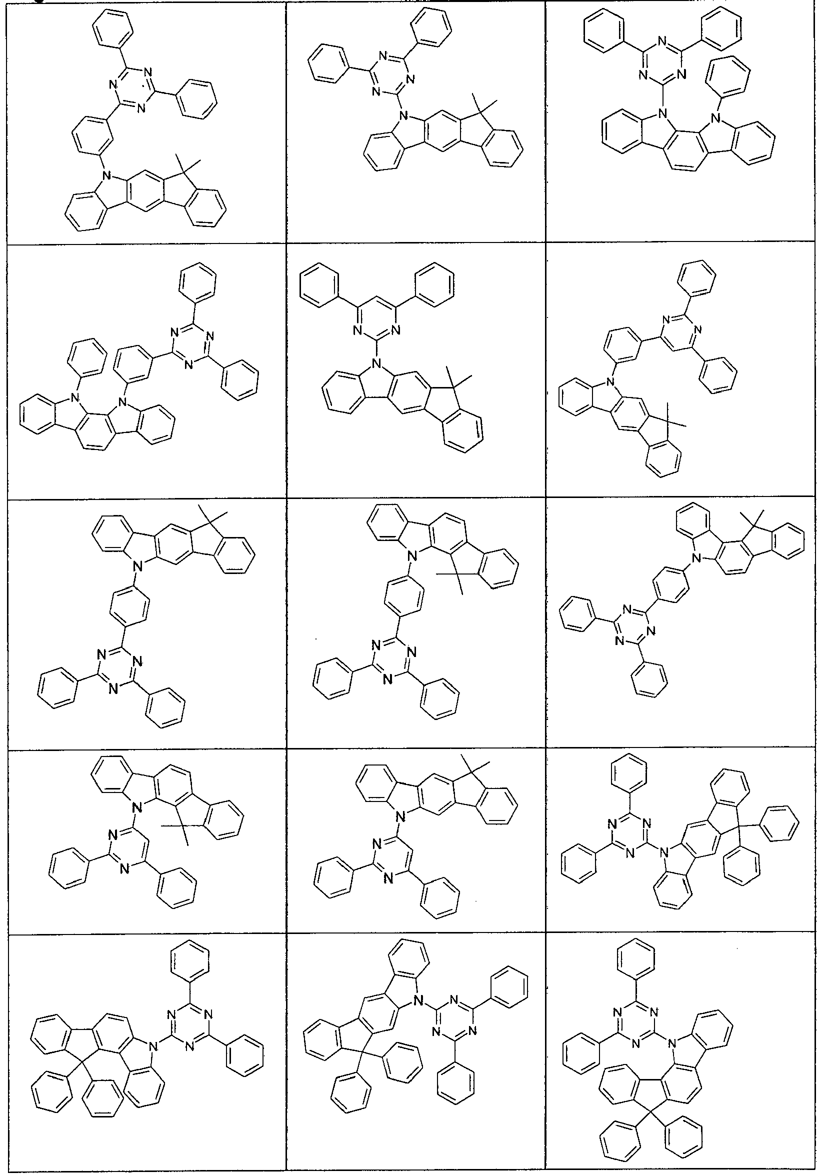

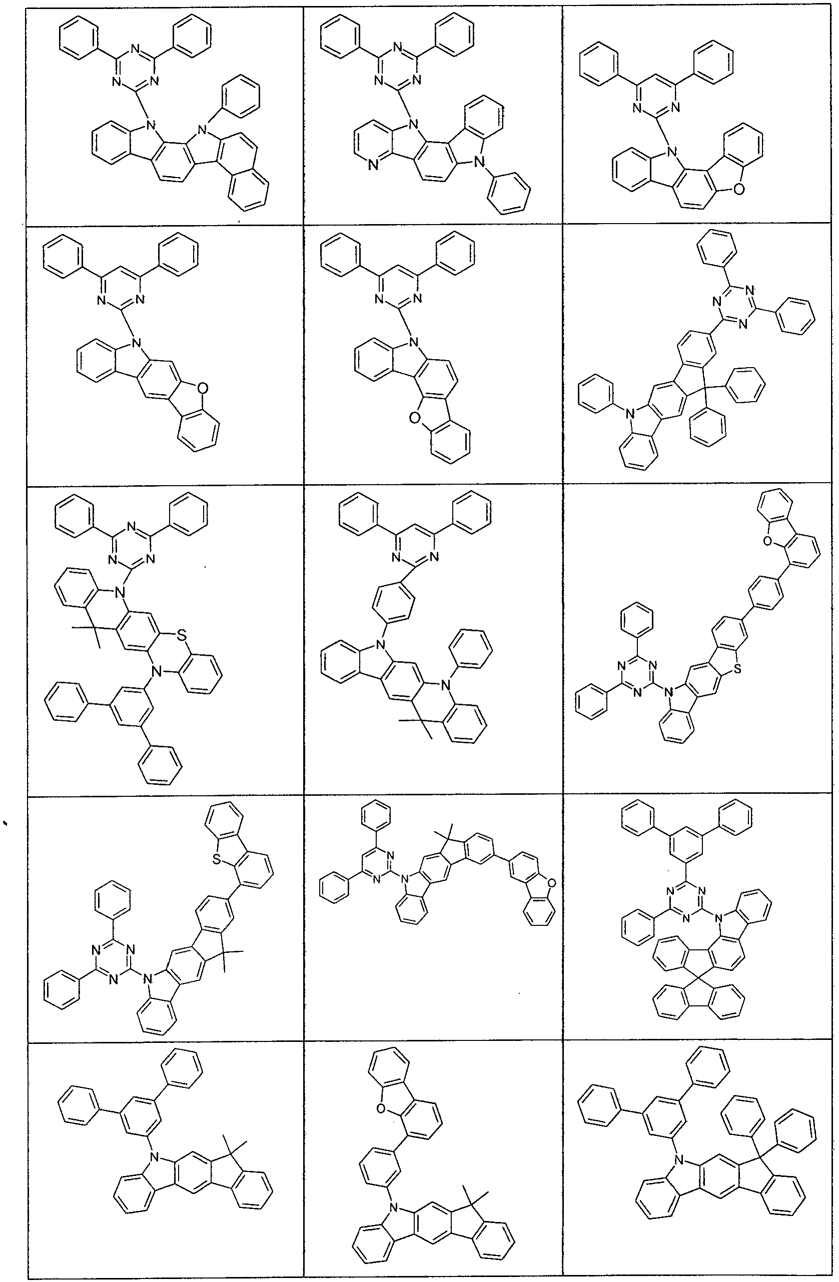

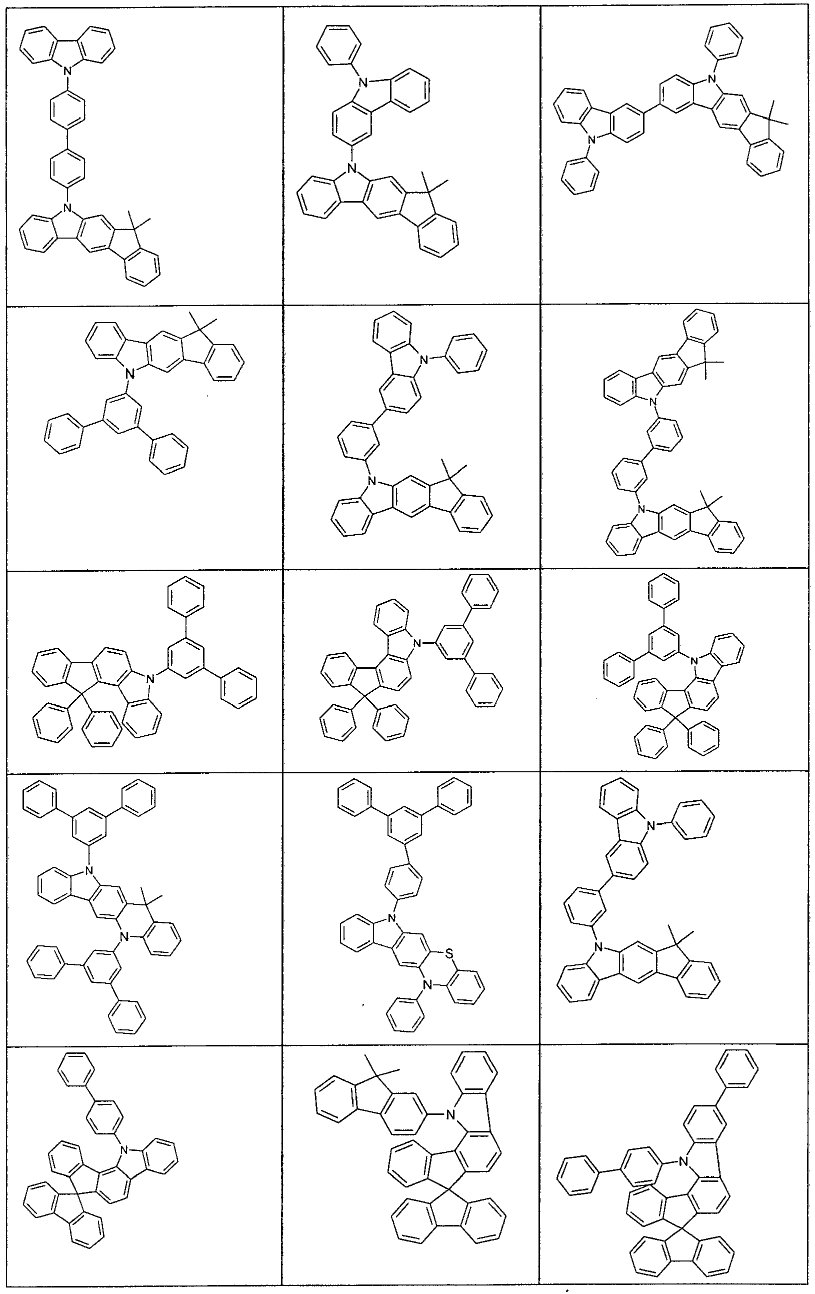

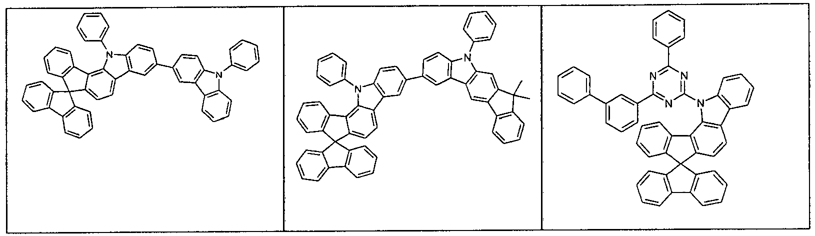

Beispiele für geeignete Phosphinoxidderivate sind die folgenden Strukturen:

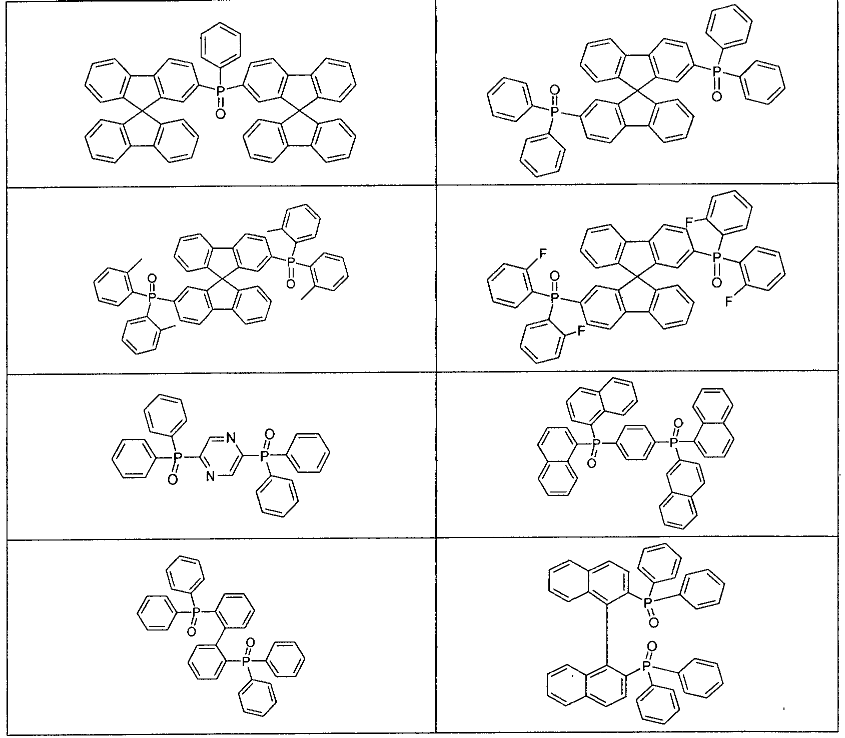

Beispiele für geeignete Carbazolderivate sind die folgenden Strukturen:

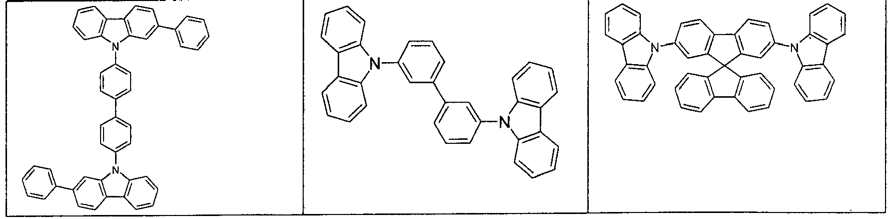

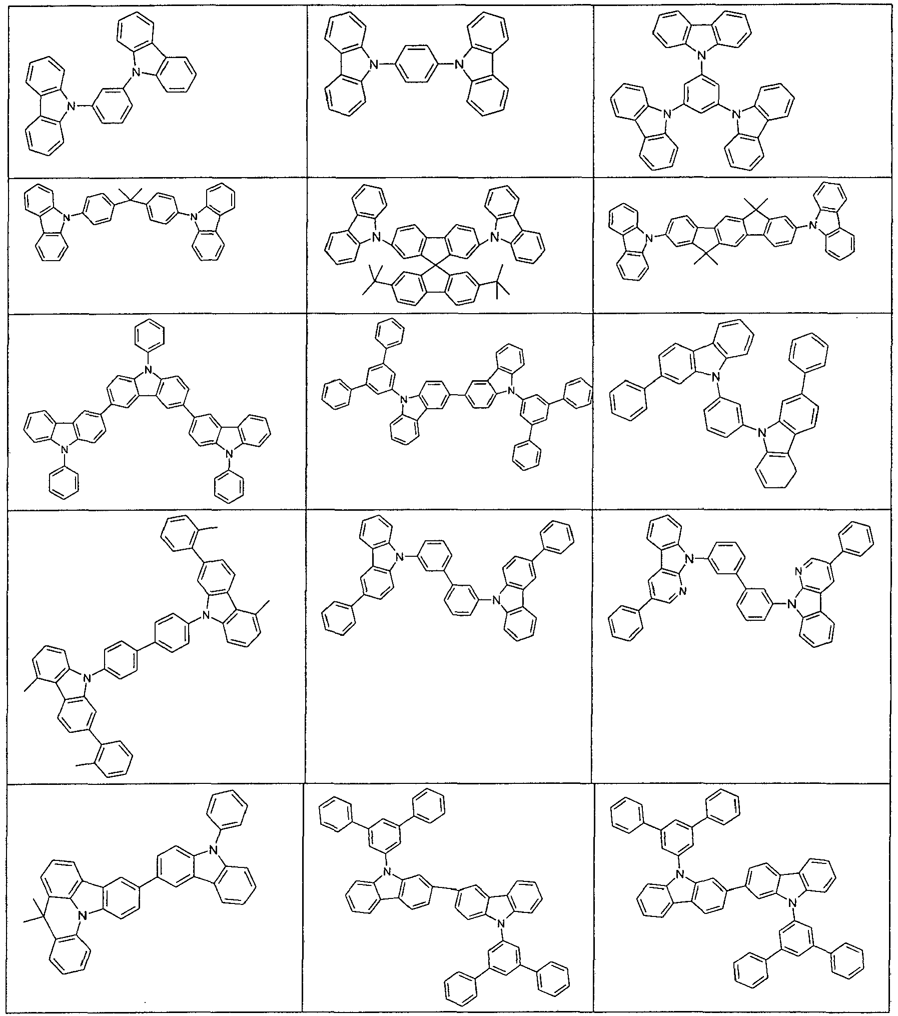

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe als Co-Matrix für längerwellig emittierende Triplettemitter, beispielsweise für grün oder rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist.

Die erfindungsgemäßen Metallkomplexe lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht, je nach Wahl des Metalls und genauer Struktur des Liganden. Wenn es sich bei dem erfindungsgemäßen Metallkomplex um einen Aluminiumkomplex handelt, so wird dieser bevorzugt in einer Elektronentransportschicht eingesetzt. Ebenso lassen sich die erfindungsgemäßen Metallkomplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Die erfindungsgemäßen Metallkomplexe lassen sich in sehr hoher Ausbeute und sehr hoher Reinheit bei außergewöhnlich kurzen Reaktionszeiten und vergleichsweise geringen Reaktionstemperaturen synthetisieren.
2. Die erfindungsgemäßen Metallkomplexe weisen eine hervorragende thermische Stabilität auf, was sich auch bei der Sublimation der Komplexe zeigt.
3. Die erfindungsgemäßen Metallkomplexe zeigen weder thermisch noch photochemisch fac/mer- bzw. mer/fac-Isomerisierung, was zu Vorteilen in der Anwedung dieser Komplexe führt.
4. Die erfindungsgemäßen Metallkomplexe weisen teilweise ein sehr schmales Emissionsspektrum auf, was zu einer hohen Farbreinheit der Emission führt, wie sie insbesondere für Displayanwendungen wünschenswert ist.
5. Organische Elektrolumineszenzvorrichtungen enthaltend die erfindungsgemäßen Metallkomplexe als emittierende Materialien weisen eine sehr gute Lebensdauer auf. Dies gilt insbesondere auch in einfachen OLEDs in denen der erfindungsgemäße Metallkomplex in eine SingleMatrix - also ein Matrix- bzw. Host-Material - eingebracht ist.
6. Organische Elektrolumineszenzvorrichtungen enthaltend die erfindungsgemäßen Metallkomplexe als emittierende Materialien weisen eine hervorragende Effizienz auf.
7. Die erfindungsgemäßen Metallkomplexe zeichnen sich durch sehr gute Oxidations- und Reduktionssabilität aus, weshalb sie auch als Loch- bzw. Elektronentransportmaterialien eingesetzt werden können.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### A: Synthese der Synthone S - Teil 1:

### Beispiel S1: 4,4,5,5-Tetramethyl-2-(1,1,3,3-tetramethyl-indan-5-yl)-[1,3,2]dioxaborolan, [1312464-73-5]

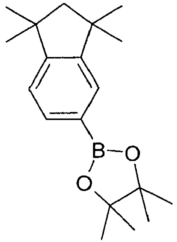

800 ml n-Heptan werden mit 3.3 g (5 mmol) Bis[(1,2,5,6-η)-1,5-cyclooctadien]di-µ-methoxydi-iridium(I) [12148-71-9], dann mit 2.7 g (10 mmol) 4,4'-Di-tert-butyl-[2,2']bipyridinyl [72914-19-3] und dann mit 5.1 g (10 mmol) Bis-(pinacolato)diboran versetzt und 15 min. bei Raumtemperatur gerührt. Anschließend gibt man 127.0 g (500 mmol) Bis-(pinacolato)diboran [73183-34-3] und dann 87.2 g (500 mmol) 1,1,3,3-Tetramethyl-indan [4834-33-7] zu und erwärmt für 12 h auf 80 °C (DC-Kontrolle-Heptan:Ethylacetat 5:1). Nach Erkalten versetzt man die Reaktionsmischung mit 300 ml Ethylacetat, filtriert über ein Kieselgel-Bett ab und engt das Filtrat im Vakuum komplett ein. Das Rohprodukt wird zweimal aus Aceton (ca. 800 ml) umkristallisiert. Ausbeute: 136.6 g (455 mmol), 91%; Reinheit: ca. 99%ig nach ¹H-NMR.

Analog können folgende Verbindungen dargestellt werden:

| Bsp. | Edukt | Produkt Boronsäureester | Ausbeute |
|---|---|---|---|
| S2 | 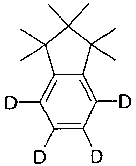 | 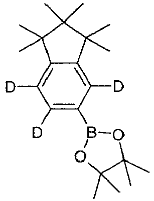 | 87% |
| | 142076-41-3 | | |
| S3 | 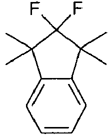 | 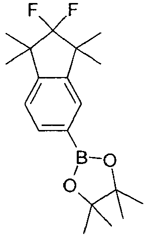 | 78% |
| | 59508-28-0 | | |
| S4 | 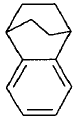 | 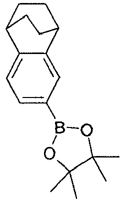 | 93% |
| | 4175-52-4 | | |
| S5 | 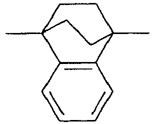 | 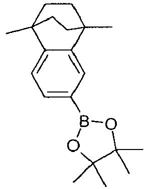 | 90% |
| | 2716-23-6 | | |
| S6 | 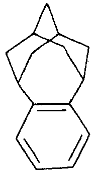 | 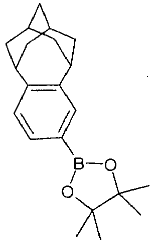 | 94% |
| | 60749-53-3 | | |

### Beispiel S7: syn,anti-Tris-1,3,5-(2-hydroxyphenyl)-tris-2,4,6-Methylbenzol-tristrifluormethansulfonsäureester

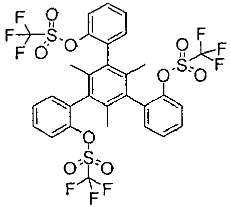

Eine Lösung von 11.9 g (30 mmol) Tris-1,3,5-(2-hydroxyphenyl)-tris-2,4,6-methyl-benzol (syn- [1421368-51-5] und anti- [1421368-52-6] Mischung) in 500 ml Dichlormethan wird bei -5 °C mit 12.1 ml (150 mmol) Pyridin versetzt. Dann tropft man während 1 h ein Gemisch aus 25.2 ml (150 mmol) Trifluormethansulfonsäureanhydrid und 200 ml Dichlormethan zu, rührt 1 h bei 0 °C nach und lässt über Nacht unter Rühren auf Raumtemperatur erwärmen. Man wäscht die Reaktionsmischung sorgfältig zweimal mit je 500 ml 1N HCl, einmal mit 500 ml Wasser, einmal mit 500 ml gesättigter Kochsalzlösung und trocknet dann über Natriumsulfat. Das nach Abziehen des Dichlormethans erhaltene Rohprodukt wird ohne weitere Reinigung weiter umgesetzt. Ausbeute: 22.1 g (28 mmol), 93 %. Reinheit: ca. 95 % nach ¹H-NMR, syn- / anti-Gemisch.

### Beispiel S8: 10-Brom-6-tert-butyl-benzo[4,5]imidazo[1,2-c]chinazolin

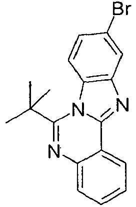

Ein Gemisch aus 28.8 g (100 mmol) 2-[5-Brom-1H-benzimidazol-2-yl]-phenyl-amin [1178172-85-4], 42.2 g (350 mmol) Pivalinsäurechlorid und 30.6 g (300 mmol) Pivalinsäure wird 50 h unter Rückfluss erhitzt. Man lässt die Reaktionsmischung auf ca. 60 °C erkalten, gibt 100 ml Ethanol zu, rührt die so erhaltene Mischung in ein Gemisch aus 500 g Eis und 500 ml konz. Ammoniak ein, rührt 15 min. nach, saugt dann vom ausgefallenen Feststoff ab, wäscht diesen zweimal mit je 100 ml Wasser und saugt diesen trocken. Man nimmt das Rohprodukt in 200 ml Dichlormethan auf, filtriert dieses über eine kurze Kieselgel-Säule, wäscht mit 200 ml Dichlormethan nach und entfernt das Dichlormethan im Vakuum. Das Rohprodukt wird an Kieselgel mit n-Heptan:Ethylacetat (2:1) chromatographiert. Ausbeute: 12.0 g (34 mmol), 34 %. Reinheit: ca. 97 % nach ¹H-NMR.

### Beispiel S9: 5-Brom-1,1,3,3-tetramethyl-2,3-dihydro-1H-3b,7-diazacyclopenta[I]phenanthren-6-on

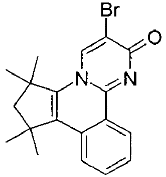

Eine Suspension von 2.9 g (10 mmol) 1,1,3,3-Tetramethyl-2,3-dihydro-1H-3b,7-diaza-cyclopenta[I]phenanthren-6-on [1616465-59-8] in 50 ml Eisessig wird bei Raumtemperatur tropfenweise mit einer Lösung von 615 µL (12 mmol) Brom in 10 ml Eisessig versetzt. Nach beendeter Zugabe erwärmt man noch 5 h auf 60 °C, entfernt dann den Eisessig weitgehend im Vakuum. Der Rückstand wird in 200 ml Ethylacetat aufgenommen, mit einmal mit 50 ml gesättigter Natriumcarbonat-Lösung, zweimal mit je 50 ml Wasser und einmal mit 50 ml gesättigter Kochsalzlösung gewaschen und über Magnesiumsulfat getrocknet. Das Rohprodukt wird an Kieselgel mit n-Heptan:Ethylacetat (2:1) chromatographiert. Ausbeute: 2.4 g (6.5 mmol), 65 %. Reinheit: ca. 97 % nach ¹H-NMR.

### Beispiel S10: 5-Brom-2-[1,1,2,2,3,3-hexamethyl-indan-5-yl]-pyridin

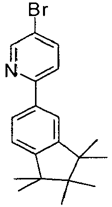

Ein Gemisch aus 164.2 g (500 mmol) 2-(1,1,2,2,3,3-Hexamethyl-indan-5-yl)-4,4,5,5-tetramethyl-[1,3,2]dioxa-borolan [152418-16-9] (analog können Boronsäuren eingesetzt werden), 142.0 g (500 mmol) 5-Brom-2-iod-pyridin [223463-13-6], 159.0 g (1.5 mol) Natriumcarbonat, 5.8 g (5 mmol) Tetrakis-(triphenylphosphino)-palladium(0), 700 ml Toluol, 300 ml Ethanol und 700 ml Wasser wird unter gutem Rühren 16 h unter Rückfluss erhitzt. Nach dem Abkühlen werden 1000 ml Toluol zugegeben, die organische Phase wird abgetrennt, die wässrige Phase wird mit 300 ml Toluol nachextrahiert. Die vereinigten organischen Phasen werden einmal mit 500 ml gesättigter Kochsalzlösung gewaschen. Nach Trocknen der organischen Phase über Natriumsulfat und Entfernen des Lösemittels im Vakuum kristallisiert man das Rohprodukt zweimal aus ca. 300 ml EtOH um. Ausbeute: 130.8 g (365 mmol), 73 %. Reinheit: ca. 95 % n. ¹H-NMR.

Analog können folgende Verbindungen dargestellt werden, dabei wird als Pyridinderivat im Allgemeinen 5-Brom-2-iod-pyridin ([223463-13-6]) eingesetzt, welches in der folgenden Tabelle nicht separat aufgeführt ist, lediglich davon abweichende Pyridinderivate sind in der Tabelle explizit aufgeführt:

| Bsp. | Boronsäure/-ester Pyridin | Produkt | Ausbeute |
|---|---|---|---|
| S11 | 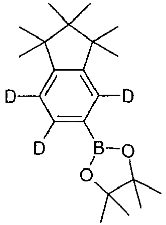 | 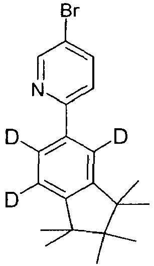 | 76 % |
| | S2 | | |
| S12 | 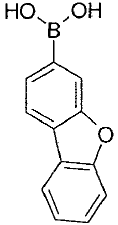 | 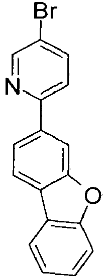 | 75 % |
| | 395087-89-5 | | |
| S13 | 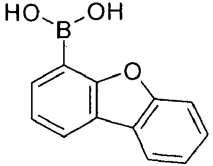 | 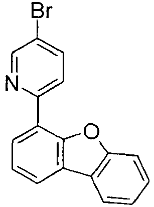 | 69 % |
| | 100124-06-9 | | |
| S14 | 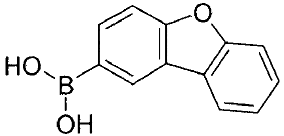 | 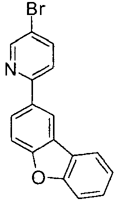 | 71 % |
| | 402936-15-6 | | |
| S15 | 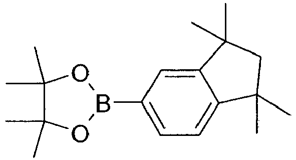 | 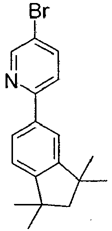 | 80 % |
| | 1312464-73-5 | | |
| S16 | 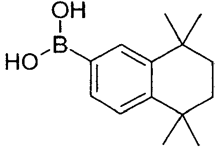 | 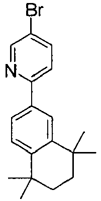 | 78 % |
| | 169126-63-0 | | |
| S17 | 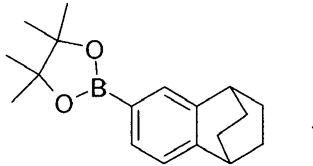 | 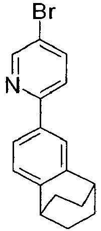 | 78 % |
| | S4 | | |
| S18 | 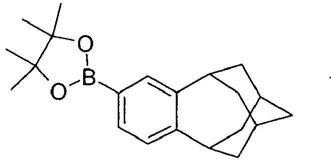 | 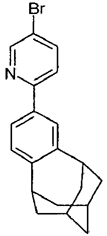 | 81 % |
| | S6 | | |
| S19 | 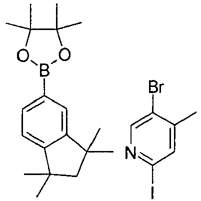 | 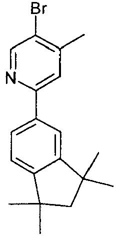 | 77 % |
| | 1312464-73-5 / 941294-57-1 | | |
| S20 | 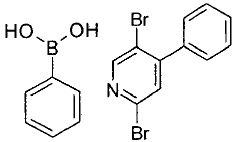 | 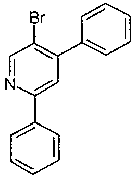 | 73 % |
| | 98-80-6 / 1381937-40-1 | | |
| S59 | 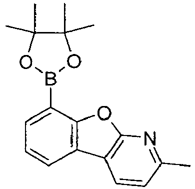 | 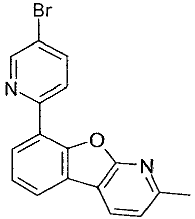 | 68 % |
| | 1609374-04-0 | | |
| S71 | 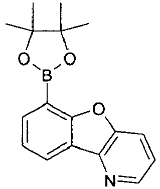 | 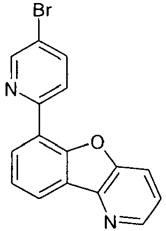 | 70 % |
| | S63 | | |
| S72 | 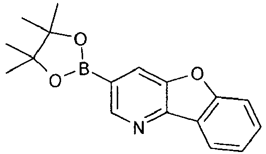 | 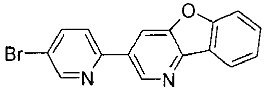 | 65 % |
| | S64 | | |
| S73 | 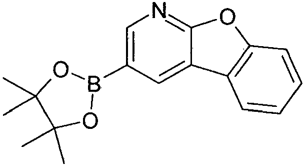 | 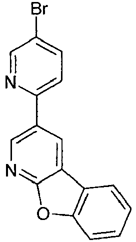 | 60 % |
| | S65 | | |
| S74 | 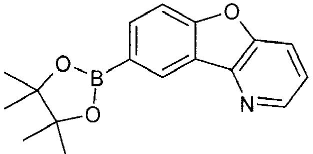 | 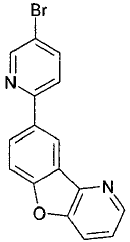 | 71 % |
| | S65 | | |
| S75 | 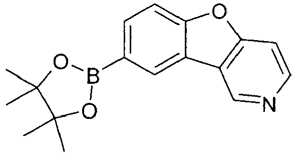 | 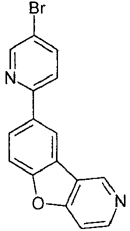 | 69 % |
| | S67 | | |
| S76 | 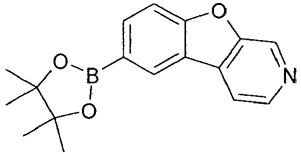 | 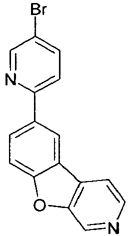 | 67 % |
| | S68 | | |
| S77 | 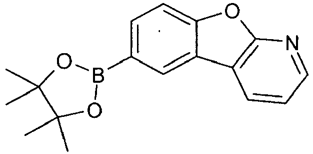 | 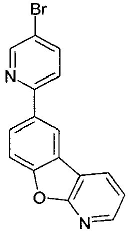 | 62 % |
| | S69 | | |
| S78 | 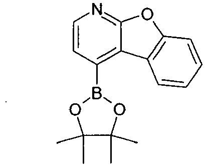 | 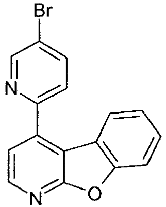 | 48 % |
| | S70 | | |
| S79 | 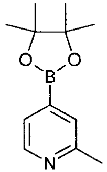 | 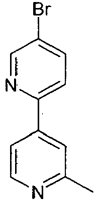 | 67 % |
| | 660867-80-1 | | |
| S80 | 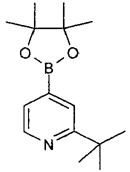 | 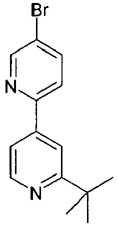 | 60% |
| | 1627722-65-9 | | |
| S81 | 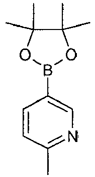 | 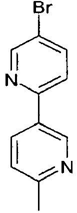 | 65 % |
| | 610768-32-6 | | |
| S82 | 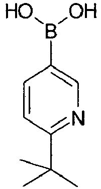 | 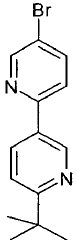 | 63 % |
| | 1174312-53-8 | | |
| S94 | 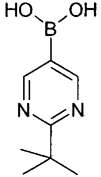 | 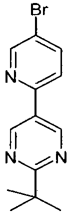 | 43 % |
| | 1352570-51-4 | | |
| S108 | 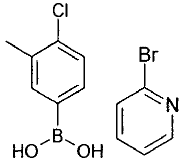 | 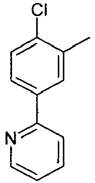 | 76 % |
| | 161950-10-3 / 109-04-6 | | |
| S125 | 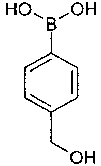 | 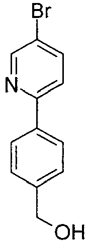 | 61 % |
| | 59016-93-2 | | |
| S126 | 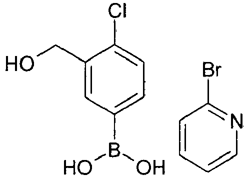 | 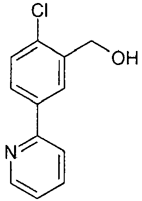 | 58 % |
| | 1430237-54-9 / 109-04-6 | | |
| S140 | 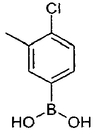 | 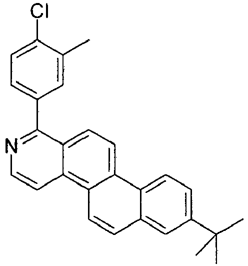 | 53 % |
| | 161950-10-3 | | |
| | 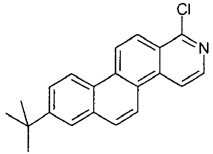 | | |
| | 1620789-34-5 | | |
| S141 | 161950-10-3 | 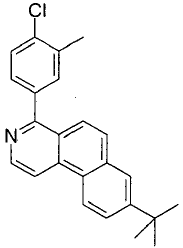 | 58 % |
| | 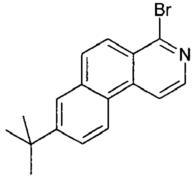 | | |
| | 1616510-96-3 | | |
| S144 | 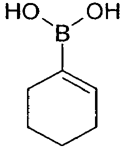 | 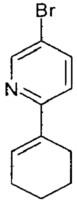 | 48 % |
| | 89490-05-1 | | |
| S145 | 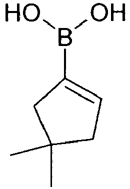 | 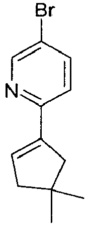 | 39 % |
| | 1146616-04-7 | | |
| S146 | 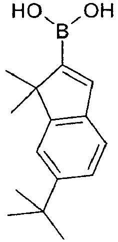 | 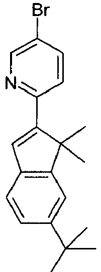 | 65 % |
| | 1599428-90-6 | | |
| S147 | 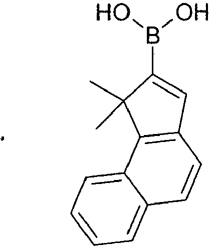 | 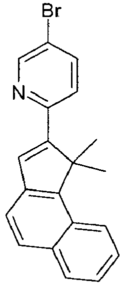 | 57 % |
| | 1603843-09-9 | | |
| S148 | 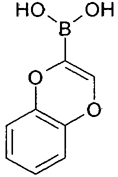 | 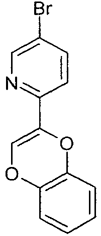 | 81 % |
| | 1107064-32-3 | | |
| S149 | 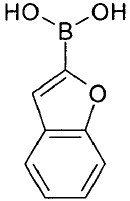 | 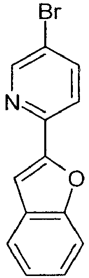 | 78 % |
| | 98437-24-2 | | |
| S150 | 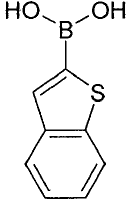 | 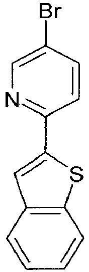 | 68 % |
| | 98437-23-1 | | |
| S151 | 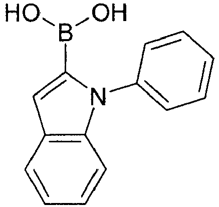 | 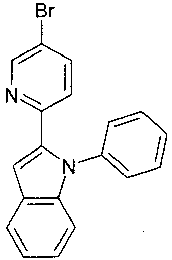 | 24 % |
| | 98437-23-1 | | |

### Beispiel S21: 2-[1,1,2,2,3,3-Hexamethyl-indan-5-yl]-5-(4,4,5,5-tetramethyl-[1,3,2]dioxaborolan-2-yl)-pyridin

### Variante A:

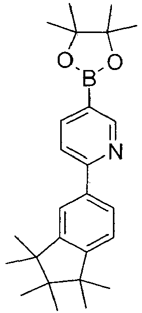

Ein Gemisch aus 35.8 g (100 mmol) S10, 25.4 g (100 mmol) Bis(pinacolato)diboran [73183-34-3], 49.1 g (500 mmol) Kaliumacetat, 1.5 g (2 mmol) 1,1-Bis(diphenylphosphino)ferrocendichlorpalladium(II)-Komplex mit DCM [95464-05-4], 200 g Glaskugeln (3 mm Durchmesser), 700 ml 1,4-Dioxan und 700 ml Toluol werden 16 h unter Rückfluss erhitzt. Nach Abkühlen wird die Suspension über ein Celite-Bett filtriert und das Lösemittel im Vakuum entfernt. Der schwarze Rückstand wird mit 1000 ml heißem n-Heptan, Cyclohexan oder Toluol digeriert, es wird noch heiß über ein Celite-Bett abfiltriert, dann auf ca. 200 ml eingeengt wobei das Produkt zu kristallisieren beginnt. Alternativ kann mit Ethylacetat Heißextrahiert werden. Die Kristallisation wird über Nacht im Kühlschrank vervollständigt, die Kristalle werden abfiltriert und mit wenig n-Heptan gewaschen. Aus der Mutterlauge kann eine zweite Produktfraktion gewonnen werden. Ausbeute: 31.6 g (78 mmol) 78 %. Reinheit: ca. 95 % ig n. ¹H-NMR.

### Variante B: Umsetzung von Arylchloriden

Wie Variante A, jedoch wird an Stelle von 1,1-Bis(diphenylphosphino)-ferrocendichlorpalladium(II)-Komplex mit DCM 2 mmol SPhos [657408-07-6] und 1 mmol Palladium(II)acetat eingesetzt.

Analog können folgende Verbindungen dargestellt werden, wobei zur Reinigung anstelle von n-Heptan auch Cyclohexan, Toluol, Acetonitril bzw. Gemische der genannten Lösungsmittel verwendet werden können:

| Bsp. | Bromid - Variante A Chlorid - Variante B | Produkt | Ausbeute |
|---|---|---|---|
| S22 | 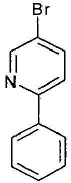 | 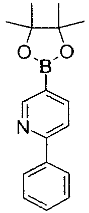 | 85 % |
| | 27012-25-5 | | |
| S23 | 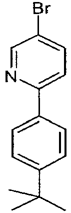 | 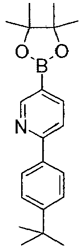 | 80 % |
| | 1215073-34-9 | | |
| S24 | 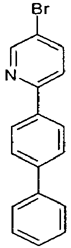 | 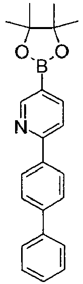 | 83 % |
| | 1035556-84-3 | | |
| S25 | 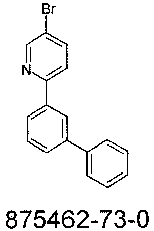 | 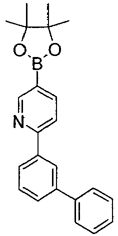 | 74 % |
| | | | |
| S26 | 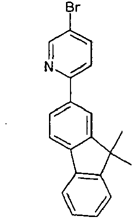 | 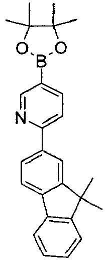 | 77 % |
| | 1486482-87-4 | | |
| S27 | 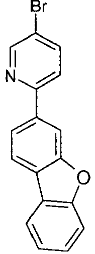 | 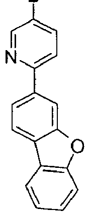 | 79 % |
| | S12 | | |
| S28 | 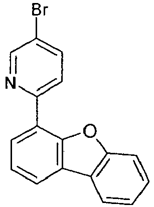 | 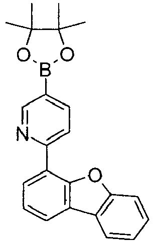 | 67 % |
| | S13 | | |
| S29 | 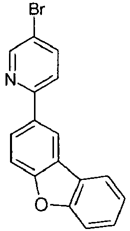 | 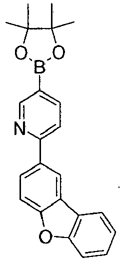 | 70 % |
| | S14 | | |
| S30 | 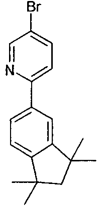 | 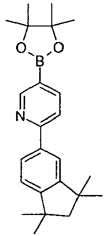 | 82 % |
| | S15 | | |
| S31 | 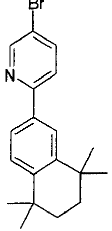 | 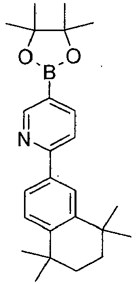 | 80 % |
| | S16 | | |
| S32 | 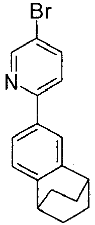 | 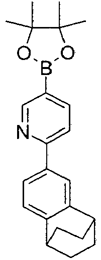 | 80 % |
| | S17 | | |
| S33 | 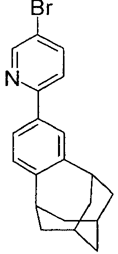 | 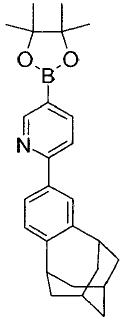 | 78 % |
| | S18 | | |
| S34 | 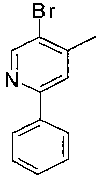 | 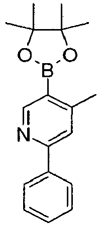 | 74 % |
| | 31686-64-3 | | |
| S35 | 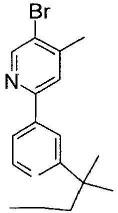 | 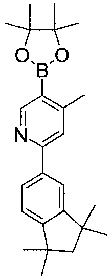 | 76 % |
| | S19 | | |
| S36 | 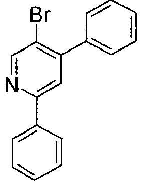 | 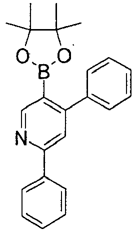 | 70 % |
| | S20 | | |
| S37 | 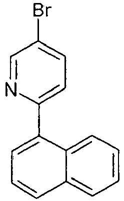 | 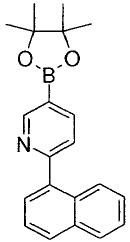 | 68 % |
| | 88345-95-3 | | |
| S38 | 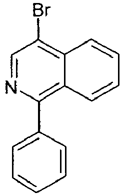 | 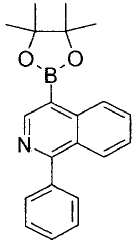 | 76 % |
| | 22960-25-4 | | |
| S39 | 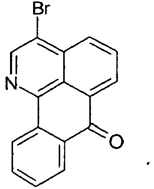 | 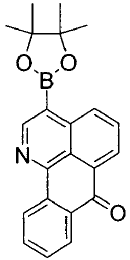 | 83 % |
| | 57669-37-1 | | |
| S40 | 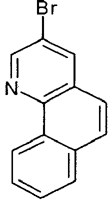 | 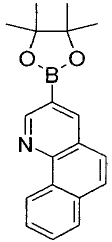 | 85 % |
| | 68473-51-8 | | |
| S41 | 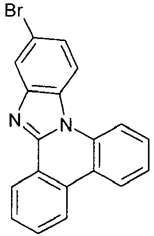 | 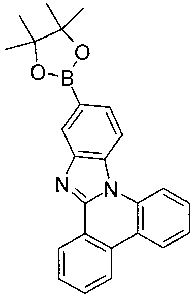 | 80 % |
| | 1623150-49-1 | | |
| S42 | 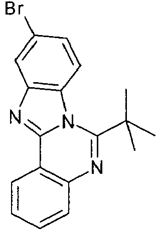 | 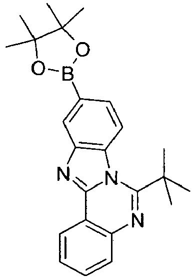 | 78 % |
| | S8 | | |
| S43 | 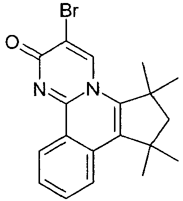 | 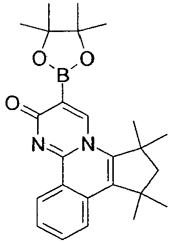 | 76 % |
| | S9 | | |
| S54 | 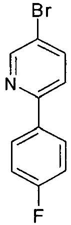 | 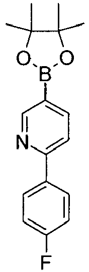 | 72 % |
| | 463336-07-4 | | |
| S55 | 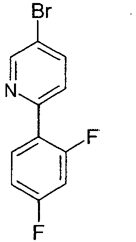 | 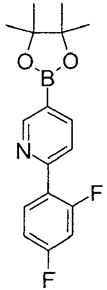 | 69 % |
| | 453530-70-6 | | |
| S56 | 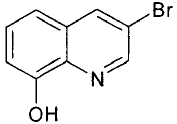 | 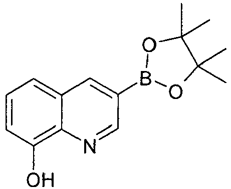 | 54 % |
| | 139399-62-5 | | |
| S57 | 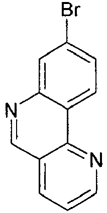 | 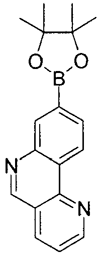 | 41 % |
| | 1039080-00-6 | | |
| S58 | 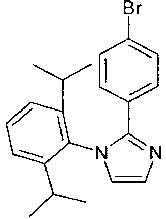 | 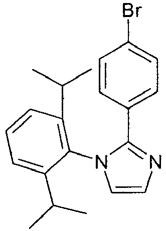 | 58 % |
| | 1492036-006 | | |
| S60 | 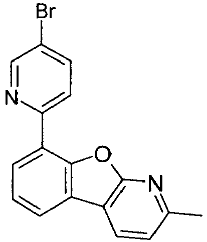 | 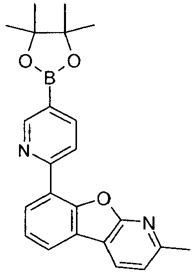 | 60 % |
| | S59 | | |
| S61 | 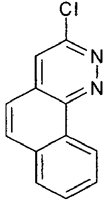 | 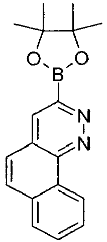 | 66 % |
| | 361979-42-2 | | |
| S62 | 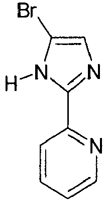 | 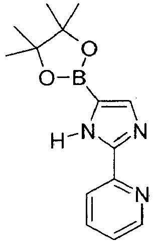 | 33 % |
| | 71048-48-1 | | |
| S83 | 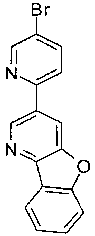 | 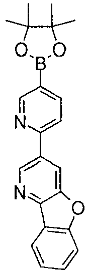 | 81 % |
| | S72 | | |
| S84 | 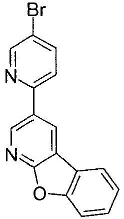 | 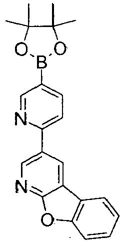 | 77 % |
| | S73 | | |
| S85 | 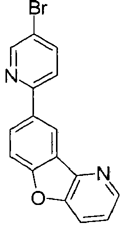 | 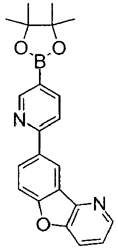 | 75 % |
| | S74 | | |
| S86 | 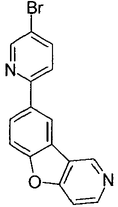 | 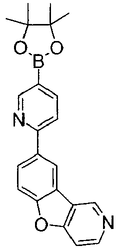 | 78 % |
| | S75 | | |
| S87 | 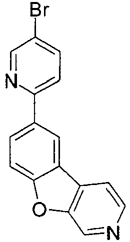 | 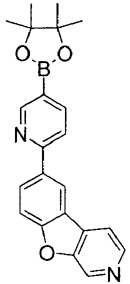 | 70 % |
| | S76 | | |
| S88 | 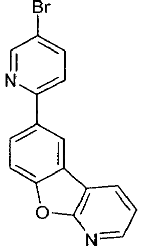 | 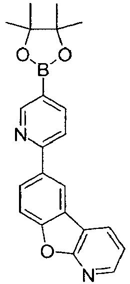 | 74 % |
| | S77 | | |
| S89 | 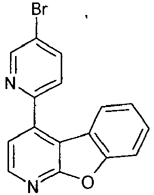 | 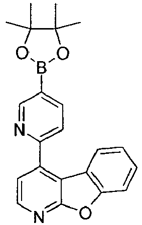 | 69 % |
| | S78 | | |
| S90 | 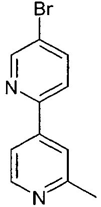 | 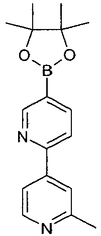 | 73 % |
| | S79 | | |
| S91 | 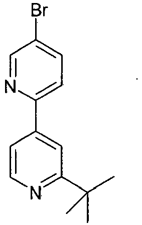 | 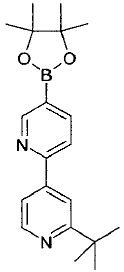 | 69 % |
| | S80 | | |
| S92 | 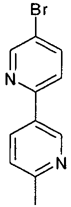 | 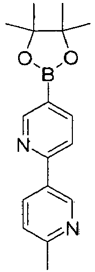 | 76 % |
| | S81 | | |
| S93 | 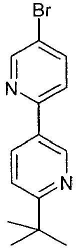 | 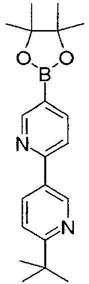 | 75 % |
| | S82 | | |
| S95 | 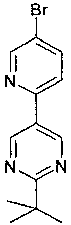 | 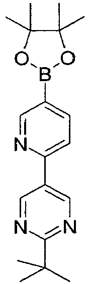 | 67 % |
| | S94 | | |
| S96 | 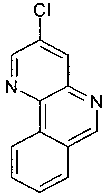 | 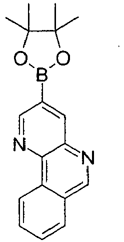 | 63 % |
| | 1421504-00-8 | | |
| S97 | 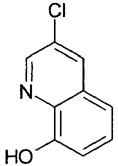 | 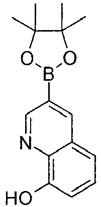 | 48 % |
| | 102878-83-1 | | |
| S98 | 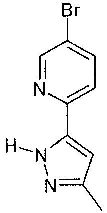 | 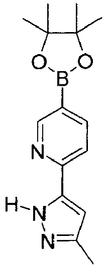 | 46 % |
| | 1239480-83-1 | | |
| S99 | 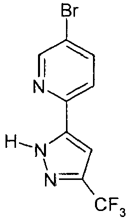 | 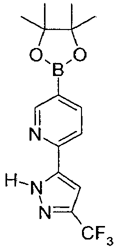 | 51 % |
| | 188918-99-2 | | |
| S100 | 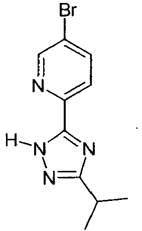 | 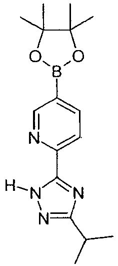 | 48 % |
| | 1342192-56-6 | | |
| S103 | 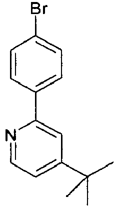 | 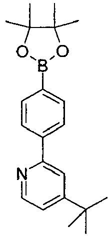 | 88 % |
| | 1246851-70-6 | | |
| S109 | 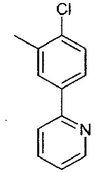 | 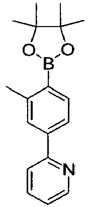 | 90 % |
| | S108 | | |
| S127 | 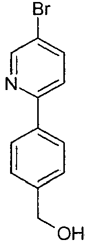 | 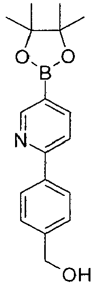 | 87 % |
| | S125 | Heißextraktion mit Ethylacetat | |
| S128 | 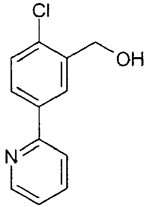 | 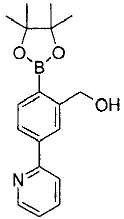 | 66 % |
| | S126 | Heißextraktion mit Ethylacetat | |
| S129 | 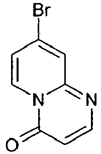 | 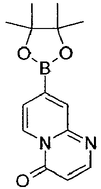 | 72 % |
| | 1198413-10-3 | | |
| S130 | 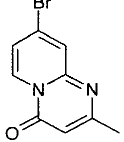 | 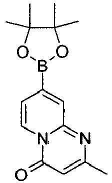 | 75 % |
| | 1781699-85-1 | | |
| S131 | 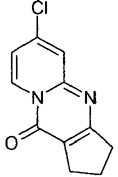 | 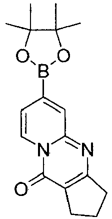 | 78 % |
| | 60781-85-3 | | |
| S132 | 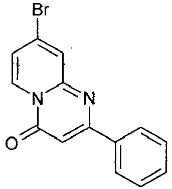 | 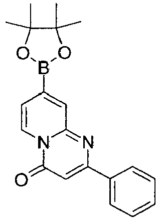 | 82 % |
| | 1338923-08-2 | | |
| S133 | 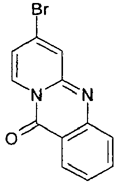 | 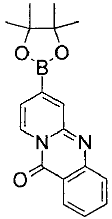 | 80 % |
| | 1446208-20-3 | | |
| S134 | 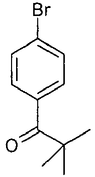 | 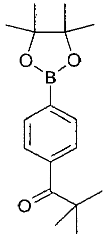 | 75 % |
| | 30314-45-5 | | |
| S135 | 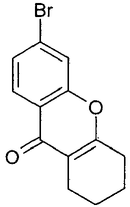 | 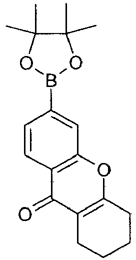 | 68 % |
| | 80268-54-8 | | |
| S136 | 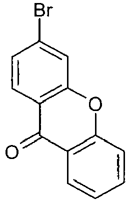 | 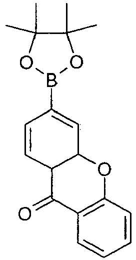 | 80 % |
| | 500286-36-2 | | |
| S137 | 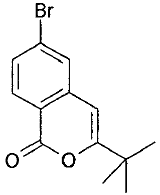 | 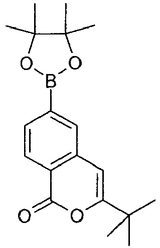 | 79 % |
| | 1257834-06-2 | | |
| S138 | 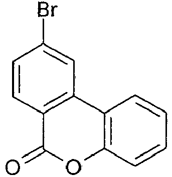 | 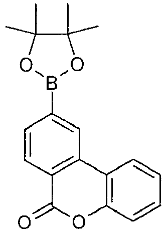 | 71 % |
| | 1469912-47-7 | | |
| S139 | 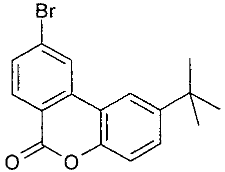 | 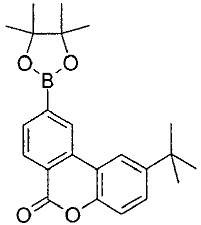 | 76 % |
| | 1469912-48-8 | | |
| S142 | 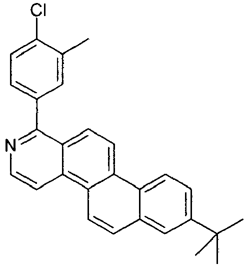 | 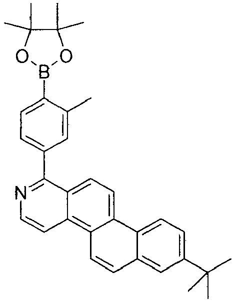 | 81 % |
| | S140 | | |
| S143 | 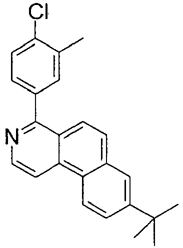 | 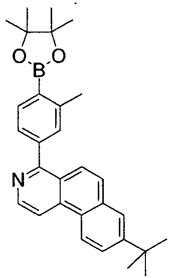 | 79 % |
| | S141 | | |
| S152 | 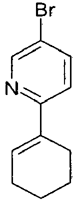 | 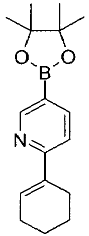 | 76 % |
| | S144 | | |
| S153 | 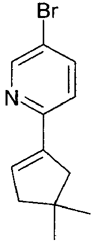 | 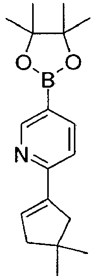 | 70 % |
| | S145 | | |
| S154 | 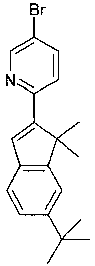 | 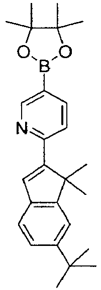 | 81 % |
| | S146 | | |
| S155 | 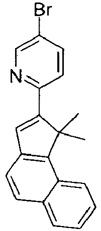 | 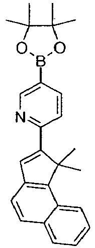 | 84 % |
| | S147 | | |
| S156 | 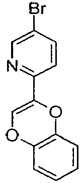 | 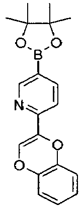 | 91 % |
| | S148 | | |
| S157 | 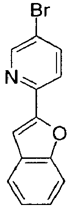 | 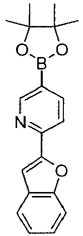 | 89 % |
| | S149 | | |
| S158 | 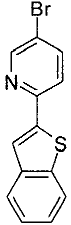 | 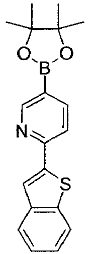 | 90 % |
| | S150 | | |
| S159 | 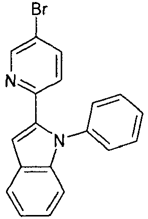 | 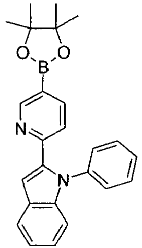 | 66 % |
| | S151 | | |

### Beispiel S44: 1,3,5-Tris-(6-brom-1,1,3,3-tetramethylindan-5-yl)benzol

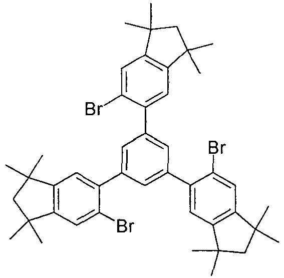

### a) 1-(6-Brom-1,1,3,3-tetramethyl-indan-5-yl)-ethanon

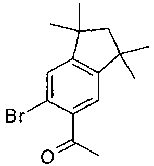

Durchführung nach I. Pravst et al., Teterhedron Lett., 2006, 47, 4707. Ein Gemisch aus 21.6 g (100 mmol) 1-(1,1,3,3-Tetramethyl-indan-5-yl)-ethanon, [17610-14-9], 39.2 g (220 mmol) N-Bromsuccinimid, 1.6 g (2.5 mmol) [Cp*RhCl₂]₂ [12354-85-7], 3.4 g (10 mmol) Silber(I)hexafluoro-antimonat [26042-64-8], 20.0 g (110 mmol) Kupfer(II)acetat [142-71-2] und 500 ml 1,2-Dichlorethan wird 20 h bei 120 °C gerührt. Nach Erkalten filtriert man von den Feststoffen über ein Kieselgelbett ab, entfernt das Lösungsmittel im Vakuum und kristallisiert den Rückstand dreimal aus Acetonitril um. Ausbeute: 12.1 g (41 mmol), 41 %. Reinheit: ca. 97 %-ig n. ¹H-NMR.

### b) 1,3,5-Tris-(6-brom-1,1,3,3-tetramethylindan-5-yl)benzol, S44

Ein Gemisch aus 12.1 g (41 mmol) 1-(6-Brom-1,1,3,3-tetramethyl-indan-5-yl)-ethanon und 951 mg (5 mmol) Toluolsulfonsäure-Monohydrat [6192-52-5] (oder Trifluormethansulfonsäure, Variante B) wird 48 h bei 150 °C am Wasserabscheider gerührt. Nach Erkalten nimmt man den Rückstand in 300 ml Ethylacetat auf, wäscht dreimal mit je 100 ml Wasser, einmal mit 100 ml gesättigter Kochsalzlösung und trocknet dann über Magnesiumsulfat. Das Rohprodukt wird an Kieselgel mit n-Heptan:Ethylacetat (5:1) chromatographiert. Ausbeute: 4.3 g (5 mmol), 38 %. Reinheit: ca. 97 %-ig n. ¹H-NMR.

Analog können folgende Verbindungen dargestellt werden:

| Bsp. | Keton bzw. Bromketon Variante | Produkt | Ausbeute |
|---|---|---|---|
| S45 | 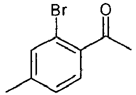 | 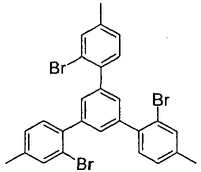 | 52 % |
| | 103286-27-7 | | |
| | B | | |
| S46 | 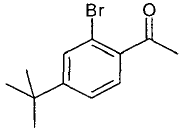 | 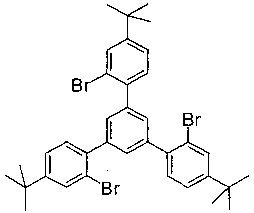 | 33% |
| | 147438-85-5 | | |
| S47 | 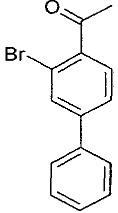 | 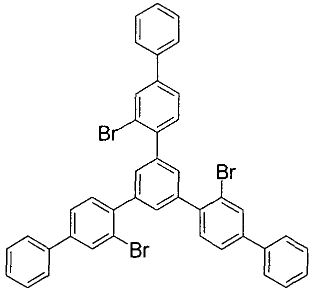 | 60 % |
| | 628735-63-7 | | |
| | B | | |
| S48 | 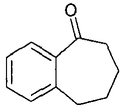 | 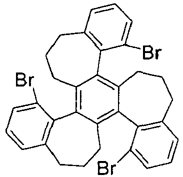 | 23 % |
| | 826-73-3 | | |
| | B | | |
| S49 | 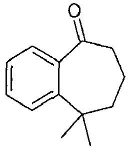 | 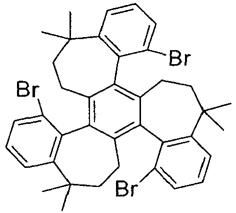 | 20 % |
| | 3345-09-3 | | |
| | B | | |

Folgende literaturbekannte Verbindungen können als Synthone eingesetzt werden:

| Synthon | |
|---|---|
| 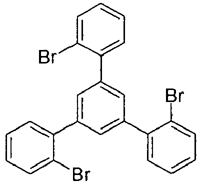 | 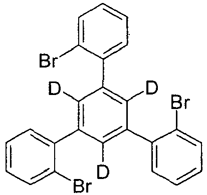 |
| 380626-56-2 | 1272029-05-6 |
| S50 | S51 |
| 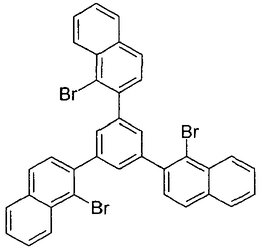 | 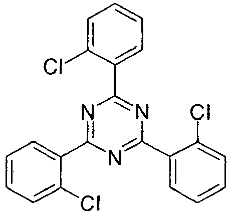 |
| 1422181-40-5 | 857972-74-8 |
| S52 | S53 |
| 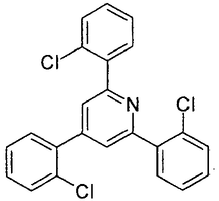 | |
| 857500-72-2 | |
| S101 | |

### Beispiel S102:

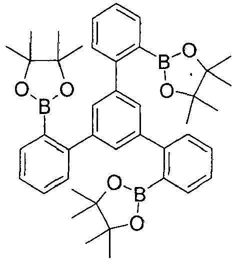

Ein Gemisch aus 54.3 g (100 mmol) 1,3,5-Tris-(2-bromphenyl)benzol, S50, [380626-56-2], 80.0 g (315 mmol) Bis(pinacolato)diboran [73183-34-3], 30.9 g (315 mmol) Kaliumacetat, 701 mg (2.50 mmol) Tricyclohexylphosphin, 281 mg (1.25 mmol) Palladium(II)acetat, 1000 ml 1,4-Dioxan und 200 g Glaskugeln (3 mm Durchmesser) wird 16 h unter Rückfluss erhitzt. Nach Abkühlen wird die Suspension über ein Celite-Bett filtriert und das Lösemittel im Vakuum entfernt. Der Rückstand wird in 1000 ml Ethylacetat aufgenommen, dreimal mit je 300 ml Wasser, einmal mit 300 ml gesättigter Kochsalzlösung gewaschen und dann über Magnesiumsulfat getrocknet. Nach Entfernen des Lösungsmittels wird der Rückstand aus Ethylacetat/Methanol umkristallisiert. Ausbeute: 56.8 g (83 mmol) 83 %. Reinheit: ca. 95 % ig n. ¹H-NMR.

Analog kann folgende Verbindung dargestellt werden:

| Bsp. | Arylhalogenid | Boronester | Ausbeute |
|---|---|---|---|
| S160 | 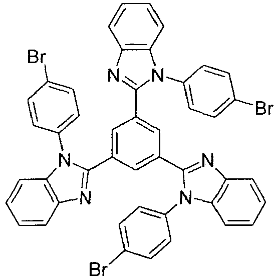 | 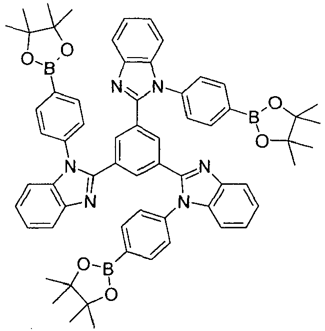 | 86 % |
| | 1149597-92-1 | | |

### Beispiel S63: 6-(4,4,5,5-Tetramethyl-[1,3,2]dioxaborolan-2-yl]-benzo[4,5]furo[3,2-b]pyridin

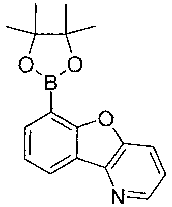

Durchführung analog Ishiyama, T. et al., Tetrahedron, 2001, 57(49), 9813. Ein gut gerührtes Gemisch aus 20.4 g (100 mmol) 6-Brom-benzo[4,5]-furo[3,2-b]pyridin [1609623-76-8], 27.9 g (110 mmol) Bis(pinacolato)-diboran [73183-34-3] und 19.6 g (200 mmol) Kaliumacetat wasserfrei, 200 g Glaskugeln (3 mm Durchmesser) in 500 ml Dioxan wird konsekutiv mit 1.7 g (6 mmol) Tricyclohexylphosphan [2622-14-2] und dann mit 1.7 g (3 mmol) Pd(dba)₂ [32005-36-0] versetzt und 16 h bei 90 °C gerührt. Alternativ kann als Katalysatorsystem auch 534 mg (1.3 mmol) SPhos [657408-07-6] und 225 mg (1 mmol) Palladium(II)acetat eingesetzt werden. Nach Erkalten filtriert am vom Feststoff ab, wäscht diesen mit 200 ml Dioxan nach und entfernt dann das Dioxan weitgehend im Vakuum. Man nimmt den Rückstand in 500 ml Ethylacetat auf, wäscht dreimal mit je 300 ml Wasser, einmal mit 300 ml gesättigter Kochsalzlösung und trocknet dann über Magnesiumsulfat. Der nach Entfernen des Ethylacetats erhaltene Schaum wird aus Acetonitril/Methanol umkristallisiert. Ausbeute: 23.0 g (78 mmol), 78 %. Reinheit: ca. 95 %-ig n. ¹H-NMR.

Analog können die folgenden Verbindungen synthetisiert werden:

| Bsp. | Arylhalogenid | Boronester | Ausbeute |
|---|---|---|---|
| S64 | 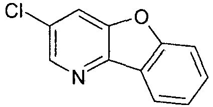 | 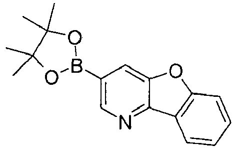 | 56 % |
| | 54168-14-8 | | |
| S65 | 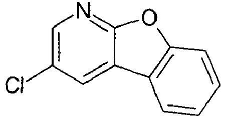 | 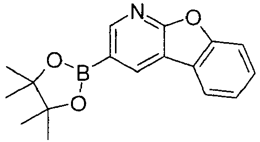 | 64 % |
| | 1424369-37-8 | | |
| S66 | 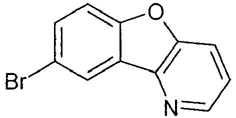 | 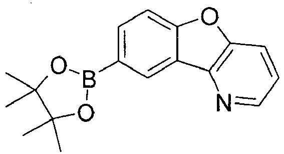 | 76 % |
| | 1384187-12-5 | | |
| S67 | 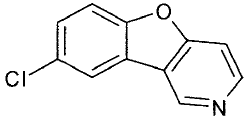 | 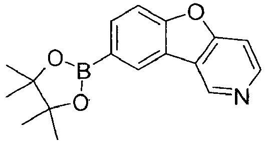 | 64 % |
| | 1174752-58-9 | | |
| S68 | 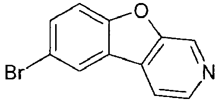 | 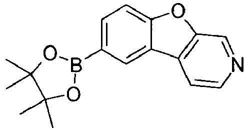 | 73 % |
| | 1585249-35-9 | | |
| S69 | 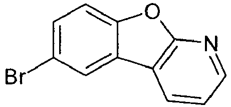 | 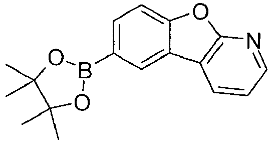 | 70 % |
| | 1507349-39-4 | | |
| S70 | 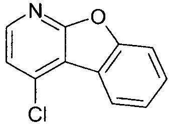 | 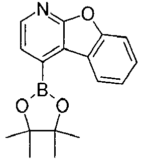 | 48 % |
| | 31874-94-9 | | |
| S105 | 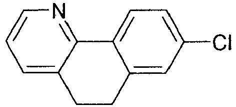 | 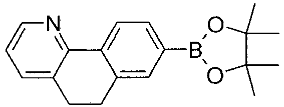 | 88 % |
| | S104 | | |
| S106 | 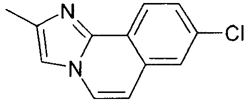 | 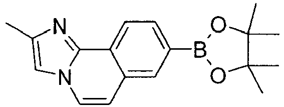 | 76 % |
| | 102200-03-3 | | |
| S107 | 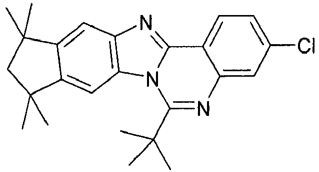 | 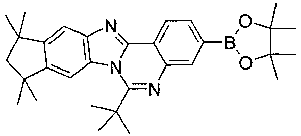 | 80 % |
| S118 | 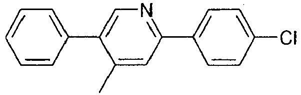 | 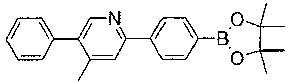 | 81 % |
| | S111 | | |
| S119 | 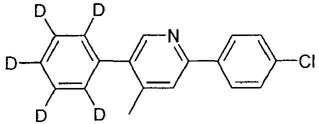 | 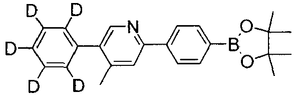 | 78 % |
| | S112 | | |
| S120 | 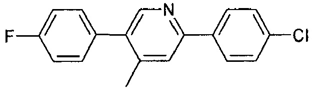 | 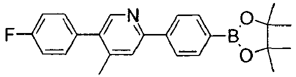 | 75 % |
| | S113 | | |
| S121 | 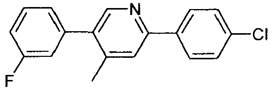 | 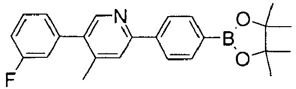 | 77 % |
| | S114 | | |
| S122 | 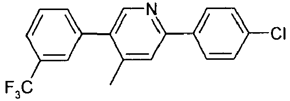 | 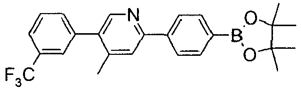 | 70 % |
| | S115 | | |
| S123 | 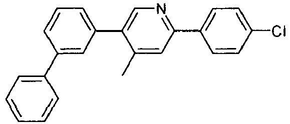 | 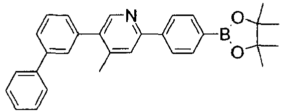 | 80 % |
| | S116 | | |
| S124 | 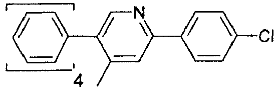 | 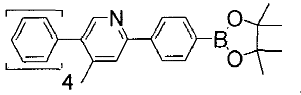 | 87 % |
| | S117 | | |
| | 250 ml Dioxan / 250 ml o-Xylol | | |

### Beispiel S104:

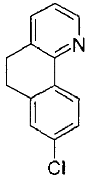

Ein Gemisch aus 18.1 g (100 mmol) 6-Chlor-tetralon [26673-31-4], 16,5 g (300 mmol) Propargylamin [2450-71-7], 796 mg [2 mmol] Natrium-tetrachloroaurat(III) Dihydrat und 200 ml Ethanol wird 24 h im Autoklaven bei 120 °C gerührt. Nach Erkalten entfernt man das Ethanol im Vakuum, nimmt den Rückstand in 200 ml Ethylacetat auf, wäscht die Lösung dreimal mit 200 ml Wasser, einmal mit 100 ml ges. Kochsalzlösung, trocknet über Magnesiumsulfat und filtriert dann von diesem über ein vorgeschlämmtes Kieselgelbett ab. Nach Entfernen des Ethylacetats im Vakuum wird der Rückstand an Kieselgel mit n-Heptan/Ethylaceat (1:2 vv) chromatographiert. Ausbeute: 9.7 g (45 mmol), 45 % . Reinheit: ca. 98 %-ig n. ¹H-NMR.

### Beispiel S110:

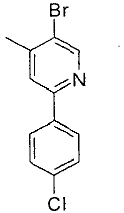

Ein Gemisch aus 25.1 g (100 mmol) 2,5-Dibrompyridin [3430-26-0], 15.6 g (100 mmol) 4-Chlorphenylboronsäure [1679-18-1], 27.6 g (200 mmol) Kaliumcarbonat,1.57 g (6 mmol) Triphenylphosphin [603-35-0], 676 mg (3 mmol) Palladium(II)acetat [3375-31-3], 200 g Glaskugeln (3 mm Durchmesser), 200 ml Acetonitril und 100 ml Ethanol wird 48 h unter Rückfluss erhitzt. Nach Erkalten entfernt man die Lösemittel im Vakuum, gibt 500 ml Toluol zu, wäscht zweimal mit je 300 ml Wasser, einmal mit 200 ml ges. Kochsalzlösung, trocknet über Magnesiumsulfat, filtriert über ein vorgeschlämmtes Kieselgelbett ab und wächt dieses mit 300 ml Toluol nach. Nach Entfernen des Toluols im Vakuum kristallisiert man einmal aus Methanol/Ethanol (1:1 vv) und einmal aus n-Heptan um. Ausbeute: 17.3 g (61 mmol), 61 %. Reinheit: ca. 95 %-ig n. ¹H-NMR.

### Beispiel S111:

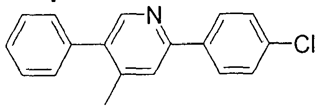

Ein Gemisch aus 28.3g (100 mmol) S110, 12.8 g (105 mmol) Phenylboronsäure, 31.8 g (300 mmol) Natriumcarbonat, 787 mg (3 mmol) Triphenylphosphin, 225 mg (1 mmol) Palladium(II)acetat, 300 ml Toluol, 300 ml Wasser wird 48 h unter Rückfluss erhitzt. Nach Erkalten wird mit 300 ml Toluol erweitert, die org. Phase wird abgetrennt, einmal mit 300 ml Wasser, einmal mit 200 ml ges. Kochsalzlösung gewaschen und über Magnesiumsulfat getrocknet. Nach Entfernen das Lösungsmittels wird der Rückstand an Kieselgel (Toluol/Ethylacetat, 9:1 vv) chromatographiert. Ausbeute: 17.1 g (61 mmol), 61 %. Reinheit: ca. 97 %-ig n. ¹H-NMR.

Analog können die folgenden Verbindungen synthetisiert werden:

| Bsp. | Boronester | Produkt | Ausbeute |
|---|---|---|---|
| S112 | 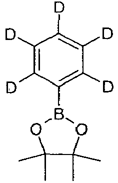 | 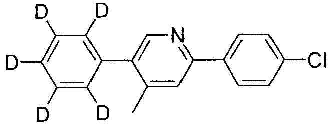 | 56 % |
| | 245043-33-8 | | |
| S113 | 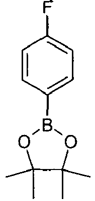 | 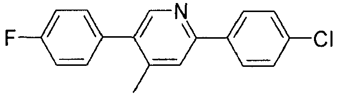 | 61 % |
| | 214360-58-4 | | |
| S114 | 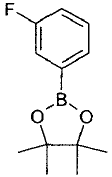 | 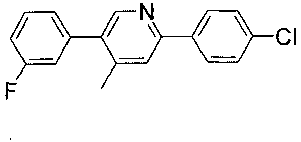 | 51 % |
| | 936618-92-7 | | |
| S115 | 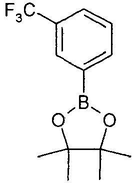 | 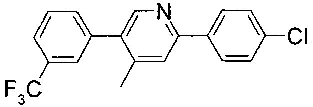 | 55 % |
| | 325142-82-3 | | |
| S116 | 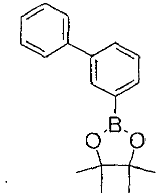 | 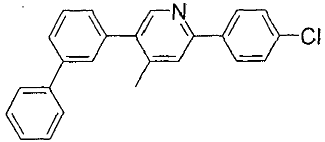 | 61 % |
| | 912844-88-3 | | |
| S117 | 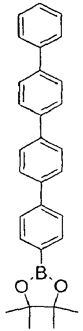 | 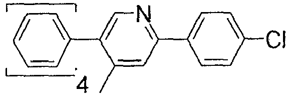 | 76 % |
| | 1802233-15-3 | | |

### Beispiel S200:

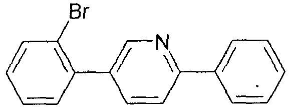

Ein Gemisch aus 28.1 g (100 mmol) 2-Phenyl-5-[4,4,5,5-tetramethyl-1,3,2-dioxaborolan-2-yl)pyridin [879291-27-7], 28.2 g (100 mmol) 1-Brom-2-iod-benzol [583-55-1], 31.8 g (300 mmol) Natriumcarbonat, 787 mg (3 mmol) Triphenylphosphin, 225 mg (1 mmol) Palladium(II)acetat, 300 ml Toluol, 150 ml Ethanol und 300 ml Wasser wird 24 h unter Rückfluss erhitzt. Nach Erkalten wird mit 500 ml Toluol erweitert, die org. Phase wird abgetrennt, einmal mit 500 ml Wasser, einmal mit 500 ml ges. Kochsalzlösung gewaschen und über Magnesiumsulfat getrocknet. Nach Entfernen das Lösungsmittels wird der Rückstand aus Ethylacetat/n-Heptan umkristallisiert oder an Kieselgel (Toluol/Ethylacetat, 9:1 vv) chromatographiert.
Ausbeute: 22.7 g (73 mmol), 73 %. Reinheit: ca. 97 %-ig n. ¹H-NMR.

Analog können die folgenden Verbindungen synthetisiert werden:

| Bsp. | Boronester | Produkt | Ausbeute |
|---|---|---|---|
| S201 | 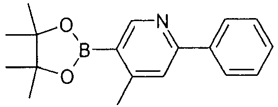 | 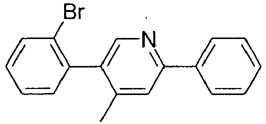 | 56 % |
| | S34 | | |
| S202 | 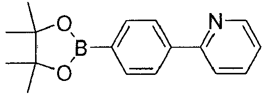 | 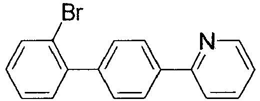 | 72 % |
| | 908350-80-1 | | |
| S203 | 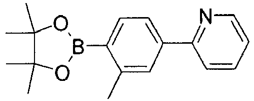 | 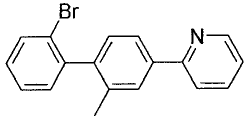 | 75 % |
| | S109 | | |
| S204 | 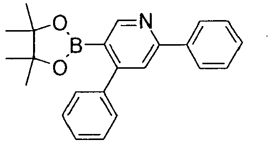 | 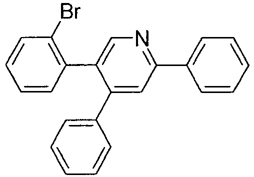 | 71 % |
| | S36 | | |
| S205 | 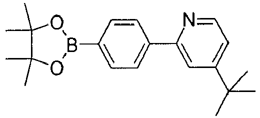 | 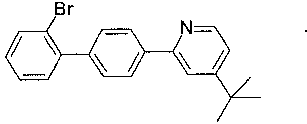 | 70 % |
| | S103 | | |
| S206 | 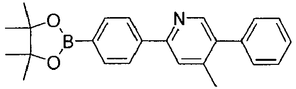 | 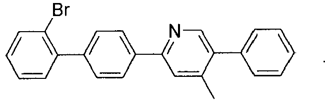 | 69 % |
| | S118 | | |
| S207 | 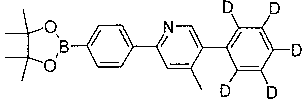 | 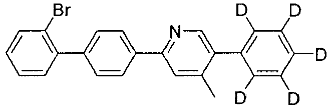 | 67 % |
| | S119 | | |
| S208 | 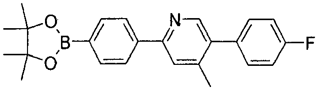 | 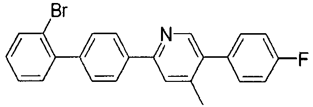 | 63 % |
| | S120 | | |
| S209 | 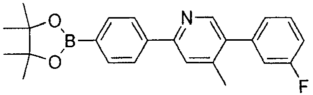 | 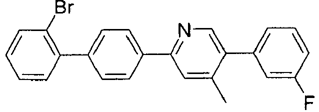 | 59 % |
| | S121 | | |
| S210 | 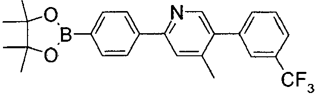 | 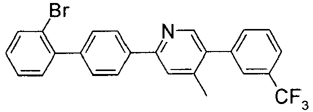 | 48 % |
| | S122 | | |
| S211 | 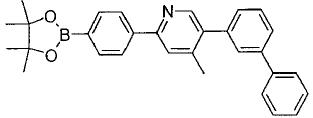 | 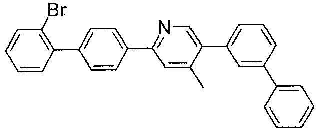 | 68 % |
| | S123 | | |
| S212 | 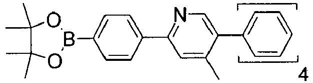 | 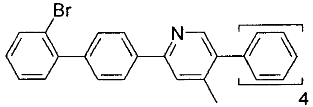 | 79 % |
| | S124 | | |
| S213 | 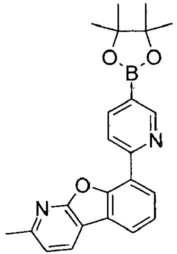 | 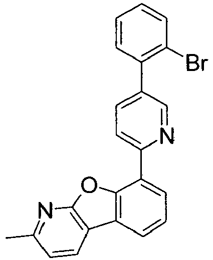 | 70 % |
| | S60 | | |
| S214 | 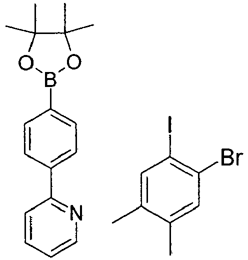 | 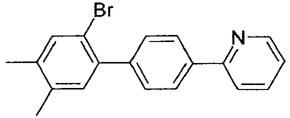 | 73 % |
| | 908350-80-1 / 96843-22-0 | | |
| S215 | 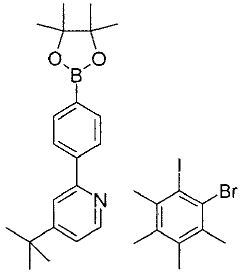 | 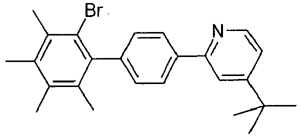 | 68 % |
| | S103 / 41571-55-5 | | |
| S216 | 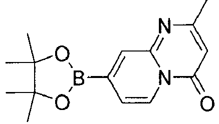 | 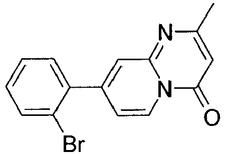 | 65 % |
| | S130 | | |
| S217 | 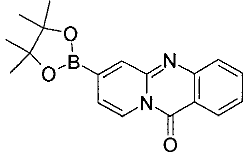 | 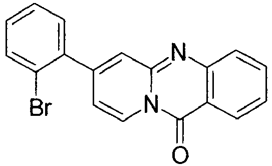 | 72 % |
| | S133 | | |
| S218 | 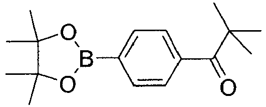 | 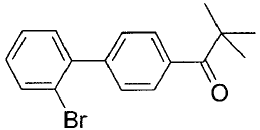 | 70 % |
| | S134 | | |
| S219 | 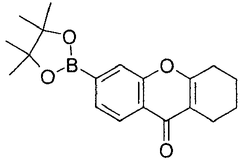 | 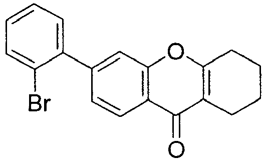 | 55 % |
| | S135 | | |
| S220 | 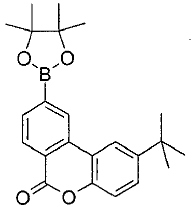 | 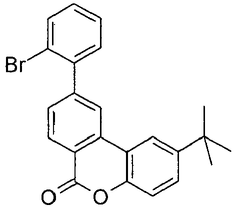 | 70 % |
| | S139 | | |
| S221 | 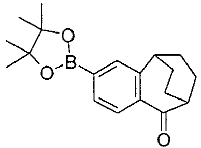 | 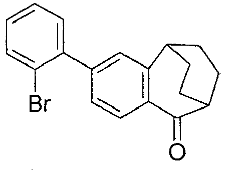 | 62 % |
| | S628 | | |
| S222 | 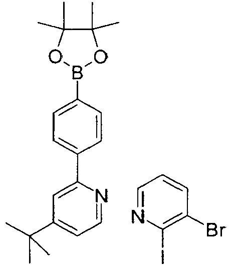 | 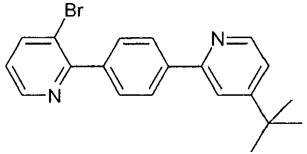 | 48 % |
| | S103 / 408502-43-2 | | |
| S223 | 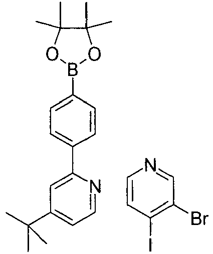 | 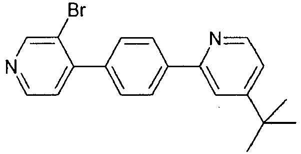 | 55 % |
| | S103 / 89167-19-1 | | |
| S224 | 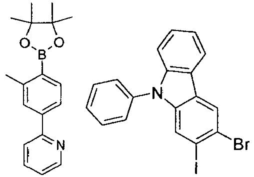 | 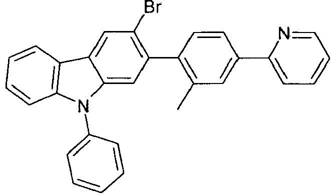 | 60 % |
| | S109 / 1549979-37-4 | | |
| S225 | 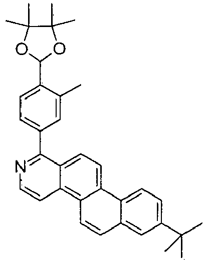 | 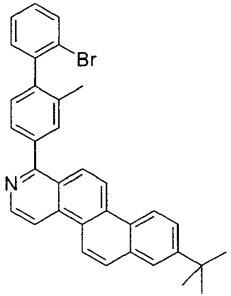 | 64 % |
| | S142 | | |
| S226 | 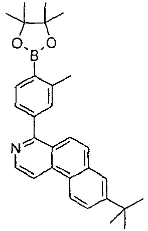 | 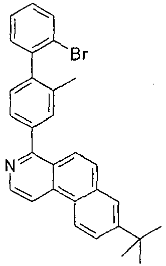 | 58 % |
| | S143 | | |

### Beispiel S300:

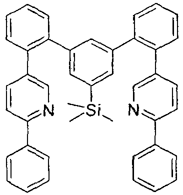

Ein Gemisch aus 40.2 g (100 mmol) 2,2'-5[5-(Trimethylsilyl)-1,3-phenylen-]bis[4,4,5,5-tetramethyl-1,3,2-dioxaborolan [383175-93-7], 65.2 g (210 mmol) S200, 42.4 g (400 mmol) Natriumcarbonat, 1.57 g (6 mmol) Triphenylphosphin, 500 mg (2 mmol) Palladium(II)acetat, 500 ml Toluol, 200 ml Ethanol und 500 ml Wasser wird 48 h unter Rückfluss erhitzt. Nach Erkalten wird mit 500 ml Toluol erweitert, die org. Phase wird abgetrennt, einmal mit 500 ml Wasser, einmal mit 500 ml ges. Kochsalzlösung gewaschen und über Magnesiumsulfat getrocknet. Nach Entfernen das Lösungsmittels wird der Rückstand an Kieselgel (n-Heptan/Ethylacetat 2:1 vv) chromatographiert. Ausbeute: 41.4 g (68 mmol), 68 %. Reinheit: ca. 95 %-ig n. ¹H-NMR.

Analog können die folgenden Verbindungen synthetisiert werden:

| Bsp. | Bromid | Produkt | Ausbeute |
|---|---|---|---|
| S301 | 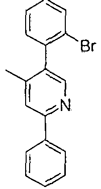 | 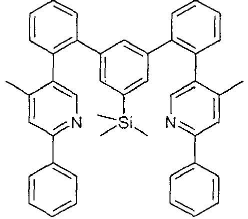 | 70 % |
| | S201 | | |
| S302 | 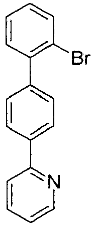 | 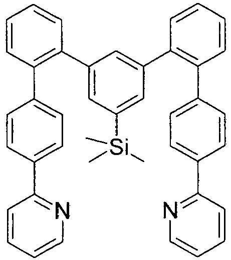 | 83 % |
| | S202 | | |
| S303 | 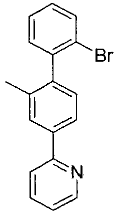 | 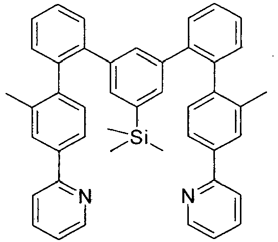 | 72 % |
| | S203 | | |
| S304 | 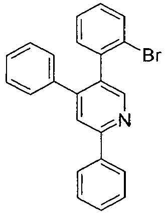 | 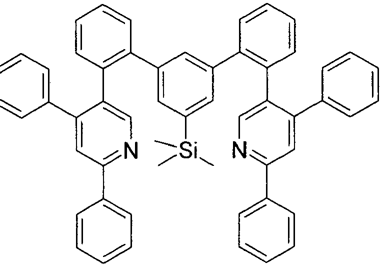 | 68 % |
| | S204 | | |
| S305 | 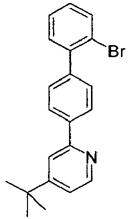 | 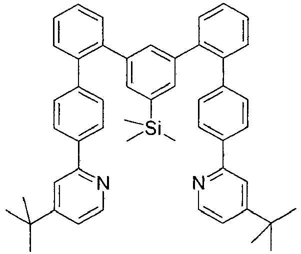 | 79 % |
| | S205 | | |
| S306 | S205 | 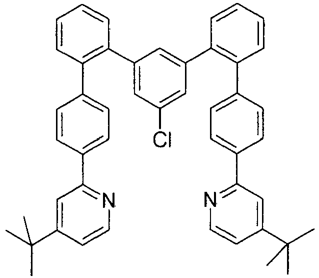 | 80 % |
| | 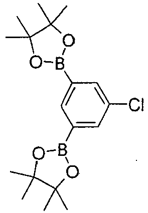 | | |
| | 1417036-49-7 | | |

### Beispiel S400:

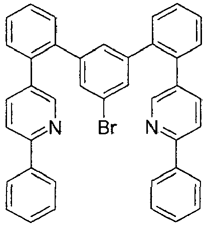

Eine auf 0°C gekühlte Lösung von 60.9 g (100 mmol) S300 in 500 ml Dichlormethan wird tropfenweise unter Lichtausschluss mit einer Mischung von 8.2 ml (160 mmol) Brom und 100 ml Dichlormethan versetzt. Nach beendeter Zugabe lässt man auf Raumtemperatur erwärmen und rührt 16 h nach, Dann versetzt man mit 100 ml Wasser, 300 ml Natriumhydrogencarbonat-Lösung und dann 150 ml wässriger 5 %-iger NaOH-Lösung. Man trennt die org. Phase ab, wäscht diese dreimal mit 200 ml Wasser, einmal mit 200 ml ges. Kochsalzlösung und trocknet dann über Magnesiumsulfat. Nach Entfernen des Lösungsmittels wird der ölige Rückstand aus Ethylacetat (ca. 1.5 ml/g) umkristallisiert. Ausbeute: ca. 20 g Rohprodukt 1. Die Mutterlauge wird chromatographiert (CombiFlash Torrent der Fa. A. Semrau). Ausbeute: ca. 20 g Rohprodukt 2. Die vereinigten Rohprodukte werden zusammen erneut aus Ethylacetat umkristallisiert.
Ausbeute: 33.8 g (55 mmol), 55 %. Reinheit: ca. 97 %-ig n. ¹H-NMR.

Analog können die folgenden Verbindungen synthetisiert werden:

| Bsp. | Edukt | Produkt | Ausbeute |
|---|---|---|---|
| S401 | 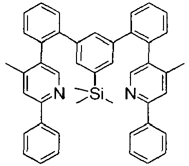 | 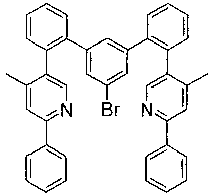 | 48 % |
| | S301 | | |
| S402 | 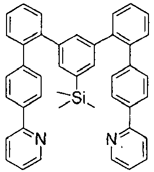 | 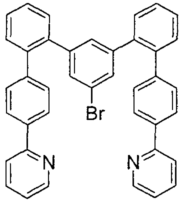 | 50 % |
| | S302 | | |
| S403 | 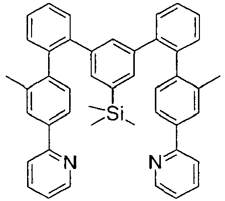 | 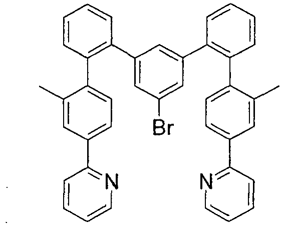 | 54 % |
| | S303 | | |
| S404 | 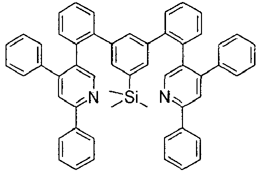 | 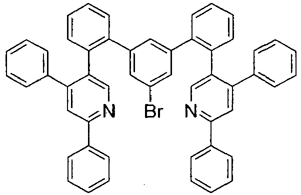 | 55 % |
| | S304 | | |
| S405 | 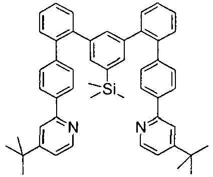 | 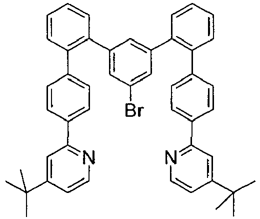 | 61 % |
| | S305 | | |

### Beispiel S500:

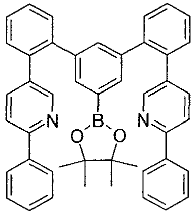

Ein Gemisch aus 61.6 g (100 mmol) S400, 27.9 g (110 mmol) Bis(pinacolato)diboran [73183-34-3], 29.4 g (300 mmol) Kaliumacetat, 561 mg (2 mmol) Tri-cyclohexylphosphin, 225 mg (1 mmol) Palladium(II)acetat, 100 g Glaskugeln (3 mm Durchmesser), 500 ml 1,4-Dioxan wird 16 h unter Rückfluss erhitzt. Nach Abkühlen wird die Suspension im Vakuum vom 1,4-Dioxan befreit, der Rückstand wird in 500 ml Ethylacetat aufgenommen, zweimal mit 300 ml Wasser und einmal mit 200 ml ges. Kochsalzlösung gewaschen, über Magnesiumsulfat getrocknet und dann über ein vorgeschlämmtes Celite-Bett filtriert, welches mit etwas Ethylacetat nachgewaschen wird. Das Filtrat wird zur Trockene eingeengt und anschließend aus Ethylacetat/Methanol umkristallisiert. Ausbeute: 55.0 g (83 mmol), 83 %. Reinheit: ca. 97 %-ig n. ¹H-NMR.

Analog können die folgenden Verbindungen synthetisiert werden:

| Bsp. | Edukt | Produkt | Ausbeute |
|---|---|---|---|
| S501 | 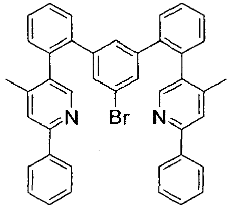 | 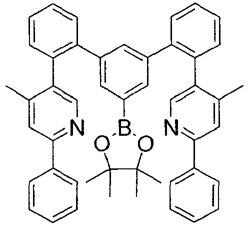 | 78 % |
| | S401 | | |
| S502 | 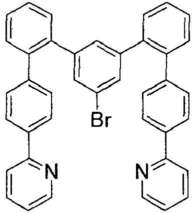 | 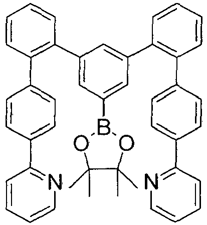 | 70 % |
| | S402 | | |
| S503 | 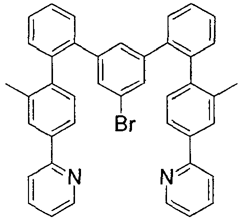 | 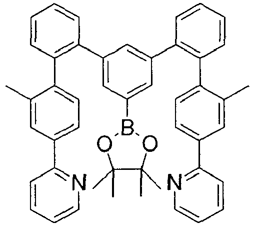 | 64 % |
| | S403 | | |
| S504 | 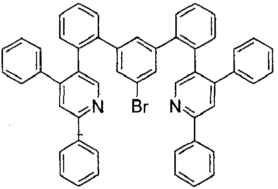 | 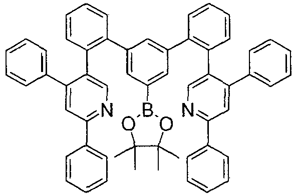 | 77 % |
| | S404 | | |
| S505 | 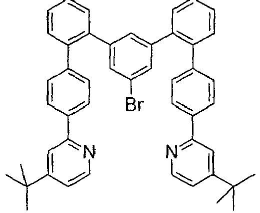 | 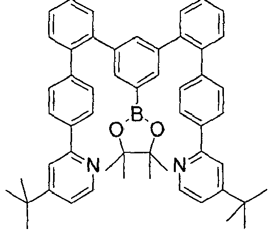 | 73 % |
| | S405 | | |
| S505 | 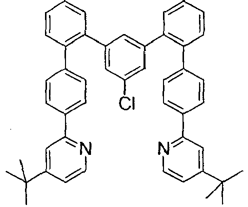 | 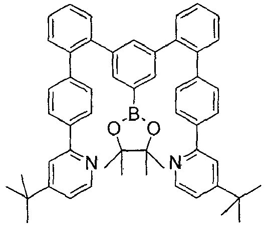 | 80 % |
| | S306 | | |

### Beispiel S600:

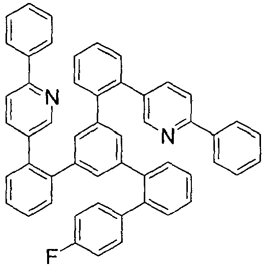

Ein Gemisch aus 66.3 g (100 mmol) S500, 27.6 g (110 mmol) 2-Brom-4'-fluor-1,1'-biphenyl [89346-54-3], 63.7 g (300 mmol) Tri-kaliumphosphat, 1.64 g (4 mmol) SPhos [657408-07-6], 449 mg (2 mmol) Palladium(II)-acetat, 700 ml Toluol, 300 ml Dioxan und 500 ml Wasser wird 8 h unter Rückfluss erhitzt. Nach Abkühlen wird die org. Phase abgetrennt, zweimal mit 300 ml Wasser und einmal mit 200 ml ges. Kochsalzlösung gewaschen, über Magnesiumsulfat getrocknet und dann über ein vorgeschlämmtes Celite-Bett filtriert, welches mit Toluol nachgewaschen wird. Das Filtrat wird zur Trockene eingeengt und der so erhaltene Feststoff wird anschließend zweimal aus Ethylacetat/Methanol umkristallisiert. Ausbeute: 49.5 g (70 mmol), 70 %. Reinheit: ca. 97 %-ig n. ¹H-NMR.

Analog können die folgenden Verbindungen synthetisiert werden:

| Bsp. | Edukte | Produkt | Ausbeute |
|---|---|---|---|
| S601 | S501 | 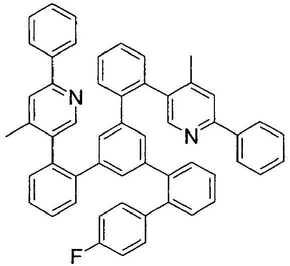 | 74 % |
| S602 | S504 | 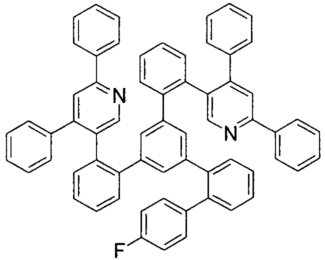 | 71 % |
| S603 | S503 | 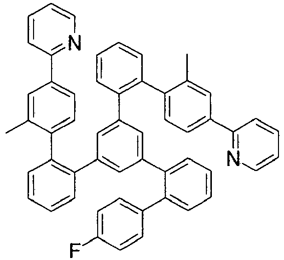 | 73 % |
| S604 | S505 | 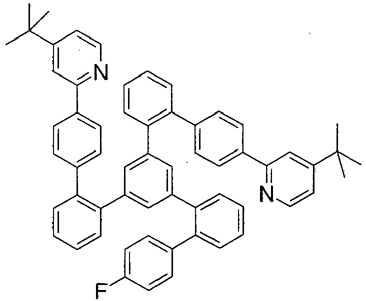 | 81 % |

### Beispiel S610:

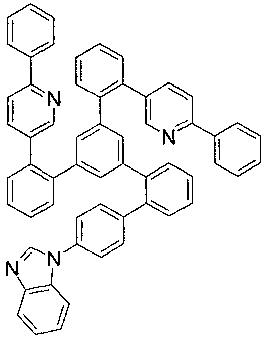

Analog F. Diness et al., Angew. Chem. Int. Ed., 2012, 51, 8012.
Ein Gemisch aus 35.3 g (50 mmol) S600, 11.8 g (100 mmol) Benzimidazol, 97.9 g (300 mmol) Cäsiumcarbonat in 500 ml N,N-Dimethylacetamid wird im Rührautoklaven 16 h auf 175 °C erhitzt. Nach Erkalten zieht man das Lösungsmittel weitgehend ab, mimmt den Rückstand in 500 ml Toluol auf, wäscht dreimal mit je 300 ml Wasser, einmal mit 300 ml ges. Natriumchloridlösung, trocknet über Magnesiumsulfat und filtriert dann über ein vorgeschlämmtes Celite-Bett ab. Nach Entfernen des Lösungsmittels im Vakuum wird der Rückstand aus Ethylacetat/Methanol umkristallisiert. Ausbeute: 33.0 g (41 mmol), 82 %. Reinheit: ca. 97 %-ig n. ¹H-NMR.

Analog können die folgenden Verbindungen synthetisiert werden:

| Bsp. | Edukte | Produkt | Ausbeute |
|---|---|---|---|
| S611 | S600 | 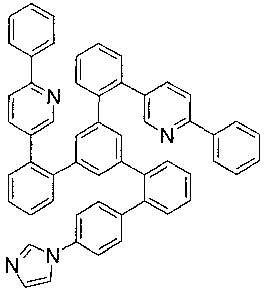 | 74 % |
| | 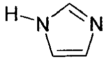 | | |
| | 233-32-4 | | |
| S612 | S601 | 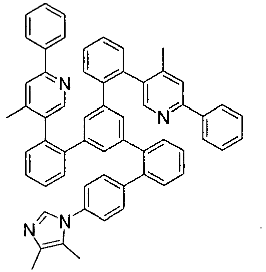 | 64 % |
| | 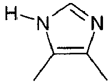 | | |
| | 2302-39-8 | | |
| S613 | S601 | 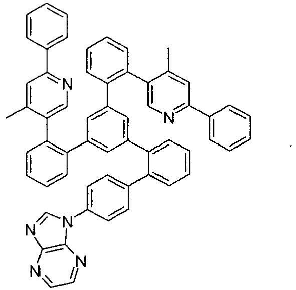 | 78 % |
| | 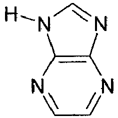 | | |
| | 273-94-9 | | |
| S614 | | 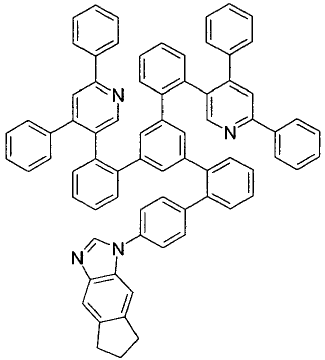 | 75 % |
| | 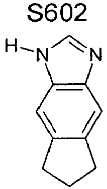 | | |
| | 83655-80-5 | | |
| S615 | S603 | 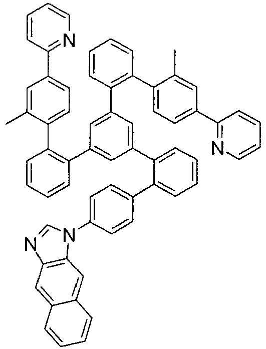 | 70 % |
| | 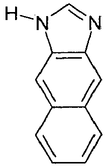 | | |
| | 269-07-8 | | |
| S616 | S604 | 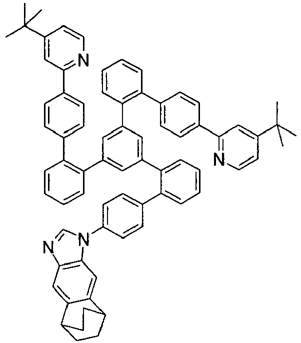 | 64 % |
| | 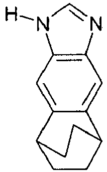 | | |
| | 7271-60-5 | | |
| S617 | S604 | 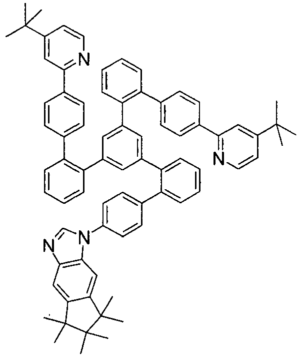 | 68 % |
| | 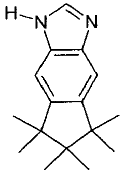 | | |
| | 1562420-66-9 | | |

### Beispiel S620:

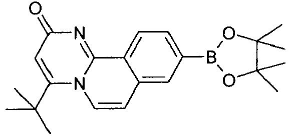

Ein Gemisch aus 12.6 g (50 mmol) 4-tert-Butyl-2H-pyrimido[2,1-a]isochinolin-2-on, 12.7g (50 mmol) Bis-(pinacolato)diborann [73183-34-3] und 200 ml Mesitylen wird mit 1.7 g (2.5 mmol) Bis[(1,2,5,6-η)-1,5-cyclooctadien]di-µ-methoxydi-iridium(I) [12148-71-9] und dann mit 1.4 g (5 mmol) 4,4'-Di-tert-butyl-[2,2']bipyridinyl [72914-19-3] versetzt und anschließend 16 h bei 120 °C gerührt. Nach Erkalten entfernt man das Lösungsmittel im Vakuum, nimmt den Rückstand in Dichlormethan auf, filtriert über ein vorgeschlämmtes Celite-Bett ab, engt das Filtrat zur Trockene ein und chromatographiert dann mit Dichlormethan:Ethylacetat (9:1) an Kieselgel. Ausbeute: 8.0 g (21 mmol), 42 %; Reinheit: ca. 95 %ig nach ¹H-NMR.

Analog können folgende Verbindungen dargestellt werden:

| Bsp. | Edukt | Produkt Boronsäureester | Ausbeute |
|---|---|---|---|
| S621 | 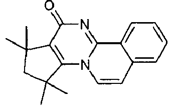 | 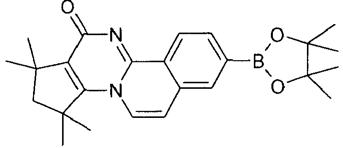 | 31 % |
| | 1616465-35-0 | | |
| S622 | 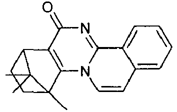 | 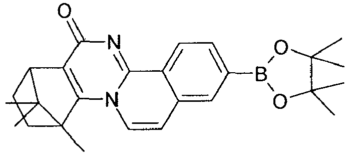 | 37 % |
| | 1616465-31-6 | | |
| S623 | 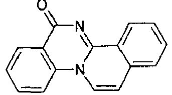 | 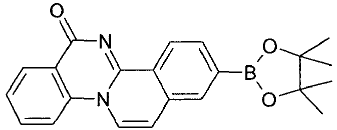 | 17 % |
| | 1615694-84-2 | | |
| S624 | 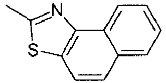 | 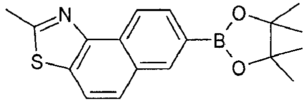 | 27 % |
| | 2682-45-3 | | |
| S625 | 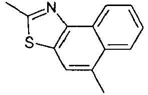 | 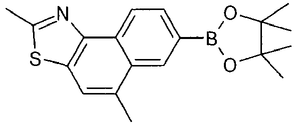 | 51 % |
| | 109129-67-1 | | |
| S626 | 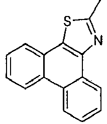 | 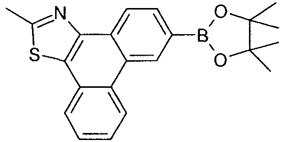 | 13 % |
| | 21639-90-7 | | |
| S627 | 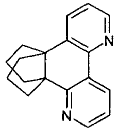 | 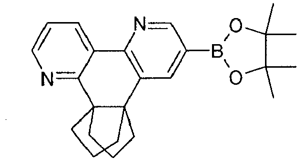 | 23 % |
| | S651 | | |
| S628 | 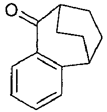 | 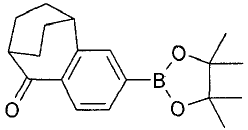 | 21 % |
| | 56129-78-3 | | |

### Beispiel S650:

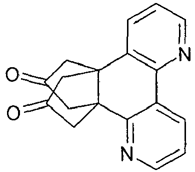

Man bereitet aus 11.5 g (500 mmol) Natrium und 1000 ml Methanol eine Natriummethanolat-Lösung. Zu dieser gibt man unter Rühren 43.6 g (250 mmol) 1,3-Acetondicarbonsäuredimethylester [1830-54-2] und rührt 10 min. nach. Dann fügt man 21.0 g (100 mmol) 1,7-Phenanthrolin-5,6-dion [82701-91-5] fest zu. Nach 16 h rühren unter Rückfluss entfernt man das Methanol im Vakuum. Man versetzt den Rückstand vorsichtig mit 1000 ml Eisessig (Achtung: Schäumen!) und fügt zur braunen Lösung 60 ml Wasser und 180 ml konz. Salzsäure zu. Man erhitzt die Reaktionsmischung 16 h unter Rückfluss, lässt dann erkalten, gießt auf 5 kg Eis und neutralisiert unter Kühlung durch Zugabe von fester Natronlauge. Man saugt vom ausgefallenen Feststoff ab, wäscht diesen dreimal mit je 300 ml Wasser nach und trocknet im Vakuum. Das Rohprodukt wird 1 h in 1000 ml Dichlormethan bei 40 °C gerührt und dann noch warm über ein Celite-Bett filtriert, um unlösliche Anteile zu entfernen. Nach Entfernen des Dichlormethans im Vakuum wird der Rückstand in 100 ml Dioxan in der Siedehitze gelöst und dann ab 80 °C tropfenweise mit 500 ml Methanol versetzt. Nach Erkalten und 12 h Nachrühren bei Raumtemperatur wird der Feststoff abgesaugt, mit etwas Methanol gewaschen und im Vakuum getrocknet. Ausbeute: 18.3 g (63 mmol), 63%; Reinheit: ca. 90%ig nach ¹H-NMR. Das so erhaltene Produkt wird ohne Reinigung weiter umgesetzt.

### Beispiel S651:

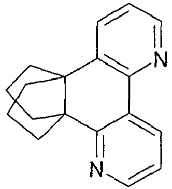

Ein Gemisch aus 21.0 g (100 mmol) S650, 50.1 g (1 mol) Hydrazinhydrat, 67.3 g (1.2 mol) Kaliumhydroxid und 400 ml Ethylenglykol wird 4 h unter Rückfluss erhitzt. Dann steigert man die Temperatur langsam und destilliert das gebildete Wasser und überschüssiges Hydrazinhydrat am Wasserabscheider ab. Nach 16 h unter Rückfluss lässt man die Reaktionsmischung erkalten, gießt in 2 l Wasser ein und extrahiert dreimal mit je 500 ml Dichlormethan. Man wäscht die Dichlormethanphase fünfmal mit je 300 ml Wasser, und zweimal mit je 300 ml gesättigter Kochsalzlösung und trocknet über Magnesiumsulfat. Nach Entfernen das Dichlormethans im Vakuum wird der ölige Rückstand an Kieselgel mit Dichlormethan chromatographiert (Rf ca. 0.5). Zur weiteren Reiningung kann das so erhaltene hellgelbe Öl Kugelrohr-destilliert oder aus Methanol umkristallisiert werden. Ausbeute: 15.5 g (59 mmol), 59 %; Reinheit: ca. 97%ig nach ¹H-NMR.

### Beispiel S660 und S661:

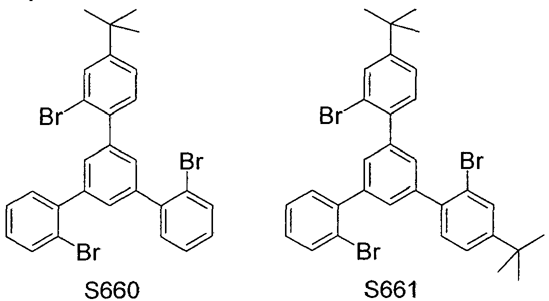

Ein Gemisch aus 10.0 g (50 mmol) 2-Bromacetophenon [2142-69-0],11.3 g (50 mmol) 2-Brom-4-tert-butyl-acetophenon [147438-85-5] und 1.5 g (10 mmol) Trifluormethansulfonsäure [1493-13-6] wird 18 h bei 140 °C am Wasserabscheider gerührt. Nach Erkalten nimmt man den Rückstand in 300 ml Ethylacetat auf, wäscht dreimal mit je 100 ml Wasser, einmal mit 100 ml gesättigter Kochsalzlösung und trocknet dann über Magnesiumsulfat. Das Rohprodukt wird chromatographiert, Torrent der Fa. Axel Semrau. Ausbeute bezogen auf Acetophenon-Gruppen: S660: 2.6 g (4.3 mmol), 12 %; S661: 2.5 g (3.8 mmol) 11 %. Reinheit jeweils: ca. 97 %-ig n. ¹H-NMR.

Analog können folgende Verbindungen dargestellt werden:

| Bsp. | Edukte | Produkte | Ausbeute |
|---|---|---|---|
| S662 | 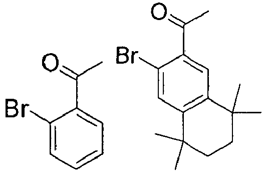 | 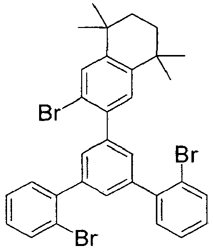 | 11 % |
| | 2142-69-0 / 27452-18-2 | | |
| S663 | wie S662 | 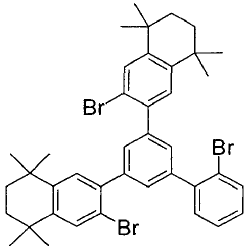 | 10 % |
| S664 | 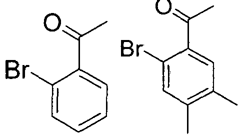 | 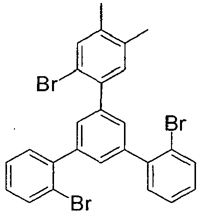 | 12 % |
| | 2142-69-0 / 15089-75-5 | | |
| S665 | wie S664 | 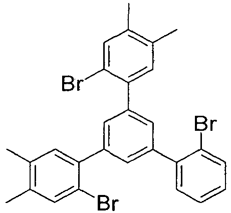 | 14 % |
| S666 | 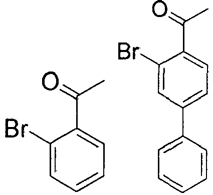 | 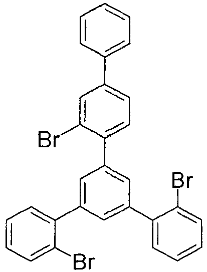 | 16 % |
| | 2142-69-0 / 628735-63-7 | | |
| S667 | wie S666 | 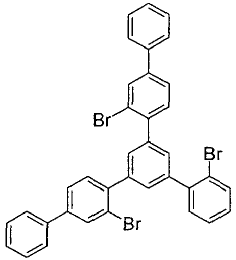 | 17% |

### Beispiel S680:

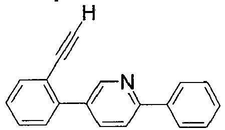

Ein Gemisch aus 29.7 g (100 mmol) S200, 11.0 g (110 mmol) Trimethylsilylacetylen [1066-54-2], 300 ml DMF und 20.8 ml (150 mmol) Triethylamin [121-44-8] wird mit 762 mg (4 mmol) Kupfer(I)iodid [7681-65-4] und dann mit 1.4 g (2 mmol) Bis(triphenylphosphino)palladium(II)chlorid [13965-03-2] versetzt und dann 6 h bei 80 °C gerührt.Nach Erkalten filtriert man vom ausgefallenen Triethylammoniumhydrochlorid ab, engt das Filtrat im Vakuum zu Trockene ein, nimmt den Rückstand in 300 ml DCM auf, filtriert über ein vorgeschlämmtes Celite-Bett ab, wäscht das Filtrat dreimal mit je 100 ml Wasser, einmal mit 100 ml ges. Kochsalzlösung und trocknet über Magnesiumsulfat. Man filtriert vom Magnesiumsulfat ab, engt das Filtrat im Vakuum ein, nimmt den öligen Rückstand in 300 ml Methanol auf, gibt 27.6 g (200 mmol) Kaliumcarbonat [584-08-7] und 50 g Glaskugeln (3 mm Duchmesser) zu und, rührt 12 h bei Raumtemperatur, filtriert vom Kaliumcarbonat und den Glaskugeln über ein vorgeschlämmtes Celite-Bett ab und engt das Filtrat im Vakuum komplett ein. Ausbeute: 22.7 g (89 mmol), 89 %; Reinheit: ca. 95%ig nach ¹H-NMR. Das so erhaltene Produkt wird ohne Reinigung weiter umgesetzt.

Analog kann fiolgende Verbindung dargestellt werden.

| Bsp. | Edukt | Produkt | Ausbeute |
|---|---|---|---|
| S681 | 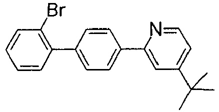 | 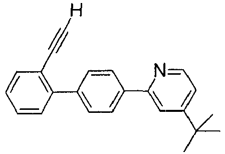 | 90 % |
| | S205 | | |

### B: Synthese der Liganden und Ligandenvorstufen L - Teil1:

### Beispiel L1:

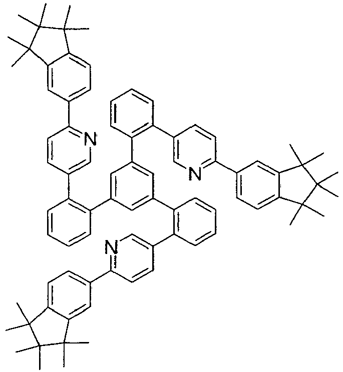

### Variante A:

Ein Gemisch aus 54.1 g (100 mmol) 1,3,5-Tris(2-bromphenyl)benzol, S50, [380626-56-2], 141.9 g (350 mmol) 2-[1,1,2,2,3,3-Hexamethyl-indan-5-yl]-5-(4,4,5,5-tetramethyl-[1,3,2]dioxaborolan-2-yl)-pyridin S21, 106.0 g (1 mol) Natriumcarbonat, 5.8 g (5 mmol) Tetrakis(triphenyphosphino)-palladium(0), oder alternativ Triphenyl- oder Tri-o-tolylphosphin und Palladium(II)acetat im molaren Verhältnis von 3:1, 750 ml Toluol, 200 ml Ethanol und 500 ml Wasser wird unter sehr gutem Rühren 24 h unter Rückfluss erhitzt. Nach 24 h fügt man 300 ml 5 Gew.-%ige wässrige Acetylcystein-Lösung zu, rührt weitere 16 h unter Rückfluss, lässt erkalten, trennt die wässrige Phase ab und engt die organische Phase zur Tockene ein. Man nimmt den braunen Schaum in 300 ml Ethylacetat auf und filtriert über ein mit Ethylacatat vorgeschlämmtes Kieselgelbett (Durchmesser 15 cm, Länge 20 cm), um braune Anteile zu entfernen. Nach Einengen auf 200 ml wird die Lösung unter sehr gutem Rühren in 1000 ml Methanol eingetropft, wobei ein beiger Feststoff ausfällt. Der Feststoff wird abgesaugt, zweimal mit je 200 ml Methanol gewaschen und im Vakuum getrocknet. Der Umfällprozess wird erneut wiederholt. Ausbeute: 54.7 g (48 mmol), 48 %. Reinheit: ca. 95 %ig nach ¹H-NMR.
Verbliebene Nebenkomponenten sind häufig das Disubstitutionsprodukt und/oder das debromierte Disubstitutionsprodukt. Eine Reinheit von ca. 90 % oder sogar weniger ist ausreichend, um in der o-Metallierungsreaktion eingesetzt zu werden. Die Liganden können bei Bedarf durch Chromatographie an Kieselgel (n-Heptan oder Cyclohexan oder Toluol in Kombination mit Ethylacetat, Dichlormethan, Aceton, etc., gegebenenfalls unter Zusatz einer polar-protischen Komponente wie Methanol oder Essigsäure) weiter gereinigt werden. Alternativ können Liganden ohne sperrige Alkylgruppen aus Ethylacetat oder Acetonitril, gegebenfalls unter Zusatz von MeOH oder EtOH, umkristallisiert werden. Liganden mit einer Molmasse kleiner ca. 1000-1200 g/mol können im Hochvakuum (p ca. 10⁻⁵ mbar) Kugelrohr-sublimiert werden.

Die NMR-Spektren der Liganden - insbesondere der von Liganden mit verbrückten Teilliganden - sind häufig komplex, da häufig Mischungen von syn- und anti-Rotameren in Lösung vorliegen.

### Beispiel L2:

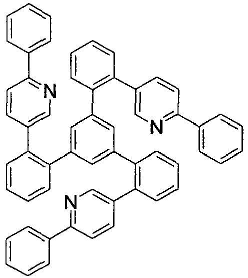

### Variante B:

Durchführung analog Beispiel L1, wobei S21 durch S22 ersetzt wird. Reinigung: Man nimmt den braunen Schaum nach Einengen der organischen Phase aus der Suzuki-Kupplung in 300 ml eines Gemischs aus Dichlormethan:Ethylacetat (8:1, vv) auf und filtriert über ein mit Dichlormethan:Ethylacetat (8:1, vv) vorgeschlämmtes Kieselgelbett (Durchmesser 15 cm, Länge 20 cm), um braune Anteile zu entfernen. Nach Einengen wird der verbliebene Schaum aus 800 ml Ethylacetat unter Zusatz von 400 ml Methanol in der Siedehitze und dann ein zweites Mal aus 1000 ml reinem Ethylacetat umkristallisiert und anschließend im Hochvakuum (p ca. 10⁻⁵ mbar, T 280 °C) Kugelrohr-sublimiert. Liganden mit einer Molmasse größer ca. 1000 - 1200 g/mol werden ohne Kugelrohr-Sublimation / -Destillation eingesetzt. Ausbeute: 50.6 g (66 mmol), 66 %. Reinheit: ca. 99.7 % ig n. ¹H-NMR.

### Variante C:

Durchführung analog Beispiel L1, wobei S21 durch S22, das Natriumcarbonat durch 127.4 g (600 mmol) Trikaliumphosphat [7778-53-2] und das Tetrakis(triphenyphosphino)-palladium(0) durch 1.6 g (4 mmol) SPhos [657408-07-6] und 674 mg (3 mmol) Palladium(II)acetat [3375-31-3] ersetzt wird. Reinigung: wie unter Variante B. Ausbeute: 40.6 g (53 mmol), 53%. Reinheit: ca. 99.5 %ig nach ¹H-NMR.

### Variante D:

Die wässrige Phase wird fünfmal mit 200 ml DCM ausgezogen. Die vereinigten organischen Phasen werden vom Lösungsmittel befreit. Der Rückstand wird in 1000 ml DCM:Acetonitrit:Methanot 1:1:0:1 aufgenommen, über Celite filtriert. Das Filtrat wird im Vakuum vom Lösungsmittel befreit, der Rückstand wird aus 300 ml Methanol heiß ausgerührt und anschließend im Vakuum getrocknet.

Analog können folgende Verbindungen dargestellt werden:

| Bsp. | Bromid Boronsäure / ester / tetrafluoro-borat | Produkt Variante | Ausbeute |
|---|---|---|---|
| L3 | S50 | 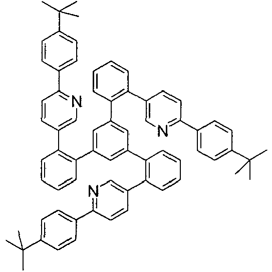 | 63 % |
| | S23 | | |
| | | B | |
| L4 | S50 | 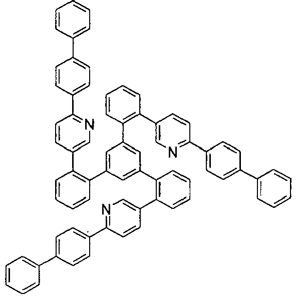 | 72 % |
| | S24 | | |
| | | B | |
| L5 | S50 | 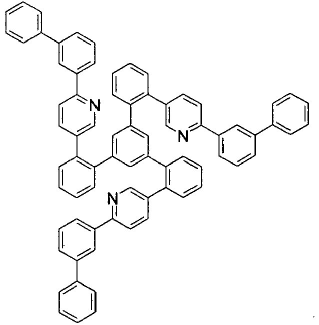 | 58 % |
| | S25 | | |
| | | A | |
| L6 | S50 | 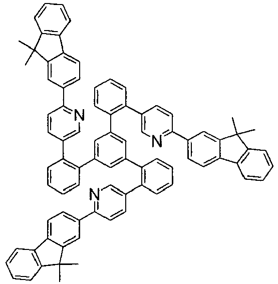 | 60 % |
| | S26 | | |
| | | A | |
| L7 | S50 | 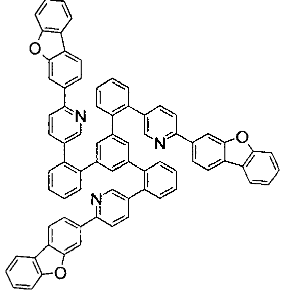 | 58 % |
| | S27 | | |
| | | B | |
| L8 | S50 | 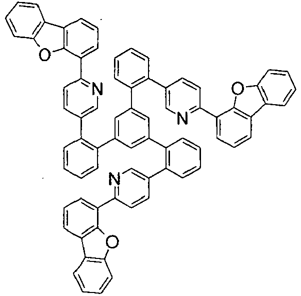 | 51 % |
| | S28 | | |
| | | A | |
| L9 | S50 | 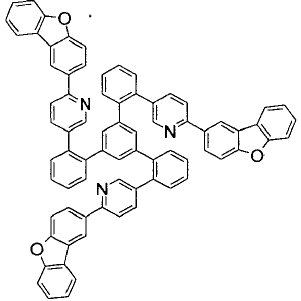 | 52 % |
| | S29 | | |
| | | B | |
| L10 | S50 | 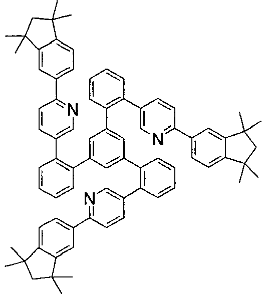 | 51 % |
| | S30 | | |
| | | A | |
| L11 | S50 | 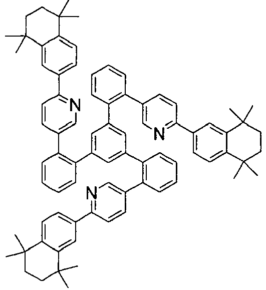 | 47 % |
| | S31 | | |
| | | A | |
| L12 | S50 | 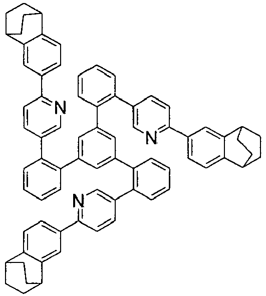 | 50 % |
| | S32 | | |
| | | A | |
| L13 | S50 | 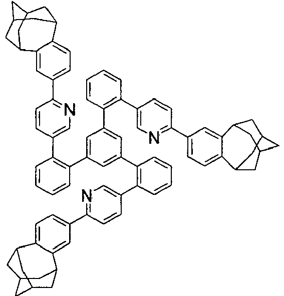 | 53 % |
| | S33 | | |
| | | A | |
| L14 | S50 | 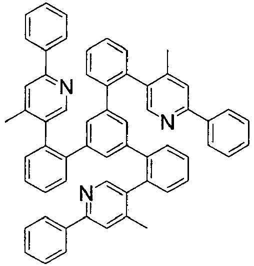 | 43 % |
| | S34 | | |
| | | C | |
| L15 | S50 | 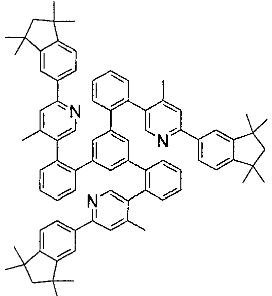 | 40 % |
| | S35 | | |
| | | C | |
| L16 | S50 | 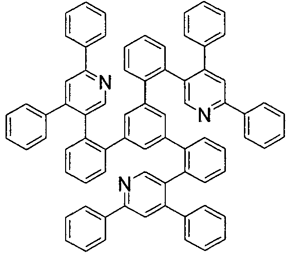 | 54 % |
| | S36 | | |
| | | C | |
| L17 | S50 | 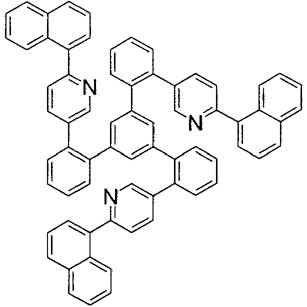 | 59 % |
| | S37 | | |
| | | B | |
| L18 | S50 | 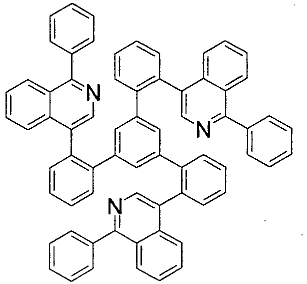 | 45 % |
| | S38 | | |
| | | B | |
| L19 | S50 | 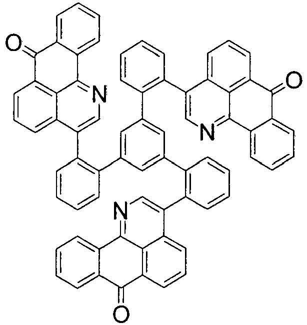 | 57 % |
| | S39 | | |
| | | B | |
| L20 | S50 | 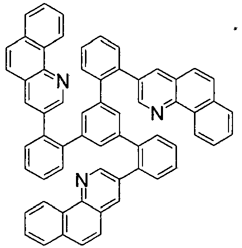 | 60 % |
| | S40 | | |
| | | C | |
| L21 | S50 | 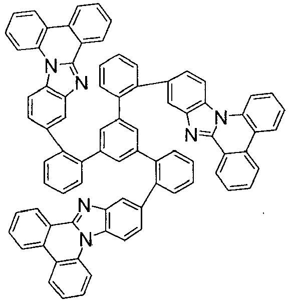 | 62 % |
| | S41 | | |
| | | B | |
| L22 | S50 | 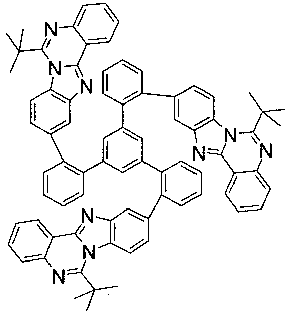 | 60 % |
| | S42 | | |
| | | C | |
| L23 | S50 | 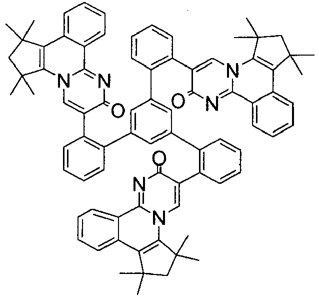 | 57 % |
| | S43 | | |
| | | A | |
| L24 | S44 | 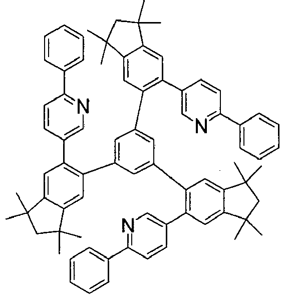 | 43 % |
| | S22 | | |
| | | A | |
| L25 | S44 | 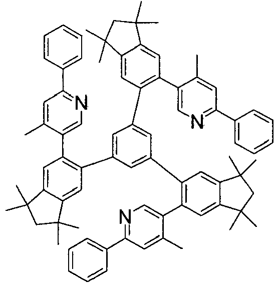 | 40 % |
| | S34 | | |
| | | C | |
| L26 | S45 | 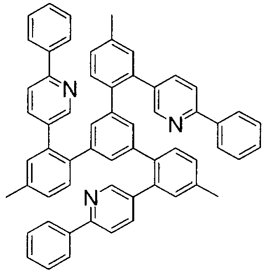 | 59 % |
| | S22 | | |
| | | C | |
| L27 | S46 | 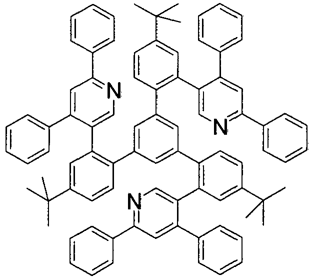 | 55 % |
| | S36 | | |
| | | C | |
| L28 | S47 | 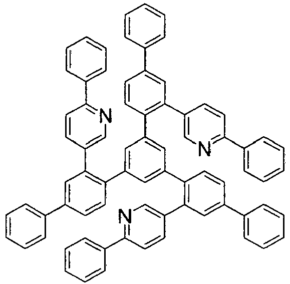 | 62 % |
| | S22 | | |
| | | B | |
| L29 | S47 | 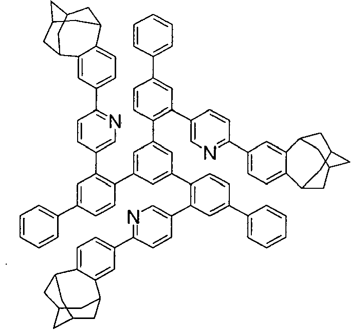 | 49 % |
| | S33 | | |
| | | A | |
| L30 | S48 | 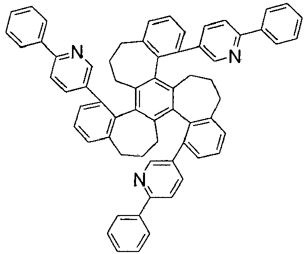 | 38 % |
| | S22 | | |
| | | A | |
| L31 | S49 | 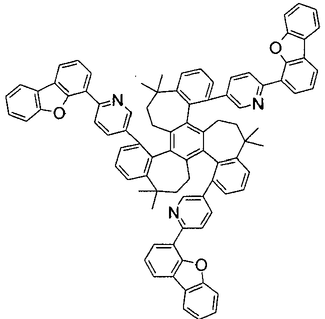 | 40 % |
| | S28 | | |
| | | C | |
| L32 | S51 | 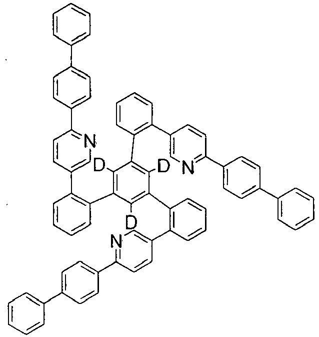 | 69 % |
| | S24 | | |
| | | A | |
| L33 | S52 | 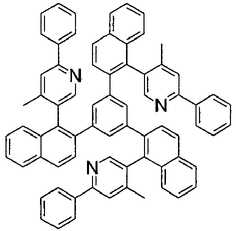 | 53 % |
| | S34 | | |
| | | C | |
| L34 | S53 | 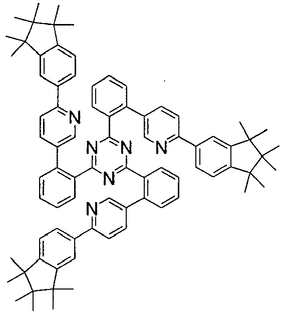 | 64 % |
| | S21 | | |
| | | A | |
| L35 syn + Anti | S7 | 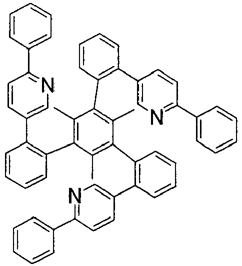 | 46 % |
| | S22 | | |
| | | A | |
| L36 syn + anti | S7 | 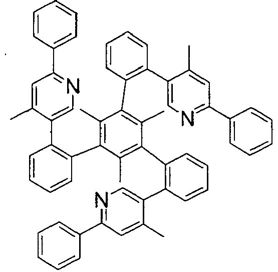 | 39 % |
| | S34 | | |
| | | C | |
| L37 | S50 | 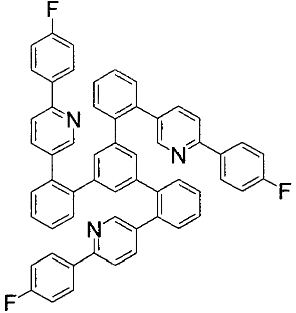 | 71 % |
| | S54 | | |
| | | B | |
| L38 | S50 | 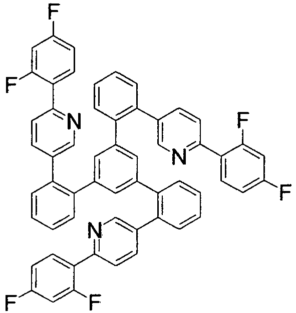 | 62 % |
| | S55 | | |
| | | B | |
| L63 | S50 | 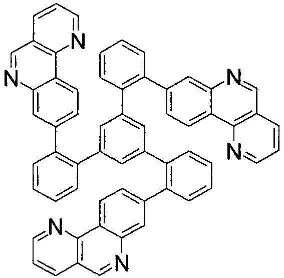 | 57 % |
| | S57 | | |
| | | B | |
| L64 | S50 | 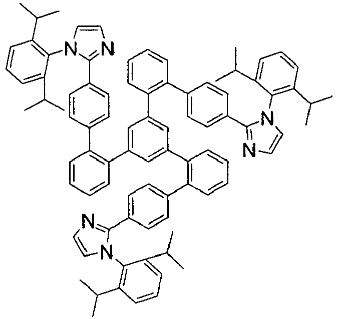 | 49 % |
| | S58 | | |
| | | B | |
| L72 | S50 | 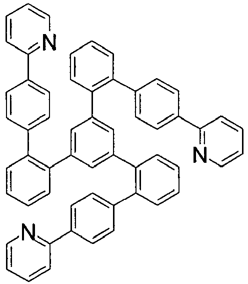 | 58 % |
| | 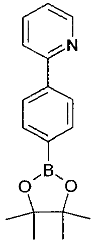 | | |
| | [908350-80-1] | B | |
| L74 | S50 | 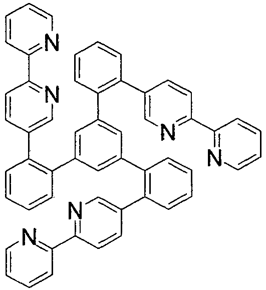 | 28 % |
| | 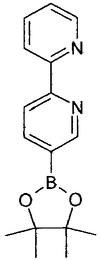 | | |
| | [562098-24-2] | C | |
| L76 | S50 | 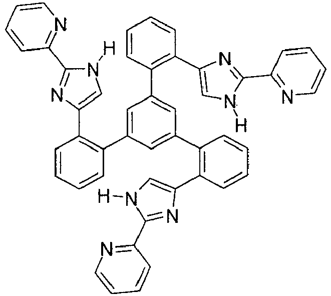 | 34 % |
| | S62 | | |
| | | B | |
| L91 | S50 | 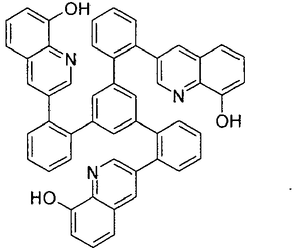 | 38 % |
| | S97 | | |
| | | B | |
| L92 | S50 | 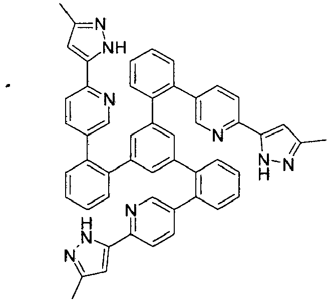 | 41 % |
| | S98 | | |
| | | A | |
| L93 | S50 | 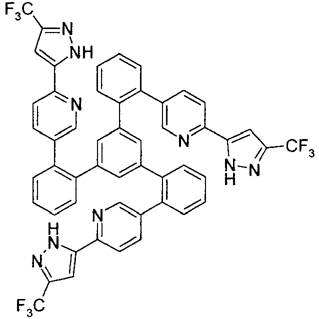 | 37 % |
| | S99 | | |
| | | A | |
| L94 | S50 | 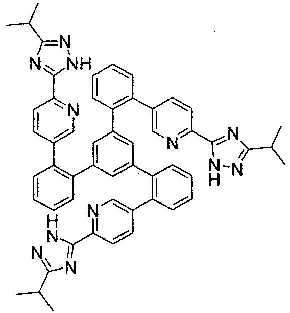 | 34 % |
| | S100 | | |
| | | A | |
| L95 | S101 | 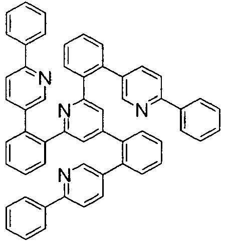 | 50 % |
| | S22 | | |
| | | B | |
| L96 | S50 | 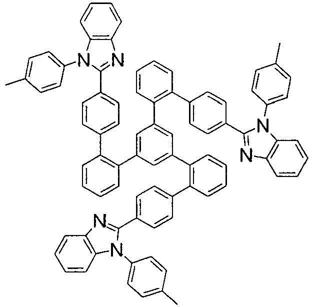 | 56 % |
| | 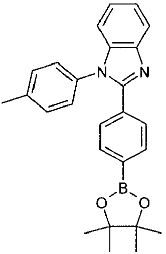 | | |
| | [1397275-52-3] | B | |
| L97 | S50 | 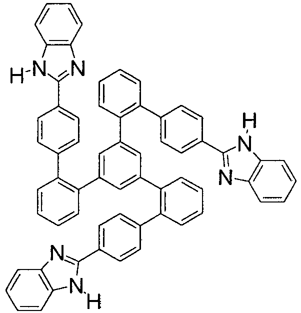 | 48 % |
| | 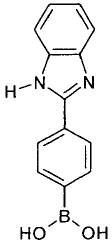 | | |
| | [1191061-89-8] | A | |
| L98 | | 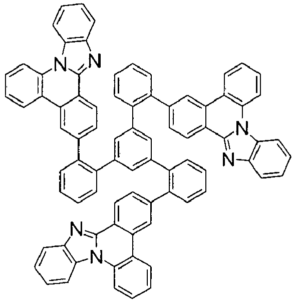 | 66 % |
| | 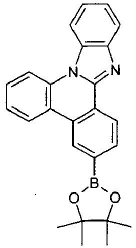 | | |
| | [1228267-13-7] | B | |
| L99 | S50 | 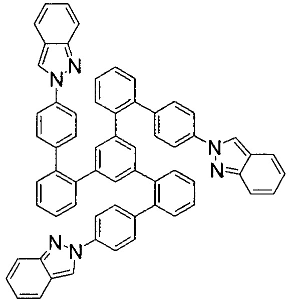 | 34 % |
| | 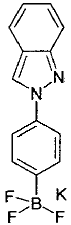 | | |
| | [1432475-28-9] | B | |
| L100 | S50 | 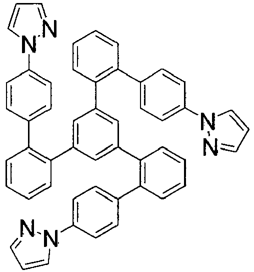 | 37 % |
| | 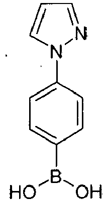 | | |
| | [891270-35-2] | B | |
| L101 | S50 | 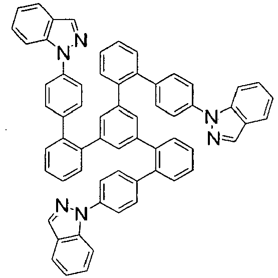 | 46 % |
| | 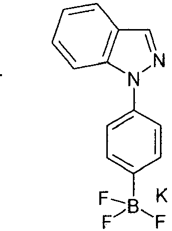 | | |
| | [1432475-27-8] | B | |
| L102 | S50 | 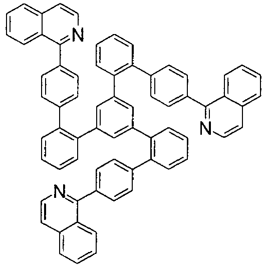 | 54 % |
| | 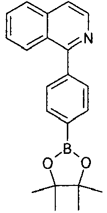 | | |
| | [1116082-29-1] | A | |
| L103 | S50 | 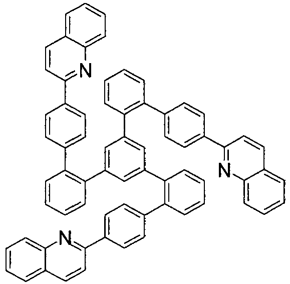 | 58 % |
| | 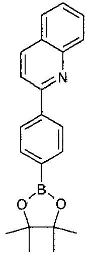 | | |
| | [1383803-71-1] | A | |
| L104 | S50 | 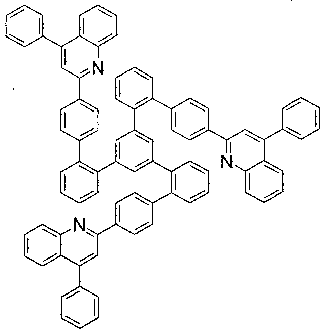 | 50 % |
| | 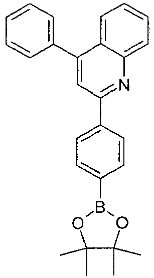 | | |
| | [1204238-11-8] | A | |
| L105 | S102 | 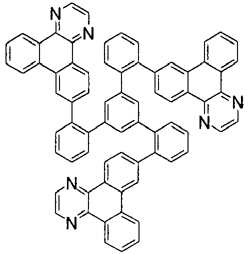 | 63 % |
| | 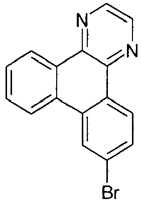 | | |
| | [1182724-82-8] | B | |
| L106 | S102 | 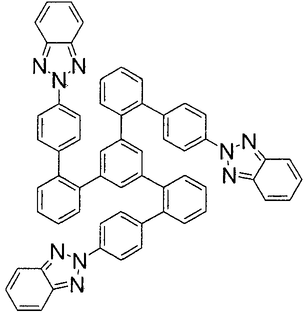 | 55 % |
| | 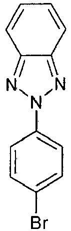 | | |
| | [3682-79-9] | B | |
| L107 | S102 | 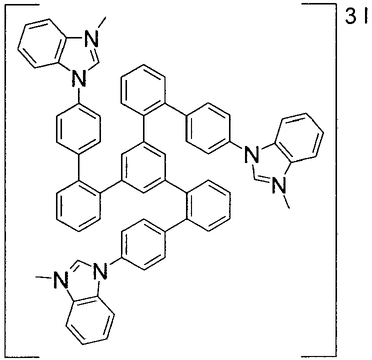 | 30 % |
| | 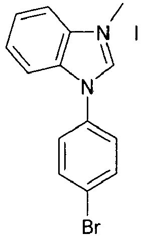 | | |
| | [1402749-00-1] | A | |
| | | Verwendung von NaHCO₃ satt Na₂CO₃ | |
| L108 | S102 | 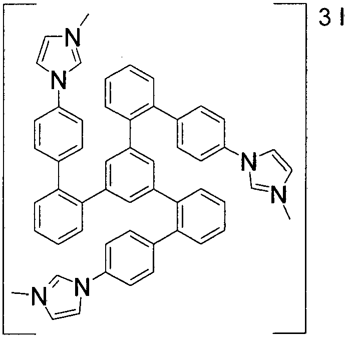 | 28 % |
| | 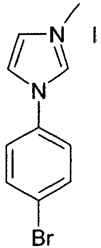 | | |
| | [1265899-48-6] | A | 48 % |
| | | Verwendung von NaHCO₃ satt Na₂CO₃ | |
| | | D | |
| L109 | S102 | 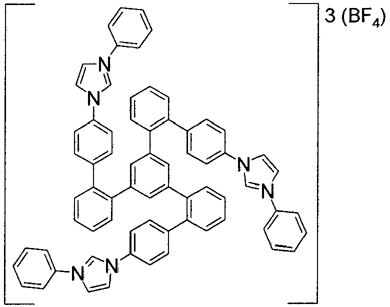 | 34 % |
| | 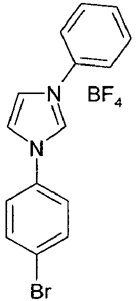 | | |
| | [1434057-17-6] | A | |
| | | Verwendung von NaHCO₃ satt Na₂CO₃ | |
| L111 | S50 | 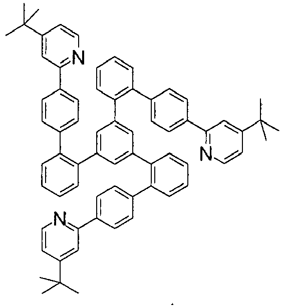 | 56 % |
| | 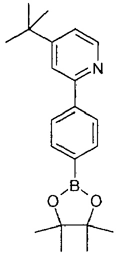 | | |
| | S103 | B | |
| L112 | S50 | 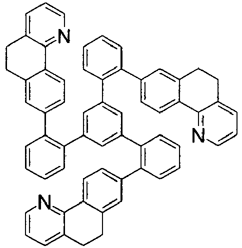 | 64 % |
| | 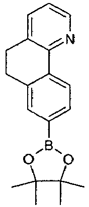 | | |
| | S105 | B | |
| L113 | S50 | 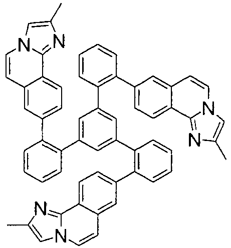 | 51 % |
| | 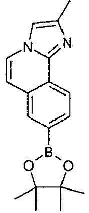 | | |
| | S106 | B | |
| L114 | S50 | 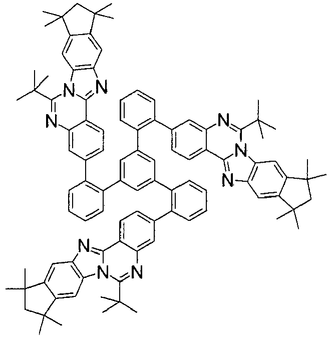 | 68 % |
| | 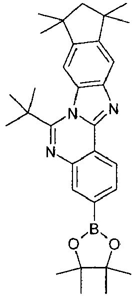 | | |
| | S107 | C | |
| L116 | S50 | 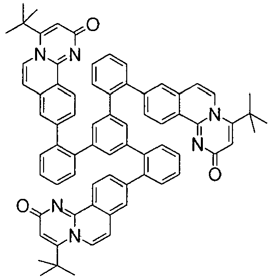 | 57 % |
| | 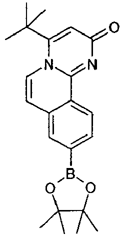 | | |
| | S620 | C | |
| L117 | S50 | 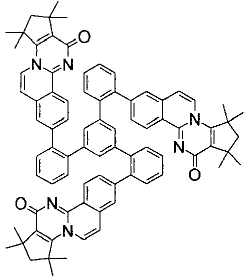 | 64 % |
| | 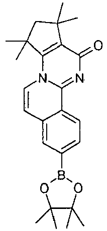 | | |
| | S621 | C | |
| L118 | S50 | 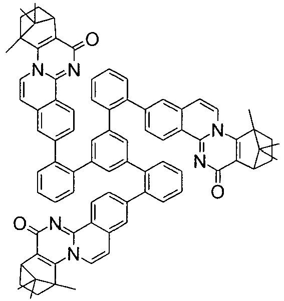 | 62 % |
| | 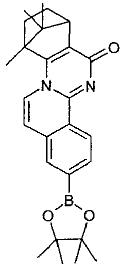 | | |
| | S622 | C | |
| L119 | S50 | 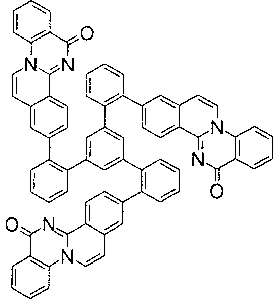 | 68 % |
| | 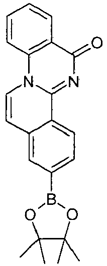 | | |
| | S623 | B | |
| L120 | S50 | 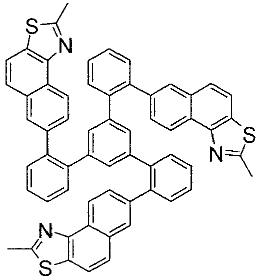 | 70 % |
| | 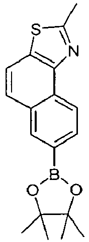 | | |
| | S624 | B | |
| L121 | S50 | 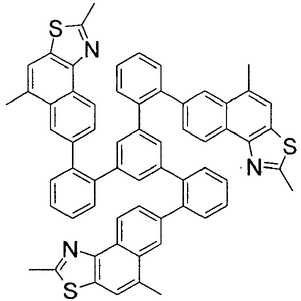 | 72 % |
| | 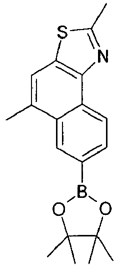 | | |
| | S625 | B | |
| L122 | S50 | 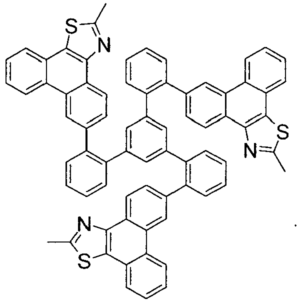 | 84 % |
| | 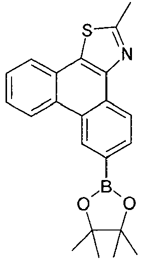 | | |
| | S626 | B | |
| L123 | S50 | 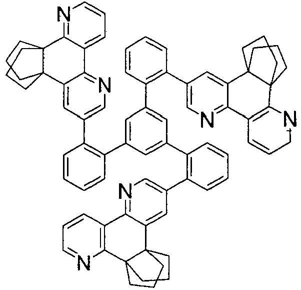 | 67 % |
| | 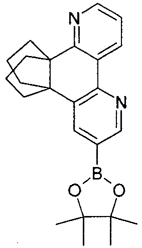 | | |
| | S627 | C | |
| L124 | S50 | 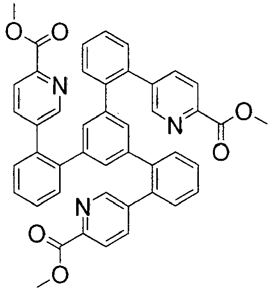 | 51 % |
| | 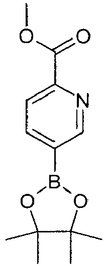 | | |
| | 1072945-86-8 | Kat.: 2 mmol Pd(Ac)₂ / 6 mmol PPh₃, Base: NaHCO₃ | |
| L125 | S50 | 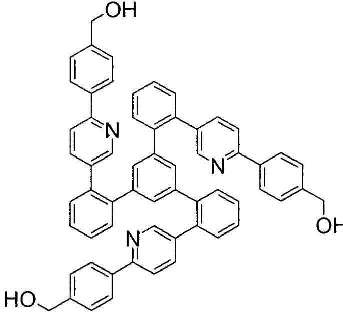 | 68 % |
| | 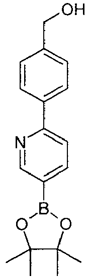 | | |
| | S127 | B | |
| L126 | S50 | 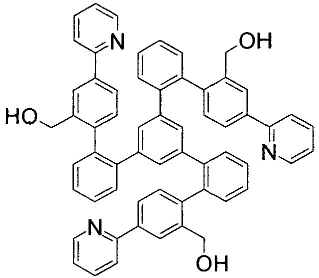 | 62 % |
| | 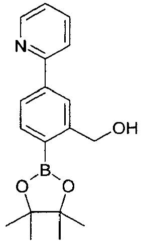 | | |
| | S128 | B | |
| L127 | S50 | 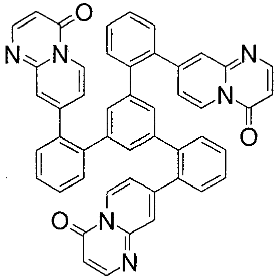 | 71 % |
| | 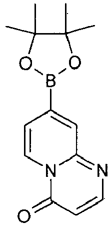 | | |
| | S129 | B | |
| L128 | S50 | 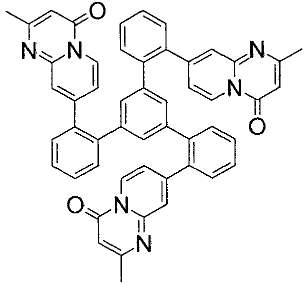 | 70 % |
| | 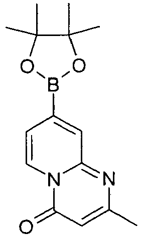 | | |
| | S130 | B | |
| L129 | S50 | 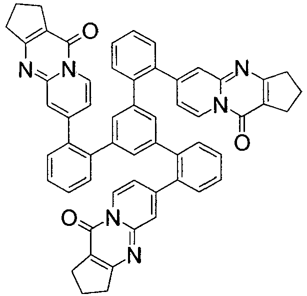 | 66 % |
| | 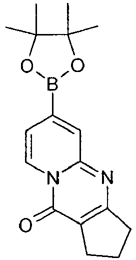 | | |
| | S131 | B | |
| L130 | S50 | 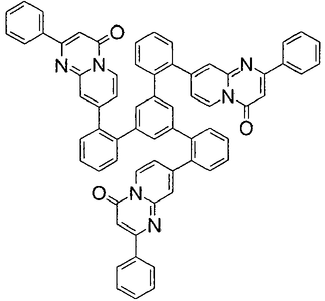 | 75 % |
| | 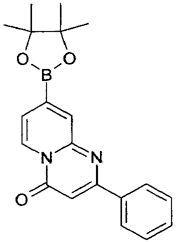 | | |
| | S132 | B | |
| L131 | S50 | 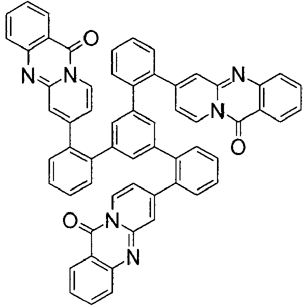 | 81 % |
| | 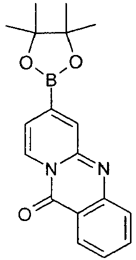 | | |
| | S133 | B | |
| L132 | S50 | 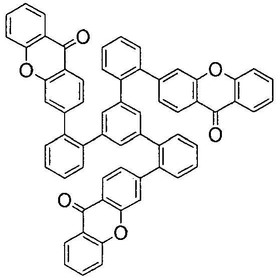 | 80 % |
| | 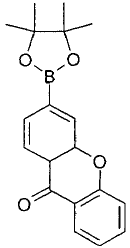 | | |
| | S136 | B | |
| L133 | S50 | 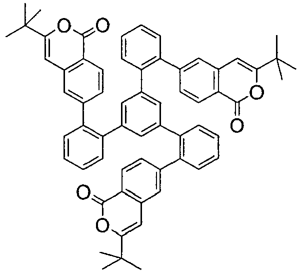 | 58 % |
| | 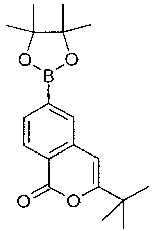 | | |
| | S137 | B | |
| L134 | S50 | 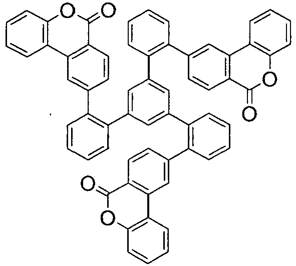 | 79 % |
| | 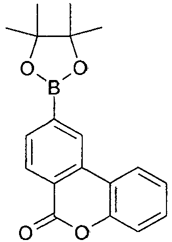 | | |
| | S138 | B | |
| L135 | S50 | 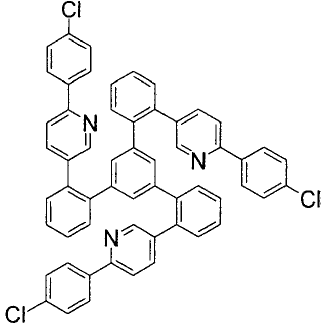 | 68 % |
| | 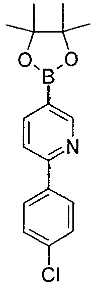 | | |
| | S1001 | B | |
| L136 | S50 | 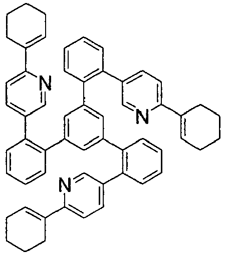 | 58 % |
| | 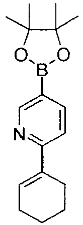 | | |
| | S144 | B | |
| L137 | S50 | 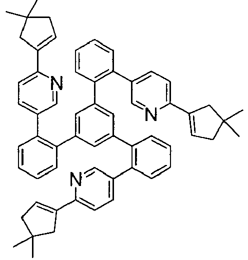 | 61 % |
| | 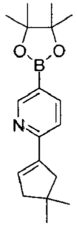 | | |
| | S145 | A | |
| L138 | S50 | 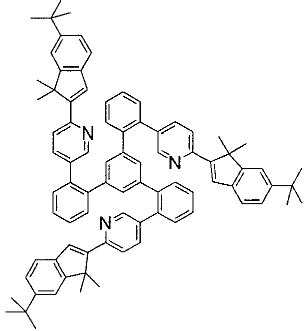 | 70 % |
| | 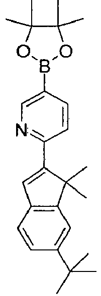 | | |
| | S146 | B | |
| L139 | S50 | 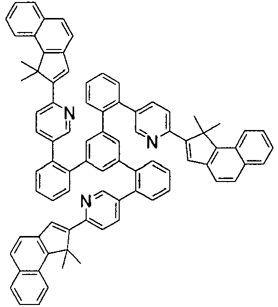 | 69 % |
| | 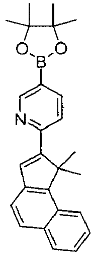 | | |
| | S147 | B | |
| L140 | S50 | 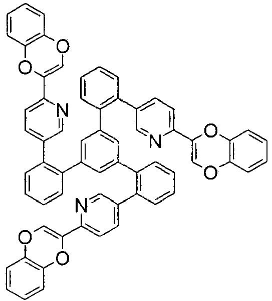 | 66 % |
| | 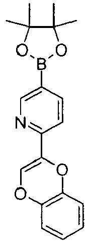 | | |
| | S148 | B | |
| L141 | S50 | 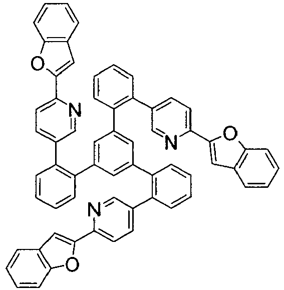 | 80 % |
| | 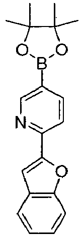 | | |
| | S149 | B | |
| L142 | S50 | 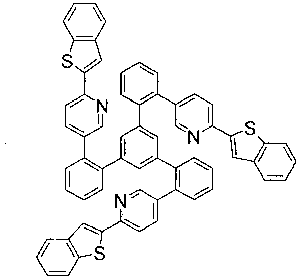 | 77 % |
| | 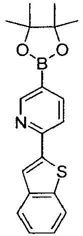 | | |
| | S150 | B | |
| L143 | S50 | 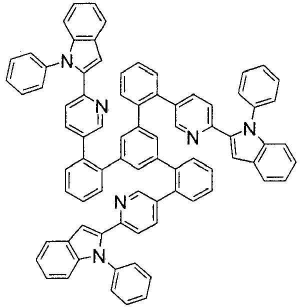 | 54 % |
| | 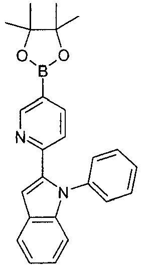 | | |
| | S151 | B | |
| L144 | 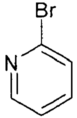 | 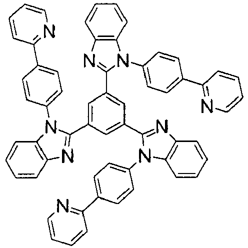 | 61 % |
| | 109-04-6 | | |
| | S160 | B | |
| L145 | 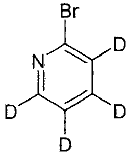 | 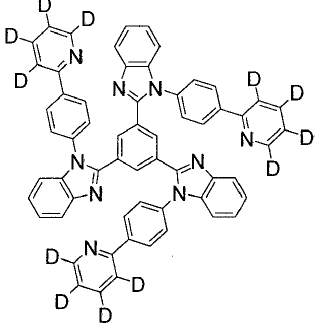 | 64 % |
| | 70766-71-1 | | |
| | S160 | B | |
| L146 | 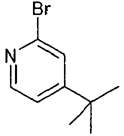 | 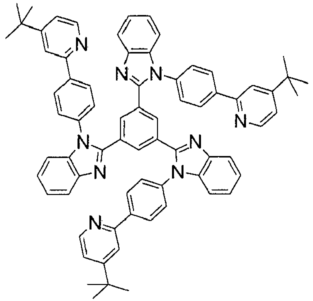 | 67 % |
| | 50488-34-1 | | |
| | S160 | B | |
| L147 | 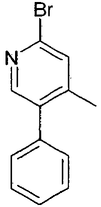 | 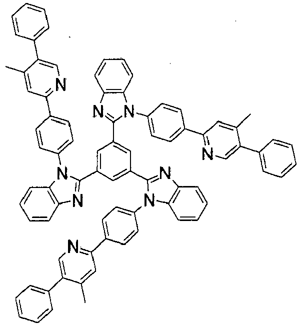 | 70 % |
| | 1438809-78-9 | | |
| | S160 | B | |
| L148 | 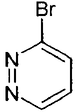 | 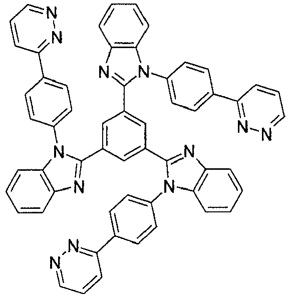 | |
| | 88491-61-6 | | |
| | S160 | B | |
| L149 | S50 | | 28 % |
| | 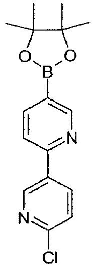 | 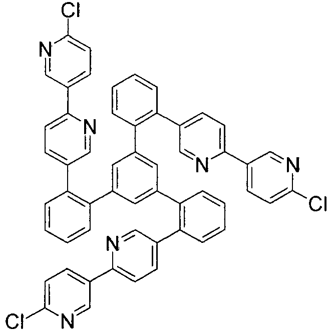 | |
| | 1216756-37-4 | B | |

### Beispiel L39:

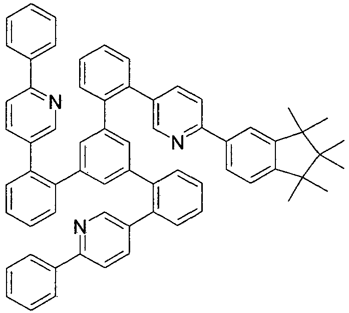

### a) L39-Zwischenstufe1

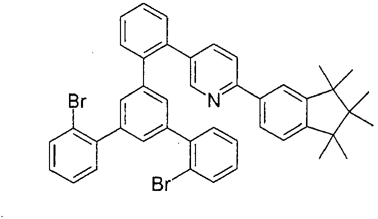

Ein Gemisch aus 54.1 g (100 mmol) 1,3,5-Tris(2-bromphenyl)benzol, S50, [380626-56-2], 40.5 g (100 mmol) 2-[1,1,2,2,3,3-Hexamethyl-indan-5-yl]-5-(4,4,5,5-tetramethyl-[1,3,2]dioxaborolan-2-yl)-pyridin, S21, nachfolgend auch Boronester 1 genannt, 31.8 g (300 mmol) Natriumcarbonat, 1.2 g (1 mmol) Tetrakis(triphenyphosphino)-palladium(0), 300 ml Toluol, 100 ml Ethanol und 200 ml Wasser wird unter sehr gutem Rühren 24 h unter Rückfluss erhitzt. Nach Erkalten trennt man die wässrige Phase ab und engt die organische Phase zur Tockene ein. Man nimmt den braunen Schaum in 300 ml Ethylacetat auf und filtriert über ein mit Ethylacatat vorgeschlämmtes Kieselgelbett (Durchmesser 15 cm, Länge 20 cm), um braune Anteile zu entfernen. Anschließend wird der Schaum zweimal an Kieselgel (n-Heptan:Ethylacetat 5:1) chromatographiert. Ausbeute: 25.2 g (34 mmol), 34 %. Reinheit: ca. 95 % ig n. ¹H-NMR.

### b) L39

Ein Gemisch aus 22.3 g (30 mmol) L39-Zwischenstufe1, 22.5 g (80 mmol) 2-Phenyl-5-(4,4,5,5-tetramethyl-[1,3,2]dioxaborolan-2-yl)-pyridin, S22, nachfolgend auch Boronester 2 genannt, 63.6 g (600 mmol) Natriumcarbonat, 3.5 g (3 mmol) Tetrakis(triphenyphosphino)palladium(0), 600 ml Toluol, 200 ml Ethanol und 400 ml Wasser wird unter sehr gutem Rühren 24 h unter Rückfluss erhitzt. Nach 24 h fügt man 200 ml 5 Gew.-%ige wässrige Acetylcystein-Lösung zu, rührt weitere 16 h unter Rückfluss, lässt erkalten, trennt die wässrige Phase ab und engt die organische Phase zur Tockene ein. Man nimmt den braunen Schaum in 300 ml Ethylacetat auf und filtriert über ein mit Ethylacetat vorgeschlämmtes Kieselgelbett (Durchmesser 15 cm, Länge 20 cm), um braune Anteile zu entfernen. Nach Einengen auf 200 ml wird die Lösung unter sehr gutem Rühren in 1000 ml Methanol eingetropft, wobei ein beiger Feststoff ausfällt. Der Feststoff wird abgesaugt, zweimal mit je 200 ml Methanol gewaschen, im Vakuum getrocknet. Der Umfällprozess wird erneut wiederholt. Anschließend wird der Schaum zweimal an Kieselgel (n-Heptan:Ethylacetat 3:1) chromatographiert. Ausbeute: 16.0 g (18 mmol), 60 %. Reinheit: ca. 99.0 %ig nach ¹H-NMR.
Verbliebene Nebenkomponenten sind häufig das Disubstitutionsprodukt und/oder das debromierte Disubstitutionsprodukt. Die Reinheit ist ausreichend, um den Liganden in der o-Metallierungsreaktion einsetzen zu können. Die Liganden können bei Bedarf durch wiederholte Chromatographie an Kieselgel (n-Heptan oder Cyclohexan oder Toluol in Kombination mit Ethylacetat) weiter gereinigt werden. Alternativ können die Liganden aus Ethylacetat gegebenfalls unter Zusatz von MeOH oder EtOH umkristallisiert werden. Liganden mit einer Molmasse kleiner ca. 1000-1200 g/mol können im Hochvakuum (p ca. 10⁻⁵ mbar) Kugelrohr-sublimiert werden.

Analog können folgende Verbindungen dargestellt werden:

| Bsp. | Bromid Boronsäure / ester 1 und 2 | Produkt | Ausbeute |
|---|---|---|---|
| L40 | S50 | 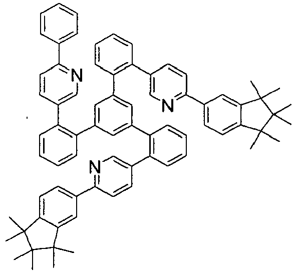 | 20 % |
| | 1 x S22 | | |
| | 2 x S21 | | |
| L41 | S50 | 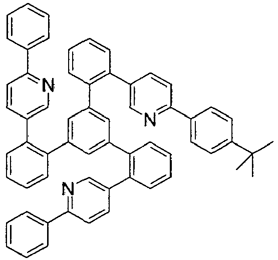 | 22 % |
| | 1 x S23 | | |
| | 2 x S22 | | |
| L42 | S50 | 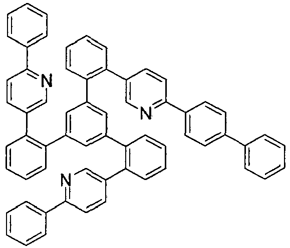 | 25 % |
| | 1 x S24 | | |
| | 2 x S22 | | |
| L43 | S50 | 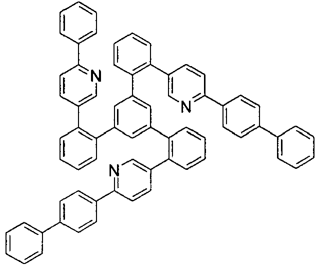 | 24 % |
| | 1 x S22 | | |
| | 2 x S24 | | |
| L44 | S50 | 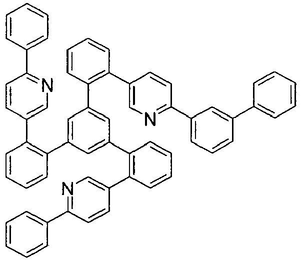 | 18 % |
| | 1 x S25 | | |
| | 2 x S22 | | |
| L45 | S50 | 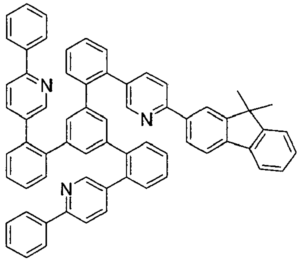 | 21 % |
| | 1 x S26 | | |
| | 2 x S22 | | |
| L46 | S50 | 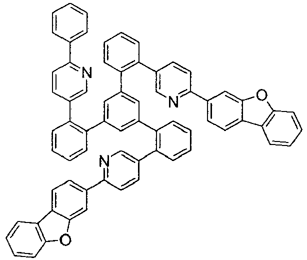 | 20 % |
| | 1 x S22 | | |
| | 2 x S27 | | |
| L47 | S50 | 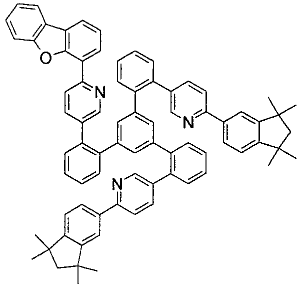 | 17 % |
| | 1 x S28 | | |
| | 2 x S30 | | |
| L48 | S50 | 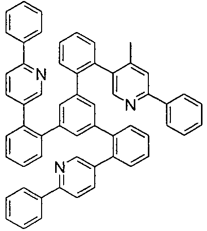 | 20 % |
| | 1 x S34 | | |
| | 2 x S22 | | |
| L49 | S50 | 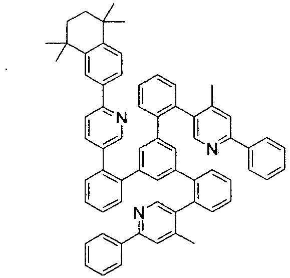 | 23 % |
| | 1 x S31 | | |
| | 2 x S34 | | |
| L50 | S50 | 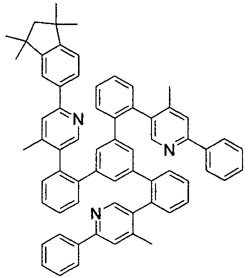 | 23 % |
| | 1 x S35 | | |
| | 2 x S34 | | |
| L51 | S50 | 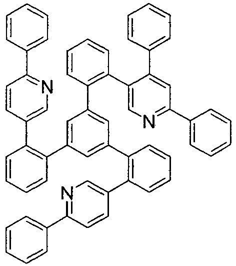 | 20 % |
| | 1 x S36 | | |
| | 2 x S22 | | |
| L52 | S50 | 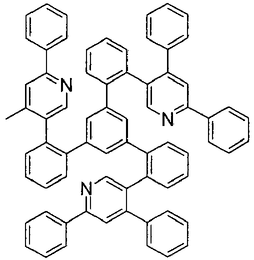 | 24 % |
| | 1 x S34 | | |
| | 2 x S36 | | |
| L53 | S46 | 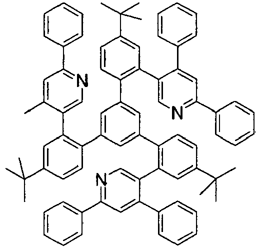 | 19 % |
| | 1 x S34 | | |
| | 2 x S36 | | |
| L54 | S47 | 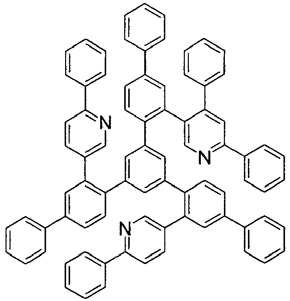 | 20 % |
| | 1 x S22 | | |
| | 2 x S36 | | |
| L55 | S50 | 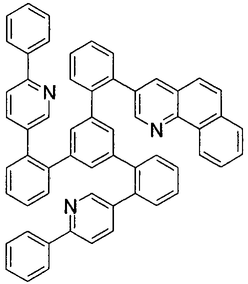 | 24 % |
| | 1 x S40 | | |
| | 2 x S22 | | |
| L56 | S50 | 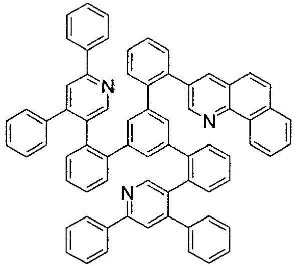 | 22 % |
| | 1 x S40 | | |
| | 2 x S36 | | |
| L57 | S50 | 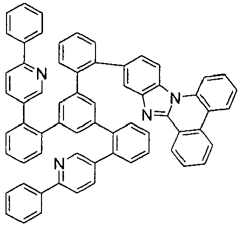 | 26 % |
| | 1 x S41 | | |
| | 2 x S22 | | |
| L58 | S50 | 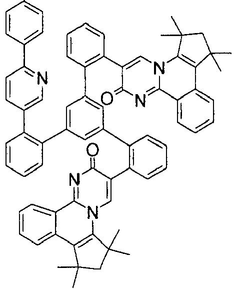 | 25 % |
| | 1 x S22 | | |
| | 2 x S43 | | |
| L71 | S50 | 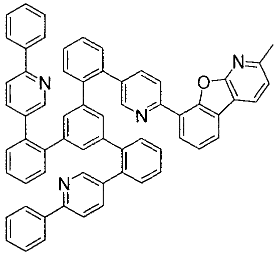 | 28 % |
| | 1 x S60 | | |
| | 2 x S22 | | |
| L73 | S50 | 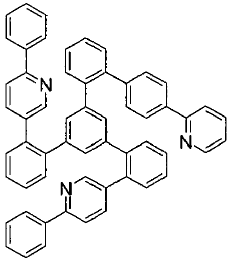 | 24 % |
| | 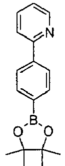 | | |
| | 1 x [908350-80-1] | | |
| | 2 x S22 | | |
| L75 | S50 | 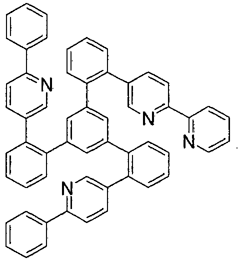 | 19 % |
| | 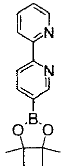 | | |
| | 1 x [562098-24-2] | | |
| | 2 x S22 | | |
| L77 | S50 | 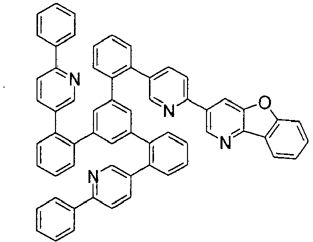 | 17 % |
| | 1 x S83 | | |
| | 2 x S22 | | |
| L78 | S50 | 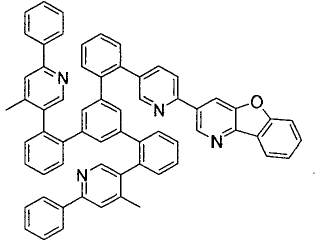 | 25 % |
| | 1 x S83 | | |
| | 2 x S34 | | |
| L79 | S50 | 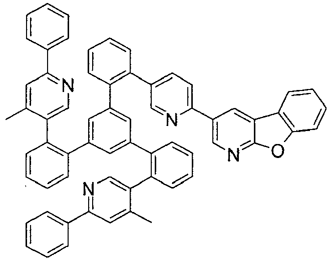 | 27 % |
| | 1 x S84 | | |
| | 2 x S34 | | |
| L80 | S50 | 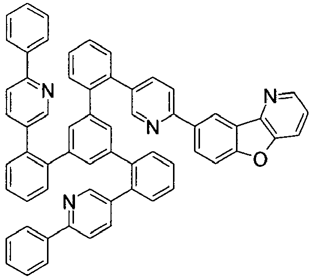 | 25 % |
| | 1 x S85 | | |
| | 2 x S22 | | |
| L81 | S50 | 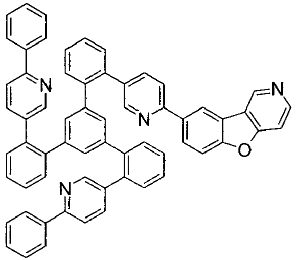 | 23 % |
| | 1 x S86 | | |
| | 2 x S22 | | |
| L82 | S50 | 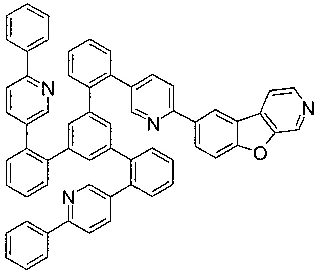 | 26 % |
| | 1 x S87 | | |
| | 2 x S22 | | |
| L83 | S50 | 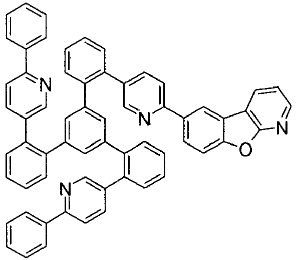 | 30 % |
| | 1 x S88 | | |
| | 2 x S22 | | |
| L84 | S50 | 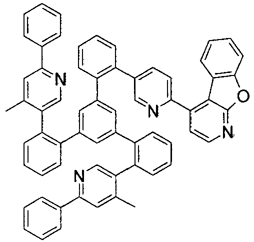 | 22 % |
| | 1 x S89 | | |
| | 2 x S36 | | |
| L85 | S50 | 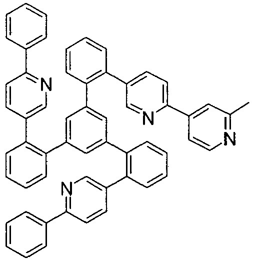 | 21 % |
| | 1 x S90 | | |
| | 2 x S22 | | |
| L86 | S50 | 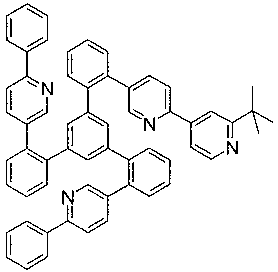 | 25 % |
| | 1 x S91 | | |
| | 2 x S22 | | |
| L87 | S50 | 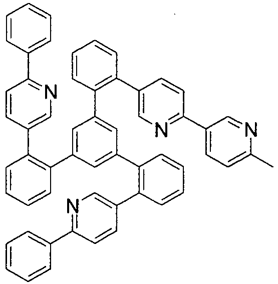 | 25 % |
| | 1 x S92 | | |
| | 2 x S22 | | |
| L88 | S50 | 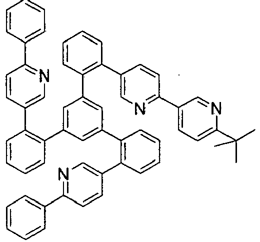 | 27 % |
| | 1 x S93 | | |
| | 2 x S22 | | |
| L89 | S50 | 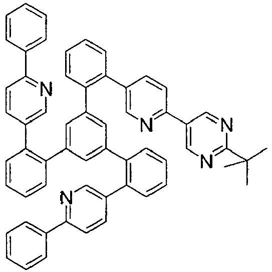 | 24 % |
| | 1 x S95 | | |
| | 2 x S22 | | |
| L90 | S50 | 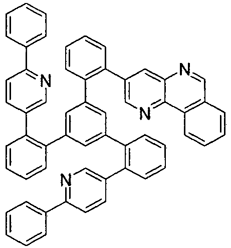 | 26 % |
| | 1 x S96 | | |
| | 2 x S22 | | |

### Beispiel L200:

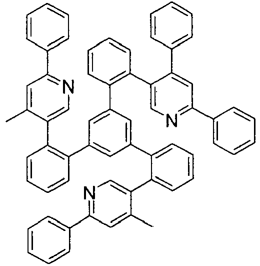

Ein Gemisch aus 69.1 g (100 mmol) S501, 42.5 g (110 mmol) S204, 63.7 g (300 mmol) Tri-kaliumphosphat, 1.64 g (4 mmol) SPhos [657408-07-6], 449 mg (2 mmol) Palladium(II)acetat, 700 ml Toluol, 300 ml Dioxan und 500 ml Wasser wird 8 h unter Rückfluss erhitzt. Nach Abkühlen wird die org. Phase abgetrennt, zweimal mit 300 ml Wasser und einmal mit 200 ml ges. Kochsalzlösung gewaschen, über Magnesiumsulfat getrocknet und dann über ein vorgeschlämmtes Celite-Bett filtriert, welches mit Toluol nachgewaschen wird. Das Filtrat wird zur Trockene eingeengt und der Rückstand wird anschließend zweimal aus Ethylacetat/Methanol umkristallisiert. Ausbeute: 45.5 g (54 mmol), 54 %. Reinheit: ca. 97 %-ig n. ¹H-NMR.

Analog können die folgenden Verbindungen synthetisiert werden:

| Bsp. | Edukte | Produkt | Ausbeute |
|---|---|---|---|
| L71 | S500 | 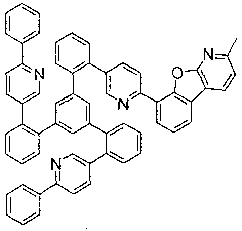 | 76 % |
| | S213 | | |
| L201 | S501 | 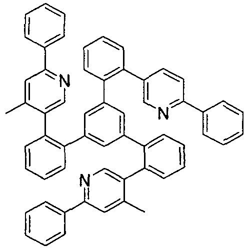 | 74 % |
| | S200 | | |
| L202 | S501 | 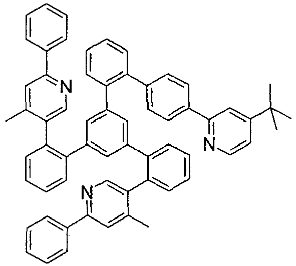 | 70 % |
| | S205 | | |
| L203 | S502 | 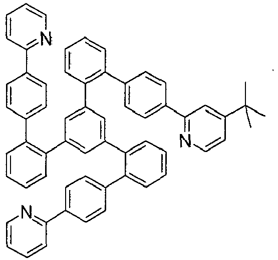 | 71 % |
| | S205 | | |
| L204 | S502 | 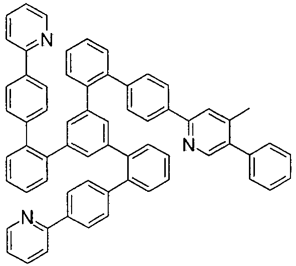 | 76 % |
| | S206 | | |
| L205 | S502 | 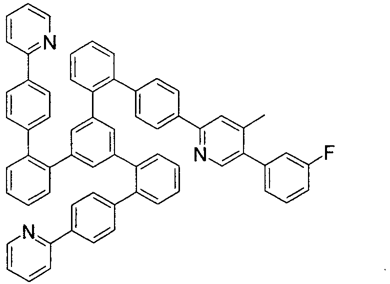 | 77 % |
| | S209 | | |
| L206 | S503 | 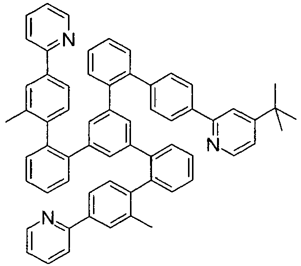 | 81 % |
| | S205 | | |
| L207 | S503 | 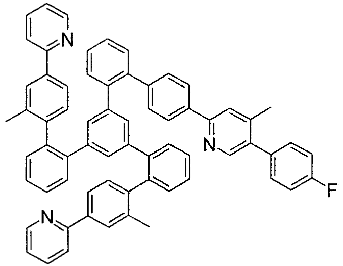 | 77 % |
| | S208 | | |
| L208 | S503 | 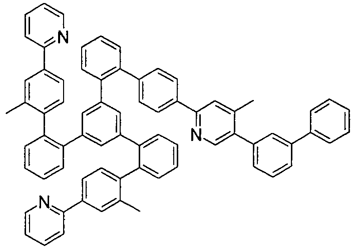 | 68 % |
| | S211 | | |
| L209 | S504 | 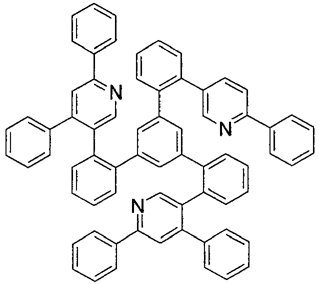 | 75 % |
| | S200 | | |
| L210 | S504 | 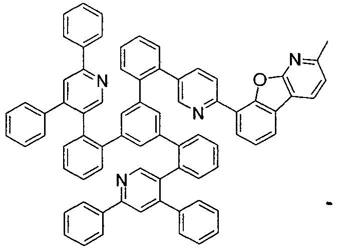 | 80 % |
| | S213 | | |
| L211 | S504 | 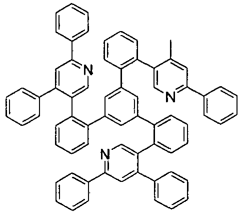 | 69 % |
| | S201 | | |
| L212 | S505 | 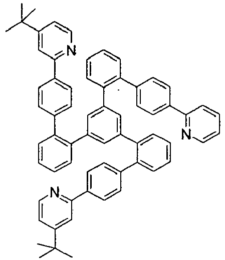 | 75 % |
| | S202 | | |
| L213 | S505 | 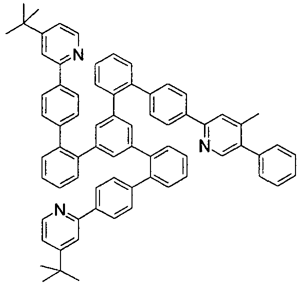 | 76 % |
| | S206 | | |
| L214 | S505 | 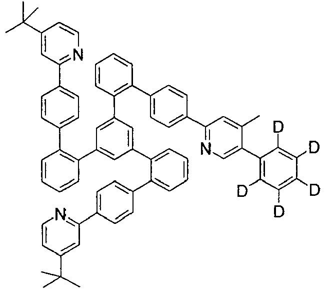 | 71 % |
| | S207 | | |
| L215 | S505 | 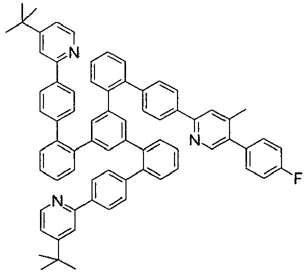 | 70 % |
| | S208 | | |
| L216 | S505 | 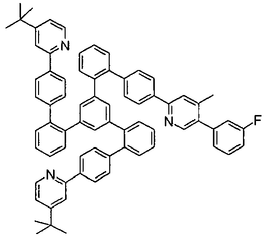 | 73 % |
| | S209 | | |
| L217 | S505 | 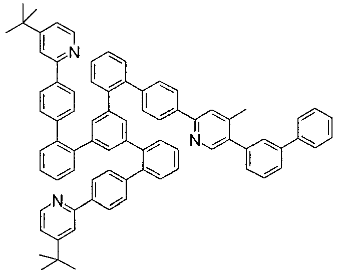 | 69 % |
| | S211 | | |
| L218 | S505 | 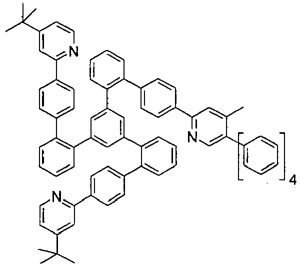 | 80 % |
| | S212 | | |
| L219 | S505 | 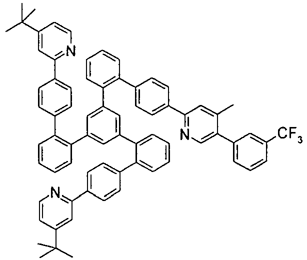 | 68 % |
| | S210 | | |
| L220 | S502 | 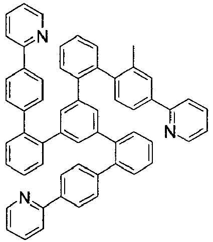 | 70 % |
| | S203 | | |
| L221 | S502 | 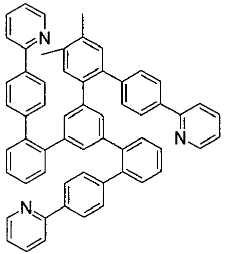 | 67 % |
| | S214 | | |
| L222 | S502 | 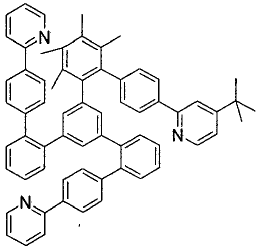 | 70 % |
| | S215 | | |
| L223 | S502 | 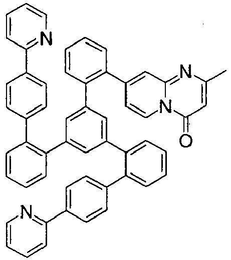 | 63 % |
| | S216 | | |
| L224 | S505 | 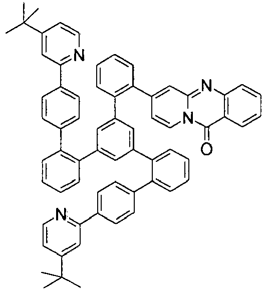 | 70 % |
| | S217 | | |
| L225 | S505 | 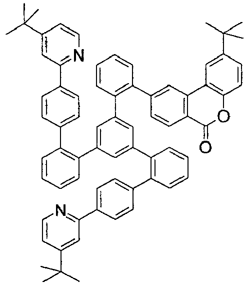 | 68 % |
| | S220 | | |
| L226 | S504 | 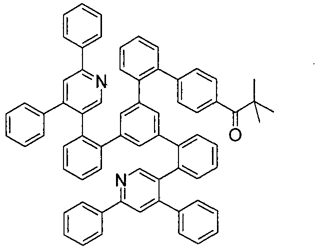 | 75 % |
| | S218 | | |
| L227 | S502 | 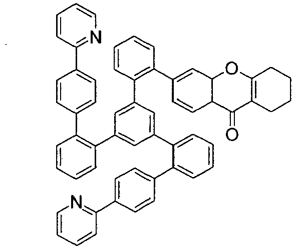 | 48 % |
| | S219 | | |
| L228 | S502 | 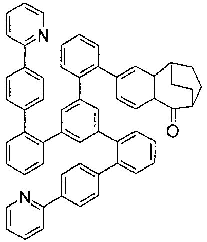 | 66 % |
| | S221 | | |
| L229 | S505 | 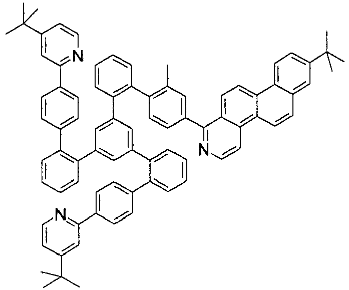 | 57 % |
| | S225 | | |
| L230 | S505 | 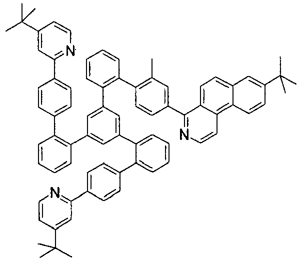 | 69 % |
| | S226 | | |
| L231 | S502 | 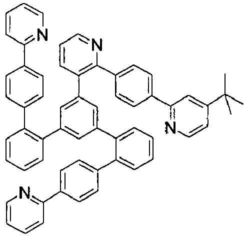 | 64 % |
| | S222 | | |
| L232 | S502 | 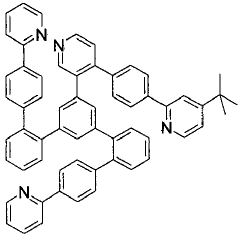 | 67 % |
| | S223 | | |
| L233 | S505 | 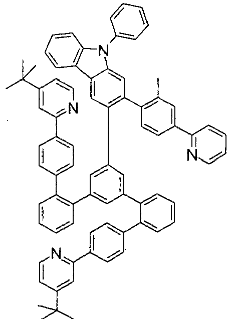 | 61 % |
| | S224 | | |

### Beispiel L250:

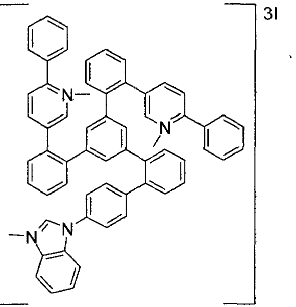

Eine Lösung von 40.3 g (50 mmol) S610 in 300 ml DCM wird tropfenweise mit 18.8 ml (300 mmol) Methyliodid [74-88-4] versetzt und 24 h im Rührautoklaven auf 60 °C erhitzt. Nach Erkalten zieht man das Lösungsmittel und überschüssiges Methyliodid im Vakuum ab. Die so erhaltene Ligandenvorstufe wird ohne weitere Reinigung umgesetzt. Ausbeute: 61.5 g (50 mmol), quantitativ. Reinheit: ca. 95 %-ig n. ¹H-NMR.

Analog können die folgenden Verbindungen synthetisiert werden:

| Bsp. | Edukte | Produkt | Ausbeute |
|---|---|---|---|
| L251 | S611 | 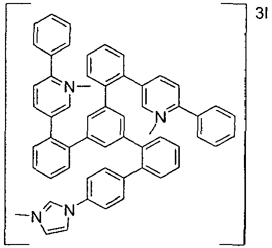 | quant. |
| L252 | S612 | 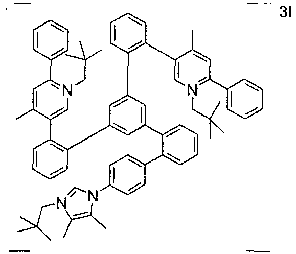 | quant. |
| | 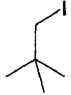 | | |
| | 15501-33-4 | Dioxan, 140 °C | |
| L253 | S613 | 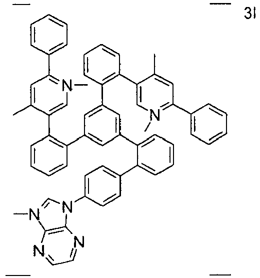 | quant. |
| L254 | S614 | 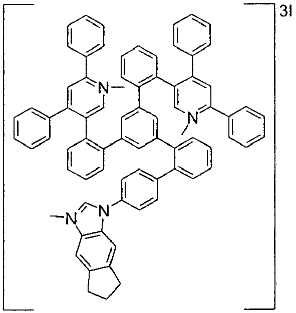 | quant. |
| L255 | S615 | 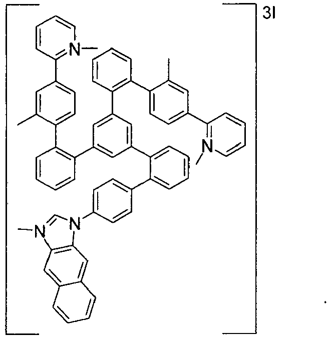 | quant. |
| L256 | S616 | 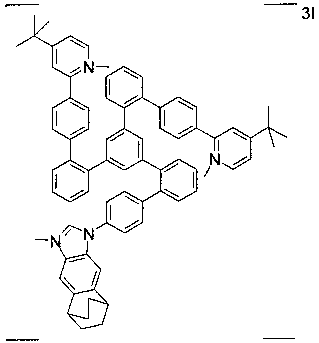 | quant. |
| L257 | S617 | 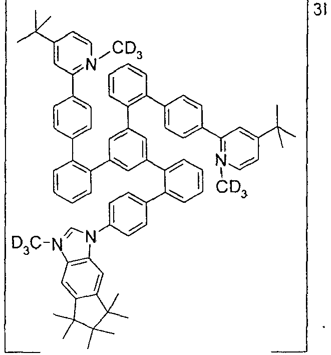 | quant. |
| | D₃C-I | | |
| | 865-50-9 | | |

### Beispiel L260:

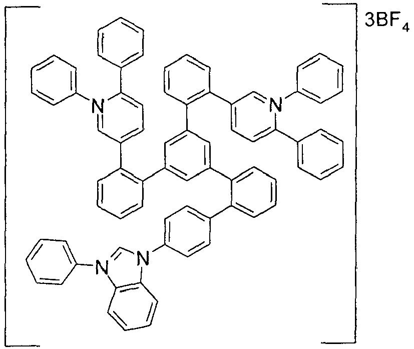

Ein Gemisch von 16.1 g (20 mmol) S610, 23.9 g (65 mmol) Diphenyliodonium-tetrafluoroborat [313-39-3], 363 mg (2 mmol) Kupfer(II)aceat [142-71-2] in 200 ml DMF wird 8 h auf 100 °C erhitzt. Nach Erkalten entfernt man das Lösungsmittel unter Vakuum, nimmt den Rückstand in einem Gemisch aus 100 ml Dichlormethan, 100 ml Aceton und 20 ml Methanol auf, filtriert über ein Kieselgel-Bett, schneidet die Kernfraktion heraus und engt diese zur Trockene ein. Die so erhaltene Liganden-Vorstufe wird ohne weitere Reinigung umgesetzt. Ausbeute: 22.1 g (17 mmol) 85 %. Reinheit: ca. 90 %-ig n. ¹H-NMR.

Analog kann die folgenden Verbindungen synthetisiert werden:

| Bsp. | Edukte | Produkt | Ausbeute |
|---|---|---|---|
| L261 | S615 | 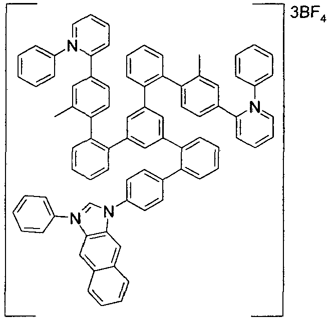 | 89 % |

### Beispiel L270:

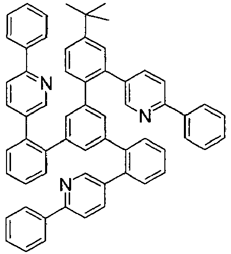

Durchführung wie Bsp. L2. Einsatz von 12.0 g (20 mmol) S660 und 19.7 g (70 mmol) S22, die restlichen Komponenten werden proportional angepasst. Ausbeute: 10.7 g (13 mmol) 65 %. Reinheit: 98 %-ig n. ¹H-NMR.

Analog kann die folgenden Verbindungen synthetisiert werden:

| Bsp. | Edukte | Produkt | Ausbeute |
|---|---|---|---|
| L271 | S661 | 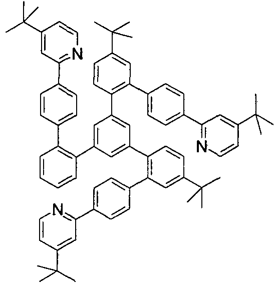 | 69 % |
| | S103 | | |
| L272 | S662 | 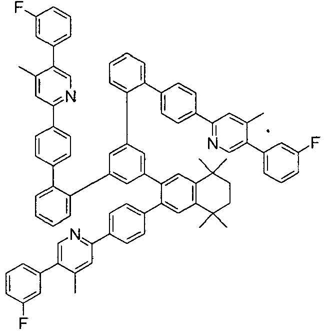 | 60 % |
| | S121 | | |
| L273 | S663 | 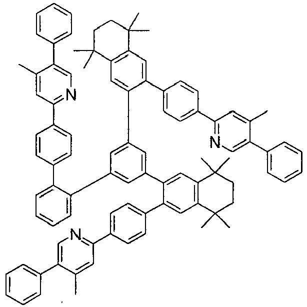 | 65 % |
| | S118 | | |
| L274 | S664 | 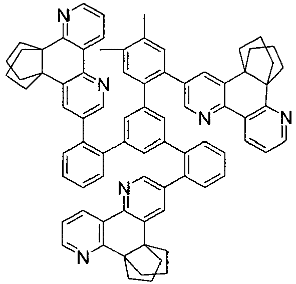 | 70 % |
| | S627 | | |
| L275 | S665 | 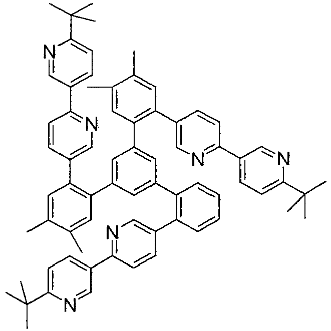 | 49 % |
| | S93 | | |
| L276 | S666 | 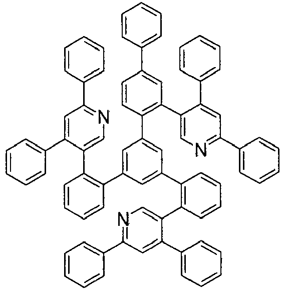 | 64 % |
| | S36 | | |
| L277 | S667 | 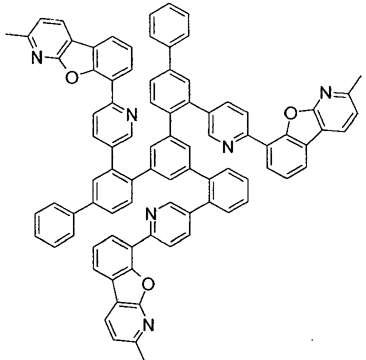 | 71 % |
| | S60 | | |

### Beispiel L59:

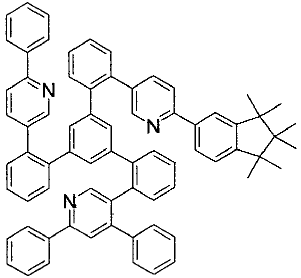

### a) L59-Zwischenstufe1 = L39-Zwischenstufe1

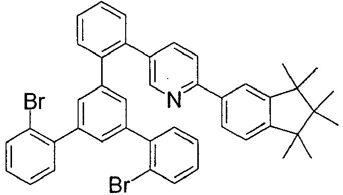

### b) L59-Zwischenstufe2

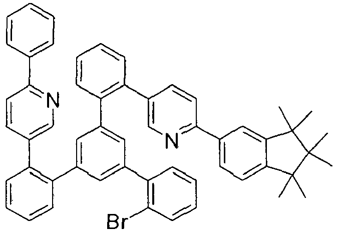

Ein Gemisch aus 74.2 g (100 mmol) L59-Zwischenstufe1, 28.1 g (100 mmol) 2-Phenyl-5-(4,4,5,5-tetramethyl-[1,3,2]dioxaborolan-2-yl)-pyridin, S22, nachfolgend auch Boronester 2 genannt, 31.8 g (300 mmol) Natriumcarbonat, 1.2 g (1 mmol) Tetrakis(triphenylphosphino)-palladium(0), 300 ml Toluol, 100 ml Ethanol und 200 ml Wasser wird unter sehr gutem Rühren 24 h unter Rückfluss erhitzt. Nach Erkalten trennt man die wässrige Phase ab und engt die organische Phase zur Tockene ein. Man nimmt den braunen Schaum in 300 ml Ethylacetat auf und filtriert über ein mit Ethylacatat vorgeschlämmtes Kieselgelbett (Durchmesser 15 cm, Länge 20 cm), um braune Anteile zu entfernen. Anschließend wird der Schaum zweimal an Kieselgel (n-Heptan:Ethylacetat 5:1) chromatographiert. Ausbeute: 29.4 g (36 mmol), 36 %. Reinheit: ca. 95 %ig nach ¹H-NMR.

### c) L59

Ein Gemisch aus 24.5 g (30 mmol) L59-Zwischenstufe2, 22.5 g (40 mmol) 2,4-Diphenyl-5-(4,4,5,5-tetramethyl-[1,3,2]dioxaborolan-2-yl)-pyridin, S36, nachfolgend auch Boronester 3 genannt, 10.6 g (100 mmol) Natriumcarbonat, 633 mg (0.6 mmol) Tetrakis(triphenylphosphino)-palladium(0), 100 ml Toluol, 70 ml Ethanol und 150 ml Wasser wird unter sehr gutem Rühren 24 h unter Rückfluss erhitzt. Nach 24 h fügt man 100 ml 5 Gew.-%ige wässrige Acetylcystein-Lösung zu, rührt weitere 16 h unter Rückfluss, lässt erkalten, trennt die wässrige Phase ab und engt die organische Phase zur Tockene ein. Man nimmt den braunen Schaum in 300 ml Ethylacetat auf und filtriert über ein mit Ethylacatat vorgeschlämmtes Kieselgelbett (Durchmesser 15 cm, Länge 20 cm), um braune Anteile zu entfernen. Nach Einengen auf 100 ml wird die Lösung unter sehr gutem Rühren in 500 ml Methanol eingetropft, wobei ein beiger Feststoff ausfällt. Der Feststoff wird abgesaugt, zweimal mit je 100 ml Methanol gewaschen, im Vakuum getrocknet. Der Umfällprozess wird erneut wiederholt. Anschließend wird der Schaum zweimal an Kieselgel (n-Heptan:Ethylacetat 3:1) chromatographiert. Ausbeute: 15.4 g (16 mmol), 53 %. Reinheit: ca. 99.0 %ig nach ¹H-NMR.

Verbliebene Nebenkomponenten sind häufig das Disubstitutionsprodukt und/oder das debromierte Disubstitutionsprodukt. Die Reinheit ist ausreichend, um die Liganden in der o-Metallierungsreaktion einzusetzen. Die Liganden können bei Bedarf durch wiederholte Chromatographie an Kieselgel (n-Heptan oder Cyclohexan oder Toluol in Kombination mit Ethylacetat) weiter gereinigt werden. Alternativ können die Liganden aus Ethylacetat gegebenfalls unter Zusatz von MeOH oder EtOH umkristallisiert werden. Liganden mit einer Molmasse kleiner ca. 1000-1200 g/mol können im Hochvakuum (p ca. 10⁻⁵ mbar) Kugelrohr-sublimiert werden.

Analog können folgende Verbindungen dargestellt werden:

| Bsp. | Bromid Boronsäure / ester 1, 2 und 3 | Produkt | Ausbeute |
|---|---|---|---|
| L60 | S50 | 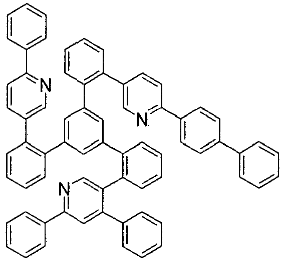 | 11 % |
| | S22 | | |
| | S24 | | |
| | S36 | | |
| L61 | S50 | 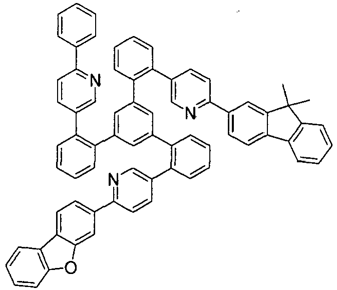 | 10 % |
| | S22 | | |
| | S26 | | |
| | S27 | | |
| L62 | S50 | 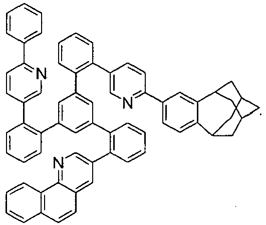 | 13 % |
| | S22 | | |
| | S33 | | |
| | S40 | | |

### Beispiel L65:

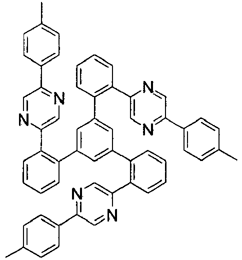

Durchführung analog Beispiel L1, wobei S21 durch 103.7 g (350 mmol) 2-(4-Methylphenyl)-5-(4,4,5,5-tetramethyl-1,3,2-dioxaborolan-2-yl)pyrazin [1402172-34-2] ersetzt wird. Reinigung: Man nimmt den braunen Schaum nach Einengen der organischen Phase aus der Suzuki-Kupplung in 300 ml eines Gemischs aus Dichlormethan:Ethylacetat (8:1, vv) auf und filtriert über ein mit Dichlormethan:Ethylacetat (8:1, vv) vorgeschlämmtes Kieselgelbett (Durchmesser 15 cm, Länge 20 cm), um braune Anteile zu entfernen. Nach Einengen wird der verbliebene Schaum dreimal aus 600 ml Ehylacetat umkristallisiert und anschließend im Hochvakkum (p ca. 10⁻⁵ mbar, T = 290 °C) Kugelrohr-sublimiert. Ausbeute: 38.9 g (48 mmol), 48 %. Reinheit: ca. 99.5 %ig nach ¹H-NMR.

Analog können folgende Verbindungen dargestellt werden:

| Bsp. | Bromid / Boronsäure bzw. ester | Produkt | Ausbeute |
|---|---|---|---|
| L66 | S50 | 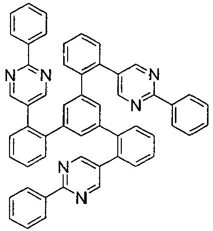 | 53 % |
| | 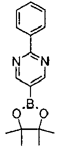 | | |
| | [1264510-78-2] | | |
| L67 | S50 | 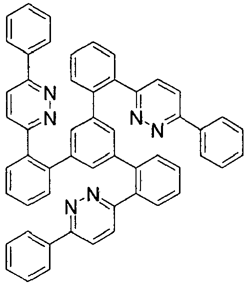 | 46 % |
| | 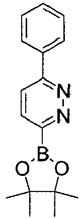 | | |
| | [1258867-70-7] | | |
| L110 | S50 | 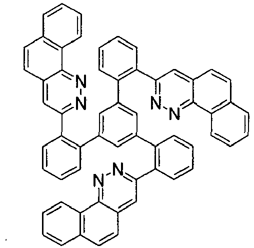 | 63 % |
| | S61 | | |

### Beispiel L68:

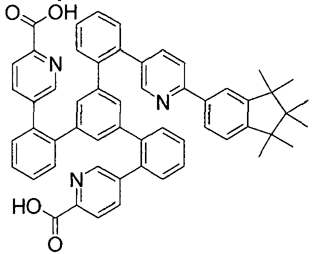

### a) L68 Zwischenstufe 1 = L39-Zwischenstufe1

Darstellung siehe L39.

### b) L68:

Ein Gemisch aus 22.3 g (30 mmol) L68-Zwischenstufe1, 22.5 g (80 mmol) 5-Borono-2-pyridincarbonsäure [913836-11-0], nachfolgend auch Boronester 2 genannt, 63.6 g (600 mmol) Natriumcarbonat, 3.5 g (3 mmol) Tetrakis(triphenyphosphino)palladium(0), 600 ml Toluol, 200 ml Ethanol und 400 ml Wasser wird unter sehr gutem Rühren 24 h unter Rückfluss erhitzt. Nach Erkalten stellt man vorsichtig durch Zugabe von 10 N Salzsäure neutral, trennt die wässige Phase ab, reextrahiert diese mit 200 ml Ethylacetat, filtriert die vereinigten organischen Phasen über Celite ab und engt dann zur Trockene ein. Man kristallisiert den Rückstand dreimal aus DMF unter Zustatz von Ethanol und dann zweimal aus Acetonitril um. Ausbeute: 10.7 g (13 mmol), 43 %. Reinheit: ca. 99.0 % ig n. ¹H-NMR. Verbliebene Nebenkomponenten sind häufig das Disubstitutionsprodukt und/oder das debromierte Disubstitutionsprodukt. Die Reinheit ist ausreichend, um die Liganden in der o-Metallierungsreaktion einzusetzen. Die Liganden können bei Bedarf durch wiederholte Chromatographie an Kieselgel (n-Heptan oder Cyclohexan oder Toluol in Kombination mit Ethylacetat) weiter gereinigt werden. Alternativ können die Liganden aus Ethylacetat gegebenfalls unter Zusatz von MeOH oder EtOH umkristallisiert werden. Liganden mit einer Molmasse kleiner ca. 1000-1200 g/mol können im Hochvakuum (p ca. 10⁻⁵ mbar) Kugelrohr-sublimiert werden.

Analog können folgende Verbindungen dargestellt werden:

| Bsp. | Bromid Boronsäure / ester 1 und 2 | 1 Produkt | Ausbeute |
|---|---|---|---|
| L69 | S50 | 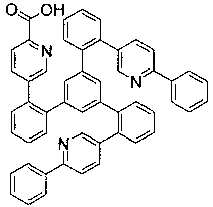 | 26 % |
| | 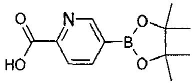 | | |
| | 1 x [913836-11-0] | | |
| | 2 x S22 | | |
| L70 | S50 | 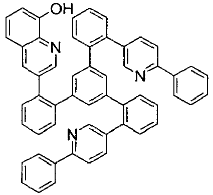 | 21 % |
| | 1 x S56 | | |
| | 2 x S22 | | |

### Beispiel L280:

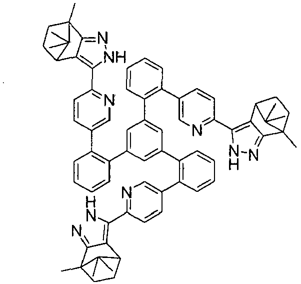

Eine gut gerührte, auf 0 °C gekühlte Suspension von 2.4 g (100 mmol) Natriumhydrid in 200 ml THF wird tropfenweise mit einer Lösung von 15.2 g (100 mmol) (1R)-(+)-Campfer [464-49-3] in 100 ml THF versetzt (Achtung: Wasserstoffentwicklung). Nach 15 min. nachrühren bei 0 °C und 30 min. bei Raumtemperatur wird die Reaktionsmischung mit 21.4 g (30 mmol) L124 versetzt und dann 5 h unter Rückfluss gerührt. Nach Erkalten wird durch vorsichtige Zugabe von 5 Gew.-%iger Salzsäure bis pH = 8 gequenscht. Man erweitert mit 300 ml Wasser und 300 ml Ethylacetat, trennt die org. Phase ab, extrahiert die wässrige dreimal mit je 200 ml Ethylacetat, vereinigt die org. Phasen, wäscht diese zweimal mit 300 ml Wasser und einmal mit 300 ml ges. Natriumchloridlösung und trocknet dann über Magnesiumsulfat. Das nach Entfernen des Ethylacetats erhaltene gelbe Öl wird in 200 ml Ethanol gelöst, tropfenweise unter Rühren mit 21.0 ml (150 mmol) Hydrazinhydrat versetzt und dann 16 h unter Rückfluss erhitzt. Nach Erkalten wird das Lösungsmittel im Vakuum entfernt, der Rückstand wird in 500 ml Ethylacetat gelöst, zweimal mit 300 ml Wasser und einmal mit 300 ml ges. Natriumchloridlösung gewaschen und dann über Magnesiumsulfat getrocknet. Der nach Entfernen des Lösungsmittels erhaltene Rückstand wird zweimal aus Acetonitril/Ethylacetat umkristallisiert. Ausbeute: 14.6 g (13.8 mmol), 46 %. Reinheit: ca. 97.0 %ig nach ¹H-NMR.

### Beispiel L290:

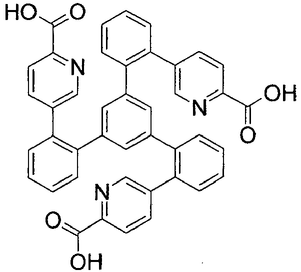

Ein Gemisch aus 71.2 g (100 mmol) L124, 22.4 g (400 mmol) KOH, 400 ml Ethanol und 100 ml Wasser wird 8 h unter Rückfluss erhitzt. Man entfernt das Lösungmittel weitgehend im Vakuum, versetzt mit 300 ml Wasser und säuert mit Essigsäure auf pH 5-6 an. Man extrahiert fünfmal mit je 200 ml Dichlormethan und trocknet die vereinigten Extrake über Magnesiumsulfat. Das nach Entfernen das Lösungsmittels erhaltene Rohprodukt wird ohne weitere Reinigung umgesetzt. Ausbeute: 63.6 g (95 mmol), 92 %. Reinheit: ca. 95.0 %ig nach ¹H-NMR.

### Beispiel L2: Darstellung durch Cyclotrimerisierung von Alkinen

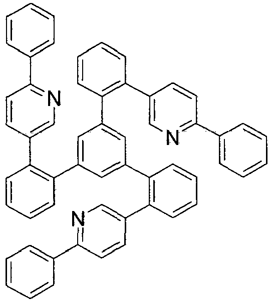

Eine Lösung von 25.5 g (100 mmol) S680 in 200 ml Dioxan wird mit 1.8 g (10 mmol) Dicarbonyl-cyclopentadienylcobalt [12078-25-0] versetzt und drei Tage unter Rückfluss erhitzt. Nach Erkalten entfernt man das Lösungsmittel im Vakuum, nimmt den Rückstand in Dichlormethan auf, und filtriert über ein vorgeschlämmtes Kieselgel-Bett. Nach Einengen wird der verbliebene Schaum aus 200 mL Ethylacetat unter Zusatz von 100 mL Methanol in der Siedehitze und dann ein zweites Mal aus 400 mL reinem Ethylacetat umkristallisiert und anschließend im Hochvakuum (p ca. 10⁻⁵ mbar, T 280 °C) Kugelrohr-sublimiert. Ausbeute: 20.7 g (27 mmol), 81 %. Reinheit: ca. 99.5 % ig n. ¹H-NMR.
Analog kann L111 aus S681 dargestellt werden, Ausbeute: 77 %.

### Beispiel L2: Darstellung aus 2,2',2"-(1,3,5-Benzenetriyl)tris [4,4,5,5-tetramethyl-1,3,2-dioxaborolan

Durchführung wie Bsp. L2, Variante B. Einsatz von 45.6 g (100 mmol) 2,2', 2"-(1,3,5-Benzenetriyl)tris[4,4,5,5-tetramethyl-1,3,2-dioxaborolan [365564-05-2] und 96.2 g (310 mmol) S200, die restlichen Komponenten werden proportional angepasst. Ausbeute: 52.1 g (68 mmol) 68 %. Reinheit: 98 %-ig n. ¹H-NMR.

Analog können folgende Verbindungen dargestellt werden:

| Bsp. | Boronester Bromid | Produkt | Ausbeute |
|---|---|---|---|
| L300 | 365564-05-2 | 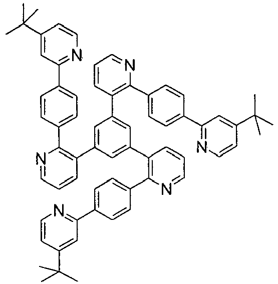 | 41 % |
| | 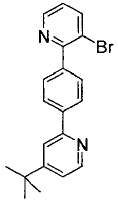 | | |
| | S222 | | |
| L301 | 365564-05-2 | 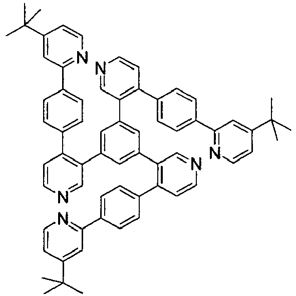 | 62 % |
| | 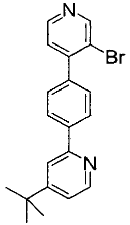 | | |
| | S223 | | |
| L302 | 365564-05-2 | 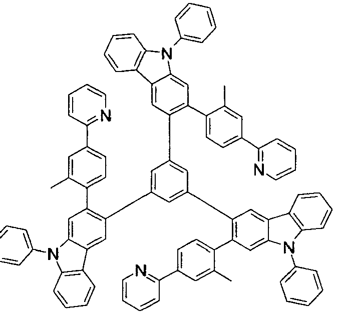 | 60 % |
| | 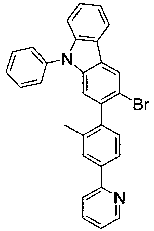 | | |
| | S224 | | |

### C: Synthese der Metallkomplexe - Teil1:

### Beispiel Ir(L1):

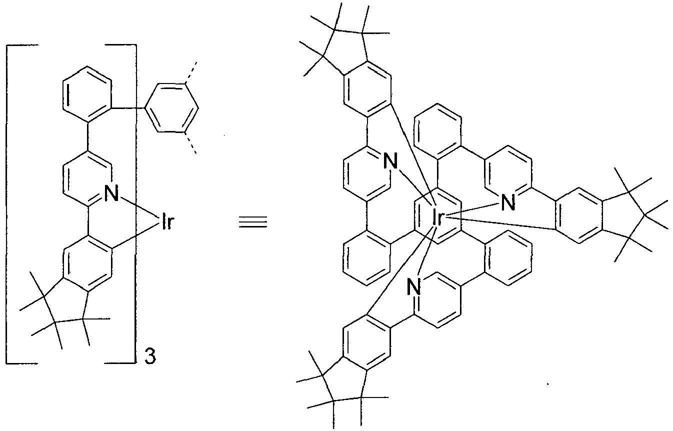

### Variante A:

Ein Gemisch aus 11.39 g (10 mmol) des Liganden L1, 4.90 g (10 mmol) Tris-acetylacetonato-iridium(III) [15635-87-7] und 120 g Hydrochinon [123-31-9] werden in einem 500 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen. Der Kolben wird in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250 - 260 °C, gemessen am Pt-100 Thermofühler, der in die aufgeschmolzene, gerührte Reaktionsmischung eintaucht, erhitzt. Während der nächsten 1.5 h wird das Reaktionsgemisch bei 250 - 260 °C gehalten, wobei wenig Kondensat abdestilliert und sich im Wasserabscheider sammelt. Nach Erkalten wird der Schmelzkuchen mechanisch zerkleinert und mit 500 ml Methanol ausgekocht. Die so erhaltene beige Suspension wird über eine Umkehrfritte filtriert, der beige Feststoff wird einmal mit 50 ml Methanol gewaschen und dann im Vakuum getrocknet. Rohausbeute: quantitativ. Der so erhaltene Feststoff wird in 200 ml Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten, am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erfolgt die weitere Reinigung des orangenfarbenen Produkts durch fünfmalige kontinuierliche Heißextraktion mit Toluol/Acetonitril 3:1 (vv) und zweimalige Heißextraktion mit Ethylacetat (Vorlagemenge jeweils ca. 150 ml, Extraktionshülse: standard Soxhletthülsen aus Cellulose der Fa. Whatman) unter sorgfältigem Luft- und Lichtausschluss. Abschließend wird das Produkt im Hochvakuum bei 330 °C getempert. Ausbeute: 11.15 g (8.4 mmol), 84 %. Reinheit: > 99.9 % nach HPLC.

### Beispiel Ir(L2):

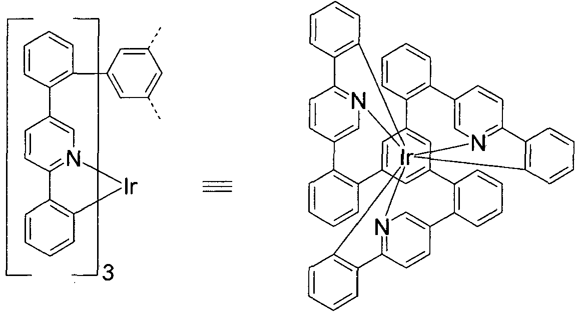

### Variante B:

Durchführung analog Ir(L1). Rohausbeute: quantitativ. Der so erhaltene Feststoff wird in 1500 ml Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten, am Rotationsverdampfer weitgehend eingeengt, wobei gleichzeitig kontinuierlich MeOH bis zur Kristallisation zugetropft wird. Nach Absaugen, waschen mit wenig MeOH und Trocknen im Vakuum erfolgt die weitere Reinigung des gelben Produkts durch dreimalige kontinuierliche Heißextraktion mit Toluol:Acetonitril (3:1, vv) und fünfmalige Heißextraktion mit Toluol (Vorlagemenge jeweils ca. 150 ml, Extraktionshülse: Standard Soxhletthülsen aus Cellulose der Fa. Whatman) unter sorgfältigem Luft- und Lichtausschluss. Abschließend wird das Produkt im Hochvakuum bei p ca. 10⁻⁵ mbar und T ca. 380 °C zweimal fraktioniert sublimiert. Ausbeute: 7.74 g (8.1 mmol), 81 %. Reinheit: > 99.9 % nach HPLC.

### Variante C:

Durchführung analog Ir(L2) Variante B, jedoch werden statt 120 g Hydrochinon 300 ml Diethylenglykol [111-46-6] verwendet und es wird 16 h bei 225 °C gerührt. Nach Erkalten auf 70 °C wird mit 300 ml Ethanol verdünnt, der Feststoff wird abgesaugt (P3), dreimal mit je 100 ml Ethanol gewaschen und dann im Vakuum getrocknet. Die weitere Reinigung erfolgt wie unter Variante B beschrieben. Ausbeute: 7.35 g (7.7 mmol), 77 %. Reinheit: > 99.9 % nach HPLC.

### Variante C*:

Durchführung analog Ir(L2) Variante B, jedoch werden statt 120 g Hydrochinon 300 ml Ethylenglykol [107-21-1] verwendet, und es wird 24 h unter Rückfluss gerührt. Nach Erkalten auf 70 °C wird mit 300 ml Ethanol verdünnt, der Feststoff wird abgesaugt (P3), dreimal mit je 100 ml Ethanol gewaschen und dann im Vakuum getrocknet. Die weitere Reinigung erfolgt wie unter Variante B beschrieben. Ausbeute: 7.54 g (7.9 mmol), 79 %. Reinheit: > 99.9 % nach HPLC.

### Variante D:

Durchführung analog Ir(L2) Variante B, jedoch werden statt 4.90 g (10 mmol) Tris-acetylacetonato-iridium(III) [15635-87-7] 3.53 g (10 mmol) Iridium(III)chlorid x n H₂O (n ca. 3) und statt 120 g Hydrochinon 300 ml Diethylenglykol [111-46-6] verwendet, und es wird 16 h bei 225 °C gerührt. Nach Erkalten auf 70 °C wird mit 300 ml Ethanol verdünnt, der Feststoff wird abgesaugt (P3), dreimal mit je 100 ml Ethanol gewaschen und dann im Vakuum getrocknet. Die weitere Reinigung erfolgt wie unter Variante B beschrieben. Ausbeute: 5.64 g (5.9 mmol), 59 %. Reinheit: > 99.9 % nach HPLC.

### Variante E: Tris-Carben-Komplexe

Eine Suspension von 20 mmol des Carben-Liganden und 60 mmol Ag₂O in 300 ml Dioxan wird 12 h bei 30 °C gerührt. Dann gibt man 10 mmol [Ir(COD)Cl]₂ [12112-67-3] zu und erhitzt 8 h unter Rückfluss. Man saugt noch heiß vom Feststoff ab, wäscht diesen dreimal mit je 50 ml heißem Dioxan, vereinigt die Filtrate und engt diese im Vakuum zur Trockene ein. Das so erhaltene Rohprodukt wird an basischem Aluminiumoxid mit Ethylacetat / Cyclohexan bzw. Toluol zweimal chromatographiert. Die weitere Reinigung des Produkts erfolgt durch fünfmalige kontinuierliche Heißextraktion mit Acetonitril und zweimalige Heißextraktion mit Ethylacetat/Methanol (Vorlagemenge jeweils ca. 200 ml, Extraktionshülse: Standard Soxhletthülsen aus Cellulose der Fa. Whatman) unter sorgfältigem Luft- und Lichtausschluss. Abschließend wird das Produkt im Hochvakuum sublimiert bzw. getempert. Reinheit: > 99.8 % nach HPLC.

### Variante F: Komplexe mit gemischtem Koordinationssatz Phenyl-Pyridine und Carbene

Durchführung analog Variante A, jedoch wird der Reaktionsmischung 2.5 g (20 mmol) 4-Dimethylaminopyridin [112258-3] und 2.3 g (10 mmol) Silber(I)oxid [20667-12-3] zugesetzt,
Die Metallkomplexe fallen üblicherweise als 1:1 Mischung der A- und Δ-Isomere / Enatiomere an. Im Folgenden aufgeführte Abbildungen von Komplexen zeigen üblicherweise nur ein Isomer. Werden Liganden mit drei verschiedenen Teilliganden eingesetzt, bzw. werden chirale Liganden als Racemat eingesetzt, fallen die abgeleiteten Metallkomplexe als Diastereomerenmischung an. Diese können durch fraktionierte Kristallisation oder chromatographisch getrennt werden. Werden chirale Liganden enantiomerenrein eingesetzt, fallen die abgeleiteten Metallkomplexe als Diastereomerenmischung an, deren Trennung durch fraktionierte Kristallisation oder Chromatographie zu reinen Enantiomeren führt.

Analog können folgende Verbindungen dargestellt werden:

| Bsp. | Ligand Metall-Synthon* | Produkt | Variante Reaktionszeit* Reaktionstemperatur* Extraktionsmittel* | Ausbeute |
|---|---|---|---|---|
| Rh(L2) | L2 Rh(acac)₃ 14284-92-5 | Rh(L2) | 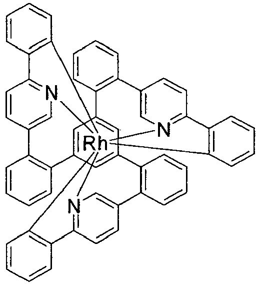 | 56 % |
| | | | B | |
| I(L3) | L3 | Ir(L3) | A | 76 % |
| | | | C | 78 % |
| Ru(L3) | L3 RuCl₃* 3H2O 13815-94-6 | Ru(L3) | B | 48 % |
| Ir(L4) | L4 | Ir(L4) | A | 72 % |
| | | | C | 69 % |
| Ir(L5 | L5 | Ir(L5) | A | 64 % |
| Ir(L6) | L6 | Ir(L6) | A | 71 % |
| Ir(L7) | L7 | Ir(L7) | A | 70 % |
| Ir(L8) | L8 | Ir(L8) | A | 63 % |
| Ir(L9) | L9 | Ir(L9) | A | 69 % |
| Ir(L10) | L10 | Ir(L10) | A | 77 % |
| | | | D | 51 % |
| Ir(L11) | L11 | Ir(L11) | A | 74 % |
| Ir(L12) | L12 | Ir(L12) | A | 69 % |
| Ir(L13) | L13 | Ir(L13) | A | 75 % |
| Ir(L14) | L14 | Ir(L14) | B | 80 % |
| | | | o-Xylol | |
| Ir(L15) | L15 | Ir(L15) | A | 78 % |
| Ir(L16) | L16 | Ir(L16) | A | 74 % |
| IrL17) | L17 | Ir(L17) | A | 77 % |
| Ir(L18) | L18 | Ir(L18) | A | 54 % |
| Ir(L19) | L19 | Ir(L19) | B | 67 % |
| | | | 12 h | |
| | | | o-Xylol | |
| Ir(L20) | L20 | Ir(L20) | B | 51 % |
| | | | 10 h | |
| | | | 260 °C | |
| Ir(L21) | L21 | Ir(L21) | B | 59 % |
| | | | 16 h | |
| | | | o-Xylol | |
| Ir(L22) | L22 | Ir(L22) | B | 62 % |
| | | | 16 h | |
| Ir(L23) | L23 | Ir(L23) | B | 54 % |
| | | | 16 h | |
| | | | 270 °C | |
| Ir(L24) | L24 | Ir(L24) | A | 67 % |
| Ir(L25) | L25 | Ir(L25) | A | 69 % |
| Ir(L26) | L26 | Ir(L26) | A | 73 % |
| Ir(L27) | L27 | Ir(L27) | B | 64 % |
| Ir(L28) | L28 | Ir(L28) | B | 76 % |
| Ir(L29) | L29 | Ir(L29) | A | 71 % |
| Ir(L30) | L30 | Ir(L30) | A | 51 % |
| Ir(L31) | L31 | Ir(L31) | A | 55 % |
| Ir(L32) | L32 | Ir(L32) | A | 70 % |
| | | | C | 71 % |
| Ir(L33) | L33 | Ir(L33) | A | 38 % |
| Ir(L34) | L34 | Ir(L34) | B | 42 % |
| Ir(L35) | L35 | Ir(L35) | B | 68 % |
| Ir(L36) | L36 | Ir(L36) | B | 65 % |
| Ir(L37) | L37 | Ir(L37) | B | 70 % |
| Ir(L38) | L38 | Ir(L38) | B | 66 % |
| Ir(L39) | L39 | Ir(L39) | A | 61 % |
| Ir(L40) | L40 | Ir(L40) | A | 58 % |
| Ir(L41) | L41 | Ir(L41) | B | 69 % |
| Ir(L42) | L42 | Ir(L42) | B | 64 % |
| Ir(L43) | L43 | Ir(L43) | B | 64 % |
| Ir(L44) | L44 | Ir(L44) | B | 59 % |
| Ir(L45) | L45 | Ir(L45) | B | 66 % |
| Ir(L46) | L46 | Ir(L46) | B | 70 % |
| | | | D | 56 % |
| Ir(L47) | L47 | Ir(L47) | B | 59 % |
| | | | Cyclohexan : Toluol (1:1, vv) | |
| Ir(L48) | L48 | Ir(L48) | B | 61 % |
| Ir(L49) | L49 | Ir(L49) | B | 64 % |
| Ir(L50) | L50 | Ir(L50) | B | 67 % |
| Ir(L51) | L51 | Ir(L51) | B | 69 % |
| Rh(L51) | L51 Rh(acac)₃ 14284-92-5 | Rh(L51) | B | 60 % |
| Ir(L52) | L52 | Ir(L52) | B | 60 % |
| | | | Cyclohexan : Toluol (1:1, vv) | |
| Ir(L53) | L53 | Ir(L53) | B | 59 % |
| | | | Cyclohexan : Toluol (1:1, vv) | |
| Ir(L54) | L54 | Ir(L54) | B | 66 % |
| IrL55) | L55 | Ir(L55) | B | 67 % |
| Ir(L56) | L56 | Ir(L56) | B | 70 % |
| Ir(L57) | L57 | Ir(L57) | B | 65 % |
| Ir(L58) | L58 | Ir(L58) | B | 53 % |
| Ir(L59) | L59 | Ir(L59) | B | 60 % |
| | | | Cyclohexan : Toluol (1:1, vv) | |
| | | | Diastereomerengemisch | |
| Ir(L60) | L60 | Ir(L60) | B | 62 % |
| | | | Disatereomerengemisch | |
| Ir(L61) | L61 | Ir(L61) | B | 65 % |
| | | | Cyclohexan : Toluol (1:1, vv) | |
| | | | Diastereomerengemisch | |
| Ir(L62) | L62 | Ir(L62) | B | 58 % |
| | | | Diastereomerengemisch | |
| Ir(L63) | L63 | Ir(L63) | B | 68 % |
| Ir(L64) | L64 | Ir(L64) | B | 44 % |
| Ir(L65) | L65 | Ir(L65) | B | 39 % |
| Ir(L66) | L66 | Ir(L66) | B | 43 % |
| Ir(L67) | L67 | Ir(L67) | B | 40 % |
| Ir(L68) | L68 | Ir(L68) | 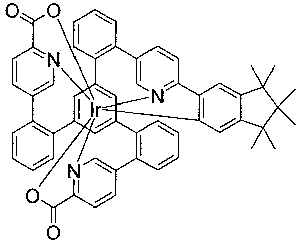 | 67 % |
| | | | C | |
| Ir(L69 | L69 | Ir(L69) | C | 70 % |
| Ir(L70) | L70 | Ir(L70) | C | 65 % |
| Ir(L71 ) | L71 | Ir(L71) | B | 74 % |
| Rh(L71) | L71 Rh(acac)₃ 14284-92-5 | Rh(L71) | B | 70 % |
| Ir(L72) | L72 | Ir(L72) | 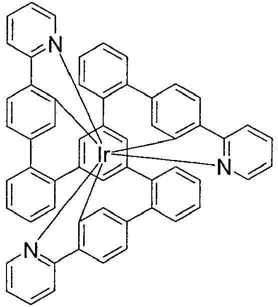 | 74 % |
| | | | B | |
| Ir(L72) | L72 | Ir(L72) | C* | 68 % |
| Ir(L73) | L73 | Ir(L73) | 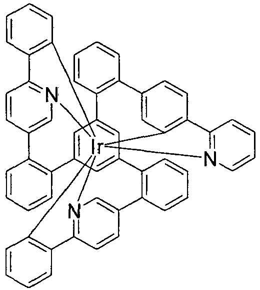 | 58 % |
| | | | B | |
| Ir(L75) | L75 | Ir(L75) | 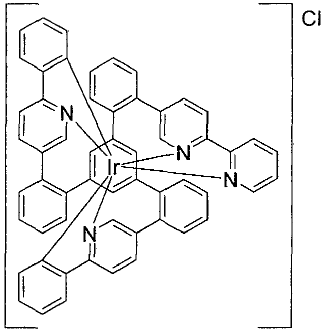 | 34 % |
| | | | D | |
| | | | Zusatz von 30 mmol 2,6-Dimethylpyridin Reinigung durch Umkristallisation aus DMF / Acetonitril | |
| Ir(L77) | L77 | Ir(L77) | B | 70 % |
| Ir(L78) | L78 | Ir(L78) | B | 58 % |
| Ir(L79) | L79 | Ir(L79) | B | 61 % |
| Ir(L80) | L80 | Ir(L80) | B | 65 % |
| Ir(L81) | L81 | Ir(L81) | B | 67 % |
| Ir(L82) | L82 | Ir(L82) | B | 71 % |
| Ir(L83) | L83 | Ir(L83) | B | 65 % |
| Ir(L84) | L84 | Ir(L84) | B | 66 % |
| Ir(L85 | L85 | Ir(L85) | B | 58 % |
| Ir(L86) | L86 | Ir(L86) | B | 57 % |
| Ir(L87) | L87 | Ir(L87) | B | 61 % |
| Ir(L88) | L88 | Ir(L88) | B | 58 % |
| Ir(L89) | L89 | Ir(L89) | B | 58 % |
| Ir(L90) | L90 | Ir(L90) | B | 50 % |
| Ir(L95) | L95 | Ir(L95) | B | 55 % |
| Ir(L96) | L96 | Ir(L96) | B | 72 % |
| Ir(L97) | L97 | Ir(L97) | 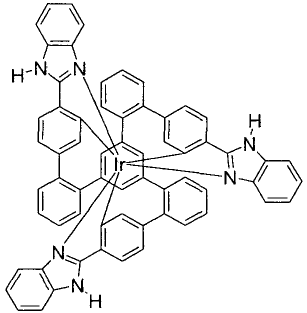 | 30 % |
| | | | B | |
| | | | Ethylacetat | |
| Ir(L98) | L98 | Ir(L98) | B | 66 % |
| | | | Mesitylen | |
| Ir(L99) | L99 | Ir(L99) | B | 51 % |
| Ir(L100) | L100 | Ir(L100) | B | 40 % |
| Ir(L101) | L101 | Ir(L101) | B | 48 % |
| Ir(L102) | L102 | Ir(L102) | B | 63 % |
| Ir(L103) | L103 | Ir(L103) | B | 31 % |
| Ir(L104) | L104 | Ir(L104) | A | 34 % |
| Ir(L105) | L105 | Ir(L105) | B | 54 % |
| Ir(L106) | L106 | Ir(L106) | B | 67 % |
| Ir(L107) | L107 | Ir(L107) | 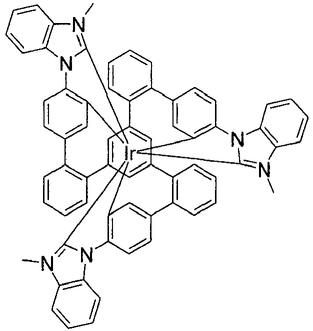 | 39 % |
| | | | E | |
| Ir(L108) | L108 | Ir(L108) | E | 33 % |
| Ir(L109) | L109 | Ir(L109) | E | 27 % |
| Ir(L110) | L110 | Ir(L110) | B | 56 % |
| Ir(L111) | L111 | Ir(L111) | B | 85 % |
| Rh(L111) | L111 Rh(acac)₃ 14284-92-5 | Rh(L111) | B | 71 % |
| Ru(L111) | L111 RuCl₃ * 3H2O 13815-94-6 | Ru(L111) | B | 36 % |
| Ir(L112) | L112 | Ir(L112) | B | 81 % |
| Ir(L113) | L113 | Ir(L113) | B | 61 % |
| | | | 260 °C / 5 h | |
| Ir(L114) | L114 | Ir(L114) | 265 °C / 6 h | 58 % |
| | | | B | |
| Ir(L116) | L116 | Ir(L116) | B | 40 % |
| | | | 265° C | |
| | | | 2 h | |
| | | | Mesitylen | |
| Ir(L117) | L117 | Ir(L117) | wie Ir(L116) | 39 % |
| Ir(L118) | L118 | Ir(L118) | wie Ir(L116) Diastereomerengemisch chromatographische Trennung mit DCM an Kieselgel möglich | 42 % |
| Ir(L119) | L119 | Ir(L119) | wie Ir(L116) | 58 % |
| Ir(L120) | L120 | Ir(L120) | 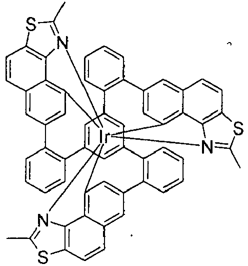 | 66 % |
| | | | wie Ir(L116) | |
| Ir(L121) | L121 | Ir(L121) | wie Ir(L116) | 53 % |
| Ir(L122) | L122 | Ir(L122) | wie Ir(L116) | 59 % |
| Ir(L123) | L123 | Ir(L123) | wie Ir(L116) | 62 % |
| Ir(L125) | L125 | Ir(L125) | B | 66 % |
| | | | 255 °C | |
| | | | 2.5 h | |
| Ir(L126) | L126 | Ir(L126) | wie Ir(L125) | 63 % |
| Ir(L127) | L127 | Ir(L127) | B | 64 % |
| | | | Ethylacetat | |
| Ir(L128) | L128 | Ir(L128) | wie Ir(L127) | 58 % |
| Ir(L129 | L129 | Ir(L129 | wie Ir(L127) | 55 % |
| Ir(L130) | L130 | Ir(L130) | B | 60 % |
| | | | Toluol | |
| Ir(L131) | L131 | Ir(L131) | B | 63 % |
| | | | Mesitylen | |
| Ir(L132) | L132 | Ir(L132) | wie Ir(L127) | 36 % |
| IrL133) | L133 | Ir(L133) | wie Ir(L131) | 44 % |
| Ir(L134) | L134 | Ir(L134 | wie IrL131) | 40 % |
| Ir(L135) | L135 | Ir(L135) | B | 75 % |
| | | | Dichlormethan | |
| Ir(L136) | L136 | Ir(L136) | 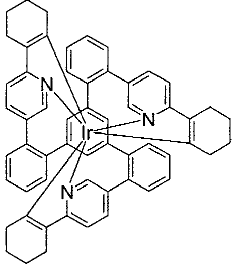 | 44 % |
| | | | B | |
| | | | 250 °C / 2 h | |
| | | | Ethylacetat | |
| Ir(L137) | L137 | Ir(L137) | wie Ir(L136) | 51 % |
| Ir(L138) | L138 | Ir(L138) | wie Ir(L136) | 73 % |
| Ir(L139) | L139 | Ir(L139) | wie Ir(L136) | 70 % |
| Ir(L140) | L140 | Ir(L140) | wie Ir(L97) | 68 % |
| Ir(L141) | L141 | Ir(L141) | wie Ir(L97) | 61 % |
| Ir(L142) | L142 | Ir(L142) | wie Ir(L97) | 65 % |
| Ir(L143) | L143 | Ir(L143) | wie Ir(L97) | 37 % |
| Ir(L144) | L144 | Ir(L144) | 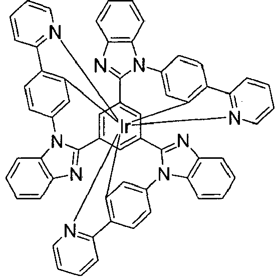 | 63 % |
| | | | B | |
| | | | o-Xylol | |
| Ir(L145) | L145 | Ir(L145) | wie Ir(L144) | 55 % |
| Ir(L146) | L146 | Ir(L146) | wie Ir(L144) | 66 % |
| Ir(L147) | L147 | Ir(L147) | wie Ir(L144) | 68 % |
| Ir(L148) | L148 | Ir(L148) | wie Ir(L144) | 48 % |
| Ir(L149) | L149 | Ir(L149) | 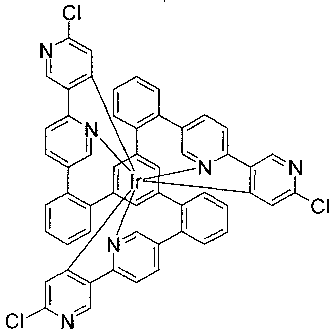 | 31 % |
| | | | B | |
| Ir(L200) | L200 | Ir(L200) | B | 73 % |
| Ir(L201) | L201 | Ir(L201) | B | 70 % |
| | | | Ethylacetat | |
| Ir(L202) | L202 | Ir(L202) | wie Ir(L201) | 67 % |
| Ir(L203) | L203 | Ir(L203) | wie Ir(L201) | 70 % |
| Ir(L204) | L204 | Ir(L204) | wie Ir(L201) | 70 % |
| Ir(L205) | L205 | Ir(L205) | wie Ir(L201) | 73 % |
| Ir(L206) | L206 | Ir(L206) | wie Ir(L201) | 75 % |
| Ir(L207) | L207 | Ir(L207) | B | 75 % |
| | | | n-Butylacetat | |
| Ir(L208) | L208 | Ir(L208) | wie Ir(L201) | 72 % |
| Ir(L209) | L209 | Ir(L209) | wie Ir(L201) | 70 % |
| Ir(L210) | L210 | Ir(L210) | B | 76 % |
| Ir(L211) | L211 | Ir(L211) | wie Ir(L201) | 75 % |
| Ir(L212) | L212 | Ir(L212) | wie Ir(L201) | 68 % |
| Ir(L213) | L213 | Ir(L213) | wie Ir(L201) | 79 % |
| Ir(L214) | L214 | Ir(L214) | wie Ir(L201) | 67 % |
| Ir(L215) | L215 | Ir(L215) | wie Ir(L201) | 70 % |
| Ir(L216) | L216 | Ir(L216) | wie Ir(L201) | 71 % |
| Ir(L217) | L217 | Ir(L217) | wie Ir(L201) | 66 % |
| Ir(L218) | L218 | Ir(L218) | B | 69 % |
| Ir(L219) | L219 | Ir(L219) | B | 55 % |
| | | | Fluorbenzol | |
| Ir(L220) | L220 | Ir(L220) | wie Ir(L201) | 63 % |
| Os(L220) | L220 | Os(L220) | C | 39 % |
| | | | Chromatographie mit DCM an Alox, neutral | |
| Ir(L221) | L221 | Ir(L221) | wie Ir(L201) | 67 % |
| Ir(L222) | L222 | Ir(L222) | B | 64 % |
| | | | Butylacetat | |
| Ir(L223) | L223 | Ir(L223) | B | 57 % |
| | | | Butylacetat | |
| It(L224) | L224 | It(L224) | wie Ir(L223) | 61 % |
| Ir(L225) | L225 | Ir(L225) | wie Ir(L201) | 33 % |
| Ir(L226) | L226 | Ir(L226) | B | 14 % |
| IrL227) | L227 | Ir(L227) | wie Ir(L201) | 21 % |
| Ir(L228) | L228 | Ir(L228) | wie Ir(L201) | 26 % |
| Ir(L229) | L229 | Ir(L229) | B | 67 % |
| | | | Mesitylen | |
| Ir(L230) | L230 | Ir(L230) | wie Ir(L229) | 63 % |
| Ir(L231) | L231 | Ir(L231) | B | 50 % |
| Ir(L232) | L232 | Ir(L232) | B | 61 % |
| Ir(L233) | L233 | Ir(L233) | 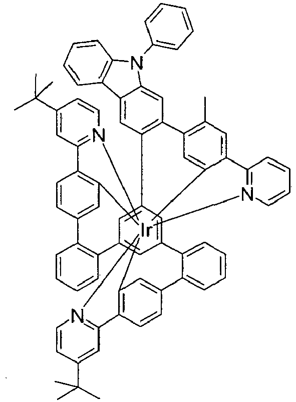 | 63 % |
| | | | B | |
| | | | Butylacetat | |
| Ir(L250) | L250 | Ir(L250) | 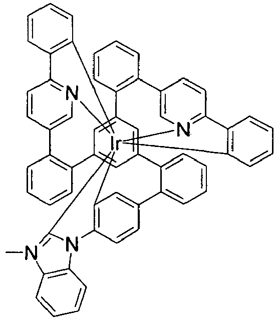 | 31 % |
| | | | F | |
| | | | 2x Heißextraktion Ethylacetat | |
| | | | 5 x Heißextraktion Toluol | |
| Ir(L251) | L251 | Ir(L251) | wie Ir(L250) | 40 % |
| Ir(L252) | L252 | Ir(L252) | wie Ir(L250) | 38 % |
| Ir(L253) | L253 | Ir(L253) | wie Ir(L250) | 27 % |
| Ir(L254) | L254 | Ir(L254) | wie Ir(L250) | 33 % |
| Ir(L255) | L255 | Ir(L255) | wie Ir(L250) | 30 % |
| Ir(L256) | L256 | Ir(L256) | wie Ir(L250) | 30 % |
| Ir(L257) | L257 | Ir(L257) | wie Ir(L250) | 40 % |
| Ir(L260) | L260 | Ir(L260) | wie Ir(L250) | 40 % |
| Ir(L261) | L261 | Ir(L261) | wie Ir(L250) | 42 % |
| Ir(L270) | L270 | Ir(L270) | 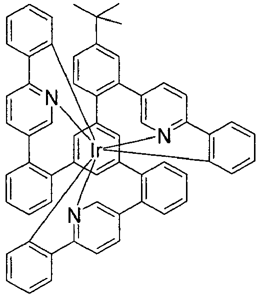 | 65 % |
| | | | B | |
| Ir(L271) | L271 | Ir(L271) | wie Ir(L270) | 70 % |
| Ir(L272) | L272 | Ir(L272) | wie Ir(L270 | 61 % |
| Ir(L273) | L273 | Ir(L273) | wie Ir(L270) | 64 % |
| Ir(L274) | L274 | Ir(L274) | wie Ir(L270) | 64 % |
| Ir(L275) | L275 | Ir(L275) | B | 48 % |
| | | | 2.5 h | |
| | | | 265 °C | |
| | | | Dichlormethan | |
| Ir(L276) | L276 | Ir(L276) | wie Ir(L270) | 70 % |
| Ir(L277 | L277 | Ir(L277) | wie Ir(L270) | 69 % |
| IrL300) | L300 | Ir(L300) | B | 27 % |
| Ir(L301) | L301 | Ir(L301) | B | 48 % |
| It(L302) | L302 | It(L302) | B | 66 % |
| | | | Toluol | |

| | | | | |
|---|---|---|---|---|
| *: Angabe sofern abweichend von allgemeiner Vorschrift | | | | |

### Metallkomplexe des Liganden L74:

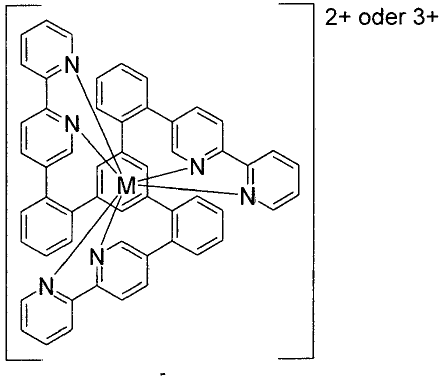

Eine Lösung von 769 mg (1 mmol) L74 in 10 ml DMSO wird bei 75 °C tropfenweise mit einer auf 75 °C temperierten Lösung von 1 mmol des entsprechenden Metallsalzes in 20 ml EtOH bzw. EtOH-Wasser (1:1 vv) versetzt und 5 h nachgerührt. Gegebenenfalls wird unter Zusatz von 6 mmol des entsprechenden Salzes (KPF₆, (NH₄)PF₆, KBF₄, etc.) in 10 ml EtOH oder EtOH/Wasser (1:1, vv) ein Anionenaustausch durchgeführt. Nach Erkalten wird der mikrokristalline Niederschlag abgesaugt, mit kaltem MeOH gewaschen und im Vakuum getrocknet. Die Reinigung kann durch Umkristallisation aus Acetonitril/Methanol erfolgen.

Analog können folgende Verbindungen dargestellt werden:

| Bsp. | Ligand | Produkt | Ausbeute |
|---|---|---|---|
| | Metallsalz | | |
| M1 | L74 | [Fe(L74)](ClO₄)₂ | 68 % |
| | Fe(ClO₄)₂ | | |
| M2 | L74 | [Fe(L74)](ClO₄)₃ | 76 % |
| | Fe(ClO₄)₃ | | |
| M3 | L74 | [Ru(L74)](ClO₄)₃ | 70 % |
| | Ru(ClO₄)₃ | | |
| M4 | L74 | [Os(L74)](ClO₄)₂ | 39 % |
| | Os(ClO₄)₂ | | |
| M5 | L74 | [Co(L74)](ClO₄)₃ | 63 % |
| | Co(ClO₄)₃ | | |
| M6 | L74 | [Rh(L74)](PF₆)₃ | 58 % |
| | RhCl₃ x H₂O | | |
| | KPF₆ | | |
| M7 | L74 | [Ir(L74)](PF₆)₃ | 69 % |
| | (NH₄)₃[IrCl₆] x H₂O | | |
| | KPF₆ | | |
| M8 | ZnCl₂ | [Zn(L74)](BF₄)₃ | 73 % |
| | KBF₄ | | |

### Metallkomplexe des Liganden L76:

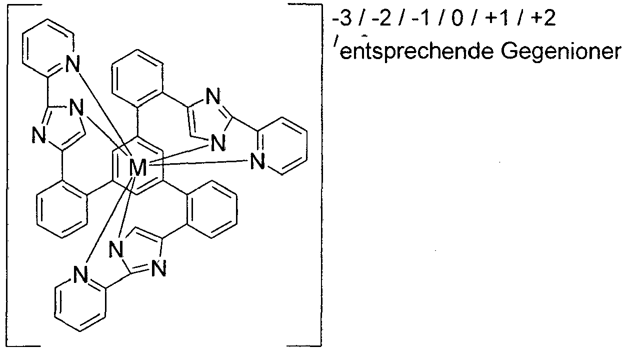

Eine Lösung von 736 mg (1 mmol) L76 und 643 mg (6 mmol) 2,6-Dimethyl-pyridin in 10 ml DMSO wird bei 75 °C tropfenweise mit einer auf 75 °C temperierten Lösung von 1 mmol des entsprechenden Metallsalzes in 20 ml EtOH bzw. EtOH-Wasser (1:1 vv) versetzt und 10 h nachgerührt. Gegebenenfalls wird unter Zusatz von 6 mmol des entsprechenden Salzes (KPF₆, (NH₄)PF₆, KBF₄, etc.) in 10 ml EtOH oder EtOH/Wasser (1:1, vv) ein Anionenaustausch durchgeführt. Nach Erkalten wird der mikrokristalline Niederschlag abgesaugt, mit kaltem MeOH gewaschen und im Vakuum getrocknet. Die Reinigung kann durch Umkristallisation aus Acetonitril / Methanol erfolgen.

Analog können folgende Verbindungen dargestellt werden:

| Bsp. | Ligand | Produkt | Ausbeute |
|---|---|---|---|
| | Metallsalz | | |
| M100 | L76 | Fe(L76) | 68 % |
| | FeCl₃ Hydrat | | |
| M101 | L76 | NH₄[Ru(L76)] | 47 % |
| | [Ru(NH₃)₆]Cl₂ | | |
| | kein 2,6-Dimetylpyridin | | |
| M102 | L76 | Ru(L76) | 56 % |
| | RuCl₃ Hydrat | | |
| M103 | L76 | Os(L76) | 61 % |
| | OsCl₃ Hydrat | | |
| M104 | L76 | Rh(L76) | 47 % |
| | RhCl₃ Hydrat | | |
| M105 | L76 | Ir(L76) | 72 % |
| | IrCl₃ Hydrat | | |
| M106 | L76 | [Pt(L76)](PF₆) | 64 % |
| | (NH₄)₂[PtCl₆] | | |
| | als Feststoff zugesetzt | | |
| | NH₄PF₆ | | |

### Metallkomplexe des Liganden L91:

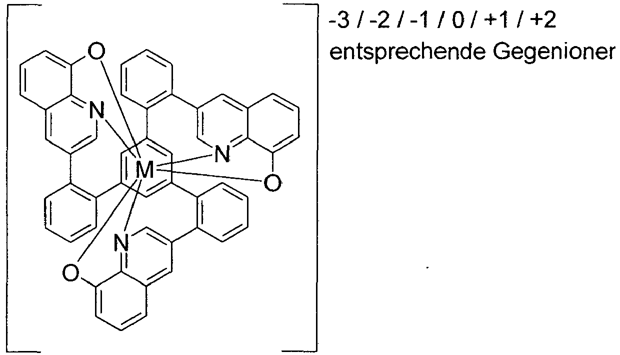

Eine Lösung von 736 mg (1 mmol) L91, 643 mg (6 mmol) 2,6-Dimethylpyridin in 10 ml DMSO wird bei 75 °C tropfenweise mit einer auf 75 °C temperierten Lösung von 1 mmol des entsprechenden Metallsalzes in 20 ml EtOH bzw. EtOH-Wasser (1:1 vv) versetzt und 10 h nachgerührt. Gegebenenfalls wird unter Zusatz von 6 mmol des entsprechenden Salzes (KPF₆, (NH₄)PF₆, KBF₄, etc.) in 10 ml EtOH oder EtOH/Wasser (1:1, vv) ein Anionenaustausch durchgeführt. Nach Erkalten wird der mikrokristalline Niederschlag abgesaugt, mit kaltem MeOH gewaschen und im Vakuum getrocknet. Die Reinigung kann durch Umkristallisation aus Acetonitril / Methanol erfolgen.

Analog können folgende Verbindungen dargestellt werden:

| Bsp. | Ligand | Produkt | Ausbeute |
|---|---|---|---|
| | Metallsalz | | |
| M200 | L91 | Al(L91) | 86 % |
| | AlCl₃ | | |
| M201 | L91 | Ga(L91) | 78 % |
| | GaCl₃ | | |
| M202 | L91 | In(L91) | 75 % |
| | InCl₃ | | |
| M203 | L91 | La(L91) | 44 % |
| | LaCl₃ | | |
| M204 | L91 | Ce(L91) | 48 % |
| | CeCl₃ | | |
| M205 | L91 | Fe(L91) | 91 % |
| | FeCl₃ | | |
| M206 | L91 | Ru(L91) | 88 % |
| | RuCl₃ | | |

### Metallkomplexe des Liganden L92:

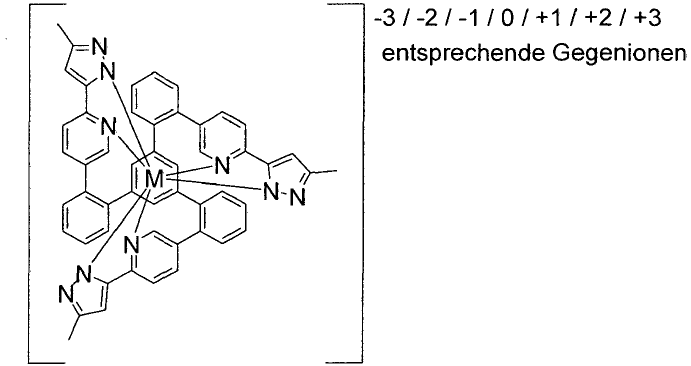

Eine Lösung von 778 mg (1 mmol) L92, 643 mg (6 mmol) 2,6-Dimethylpyridin in 10 ml DMSO wird bei 75 °C tropfenweise mit einer auf 75 °C temperierten Lösung von 1 mmol des entsprechenden Metallsalzes in 20 ml EtOH bzw. EtOH-Wasser (1:1 vv) versetzt und 10 h nachgerührt. Gegebenenfalls wird unter Zusatz von 6 mmol des entsprechenden Salzes (KPF₆, (NH₄)PF₆, KBF₄, etc.) in 10 ml EtOH oder EtOH/Wasser (1:1, vv) ein Anionenaustausch durchgeführt. Nach Erkalten wird der mikrokristalline Niederschlag abgesaugt, mit kaltem MeOH gewaschen und im Vakuum getrocknet. Die Reinigung kann durch Umkristallisation aus Acetonitril / Methanol oder durch Heißextraktion und anschließende fraktionierte Sublimation erfolgen. Die sich im Fall des chiralen Liganden L280 bildenden Diastereomerengemische können chromatographisch an silanisiertem Kieselgel getrennt werden.

Analog können folgende Verbindungen dargestellt werden:

| Bsp. | Ligand | Produkt | Ausbeute |
|---|---|---|---|
| | Metallsalz | | |
| M300 | L92 | Ga(L92) | 68 % |
| | GaCl₃ | | |
| M301 | L92 | In(L92) | 70 % |
| | InCl₃ | | |
| M302 | L92 | Ir(L92) | 76 % |
| | IrCl₃ Hydrat | | |
| M303 | L93 | La(L93) | 55 % |
| | LaCl₃ | | |
| M304 | L93 | Fe(L93) | 86 % |
| | FeCl₃ | | |
| M305 | L93 | Ir(L93) | 84 % |
| | IrCl₃ Hydrat | | |
| M306 | L94 | Ru(L94) | 78 % |
| | RuCl₃ | | |
| M307 | L94 | Ir(L94) | 81 % |
| | IrCl₃ Hydrat | | |
| M308 | L280 | Al(L280) | 58 % |
| | AlCl₃ | Diastereomerengemisch | |
| M309 | L280 | Fe(L280) | 86 % |
| | FeCl₃ | Diastereomerengemisch | |
| M310 | L280 | Ru(L280) | 74 % |
| | RuCl₃ | Diastereomerengemisch | |
| M311 | L280 | Ir(L280) | 79 % |
| | IrCl₃ Hydrat | Diastereomerengemisch | |

### Metallkomplexe des Liganden L290:

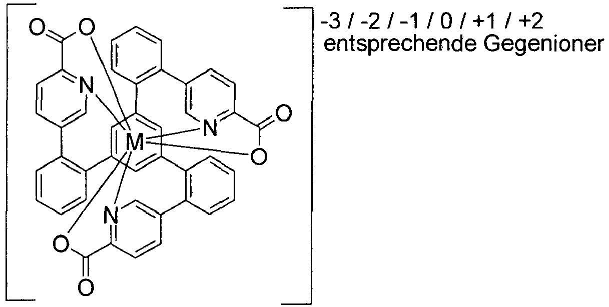

Durchführung analog zu Beispiel M200.

Analog können folgende Verbindungen dargestellt werden:

| Bsp. | Ligand | Produkt | Ausbeute |
|---|---|---|---|
| | Metallsalz | | |
| M400 | L290 | Al(L290) | 66 % |
| | AlCl₃ | | |
| M401 | L290 | Ga(L290) | 70 % |
| | GaCl₃ | | |
| M402 | L290 | La(L290) | 48 % |
| | LaCl₃ | | |
| M403 | L290 | Ce(L290) | 53 % |
| | CeCl₃ | | |
| M404 | L290 | Fe(L290) | 89 % |
| | FeCl₃ | | |
| M405 | L290 | Ru(L290) | 87 % |
| | RuCl₃ | | |
| M406 | L290 | Ir(L290) | 77 % |
| | IrCl₃ Hydrat | | |

### D: Funktionalisierung der Metallkomplexe - Teil1:

### 1) Halogenierung der Iridium-Komplexe:

Eine Lösung bzw. Suspension von 10 mmol eines Komplexes, der in para-Position zum Iridium A x C-H-Gruppen (mit A = 1, 2, 3) trägt, in 500 ml bis 2000 ml Dichlormethan, je nach Löslichkeit der Metallkomplexe, wird unter Licht- und Luftausschluss bei -30 bis +30 °C mit A x 10.5 mmol N-Halogensuccinimid (Halogen: Cl, Br, I) versetzt und 20 h gerührt. In DCM schlecht lösliche Komplexe können auch in anderen Lösungsmitteln (TCE, THF, DMF, Chlorbenzol, etc.) und bei erhöhter Temperatur umgesetzt werden. Anschließend wird das Lösungsmittel im Vakuum weitgehend entfernt. Der Rückstand wird mit 100 ml Methanol ausgekocht, der Feststoff wird abgesaugt, dreimal mit 30 ml Methanol gewaschen und dann im Vakuum getrocknet. Man erhält so die in para-Position zum Iridium bromierten Iridium-Komplexe. Komplexe mit einem HOMO (CV) von ca. -5.1 bis - 5.0 eV und betragsmäßig kleiner neigen zur Oxidation (Ir(III) > Ir(IV)), wobei das Oxidationsmittel Brom, freigesetzt aus NBS, ist. Diese Oxidationsreaktion ist durch eine deutliche Grünfärbung der ansonsten gelben bis roten Lösungen / Suspensionen der Emitter zu erkennen. In solchen Fällen wird ein weiteres Äquivalent NBS zugesetzt. Zur Aufarbeitung setzt man 300 - 500 ml Methanol und 2 ml Hydrazin Hydrat als Reduktionsmittel zu, wodurch sich die grünen Lösungen / Suspension gelb verfärben (Reduktion Ir(IV) > Ir(III). Dann zieht man im Vakuum das Lösungsmittel weitgehend ab, versetzt mit 300 ml Methanol, saugt den Feststoff ab, wäscht dreimal mit je 100 ml Methanol und trocknet im Vakuum.

Unterstöchiometrische Bromierungen, z.B. Mono- und Di-Bromierungen von Komplexen mit 3 C-H-Gruppen in der para-Position zum Iridium, verlaufen meist weniger selektiv als die stöchiometrischen Bromierungen. Die Rohprodukte dieser Bromierungen können chromatographisch (CombiFlash Torrent der Fa. A. Semrau) getrennt werden.

### Synthese von Ir(L2-3Br):

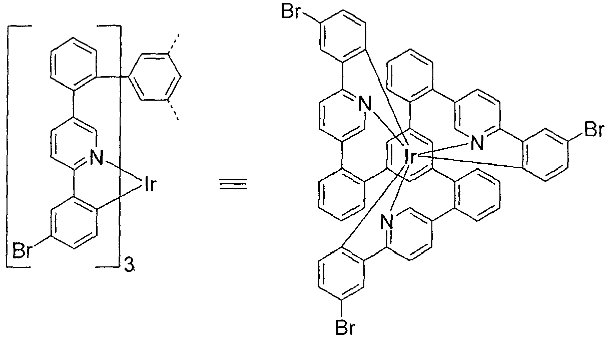

Eine bei 0 °C gerührte Suspension von 9.6 g (10 mmol) Ir(L2) in 2000 ml DCM wird auf einmal mit 5.6 g (31.5 mmol) N-Bromsuccinimid versetzt und dann weitere 20 h gerührt. Nach Entfernen von ca. 1900 ml des DCMs im Vakuum wird die gelbe Suspension mit 100 ml Methanol versetzt, der Feststoff wird abgesaugt, dreimal mit ca. 50 ml Methanol gewaschen und dann im Vakuum getrocknet. Ausbeute: 11.3 g (9.5 mmol) 95 %; Reinheit: > 99.0 %ig nach NMR.

Analog können folgende Verbindungen dargestellt werden:

| Bsp. | Edukt > bromierter Komplex | Ausbeute |
|---|---|---|
| Tribromierung | | |
| Ir(L14-3Br) | 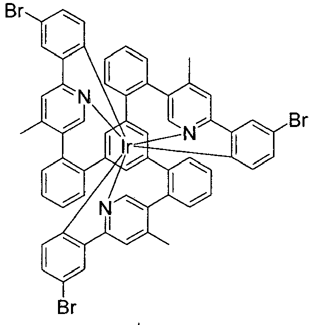 | 95 % |
| | Ir(L14) > Ir(L14-3Br) | |
| Ir(L16-3Br) | 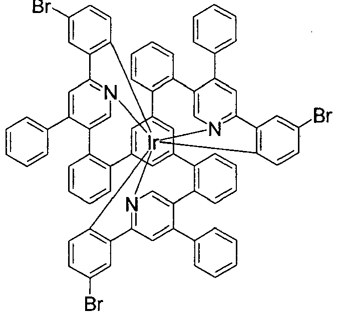 | 90 % |
| | Ir(L16) > Ir(L16-3Br) | |
| Ir(L20-3Br) | 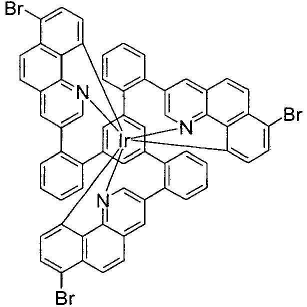 | 97 % |
| | Ir(L20) > Ir(L20-3Br) | |
| Ir(L22-3Br) | 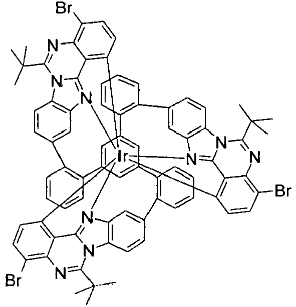 | 96 % |
| | Ir(L22) > Ir(L22-3Br) | |
| Ir(L24-3Br) | 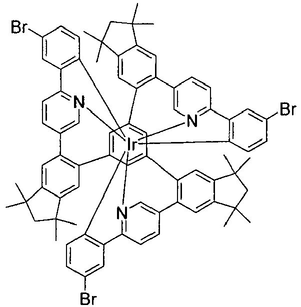 | 93 % |
| | Ir(L24) > Ir(L24-3Br) | |
| Ir(L27 -3Br) | 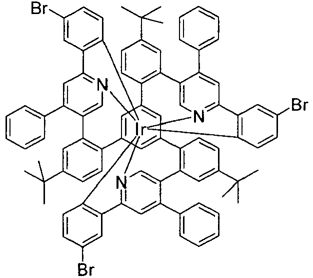 | 90 % |
| | Ir(L27) > Ir(L27-3Br) | |
| Ir(L35-3Br) | 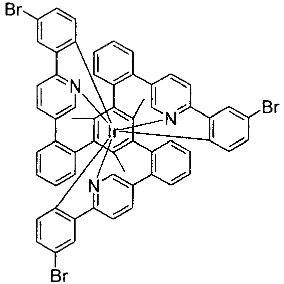 | 95 % |
| | Ir(L35) > Ir(L35-3Br) | |
| Ir(L37-3Br) | 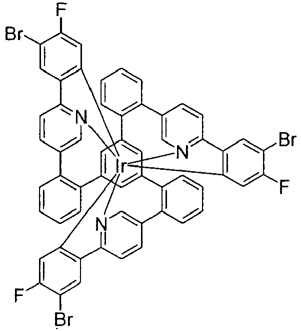 | 92 % |
| | Ir(L37) > Ir(L37-3Br) | |
| Ir(L48-3Br) | 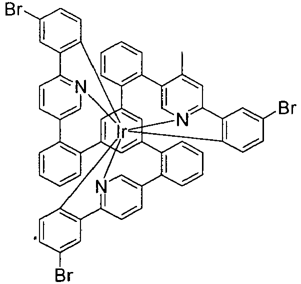 | 90 % |
| | Ir(L48) > Ir(L48-3Br) | |
| Ir(L51-3Br) | 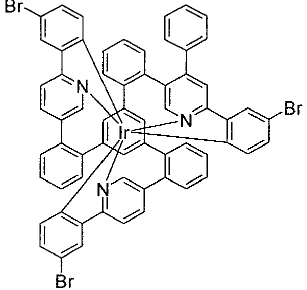 | 90 % |
| | Ir(L51) > Ir(L51-3Br) | |
| Ir(L55-3Br) | 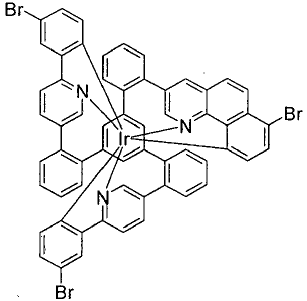 | 95 % |
| | Ir(L55) > Ir(L55-3Br) | |
| Ir(L72-3Br) | 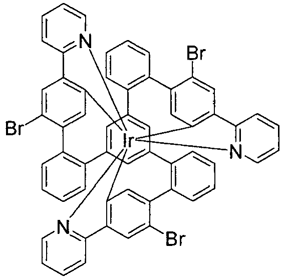 | 96 % |
| | Ir(L72) > Ir(L72-3Br) | |
| Ir(L73-3Br) | 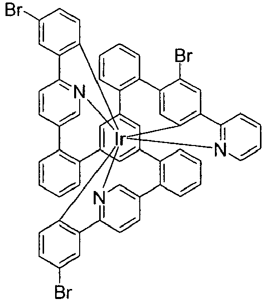 | 91 % |
| | Ir(L73) > Ir(L73-3Br) | |
| Ir(L96-3Br) | 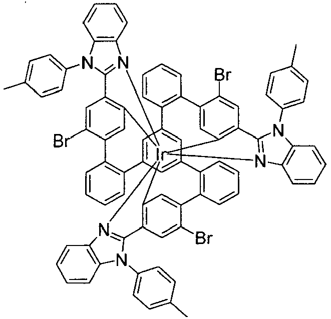 | 89 % |
| | Ir(L96) > Ir(L96-3Br) | |
| Ir(L100-3Br) | 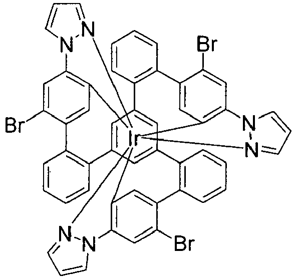 | 87 % |
| | Ir(L100) > Ir(L100-3Br) | |
| Ir(L101-3Br) | 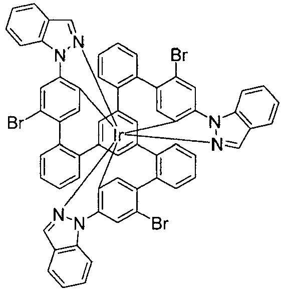 | 46 % |
| | Ir(L101) > Ir(L101-3Br) | |
| Ir(L107-3Br) | 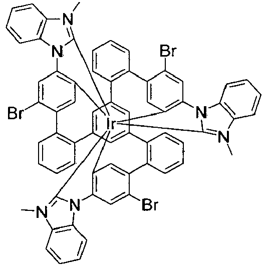 | 67 % |
| | Ir(L107) > Ir(L107-3Br) | |
| | Chromatographie an Kieselgel | |
| Ir(L111-3Br) | 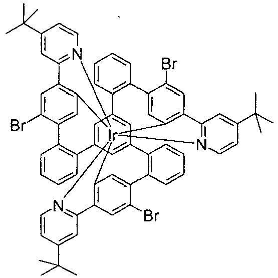 | 96% |
| | Ir(L111) > Ir(L111-3Br) | |
| Ir(L116-3Br) | 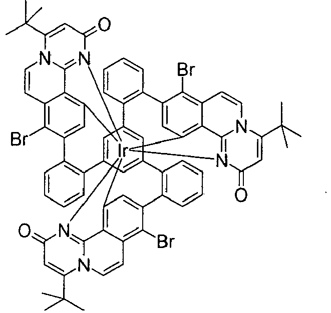 | 95 % |
| | Ir(L116) > Ir(116-3Br) | |
| Ir(L120-3Br) | 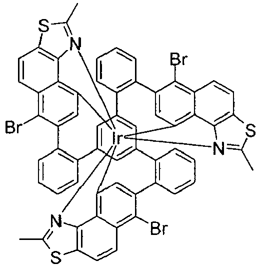 | 90 % |
| | Ir(L120) > Ir(L120-3Br) | |
| Ir123-3Br | 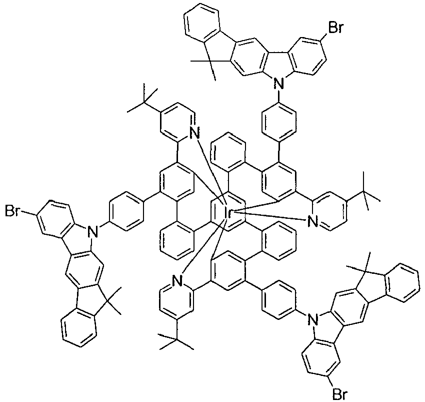 | 92 % |
| | Ir123 > Ir123-3Br | |
| | Einsatz von 4.15 mmol NBS | |
| | Zusatz von 2 ml Hydrazin Hydrat zum MeOH | |
| Ir(L203-3Br) | 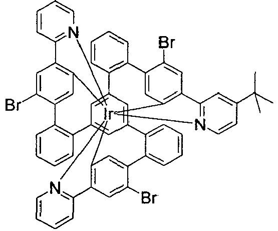 | 95 % |
| | Ir(L203) > Ir(L203-3Br) | |
| Ir(L204-3Br) | 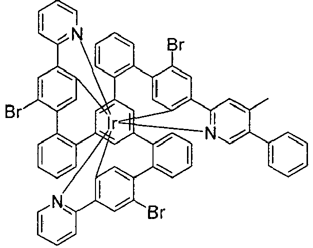 | 96 % |
| | Ir(L204) > Ir(L204-3Br) | |
| Ir(L205-3Br) | 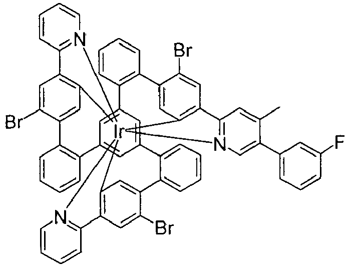 | 94 % |
| | Ir(L205) > Ir(L205-3Br) | |
| Ir(L212-3Br) | 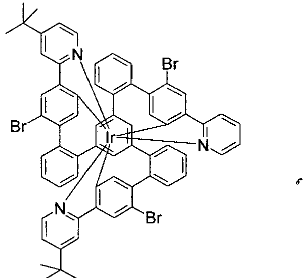 | 96 % |
| | Ir(L212) > Ir(L212-3Br) | |
| Ir(L213-3Br) | 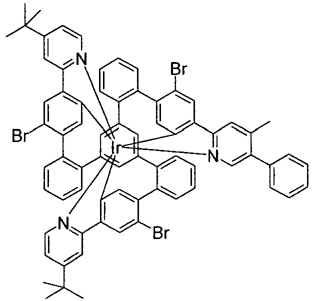 | 95 % |
| | Ir(L213) > Ir(L213-3Br) | |
| Ir(L216-3Br) | 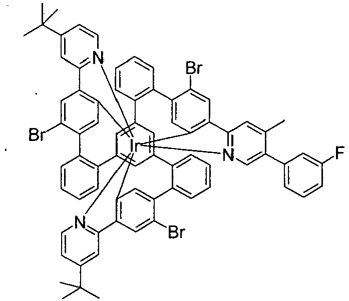 | 95 % |
| | Ir(L216) > Ir(L216-3Br) | |
| Ir(L218-3Br) | 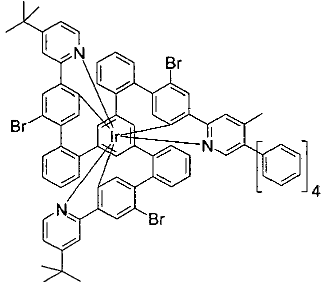 | 95 % |
| | Ir(L218) > Ir(L218-3Br) | |
| Ir150-3Br | 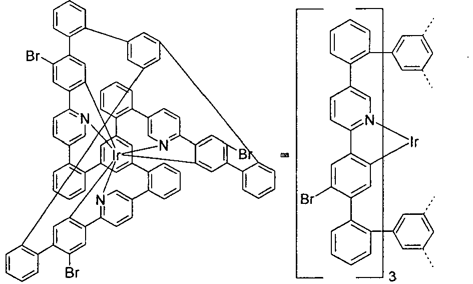 | 96 % |
| | Ir150 > Ir150-3Br | |

| | Dibromierung | |
|---|---|---|
| Ir(L2-2Br) | 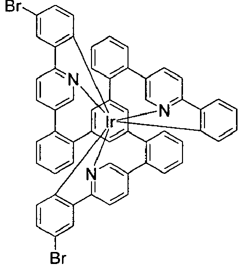 | 33 % |
| | Ir(L2) > Ir(L2-2Br) | |
| Ir(L39-2Br) | 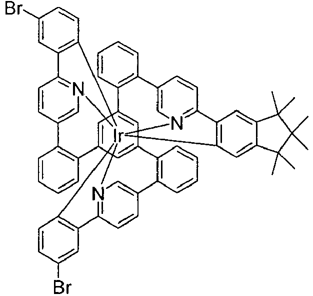 | 63 % |
| | Ir(L39) > Ir(L39-2Br) | |
| Ir(L44-2Br) | 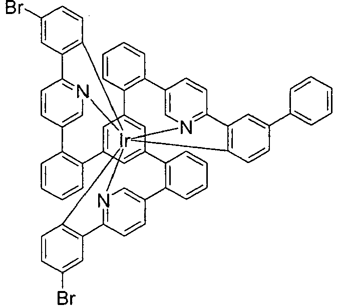 | 62 % |
| | Ir(L44) > Ir(L44-2Br) | |
| Ir(L49-2Br) | 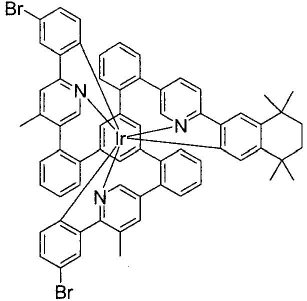 | 67 % |
| | Ir(L49) > Ir(L49-2Br) | |
| Ir(L71-2Br) | 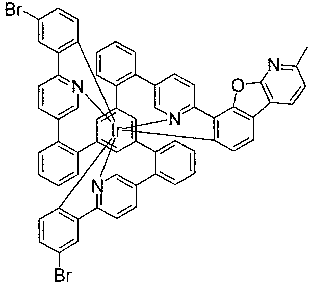 | 96 % |
| | Ir(L71) > Ir(L71-2Br) | |
| Ir(L220-2Br) | 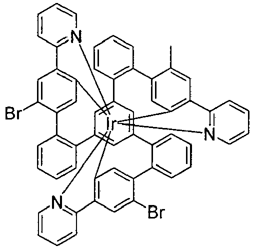 | 95 % |
| | Ir(L220) > Ir(L220-2Br) | |
| | Lösungsmittel DMSO | |

| | Monobromierung | |
|---|---|---|
| Ir(L2-Br) | 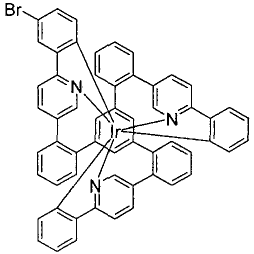 | 24 % |
| | Ir(L2) > Ir(L2-Br) | |
| | Lösungsmittel DMSO | |
| Ir(L40-Br) | 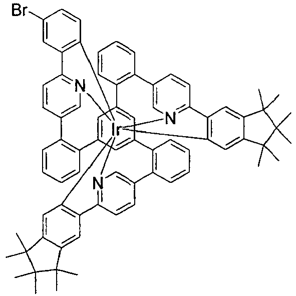 | 64 % |
| | Ir(L40) > Ir(L40-Br) | |
| Ir(L206-Br) | 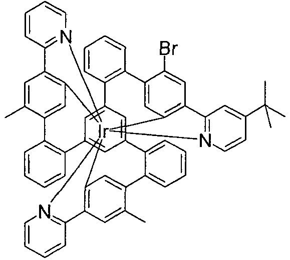 | 93 % |
| | Ir(L206) > Ir(L206-Br) | |
| | Einsatz von 2.1 mmol NBS | |
| | Zusatz von 2 ml Hydrazin Hydrat zum MeOH | |
| Ir(L207-Br) | 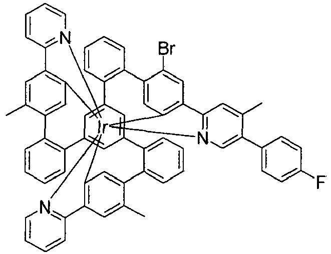 | 94 % |
| | Ir(L207) > Ir(L207-Br) | |
| | Einsatz von 2.1 mmol NBS | |
| | Zusatz von 2 ml Hydrazin Hydrat zum MeOH | |
| Ir(L208-Br) | 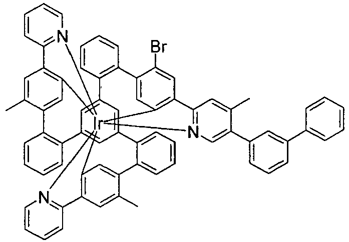 | 89 % |
| | Ir(L208) > Ir(L208-Br) | |
| | Einsatz von 2.1 mmol NBS | |
| | Zusatz von 2 ml Hydrazin Hydrat zum MeOH | |

### 2) Suzuki-Kupplung an den bromierten Iridium-Komplexen:

### Variante A, zweiphasige Reaktionsmischung:

Eine Suspension von 10 mmol eines bromierten Komplexes, 12-20 mmol Boronsäure bzw. Boronsäureester pro Br-Funktion und 40 - 80 mmol Trikaliumphosphat in einem Gemisch aus 300 ml Toluol, 100 ml Dioxan und 300 ml Wasser wird mit 0.6 mmol Tri-o-tolylphosphin und dann mit 0.1 mmol Palladium(ll)acetat versetzt und 16 h unter Rückfluss erhitzt. Nach Erkalten gibt man 500 ml Wasser und 200 ml Toluol zu, trennt die wässrige Phase ab, wäscht die organische Phase dreimal mit 200 ml Wasser, einmal mit 200 ml gesättigter Kochsalzlösung und trocknet über Magnesiumsulfat. Man filtriert über ein Celite-Bett ab, wäscht dieses mit Toluol nach, entfernt das Toluol fast vollständig im Vakuum, gibt 300 ml Methanol zu, saugt vom ausgefallenen Rohprodukt ab, wäscht dieses dreimal mit je 50 ml Methanol und trocknet im Vakuum. Das Rohprodukt wird an Kieselgel gesäult. Der Metallkomplex wird abschließend getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Variante B, einphasige Reaktionsmischung:

Eine Suspension von 10 mmol eines bromierten Komplexes, 12-20 mmol Boronsäure bzw. Boronsäureester pro Br-Funktion und 60 - 100 mmol der Base (Kaliumfluorid, Trikaliumphosphat (wasserfrei oder Monohydrat oder Trihydrat), Kaliumcarbonat, Cäsiumcarbonat etc.) und 100 g Glaskugeln (3 mm Durchmesser) in 100 ml - 500 ml eines aprotischen Lösungsmittels (THF, Dioxan, Xylol, Mesitylen, Dimethylacetamid, NMP, DMSO, etc.) wird mit 0.6 mmol Tri-o-tolylphosphin und dann mit 0.1 mmol Palladium(ll)acetat versetzt und 1 - 24 h unter Rückfluss erhitzt. Alternativ können andere Phosphine wie Triphenylphosphin, Tri-tert-butylphosphin, Sphos, Xphos, RuPhos, XanthPhos, etc. eingesetzt werden, wobei bei diesen Phosphinen das bevorzugte Phosphin:Palladium Verhältnis 3:1 bis 1.2:1 beträgt. Man entfernt das Lösungsmittel im Vakuum, nimmt das Produkt in einem geeigneten Lösungsmittel (Toluol, Dichlormethan, Ethylacetat, etc.) auf und reinigt wie unter Variante A beschrieben.

### Synthese von Ir100:

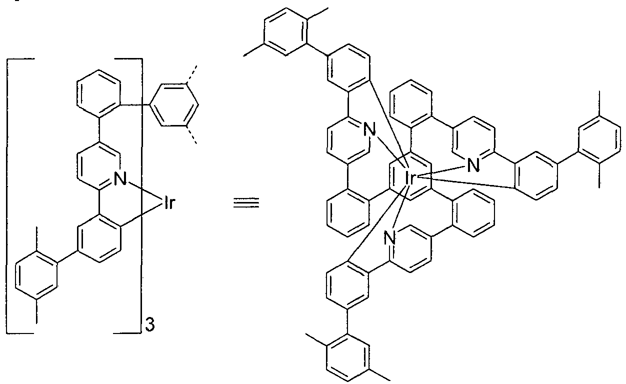

### Variante A:

Einsatz von 11.9 g (10.0 mmol) Ir(L2-3Br) und 9.0 g (60.0 mmol) 2,5-Dimethyl-phenylboronsäure [85199-06-0], 17.7 g (60 mmol) Trikaliumphosphat (wasserfrei), 183 mg (0.6 mmol) Tri-o-tolylphosphin [6163-58-2], 23 mg (0.1 mmol) Palladium(II)acetat, 300 ml Toluol, 100 ml Dioxan und 300 ml Wasser, Rückfluss, 16 h. Zweimalige chromatographische Trennung an Kieselgel mit Toluol/Ethylacetat (9:1, vv), anschließend fünfmalige Heißextraktion mit Ethylacetat/Dichlormethan (1:1, vv). Ausbeute: 6.8 g (5.7 mmol) 57 %; Reinheit: ca. 99.9 %ig nach HPLC.

Analog können folgende Verbindungen dargestellt werden:

| Bsp. | Bromid / Boronsäure / Variante | Ausbeute |
|---|---|---|
| | Produkt | |
| Ir101 | Ir(14-3Br) / 5122-95-2 | 61 % |
| | A | |
| | 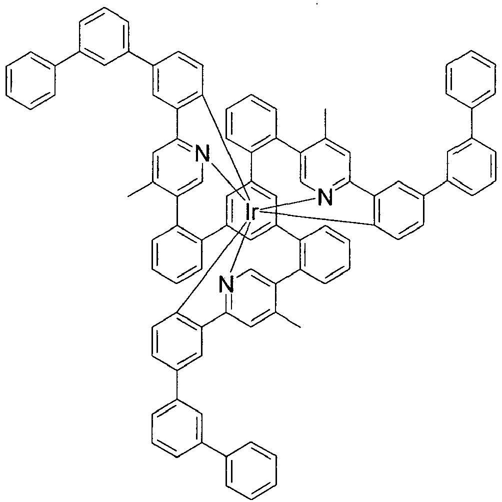 | |
| Ir102 | Ir(L20-3Br) / 1233200-59-3 | 53 % |
| | A | |
| | 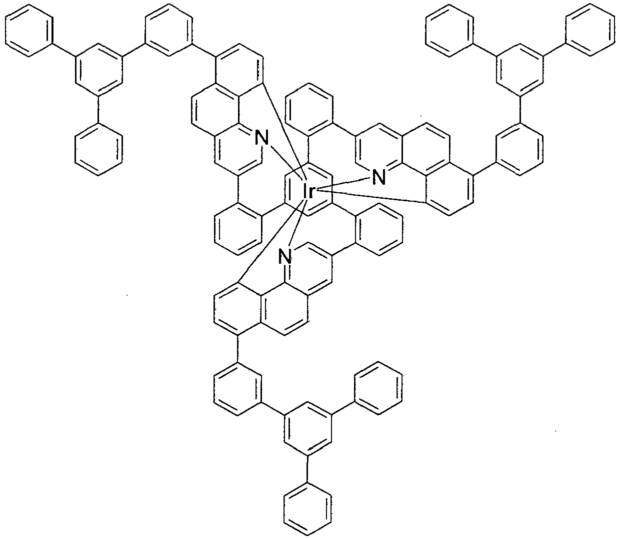 | |
| Ir103 | Ir(L22-3Br) / 100379-00-8 / B | 41 % |
| | SPhos:Pd(ac)₂ / 2:1 / Cs₂CO₃ / Dioxan | |
| | chromatographische Trennung mit Tol/DCM (8:2 vv) | |
| | 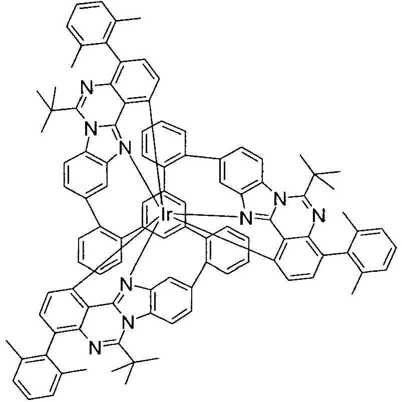 | |
| Ir104 | Ir(L27-3Br) / 84110-40-7 / B | 66 % |
| | SPhos:Pd(ac)₂ / 2:1 / K₃PO₄ * 3H₂O | |
| | Toluol / chromatographische Trennung mit Toluol | |
| | 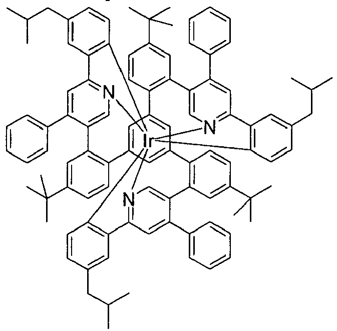 | |
| Ir105 | Ir(L39-2Br) / 100124-06-9 / A | 55 % |
| | 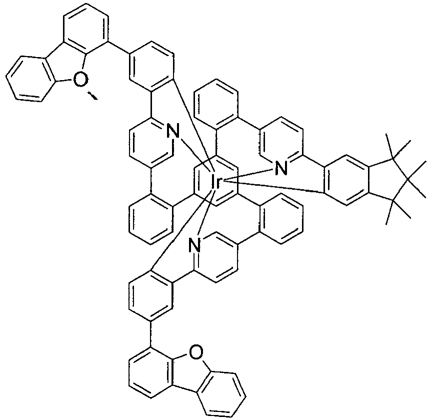 | |
| Ir106 | Ir(L44-2Br) / 162607-19-4 / A | 46 % |
| | 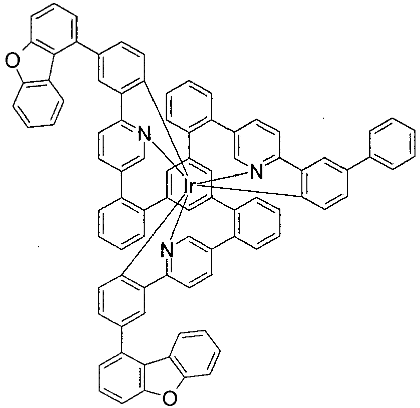 | |
| Ir107 | Ir(L40-Br) / 854952-58-2 / A | 62 % |
| | 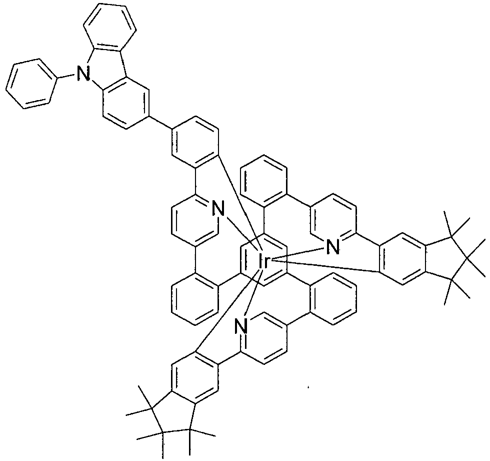 | |
| Ir108 | Ir(L73-3Br) / 98-80-6 / A | 47 % |
| | 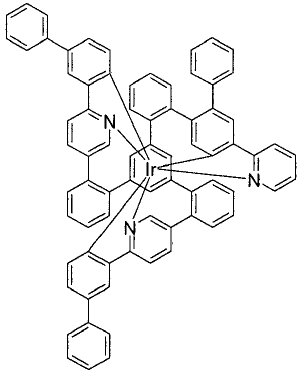 | |
| Ir109 | Ir(L2-3Br) / 1233200-59-3 / A | 57 % |
| | 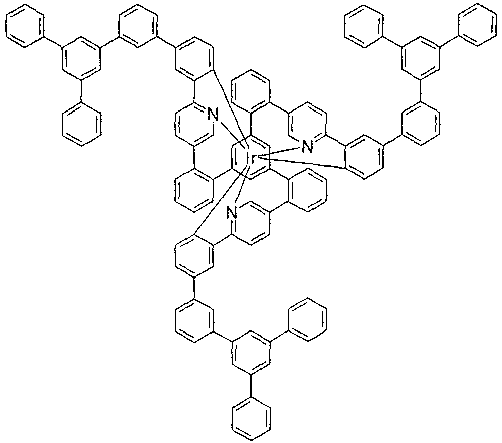 | |
| Ir110 | Ir(L72-3Br) / 5122-95-2 / B | 55 % |
| | 9 mol % Pd(PPh₃)₄/ K₃PO₄ x 1 H₂O / DMSO / 80 °C / 60 h | |
| | chromatographische Reinigung mit DCM | |
| | und 8 x Heißextraktion mit Ethylacetat | |
| | 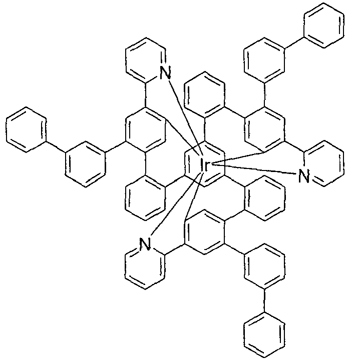 | |
| | Trennung der Δ- und Λ-Enatiomere siehe 14) | |
| Ir111 | Ir(L72-3Br) / 1421789-05-0 / Bedingungen wie Ir110 | 46 % |
| | 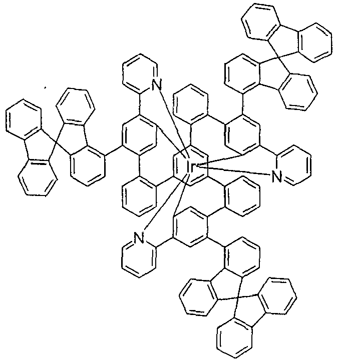 | |
| Ir112 | IrL72-3Br / 162607-19-4 / Bedingungen wie Ir110 | 53 % |
| | 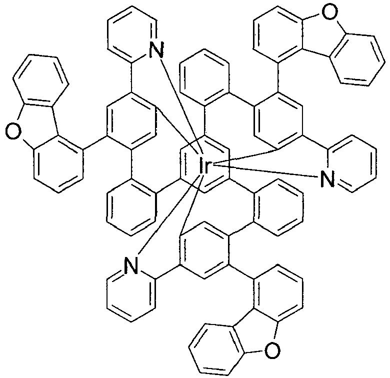 | |
| Ir113 | Ir(L72-3Br) / 100124-06-9 / Bedingungen wie Ir110 | 55 % |
| | 3 x Heißextraktion mit Butylacetat / 3 x Heißextraktion mit Toluol | |
| | 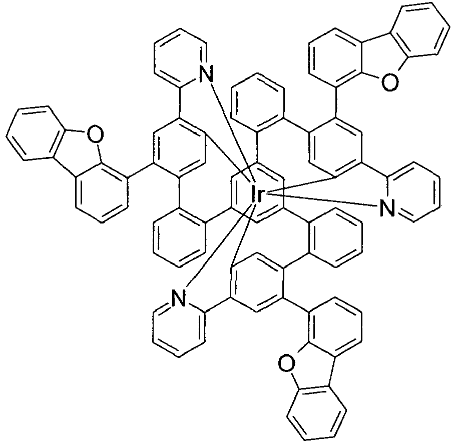 | |
| Ir114 | Ir(L72-3Br) / 100379-00-8 / Bedingungen wie Ir110 | 50 % |
| | Heißextraktion mit Toluol | |
| | 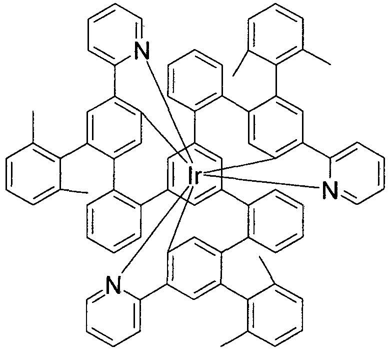 | |
| Ir115 | Ir(L72-3Br) / 1703019-86-6 / Bedingungen wie Ir110 | 49 % |
| | Heißextraktion mit Toluol | |
| | 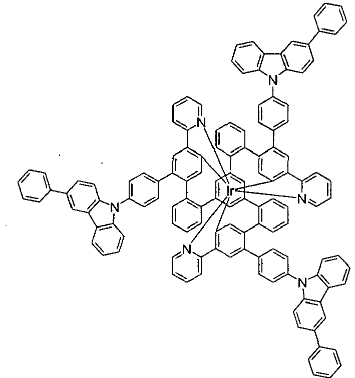 | |
| Ir116 | Ir(L111-3Br) / 5122-95-2 / A | 52 % |
| | chrom. Reinigung mit DCM / 5 x Heißextraktion mit Ethylacetat | |
| | 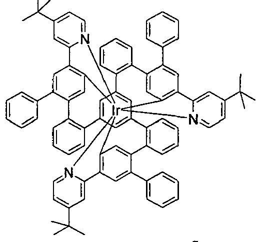 | |
| | fraktionierte Sublimation: p ca. 10⁻⁵ mbar / T ca. 390 °C | |
| Ir117 | Ir(L111-3Br) / 162607-19-4 / Bedingungen wie Ir116 | 43 % |
| | 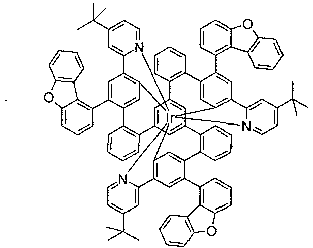 | |
| Ir118 | Ir(L111-3Br) / 100124-06-9 / Bedingungen wie Ir116 | 61 % |
| | 5 x Heißextraktion mit Toluol | |
| | 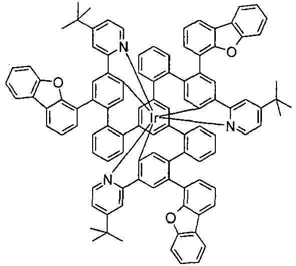 | |
| Ir119 | Ir(L111-3Br) / 100379-00-8 / Bedingungen wie Ir110 | 46 % |
| | 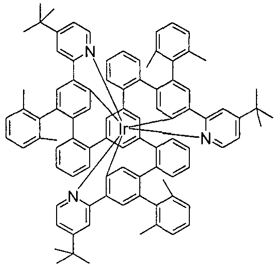 | |
| Ir120 | Ir(L72-3Br) / 236389-21-2 / Bedingungen wie Ir116 | 59 % |
| | 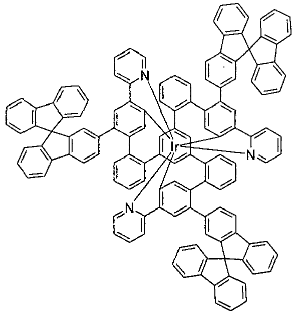 | |
| Ir121 | Ir(L111-3Br) / 419536-33-7 / Bedingungen wie Ir116 | 67 % |
| | 5 x Heißextraktion mit Toluol | |
| | 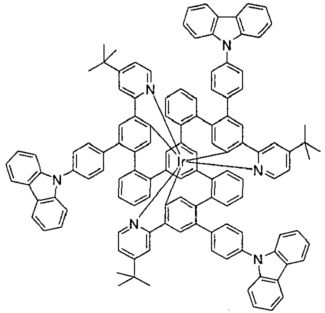 | |
| Ir122 | Ir(L111-3Br) / 854952-58-2 / Bedingungen wie Ir116 | 51 % |
| | 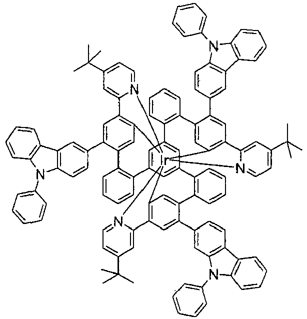 | |
| Ir123 | Ir(L111-3Br) / 1357066-50-2 / Bedingungen wie Ir116 | 71 % |
| | 5 x Heißextraktion mit Toluol | |
| | 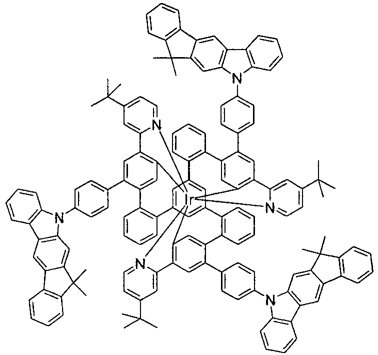 | |
| Ir124 | Ir(L111-3Br) / 1313018-07-3 / Bedingungen wie Ir116 | 68 % |
| | 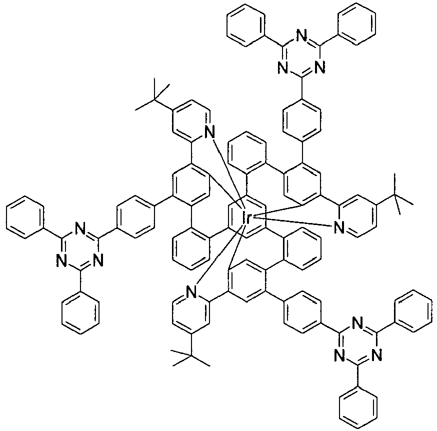 | |
| Ir126 | Ir123-3Br / 98-80-6 / Bedingungen wie Ir116 | 50 % |
| | 8 x Heißextraktion mit Butylacetat/Toluol 2:1, vv | |
| | 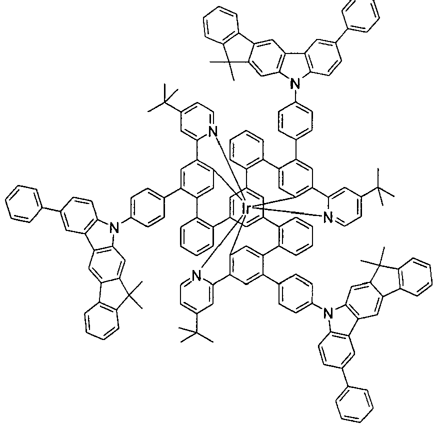 | |
| Ir127 | Ir123-3Br 5122-95-2 / Bedingungen wie Ir116 | 55 % |
| | 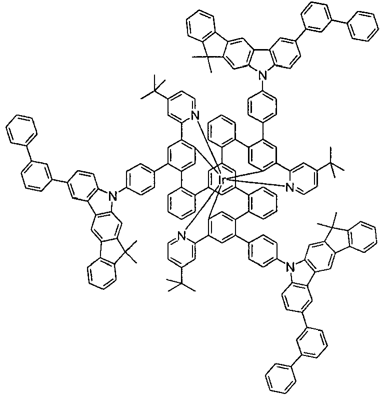 | |
| Ir128 | Ir123-3Br / 100124-06-9 / Bedingungen wie Ir116 | 63 % |
| | 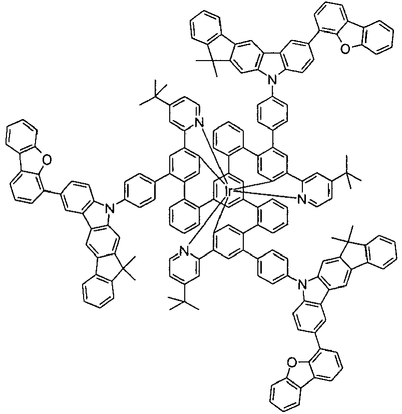 | |
| Ir129 | Ir123-3Br / 854952-58-2 / Bedingungen wie Ir116 | 59 % |
| | 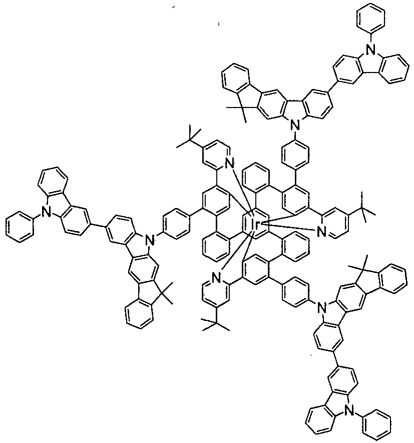 | |
| Ir131 | Ir(L72-3Br) / 1233200-59-3 / Bedingungen wie Ir110 | 51 % |
| | 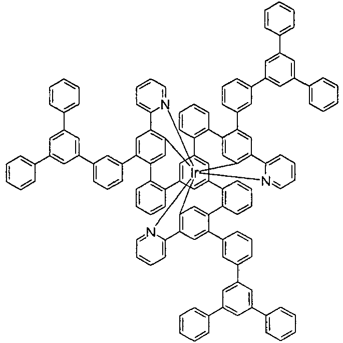 | |
| Ir132 | Ir(L111-3Br) / 1233200-59-3 / Bedingungen wie Ir116 | 54 % |
| | 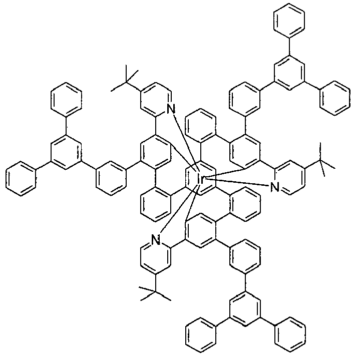 | |
| Ir133 | Ir(L71-2Br) / 1233200-59-3 / Bedingungen wie Ir116 | 60 % |
| | 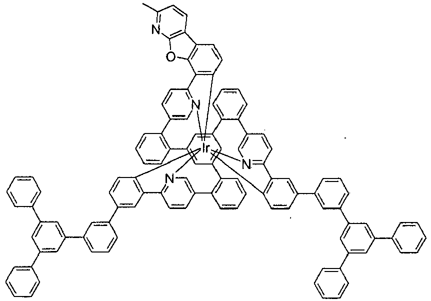 | |
| Ir134 | Ir(L203-3Br) / 333432-28-3 / Bedingungen wie Ir116 | 57 % |
| | 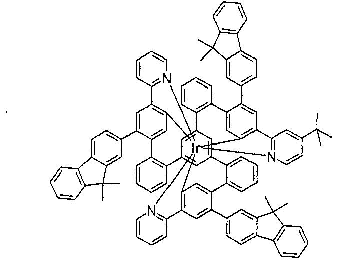 | |
| Ir135 | Ir(L204-3Br) / 1680179-22-9 / Bedingungen wie Ir116 | 62 % |
| | 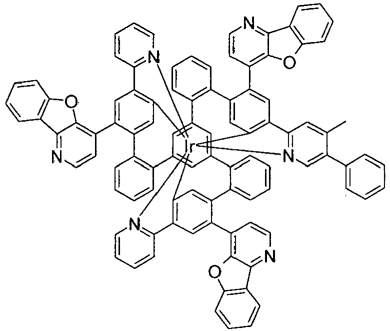 | |
| Ir136 | Ir(L205-3Br) / 5122-95-2 / Bedingungen wie Ir116 | 59 % |
| | 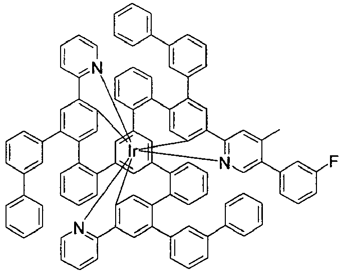 | |
| Ir137 | Ir(L206-Br) / 5122-95-2 / Bedingungen wie Ir116 | 61 % |
| | 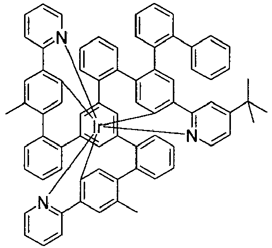 | |
| Ir138 | Ir(L207-Br) / 1357066-50-2 / Bedingungen wie Ir116 | 58 % |
| | 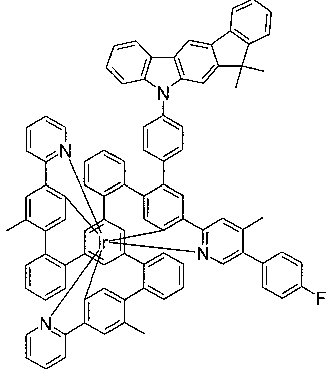 | |
| Ir139 | Ir(L208-Br) / 1369587-64-3 / Bedingungen wie Ir116 | 53 % |
| | 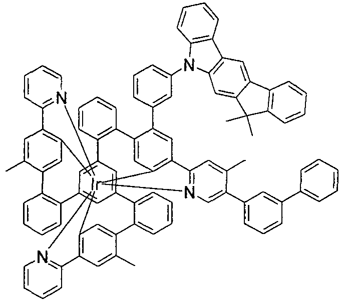 | |
| Ir140 | Ir(L212-3Br) / 1212021-54-9 / Bedingungen wie Ir116 | 68 % |
| | 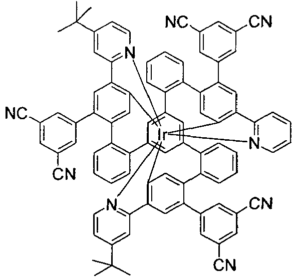 | |
| Ir141 | Ir(L213-Br) / 1106676-79-2 / Bedingungen wie Ir116 | 55 % |
| | 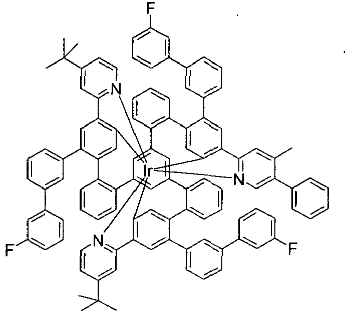 | |
| Ir142 | Ir(L216-Br) / 1259025-43-8 / Bedingungen wie Ir116 | 57 % |
| | 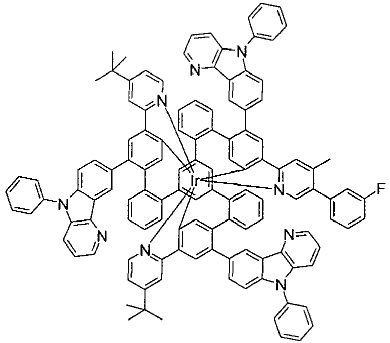 | |
| Ir143 | Ir(L218-3Br) / 153624-42-1 / Bedingungen wie Ir116 | 48 % |
| | 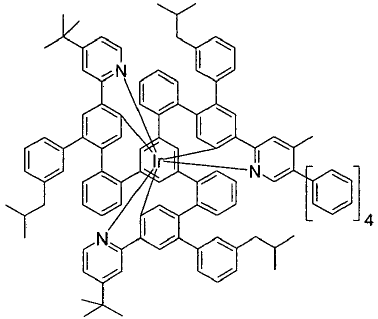 | |
| Ir144 | Ir(L111-3Br) / 374538-03-1 / B | 55 % |
| | 6 mol % Pd(PPh₃)₄ / K₃PO₄ x 1 H₂O / DMSO / 100 °C / 40 h | |
| | chromatographische Reinigung mit DCM | |
| | 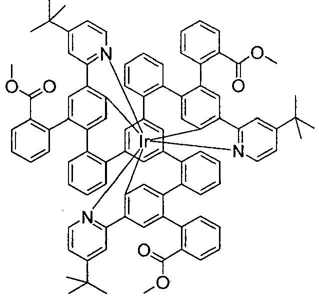 | |
| Ir145 | Ir(L220-2Br) / 374538-03-1 / wie Ir144 | 61 % |
| | 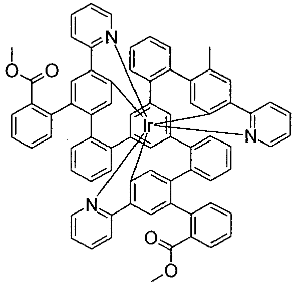 | |
| Ir146 | Ir(L220-2Br) / 98-80-6 / wie Ir144 | 65 % |
| | 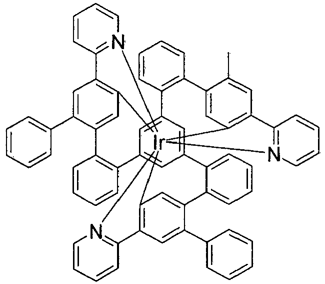 | |
| Ir151 | Ir150-3Br / 5122-95-2 / B | 60 % |
| | 9 mol % Pd(PPh₃)₄ / K₃PO₄ x 1 H₂O / DMSO / 80 °C / 60 h | |
| | chrom. Reinigung mit DCM / und 5 x Heißextraktion mit Butylacetat | |
| | 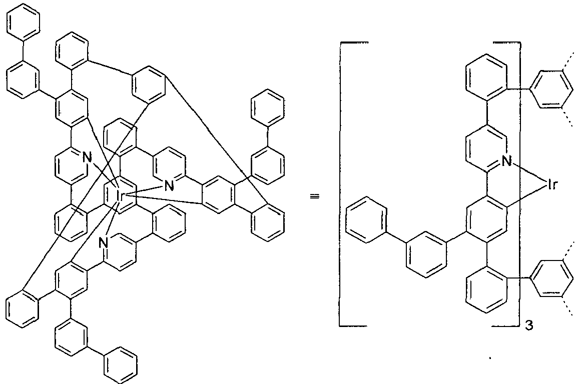 | |
| Ir152 | Ir(L101-3Br) / 5122-95-2 / A | 42 % |
| | 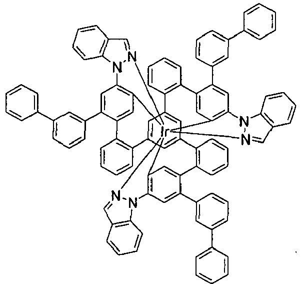 | |
| Ir153 | Ir(L107-3Br) / 333432-28-3 / Bedingungen wie Ir151 | 66 % |
| | 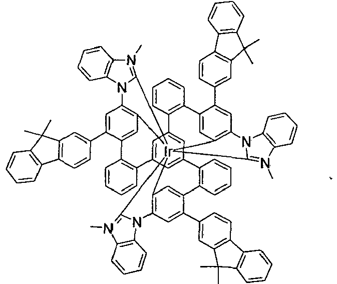 | |
| Ir154 | Ir(L120-3Br) / 153624-42-1 / Bedingungen wie Ir151 | 55 % |
| | 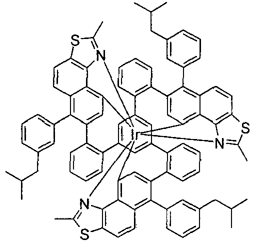 | |

### 3) Buchwald-Kupplung an den Ir-Komplexen

Ein Gemisch aus 10 mmol des bromierten Komplexes, 12-20 mmol des Diarylamins oder Carbazols pro Brom-Funktion, 1.1 molare Menge an Natrium-tert-butylat pro eingesetztem Amin bzw. 80 mmol Trikaliumphosphat (wasserfrei) bei Carbazolen, 100 g Glaskugeln (3 mm Durchmesser) und 300 - 500 ml Toluol bzw. o-Xylol bei Carbazolen wird mit 0.4 mmol Tri-tert-butylphosphin und dann mit 0.3 mmol Palladium(ll)acetat versetzt und unter gutem Rühren 16 - 30 h unter Rückfluss erhitzt. Nach Erkalten gibt man 500 ml Wasser zu, trennt die wässrige Phase ab, wäscht die organische Phase zweimal mit 200 ml Wasser, einmal mit 200 ml gesättigter Kochsalzlösung und trocknet über Magnesiumsulfat. Man filtriert über ein Celite-Bett ab, wäscht dieses mit Toluol bzw. o-Xylol nach, entfernt das Lösungsmittel fast vollständig im Vakuum, gibt 300 ml Ethanol zu, saugt vom ausgefallenen Rohprodukt ab, wäscht dieses dreimal mit je 50 ml EtOH und trocknet im Vakuum. Das Rohprodukt wird an Kieselgel chromatographisch oder durch Heißextraktion gereinigt. Der Metallkomplex wird abschließend getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Synthese von Ir200:

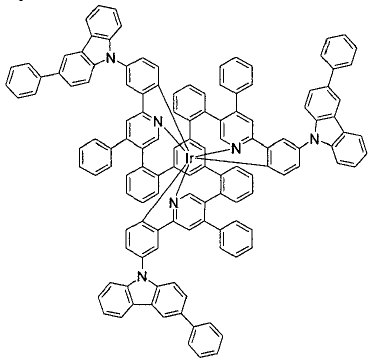

Einsatz von 14.2 g (10 mmol) Ir(L16-3Br) und 9.7 g (40 mmol) 3-Phenylcarbazol [103012-26-6]. Dreimalige Chromatographie mit Toluol an Kieselgel, tempern. Ausbeute: 6.5 g (3.4 mmol) 34 %; Reinheit: ca. 99.8 %ig nach HPLC.

Analog können folgende Verbindungen dargestellt werden:

| Bsp. | Edukt / Amin oder Carbazol Produkt | Ausbeute |
|---|---|---|
| Ir201 | Ir(L35-3Br) /n 1257220-47-5 | 39 % |
| | 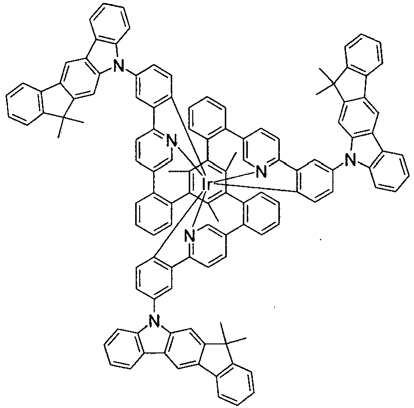 | |
| Ir202 | Ir(L49-2Br) / 1421789-16-3 | 67 % |
| | 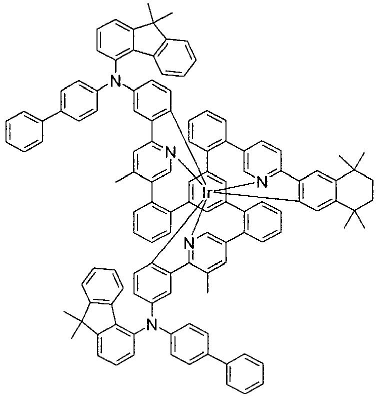 | |
| Ir203 | Ir(L111-3Br) / 103012-26-6 | 27 % |
| | Einsatz von PCy₃ statt P(t-Bu)₃ | |
| | 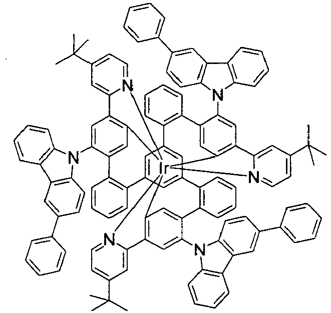 | |
| Ir204 | Ir(L111-3Br) / 1257220-47-5 | 23 % |
| | Einsatz von PCy₃ statt P(t-Bu)₃ | |
| | 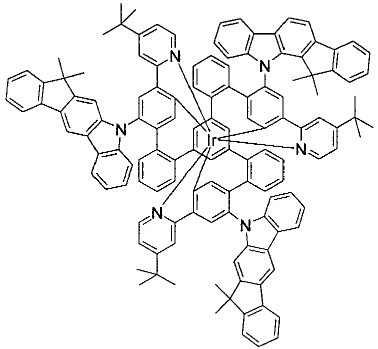 | |
| Ir205 | Ir150-3Br / 1257220-47-5 | 28 % |
| | Einsatz von PCy₃ statt P(t-Bu)₃ | |
| | 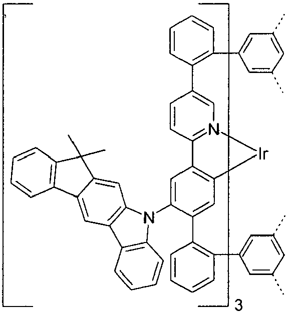 | |

### 4) Cyanierung der Iridium-Komplexe:

Ein Gemisch aus 10 mmol des bromierten Komplexes, 13 mmol Kupfer(I)-cyanid pro Brom-Funktion und 300 ml NMP wird 20 h bei 180 °C gerührt. Nach Erkalten entfernt man das Lösungsmittel im Vakuum, nimmt den Rückstand in 500 ml Dichlormethan auf, filtriert über Celite von den Kupfersalzen ab, engt das Dichlormethan im Vakuum fast bis zur Trockene ein, gibt 100 ml Ethanol zu, saugt vom ausgefallenen Feststoff ab, wäscht diesen zweimal mit je 50 ml Ethanol und trocknet im Vakuum. Das Rohprodukt wird durch Chromatographie und / oder Heißextraktion gereinigt. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Synthese von Ir300:

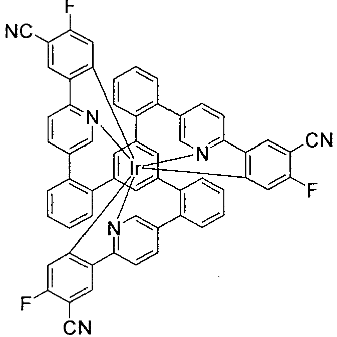

Einsatz von 12.4 g (10 mmol) Ir(L37-3Br) und 3.5 g (39) mmol) Kupfer(I)-cyanid. Zweimalige Chromatographie an Kieselgel mit Dichlormethan, Sublimation. Ausbeute: 5.6 g (4.9 mmol) 49 %; Reinheit: ca. 99.9 %ig nach HPLC.

Analog können folgende Verbindungen dargestellt werden:

| Bsp. | Edukt Cyanierungsprodukt | |
|---|---|---|
| Ir301 | 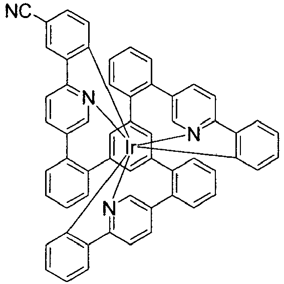 | 44 % |
| | Ir(L2-Br) | |
| Ir302 | 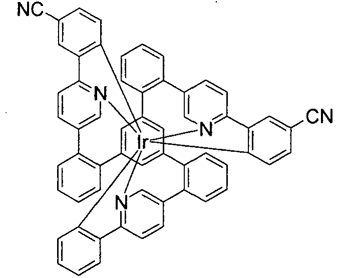 | 44 % |
| | Ir(L2-2Br) | |
| Ir303 | 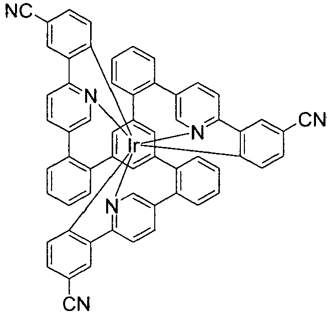 | 51 % |
| | Ir(L2-3Br) | |
| Ir304 | 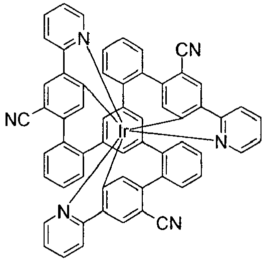 | 60 % |
| | Ir(L72-3Br) | |
| Ir305 | 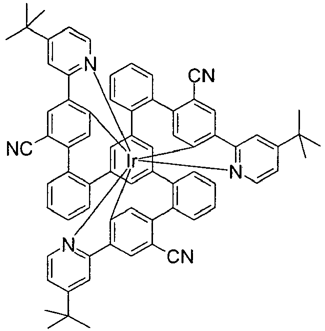 | 58 % |
| | Ir(L111-3Br) | |
| Ir306 | 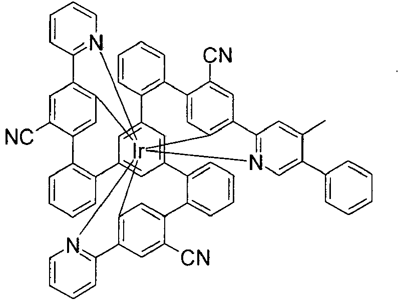 | 62 % |
| | Ir(L204-3Br) | |
| Ir307 | 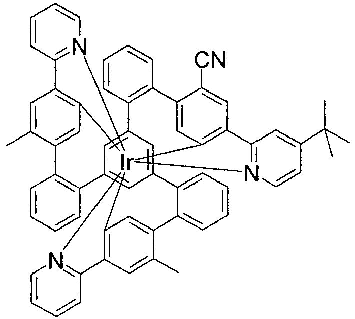 | 64 % |
| | Ir(L206-Br) | |
| Ir308 | 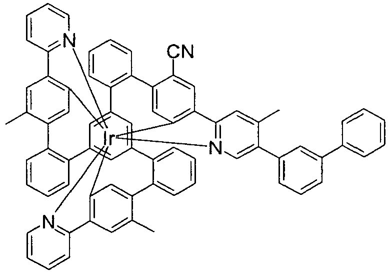 | 60 % |
| | Ir(L208-Br) | |
| Ir309 | 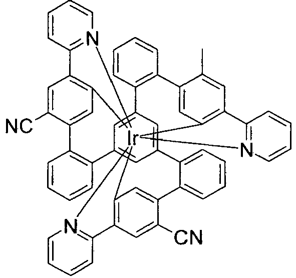 | 67 % |
| | Ir(L220-2Br) | |
| Ir310 | 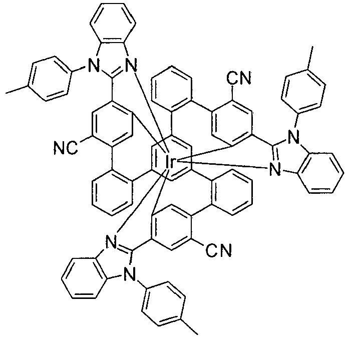 | 67 % |
| | Ir(L96-3Br) | |
| Ir311 | 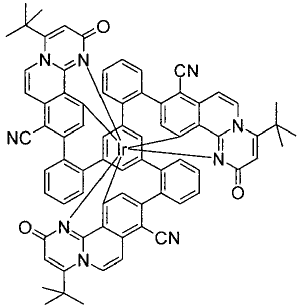 | 72 % |
| | Ir(L116-3Br) | |
| Ir312 | 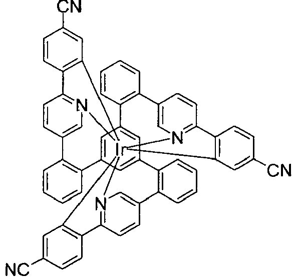 | 68 % |
| | Ir(L135) | |
| Ir313 | 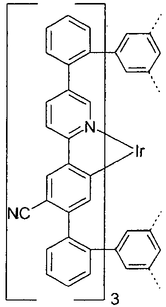 | 64 % |
| | Ir150-3Br | |

### 5) Borylierung der Iridium-Komplexe:

Ein Gemisch von 10 mmol des bromierten Komplexes, 12 mmol Bis-(pinacolato)diboran [73183-34-3] pro Brom-Funktion, 30 mmol Kaliumacetat, wasserfrei pro Bromfunktion, 0.2 mmol Tricyclohexylphosphin, 0.1 mmol Palladium(II)acetat und 300 ml Lösungsmittel (Dioxan, DMSO, NMP, Toluol, etc.) wird 4-16 h bei 80-160 °C gerührt. Nach Entfernen des Lösungsmittels im Vakuum wird der Rückstand in 300 ml Dichlormethan, THF oder Ethylacetat aufgenommen, über ein Celite-Bett filtriert, das Filtrat wird bis zur beginnenden Kristallisation im Vakuum eingeengt und abschließend noch tropfenweise mit ca. 100 ml Methanol versetzt, um die Kristallisation zu vervollständigen. Die Verbindungen können aus Dichlormethan, Ethylacetat oder THF unter Zusatz von Methanol umkristallisiert werden.

### Synthese von Ir400:

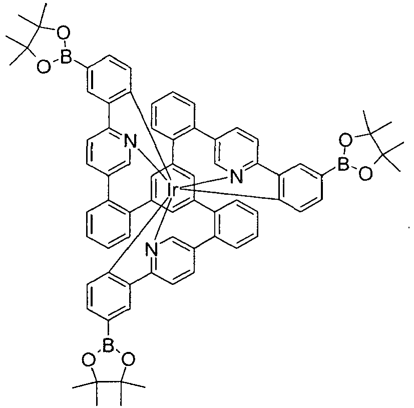

Einsatz von 11.9 g (10 mmol) Ir(L2-3Br) und 9.1 g (36 mmol) Bis(pinaco-lato)diboran [73183-34-3], Dioxan/Toluol 1:1 vv, 120 °C, 16 h, aufnehmen und Celite-Filtration in THF, Umkristallisation aus THF:Methanol. Ausbeute: 7.3 g (5.5 mmol) 55 %; Reinheit: ca. 99.8 %ig nach HPLC.

Analog können folgende Verbindungen dargestellt werden:

| Bsp. | Produkt Edukt | Ausbeute |
|---|---|---|
| Ir401 | 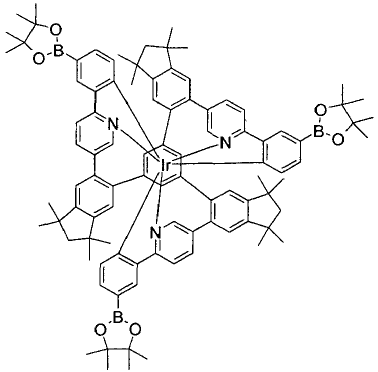 | 39 % |
| | Ir(L24-3Br) | |
| Ir402 | 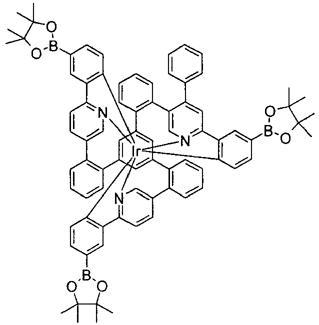 | 48 % |
| | Ir(L51-3Br) | |
| Ir403 | 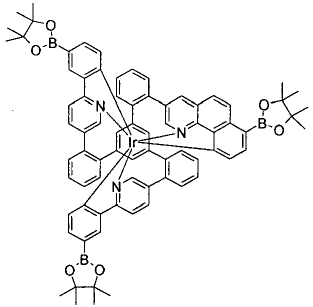 | 55 % |
| | Ir(L55-3Br) | |
| Ir404 | 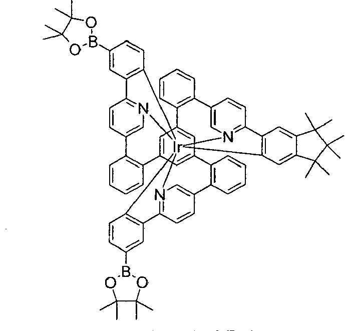 | 63 % |
| | Ir(L-39-2Br) | |
| Ir405 | 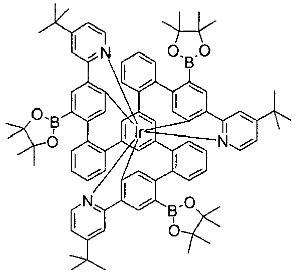 | 48 % |
| | Ir(L111-3Br) | |
| Ir406 | 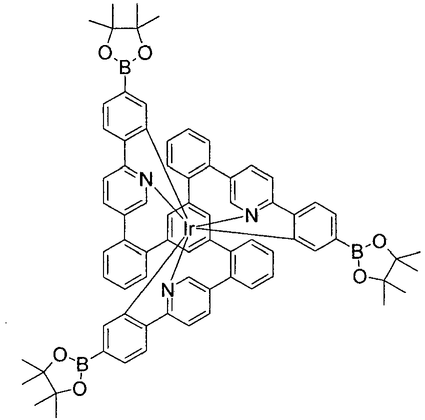 | 68 % |
| | Ir(L135) | |
| | Dioxan / DMSO | |
| Ir407 | 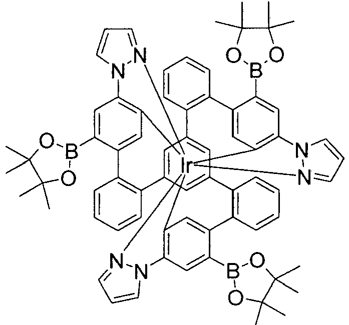 | 60 % |
| | Ir(L100-3Br) | |
| Ir408 | 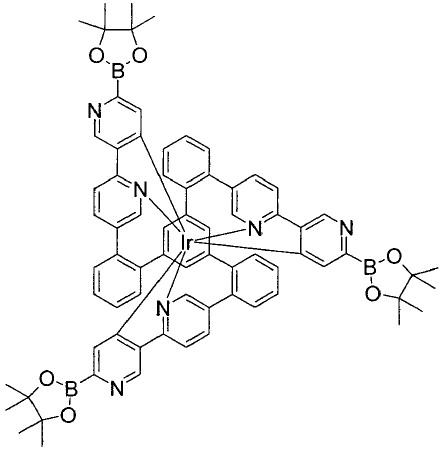 | 76 % |
| | Ir(L149) | |
| | Dioxan / DMSO | |

### 6) Suzuki-Kupplung an den borylierten Iridium-Komplexen: Variante A, zweiphasige Reaktionsmischung:

Eine Suspension von 10 mmol eines borylieren Komplexes, 12-20 mmol Arylbromid pro (RO)₂B-Funktion und 80 mmol Trikaliumphosphat in einem Gemisch aus 300 ml Toluol, 100 ml Dioxan und 300 ml Wasser wird mit 0:6 mmol Tri-o-tolylphosphin und dann mit 0.1 mmol Palladium(ll)acetat versetzt und 16 h unter Rückfluss erhitzt. Nach Erkalten gibt man 500 ml Wasser und 200 ml Toluol zu, trennt die wässrige Phase ab, wäscht die organische Phase dreimal mit 200 ml Wasser, einmal mit 200 ml gesättigter Kochsalzlösung und trocknet über Magnesiumsulfat. Man filtriert über ein Celite-Bett ab, wäscht dieses mit Toluol nach, entfernt das Toluol fast vollständig im Vakuum, gibt 300 ml Methanol zu, saugt vom ausgefallenen Rohprodukt ab, wäscht dieses dreimal mit je 50 ml Methanol und trocknet im Vakuum. Das Rohprodukt wird zweimal an Kieselgel gesäult und/oder durch Heißextraktion gereinigt. Der Metallkomplex wird abschließend getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Variante B, einphasige Reaktionsmischung:

Eine Suspension von 10 mmol eines borylieren Komplexes, 12-20 mmol Arylbromid pro (RO)₂B-Funktion und 60 - 100 mmol der Base (Kaliumfluorid, Trikaliumphosphat (wasserfrei, Monohydrat oder Trihydrat), Kaliumcarbonat, Cäsiumcarbonat etc.) und 100 g Glaskugeln (3 mm Durchmesser) in 100 ml - 500 ml eines aprotischen Lösungsmittels (THF, Dioxan, Xylol, Mesitylen, Dimethylacetamid, NMP, DMSO, etc.) wird mit 0.6 mmol Tri-o-tolylphosphin und dann mit 0.1 mmol Palladium(ll)acetat versetzt und 1 - 24 h unter Rückfluss erhitzt. Alternativ können andere Phosphine wie Triphenylphosphin, Tri-tert-butylphosphin, Sphos, Xphos, RuPhos, XanthPhos, etc. eingesetzt werden, wobei bei diesen Phosphinen das bevorzugte Phosphin:Palladium Verhältnis 3:1 bis 1.2:1 beträgt. Man entfernt das Lösungsmittel im Vakuum, nimmt das Produkt in einem geeigneten Lösungsmittel (Toluol, Dichlormethan, Ethylacetat, etc.) auf und reinigt wie unter Variante A beschrieben.

### Synthese von Ir100:

### Variante A:

Einsatz von 13.3 g (10.0 mmol) Ir400 und 7.4 g (40.0 mmol) 1-Brom-2,5-dimethylbenzol [553-94-6], 17.7 g (60 mmol) Trikaliumphosphat (wasserfrei), 183 mg (0.6 mmol) Tri-o-tolylphosphin [6163-58-2], 23 mg (0.1 mmol) Palladium(II)acetat, 300 ml Toluol, 100 ml Dioxan und 300 ml Wasser, 100 °C, 16 h. Zweimalige chromatographische Trennung an Kieselgel mit Toluol/Ethylacetat (9:1, vv). Ausbeute: 6.7 g (5.3 mmol) 53 %; Reinheit: ca. 99.9 %ig nach HPLC.

Analog können folgende Verbindungen dargestellt werden:

| Bsp. | Edukte / Katalysator / Variante / Base / Lösemittel Produkt | Ausbeute |
|---|---|---|
| Ir125 | Ir405 / 3842-55-5 / A | 39 % |
| | 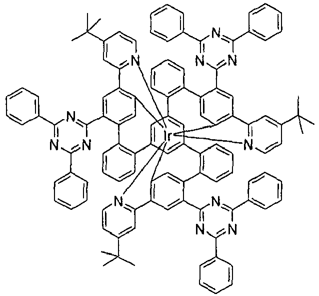 | |
| Ir130 | Ir405 / 1613576-58-1 / A | 35 % |
| | 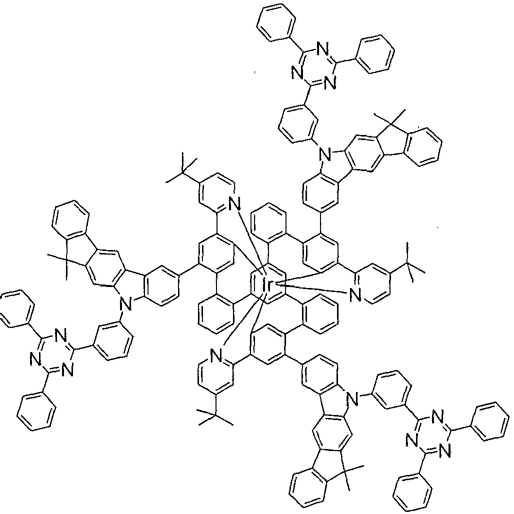 | |
| Ir147 | Ir406 / 50548-45-3 / B / S-Phos / Pd(ac)₂ / K₃PO₄ * H₂O / DMSO / 100 °C / 24 h | 58 % |
| | 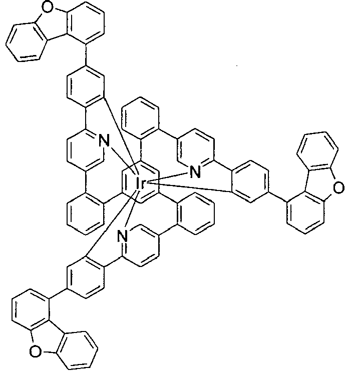 | |
| Ir148 | Ir406 / 1161009-88-6 / A | 63 % |
| | 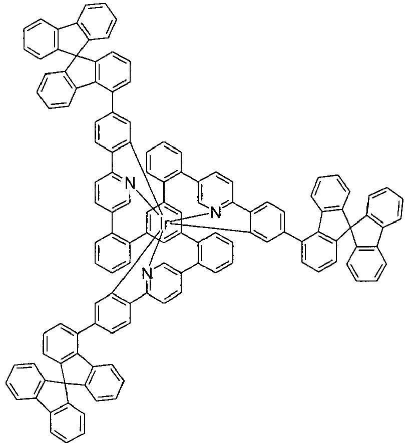 | |
| Ir149 | Ir406 / 160892-07-9 / A | 72 % |
| | 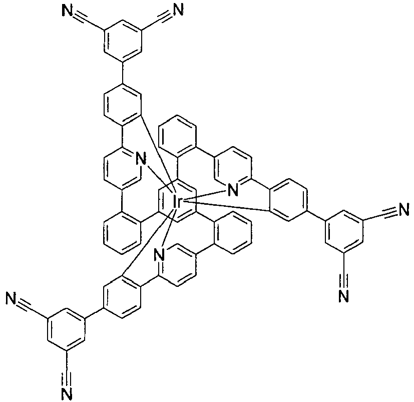 | |
| Ir150 | Ir406 / 380626-56-2 / A | 33 % |
| | 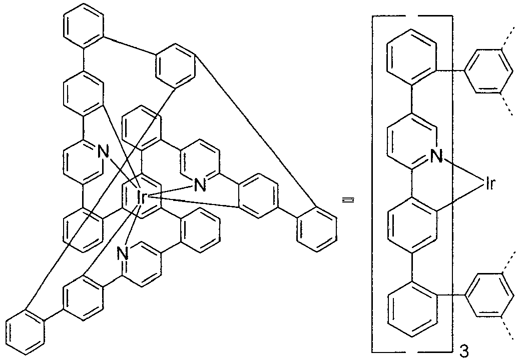 | |
| Ir155 | Ir407 / 73084-03-4 / A | 58 % |
| | 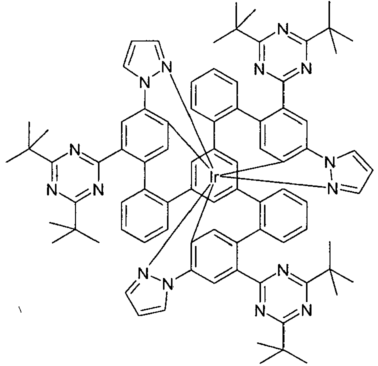 | |
| Ir156 | Ir407 / 253158-13-3 / B / K₃PO₄ x 3 H₂O/PPh₃ : Pd(ac)₂ (3:1) / DMSO 100 °C | 55 % |
| | 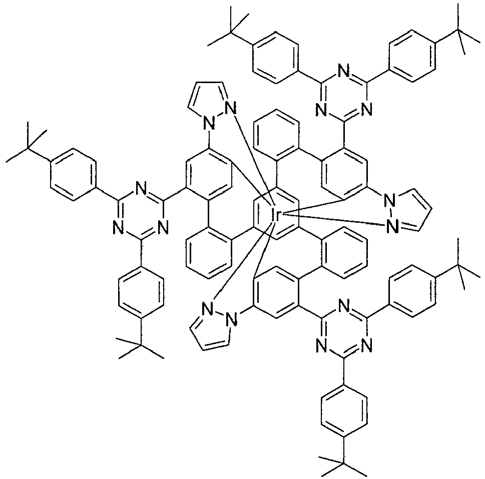 | |
| Ir157 | Ir408 / 380626-56-2 / A | 21 % |
| | 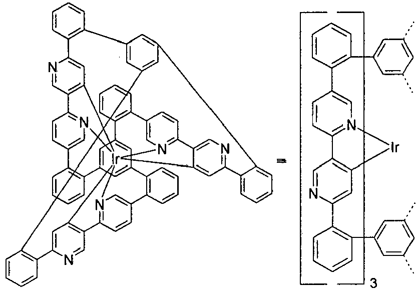 | |
| Ir158 | Ir408 / S46 / A | 27 % |
| | 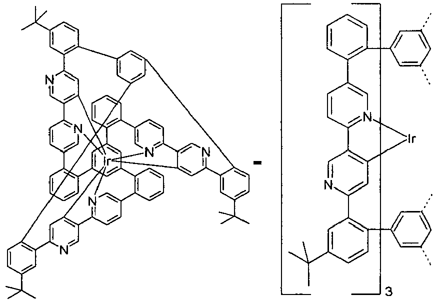 | |
| Ir159 | Ir408 / S665 / A | 25 % |
| | 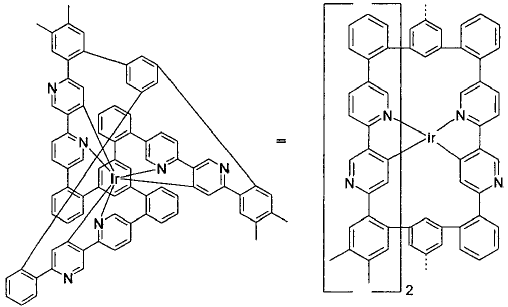 | |
| Ir160 | Ir408 / S666 / A | 23 % |
| | 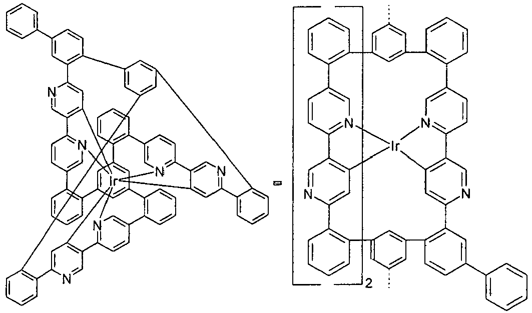 | |

### 7) Alkylierung an Iridium-Komplexen:

Eine Suspension von 10 mmol des Komplexes in 1500 ml THF wird mit 50 ml einer frisch bereiteten LDA-Lösung, 1 molar in THF versetzt und 24 h bei 25 °C nachgerührt. Dann gibt man unter gutem Rühren auf ein Mal 200 mmol des Alkylierungsmittels zu, wobei flüssige Alkylierungsmittel ohne Verdünnug, feste als Lösung in THF zugegeben werden. Man rührt 60 min. bei Raumtemperatur nach, entfernt das THF im Vakuum, und chromatographiert den Rückstand an Kieselgel. Die weitere Reiningung kann durch Heißextraktion - wie oben beschrieben - erfolgen. Der Metallkomplex wird abschließend getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Synthese von Ir700:

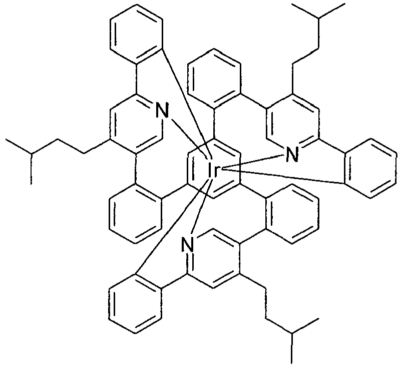

Einsatz von 9.8 g (10.0 mmol) Ir(L14) und 21.7 ml (200 mmol) 1-Brom-2-methyl-propan [78-77-3]. Zweimalige chromatographische Trennung an Kieselgel mit Toluol, anschließend fünfmalige Heißextraktion mit Acetonitril. Ausbeute: 2.7 g (2.3 mmol) 23 %; Reinheit: ca. 99.7 %ig nach HPLC.

Analog können folgende Verbindungen dargestellt werden:

| Bsp. | Edukt / Alkylierungsmittel Produkt | Ausbeute |
|---|---|---|
| Ir701 | Ir(L14) / 74-83-9 | 29 % |
| | 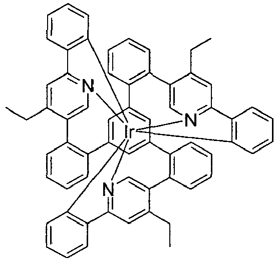 | |
| Ir702 | Ir(L14) / 630-17-1 | 27 % |
| | 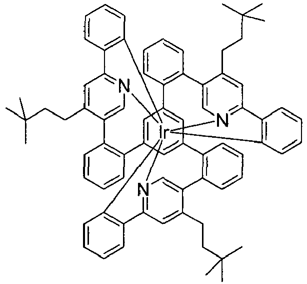 | |
| Ir703 | Ir(L14) / 100-39-0 | 34 % |
| | 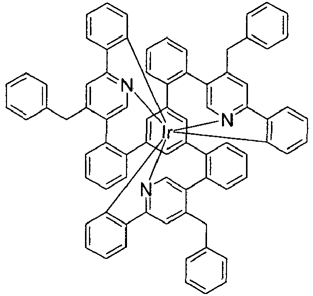 | |
| Ir704 | Ir(L52) / 108-85-0 | 35 % |
| | 1.6 eq LDA / 6.7 eq Alkylierungsmittel | |
| | 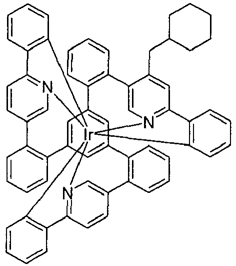 | |
| Ir705 | Ir701 / 74-83-9 | 26 % |
| | 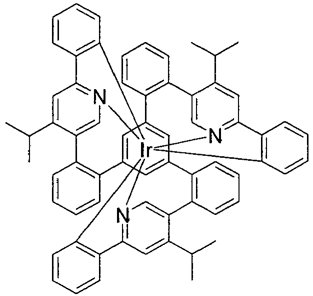 | |

### 8) Arylierung an Ir-Komplexen

### Synthese von Ir(L98):

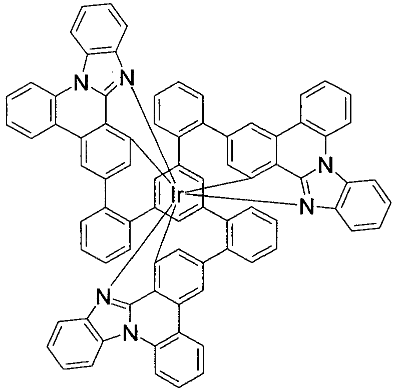

Eine Gemisch aus 10.7 g (10 mmol) Ir(L97), 14.2 g (60 mmol) o-Dibrombenzol [583-53-9], 39.1 g (120 mmol) Cäsiumcarbonat in 400 ml Dimethylacetamid (DMAC) wird mit 578.62 mg (1 mmol) Xanthphos [161265-03-8] und dann 1156 mg (1 mmol) Tetrakis-triphenylphospinopalladium(0) [14221-01-3] versetzt und 60 h unter Rückfluss gerührt. Nach Erkalten entfernt man 300 ml DMAC im Vakuum, verdünnt mit 1000 ml Methanol, rührt 1 h nach, saugt vom gelben FS ab, wäscht diesen mit 100 ml Methanol und trocknet im Vakuum. Man rührt den gelben Feststoff in einem Gemisch aus 200 ml Wasser und 100 ml Methanol heiß aus, saugt ab, wäscht mit Methanol nach und trocknet im Vakuum. Die weitere Reinigung erfolg wie in **"C: Synthese der Metallkomplexe"** beschrieben. Ausbeute: 6.9 g (5.3 mmol) 53 %; Reinheit: ca. 99.7 %ig nach HPLC.

Analog können folgende Verbindungen dargestellt werden:

| Bsp. | Edukt = Ir(L97) / Dibromaromat / Produkt | Ausbeute |
|---|---|---|
| Ir710 | 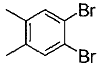 | 59 % |
| | 24932-48-7 | |
| | 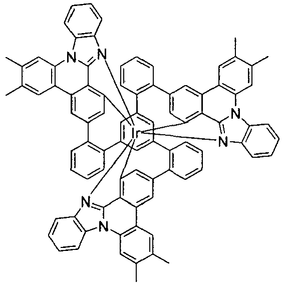 | |
| Ir711 | 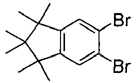 | 53 % |
| | 15411011-19-2 | |
| | 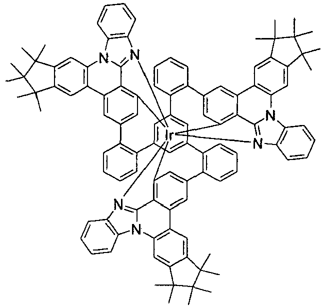 | |
| Ir712 | 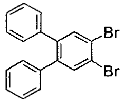 | 46 % |
| | 912922-63-5 | |
| | 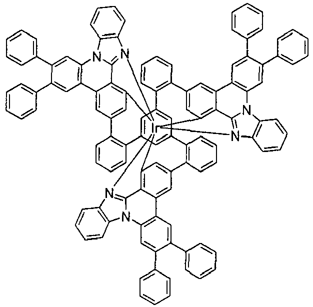 | |

### 9) Carbonyl-enthaltende Ir-KomplexeSynthese von Ir720:

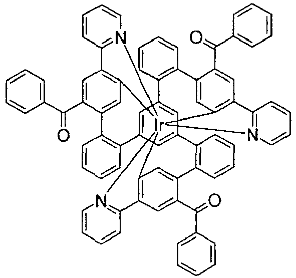

Eine Suspension von 10.3 g (10 mmol) Ir304 in 500 ml THF wird bei Raumtemperatur tropfenweise mit 60 ml einer 1 molaren Phenylmagnesiumbromid-Lösung in THF versetzt. Anschließend rührt man die Reaktionsmischung noch 2 h unter Rückfluss, lässt dann erkalten und quenscht durch tropfenweise Zugabe von 20 ml Methanol und 20 ml Wasser. Nach Entfernen des Lösungsmittels im Vakuum nimmt man den Rückstand in 300 ml N,N-Dimethylacetamid auf, fügt 20 ml wässrige 5 N HCl zu, kocht 12 h unter Rückfluß. Nach Entfernen des Lösungsmittels im Vakuum nimmt man den Rückstand in 500 ml Toluol auf, wäscht dreimal mit je 200 ml Wasser, einmal mit 200 ml ges. Natriumcarbonat-Lösung, einmal mit 200 ml ges. Natriumchloridlösung und trocknet dann über Magnesiumsulfat. Nach Entfernen des Lösungsmittels erfolgt die weitere Reinigung durch zweimalige chromatographische Trennung an Kieselgel mit DCM, anschließende fünfmalige Heißextraktion mit Toluol. Ausbeute: 4.8 g (3.8 mmol) 38 %; Reinheit: ca. 99.8 %ig nach HPLC.

Analog können folgende Verbindungen dargestellt werden:

| Bsp. | Edukt / Grignard-Verbindung / Produkt | Ausbeute |
|---|---|---|
| Ir721 | Ir305 / 103068-18-4 | 43 % |
| | 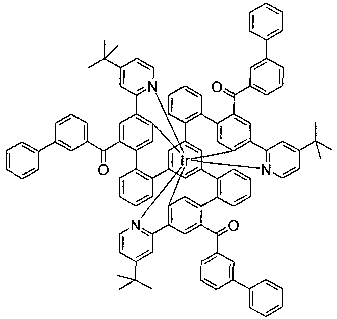 | |
| Ir722 | Ir308 / 20 mmol 1155294-76-0 | 63 % |
| | 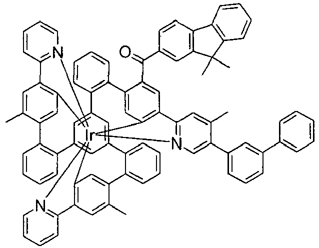 | |

### 10) Lactam-enthaltende Ir-Komplexe

### Synthese von Ir730:

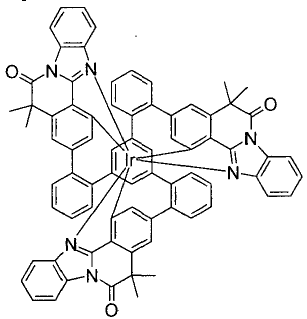

Eine Lösung von 10.7 g (10 mmol) Ir(L97) in 300 ml THF wird portrionsweise mit 1.2 g (50 mmol) Natriumhydrid versetzt. Nach 10 min. rühren bei Raumtemperatur tropft man unter Eiskühlung 3.8 ml (40 mmol) Methacylsäurechlorid [920-46-7] in 50 ml THF zu. Man lässt auf Raumtemperatur erwärmen und rührt 12 h nach. Nach Entfernen das Lösungsmittels im Vakuum nimmt man den Rückstand in 100 ml Methanol auf, rührt 30 min. nach, saugt vom ausgefallenen Feststoff ab, wäscht diesen dreimal mit 50 ml Methanol nach und trocknet im Vakuum bei 30 °C. Der so erhaltene Feststoff wird in 500 ml DCM gelöst, die Lösung wird im Eis-Kochsalzbad auf 0° C abgekühlt, und dann tropfenweise mit 3.1 ml (40 mmol) Trifluormethansulfonsäure [76-05-1] versetzt. Nach 16 h Rühren bei Raumtemperatur gibt man tropfenweise 50 ml Triethylamin zu, wäscht dann dreimal mit je 200 ml Wasser und einmal mit 200 ml ges. Kochsalzlösung und trocknet über Magnesiumsulfat, filtriert von diesem über ein Celite-Bett ab und engt das Filtrat im Vakuum zur Trockene ein. Das so erhaltene Rohprpodukt wird mit DCM an Kieselgel chromatographiert und anschließend durch fünfmalige Heißextr.mit o-Xylol gereinigt. Ausbeute: 5.6 g (4.4 mmol) 44 %; Reinheit: ca. 99.8 %ig nach HPLC.

### 11) Carbonyl-enthaltende Ir-Komplexe

### Synthese von Ir740

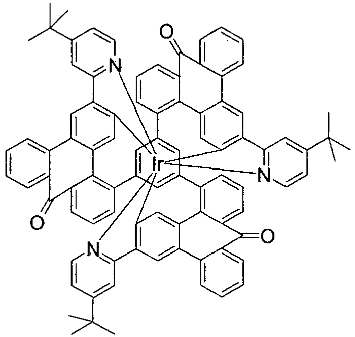

Eine Lösung von 15.3 g (10 mmol) Ir144 in 1000 ml Mesitylen wird bei bei 60 °C unter gutem Rühren tropfenweise mit 5.3 ml (60 mmol) Trifluormethansulfonsäure [1493-13-6] versetzt und dann 12 h gerührt. Nach Erkalten versetzt man mit 300 ml Eiswasser, neutralisiert mit ges. Natriumhydrogencarbonatlösung, trennt die org. Phase ab, wäscht diese zweimal mit je 300 ml Wasser, einmal mit 200 ml ges. Kochsalzlösung und trocknet über Magnesiumsulfat. Man filtriert vom Trockenmittel ab, engt das Filtrat zur Trockene ein und chromatographiert den Rückstand zweimal an Kieselgel (DCM/Ethylacetat, 9:1 vv). Anschließende Reinigung durch fünfmalige Heißextraktion mit Ethylacetat. Ausbeute: 3.9 g (2.7 mmol) 27 %; Reinheit: ca. 99.8 %ig nach HPLC.

Analog kann folgende Verbindungen dargestellt werden:

| Bsp. | Edukt | Ausbeute |
|---|---|---|
| | Produkt | |
| Ir741 | Ir145 | 34 % |
| | 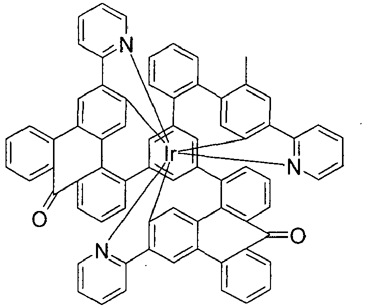 | |

### 12) Alkylierung von Ir-Komplexen mit Benzylalkoholischer Funktion Synthese des Diastereomerengemischs Ir750:

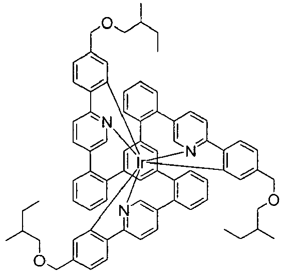

Eine Suspension von 10.5 g (10 mmol) Ir(L125) in 300 ml DMF wird unter gutem Rühren portionsweise mit 960 mg (40 mmol) Natriumhydrid versetzt (Vorsicht: Wasserstoffentwicklung). Nach Erwärmen und 30 min. rühren bei 60 °C tropft man ein Gemisch aus 9.9 g (50 mmol) (2S)-1-Iod-2-methylbutan [29394-58-9] in 50 ml DMF zu und rührt dann 16 h bei 80 °C nach. Nach Erkalten entfernt man alle flüchtigen Anteile im Vakuum, nimmt den Rückstand in 500 ml DCM auf, wäscht dreimal mit 200 ml Wasser, einmal mit 200 ml ges. Natriumchloridlösung und trocknet über Magnesiumsulfat. Man filtriert vom Trockenmittel über ein vorgeschlämmtes Celite-Bett ab, versetzt das Filtrat mit 300 ml Methanol und destilliert dann am Rotationsverdampfer (Wasserbad 70 °C) ca. 90 % des Löungsmittels ab, wobei das Produkt als orang-gelber Feststoff anfällt. Der Feststoff wird abgesaugt und dreimal mit je 50 ml Methanol gewaschen und dann im Vakuum getrocknet. Ausbeute: 9.2 g (7.3mmol) 73 % Diastereomerengemisch.

Analog kann folgende Verbindungen dargestellt werden:

| Bsp. | Edukt / Produkt | Ausbeute |
|---|---|---|
| Ir751 | Ir(L126) / Diastereomerengemisch | 69 % |
| | 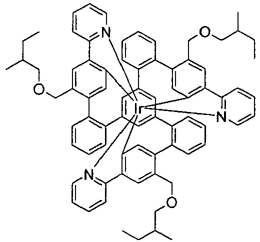 | |

### Trennung der Diastereomeren von Ir750:

Das Diastereomerengemisch Ir750 wird mit Toluol an Kieselgel (ca. 1200 g, Säulengeometrie ca. 10 x 50 cm) in die Beiden enantiomerenreinen Diastereomere Ir750-1 (Rf ca. 0.6, 3.7 g) und Ir750- 2 (Rf ca. 0.4, 4.0 g) zerlegt.

Analog kann das Diastereomerengemisch von Ir751 in die beiden enantiomerenreinen Diastereomere Ir751-1 und Ir751-2 zerlegt werden.

### 13) Hydrogenolyse von Ir-Komplexen mit Benzylether-Funktion: Synthese der Enantiomeren Ir760-1 und Ir760-2

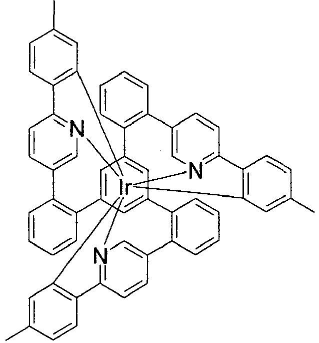

### Δ- bzw Λ-Enantiomer

Eine Lösung von 3.7 g (2.9 mmol) Ir750-1 in 50 ml Toluol und 50 ml Methanol wird mit 2 ml (10 mmol) Polymethylhydrosiloxan [9004-73-3] und 87 mg (0.5 mmol) Palladium(II)chlorid [7647-10-1] versetzt und im Autoklaven 30 h bei 60 °C gerührt. Nach Erkalten entfernt man das Lösungsmittel im Vakuum und chromatographiert den Rückstand zweimal mit Dichlormethan an Kieselgel. Die weitere Reinigung erfolgt durch Heißextraktion mit Acetonitril / Ethylacetat (2:1, vv).
Ausbeute Ir760-1: 2.1 g (2.1 mmol) 72 %; Reinheit: ca. 99.8 %ig nach HPLC.
Analog kann Ir750-2 umgesetzt werden.

Analog können folgende Verbindungen dargestellt werden:

| Bsp. | Edukt / Produkt | Ausbeute |
|---|---|---|
| Ir761-1 | Ir751-1 und Ir751-2 | 67 % |
| Ir761-2 | 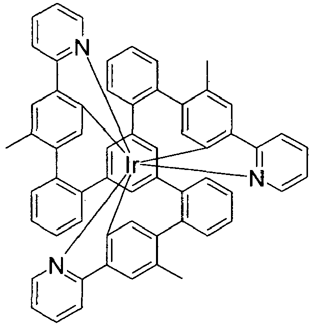 | 64 % |
| | Δ- bzw Λ-Enantiomer | |

Im allgemeinen sind die reinen Δ- und Λ-Enantiomere eines Komplexes, im Vgl. zum Racemat, viel besser in organischen Lösungsmitteln (Dichlormethan, Ethylacetat, Aceton, THF, Toluol, Anisol, 3-Phenoxytoluol, DMSO, DMF, etc.) löslich und sublimieren bei deutlich niedrigeren Temperaturen (typischerweise 30-60 °C tiefer), z.B.:
Racemat von Ir761, dargestellt durch co-Kristallisation gleicher Mengen von Ir761-1 und Ir761-2: Löslichkeit in Toluol bei RT < 1 mg/ml, Tsubl.:
390 °C / p ca. 10⁻⁵ mbar.
Ir761-1 bzw. Ir761-2: Löslichkeit in Toluol bei RT ca. 5 mg/ml, Tsubl.: 350 °C / p ca. 10⁻⁵ mbar.

### 14) Trennung der Δ- und Λ-Enantiomeren der Metallkomplexe mittels Chromatographie an chiralen Säulen:

Die Δ- und Λ-Enantiomeren der Komplexe können mittels analytischer und/oder präparativer Chromatographie an chiralen Säulen nach laborüblichen Methoden getrennt werden, z.B. Trennung von Ir110 an ChiralPak AZ-H (Fa. Chiral Technologies INC.) mit n-Hexan/Ethanol (90:10), Retentionszeiten 18.5 min. bzw. 26.0 min.

### 15) Deuterierung von Ir-Komplexen:

### Beispiel: Ir(L14-D9)

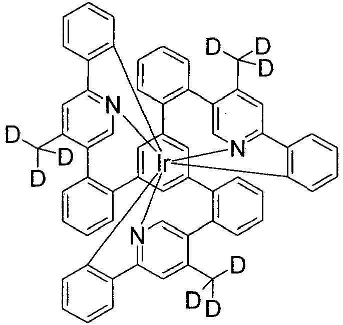

Ein Gemisch von 1.0 g (1 mmol) Ir(L14), 68 mg (1 mmol) Natriumethanolat, 30 ml Ethanol-D1 und 50 ml DMSO-D6 wird 80 h im Autoklaven auf 90 °C erhitzt. Nach Erkalten entfernt man das Lösungsmittel im Vakuum und chromatographiert den Rückstand mit DCM an Kieselgel. Ausbeute: 0.88 g (0.87 mmol), 87 %, Deuterierungsgrad > 90 %.

Analog können folgende Verbindungen dargestellt werden:

| Bsp. | Edukt / Produkt | Ausbeute |
|---|---|---|
| Ir(L52-D3) | Ir(L52) | 90 % |
| | 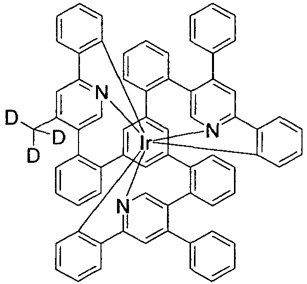 | |
| Ir(L71-D3) | Ir(L71) | 87 % |
| | 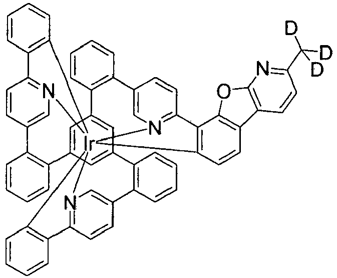 | |
| Ir(L79-D6) | Ir(L79) | 85 % |
| | 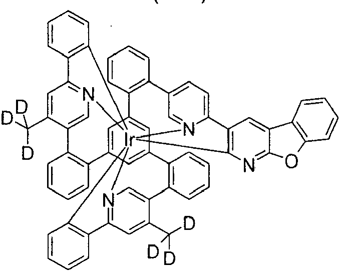 | |
| Ir(L204-D3) | Ir(L204) | 88 % |
| | 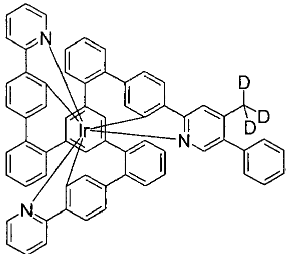 | |
| Ir(L210-D3) | Ir(L210) | 89 % |
| | 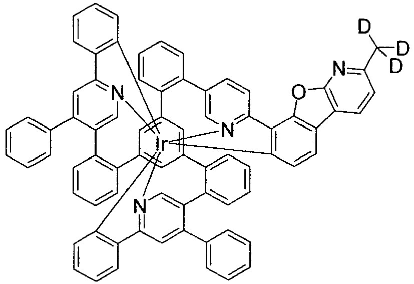 | |
| Ir700-D6 | Ir700 | 83 % |
| | 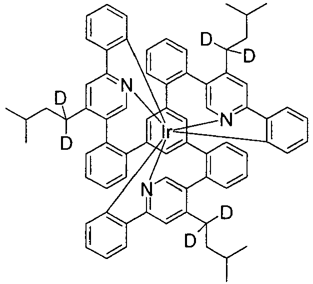 | |
| Ir701-D6 | Ir701 | 85 % |
| | 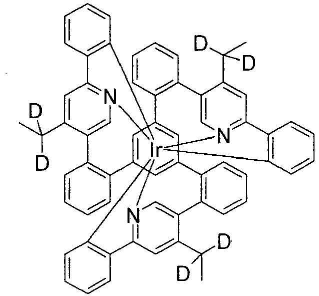 | |
| Ir705-D3 | Ir705 | 83 % |
| | 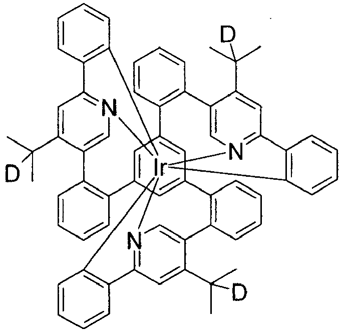 | |

### 16) Kryptate mit zwei verschiedenen Verbrückungseinheiten:

### Beispiel Ir800:

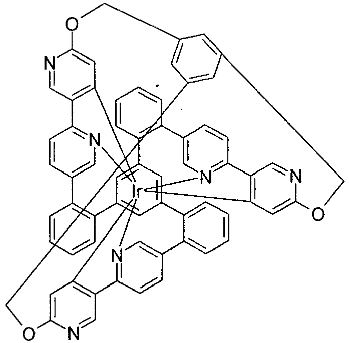

Eine Suspension von 202 mg (1.2 mmol) 1,3,5-Benzol-tri-methanol [4464-18-0] in 50 ml wasserfreiem DMSO wird mit 120 mg (5 mmol) Natriumhydrid in versetzt und 1 h bei 60 °C gerührt. Dann fügt man 1058 mg (1 mmol) Ir(L149) zu und rührt die Reaktionsmischung 16 h bei 120 °C. Nach Erkalten entfernt man das DMSO im Vakuum, nimmt den Rückstand in 200 ml Dichlormethan auf, wäscht die Lösung dreimal mit je 100 ml Wasser, einmal mit 200 ml ges. Natriumchloridlösung und trocknet dann über Magnesiumsulfat. Man filtriert vom Trockenmittel ab, engt das Filtrat zur Trockene ein und chromatographiert den Rückstand mit Dichlormethan/Ethylacetat (9:1 vv) an Kieselgel. Ausbeute: 179 mg (0.16 mmol) 16 %; Reinheit: ca. 99.8 %ig nach HPLC.

Analog können folgende Verbindungen dargestellt werden:

| Bsp. | Edukt / Produkt | Ausbeute |
|---|---|---|
| Ir801 | Ir(L149) | 37 % |
| | 18226-43-2 | |
| | 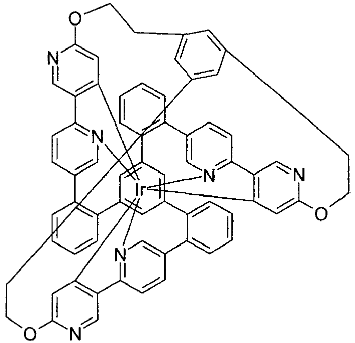 | |
| Ir802 | Ir(L125) Deprotonierung mit NaH in DMSO, dann Zugabe von 18226-42-1 | 34 % |
| | 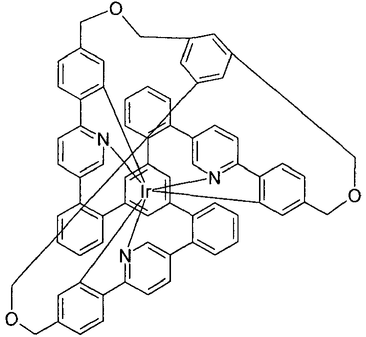 | |

### 17) Polymere enthaltend die Metallkomplexe: Allgemeine Polymerisationsvorschrift für die Bromide bzw. Boronsäure-Derivate als polymerisierbare Gruppe, Suzuki-Polymerisation Variante A - Zweiphasiges Reaktionsgemisch:

Die Monomere (Bromide und Boronsäuren bzw. Boronsäureester, Reinheit nach HPLC > 99.8 % ig) werden in der in der Tabelle angegebenen Zusammensetzung in einer Gesamtkonzentration von ca. 100 mmol/L in einem Gemisch aus 2 Volumenteilen Toluol: 6 Volumenteilen Dioxan : 1 Volumenteil Wasser gelöst bzw. suspendiert. Dann gibt man 2 mol Äquivalente Tri-kalium-phosphat pro eingesetzter Br-Funktionalität zu, rührt 5 min. nach, fügt dann 0.03 bis 0.003 mol Äquivalente Tri-ortho-tolylphosphin und dann 0.005 bis 0.0005 mol Äquivalente Palladium(II)acetat (Verhältnis Phosphin zu Pd bevorzugt 6:1) pro eingesetzter Br-Funktionalität zu und erhitzt unter sehr gutem Rühren 2-3 h unter Rückfluss. Falls die Viskosität der Mischung zu stark ansteigt, kann mit einem Gemisch aus 2 Volumenteilen Toluol: 3 Volumenteilen Dioxan verdünnt werden. Nach insgesamt 4-6 h Reaktionszeit fügt man zum end-capping 0.05 mol Aquivalente pro eingesetzter Boronsäure-Funktionalität eines Monobromaromaten und dann 30 min. danach 0.05 mol Äquivalente pro eingesetzter Br-Funktionalität einer Monoboronsäure bzw. eines Monoboronsäureesters zu und kocht weitere 1 h nach. Nach Erkalten verdünnt man mit 300 ml Toluol, trennt die wässrige Phase ab, wäscht die organische Phase zweimal mit je 300 ml Wasser, trocknet über Magnesiumsulfat, filtriert über ein Celite-Bett ab, um Palladium zu entfernen und engt dann zur Trockene ein. Man löst das Rohpolymer in THF (Konzentration ca. 10 - 30 g/L) und lässt die Lösung unter sehr gutem Rühren langsam in das doppelte Volumen Methanol einlaufen. Das Polymer wird abgesaugt und dreimal mit Methanol gewaschen. Der Umfällvorgang wird fünfmal wiederholt, danach wird das Polymer im Vakuum bis zur Gewichtskonstanz bei 30 - 50 °C getrocknet.

### Variante B - Einphasiges Reaktionsgemisch:

Die Monomere (Bromide und Boronsäuren bzw. Boronsäureester, Reinheit nach HPLC > 99.8 % ig) werden in der in Tabelle angegebenen Zusammensetzung in einer Gesamtkonzentration von ca. 100 mmol/L in einem Lösemittel (THF, Dioxan, Xylol, Mesitylen, Dimethylacetamid, NMP, DMSO, etc.) gelöst bzw. suspendiert. Dann gibt man 3 mol Äquivalente Base (Kaliumfluorid, Trikaliumphosphat (wasserfrei, Monohydrat oder Trihydrat), Kaliumcarbonat, Cäsiumcarbonat etc. jeweils wasserfrei) pro Br-Funktionalität und das Gewichtsäquivalent Glaskugeln (3 mm Durchmesser) zu, rührt 5 min. nach, fügt dann 0.03 bis 0.003 mol Äquivalente Tri-ortho-tolylphosphin und dann 0.005 bis 0.0005 mol Äquivalente Palladium(II)acetat (Verhältnis Phosphin zu Pd bevorzugt 6:1) pro Br-Funktionalität zu und erhitzt unter sehr gutem Rühren 2-3 h unter Rückfluss. Alternativ können andere Phosphine wie Tri-tert-butylphosphin, Sphos, Xphos, RuPhos, XanthPhos, etc. eingesetzt werden, wobei bei diesen Phosphinen das bevorzugte Phosphin : Palladium Verhältnis 2:1 bis 1.3:1 beträgt. Nach insgesamt 4-12 h Reaktionszeit fügt man zum end-capping 0.05 mol Aquivalente eines Monobromaromaten und dann 30 min. danach 0.05 mol Äquivalente einer Monoboronsäure bzw. eines Monoboronsäureesters zu und kocht weiter 1 h nach. Man entfernt das Lösungsmittel weitgehend im Vakuum, nimmt den Rückstand in Toluol auf, und reinigt das Polymer wie unter Variante A beschrieben.

**Monomere M / Endcapper E:**

| | |
|---|---|
| 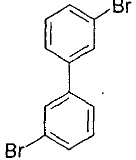 | 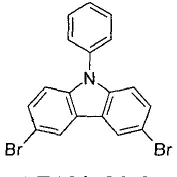 |
| 16400-51-4 | 57103-20-5 |
| M1 | M2 |
| 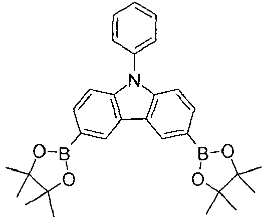 | 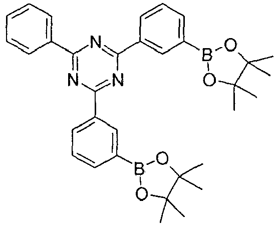 |
| 618442-57-2 | 1238752-26-5 |
| M3 | M4 |
| 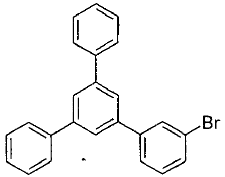 | 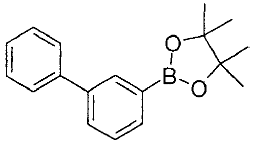 |
| 1233200-57-1 | 912844-88-3 |
| E1 | E2 |

### Polymere:

**Zusammensetzung der Polymere, mmol :**

| **Polymer** | **M1** | **M2** | **M3** | **M4** | **Ir-Komplex** |
|---|---|---|---|---|---|
| P1 | --- | 30 | --- | 45 | Ir(L14-3Br) / 10 |
| P2 | 5 | 25 | --- | 40 | Ir(L39-2Br) / 10 |
| P3 | 10 | 40 | 25 | 20 | Ir404 / 5 |

**Molekulargewichte und Ausbeute der erfindungsgemäßen Polymere:**

| Polymer | Mn [gmol⁻¹] | Polydispersität | Ausbeute |
|---|---|---|---|
| P1 | 240.000 | 4.6 | 71% |
| P2 | 250.000 | 2.3 | 57% |
| P3 | 200.000 | 2.2 | 60% |

### D: Synthese der Synthone - Teil2

### Beispiel S1000: 5-Bromo-2-(4-chloro-phenyl)-pyridin

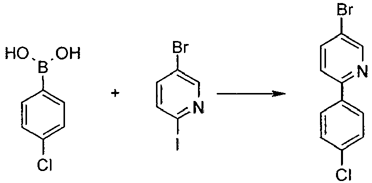

In einen 4 L-Vierhalskolben mit Rückflusskühler, Argonüberlagerung, KPG-Rührer und Innenthermometer werden 129.9 g 4-Chlorphenylboronsäure (810 mmol) [1679-18-1], 250.0 g 5-Brom-2-iod-pyridin (250mmol) [223463-13-6] und 232.7 g Kaliumcarbonat (1.68 mol) eingewogen, der Kolben mit Argon inertisiert und mit 1500 ml Acetonitril und 1000 ml absolutem Ethanol versetzt. Es werden noch 100 g Glasperlen (Durchmesser 3 mm) hinzugegeben und die Suspension wird für 5 Minuten homogenisiert. Dann werden 5.8 g Bis(triphenylphosphin)palladium(II)chlorid (8.3 mmol) [13965-03-2] zugegeben. Die Reaktionsmischung wird über Nacht, unter starkem Rühren auf Rückfluss erwärmt. Nach dem Abkühlen wird das Losungsmittel abrotiert und der Rückstand extraktiv mit Toluol und Wasser im Scheidetrichter aufgearbeitet. Die organische Phase wird 2 x mit 500 ml Wasser und 1 x mit 300 ml gesättigter Kochsalzlösung gewaschen, über wasserfreiem Natriumsulfat getrocknet und anschließend das Lösungsmittel im Vakuum entfernt. Der ausgefallene Feststoff wird abgesaugt und mit Ethanol gewaschen. Der erhaltene gelbe Feststoff wird aus 800 ml Acetonitril am Rückfluss umkristallisiert. Es wird ein beiger Feststoff erhalten. Ausbeute: 152.2 g (567.0 mmol), 70%; Reinheit: ca. 95%ig nach ¹H-NMR.

### Beispiel S1001: 2-(4-Chloro-phenyl)-5-(4,4,5,5-tetramethyl[1,3,2]di-oxaborolan-2-yl)-pyridine

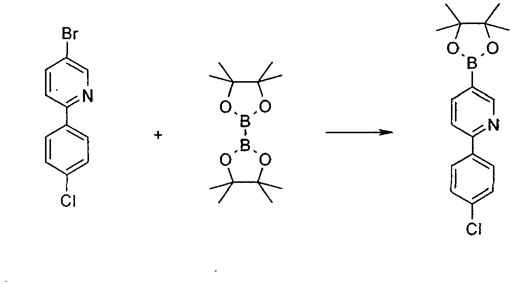

In einen 4 L-Vierhalskolben mit Rückflusskühler, KPG-Rührer, Heizbad und Argonanschluss werden 162.0 g (600 mmol) S1000, 158.0 g (622 mmol) Bis(pinacolato)diboran [73183-34-3], 180.1 g (1.83 mol) Kaliumacetat [127-08-2] und 8.9 g (12.1mmol) trans-Dichlorobis(tricyclohexylphosphine)-palladium(II) [29934-17-6] eingewogen und mit 2200 ml 1,4-Dioxan versetzt. Es werden noch 100 g Glasperlen (Durchmesser 3 mm) zugegeben und die Reaktionsmischung wird mit Argon inertisiert und unter Rückfluss für 24 Stunden gerührt. Nach Abkühlen wird das Lösungsmitel im Vakuum entfernt, der erhaltene Rückstand extraktiv im Scheidtrichter mit 1000 ml Ethalacetat und 1500 ml Wasser aufgearbeitet. Die organi-sche Phase wird 1 x mit 500 ml Wasser und 1 x mit 300 ml gesättigter Kochsalzlösung gewaschen, über wasserfreiem Natriumsulfat getrocknet und über eine mit Kieselgel gepackte Fritte filtriert. Das Kieselgelbett wird 2 x mit 500 ml Ethylacetat nachgewaschen und das erhaltene Filtrat im Vakuum eingeengt. Der erhaltene braune Feststoff wird aus 1000 ml nHeptan am Rückfluss umkristallisiert. Es wird ein beiger Feststoff erhalten. Ausbeute: 150.9 g (478 mmol), 80%; Reinheit: 97%%ig nach ¹H-NMR.

### Beispiel S1002: Synthese symetrischer Triazin-Bausteine 2-Chlor-4,6-bis-(3,5-di-tert.-butyl-phenyl)-[1,3,5]triazin

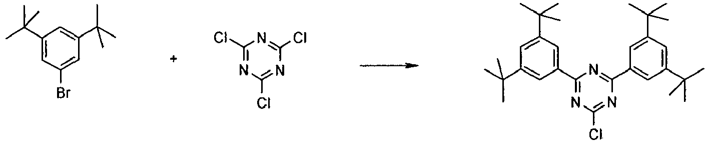

In einen ausgeheizten Kolben werden 5.8 g (239 mmol) Magnesiumspäne vorgelegt und eine Lösung von 73.0 g (271 mmol) Brom-3,5-di-tert-butylbenzol [22385-77-9] in 400 ml trockenem THF langsam zugetropft, so dass die Reaktionslösung stetig unter Rückfluss kocht. Nach vollständiger Zugabe wird die Lösung weitere zwei Stunden unter Rückfluss gekocht, danach abkühlen gelassen. In einem weiteren Kolben werden 20.0 g (108.5 mmol) Cyanurchlorid in 400 ml trockenem THF vorgelegt und auf 0°C gekühlt. Das Grignard-Reagenz wird so zugetropft, dass eine Innentemperatur von 20°C nicht überschritten wird. Nach vollständiger Zugabe lässt man die Reaktionsmischung über Nacht auf Raumtemperatur erwärmen. Durch Zugabe von 500 ml 1 mol/L HCl-Lösung unter Eiskühlung wird die Reaktion gequencht. Die Phasen werden getrennt und die wässrige Phase 3 mal mit Essigester extrahiert. Die organischen Phasen werden vereinigt und mit ges. NaCl-Lösung gewaschen, danach über Natriumsulfat getrocknet und das Filtrat im Vakuum eingeengt. Das erhaltene hellbraune Öl wird mit Methanol versetzt und auf Rückfluss erhitzt. Nach Abkühlen wird der ausgefallene farbloese Feststoff abgesaugt, mit Heptan gewaschen und im Vakuum getrocknet. Ausbeute: 23.6 g (48 mmol), 47%; Reinheit: ca. 97%ig nach ¹H-NMR.

Analog können folgende Verbindungen dargestellt werden:

| **Bsp.** | **Brom-Edukt** | **Produkt** | **Ausbeute** |
|---|---|---|---|
| S1003 | 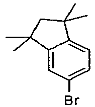 | 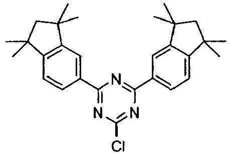 | 60% |
| | [169695-24-3] | | |
| S1004 | 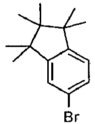 | 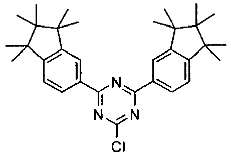 | 57% |
| | [1562418-80-7] | | |

### Beispiel S1005 Synthese asymetrischer Triazin Bausteine 2-tert-Butyl-4-(4-tert-butyl-phenyl)-6-chloro-[1,3,5]triazine

In einen ausgeheizten Kolben werden 3.4 g (140 mmol) Magnesiumspäne vorgelegt und eine Lösung von 30.0 g (141 mmol) 1-Bromo-4-tert-butyl-benzene [3972-65-4] in 50 ml trockenem THF langsam zugetropft, so dass die Reaktionslösung stetig unter Rückfluss kocht. Nach vollständiger Zugabe wird die Lösung weitere zwei Stunden unter Rückfluss gekocht, danach abkühlen gelassen. In einem weiteren Kolben werden 30.1 g (146 mmol) 2-tert-Butyl-4,6-dichloro-[1,3,5]triazine [705-23-7] in 75 ml trockenem THF vorgelegt und auf 0°C gekühlt. Das Grignard-Reagenz wird so zugetropft, dass eine Innentemperatur von 20°C nicht überschritten wird. Nach vollständiger Zugabe lässt man die Reaktionsmischung über Nacht auf Raumtemperatur erwärmen. Durch Zugabe von 200 ml 1 mol/L HCl-Lösung unter Eiskühlung wird die Reaktion gequencht. Die Phasen werden getrennt und die wässrige Phase dreimal mit Toluol extrahiert. Die organischen Phasen werden vereinigt und mit ges. NaCl-Lösung gewaschen, danach über Natriumsulfat getrocknet und das Filtrat im Vakuum eingeengt. Das erhaltene rotbraune Öl wird ohne weitere Aufreinigung eingesetzt. Ausbeute: 34 g (112 mmol), 79%; Reinheit: ca. 90%ig nach ¹H-NMR.

Analog können folgende Verbindungen dargestellt werden:

| **Bsp.** | **Triazin** | **Bromid** | **Produkt** | **Ausbeute** |
|---|---|---|---|---|
| S1006 | 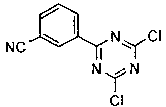 | 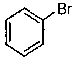 | 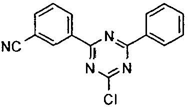 | 52% |
| | [1207841-72-2] | [108-86-1] | | |
| S1007 | 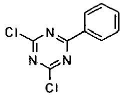 | 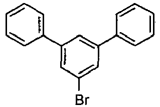 | 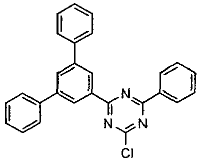 | 61% |
| | [1700-02-3] | [103068-20-8] | | |

### Beispiel S1008: 5-Brom-2-(1,1,2,2,3,3-hexamethyl-indan-5-yl)-pyridin

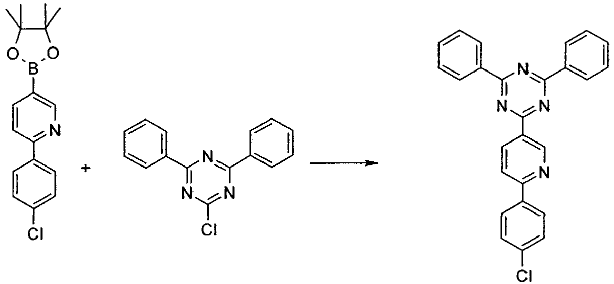

In einem 2-L Vierhalskolben werden 76.5 g (242 mmol) S1001, 65.6 g (245 mmol) 2-Chloro-4,6-diphenyl-[1,3,5]-triazin [3842-55-5], 2.8 g (2.4 mmol) Tetrakis(triphenylphosphin)-palladium (0) und 64.3 g (606 mmol) Natriumcarbonat eingewogen, inertisiert und mit1200 ml entgastem Toluol und 200 ml entgastem Wasser versetzt. Die Reaktionsmischung wird für 24 Stunden unter Rückfluss gerührt. Nach beendeter Reaktion filtriert man den ausgefallenen Feststoff ab und wäscht diesen 3 x mit 50 ml Wasser, 3 x mit 50 ml Ethanol und 2 x mit 20 ml Toluol. Der erhaltene graue Feststoff wird ohne weitere Aufreinigung eingesetzt. Ausbeute: 75.5 g (179 mmol), 74%; Reinheit: 98%ig nach ¹H-NMR.

Analog können weiterhin folgende Liganden aufgebaut werden:

| **Bsp.** | **Chlorid** | **Produkt** | **Ausbeute** |
|---|---|---|---|
| S1009 | 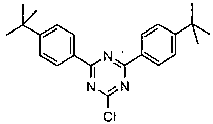 | 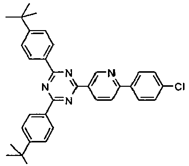 | 60% |
| | [253158-13-3] | | |
| S1010 | S1002 | 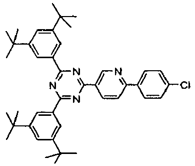 | 58% |
| S1011 | S1005 | 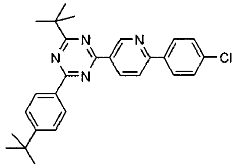 | 73% |
| S1012 | 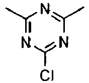 | 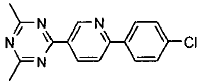 | 41% |
| | [30894-84-9] | | |
| S1013 | 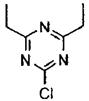 | 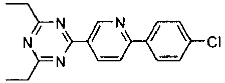 | 50% |
| | [701-77-9] | | |
| S1014 | 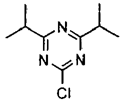 | 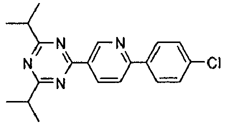 | 56% |
| | [911798-79-3] | | |
| S1015 | 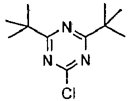 | 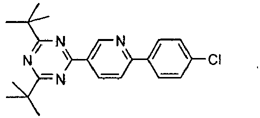 | 66% |
| | [73084-03-4] | | |
| S1016 | 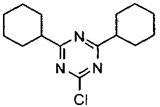 | 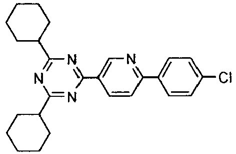 | 61% |
| | [78941-35-2] | | |
| S1017 | 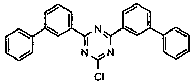 | 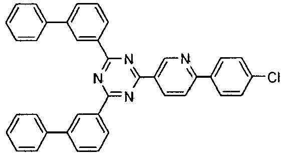 | 77% |
| | [1205748-61-3] | | |
| S1018 | 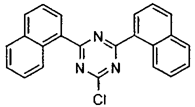 | 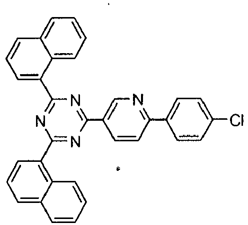 | 58% |
| | [78941-32-9] | | |
| S1019 | 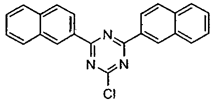 | 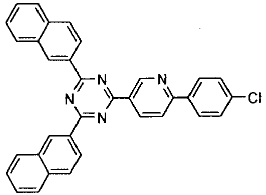 | 52% |
| | [1247124-77-1] | | |
| S1020 | 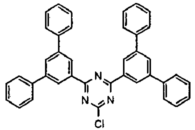 | 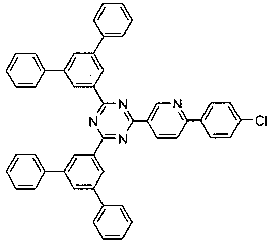 | 78% |
| | [1205748-51-1] | | |
| S1021 | 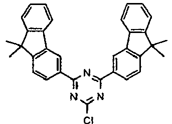 | 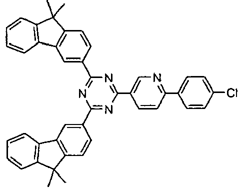 | 69% |
| | [1646532-00-4] | | |
| S1022 | 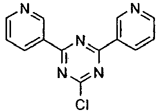 | 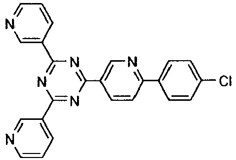 | 45% |
| | [1418124-08-9] | | |
| S1023 | 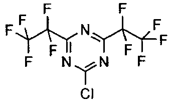 | 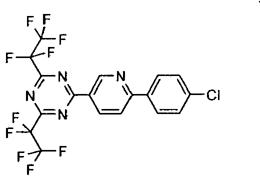 | 49% |
| | [736-68-5] | | |
| S1024 | 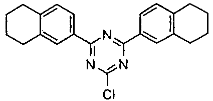 | 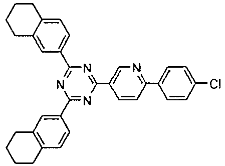 | 71% |
| | [253133-88-9] | | |
| S1025 | S1003 | 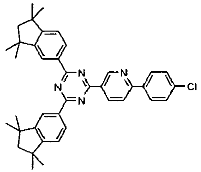 | 77% |
| S1026 | S1004 | 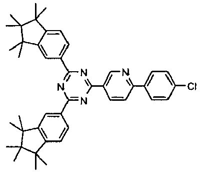 | 75% |
| S1027 | 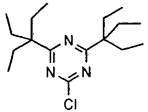 | 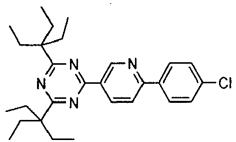 | 68% |
| | [1092838-17-9] | | |
| S1028 | S1006 | 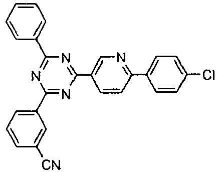 | 59% |
| S1029 | S1007 | 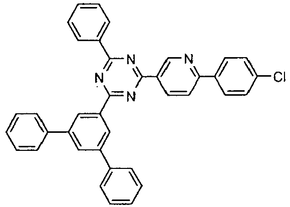 | 74% |
| S1030 | 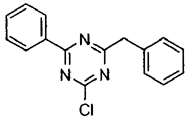 | 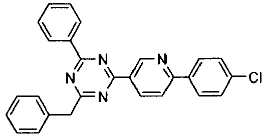 | 60% |
| | [80984-77-6] | | |
| S1031 | 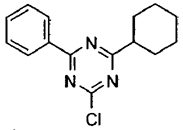 | 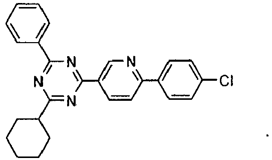 | 61% |
| | [1426435-09-7] | | |
| S1032 | 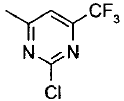 | 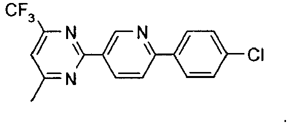 | 31% |
| | [241164-09-0] | | |
| S1034 | 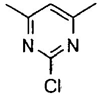 | 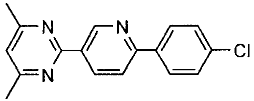 | 41% |
| | [4472-44-0] | | |
| S1035 | 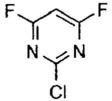 | 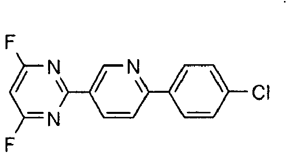 | 35% |
| | [38953-30-9] | | |
| S1036 | 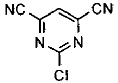 | 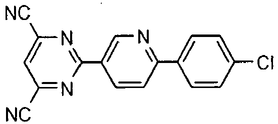 | 41% |
| | [29872-58-0] | | |
| S1036 | 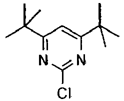 | 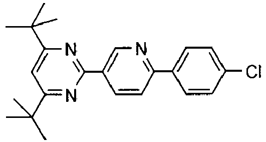 | 72% |
| | [71162-19-1] | | |
| S1037 | 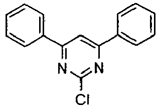 | 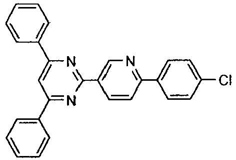 | 81% |
| | [2915-16-4] | | |
| S1038 | 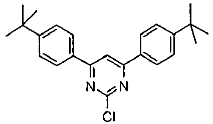 | 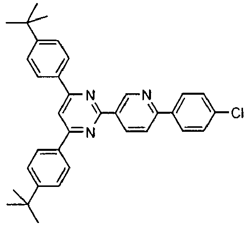 | 79% |
| | [1035556-77-4] | | |
| S1039 | 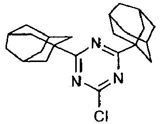 | 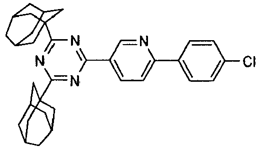 | 70% |
| | [1092838-15-7] | | |
| S1040 | 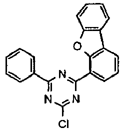 | 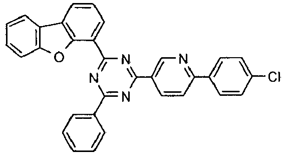 | 80% |
| | [1472729-25-1] | | |
| S1041 | 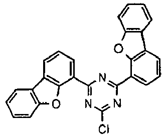 | 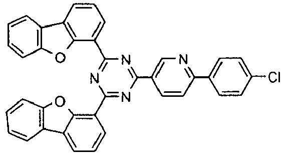 | 85% |
| | [1699739-83-7] | | |
| S1042 | 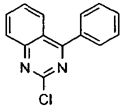 | 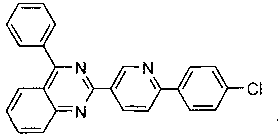 | 60% |
| | [29874-83-7] | | |

### Beispiel S1100: 2,4-Diphenyl-6-{6-[4-(4,4,5,5-tetramethyl-[1,3,2]dioxaborolan-2-yl)-phenyl]-pyridin-3-yl}-[1,3,5]triazine

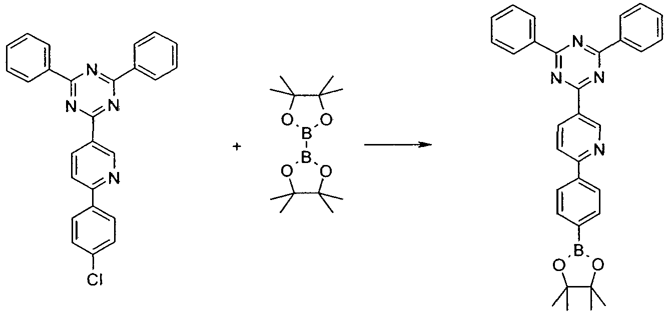

In einen 2 L-Vierhalskolben mit Rückflusskühler, KPG-Rührer, Heizbad und Argonanschluss werden 99.5 g (236.4 mmol) S1008, 61.6 g (243 mmol) Bis(pinacolato)diboran [73183-34-3], 69.6 g (709 mmol) Kaliumacetat [127-08-2], 1.9 g (4.7 mmol) 2-Dicyclohexylphosphino-2',6'-dimethoxybiphenyl [657408-07-6] und 800 mg (3.6 mmol) Palladium(II)acetat [3375-31-3] eingewogen, inertisiert und mit 1000 ml entgastem 1,4-Dioxan versetzt. Es werden noch 100 g Glasperlen (Durchmesser 3 mm) zugegeben, dann wird die Reaktionsmischung unter Rückfluss für 24 Stunden gerührt. Nach Abkühlen wird das Lösungsmittel im Vakuum entfernt, der erhaltene Rückstand mit einem Gemisch aus 1000 ml Ethanol und 500 ml Wasser heiß ausgerührt. Der erhaltene graue Feststoff wird abgesaugt und 3 x mit 100 ml Ethanol gewaschen, im Vakuumtrockenschrank bei 70°C und 30 mbar getrocknet. Die weitere Aufreinigung erfolgt durch dreimalige kontinuierliche Heißextraktion (Extraktionsmittel, Vorlagemenge jeweils ca. 300 ml, Extraktionshülse: standard Soxhletthülsen aus Cellulose der Fa. Whatman) mit 1,4-Dioxan. Es wird ein blass gelber Feststoff erhalten. Ausbeute: 90.8 g (177 mmol), 75%; Reinheit: 99%%ig nach ¹H-NMR.

Analog können folgende Verbindungen dargestellt werden:

| **Bsp.** | **Chlorid/Synthon** | **Extrations-mittel** | **Produkt** | **Ausbeute** |
|---|---|---|---|---|
| S1101 | S1009 | Cyclohexan | 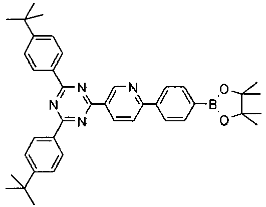 | 77% |
| S1102 | S1010 | Cyclohexan | 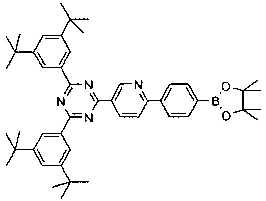 | 80% |
| S1103 | S1011 | Acetonitril | 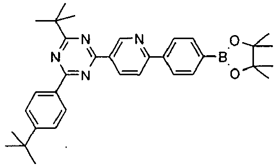 | 73% |
| S1104 | S1012 | Ethylacetat | 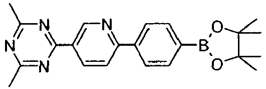 | 75% |
| S1105 | S1013 | Ethylacetat | 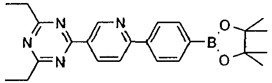 | 67% |
| S1106 | S1014 | Ethylacetat | 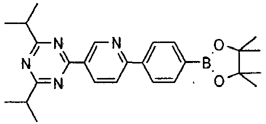 | 65% |
| S1107 | S1015 | Cylcohexan | 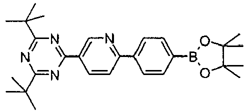 | 66% |
| S1108 | S1016 | Cyclohexan | 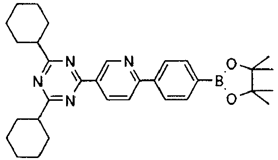 | 61% |
| S1109 | S1017 | o-Xylol | 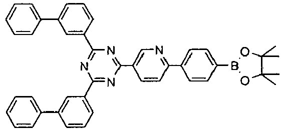 | 77% |
| S1110 | S1018 | o-Xylol | 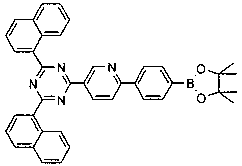 | 76% |
| S1111 | S1019 | Toluol | 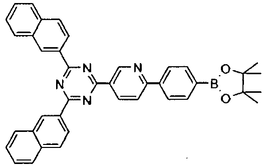 | 78% |
| S1112 | S1020 | Mesitylen | 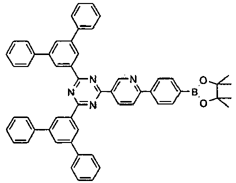 | 86% |
| S1113 | S1021 | Toluol | 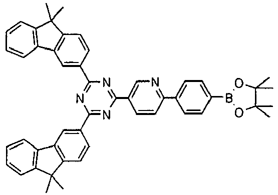 | 80% |
| S1114 | S1022 | Toluol | 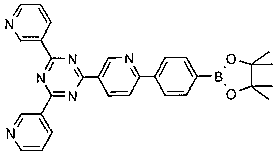 | 70% |
| S1115 | S1023 | Ethylacetat | 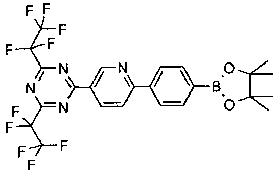 | 59% |
| S1116 | S1024 | Toluol | 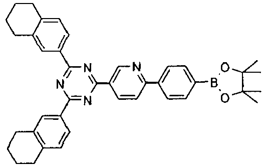 | 65% |
| S1117 | S1025 | Cyclohexan | 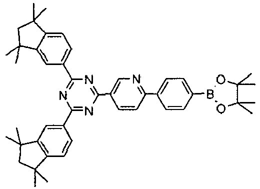 | 72% |
| S1118 | S1026 | Cyclohexan | 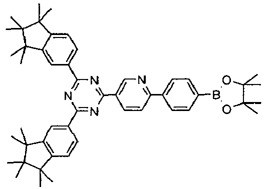 | 70% |
| S1119 | S1027 | Cyclohexan | 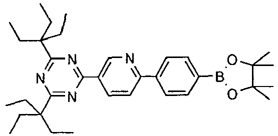 | 78% |
| S1120 | S1028 | Toluol | 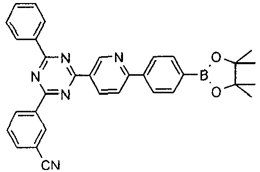 | 80% |
| S1121 | S1029 | Toluol | 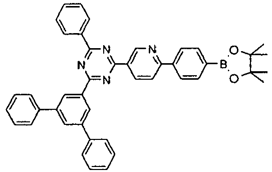 | 74% |
| S1122 | S1030 | Dioxan | 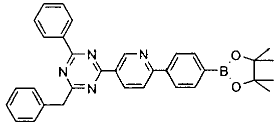 | 77% |
| S1123 | S1031 | Dioxan | 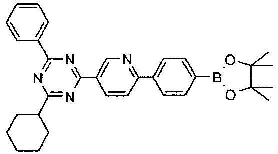 | 70% |
| S1124 | S1032 | Acetonitril | 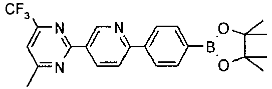 | 72% |
| S1125 | S1034 | Ethylacetat | 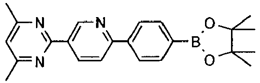 | 65% |
| S1126 | S1035 | Ethanol | 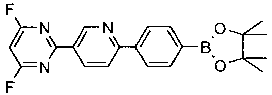 | 68% |
| S1127 | S1036 | Acetonitril | 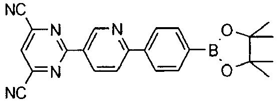 | 70% |
| S1128 | S1036 | Cylohexan | 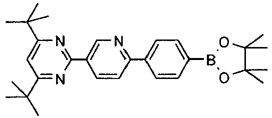 | 75% |
| S1129 | S1037 | Toluol | 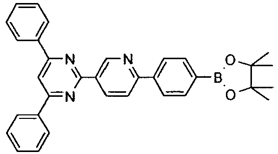 | 80% |
| S1130 | S1038 | Cylcohexan | 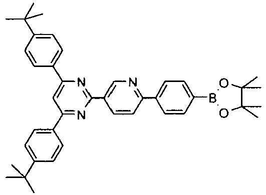 | 79% |
| S1131 | S1039 | Ethylacetat | 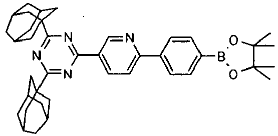 | 72% |
| S1132 | S1040 | Ethylacetat | 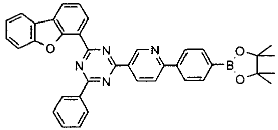 | 74% |
| S1133 | S1041 | p-Xylol | 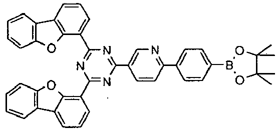 | 82% |
| S1134 | 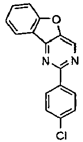 | Ethylacetat | 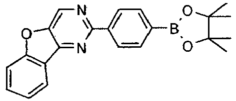 | 78% |
| | [1374216-04-2] | | | |
| S1135 | 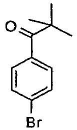 | Chromatographisch | 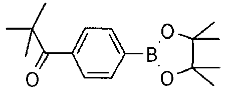 | 80% |
| | [30314-45-5] | | | |
| S1136 | S1042 | Toluol | 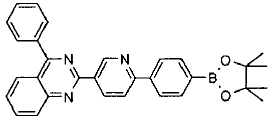 | 70% |
| S1137 | 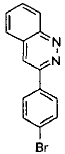 | Dioxan | 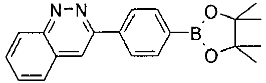 | 74% |
| | [1401421-23-5] | | | |

### E: Synthese der Liganden Teil 2:

### Beispiel L1000: 2-[6-[4-[2-[3,5-bis[2-[4-[5-(4,6-diphenyl-1,3,5-triazin-2-yl)-2-pyridyl]phenyl]phenyl]phenyl]phenyl]phenyl]-3-pyridyl]-4,6-diphenyl-1,3,5-triazine

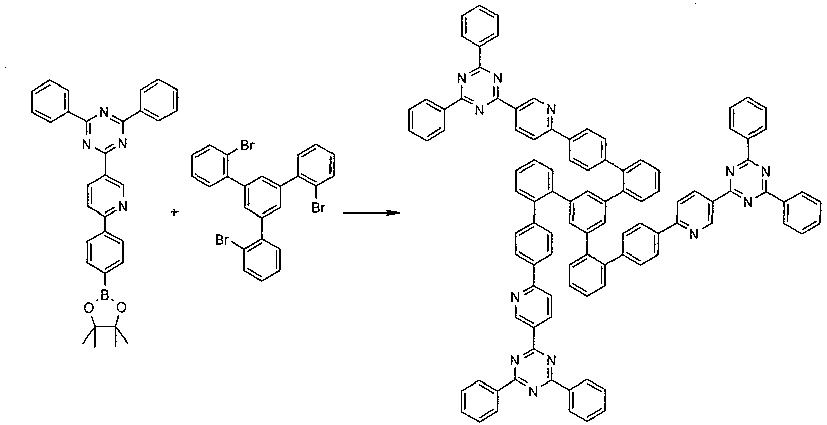

In einen 2 L-Vierhalskolben mit Rückflusskühler, KPG-Rührer, Heizbad und Argonanschluss werden 40.0 g (76.1 mmol) S1100, 12.1g (22.3 mmol) 1,3,5-tris(2-bromophenyl)benzol [380626-56-2], 17.2 g (162 mmol) Natriumcarbonat, 526 mg (2.0 mmol) Triphenylphosphin [603-35-0] und 150 mg (0.67 mmol) Palladium(II)acetat [3375-31-3] eingewogen und mit 400 ml Toluol, 200 ml Ethanol und 200 ml Wasser versetzt. Die Reaktionsmischung wird mit Argon inertisiert und unter Rückfluss für 48 Stunden gerührt. Nach Abkühlen wird der ausgefallene graue Feststoff abgesaugt und 5 x mit 100 ml Ethanol gewaschen und anschließend im Vakuumtrockenschrank bei 70°C getrocknet. Die weitere Aufreinigung erfolgt durch dreimalige kontinuierliche Heißextraktion (Extraktionsmittel, Vorlagemenge jeweils ca. 300 ml, Extraktionshülse: Standard Soxhletthülsen aus Cellulose der Fa. Whatman) mit o-Xylol. Besser lösliche Derivate können mittels chromatographischer Methoden aufgereinigt werden. Es wird ein blass gelber Feststoff erhalten. Ausbeute: 23.7 g (177 mmol), 69%; Reinheit: 97%%ig nach ¹H-NMR.

Analog können folgende Verbindungen dargestellt werden:

| **Bsp.** | **Produkt/Synthon/Extrationsmittel/Aufeinigung** | **Ausbeute** |
|---|---|---|
| L1001 | 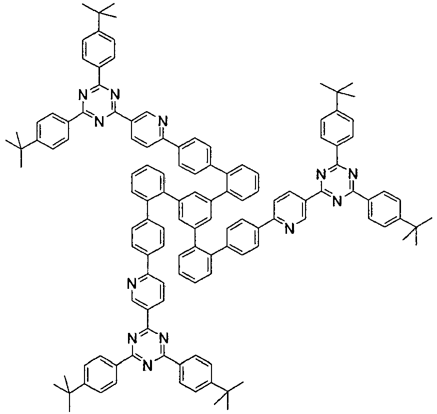 | 55% |
| | S1101 | |
| | chromatographisch | |
| L1002 | 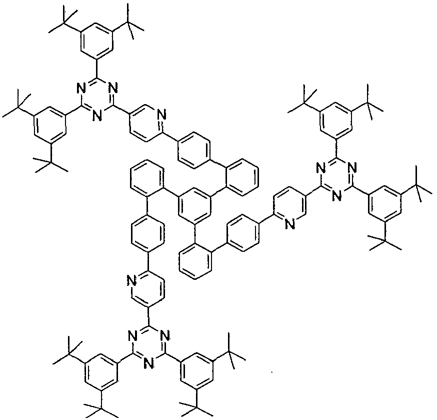 | 60% |
| | S1102 | |
| L1003 | 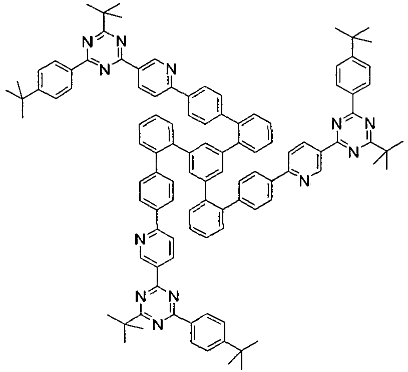 | 66% |
| | S1103 | |
| | chromatographisch | |
| L1004 | 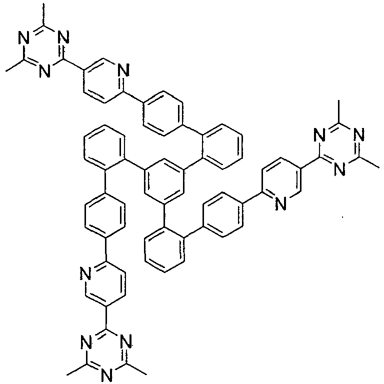 | 70% |
| | S1104 | |
| | Toluol | |
| L1005 | 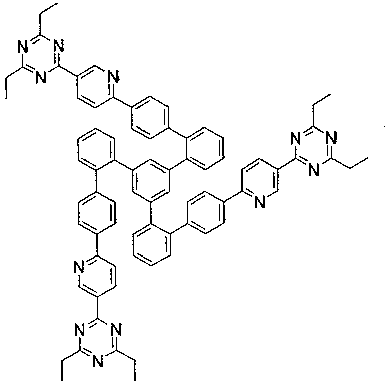 | 62% |
| | S1105 | |
| | Toluol | |
| L1006 | 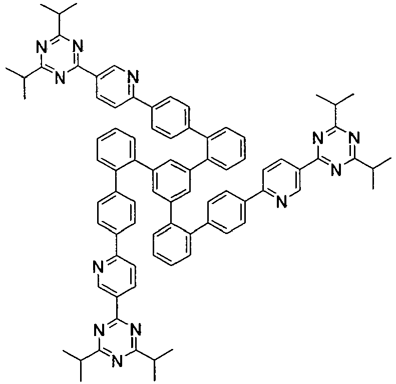 | 60% |
| | S1106 | |
| | Toluol | |
| L1007 | 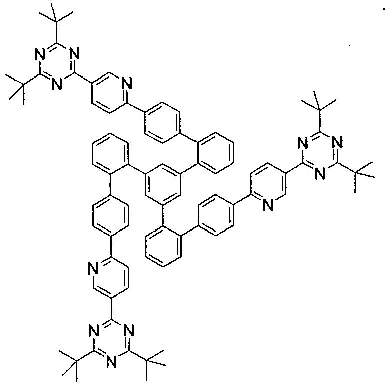 | 71% |
| | S1107 | |
| | Ethylacetat | |
| L1008 | 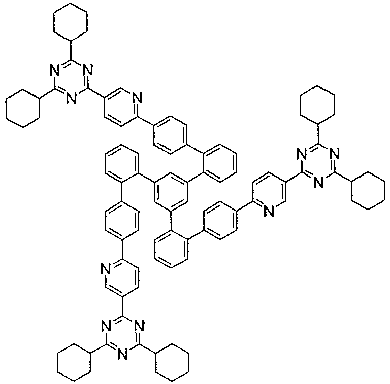 | 75% |
| | S1108 | |
| | Toluol | |
| L1009 | 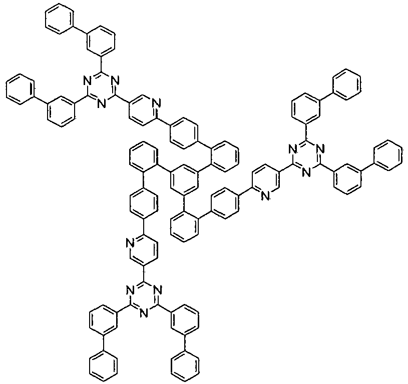 | 82% |
| | S1109 | |
| | o-Xylol | |
| L1010 | 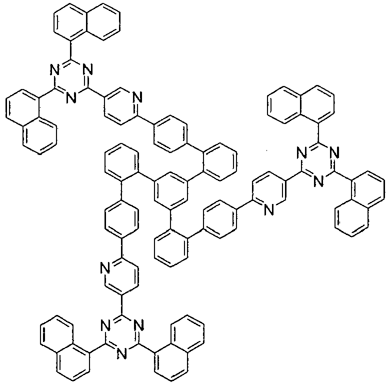 | 80% |
| | S1110 | |
| | Toluol | |
| L1011 | 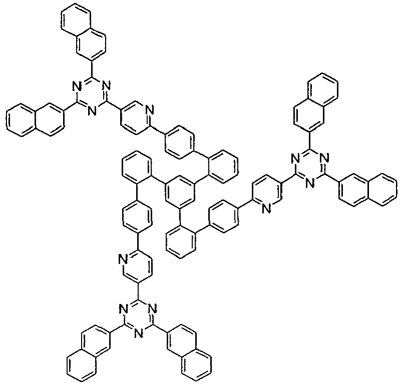 | 81% |
| | S1111 | |
| | Toluol | |
| L1012 | 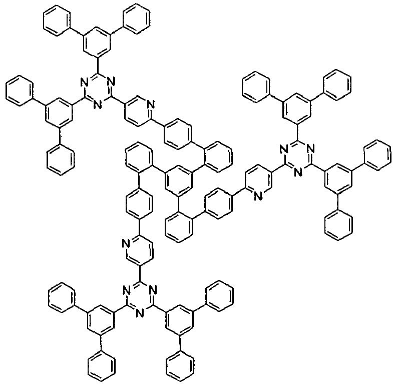 | 88% |
| | S1112 | |
| | p-Xylol | |
| L1013 | 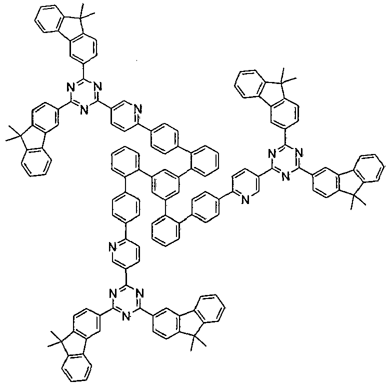 | 85% |
| | S1113 | |
| | Mesitylen | |
| L1014 | 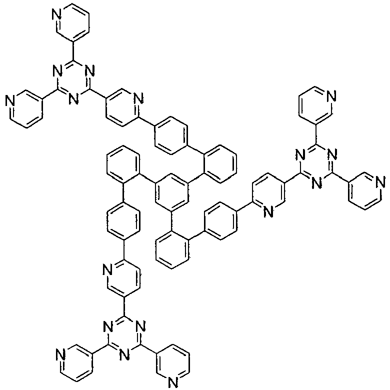 | 73% |
| | S1114 | |
| | o-Xylol | |
| L1015 | 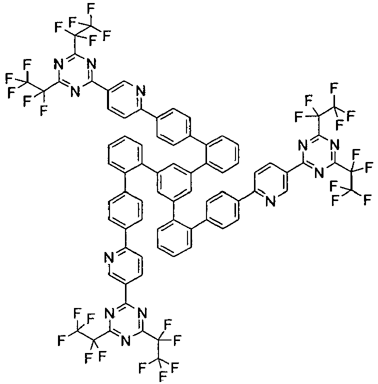 | 55% |
| | S1115 | |
| | Ethylacetat | |
| L1016 | 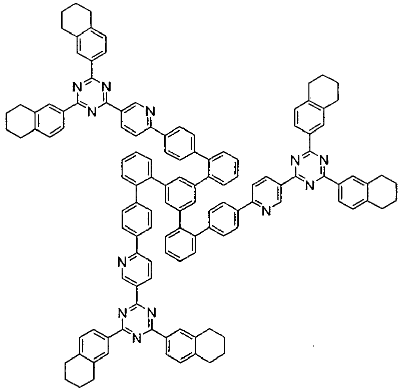 | 59% |
| | S1116 | |
| | Toluol | |
| L1017 | 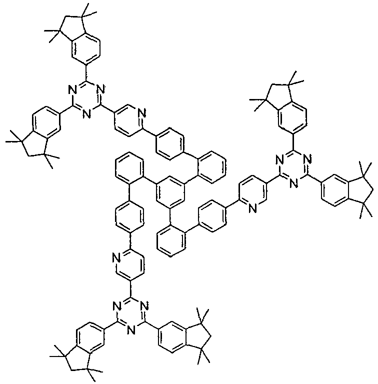 | 71% |
| | S1117 | |
| | Dioxan | |
| L1018 | 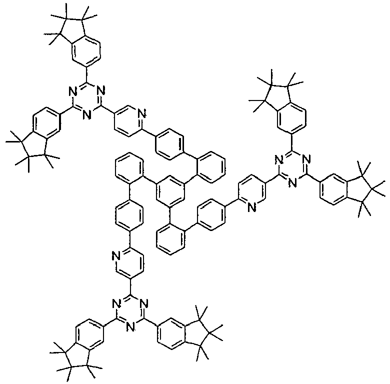 | 78% |
| | S1118 | |
| | Dioxan | |
| L1019 | 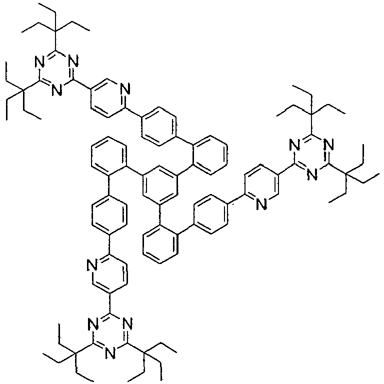 | 78% |
| | S1119 | |
| | Toluol | |
| L1020 | 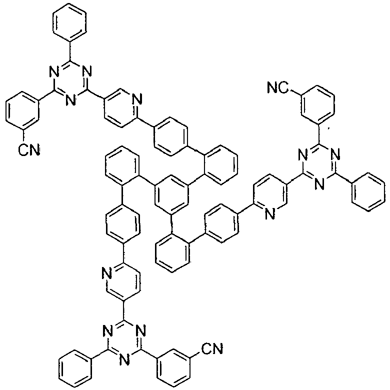 | 80% |
| | S1120 | |
| | Toluol | |
| L1021 | 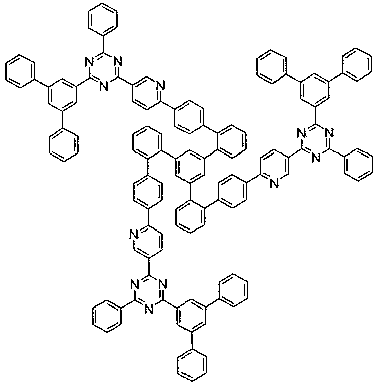 | 74% |
| | S1121 | |
| | o-Xylol | |
| L1022 | 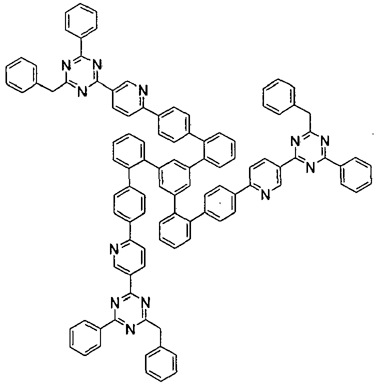 | 77% |
| | S1122 | |
| | o-Xylol | |
| L1023 | 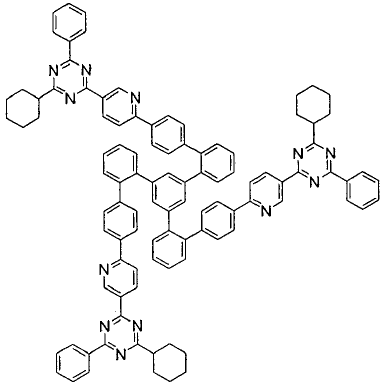 | 70% |
| | S1123 | |
| | Dioxan | |
| L1024 | 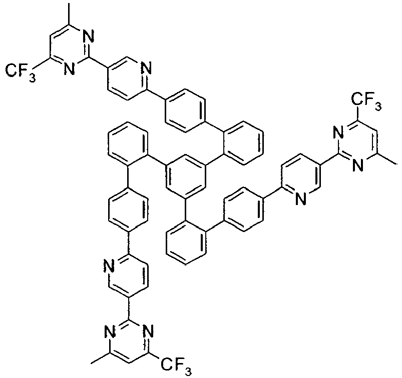 | 72% |
| | S1124 | |
| | Ethylacetat | |
| L1025 | 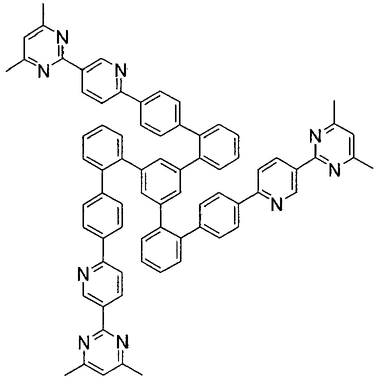 | 65% |
| | S1125 | |
| | Toluol | |
| L1026 | 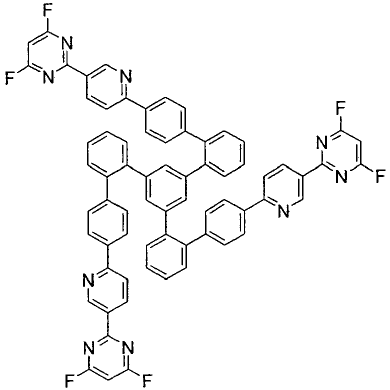 | 68% |
| | S1126 | |
| | *n*-Butanol | |
| L1027 | 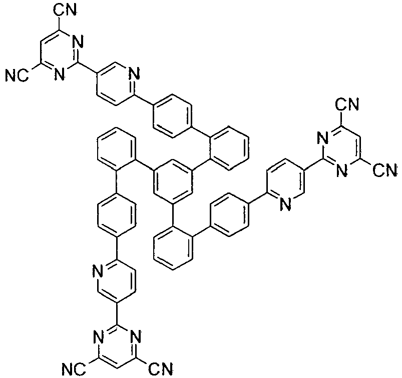 | 70% |
| | S1127 | |
| | Acetonitril | |
| L1028 | 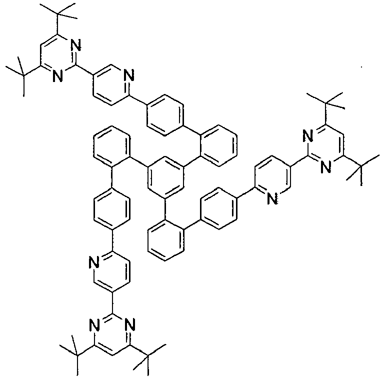 | 75% |
| | S1128 | |
| | chromatographisch | |
| L1029 | 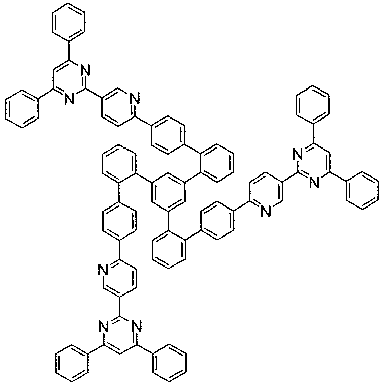 | 80% |
| | S1129 | |
| | o-Xylol | |
| L1030 | 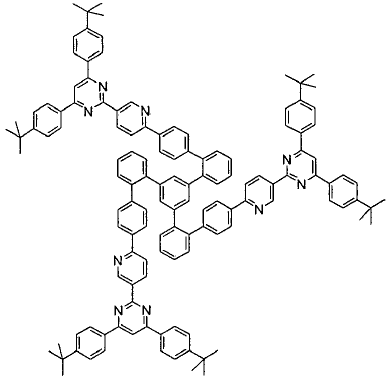 | 79% |
| | S1130 | |
| | chromatographisch | |
| L1031 | 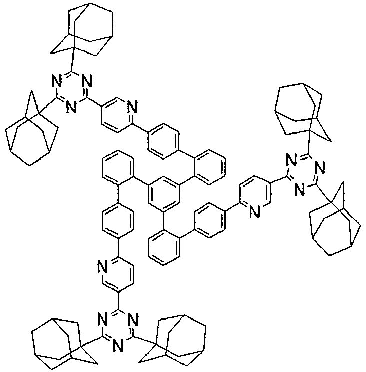 | 72% |
| | S1131 | |
| | Ethylacetat | |
| L1032 | 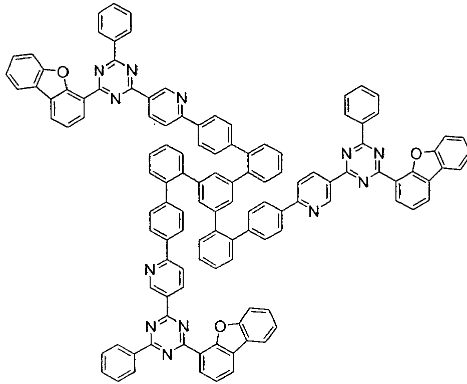 | 74% |
| | S1132 | |
| | Toluol | |
| L1033 | 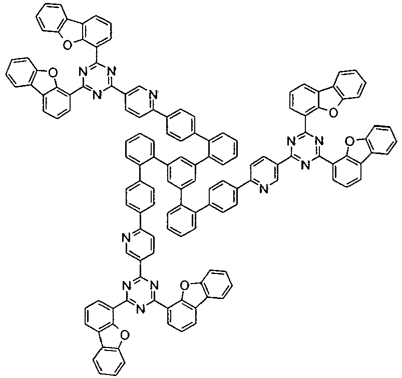 | 82% |
| | S1133 | |
| | o-Xylol | |
| L1034 | 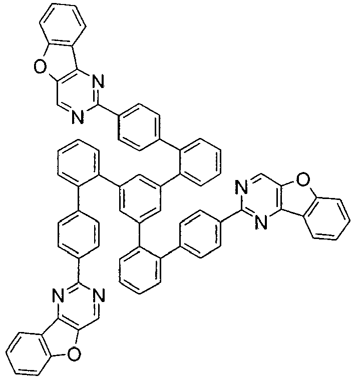 | 76% |
| | S1134 | |
| | Toluol | |
| L1036 | 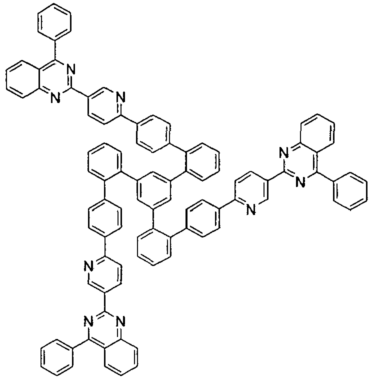 | 70% |
| | S1136 | |
| | Toluol | |
| L1037 | 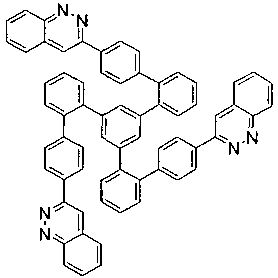 | 68% |
| | S1137 | |
| | Toluol | |

Analog können folgende Liganden hergestellt werden:

| **Bsp.** | **Boronester** | **Bromid** | **Produkt** | **Aus-beute** |
|---|---|---|---|---|
| L1035 | 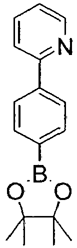 | 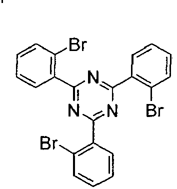 | 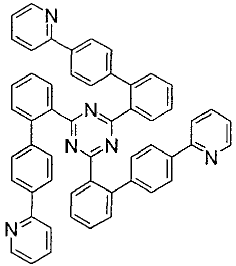 | 70% |
| | [908350-80-1] | [1690315-37-7] | | |

### F: Synthese der Metallkomplexe - Teil2

### Beispiel Ir(L1000)

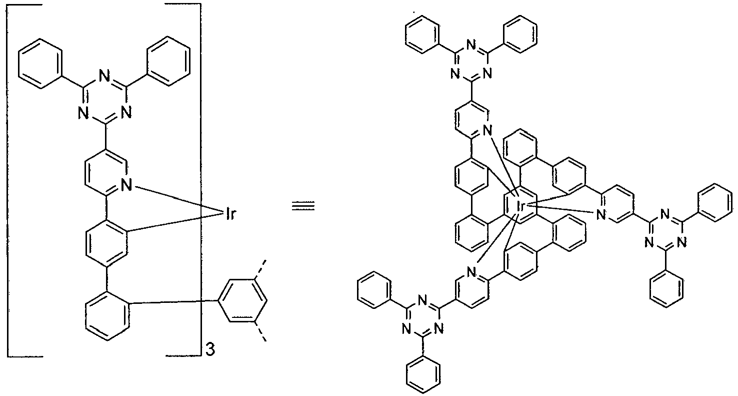

### Variante A:

Ein Gemisch aus 14.6 g (10 mmol) des Liganden L1000, 4.9 g (10 mmol) Tris-acetylacetonato-iridium(III) [15635-87-7] und 180 g Hydrochinon [123-31-9] wird in einem 1000 ml Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen. Der Kolben wird in einer Metallheizschale platziert. Die Apparatur wird über die Argonüberlagerung von oben her 15 min mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushalts-Aluminiumfolie thermisch isoliert, wobei die Isolation bis zur Mitte des Steigrohres des Wasserabscheiders geführt wird. Dann wird die Apparatur schnell mit einem Laborheizrührwerk auf 250 °C (Reaktionstemperatur) erhitzt, gemessen am Pt-100 Thermofühler, der in die aufgeschmolzene, gerührte Reaktionsmischung eintaucht. Während der nächsten 2 h (Reaktionszeit) wird das Reaktionsgemisch bei 250 °C gehalten, wobei wenig Kondensat abdestilliert und sich im Wasserabscheider sammelt. Nach Abkühlen auf 100 °C wird der Schmelzkuchen vorsichtig mit 500 ml Methanol versetzt und ausgekocht bis eine rote Suspension entsteht. Die so erhaltene rote Suspension wird über eine Umkehrfritte (P3) filtriert, der rote Feststoff wird dreimal mit 100 ml Methanol gewaschen und dann im Vakuum getrocknet. Rohausbeute: quantitativ. Die weitere Reinigung des roten Produkts erfolgt durch fünfmalige kontinuierliche Heißextraktion mit Ethylacetat (Extraktionsmittel, Vorlagemenge jeweils ca. 150 ml, Extraktionshülse: standard Soxhletthülsen aus Cellulose der Fa. Whatman) unter sorgfältigem Luft- und Lichtausschluss. Abschließend wird das Produkt im Hochvakuum (p ca. 10⁻⁶ mbar, T bis 250°C) getempert oder sublimiert (p ca. 10⁻⁶ mbar, T 300-400 °C). Ausbeute: 12.1 g (6.2 mmol), 62%. Reinheit: > 99.9 % nach HPLC.

Es können folgende Komplexe dargestellt werden:

| **Bsp.** | **Ir-Komplex** | **Ligand** | **Ausbeute** |
|---|---|---|---|
| | | **Variante** | |
| | | **Temperatur** | |
| | | **Reaktionszeit** | |
| | | **Extraktionsmittel** | |
| Ir(L1001) | 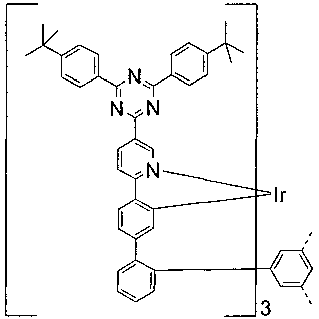 | L1001 | 65% |
| | | A | |
| | | 250 °C | |
| | | 2 h | |
| | | Acetoniril | |
| Ir(L1002) | 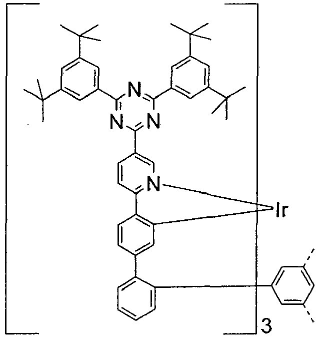 | L1002 | 70% |
| | | A | |
| | | 250 °C | |
| | | 2.5 h | |
| | | Acetoniril/Ethylacetat 1:1 | |
| Ir(L1003) | 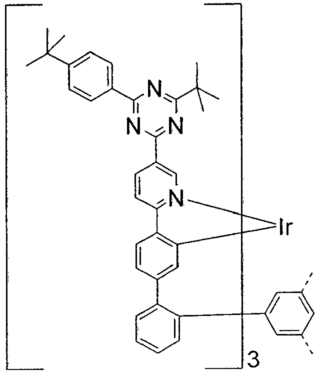 | L1003 | 80% |
| | | A | |
| | | 250 °C | |
| | | 3 h | |
| | | Toluol/Heptan 1:1 | |
| Ir(L1004) | 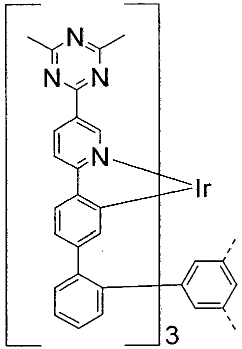 | L1004 | 68% |
| | | A | |
| | | 250 °C | |
| | | 3 h | |
| | | Toluol | |
| Ir(L1005) | 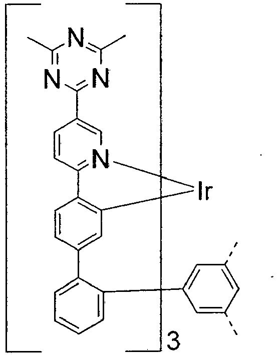 | L1005 | 75% |
| | | A | |
| | | 250 °C | |
| | | 4 h | |
| | | Toluol | |
| Ir(L1006) | 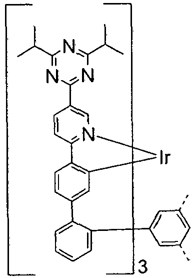 | L1006 | 74% |
| | | A | |
| | | 250 °C | |
| | | 3 h | |
| | | Ethylacetat | |
| Ir(L1007) | 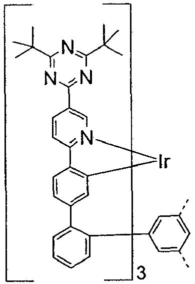 | L1007 | 66% |
| | | A | |
| | | 250 °C | |
| | | 2 h | |
| | | Ethylacetat/Acetoniril 1:1 | |
| Ir(L1008) | 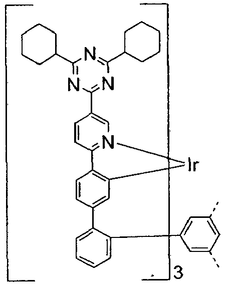 | L1008 | 67% |
| | | A | |
| | | 250 °C | |
| | | 3 h | |
| | | Toluol | |
| Ir(L1009) | 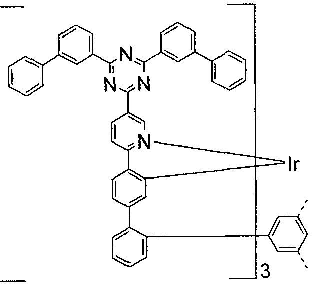 | L1009 | 60% |
| | | A | |
| | | 250 °C | |
| | | 2 h | |
| | | Toluol | |
| Ir(L1010) | 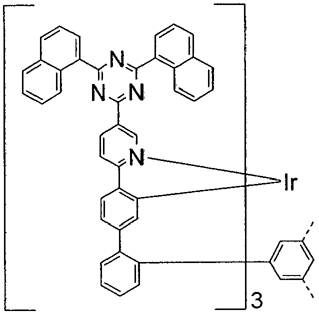 | L1010 | 58% |
| | | A | |
| | | 250 °C | |
| | | 4 h | |
| | | Toluol | |
| Ir(L1011) | 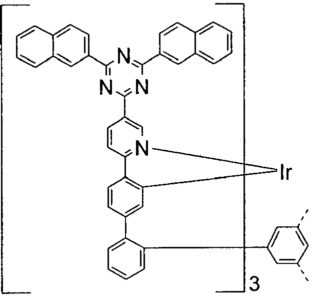 | L1011 | 59% |
| | | A | |
| | | 250 °C | |
| | | 4 h | |
| | | Toluol | |
| Ir(L1012) | 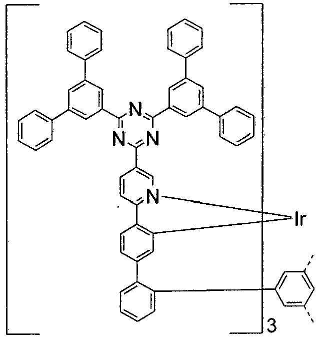 | L1012 | 80% |
| | | A | |
| | | 250 °C | |
| | | 2 h | |
| | | o-Xylol | |
| Ir(L1013) | 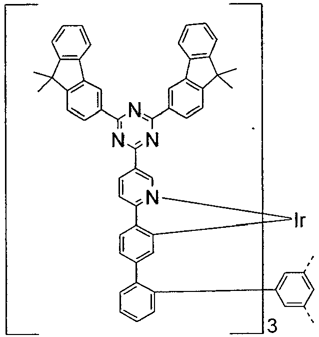 | L1013 | 76% |
| | | A | |
| | | 250°C | |
| | | 2 h | |
| | | Toluol | |
| Ir(L1014) | 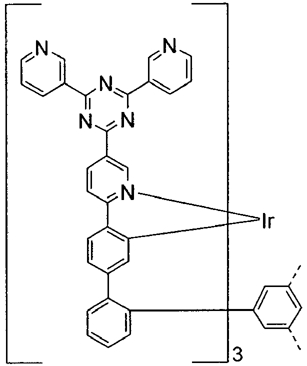 | L1014 | 50% |
| | | A | |
| | | 250 °C | |
| | | 3 h | |
| | | Toluol | |
| Ir(L1015) | 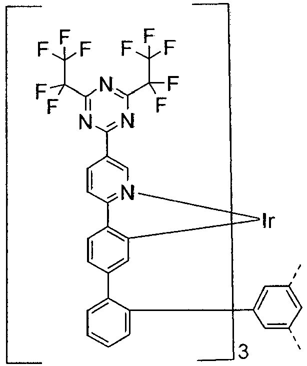 | L1015 | 53% |
| | | A | |
| | | 250 °C | |
| | | 3 h | |
| | | Ethylacetat | |
| Ir(L1016) | 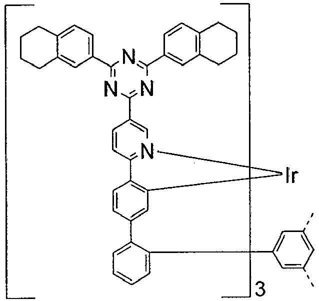 | L1016 | 70% |
| | | A | |
| | | 250°C | |
| | | 2 h | |
| | | Toluol | |
| Ir(L1017) | 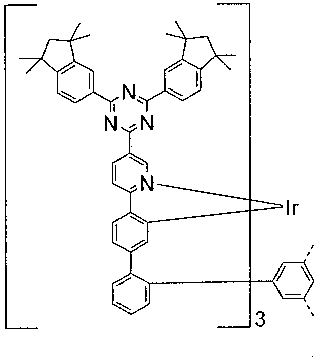 | L1017 | 65% |
| | | A | |
| | | 250°C | |
| | | 2 h | |
| | | Ethylacetat | |
| Ir(L1018) | 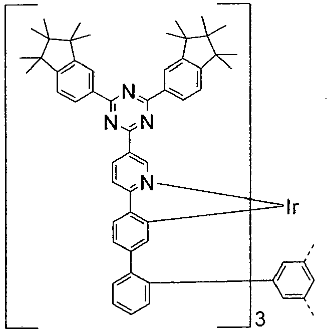 | L1018 | 69% |
| | | A | |
| | | 250°C | |
| | | 2 h | |
| | | Ethylacetat | |
| Ir(L1019) | 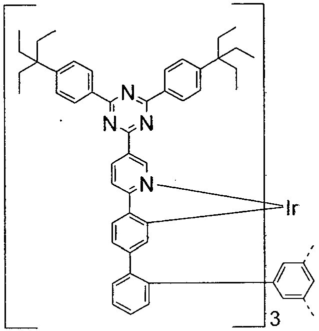 | L1019 | 72% |
| | | A | |
| | | 250 °C | |
| | | 3 h | |
| | | Cyclohexan | |
| Ir(L1020) | 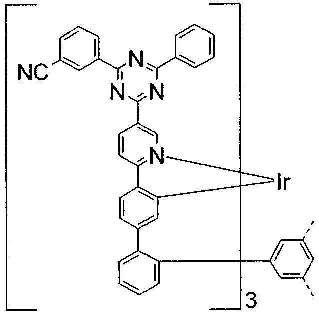 | L1020 | 14% |
| | | A | |
| | | 250°C | |
| | | 2 h | |
| | | Toluol | |
| Ir(L1021) | 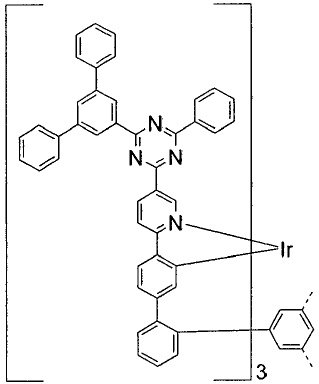 | L1021 | 68% |
| | | A | |
| | | 250 °C | |
| | | 2 h | |
| | | Toluol/Heptan 1:1 | |
| Ir(L1022) | 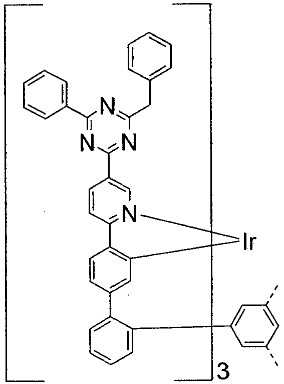 | L1022 | 60% |
| | | A | |
| | | 250 °C | |
| | | 3 h | |
| | | Ethylacetat | |
| Ir(L1023) | 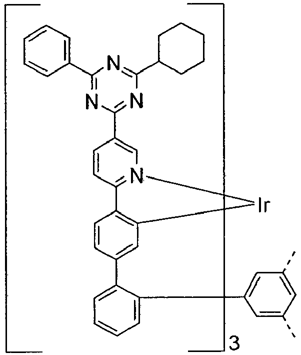 | L1023 | 58% |
| | | A | |
| | | 250 °C | |
| | | 2 h | |
| | | Ethylacetat | |
| Ir(L1024) | 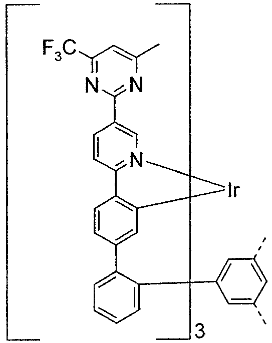 | L1024 | 64% |
| | | A | |
| | | 250 °C | |
| | | 4 h | |
| | | Acetonitril | |
| Ir(L1025) | 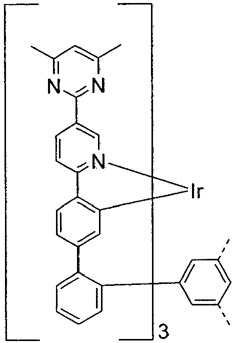 | L1025 | 66% |
| | | A | |
| | | 250 °C | |
| | | 3 h | |
| | | Ethylacetat | |
| Ir(L1026) | 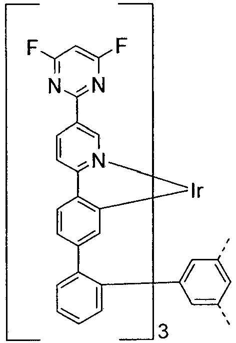 | L1026 | 62% |
| | | A | |
| | | 250°C | |
| | | 5 h | |
| | | Acetonitril | |
| Ir(L1027) | 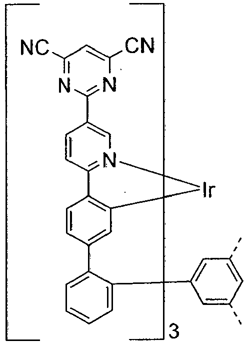 | L1027 | 16% |
| | | A | |
| | | 250°C | |
| | | 5 h | |
| | | Acetonitril | |
| Ir(L1028) | 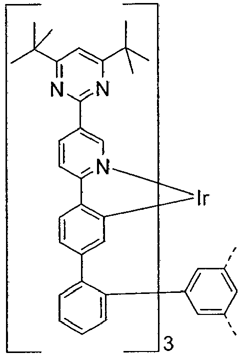 | L1028 | 75% |
| | | A | |
| | | 250°C | |
| | | 2 h | |
| | | Cyclohexan | |
| Ir(L1029) | 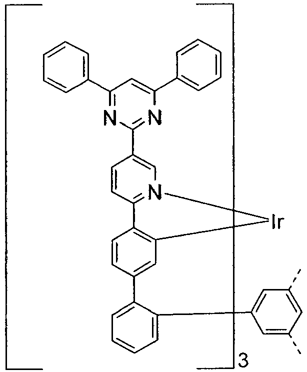 | L1029 | 80% |
| | | A | |
| | | 250°C | |
| | | 2 h | |
| | | Ethylacetat | |
| Ir(L1030) | 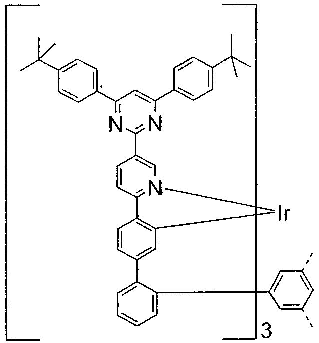 | L1030 | 55% |
| | | A | |
| | | 250°C 3 h | |
| | | Ethylacetat/Acetonitril 1:1 | |
| Ir(L1031) | 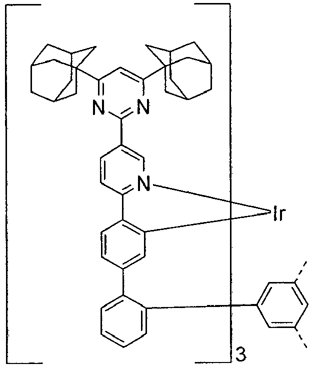 | L1031 | 53% |
| | | A | |
| | | 250°C | |
| | | 3 h | |
| | | - | |
| | | chromatographisch | |
| Ir(L1032) | 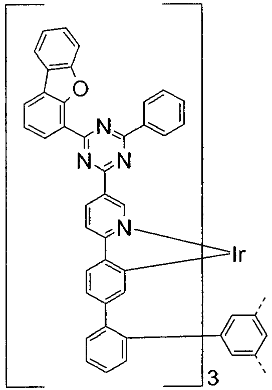 | L1032 | 74% |
| | | A | |
| | | 250 °C | |
| | | 3 h | |
| | | Toluol | |
| Ir(L1033) | 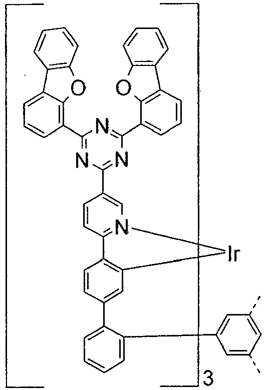 | L1033 | 70% |
| | | A | |
| | | 250 °C | |
| | | 4 h | |
| | | Toluol | |
| Ir(L1034) | 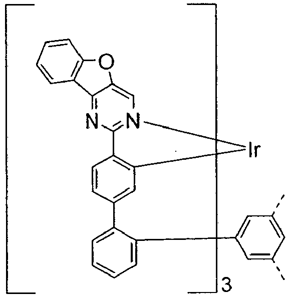 | L1034 | 63% |
| | | A | |
| | | 250 °C | |
| | | 2 h | |
| | | Ethylacetat | |
| Ir(L1035) | 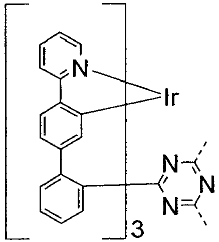 | L1035 | 55% |
| | | A | |
| | | 250°C | |
| | | 4 h | |
| | | Toluol | |
| Ir(L1036) | 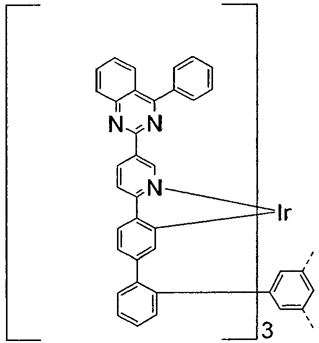 | L1036 | 60% |
| | | A | |
| | | 250°C | |
| | | 2 h | |
| | | Toluol | |
| Ir(L1037) | 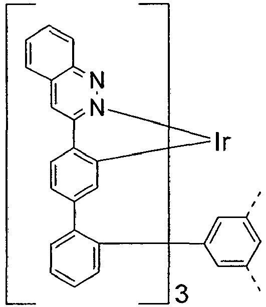 | L1037 | 45% |
| | | A | |
| | | 225°C 10 h | |
| | | Toluol | |

### G. Funktionalisierung der Metallkomplexe - Teil 2:

### 1) Halogenierung der Metallkomplexe:

Eine Lösung bzw. Suspension von 10 mmol eines Komplexes, der in para-Position zum Iridium A x C-H-Gruppen (mit A = 1, 2, 3) trägt, in 500 ml bis 2000 ml Dichlormethan, je nach Löslichkeit der Metallkomplexe, wird unter Licht- und Luftausschluss bei -30 bis +30 °C mit A x 10.5 mmol N Halogensuccinimid (Halogen: Cl, Br, I) versetzt und 20 h gerührt. In DCM schlecht lösliche Komplexe können auch in anderen Lösungsmitteln (TCE, THF, DMF, etc.) und bei erhöhter Temperatur umgesetzt werden. Anschließend wird das Lösungsmittel im Vakuum weitgehend entfernt. Der Rückstand wird mit 100 ml Methanol ausgekocht, der Feststoff wird abgesaugt, dreimal mit 30 ml Methanol gewaschen und dann im Vakuum getrocknet. Man erhält so die in para Position zum Iridium bromierten Iridium-Komplexe.

Unterstöchiometrische Bromierungen, z.B. Mono- und Di-Bromierungen von Komplexen mit 3 C-H-Gruppen para-Position zum Iridium, verlaufen meist weniger selektiv als die stöchio-metrischen Bromierungen. Die Rohprodukte dieser Bromierungen können chromatographisch (CombiFlash Torrent der Fa. A. Semrau) getrennt werden.

### Beispiel Ir(L1000-3Br):

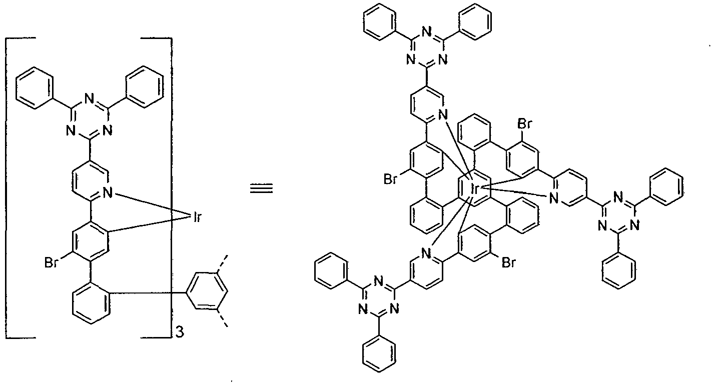

Eine bei 0°C gerührte Suspension von 24.7 g (15.0 mmol) Ir(L1000) in 2000 ml DCM wird auf einmal mit 8.8 g (49.5 mmol) N-Bromsuccinimid, sowie 0.1 ml 47%ige Bromwasserstoffsäure versetzt, 2 h bei 0°C gerührt und dann weitere 20 h bei Raumtemperatur. Nach Entfernen von ca. 1900 ml des DCMs im Vakuum wird die rote Suspension mit 150 ml Methanol ver-setzt, der Feststoff wird abgesaugt, dreimal mit ca. 50 ml Methanol gewaschen und dann im Vakuum getrocknet. Ausbeute: 25.5 g (13.5 mmol) 90 %; Reinheit: > 99.0 %ig nach ¹H-NMR.

Analog können folgende Verbindungen dargestellt werden:

| **Bsp.** | **Edukt** | **Ir-Komplex** | **Ausbeute** |
|---|---|---|---|
| Ir(L1001-3Br) | Ir(L1001) | 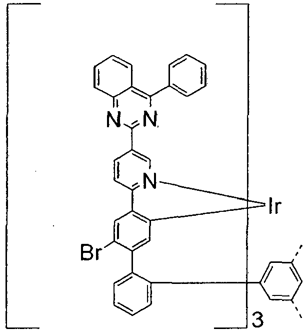 | 81% |
| Ir(L1002-3Br) | Ir(L1002) | 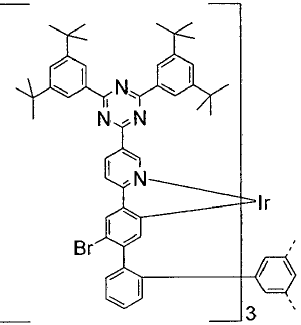 | 80% |
| Ir(L1003-3Br) | Ir(L1003) | 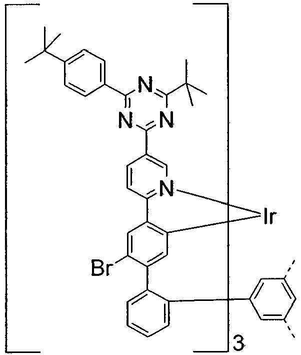 | 86% |
| Ir(L1004-3Br) | Ir(L1004) | 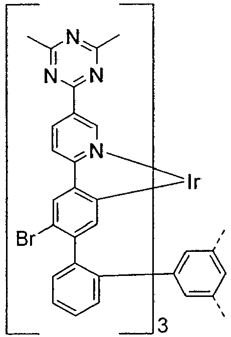 | 72% |
| Ir(L1005-3Br) | Ir(L1005) | 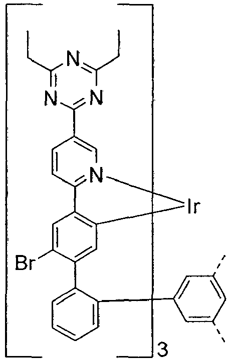 | 79% |
| Ir(L1006-3Br) | Ir(L1006) | 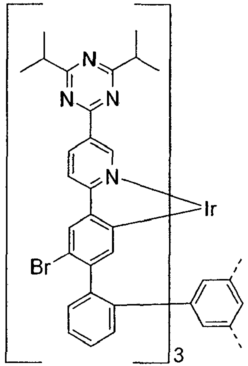 | 77% |
| Ir(L1007-3Br) | Ir(L1007) | 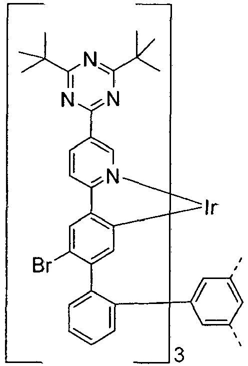 | 84% |
| Ir(L1008-3Br) | Ir(L1008) | 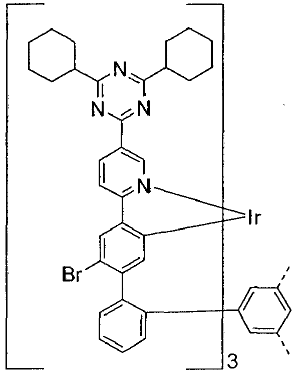 | 89% |
| Ir(L1009-3Br) | Ir(L1009) | 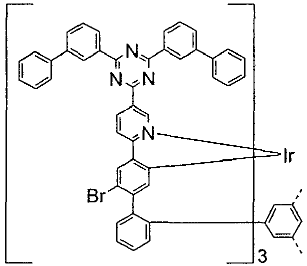 | 85% |
| Ir(L1010-3Br) | Ir(L1010) | 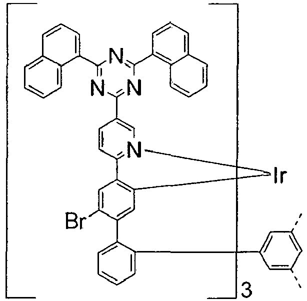 | 78% |
| Ir(L1011-3Br) | Ir(L1011) | 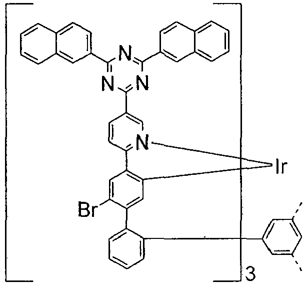 | 81% |
| Ir(L1012-3Br) | Ir(L1012) | 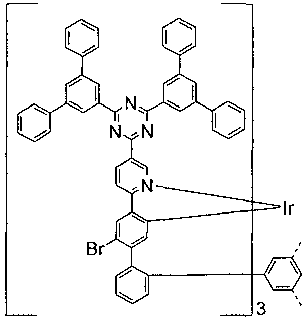 | 94% |
| Ir(L1013-3Br) | Ir(L1013) | 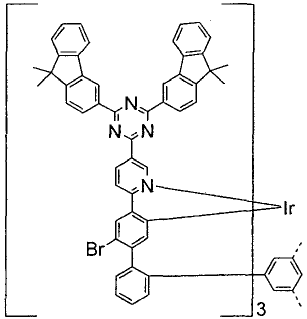 | 96% |
| Ir(L1014-3Br) | Ir(L1014) | 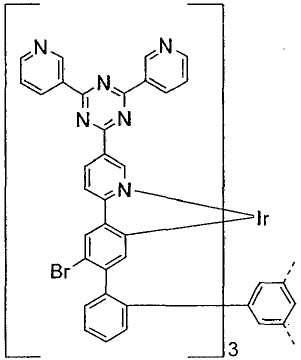 | 71% |
| Ir(L1015-3Br) | Ir(L1015) | 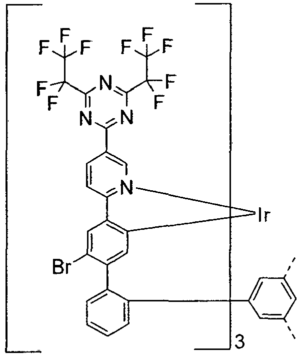 | 75% |
| Ir(L1016-3Br) | Ir(L1016) | 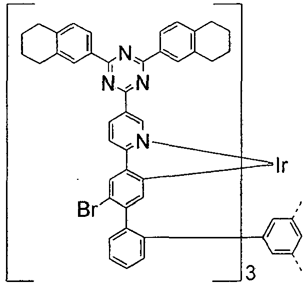 | 90% |
| Ir(L1017-3Br) | Ir(L1017) | 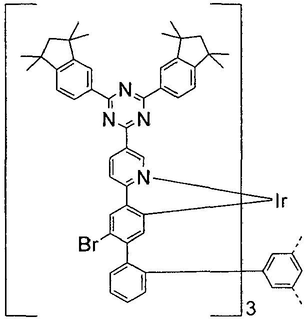 | 82% |
| Ir(L1018-3Br) | Ir(L1018) | 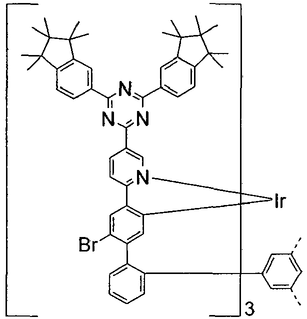 | 80% |
| Ir(L1019-3Br) | Ir(L1019) | 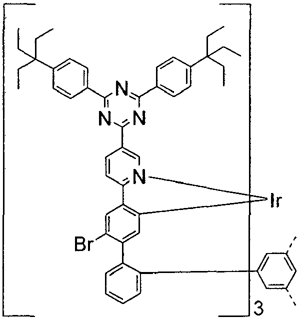 | 80% |
| Ir(L1020-3Br) | Ir(L1020) | 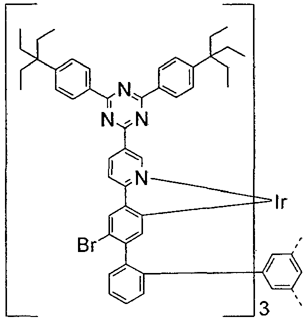 | 85% |
| Ir(L1021-3Br) | Ir(L1021) | 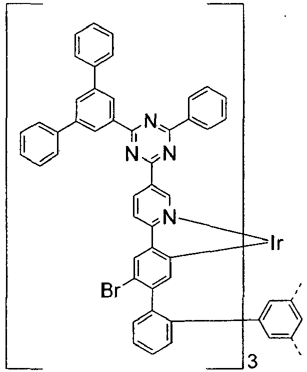 | 87% |
| Ir(L1022-3Br) | Ir(L1022) | 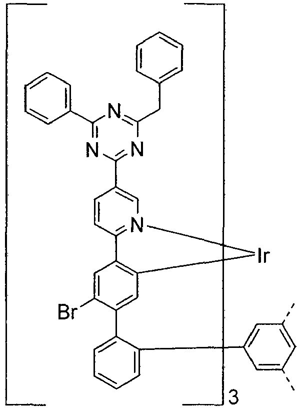 | 93% |
| Ir(L1023-3Br) | Ir(L1023) | 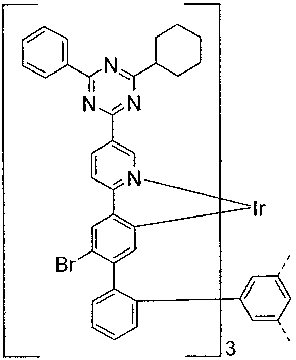 | 90% |
| Ir(L1024-3Br) | Ir(L1024) | 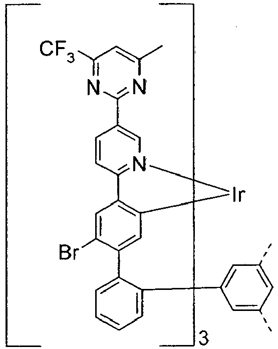 | 82% |
| Ir(L1025-3Br) | Ir(L1025) | 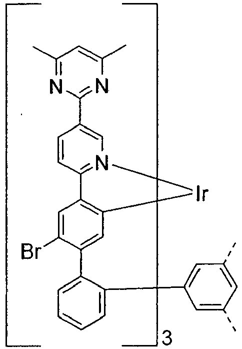 | 88% |
| Ir(L1026-3Br) | Ir(L1026) | 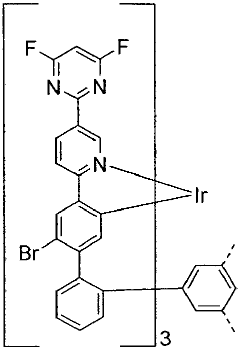 | 76% |
| Ir(L1027-3Br) | Ir(L1027) | 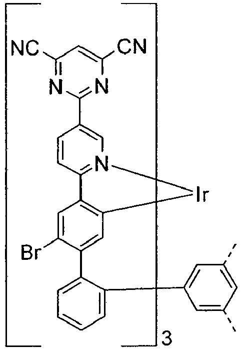 | 78% |
| Ir(L1028-3Br) | Ir(L1028) | 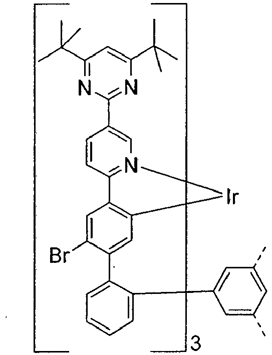 | 85% |
| Ir(L1029-3Br) | Ir(L1029) | 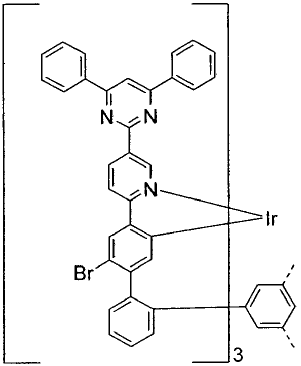 | 95% |
| Ir(L1030-3Br) | Ir(L1030) | 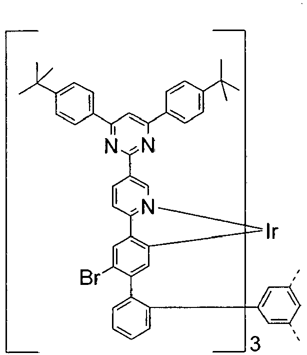 | 91% |
| Ir(L1031-3Br) | Ir(L1031) | 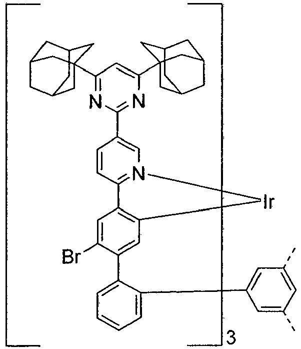 | 85% |
| Ir(L1032-3Br) | Ir(L1032) | 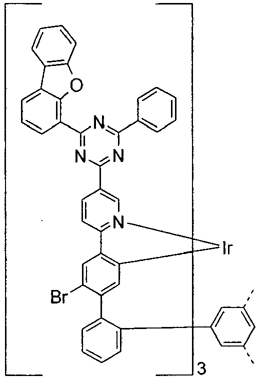 | 88% |
| Ir(L1033-3Br) | Ir(L1033) | 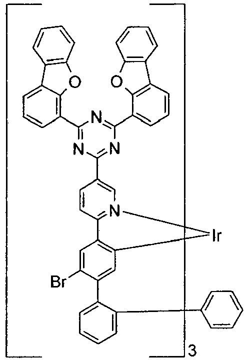 | 84% |

### 2) Suzuki-Kupplung an den bromierten Iridium-Komplexen. Variante A, zweiphasige Reaktionsmischung:

Eine Suspension von 10 mmol eines bromierten Komplexes, 12-30 mmol Boronsäure bzw. Boronsäureester pro Br-Funktion und 60 - 100 mmol Trikaliumphosphat in einem Gemisch aus 300 ml Toluol, 150 ml Ethanol und 150 ml Wasser wird mit 0.6 mmol Tri-ortho-tolylphosphin und dann mit 0.1 mmol Palladium(II)acetat versetzt und 24 h unter Rückfluss erhitzt. Nach Erkalten gibt man 500 ml Wasser und 200 ml Toluol zu, trennt die wässrige Phase ab, wäscht die organische Phase dreimal mit 200 ml Wasser, einmal mit 200 ml gesättigter Kochsalzlösung und trocknet über Magnesiumsulfat. Man filtriert über ein Celite-Bett ab, wäscht dieses mit Toluol nach, entfernt das Toluol fast vollständig im Vakuum, gibt 300 ml Methanol zu, saugt vom ausgefallenen Rohprodukt ab, wäscht dieses dreimal mit je 50 ml Methanol und trocknet im Vakuum. Das Rohprodukt wird an Kieselgel gesäult. Der Metallkomplex wird abschließend getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Variante B, einphasige Reaktionsmischung:

Eine Suspension von 10 mmol eines bromierten Komplexes, 12-30 mmol Boronsäure bzw. Boronsäureester pro Br-Funktion und 60 - 100 mmol der Base (Kaliumfluorid, Trikaliumphosphat (wasserfrei oder Monohydrat oder Trihydrat), Kaliumcarbonat, Cäsiumcarbonat etc.) und 100 g Glaskugeln (3 mm Durchmesser) in 100 ml - 500 ml eines aprotischen Lösungsmittels (THF, Dioxan, Xylol, Mesitylen, Dimethylacetamid, NMP, DMSO, etc.) wird mit 0.6 mmol Tri-ortho-tolyl-phosphin und dann mit 0.1 mmol Palladium(II)acetat versetzt und 24 h unter Rückfluss erhitzt. Alternativ können andere Phosphine wie Tri-tert-butylphosphin, S-Phos, X-Phos, RuPhos, XanthPhos, etc. eingesetzt werden, wobei bei diesen Phosphinen das bevorzugte Phosphin:Palladium Verhältnis 2:1 bis 1.2:1 beträgt. Man entfernt das Lösungsmittel im Vakuum, nimmt das Produkt in einem geeigneten Lösungsmittel (Toluol, Dichlormethan, Ethylacetat, etc.) auf und reinigt wie unter Variante A beschrieben.

### Synthese Ir1000:

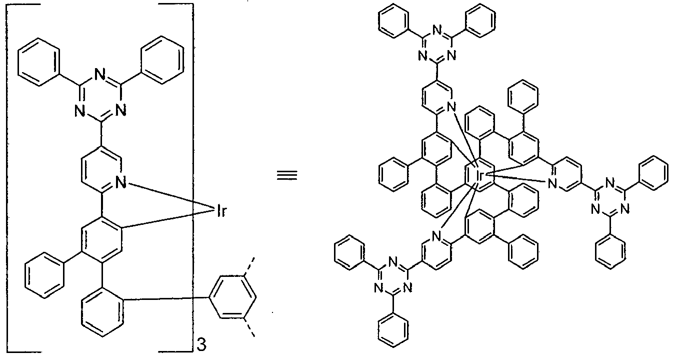

### Variante A:

Einsatz von 18.9 g (10.0 mmol) Ir(L1000-3Br) und 9.8 g (80.0 mmol) Phenylboronsäure [98-80-6], 19.1 g (90 mmol) Trikaliumphosphat (wasserfrei), 183 mg (0.6 mmol) Tri-o-tolylphosphin [6163-58-2], 23 mg (0.1 mmol) Palladium(II)acetat, 300 ml Toluol, 150 ml Ethanol und 150 ml Wasser, Rückfluss, 24 h. Zweimalige chromatographische Trennung an Kieselgel mit Toluol, anschließend fünfmalige Heißextraktion mit Ethylacetat. Ausbeute: 9.8 g (5.2 mmol) 52%; Reinheit: ca. 99.9 %ig nach HPLC.

Analog könnnen folgende Komplexe dargestellt werden:

| **Bsp.** | **Edukt Variante/Reaktionsbedingungen Boronsäure Heißextraktionsmittel** | **Ir-Komplex** | **Ausbeute** |
|---|---|---|---|
| Ir1001 | Ir(L1000-3Br) | 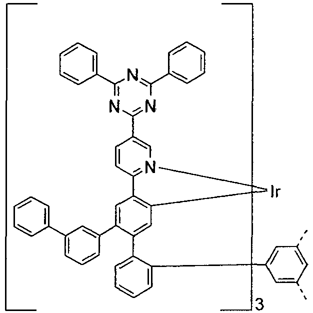 | 50% |
| | A | | |
| | 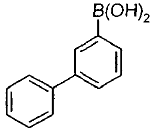 | | |
| | [5122-95-2] | | |
| | Toluol/Heptan 1:1 | | |
| Ir1002 | Ir(L1000-3Br) | 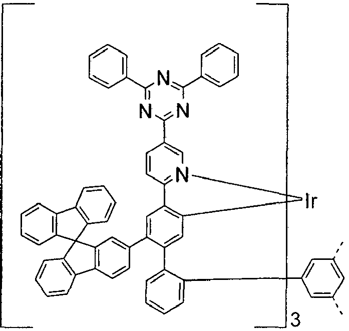 | 42% |
| | A | | |
| | 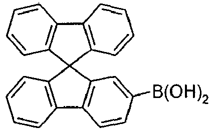 | | |
| | [236389-21-2] | | |
| | Ethylacetat | | |
| Ir1003 | Ir(L1000-3Br) | 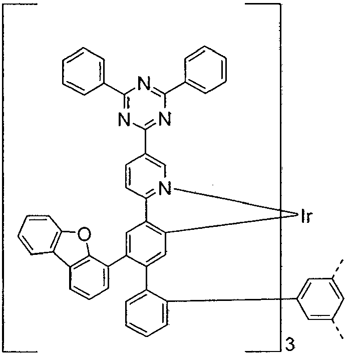 | 56% |
| | A | | |
| | 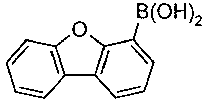 | | |
| | [100124-06-9] | | |
| | Ethylacetat | | |
| Ir1004 | Ir(L1009-3Br) | 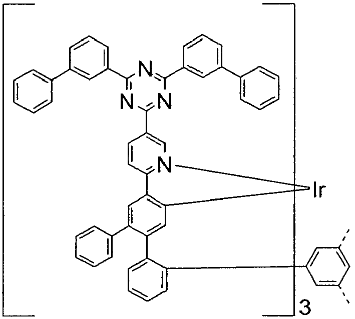 | 45% |
| | A | | |
| | 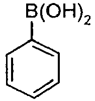 | | |
| | [98-80-6] | | |
| | Toluol | | |
| Ir1005 | Ir(L1009-3Br) | 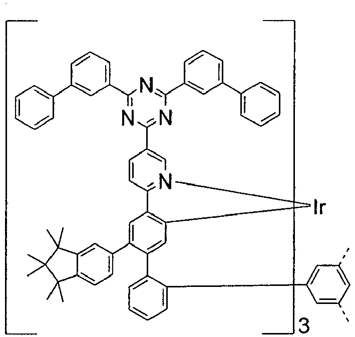 | 20% |
| | A | | |
| | 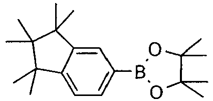 | | |
| | [1562418-16-9] | | |
| | Ethylacetat | | |
| Ir1006 | Ir(L1009-3Br) | 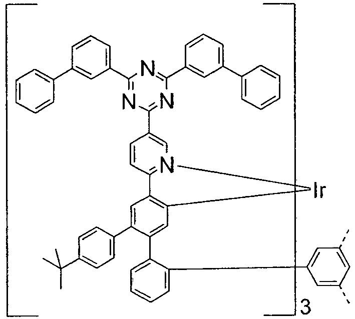 | 39% |
| | A | | |
| | 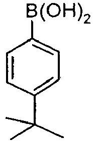 | | |
| | [123324-71-0] | | |
| | Toluol/Heptan 2:1 | | |
| Ir1007 | Ir(L1009-3Br) | 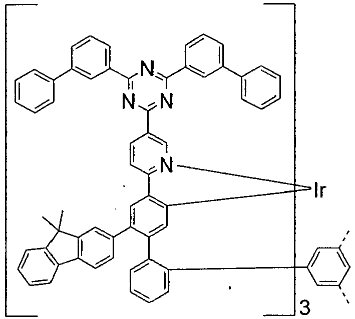 | 52% |
| | A | | |
| | 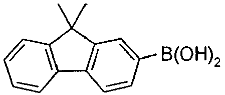 | | |
| | [333432-28-3] | | |
| | Toluol | | |
| Ir1008 | Ir(L1001-3Br) | 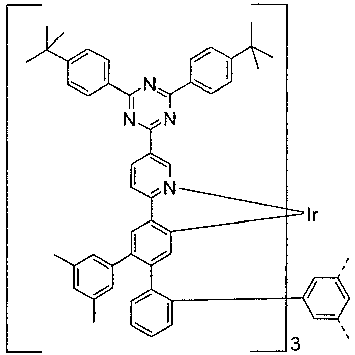 | 44% |
| | A | | |
| | 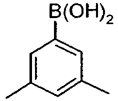 | | |
| | [172975-69-8] | | |
| | Toluol/Heptan 1:1 | | |
| Ir1009 | Ir(L1001-3Br) | 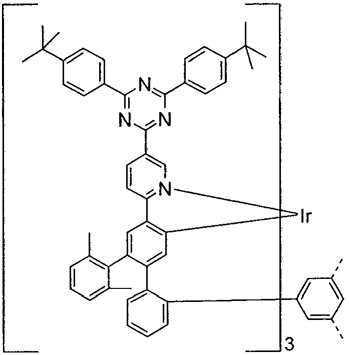 | 55% |
| | A | | |
| | 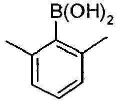 | | |
| | [100379-00-8] | | |
| | Ethylacetat | | |
| Ir1010 | Ir(L1002-3Br) | 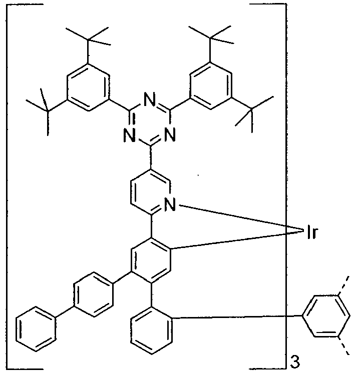 | 35% |
| | A | | |
| | 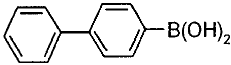 | | |
| | Ethylacetat | | |
| Ir1011 | Ir(L1003-3Br) | 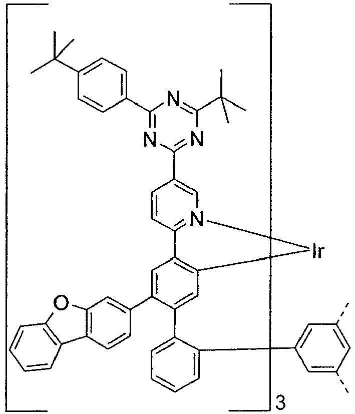 | 41% |
| | B | | |
| | Pd(OAc)₂/S-Phos 1:1.3, KF, Dioxan | | |
| | 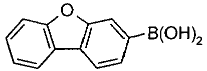 | | |
| | [395087-89-5] | | |
| | Toluol/Heptan 1:1 | | |
| Ir1012 | Ir(L1004-Br) | 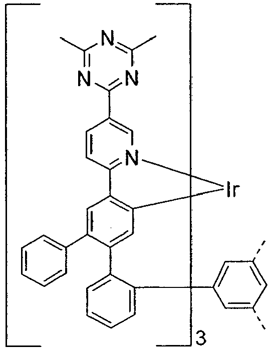 | 56% |
| | A | | |
| | 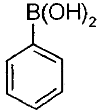 | | |
| | [98-80-6] | | |
| | Ethylacetat | | |
| Ir1013 | Ir(L1005-3Br) | 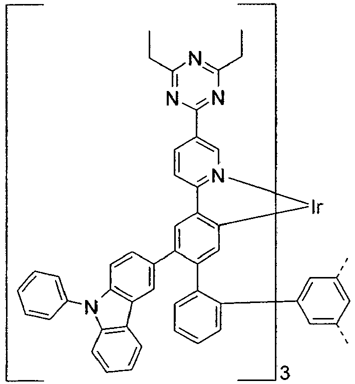 | 60% |
| | A | | |
| | 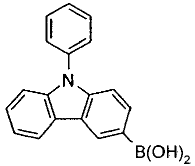 | | |
| | [854952-58-2] | | |
| | Ethylacetat | | |
| Ir1014 | Ir(L1006-3Br) | 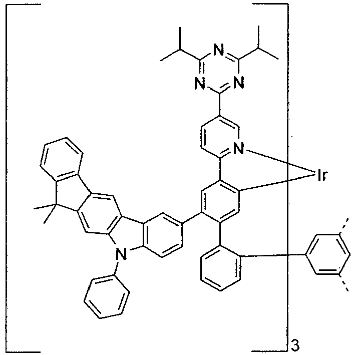 | 58% |
| | A | | |
| | 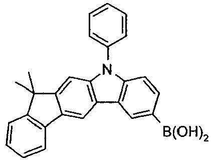 | | |
| | [1379585-25-7] | | |
| | Toluol | | |
| Ir1015 | Ir(L1007-3Br) | 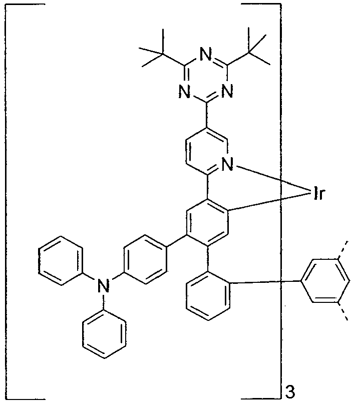 | 60% |
| | A | | |
| | 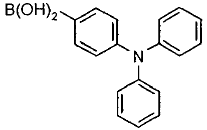 | | |
| | [201802-67-7] | | |
| | Ethylacetat | | |
| Ir1016 | Ir(L1008-3Br) | 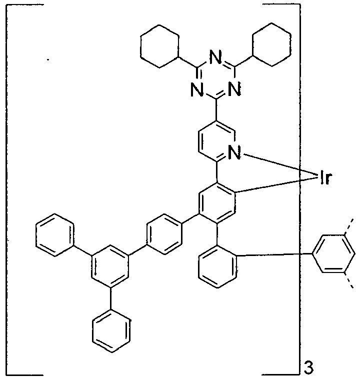 | 55% |
| | A | | |
| | 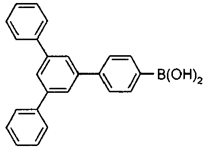 | | |
| | [491612-72-7] | | |
| | Toluol | | |
| Ir1017 | Ir(L1010-3Br) | 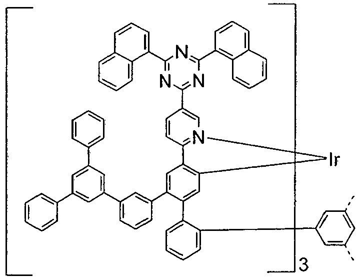 | 56% |
| | A | | |
| | 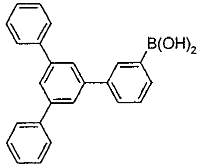 | | |
| | [1233200-59-3] | | |
| | Ethylacetat | | |
| Ir1018 | Ir(L1011-3Br) | 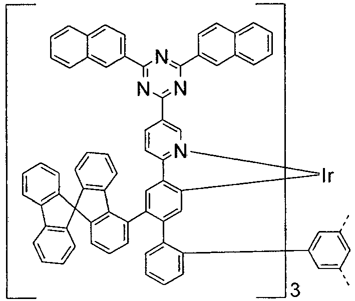 | 61% |
| | A | | |
| | 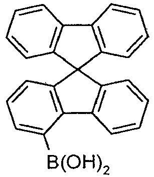 | | |
| | [1421789-05-0] | | |
| | Toluol | | |
| Ir1019 | Ir(L1012-3Br) | 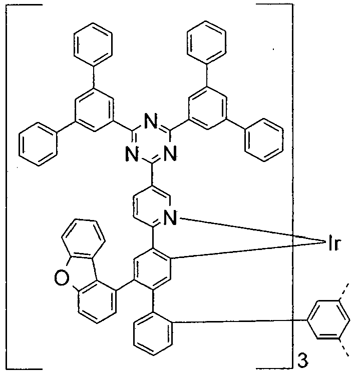 | 55% |
| | A | | |
| | 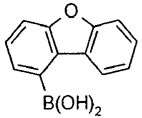 | | |
| | [162607-19-4] | | |
| | Toluol | | |
| Ir1020 | Ir(L1013-3Br) | 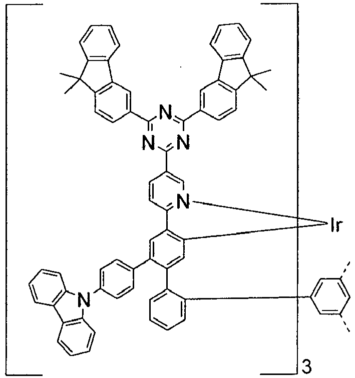 | 50% |
| | A | | |
| | 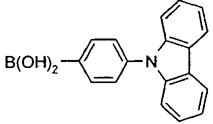 | | |
| | [419536-33-7] | | |
| | Ethylacetat | | |
| Ir1021 | Ir(L1014-3Br) | 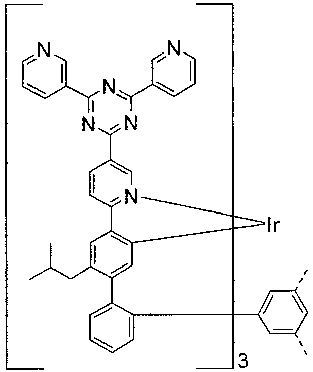 | 28% |
| | B | | |
| | Pd(OAc)₂/S-Phos 1:1.3, CsCO₃, Toluol | | |
| | 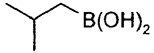 | | |
| | [84110-40-7] | | |
| | Toluol/Heptan 2:1 | | |
| Ir1022 | Ir(L1015-3Br) | 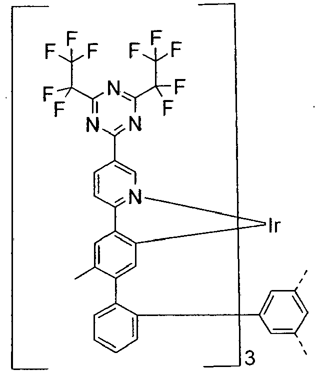 | 16% |
| | B | | |
| | Pd(OAc)₂/S-Phos 1:1.3, K₃PO₄ x 3 H₂O, Toluol | | |
| | 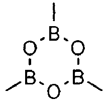 | | |
| | [823-96-1] | | |
| | Ethylacetat | | |
| Ir1023 | Ir(L1016-3Br) | 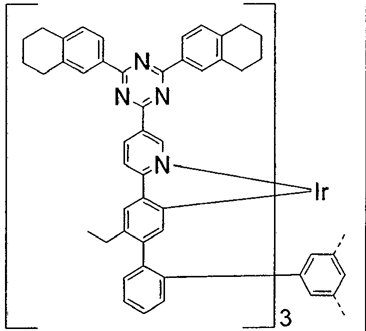 | 20% |
| | B | | |
| | Pd(OAc)₂/S-Phos, 1:1.3, CsCO₃, Dioxan | | |
| | 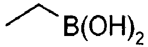 | | |
| | [4433-63-0] | | |
| | Toluol/Heptan 5:1 | | |
| Ir1024 | Ir(L1017-3Br) | 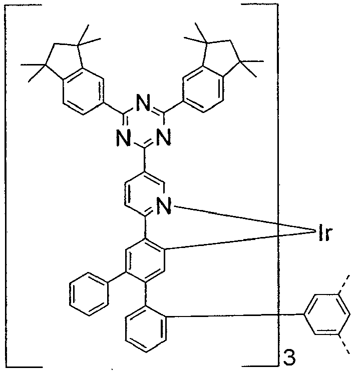 | 60% |
| | A | | |
| | 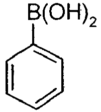 | | |
| | [98-80-6] | | |
| | Ethylacetat | | |
| Ir1025 | Ir(L1018-3Br) | 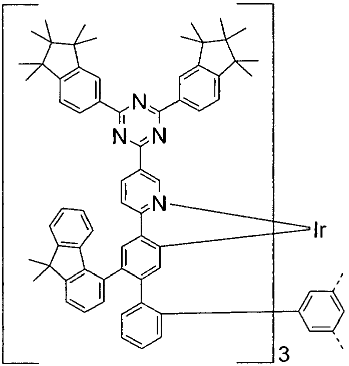 | 50% |
| | A | | |
| | 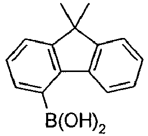 | | |
| | [1246022-50-3] | | |
| | Ethylacetat | | |
| Ir1026 | Ir(L1019-3Br) | 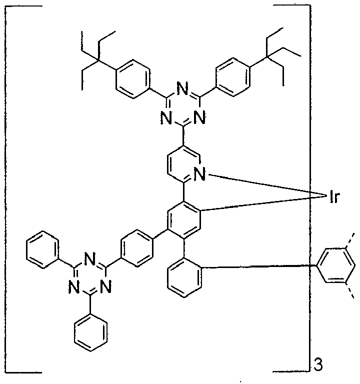 | 41% |
| | A | | |
| | 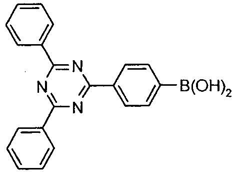 | | |
| | [1313018-07-3] | | |
| | Toluol | | |
| Ir1027 | Ir(L1020-3Br) | 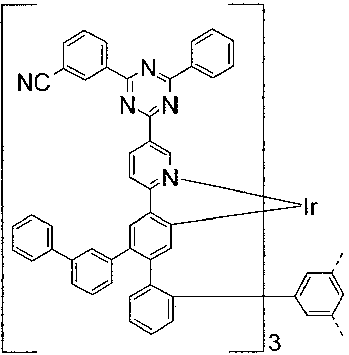 | 71% |
| | A | | |
| | 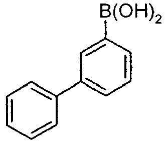 | | |
| | [5122-95-2] | | |
| | Toluol | | |
| Ir1028 | Ir(L1021-3Br) | 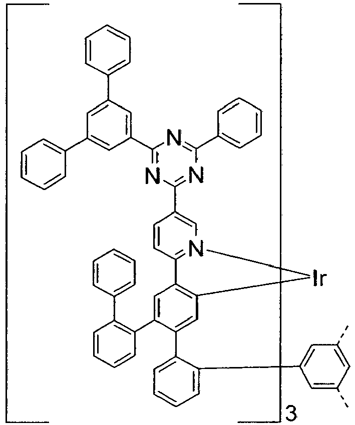 | 14% |
| | A | | |
| | 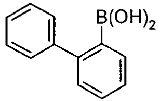 | | |
| | [4688-76-0] | | |
| | Toluol | | |
| Ir1030 | Ir(L1022-Br) | 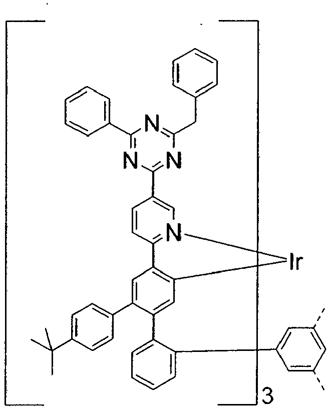 | 45% |
| | A | | |
| | 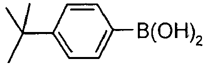 | | |
| | [123324-71-0] | | |
| | Ethylacetat | | |
| Ir1031 | Ir(L1023-Br) | 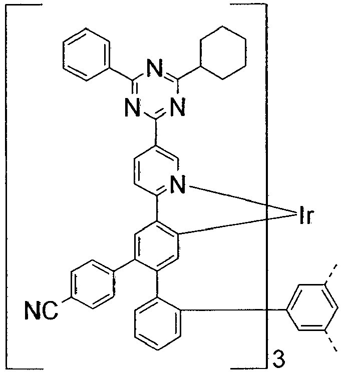 | 61% |
| | A | | |
| | 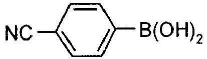 | | |
| | [126747-14-6] | | |
| | Toluol/Heptan 3:1 | | |
| Ir1032 | Ir(L1024-3Br) | 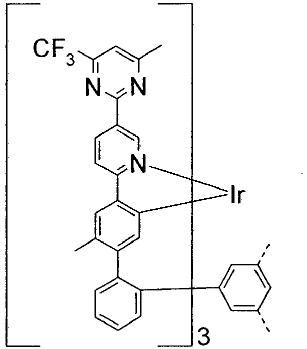 | 27% |
| | B | | |
| | Pd(OAc)₂/S-Phos 1:1.3, K₃PO₄ x 3 H₂O, Toluol | | |
| | 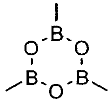 | | |
| | [823-96-1] | | |
| | Ethylacetat | | |
| Ir1033 | Ir(L1025-3Br) | 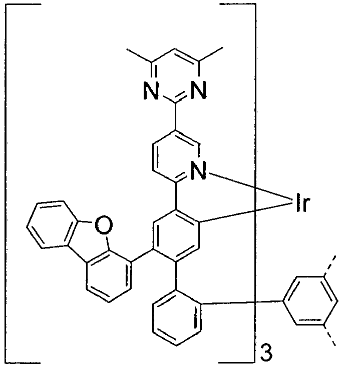 | 50% |
| | A | | |
| | 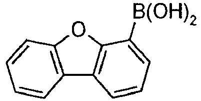 | | |
| | [100124-06-9] | | |
| | Toluol | | |
| Ir1034 | Ir(L1026-3Br) | 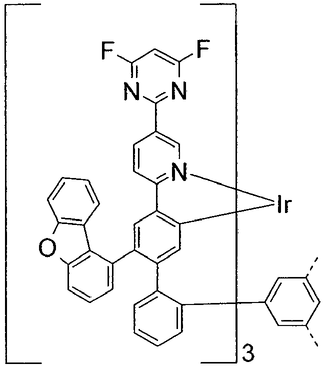 | 40% |
| | A | | |
| | 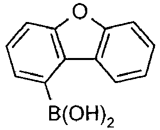 | | |
| | [162607-19-4] | | |
| | Ethylacetat | | |
| Ir1035 | Ir(L1027-3Br) | 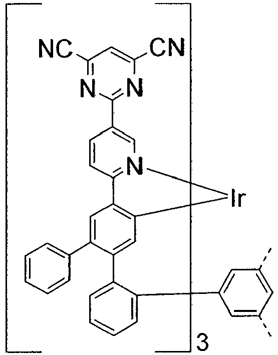 | 50% |
| | A | | |
| | 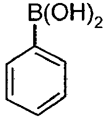 | | |
| | [98-80-6] | | |
| | Toluol | | |
| Ir1036 | Ir(L1028-3Br) | 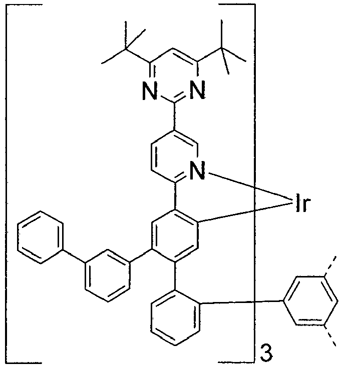 | 67% |
| | A | | |
| | 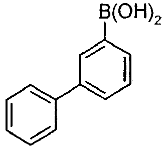 | | |
| | [5122-95-2] | | |
| | Ethylacetat | | |
| Ir1037 | Ir(L1029-3Br) | 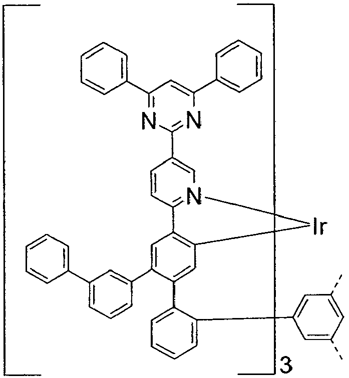 | 70% |
| | A | | |
| | 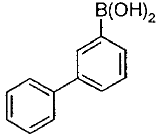 | | |
| | [5122-95-2] | | |
| | Toluol | | |
| Ir1038 | Ir(L1030-3Br) | 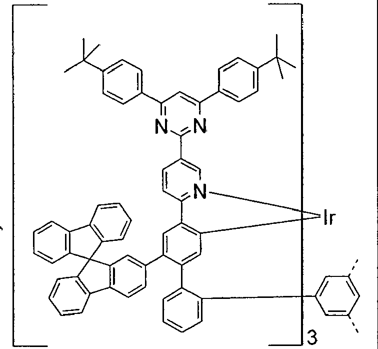 | 40% |
| | A | | |
| | 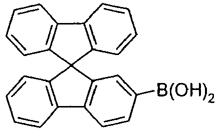 | | |
| | [236389-21-2] | | |
| | Ethylacetat | | |
| Ir1039 | Ir(L1031-3Br) | 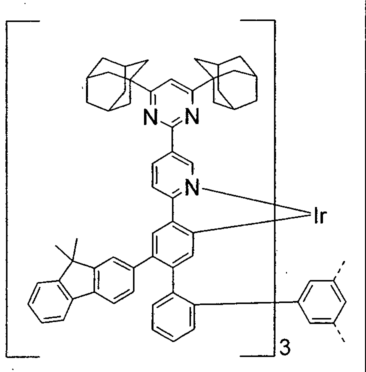 | 61% |
| | A | | |
| | 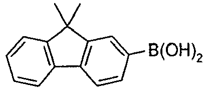 | | |
| | [333432-28-3] | | |
| | Toluol/Heptan 3:1 | | |
| Ir1040 | Ir(L1032-3Br) | 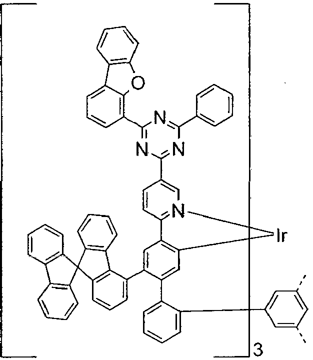 | 88% |
| | A | | |
| | 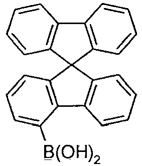 | | |
| | [1421789-05-0] | | |
| | Toluol | | |
| Ir1041 | Ir(L1033-3Br) | 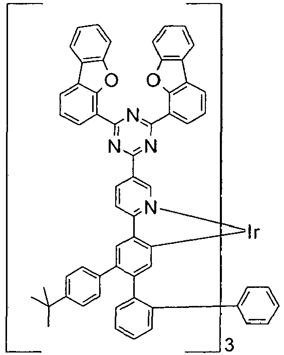 | 38% |
| | A | | |
| | 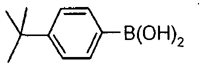 | | |
| | [123324-71-0] | | |
| | Toluol | | |

### H: Synthese unsymmetrischer Liganden

### 1. Variante:

### Beispiel S1200 und S1201: Suzuki-Kupplung mit anschließender chromatographischer Trennung

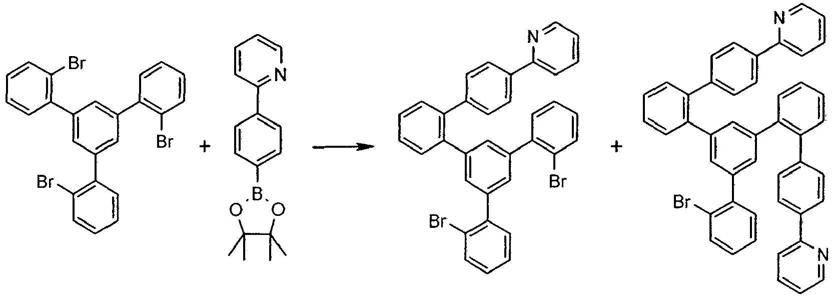

In einen 2 L-Vierhalskolben mit Rückflusskühler, Argonüberlagerung, KPG-Rührer und Innen-thermometer werden 50 g 1,3,5-tris(2-bromophenyl)benzol (92.1 mmol) [380626-56-2], 51.8 g 2-[4-(4,4,5,5-Tetramethyl-[1,3,2]dioxaborolan-2-yl)-phenyl]pyridine (184.2 mmol) [908350-80-1] und 84.0 g Cäsiumfluorid (553 mmol) eingewogen, der Kolben mit Argon inertisiert und anschließend mit 1000 ml Diethylenglycoldimethylether sowie 100 g Glasperlen (Durchmes-ser 3 mm) versetzt. Die Rektionsmischung wird 15 min mit Argon inertisiert, dann werden 3.2 g Bis(triphenylphosphin)palladium(II)chlorid (4.6 mmol) [13965-03-2] zugegeben und die Reaktionsmischung bei 130 °C Innentemperatur über Nacht gerührt. Nach dem Abkühlen wird das Lösungsmittel am Rotationsverdampfer bei ca. 10 mbar und 80 °C Badtemperatur weitgehend abrotiert und der Rückstand mit 500 ml Toluol und 500 ml Wasser extraktiv im Scheidetrichter aufgearbeitet. Die wässrige Phase wird einmal mit 200 ml Toluol extrahiert, dann werden die vereinigten organischen Phasen einmal mit 300 ml Wasser und einmal mit 150 ml gesättigter Kochsalzlösung gewaschen, über Natriumsulfat getrocknet und das Lösungmittel im Vakuum entfernt. Der Rückstand wird an Kieselgel chromatographiert. Gradientenelution: Laufmittel: Toluol 98% / Ethylacetat 2%. Ausbeute: einfach substituiertes Produkt S1200: 11.9 g (19.3 mmol), 21% als gelber Feststoff. Reinheit 95%ig nach 1H-NMR. Ausbeute zweifach substituiertes Produkt S1201: 21.7 g (31.3 mmol) 34% als brauner Feststoff. Reinheit 95%ig nach 1H-NMR.

Analog können folgende Synthone hergestellt werden.

| **Bsp.** | **Produkt** | **Ausbeute** |
|---|---|---|
| | **Boronsäure/-ester** | |
| S1204/S1205 | 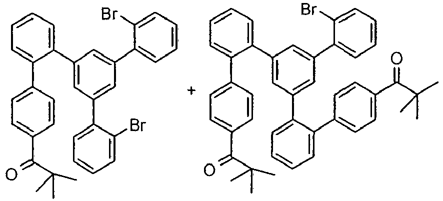 | 18%/32% |
| | S1136 | |
| S1206/S1207 | 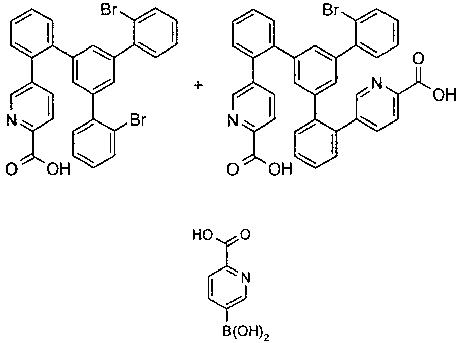 | 15%/28% |
| | [913836-11-0] | |

### 2. Variante:

### Beispiel S1202: Silylierung von 1,3,5-Tris(2-bromophenyl)benzol

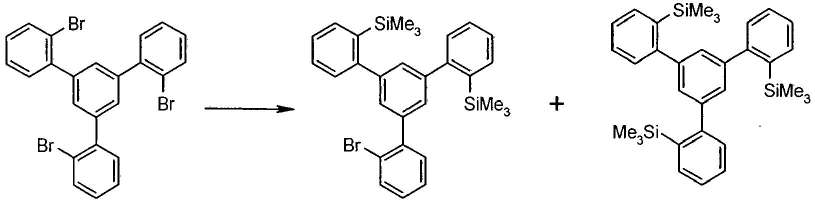

In einem 2L-Vierhalskolben mit KPG-Rührer, Innenthermometer und Argonüberlagerung werden 50 g 1,3,5-Tris(2-bromophenyl)benzol (92.1 mmol) [380626-56-2] in 1000 ml trockenem THF gelöst und im Aceton/Trockeneisbad auf -78 °C abgekühlt. Dann werden 92.1 ml einer 2.5 mol/L Lösung von n-Butyllithium (230.3 mmol) in n-Hexan [109-72-8] so zugetropft, dass die Innentemperatur -65 °C nicht übersteigt. Es wird 1 h bei dieser Temperatur nachgerührt. Anschließend werden 30.5 ml Chlortrimethylsilan (239.5 mmol) [75-77-4] in 300 ml trockenem THF über einen Tropftrichter zügig zugetropft, die Reaktionsmischung wird noch 1 h bei -78 °C gerührt und dann langsam über Nacht auf Raumtemperatur auftauen gelassen. Es werden langsam 20 ml Methanol zugetropft. Anschließend wird die Reaktionsmischung in einen Scheidetrichter überführt und extraktiv mit 1000 ml Ethylacetat und 1000 ml Wasser aufgearbeitet. Die wässrige Phase wird nochmals mit 500 ml Ethylacetat extrahiert, die vereinigten organischen Phasen mit 500 ml Wasser und 250 ml gesättigter Natriumchloridlösung gewaschen, über Natriumsulfat getrocknet und zur Trockene einrotiert. Es wird ein gelbes Öl enrhalten, das ohne weitere Aufreinigung in der nächsten Stufe umgesetzt wird. Aus-beute: 43.1 g, davon nach NMR ca. 60% 2-fach-TMS substituiertes Produkt und ca. 40% 3-fach-TMS substituiertem Produkt.

### Beispiel S1203: Suzuki-Kupplung des silylierten Bromphenylbenzols

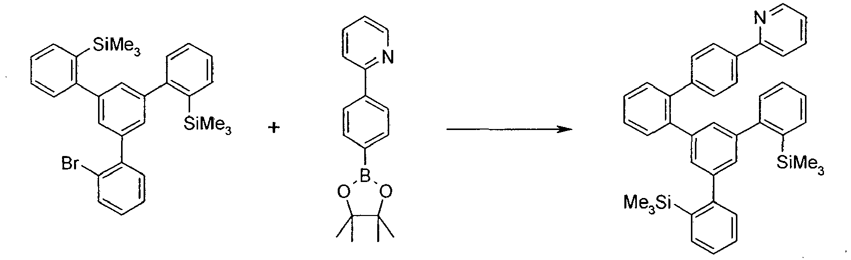

In einen 1L-Vierhalskolben mit Rückflusskühler, KPG-Rührer, Heizbad und Argonanschluss werden 40.0 g (davon 24 mmol [2-[3-(2-bromophenyl)-5-(2-trimethylsilylphenyl)phenyl]phenyl]-trimethyl-silane) S1202, 16.2 g 2-[4-(4,4,5,5-Tetramethyl-[1,3,2]dioxaborolan-2-yl)-phenyl]pyridine (57.6 mmol) [908350-80-1], 7.6 g (72 mmol) Natriumcarbonat, 567 mg (2.2 mmol) Triphenylphosphin [603-35-0] und 162 mg (0.72 mmol) Palladium(II)acetat [3375-31-3] eingewogen und mit 200 ml Toluol, 100 ml Ethanol und 100 ml Wasser versetzt. Die Reaktionsmischung wird mit Argon inertisiert und unter Rückfluss für 24 Stunden gerührt. Nach Abkühlen wird die Organische Phase abgetrennt, die wässrige Phase einmal mit 100 ml Toluol extrahiert, die vereinigten organischen Phase einmal mit 200 ml Wasser und einmal mit 100 ml gesättigter Kochsalzlösung gewaschen, über Natriumsulfat getrocknet und am Rotationsverdampfer auf 50 ml eingeengt. Die erhaltene Lösung wird an Kieselgel chromatographiert. Gradientenelution Laufmittel: Heptan > Heptan/Dichlormethan 1:1. Die Produktfraktionen werden einrotiert, zum erhaltenen rosafarbenen Öl werden 100 ml n-Heptan gegeben und über Nacht bei Raumtemperatur gerührt. Der ausgefallenen Feststoff wird abgesaugt und zweimal mit 20 ml n-Heptan gewaschen. Es wird ein weißer Feststoff erhalten. Ausbeute: 11.6 g (19.2 mmol), 80%; Reinheit: 98%%ig nach ¹H-NMR.

### Beispiel S1200: Bromierung von S1203

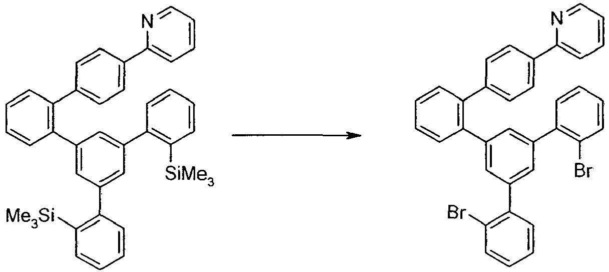

In einem 500 ml 2-Halskolben mit Magnetrührfisch und Argonüberlagerung werden 11.5 g S1203 (19.0 mmol) in 180 ml Dichlormethan gelöst und im Eis/Wasserbad auf 0 °C gekühlt. In einem Tropftrichter werden 2.5 ml Brom (49.4 mmol) mit 100 ml Dichlormethan gemischt und dann langsam zugetropft. Nach beendeter Zugabe wird das Eis/Wasserbad entfernt und die Reaktionsmischung weitere 6 h bei Raumtemperatur gerührt. Dann werden 20 ml gesättigte Natriumsulfitlösung zugetropft, 50 ml gesättigte Natriumhydrogencarbonatlösung sowie 3 ml 20%ige (w/w) Natronlauge. Das Reaktionsgemisch wird in einen Scheiderichter überführt, die organische Phase abgetrennt und 5 x mit 100 ml Wasser und zweimal mit 50 ml gesättigter Natriumchloridlösung gewaschen, über Natriumsulfat getrocknet und im Vakuum eingeengt. Es wird ein gelber Feststoff erhalten. Ausbeute: 9.4 g (15.2 mmol), 80%, Reinheit 95%ig nach ¹H-NMR.

### Beispiel L1200: Synthese der Liganden

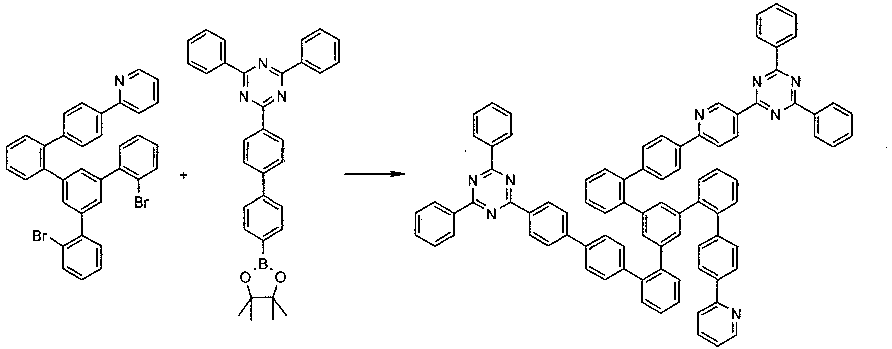

In einen 1 L-Vierhalskolben mit Rückflusskühler, Argonüberlagerung, KPG-Rührer und Innenthermometer werden 10 g S1200 (16.2 mmol), 19.9 g S1100 (38.9 mmol) und 14.8 g Cäsiumfluorid (97 mmol) eingewogen, der Kolben mit Argon inertisiert und anschließend mit 500 ml Diethylenglycoldimethylether sowie 50 g Glasperlen (Durchmesser 3 mm) versetzt. Die Rektionsmischung wird 15 min unter Argon Atmosphäre inertisiert, dann werden 569 mg Bis(triphenylphosphin)palladium(II)chlorid (0.81 mmol) [13965-03-2] zugegeben und die Reaktionsmischung bei 130 °C Innentemperatur über Nacht gerührt. Nach dem Abkühlen wird das Lösungsmittel am Rotationsverdampfer bei ca. 10 mbar und 80 °C Badtemperatur weitgehend abrotiert und der Rückstand mit 200 mlToluol und 300 ml Wasser extraktiv in einem Scheidetrichter aufgearbeitet. Die wässrige Phase wird einmal mit 100 ml Toluol extrahiert, dann werden die vereinigten organischen Phasen einmal mit 200 ml Wasser und einmal mit 100 ml gesättigter Kochsalzlösung gewaschen, über Natriumsulfat getrocknet und das Lösungmittel im Vakuum entfernt. Der Rückstand wird an Kieselgel chromatographiert. Gradientenelution: Laufmittel: Heptan/Ethylacetat 4:1 > Heptan/Ethylacetat 3:1. Es wird ein weißer Feststoff erhalten 13.5 g (11.0 mmol), 68% Reinheit 97%ig nach ¹H-NMR.

Analog können folgende Liganden synthetisiert werden:

| **Bsp**. | **Produkt/** | **Ausbeute** |
|---|---|---|
| | **Synthon/** | |
| | **Aufeinigung** | |
| L1202 | 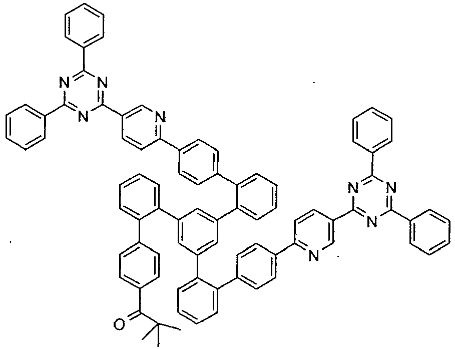 | 70% |
| | S1204 | |
| | chromatorgraphisch | |
| | Toluol/ Ethylacetat 9:1 | |
| L1204 | 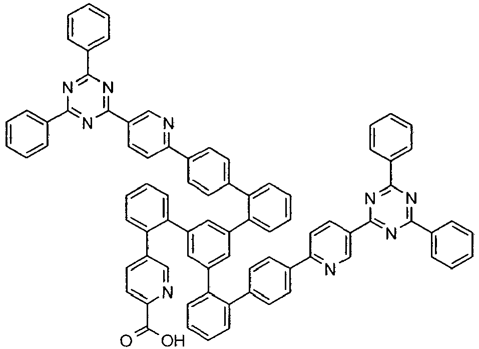 | 55% |
| | S1206 | |
| | chromatographisch | |
| | Toluol/Ethylacetat 2:1 → Toluol/Ethylacetat 1:2 | |

### Beispiel L1201: Synthese der Liganden am

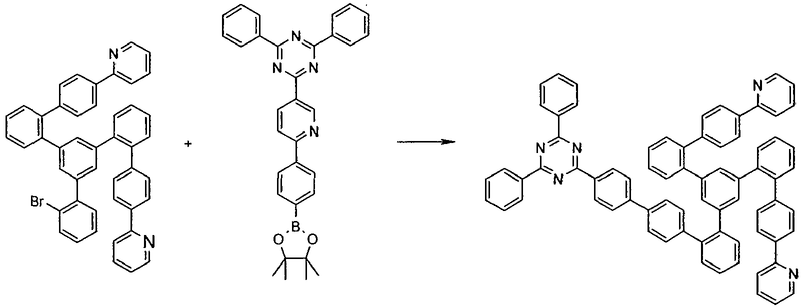

In einen 1 L-Vierhalskolben mit Rückflusskühler, Argonüberlagerung, KPG-Rührer und Innenthermometer werden 10 g S1201 (14.5 mmol), 8.9 g S1100 (17.3 mmol) und 13.2 g Cäsium-fluorid (87 mmol) eingewogen, der Kolben mit Argon inertisiert und anschließend mit 400 ml Diethylenglycoldimethylether sowie 50 g Glasperlen (Durchmesser 3 mm) versetzt. Die Rek-tionsmischung wird 15 min unter Argon Atmosphäre inertisiert, dann werden 509 mg Bis(triphenylphosphin)palladium(II)chlorid (0.73 mmol) [13965-03-2] zugegeben und die Reak-tionsmischung bei 130 °C Innentemperatur über Nacht gerührt. Nach dem Abkühlen wird das Lösungsmittel am Rotationsverdampfer bei ca. 10 mbar und 80 °C Badtemperatur weitge-hend abrotiert und der Rückstand mit 200 mlToluol und 300 ml Wasser extraktiv in einem Scheidetrichter aufgearbeitet. Die wässrige Phase wird einmal mit 100 ml Toluol extrahiert, dann werden die vereinigten organischen Phasen einmal mit 200 ml Wasser und einmal mit 100 ml gesättigter Kochsalzlösung gewaschen, über Natriumsulfat getrocknet und das Lösungmittel im Vakuum entfernt. Der Rückstand wird an Kieselgel chromatographiert. Gradi-entenelution: Laufmittel: Dichlormethan > Dichlormethan/Ethylacetat 95:5. Der erhaltene gelbe Feststoff wird aus 60 ml Ethylacetat am Rückfluss umkristallisiert. Es wird ein weißer Feststoff erhalten 10.7 g (10.7 mmol), 74% Reinheit 99%ig nach ¹H-NMR.

Analog können folgende Liganden synthetisiert werden.

| **Bsp.** | **Produkt/** | **Ausbeute** |
|---|---|---|
| | **Synthon/** | |
| | **Aufeinigung** | |
| L1203 | 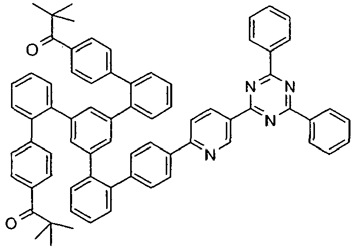 | 65% |
| | S1205 | |
| | Chromatographsich | |
| | Toluol/ Ethylacetat 20:1 → Toluol/Ethylacetat 10:1 | |
| L1205 | 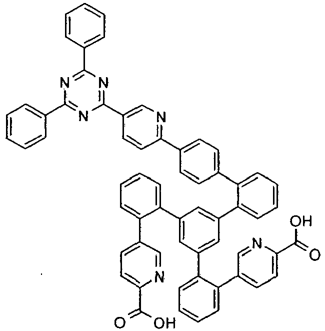 | 58% |
| | S1207 | |
| | Chromatographsich | |
| | Toluol/Ethylacetat 2:1 → Toluol/Ethylacetat 1:3 | |

### I: Synthese der Metallkomplexe - Teil 3

### Beispiel Ir(L1200)

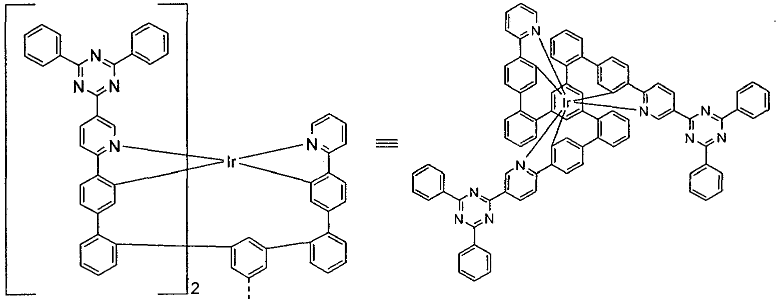

Durchführung analog wie bei der Synthse von Ir(L1000) beschrieben (siehe B. Synthese der Metallkomplexe, Variante A). Das Rohprodukt wird an Kieselgel mit Toluol als Eluent gesäult. Die weitere Reinigung des Rohprodukts erfolgt durch fünfmalige kontinuierliche Heißextraktion mit Ethylacetat/Acetonitril 1:1 (Extraktionsmittel, Vorlagemenge jeweils ca. 150 ml, Extraktionshülse: Standard Soxhletthülsen aus Cellulose der Fa. Whatman) unter sorgfältigem Luft- und Lichtausschluss. Abschließend wird das Produkt im Hochvakuum (p ca. 10⁻⁶ mbar, T bis 250°C) getempert oder sublimiert (p ca. 10⁻⁶ mbar, T 300-400°C). Es wird ein roter Feststoff erhalten. Ausbeute: 8.5 g (6.0 mmol), 60%. Reinheit: > 99.9 % nach HPLC.

Analog können folgende Komplexe Dargestellt werden:

| **Bsp.** | **Ir-Komplex** | **Ligand** | **Ausbeute** |
|---|---|---|---|
| | | **Variante** | |
| | | **Temperatur** | |
| | | **Reaktionszeit** | |
| | | **Extraktionsmittel** | |
| Ir(L1201) | 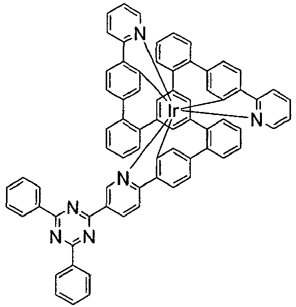 | L1201 | 60% |
| | | A | |
| | | 250 °C | |
| | | 2 h | |
| | | Cylohexan | |
| Ir(L1202) | 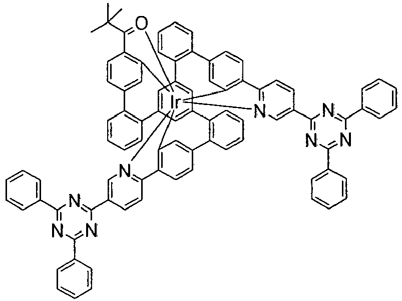 | L1202 | 40% |
| | | A | |
| | | 250 °C | |
| | | 2.5 h | |
| | | Acetoniril/Ethylacetat 1:1 | |
| Ir(L1204) | 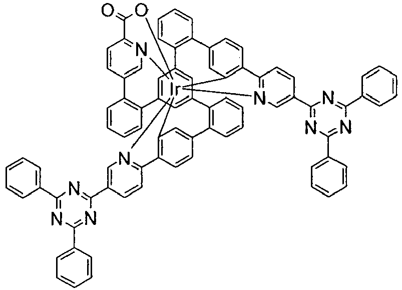 | L1204 | 54% |
| | | A | |
| | | 250 °C | |
| | | 2 h | |
| | | Cylohexan | |
| Ir(L1203) | 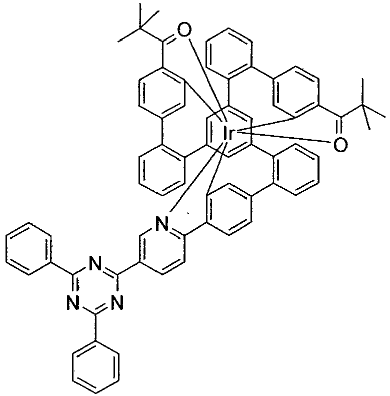 | L1203 | 14% |
| | | A | |
| | | 250 °C | |
| | | 3 h | |
| | | Cylohexan | |
| Ir(L1205) | 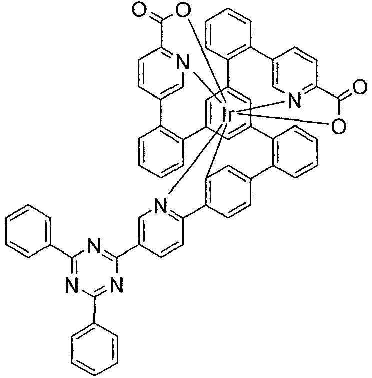 | L1205 | 16% |
| | | A | |
| | | 250 °C | |
| | | 2 h | |
| | | Ethylacetat | |

### Beispiel A: Thermische und photophysikalische Eigenschaften sowie Oxidations- und Reduktionspotentiale

Tabelle 1 faßt die thermischen und photochemischen Eigenschaften sowie Oxidations- und Reduktionspotentiale der Vergleichsmaterialien IrPPy, Ir1 bis 4 (Strukturen s. Tabelle 13) und die ausgewählter erfindungsgemäßer Materialien zusammen. Die erfindungsgemäßen Verbindungen weisen eine im Vergleich zu den Materialien nach Stand der Technik verbesserte thermische Stabilität und Photostabilität auf. Während Materialien nach Stand der Technik nach siebentägiger thermischer Auslagerung bei 380 °C Braunverfärbungen und Veraschung zeigen und man im ¹H-NMR Nebenkomponenten im Bereich > 2 mol % nachweisen kann, sind die erfindungsgemäßen Komplexe unter diesen Bedingungen inert. Diese thermische Robustheit ist insbesondere für die Verarbeitung der Materialien im Hochvakuum (Vapor-Small-Molecule Devices) entscheidend. Außerdem weisen die erfindungsgemäßen Verbindungen eine sehr gute Photostabilität in wasserfreien C₆D₆-Lösung unter Bestrahlung mit Licht der Wellenlänge von ca. 455 nm auf. Insbesondere ist im Gegensatz zu Komplexen nach Stand der Technik, die zweizähnige Liganden enthalten, ist im ¹H-NMR keine facial-meridional Isomerisierung nachzuweisen. Wie Tabelle 1 entnommen werden kann, zeichnen sich die erfindungsgemäßen Verbindungen in Lösung durch durchweg sehr hohe PL-Quanteneffizienzen aus.

**Tabelle 1:**

| **Komplex** | **therm. Stab.** | **PL-max.** | **PLQE** | **HOMO** |
|---|---|---|---|---|
| | **Photo. Stab.** | **FWHM** | | **LUMO** |
| **Vergleichsbeispiele, Strukturen s. Tabelle 13** | | | | |
| **IrPPy** | Zersetzung | 509 | 0.97 | --- |
| | Zersetzung | 67 | Toluol | --- |
| **Ir1** | --- | 513 | 0.97 | -5.09 |
| | --- | 60 | Toluol | -1.99 |
| **Ir2** | Zersetzung | 516 | 0.97 | -5.05 |
| | Zersetzung | 69 | Toluol | -1.71 |
| **Ir3** | Zersetzung | 510* | 0.76* | --- |
| | Zersetzung | --- | BuCN | --- |
| **Ir4** | Zersetzung | 524* | 0.79* | --- |
| | Zersetzung | --- | MeCN | --- |
| **Ir6** | Zersetzung | 595 | 0.82 | -5.18 |
| | Zersetzung | 63 | Toluol | -2.70 |

| **Erfindungsgemäße Beispiele** | | | | |
|---|---|---|---|---|
| **Ir(L1)** | --- | 545 | 1.00 | -4.84 |
| | --- | 66 | Toluol | -1.99 |
| **Ir(L2)** | keine Zers. | 530 | 0.98 | -5.07 |
| | keine Zers. | 66 | Toluol | -2.12 |
| | | | 0.93 | |
| | | | MeCN | |
| **Ir(L14)** | keine Zers. | 522 | 1.00 | -5.02 |
| | keine Zers. | 64 | Toluol | -1.98 |
| **Ir(L34)** | --- | 586 | 0.75 | -4.89 |
| | --- | 86 | Toluol | -2.42 |
| **Ir(L48)** | keine Zers. | 535 | 0.94 | -5.06 |
| | keine Zers. | 70 | Toluol | -2.11 |
| **Ir(L71)** | keine Zers. | 543 | 0.98 | --- |
| | keine Zers. | 74 | Toluol | --- |
| **Ir(L72)** | keine Zers. | 520 | 0.97 | -5.07 |
| | keine Zers. | 64 | Toluol | -1.99 |
| **Ir(L97)** | keine Zers. | 520 | 0.74 | --- |
| | keine Zers. | 73 | THF | --- |
| **Ir(L98**) | keine Zers. | 505 | 0.94 | --- |
| | keine Zers. | 38 | Toluol | --- 3 |
| **Ir(L111)** | keine Zers. | 519 | 0.99 | -4.99 |
| | keine Zers. | 61 | Toluol | -1.94 |
| **Ir(L112)** | - | 527 | 0.91 | --- |
| **Ir(L114)** | --- | 497, 536 | 0.77 | -5.05 |
| | --- | 32 | Toluol | --- |
| **Ir(L200)** | keine Zers. | 523 | 0.97 | -5.03 |
| | keine Zers. | 60 | Toluol | -2.01 |
| **Ir(L204)** | --- | 526 | 0.94 | --- |
| | --- | 65 | Toluol | --- |
| **Ir(L200)** | keine Zers. | 523 | 0.97 | -5.03 |
| | keine Zers. | 60 | Toluol | -2.01 |
| **Ir(L220)** | keine Zers. | 523 | 0.97 | --- |
| | keine Zers. | 60 | Toluol | --- |
| **Ir101** | --- | 526 | 0.97 | --- |
| | --- | 62 | Toluol | --- |
| **Ir109** | --- | 535 | 0.96 | -5.09 |
| | --- | 65 | Toluol | -2.19 |
| **Ir110** | --- | 520 | 0.97 | -5.07 |
| | --- | 56 | Toluol | -2.06 |
| **Ir111** | --- | 519 | 0.96 | --- |
| | --- | 60 | Toluol | --- |
| **Ir112** | --- | 517 | 0.97 | --- |
| | --- | 57 | Toluol | --- |
| **Ir113** | --- | 519 | 0.94 | --- |
| | --- | 64 | DCM | --- |
| **Ir114** | --- | 524 | 0.97 | --- |
| | --- | 59 | Toluol | --- |
| **Ir115** | --- | 518 | 0.95 | --- |
| | --- | 56 | DCM | --- |
| **Ir116** | keine Zers. | 520 | 0.97 | -5.01 |
| | keine Zers. | 55 | Toluol | -1.91 |
| **Ir117** | keine Zers. | 515 | 0.98 | --- |
| | keine Zers. | 55 | Toluol | --- |
| **Ir118** | keine Zers. | 516 | 0.98 | --- |
| | keine Zers. | 55 | Toluol | --- |
| **Ir119** | --- | 522 | 0.97 | --- |
| | --- | 59 | Toluol | --- |
| **Ir120** | --- | 523 | 0.95 | --- |
| | --- | 56 | Toluol | --- |
| **Ir121** | --- | 519 | 0.97 | --- |
| | --- | 56 | Toluol | --- |
| **Ir122** | --- | 524 | 0.95 | --- |
| | --- | 58 | Toluol | --- |
| **Ir123** | --- | 519 | 0.97 | -5.08 |
| | --- | 54 | Toluol | -2.01 |
| **Ir124** | --- | 524 | 0.99 | --- |
| | --- | 55 | Toluol | --- |
| **Ir126** | --- | 519 | 0.99 | -5.04 |
| | --- | 51 | Toluol | -1.97 |
| **Ir146** | keine Zers. | 523 | 0.98 | -5.02 |
| | keine Zers. | 56 | Toluol | -2.02 |
| **Ir301** | keine Zers. | 523 | 0.98 | --- |
| | keine Zers. | 68 | Toluol | --- |
| **Ir303** | keine Zers. | 505 | 0.89 | -5.56 |
| | keine Zers. | 64 | Toluol | -2.41 |
| **Ir305** | keine Zers. | 491, 526 | Toluol | --- |
| | keine Zers. | 52 | 0.99 | --- |
| **Ir309** | keine Zers. | 506 | Toluol | -5.29 |
| | keine Zers. | 59 | 0.98 | -2.25 |
| **Ir405** | --- | 507 | Toluol | --- |
| | --- | 59 | 0.93 | --- |
| **Ir700** | --- | 522 | 0.96 | -5.02 |
| | --- | 63 | Toluol | -2.02 |
| **Ir(L1000)** | Keine Zers. | 604 | 0.84 | -5.21 |
| | | 50 | Toluol | -- |
| **Ir(L1001)** | Keine Zers. | 599 | 0.88 | -5.17 |
| | | 47 | Toluol | -2.70 |
| **Ir(L1009)** | Keine Zers. | 609 | 0.83 | -- |
| | | 54 | Toluol | -- |
| **Ir(L1036)** | Keine Zers | 593 | 0.84 | -- |
| | | 47 | Toluol | -- |
| **Ir1000** | Keine Zers. | 609 | 0.90 | -- |
| | | 46 | Toluol | -- |
| **Ir1001** | Keine Zers. | 605 | 0.90 | -- |
| | | 45 | Toluol | -- |
| **Ir1002** | Keine Zers. | 613 | 0.85 | -5.18 |
| | | 48 | Toluol | -2.83 |
| **Ir1003** | Keine Zers. | 604 | 0.91 | -- |
| | | 47 | Toluol | -- |
| **Ir1004** | Keine Zers. | 610 | -- | -- |
| | | 51 | -- | -- |
| | | 51 | -- | -- |
| **Ir1005** | Keine Zers. | 618 | -- | -- |
| | | 55 | -- | -- |
| **Ir1006** | Keine Zers. | 615 | -- | -- |
| | | 51 | -- | -- |
| **Ir1007** | Keine Zers. | 615 | -- | -- |
| | | 50 | -- | -- |
| **Ir(L1200)** | Keine Zers. | 618 | -- | -- |
| | | 77 | -- | -- |
| **Ir(L1201)** | Keine Zers. | 626 | 0.67 | -- |
| | | 86 | Toluol | -- |

| | | | | |
|---|---|---|---|---|
| *: Daten aus G. St-Pierre et al., Dalton Trans, 2011, 40, 11726. | | | | |

### Legende:

### - Therm. Stab. (thermische Stabilität):

Auslagerung in unter Vakuum abgeschmolzenen Ampullen, 7 Tage bei 380 °C. Visuelle Begutachtung auf Farbveränderung / Braunverfärbung / Veraschung und Analyse mittels ¹H-NMR Spektroskopie.

### - Photo. Stab. (photochemische Stabilität):

Bestrahlung ca. 1 mmolarer Lösungen in wasserfreiem C₆D₆ (entgaste und abgeschmolzene NMR-Röhrchen) mit blauem Licht (ca. 455 nm, 1.2 W Lumispot der Fa. Dialight Corporation, USA) bei RT.

### - PL-max.:

Maximum des PL-Spektrums in [nm] einer entgasten ca. 10⁻⁵ molaren Lösung bei RT, Anregungswellenlänge 370 nm, Lösungsmittel s. Spalte PLQE.

### - FWHM:

Halbwertsbreite des PL-Spektrums in [nm] bei RT.

### - PLQE.:

Abs. Photolumisenzenz-Quanteneffizienz einer entgasten, ca. 10⁻⁵ molaren Lösung im angegebenen Lösungsmittel bei RT.

### - HOMO, LUMO:

in [eV] vs. Vakuum, bestimmt in Dichlormethan-Lösung (Oxidation) bzw. THF (Reduktion) mit interner Ref. Ferrocen (- 4.8 eV vs. Vakuum).

### Beispiel B: Vergleich der Syntheseausbeuten von Ir(L2) vs. Ir3 und Ir(L72) vs. Ir4

Die erfindungsgemäße Verbindung Ir(L2) wird unter gleichen Synthesebedingungen (Variante C*) in deutlich besser Ausbeute (79 %) als die Verbindung nach Stand der Technik Ir3 (33 %) erhalten. Analoges gilt für Ir(L72) mit 68 % vs. Ir4 mit 37 %. Ausbeuten zu Ir3 und Ir4: s. G. St-Pierre et al., Dalton Trans, 2011, 40, 11726.

### Beispiel C: Löslichkeit ausgewählter Komplexe bei 25 °C

Für die Verarbeitung der erfindungsgemäßen Komplexe aus Lösung (Spin-Coating, InkJet-Printing, Nozzle-Printing, Rakeln, etc.) werden langzeitstabile Lösungen mit Feststoffgehalten von ca. 5 mg/ml oder mehr benötigt.

**Tabelle 2: Löslichkeiten ausgewählter Komplexe**

| Komplex | Lösungsmittel | Löslichkeit |
|---|---|---|
| Ir(L1) | Toluol | > 5 mg/ml |
| Ir(L64) | Anisol | > 5 mg/ml |
| Ir(L118) | Toluol | > 10 mg/ml |
| Ir(L39) | 3-Phenoxytoluol | > 5 mg/ml |
| Ir(L49) | 3-Phenoxytoluol | > 10 mg/ml |
| Ir(L53) | Toluol | > 10 mg/ml |
| Ir(L280) | Toluol | > 10 mg/ml |
| Ir101 | 3-Phenoxytoluol | > 10 mg/ml |
| Ir104 | Toluol | > 20 mg/ml |
| Ir105 | 3-Phenoxytoluol | > 15 mg/ml |
| Ir108 | 3-Phenoxytoluol | > 15 mg/ml |
| Ir113 | 3-Phenoxytoluol | > 15 mg/ml |
| Ir116 | Toluol | > 5 mg/ml |
| Ir126 | o-Xylol | > 25 mg/ml |
| Ir127 | o-Xylol | > 50 mg/ml |
| Ir132 | 3-Phenoxytoluol | > 50 mg/ml |
| Ir151 | 3-Phenoxytoluol | > 30 mg/ml |
| Ir152 | 3-Phenoxytoluol | > 30 mg/ml |
| Ir308 | 3-Phenoxytoluol | > 20 mg/ml |
| Ir700 | 3-Phenoxytoluol | > 50 mg/ml |
| Ir1019 | 3-Phenoxytoluol | > 10 mg/ml |
| Ir1038 | 3-Phenoxytoluol | > 10 mg/ml |

### Beispiel: Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Glasplättchen, mit strukturiertem ITO (50 nm, Indium-ZinnOxid) bilden die Substrate, auf welche die OLEDs aufgebracht werden. Die OLEDs haben prinzipiell folgenden Schichtaufbau: Substrat / Lochtransportschicht 1 (HTL1) bestehend aus HTM dotiert mit 5 % NDP-9 (kommerziell erhältlich von der Fa. Novaled), 20 nm / Lochtransportschicht 2 (HTL2) / optionale Elektronenblockerschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuum-prozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co-Verdampfung in einem bestimmten Volumenanteil beigemischt wird. Eine Angabe wie M3:M2:Ir(L2) (55%:35%:10%) bedeutet hierbei, dass das Material M3 in einem Volumenanteil von 55%, M2 in einem Anteil von 35% und Ir(L2) in einem Anteil von 10% in der Schicht vorliegt. Analog kann auch die Elektronentransportschicht aus einer Mischung zweier Materialien bestehen. Der genaue Aufbau der OLEDs ist Tabelle 2 zu entnehmen. Die zur Herstellung der OLEDs verwendeten Materialien sind in Tabelle 13 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/m² in V) bestimmt aus Strom-Spannungs-Helligkeits-Kennlinien (IUL-Kennlinien). Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50% der Startleuchtdichte abgefallen ist, also von z.B. 1000 cd/m² auf 500 cd/m². Je nach Emissionsfarbe wurden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/m² eine übliche Angabe.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Als Vergleich gemäß dem Stand der Technik werden die Iridium-Verbindungen gemäß Tabelle 13 verwendet. Die Ergebnisse der OLEDs sind in Tabelle 4 zusammengefasst.

**Tabelle 3: Aufbau der OLEDs**

| Bsp. | **HTL2** | **EBL** | **EML** | **HBL** | **ETL** |
|---|---|---|---|---|---|
| | **Dicke** | **Dicke** | **Dicke** | **Dicke** | **Dicke** |
| **Grüne OLEDs** | | | | | |
| Ref.-D1 | HTM | --- | M1:IrPPy (90%:10%) | --- | ETM1:ETM2 (50%:50%) |
| | 40 nm | | 30 nm | | 30 nm |
| Ref.-D2 | HTM | --- | M1:IrPPy (90%:10%) | HBM1 | ETM1:ETM2 (50%:50%) |
| | 40 nm | | 30 nm | 10 nm | 30 nm |
| Ref.-D3 | HTM | --- | M1:IrPPy (85%:15%) | HBM1 | ETM1:ETM2 (50%:50%) |
| | 40 nm | | 30 nm | 10 nm | 30 nm |
| Ref.-D4 | | --- | M1:Ir2 (90%:10%) | --- | ETM1:ETM2 (50%:50%) |
| | 40 nm | | 30 nm | | 30 nm |
| Ref.-D5 | HTM | --- | M1:Ir2 (90%:10%) | HBM1 | ETM1:ETM2 (50%:50%) |
| | 40 nm | | 30 nm | 10 nm | 30 nm |
| Ref.-D6 | HTM | --- | M1:Ir2 (85%:15%) | HBM1 | ETM1:ETM2 (50%:50%) |
| | 40 nm | | 30 nm | 10 nm | 30 nm |
| Ref.-D7 | HTM | --- | M1:M3:Ir2 (60%:30%:10%) | HBM1 | ETM1:ETM2 (50%:50%) |
| | 40 nm | | 30 nm | 10 nm | 30 nm |
| Ref.-D8 | HTM | --- | M1:Ir3 (90%:10%) | HBM1 | ETM1:ETM2 (50%:50%) |
| | 40 nm | | 30 nm | 10 nm | 30 nm |
| D1 | HTM | --- | M1:Ir(L2) (90%:10%) | --- | ETM1:ETM2 (50%:50%) |
| | 40 nm | | 30 nm | | 30 nm |
| D2 | HTM | --- | M1:Ir(L2) (90%:10%) | HBM1 | ETM1:ETM2 (50%:50%) |
| | 40 nm | | 30 nm | 10 nm | 30 nm |
| D3 | HTM | --- | M1:Ir(L2) (85%:15%) | HBM1 | ETM1:ETM2 (50%:50%) |
| | 40 nm | | 30 nm | 10 nm | 30 nm |
| D4 | HTM | --- | M2:Ir(L2) (85%:15%) | NBM1 | ETM1:ETM2 (50%:50%) |
| | 40 nm | | 30 nm | 10 nm | 30 nm |
| D5 | HTM | --- | M1:M3:Ir(L2) (60%:30%:10%) | HBM1 | ETM1:ETM2 (50%:50%) |
| | 40 nm | | 30 nm | 10 nm | 30 nm |
| D6 | HTM | --- | M1:M3:Ir(L14) (60%:30%:10%) | HBM1 | ETM1:ETM2 (50%:50%) |
| | 40 nm | | 30 nm | 10 nm | 30 nm |

**Tabelle 4: Ergebnisse der Vakuum-prozessierten OLEDs**

| **Bsp.** | **EQE (%)** | **Spannung (V)** | **CIE x/y** | **LD50 (h)** |
|---|---|---|---|---|
| | **1000 cd/m²** | **1000 cd/m²** | **1000 cd/m²** | **1000 cd/m²** |
| **Grüne OLEDs** | | | | |
| Ref.-D1 | 15.8 | 2.7 | 0.33/062 | 55000 |
| Ref.-D2 | 15.6 | 3.3 | 0.33/062 | 70000 |
| Ref.-D3 | 16.0 | 3.3 | 0.33/062 | 85000 |
| Ref.-D4 | 17.4 | 2.5 | 0.35/0.61 | 160000 |
| Ref.-D5 | 17.3 | 3.2 | 0.35/0.61 | 210000 |
| Ref.-D6 | 17.7 | 3.2 | 0.35/0.62 | 240000 |
| Ref.-D7 | 17.6 | 3.1 | 0.35/0.62 | 340000 |
| Ref.-D8 | 17.8 | 3.2 | 0.34/0.62 | 180000 |
| D1 | 17.8 | 2.6 | 0.40/0.59 | 320000 |
| D2 | 18.1 | 3.0 | 0.40/0.59 | 360000 |
| D3 | 18.3 | 2.9 | 0.40/0.58 | 430000 |
| D4 | 19.7 | 3.0 | 0.40/0.59 | 450000 |
| D5 | 19.2 | 3.0 | 0.40/0.59 | 480000 |
| D6 | 20.3 | 3.1 | 0.37/0.61 | 570000 |

### 2) Weitere vakuum-prozessierte Bauteile

In den folgenden Beispielen D7 bis D84 und Ref-D9 bis Ref-D14 (siehe Tabellen 5 und 6) werden Daten weiterer OLEDs vorgestellt. Die Prozessierung erfolgt wie in 1) beschrieben, mit dem Unterschied, dass andere, im folgenden beschriebene, Substrate verwendet werden: Gereinigte Glasplättchen (Reinigung in Miele Laborspülmaschine, Reiniger Merck Extran), die mit strukturiertem ITO (Indium Zinn Oxid) der Dicke 50 nm beschichtet sind werden 25 Minuten mit UV-Ozon vorbehandelt (UV-Ozon Generator PR-100, Firma UVP) und innerhalb 30min zur verbesserten Prozessierung mit 20 nm PEDOT:PSS beschichtet (Poly(3,4-ethylenedioxythiophene) poly(styrenesulfonate), bezogen als CLEVIOS™ P VP AI 4083 von Heraeus Precious Metals GmbH Deutschland, aus wässriger Lösung aufgeschleudert) und anschließend bei 180°C 10min lang ausgeheizt. Diese beschichteten Glasplättchen bilden die Substrate, auf welche die OLEDs aufgebracht werden.

In den Beispielen D27, D28, Ref-D13 und Ref-D14 und wird statt der 20 nm dicken Schicht HTM dotiert mit 5% NDP-9 eine 20 nm dicke Schicht HTM2 dotiert mit 5% NDP-9 verwendet.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/m² bestimmt und daraus die CIE 1931 x und y Farbkoordinaten berechnet. Die Angabe U1000 in Tabelle 6 bezeichnet die Spannung, die für eine Leuchtdichte von 1000 cd/m² benötigt wird. EQE1000 bezeichnet die externe Quanteneffizienz bei einer Betriebsleuchtdichte von 1000 cd/m².

Als Lebensdauer LD80 wird die Zeit definiert, nach der die Leuchtdichte bei Betrieb mit einem konstantem Strom von 40 mA/cm² auf 80% der Startleuchtdichte absinkt.

**Tabelle 5: Aufbau der weiteren vakuum-prozessierten OLEDs**

| **Bsp.** | **HTL2** | **EBL** | **EML** | **HBL** | **ETL** |
|---|---|---|---|---|---|
| | **Dicke** | **Dicke** | **Dicke** | **Dicke** | **Dicke** |
| D7 | HTM | | M1:Ir116 (95%:5%) | ETM1 | ETM1:ETM2 (50%:50%) |
| | 40nm | | 30nm | 10nm | 30nm |
| D8 | HTM | | M1:Ir116 (90%:10%) | ETM1 | ETM1:ETM2 (50%:50%) |
| | 40nm | | 30nm | 10nm | 30nm |
| D9 | HTM | | m1:Ir116 (85%:15%) | ETM1 | ETM1:ETM2 (50%:50%) |
| | 40nm | | 30nm | 10nm | 30nm |
| D10 | HTM | | M1:Ir116 (80%:20%) | ETM1 | ETM1:ETM2 (50%:50%) |
| | 40nm | | 30nm | 10nm | 30nm |
| D11 | HTM | | M1:M3:Ir116 (45%:45%:10%) | ETM1 | ETM1:ETM2 (50%:50%) |
| | 40nm | | 30nm | 10nm | 30nm |
| D12 | HTM | | M1:M3:Ir116 (60%:30%:10%) | ETM1 | ETM1:ETM2 (50%:50%) |
| | 40nm | | 30nm | 10nm | 30nm |
| D13 | HTM | | M6:Ir116 (90%:10%) | ETM1 | ETM1:ETM2 (50%:50%) |
| | 40nm | | 30nm | 10nm | 30nm |
| D14 | HTM | | M6:Ir116 (85%:15%) | ETM1 | ETM1:ETM2 (50%:50%) |
| | 40nm | | 30nm | 10nm | 30nm |
| D15 | HTM | | M1:Ir(L111) (85%:15%) | ETM1 | ETM1:ETM2 (50%:50%) |
| | 40nm | | 30nm | 10nm | 30nm |
| D16 | HTM | | M6:Ir(L111) (85%:15%) | ETM1 | ETM1:ETM2 (50%:50%) |
| | 40nm | | 30nm | 10nm | 30nm |
| D17 | HTM | | M1:M3:Ir(L111) (40%:40%:20%) | ETM1 | ETM1:ETM2 (50%:50%) |
| | 40nm | | 30nm | 10nm | 30nm |
| D18 | HTM | | M1:Ir(L48) (90%:10%) | ETM1 | ETM1:ETM2 (50%:50%) |
| | 40nm | | 30nm | 10nm | 30nm |
| D19 | HTM | | M1:Ir(L48) (85%:15%) | ETM1 | ETM1:ETM2 (50%:50%) |
| | 40nm | | 30nm | 10nm | 30nm |
| D20 | HTM | | M1:Ir(L48) (80%:20%) | ETM1 | ETM1:ETM2 (50%:50%) |
| | 40nm | | 30nm | 10nm | 30nm |
| D21 | HTM | | M1:M3:Ir(L48) (45%:45%:10%) | ETM1 | ETM1:ETM2 (50%:50%) |
| | 40nm | | 30nm | 10nm | 30nm |
| D22 | HTM | | M1:M3:Ir(L48) (42.5%:42.5%:15%) | ETM1 | ETM1:ETM2 (50%:50%) |
| | 40nm | | 30nm | 10nm | 30nm |
| D23 | HTM | | M1:M3:Ir(L48) (60%:30%:10%) | ETM1 | ETM1:ETM2 (50%:50%) |
| | 40nm | | 30nm | 10nm | 30nm |
| D24 | HTM | | M1:M3:Ir(L48) (30%:60%:10%) | ETM1 | ETM1:ETM2 (50%:50%) |
| | 40nm | | 30nm | 10nm | 30nm |
| D25 | HTM | | M1:M3:Ir(L48) (57%28%:15%) | ETM1 | ETM1:ETM2 (50%:50%) |
| | 40nm | | 30nm | 10nm | 30nm |
| D26 | HTM | | M7:M3:Ir(L14) (60%:30%:10%) | ETM1 | ETM1:ETM2 (50%:50%) |
| | 40nm | | 30nm | 10nm | 30nm |
| D27 | HTM2 | | M1:M3:Ir(L14) (45%:45%:10%) | ETM1 | ETM1:ETM2 (50%:50%) |
| | 40nm | | 30nm | 10nm | 30nm |
| D28 | HTM2 | | M1:M3:Ir(L14-D9) (45%:45%:10%) | ETM1 | ETM1:ETM2 (50%:50%) |
| | 40nm | | 30nm | 10nm | 30nm |
| D29 | HTM2 | | M1:M3:Ir(L14) (47.5%:47.5%:5%) | ETM1 | ETM1:ETM2 (50%:50%) |
| | 40nm | | 30nm | 10nm | 30nm |
| D30 | HTM | | M2:M3:Ir(L2) (45%:45%:10%) | ETM1 | ETM1:ETM2 (50%:50%) |
| | 40nm | | 30nm | 10nm | 30nm |
| D31 | HTM | | M2:M3:Ir(L2) (60%:30%:10%) | ETM1 | ETM1:ETM2 (50%:50%) |
| | 40nm | | 30nm | 10nm | 30nm |
| D32 | HTM2 | | M1:M3:Ir(L3) (45%:45%:10%) | ETM1 | ETM1:ETM2 (50%:50%) |
| | 40nm | | 30nm | 10nm | 30nm |
| D33 | HTM | | M1:M3:Ir(L20) (40%:50%:10%) | ETM1 | ETM1:ETM2 (50%:50%) |
| | 50nm | | 35nm | 10nm | 30nm |
| D34 | HTM | | M1:M3:Ir(L18) (40%:50%:10%) | ETM1 | ETM1:ETM2 (50%:50%) |
| | 50nm | | 35nm | 10nm | 30nm |
| D35 | HTM | | M1:M3:Ir(L23) (40%:45%:15%) | ETM1 | ETM1:ETM2 (50%:50%) |
| | 40nm | | 30nm | 10nm | 30nm |
| D36 | HTM | | M1:M3:Ir(L117) (35%:55%:10%) | ETM1 | ETM1:ETM2 (50%:50%) |
| | 40nm | | 30nm | 10nm | 30nm |
| D37 | HTM | | M6:Ir(L27) (85%:15%) | ETM1 | ETM1:ETM2 (50%:50%) |
| | 40nm | | 30nm | 10nm | 30nm |
| D38 | HTM | | M1:M3:Ir(L51) (45%:40%:15%) | ETM1 | ETM1:ETM2 (50%:50%) |
| | 40nm | | 30nm | 10nm | 30nm |
| D39 | HTM | | M1:M3:Ir(L71) (45%:40%:15%) | ETM1 | ETM1:ETM2 (50%:50%) |
| | 40nm | | 35nm | 10nm | 30nm |
| D40 | HTM | | M1:M3:Ir(L79) (20%:60%:20%) | ETM1 | ETM1:ETM2 (50%:50%) |
| | 40nm | | 30nm | 10nm | 30nm |
| D41 | HTM | | M8:M9:Ir(L88) (55%:30%15%) | ETM1 | ETM1:ETM2 (50%:50%) |
| | 40nm | | 30nm | 10nm | 30nm |
| D42 | HTM | | M1:Ir(L112) (85%:15%) | ETM1 | ETM1:ETM2 (50%:50%) |
| | 40nm | | 30nm | 10nm | 30nm |
| D43 | HTM | | M8:Ir(123) (85%:15%) | ETM1 | ETM1:ETM2 (50%:50%) |
| | 30nm | | 30nm | 10nm | 30nm |
| D44 | HTM | | M1:Ir(L128) (85%:15%) | ETM1 | ETM1:ETM2 (50%:50%) |
| | 40nm | | 30nm | 10nm | 30nm |
| D45 | HTM | | M8:Ir(L133) (85%:15%) | ETM1 | ETM1:ETM2 (50%:50%) |
| | 40nm | | 30nm | 10nm | 30nm |
| D46 | HTM | | M1:Ir(L138) (85%:15%) | ETM1 | ETM1:ETM2 (50%:50%) |
| | 50nm | | 40nm | 5nm | 30nm |
| D47 | HTM | | M1:M3:Ir(L138) (42.5%:42.5%:15%) | ETM1 | ETM1:ETM2 (50%:50%) |
| | 40nm | | 30nm | 10nm | 30nm |
| D48 | HTM | | M1:M9:Ir(L146) (50%:40%:10%) | ETM1 | ETM1:ETM2 (50%:50%) |
| | 40nm | | 30nm | 10nm | 30nm |
| D49 | HTM | | M1:M3:Ir(L200) (60%:30%:10%) | ETM1 | ETM1:ETM2 (50%:50%) |
| | 40nm | | 30nm | 10nm | 30nm |
| D50 | HTM | | M1:M3:Ir(L201) (60%:30%:10%) | ETM1 | ETM1:ETM2 (50%:50%) |
| | 40nm | | 30nm | 10nm | 30nm |
| D51 | HTM | | M1:M3:Ir(L202) (60%:30%:10%) | ETM1 | ETM1:ETM2 (50%:50%) |
| | 40nm | | 30nm | 10nm | 30nm |
| D52 | HTM | | M1:M3:Ir(L206) (50%:35%:15%) | ETM1 | ETM1:ETM2 (50%:50%) |
| | 40nm | | 30nm | 10nm | 30nm |
| D53 | HTM | | M1:M3:Ir(L204) (60%:30:%10%) | ETM1 | ETM1:ETM2 (50%:50%) |
| | 40nm | | 30nm | 10nm | 30nm |
| D54 | HTM | | M1:M3:Ir(L222) (40%:45%:15%) | ETM1 | ETM1:ETM2 (50%:50%) |
| | 40nm | | 30nm | 10nm | 30nm |
| D55 | HTM | | M1:M3:Ir(L255) (40%:45%:15%) | ETM1 | ETM1:ETM2 (50%:50%) |
| | 40nm | | 30nm | 10nm | 30nm |
| D56 | HTM | | M1:M3:Ir(L271) (40%:40%:20%) | ETM1 | ETM1:ETM2 (50%:50%) |
| | 40nm | | 30nm | 10nm | 30nm |
| D57 | HTM | Ir116 | M1:M9:Ir(L67) (60%:20%:20%) | ETM1 | ETM1:ETM2 (50%:50%) |
| | 30nm | 20nm | 30nm | 10nm | 30nm |
| D58 | HTM2 | | M1:M3:Ir(L274) (50%:40%:10%) | ETM1 | ETM1:ETM2 (50%:50%) |
| | 40nm | | 30nm | 10nm | 30nm |
| D59 | HTM | | M1:M3:Ir301 (40%:45%:15%) | ETM1 | ETM1:ETM2 (50%:50%) |
| | 40nm | | 30nm | 10nm | 30nm |
| D60 | HTM | | M1:M3:Ir302 (20%:70%:10%) | ETM1 | ETM1:ETM2 (50%:50%) |
| | 40nm | | 30nm | 10nm | 30nm |
| D61 | HTM | | M1:M9:Ir305 (60%:30%:10%) | ETM1 | ETM1:ETM2 (50%:50%) |
| | 40nm | | 30nm | 10nm | 30nm |
| D62 | HTM | | M1:M9:Ir306 (60%:30%:10%) | ETM1 | ETM1:ETM2 (50%:50%) |
| | 40nm | | 30nm | 10nm | 30nm |
| D63 | HTM | | M1:M3:Ir307 (40%:45%:15%) | ETM1 | ETM1:ETM2 (50%:50%) |
| | 40nm | | 30nm | 10nm | 30nm |
| D64 | HTM | | M1:M9:Ir311 (60%:30%:10%) | ETM1 | ETM1:ETM2 (50%:50%) |
| | 40nm | | 30nm | 10nm | 30nm |
| D65 | HTM | | M1:M9:Ir313 (60%:25%:15%) | ETM1 | ETM1:ETM2 (50%:50%) |
| | 40nm | | 30nm | 10nm | 30nm |
| D66 | HTM | | M1:M3:Ir150 (45%:45%:10%) | ETM1 | ETM1:ETM2 (50%:50%) |
| | 40nm | | 30nm | 10nm | 30nm |
| D67 | HTM | | M1:M3:IrL760-1 (45%:45%:10%) | ETM1 | ETM1:ETM2 (50%:50%) |
| | 40nm | | 30nm | 10nm | 30nm |
| D68 | HTM | | M1:M3:Ir146 (45%:40%:15%) | ETM1 | ETM1:ETM2 (50%:50%) |
| | 40nm | | 30nm | 10nm | 30nm |
| D69 | HTM | | M7:M10:Ir(L25) (50%:30%:20%) | ETM1 | ETM1:ETM2 (50%:50%) |
| | 40nm | | 30nm | 10nm | 30nm |
| D70 | HTM | | M1:M3:Ir(L8) (45%:45%:10%) | ETM1 | ETM1:ETM2 (50%:50%) |
| | 40nm | | 30nm | 10nm | 30nm |
| D71 | HTM | | M1:M3:Ir(L20) (40%:40%:20%) | ETM1 | ETM1:ETM2 (50%:50%) |
| | 40nm | | 30nm | 10nm | 30nm |
| D72 | HTM2 | | M1:M3:Ir(L99) (60%:30%:10%) | ETM1 | ETM1:ETM2 (50%:50%) |
| | 40nm | | 40nm | 10nm | 30nm |
| D73 | HTM2 | | M1:M3:Ir(L101) (60%:30%:10%) | ETM1 | ETM1:ETM2 (50%:50%) |
| | 40nm | | 30nm | 10nm | 30nm |
| D74 | HTM | | M1:M3:Ir(L121) (55%:30%:15%) | ETM1 | ETM1:ETM2 (50%:50%) |
| | 40nm | | 40nm | 10nm | 30nm |
| D75 | HTM | | M1:M9:Ir(L145) (60%:30%:10%) | ETM1 | ETM1:ETM2 (50%:50%) |
| | 40nm | | 30nm | 10nm | 30nm |
| D76 | HTM | | M1:M3:Ir(L82) (45%:40%:15%) | ETM1 | ETM1:ETM2 (50%:50%) |
| | 40nm | | 40nm | 10nm | 30nm |
| D77 | HTM | | M1:M3:Ir(L88) (35%:50%:15%) | ETM1 | ETM1:ETM2 (50%:50%) |
| | 40nm | | 30nm | 10nm | 30nm |
| D78 | HTM | | M1:M3:Ir(L89) (35%:50%:15%) | ETM1 | ETM1:ETM2 (50%:50%) |
| | 40nm | | 30nm | 10nm | 30nm |
| D79 | HTM2 | | M1:M3:Ir(L210) (55%:30%:15%) | ETM1 | ETM1:ETM2 (50%:50%) |
| | 40nm | | 40nm | 10nm | 30nm |
| D80 | HTM | | M1:M3:Ir(L233) (65%:30%:5%) | ETM1 | ETM1:ETM2 (50%:50%) |
| | 40nm | | 30nm | 10nm | 30nm |
| D81 | HTM | | M1:M3:Ir(L69) (45%:45%:10%) | ETM1 | ETM1:ETM2 (50%:50%) |
| | 40nm | | 30nm | 10nm | 30nm |
| D82 | HTM | | M6:Ir116 (85%:15%) | ETM1 | M200 |
| | 40nm | | 30nm | 10nm | 30nm |
| D83 | HTM | | M6:Ir116 (85%:15%) | ETM1 | M400 |
| | 40nm | | 30nm | 10nm | 30nm |
| D84 | HTM | | M1:M3:Ir(L257) (45%:45%:10%) | ETM1 | ETM1:ETM2 (50%:50%) |
| | 40nm | | 30nm | 10nm | 30nm |
| Ref-D9 | HTM | | M1:IrPPy (85%:15%) | ETM1 | ETM1:ETM2 (50%:50%) |
| | 40nm | | 30nm | 10nm | 30nm |
| Ref-D10 | HTM | | M1:Ir2 (85%:15%) | ETM1 10nm | ETM1:ETM2 (50%:50%) |
| | 40nm | | 30nm | | 30nm |
| Ref-D11 | HTM | | M1:M3:IrPPy (45%:45%:10%) | ETM1 | ETM1:ETM2 (50%:50%) |
| | 40nm | | 30nm | 10nm | 30nm |
| Ref-D12 | HTM | | M1:M3:Ir2 (45%:45%:10%) | ETM1 | ETM1:ETM2 (50%:50%) |
| | 40nm | | 30nm | 10nm | 30nm |
| Ref-D13 | HTM2 | | M1:M3:Ir2 (45%:45%:10%) | ETM1 | ETM1:ETM2 (50%:50%) |
| | 40nm | | 30nm | 10nm | 30nm |
| Ref-D14 | HTM2 | | M1:M3:Ir2 (47.5%:47.5%:5%) | ETM1 | ETM1:ETM2 (50%:50%) |
| | 40nm | | 30nm | 10nm | 30nm |

**Tabelle 6: Daten der weiteren Vakuum-prozessierten OLEDs**

| **Bsp.** | **EQE1000 (%)** | **U1000 (V)** | **CIE x/y** | **LD80 (h)** |
|---|---|---|---|---|
| D7 | 20.6 | 2.9 | 0.33/0.64 | 50 |
| D8 | 20.5 | 2.9 | 0.33/0.64 | 130 |
| D9 | 20.1 | 2.9 | 0.33/0.64 | 230 |
| D10 | 19.4 | 2.9 | 0.33/0.63 | 255 |
| D11 | 20.8 | 3.0 | 0.32/0.64 | 245 |
| D12 | 21.9 | 3.0 | 0.32/0.64 | 260 |
| D13 | 22.9 | 3.0 | 0.33/0.64 | 90 |
| D14 | 21.9 | 3.0 | 0.33/0.64 | 175 |
| D15 | 15.7 | 3.2 | 0.36/0.62 | 290 |
| D16 | 17.9 | 3.1 | 0.35/0.62 | 190 |
| D17 | 17.0 | 3.4 | 0.35/0.62 | 305 |
| D18 | 17.8 | 3.0 | 0.39/0.59 | 170 |
| D19 | 17.6 | 2.9 | 0.40/0.59 | 400 |
| D20 | 17.2 | 3.1 | 0.40/0.58 | 515 |
| D21 | 20.1 | 3.2 | 0.39/0.59 | 465 |
| D22 | 19.5 | 3.1 | 0.40/0.59 | 500 |
| D23 | 20.5 | 3.1 | 0.40/0.59 | 330 |
| D24 | 18.1 | 3.3 | 0.39/0.59 | 260 |
| D25 | 19.5 | 3.0 | 0.40/0.59 | 500 |
| D26 | 19.4 | 3.8 | 0.35/0.62 | 280 |
| D27 | 20.5 | 3.2 | 0.35/0.62 | 240 |
| D28 | 20.9 | 3.2 | 0.34/0.62 | 290 |
| D29 | 19.2 | 3.3 | 0.36/0.61 | 305 |
| D30 | 19.3 | 3.3 | 0.36/0.60 | 210 |
| D31 | 20.3 | 3.1 | 0.36/0.61 | 195 |
| D32 | 20.4 | 3.3 | 0.37/0.62 | 280 |
| D33 | 19.8 | 3.2 | 0.46/0.53 | 580 |
| D34 | 18.0 | 3.2 | 0.67/0.33 | 490 |
| D35 | 21.1 | 3.3 | 0.33/0.64 | 360 |
| D36 | 20.3 | 3.3 | 0.32/0.65 | 370 |
| D37 | 19.9 | 3.2 | 0.45/0.52 | 390 |
| D38 | 20.9 | 3.1 | 0.45/0.53 | 420 |
| D39 | 19.9 | 3.2 | 0.42/0.57 | 510 |
| D40 | 20.3 | 3.3 | 0.28/0.65 | 280 |
| D41 | 18.8 | 3.3 | 0.18/0.38 | 330 |
| D42 | 17.0 | 3.2 | 0.37/0.62 | 450 |
| D43 | 20.7 | 3.5 | 0.20//0.55 | 370 |
| D44 | 18.0 | 3.1 | 0.36/0.60 | 210 |
| D45 | 18.5 | 3.3 | 0.18/0.39 | 190 |
| D46 | 17.9 | 3.2 | 0.67/0.33 | 90 |
| D47 | 20.2 | 3.1 | 0.64/.035 | 200 |
| D48 | 20.9 | 3.1 | 0.32/0.64 | 425 |
| D49 | 21.3 | 3.1 | 0.43/0.55 | 380 |
| D50 | 20.7 | 3.3 | 0.37/0.61 | 360 |
| D51 | 15.2 | 3.2 | 0.52/0.48 | 260 |
| D52 | 19.0 | 3.3 | 0.36/0.62 | 350 |
| D53 | 20.3 | 3.1 | 0.38/0.61 | 440 |
| D54 | 19.0 | 3.3 | 0.34/0.63 | 350 |
| D55 | 20.8 | 3.2 | 0.36/0.63 | 400 |
| D56 | 18.6 | 3.1 | 0.34/0.62 | 330 |
| D57 | 20.2 | 3.2 | 0.46/0.51 | 410 |
| D58 | 19.6 | 3.3 | 0.20/0.52 | 315 |
| D59 | 21.0 | 3.2 | 0.36/0.61 | 330 |
| D60 | 20.7 | 3.3 | 0.32/0.61 | 310 |
| D61 | 20.3 | 3.5 | 0.22/0.56 | 280 |
| D62 | 20.6 | 3.4 | 0.24/0.57 | 360 |
| D63 | 21.3 | 3.2 | 0.32/0.63 | 360 |
| D64 | 23.3 | 3.5 | 0.23/0.54 | 180 |
| D65 | 21.0 | 3.5 | 0.28/0.59 | 310 |
| D66 | 20.8 | 3.1 | 0.40/0.59 | 470 |
| D67 | 20.5 | 3.3 | 0.37/0.62 | 390 |
| D68 | 21.8 | 3.2 | 0.35/0.62 | 400 |
| D69 | 20.2 | 3.3 | 0.36/0.61 | 270 |
| D70 | 19.8 | 3.3 | 0.42/0.55 | 430 |
| D71 | 18.8 | 3.2 | 0.47/0.51 | 410 |
| D72 | 18.3 | 3.3 | 0.46/0.50 | 200 |
| D73 | 19.1 | 3.3 | 0.35/0.53 | 110 |
| D74 | 19.5 | 3.3 | 0.42/0.54 | 410 |
| D75 | 21.4 | 3.2 | 0.31/0.63 | 390 |
| D76 | 19.6 | 3.3 | 0.43/0.55 | 380 |
| D77 | 21.1 | 3.3 | 0.33/0.63 | 400 |
| D78 | 20.8 | 3.4 | 0.34/0.63 | 360 |
| D79 | 22.1 | 3.3 | 0.47/0.51 | 420 |
| D80 | 21.0 | 3.3 | 0.34/0.63 | 400 |
| D81 | 20.5 | 3.4 | 0.39/0.58 | 190 |
| D82 | 19.7 | 3.5 | 0.33/0.64 | 230 |
| D83 | 20.4 | 3.4 | 0.33/0.63 | 290 |
| D84 | 21.3 | 3.4 | 0.36/0.62 | 300 |
| Ref-D9 | 18.1 | 3.1 | 0.34/0.62 | 70 |
| Ref-D10 | 17.1 | 3.0 | 0.34/0.62 | 185 |
| Ref-D11 | 17.1 | 3.2 | 0.31/0.63 | 95 |
| Ref-D12 | 17.9 | 3.0 | 0.32/0.63 | 265 |
| Ref-D13 | 18.4 | 3.2 | 0.33/0.63 | 150 |
| Ref-D14 | 17.0 | 3.1 | 0.34/0.62 | 200 |

### 3) Weitere vakuum-prozessierte blau emittierende Bauteile

In den folgenden Beispielen D85 bis D90 (siehe Tabellen 7 und 8) werden Daten blau emittierender OLEDs vorgestellt. Die Prozessierung und Charakterisierung erfolgt wie in 2) beschrieben.

Die Elektrolumineszenzspektren werden bei einer Leuchtdichte von 1000 cd/m² bestimmt und daraus die CIE 1931 x und y Farbkoordinaten berechnet. Die Angabe U1000 in Tabelle 8 bezeichnet die Spannung, die für eine Leuchtdichte von 1000 cd/m² benötigt wird. EQE1000 bezeichnet die externe Quanteneffizienz bei einer Betriebsleuchtdichte von 1000 cd/m². Als Lebensdauer LD50 wird die Zeit definiert, nach der die Leuchtdichte bei einer Starthelligkeit von 1000 cd/m² auf 50% der Startleuchtdichte absinkt.

**Tabelle 7: Aufbau der blauen vakuum-prozessierten OLEDs**

| **Bsp.** | **HTL2** | **EBL** | **EML** | **HBL** | **ETL** |
|---|---|---|---|---|---|
| | **Dicke** | **Dicke** | **Dicke** | **Dicke** | **Dicke** |
| D85 | HTM | EBM1 | M8:Ir(L64) (85%:15%) | ETM1 | ETM1:ETM2 (50%:50%) |
| | 30nm | 10 nm | 30nm | 10nm | 30nm |
| D86 | HTM | EBM1 | M8:Ir(L64) (85%:15%) | ETM2 | M300 |
| | 30nm | 10 nm | 30nm | 10nm | 30nm |
| D87 | HTM | EBM1 | M8:Ir(L64) (85%:15%) | ETM3 | M200 |
| | 30nm | 10 nm | 30nm | 10nm | 30nm |
| D88 | HTM | Ir(L100) | M8:Ir(L64) (85%:15%) | ETM3 | ETM1:ETM2 (50%:50%) |
| | 30nm | 10 nm | 30nm | 10nm | 30nm |
| D89 | HTM | EBM1 | M9:Ir(L107) (85%:15%) | ETM3 | ETM1:ETM2 (50%:50%) |
| | 30nm | 10 nm | 30nm | 10nm | 30nm |
| D90 | HTM | EBM1 | M8:Ir(L114) (85%:15%) | ETM3 | ETM1:ETM2 (50%:50%) |
| | 30nm | 10 nm | 30nm | 10nm | 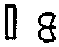 Ĥ 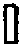 |

**Tabelle 8: Daten der blauen vakuum-prozessierten OLEDs**

| **Bsp.** | **EQE1000 (%)** | **U1000 (V)** | **CIE x/y** | **LD50 (h)** |
|---|---|---|---|---|
| D85 | 17.1 | 4.3 | 0.17/0.38 | 1800 |
| D86 | 18.6 | 4.5 | 0.18/0.38 | 2200 |
| D87 | 16.3 | 4.7 | 0.18/0.39 | 2000 |
| D88 | 18.8 | 4.5 | 0.18/0.38 | 2500 |
| D89 | 5.1 | 5.7 | 0.16/0.11 | --- |
| D90 | 22.7 | 4.9 | 0.16/0.37 | 3400 |

### 4) Weiß emittierende OLEDs

Gemäß den allgemeinen Verfahren aus 1) wird eine weiß emittierende OLED mit folgendem Schichtaufbau hergestellt:

**Tabelle 9: Aufbau der weißen OLEDs**

| **Bsp.** | **HTL2** | **EML Rot** | **EML Blau** | **EML Grün** | **HBL** | **ETL** |
|---|---|---|---|---|---|---|
| | **Dicke** | **Dicke** | **Dicke** | **Dicke** | **Dicke** | **Dicke** |
| D-W1 | HTM | EBM1:Ir(L105) (97%:3%) | M8:M3:Ir(L64) (45%:50%:5%) | M3:Ir116 (90%:10%) | ETM1 | ETM1:ETM2 (50%:50%) |
| | 230 nm | 9 nm | 8 nm | 7 nm | 10 nm | 30 nm |

**Tabelle 10: Deviceergebnisse**

| **Bsp.** | **EQE (%)** | **Spannung (V)** | **CIE x/y** | **LD50** |
|---|---|---|---|---|
| | | **1000 cd/m²** | **1000 cd/m²** | **(h)** |
| | **1000 cd/m²** | | **CRI** | **1000 cd/m²** |
| D-W1 | 21.8 | 6.1 | 0.43/0.46 | 7500 |
| | | | 83 | |

### Lösungs-prozessierte Devices:

### A: Aus niedermolekularen lölichen Funktionsmaterialien

Die erfindungsgemäßen Iridium-Komplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / Lochinjektionsschicht (60 nm) / Interlayer (20 nm) / Emissionsschicht (60 nm) / Lochblockierschicht (10 nm) / Elektronentransportschicht (40 nm) / Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport, in diesem Fall wird HL-X092 von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol gelöst. Der typische Feststoffgehalt solcher Lösungen liegt zwischen 16 und 25 g/L, wenn, wie hier, die für eine Device typische Schichtdicke von 60 nm mittels Spincoating erzielt werden soll. Die lösungsprozessierten Devices vom Typ1a enthalten eine Emissionsschicht aus M4:M5:IrL (40%:45%:15%), die vom Typ 1b enthalten eine Emissionsschicht aus M4:M5:IrL (20%:60%:20%), die vom Typ2 enthalten eine Emissionsschicht aus M4:M5:IrLa:IrLb (30%:34%:30%:6%), d.h. sie enthalten zwei verschiedene Ir-Komplexe. Die Emissionsschicht wird in einer Inertgasatmosphäre, im vorliegenden Fall Argon, aufgeschleudert und 10 min bei 160 °C ausgeheizt. Darüber wird die Lochblockierschicht (10nm ETM1) und die Elektronentransportschicht (40nm ETM1 (50%) / ETM2 (50%)) aufgedampft (Aufdampfanlagen von Lesker o.a., typischer Aufdampfdruck 5 x 10⁻⁶ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 11 fasst die erhaltenen Daten zusammen.

**Tabelle 11: Ergebnisse mit aus Lösung prozessierten Materialien**

| **Bsp.** | **Emitter** | **EQE (%)** | **Spannung (V)** | **CIE x/y** | **LD50 (h)** |
|---|---|---|---|---|---|
| | **Device** | **1000 cd/m²** | **1000 cd/m²** | | **1000 cd/m²** |
| **Grüne, Gelbe, Orange und Rote OLEDs** | | | | | |
| Sol-Ref-Red1 | Ir5 | 15.0 | 6.2 | 0.68/0.32 | 4000 |
| | Typ1a | | | | |
| Sol-RedD1 | Ir(L34) | 15.7 | 6.5 | 0.57/0.43 | 40000 |
| | Typ1a | | | | |
| Sol-RedD2 | Ir1 | 15.7 | 6.6 | 0.56/0.44 | ÿ40000 |
| | Ir(L34) | | | | |
| | Typ2 | | | | |
| Sol-RedD3 | Ir109 | 16.1 | 6.5 | 0.56/0.44 | 200000 |
| | Ir(L34) | | | | |
| | Typ2 | | | | |
| Sol-RedD4 | Ir109 | 17.1 | 6.3 | 0.67/0.33 | 270000 |
| | Ir5 | | | | |
| | Typ2 | | | | |
| Sol-RedD5 | Ir1 | 17.4 | 6.1 | 0.64/0.36 | 210000 |
| | Ir(L1000) | | | | |
| | Typ2 | | | | |
| Sol-RedD6 | Ir1 | 17.0 | 6.1 | 0.62/0.37 | 545000 |
| | Ir(L1001) | | | | |
| | Typ2 | | | | |
| Sol-RedD7 | Ir1 | 17.8 | 6.3 | 0.64/0.36 | 210000 |
| | Ir1000 | | | | |
| | Typ2 | | | | |
| Sol-RedD8 | Ir1 | 18.6 | 5.7 | 0.63/0.37 | 285000 |
| | Ir1001 | | | | |
| | Typ2 | | | | |
| Sol-RedD9 | Ir1 | 18.5 | 6.2 | 0.63/0.37 | 77000 |
| | Ir1002 | | | | |
| | Typ2 | | | | |
| Sol-RedD10 | Ir1 | 19.3 | 5.4 | 0.62/0.38 | 282000 |
| | Ir1003 | | | | |
| | Typ2 | | | | |
| Sol-RedD11 | Ir1 | 17.6 | 5.9 | 0.67/0.33 | 165000 |
| | Ir1005 | | | | |
| | Typ2 | | | | |
| Sol-RedD12 | Ir1 | 15.9 | 6.4 | 0.67/0.33 | 130000 |
| | Ir(L1200) | | | | |
| | Typ2 | | | | |
| Sol RedD13 | Ir(L1) | 16.1 | 6.5 | 0.67/0.33 | 120000 |
| | Ir(L1200) | | | | |
| | Typ2 | | | | |
| Sol RedD14 | Ir(L104) | 18.1 | 4.8 | 0.66/0.34 | 70000 |
| | Typ1b | | | | |
| Sol RedD15 | Ir110 | 19.1 | 4.8 | 0.65/0.34 | 470000 |
| | Ir(L104) | | | | |
| | Typ2 | | | | |
| Sol-RedD16 | Ir1 | 18.2 | 6.0 | 0.65/0.35 | 250000 |
| | Ir(L1009) | | | | |
| | Typ2 | | | | |
| Sol-RedD17 | Ir1 | 18.4 | 6.4 | 0.66/0.34 | 270000 |
| | Ir1007 | | | | |
| | Typ2 | | | | |
| Sol-RedD18 | Ir116 | 18.0 | 5.9 | 0.60/0.40 | 350000 |
| | Ir(L1036) | | | | |
| | Typ2 | | | | |
| Sol-RedD19 | Ir1 | 17.8 | 6.1 | 0.64/0.36 | 255000 |
| | Ir(L1021) | | | | |
| | Typ2 | | | | |
| Sol-RedD20 | Ir1 | 18.3 | 5.8 | 0.57/0.43 | 240000 |
| | Ir(L1008) | | | | |
| | Typ2 | | | | |
| Sol-RedD21 | Ir1 | 17.4 | 6.2 | 0.61/0.38 | 450000 |
| | Ir(L1019) | | | | |
| | Typ2 | | | | |
| Sol-RedD22 | Ir1 | 17.2 | 6.4 | 0.60/0.40 | 400000 |
| | Ir(L1017) | | | | |
| | Typ2 | | | | |
| Sol RedD23 | Ir116 | 17.5 | 6.3 | 0.66/0.34 | 200000 |
| | Ir(L1014) | | | | |
| | Typ2 | | | | |
| Sol RedD24 | Ir1 | 17.5 | 6.3 | 0.66/0.34 | 200000 |
| | Ir(L1014) | | | | |
| | Typ2 | | | | |
| Sol RedD25 | Ir110 | 17.2 | 6.8 | 0.68/0.32 | 180000 |
| | Ir(L1020) | | | | |
| | Typ2 | | | | |
| Sol RedD26 | Ir1 | 17.0 | 6.0 | 0.63/0.36 | 140000 |
| | Ir(L1024) | | | | |
| | Typ2 | | | | |
| Sol RedD27 | Ir1 | 17.8 | 6.3 | 0.62/0.38 | 320000 |
| | Ir1019 | | | | |
| | Typ2 | | | | |
| Sol RedD28 | Ir1 | 17.6 | 6.1 | 0.65/0.35 | 300000 |
| | Ir1017 | | | | |
| | Typ2 | | | | |
| Sol RedD29 | Ir1 | 17.2 | 6.4 | 0.63/0.36 | 370000 |
| | Ir1008 | | | | |
| | Typ2 | | | | |
| Sol RedD30 | Ir110 | 18.0 | 6.0 | 0.64/0.36 | 330000 |
| | Ir1040 | | | | |
| | Typ2 | | | | |
| Sol-Ref-Green1 | Ir1 | 19.8 | 5.2 | 0.36/0.61 | 200000 |
| | Typ1a | | | | |
| Sol-GreenD1 | Ir109 | 20.9 | 5.2 | 0.40/0.59 | 450000 |
| | Typ1a | | | | |
| Sol-Ref-Green2 | Ir1 | 19.6 | 4.8 | 0.36/0.61 | 220000 |
| | Typ1b | | | | |
| Sol-GreenD2 | Ir110 | 23.3 | 4.4 | 0.34/0.62 | 360000 |
| | Typ1b | | | | |
| Sol-GreenD3 | Ir114 | 21.1 | 4.4 | 0.36/0.62 | 55000 |
| | Typ1b | | | | |
| Sol-GreenD4 | Ir116 | 21.6 | 4.5 | 0.34/0.63 | 240000 |
| | Typ1b | | | | |
| Sol-GreenD5 | Ir118 | 21.1 | 4.8 | 0.34/0.62 | 160000 |
| | Typ1b | | | | |
| Sol-GreenD6 | Ir700 | 15.2 | 5.8 | 0.40/0.60 | 240000 |
| | Typ1b | | | | |
| Sol-GreenD7 | Ir702 | 16.3 | 5.7 | 0.39/0.61 | 280000 |
| | Typ1b | | | | |
| Sol-GreenD8 | Ir704 | 16.1 | 5.8 | 0.39/0.61 | 270000 |
| | Typ1b | | | | |
| Sol-GreenD9 | Ir705 | 15.9 | 5.7 | 0.40/0.60 | 300000 |
| | Typ1b | | | | |
| Sol-GreenD10 | Ir705-D3 | 16.1 | 5.8 | 0.40/0.59 | 320000 |
| | Typ1b | | | | |
| Sol-GreenD11 | Ir721 | 19.9 | 5.0 | 0.33/0.64 | 330000 |
| | Typ1b | | | | |
| Sol-GreenD12 | Ir722 | 20.6 | 5.2 | 0.33/0.64 | 300000 |
| | Typ1b | | | | |
| Sol-GreenD13 | Ir740 | 20.1 | 5.0 | 0.37/0.61 | 320000 |
| | Typ1b | | | | |
| Sol-GreenD14 | Ir101 | 21.1 | 4.5 | 0.38/0.60 | 350000 |
| | Typ1b | | | | |
| Sol-GreenD15 | Ir106 | 21.3 | 4.5 | 0.37/0.62 | 270000 |
| | Typ1b | | | | |
| Sol-GreenD16 | Ir107 | 19.9 | 4.3 | 0.39/0.60 | 400000 |
| | Typ1b | | | | |
| Sol-GreenD17 | Ir113 | 23.0 | 4.4 | 0.34/0.62 | 260000 |
| | Typ1b | | | | |
| Sol-GreenD18 | Ir111 | 22.2 | 4.6 | 0.35/0.63 | 360000 |
| | Typ1b | | | | |
| Sol-GreenD19 | Ir112 | 21.9 | 4.5 | 0.34/0.63 | 350000 |
| | Typ1b | | | | |
| Sol-GreenD20 | Ir115 | 21.1 | 4.2 | 0.33/0.61 | 390000 |
| | Typ1b | | | | |
| Sol-GreenD21 | Ir120 | 20.7 | 4.6 | 0.34/0.62 | 290000 |
| | Typ1b | | | | |
| Sol-Green D22 | Ir122 | 20.0 | 4.2 | 0.36/0.61 | 310000 |
| | Typ1b | | | | |
| Sol-GreenD23 | Ir124 | 22.4 | 4.5 | 0.35/0.61 | 340000 |
| | Typ1b | | | | |
| Sol-GreenD24 | Ir126 | 21.7 | 4.2 | 0.35/0.62 | 400000 |
| | Typ1b | | | | |
| Sol-GreenD25 | Ir127 | 21.8 | 4.2 | 0.35/0.62 | 390000 |
| | Typ1b | | | | |
| Sol-GreenD26 | Ir128 | 21.5 | 4.3 | 0.35/0.63 | 420000 |
| | Typ1b | | | | |
| Sol-GreenD27 | Ir129 | 21.0 | 4.1 | 0.37/0.60 | 340000 |
| | Typ1b | | | | |
| Sol-GreenD28 | Ir131 | 23.0 | 4.4 | 0.35/0.62 | 310000 |
| | Typ1b | | | | |
| Sol-GreenD29 | Ir132 | 22.8 | 4.4 | 0.35/0.62 | 320000 |
| | Typ1b | | | | |
| Sol-GreenD30 | Ir133 | 19.0 | 4.5 | 0.42/0.57 | 310000 |
| | Typ1b | | | | |
| Sol-GreenD31 | Ir136 | 20.3 | 4.5 | 0.37/0.60 | 220000 |
| | Typ1b | | | | |
| Sol-GreenD32 | Ir138 | 21.5 | 4.3 | 0.37/0.61 | 280000 |
| | Typ1b | | | | |
| Sol-GreenD33 | Ir141 | 21.7 | 4.5 | 0.34/0.63 | 140000 |
| | Typ1b | | | | |
| Sol-GreenD34 | Ir143 | 22.7 | 4.4 | 0.38/0.61 | 340000 |
| | Typ1b | | | | |
| Sol-GreenD35 | Ir146 | 21.9 | 4.4 | 0.35/0.62 | 340000 |
| | Typ1b | | | | |
| Sol-GreenD36 | Ir151 | 22.4 | 4.5 | 0.41/0.58 | 430000 |
| | Typ1b | | | | |
| Sol-GreenD37 | Ir201 | 20.0 | 4.3 | 0.36/0.61 | 340000 |
| | Typ1b | | | | |
| Sol-GreenD38 | Ir203 | 21.7 | 4.4 | 0.34/0.63 | 380000 |
| | Typ1b | | | | |
| Sol-GreenD39 | Ir205 | 22.1 | 4.4 | 0.39/0.59 | 400000 |
| | Typ1b | | | | |
| Sol-GreenD40 | Ir308 | 20.8 | 4.5 | 0.35/0.62 | 350000 |
| | Typ1b | | | | |
| Sol-GreenD41 | Ir(L11) | 21.1 | 4.6 | 0.43/0.56 | 300000 |
| | Typ1b | | | | |
| Sol-GreenD42 | Ir(L23) | 21.6 | 4.4 | 0.34/0.61 | 190000 |
| | Typ1b | | | | |
| Sol-GreenD43 | Ir(L25) | 17.2 | 5.8 | 0.39/0.60 | 260000 |
| | Typ1b | | | | |
| Sol-GreenD44 | Ir(L27) | 19.9 | 4.8 | 0.45/0.52 | 360000 |
| | Typ1b | | | | |
| Sol-GreenD45 | Ir(L96) | 20.3 | 4.6 | 0.35/0.62 | 390000 |
| | Typ1b | | | | |
| Sol-GreenD46 | Ir(L118) | 23.1 | 4.5 | 0.34/0.62 | 200000 |
| | Typ1b | | | | |
| Sol-GreenD47 | IrL(146) | 20.2 | 4.3 | 0.31/0.64 | 380000 |
| | Typ1b | | | | |
| Sol-GreenD48 | Ir(L208) | 19.5 | 4.5 | 0.38/0.60 | 340000 |
| | Typ1b | | | | |
| Sol-GreenD49 | Ir(L130) | 16.8 | 4.6 | 0.36/0.60 | 160000 |
| | Typ1b | | | | |
| Sol-GreenD50 | Ir(L47) | 19.3 | 4.5 | 0.39/0.58 | 400000 |
| | Typ1b | | | | |
| Sol-GreenD51 | Ir(L53) | 20.9 | 4.7 | 0.46/0.51 | 260000 |
| | Typ1b | | | | |
| Sol-GreenD52 | Ir(L218) | 20.3 | 4.6 | 0.38/0.59 | 390000 |
| | Typ1b | | | | |
| Sol-GreenD53 | Ir(L226) | 21.9 | 4.4 | 0.47/0.50 | 180000 |
| | Typ1b | | | | |
| Sol-GreenD54 | Ir(L273) | 20.0 | 4.5 | 0.37/0.61 | 400000 |
| | Typ1b | | | | |
| Sol-GreenD55 | Ir(L280) | 6.3 | 4,9 | 0.39/0.55 | --- |
| | Typ1a | | | | |
| Sol-GreenD56 | Ir(L302) | 22.4 | 4.4 | 0.35/0.63 | 350000 |
| | Typ1b | | | | |
| Sol-GreenD57 | Ir801 | 20.3 | 4.6 | 0.34/0.62 | 410000 |
| | Typ1b | | | | |
| Sol-GreenD58 | IrL802 | 21.0 | 4.5 | 0.39/0.59 | 380000 |
| | Typ1b | | | | |

### B: Aus polymeren Funktionsmaterialien:

Herstellung der OLEDs wie unter A: beschrieben. Zur Herstellung der Emissionsschicht werden die erfindungsgemäßen Polymere in Toluol gelöst. Der typische Feststoffgehalt solcher Lösungen liegt zwischen 10 und 15 g/L, wenn, wie hier, die für eine Device typische Schichtdicke von 40 nm mittels Spincoating erzielt werden soll. Die genannten OLED-Beispiele sind noch nicht optimiert, Tabelle 12 fasst die erhaltenen Daten zusammen.

**Tabelle 12: Ergebnisse mit aus Lösung prozessierten Materialien**

| **Bsp.** | **Polymer** | **EQE (%)** | **Spannung (V)** | **CIE x/y** |
|---|---|---|---|---|
| | | **1000 cd/m²** | **1000 cd/m²** | **1000 cd/m²** |
| **Grüne OLEDs** | | | | |
| D-P1 | P1 | 19.8 | 4.1 | 0.39/0.59 |

| **Gelbe OLEDs** | | | | |
|---|---|---|---|---|
| D-P2 | P2 | 20.0 | 4.0 | 0.43/0.55 |
| D-P3 | P3 | 19.7 | 4.0 | 0.42/0.56 |

**Tabelle 13: Strukturformeln der verwendeten Materialien**

| | |
|---|---|
| 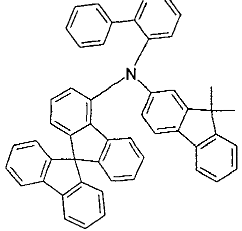 | 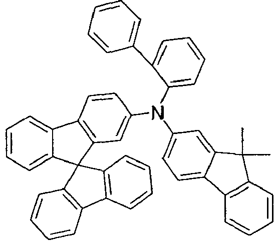 |
| HTM = M9 | HTM2 |
| 1450933-44-4 | 1364603-07-5 |
| 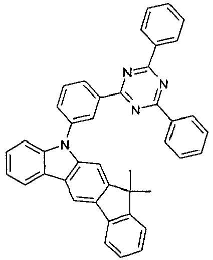 | 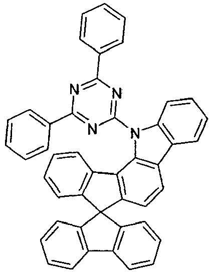 |
| M1 | M2 |
| 1257248-13-7 | 1615703-29-1 |
| 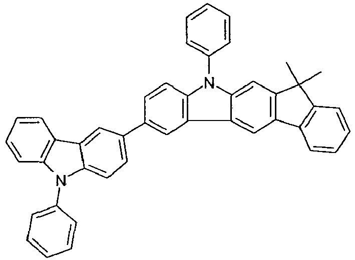 | 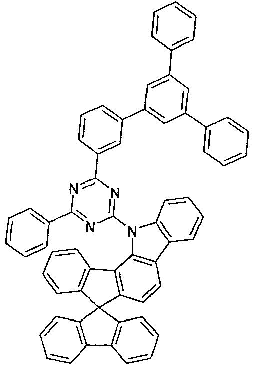 |
| M3 | M4 |
| 1357150-54-9 | 1616231-60-7 |
| 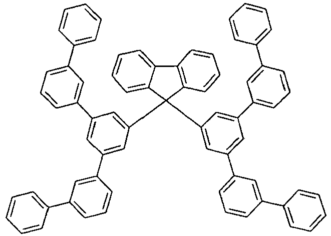 | 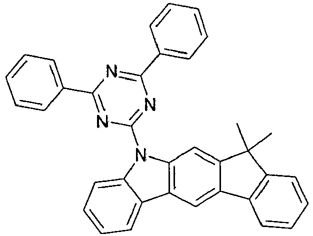 |
| M5 | M6 |
| 1246496-85-4 | 1257220-48-6 |
| 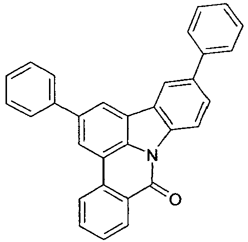 | 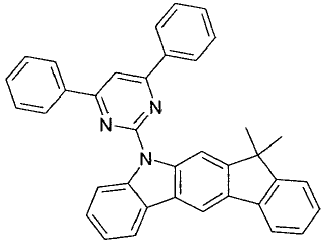 |
| M7 | M8 |
| 1615695-76-5 | 1238297-78-3 |
| 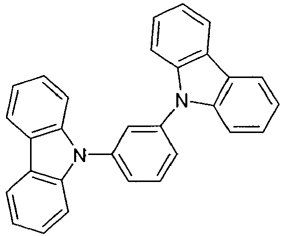 | 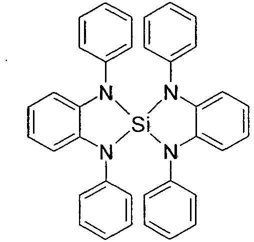 |
| M9 | EBM1 |
| 550378-78-4 | 12006465-62-4 |
| 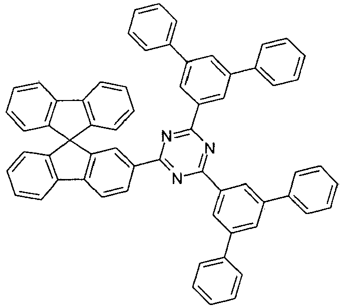 | 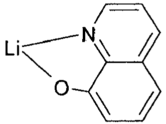 |
| ETM1 = HBM1 = M10 | ETM2 |
| 1233200-52-6 | 25387-93-3 |
| 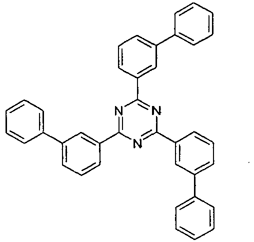 | 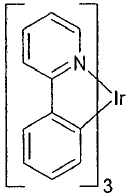 |
| ETM3 | IrPPy |
| 1201800-83-0 | 693794-98-8 |
| 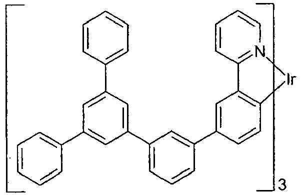 | 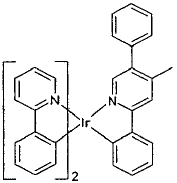 |
| Ir1 | Ir2 |
| 1269508-30-6 | 1215692-34-4 |
| 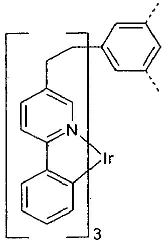 | 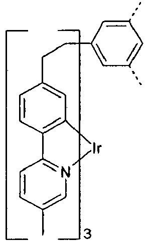 |
| Ir3* | Ir4* |
| 861806-70-4 | 873436-02-3 |
| 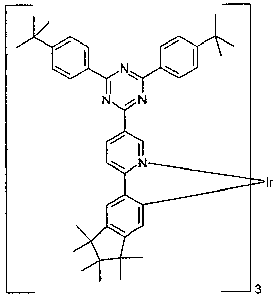 | 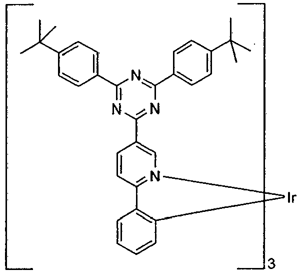 |
| Ir5 | Ir6 |
| EP14002623.8 | 1202823-72-0 |

| | |
|---|---|
| *: G. St-Pierre et al., Dalton Trans, 2011, 40, 11726. | |

### Beschreibung der Figuren

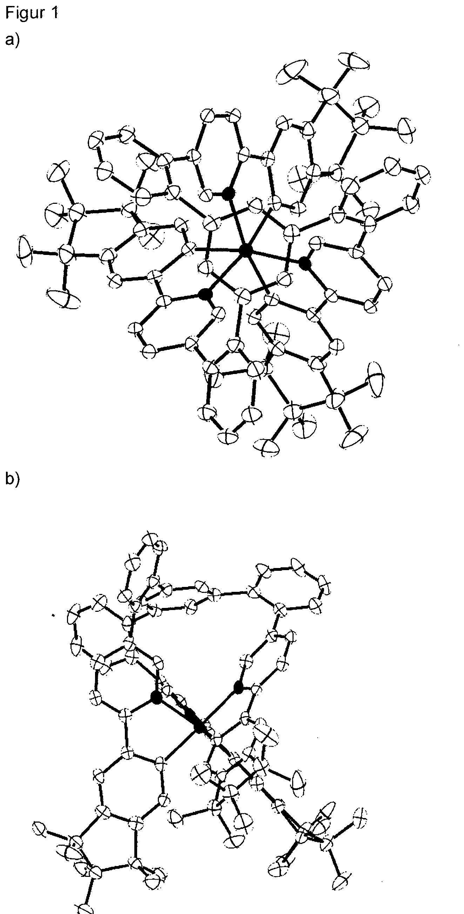

**Figur 1****: Einkristallstruktur der Verbindung Ir(L1) (ORTEP-Darstellung mit 50% Wahrscheinlichkeitslevel)**
   a) Blick entlang der (pseudo) C₃-Achse
   b) Blick seitlich auf die (pseudo) C₃-Achse
   Die Wasserstoffatome sind zur besseren Übersichtlichkeit nicht dargestellt.

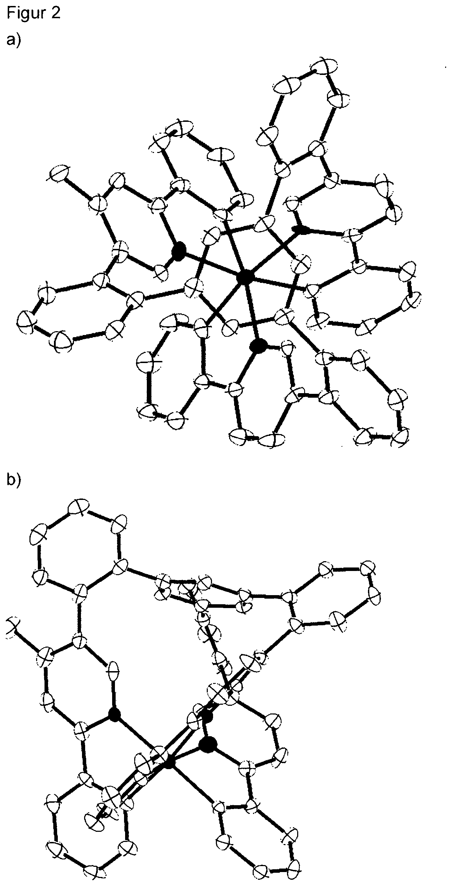

**Figur 2****: Einkristallstruktur der Verbindung Ir(L48) (ORTEP-Darstellung mit 50% Wahrscheinlichkeitslevel)**
   a) Blick entlang der (pseudo) C₃-Achse
   b) Blick seitlich auf die (pseudo) C₃-Achse
   Die Wasserstoffatome sind zur besseren Übersichtlichkeit nicht dargestellt.

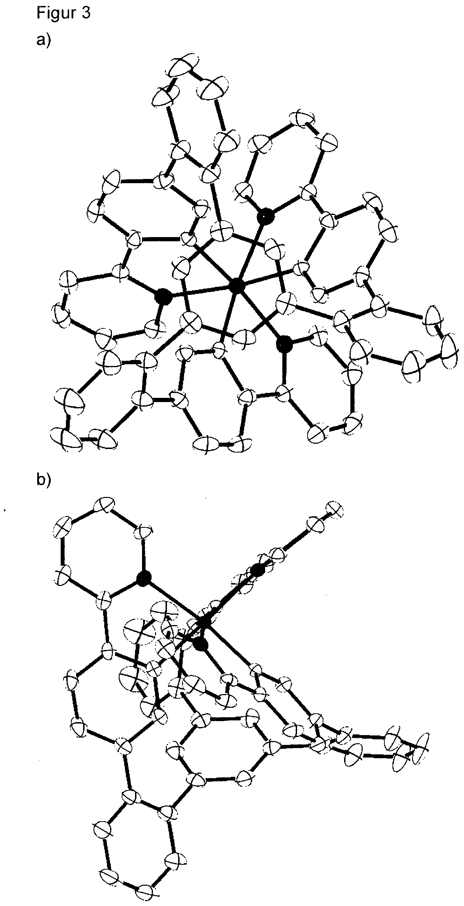

**Figur 3****: Einkristallstruktur der Verbindung Ir(L72) (ORTEP-Darstellung mit 50% Wahrscheinlichkeitslevel)**
   a) Blick entlang der (pseudo) C₃-Achse
   b) Blick seitlich auf die (pseudo) C₃-Achse
   Die Wasserstoffatome sind zur besseren Übersichtlichkeit nicht dargestellt.

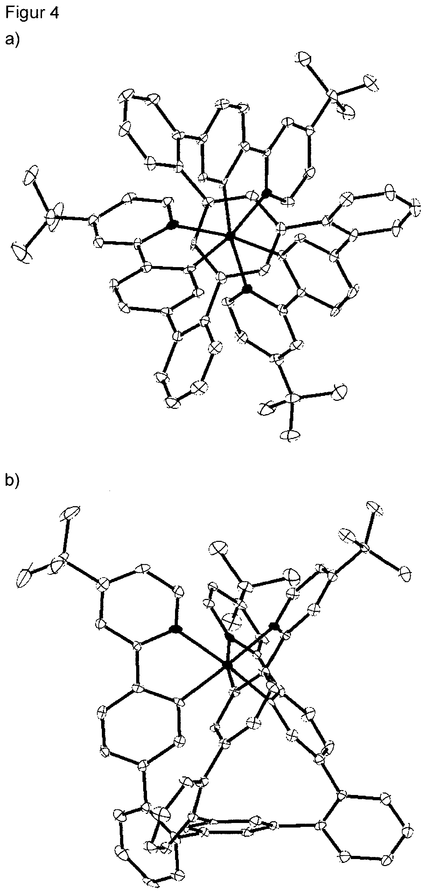

**Figur 4****: Einkristallstruktur der Verbindung Ir(L111) (ORTEP-Darstellung mit 50% Wahrscheinlichkeitslevel)**
   a) Blick entlang der (pseudo) C₃-Achse
   b) Blick seitlich auf die (pseudo) C₃-Achse
   Die Wasserstoffatome sind zur besseren Übersichtlichkeit nicht dargestellt.

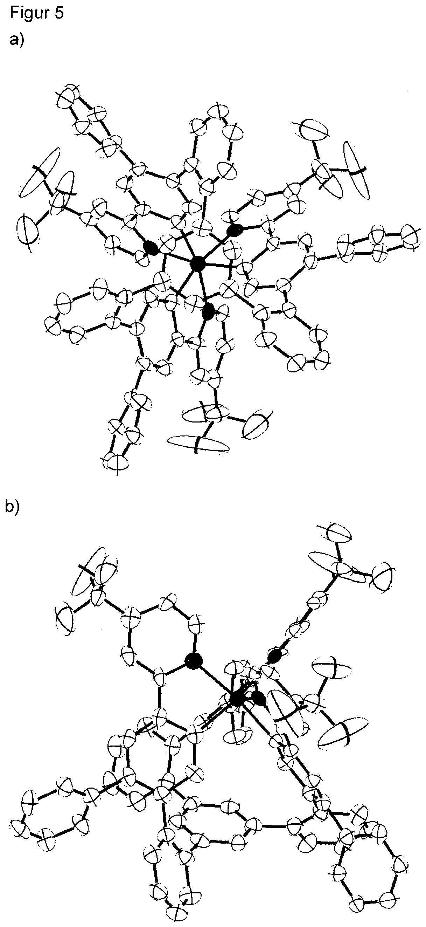

**Figur 5****: Einkristallstruktur der Verbindung Ir116 (ORTEP-Darstellung mit 50% Wahrscheinlichkeitslevel)**
   a) Blick entlang der (pseudo) C₃-Achse
   b) Blick seitlich auf die (pseudo) C₃-Achse
   Die Wasserstoffatome sind zur besseren Übersichtlichkeit nicht dargestellt.

## Patentansprüche

1. Monometallischer Metallkomplex enthaltend einen hexadentaten tripodalen Liganden, in dem drei bidentate Teilliganden an ein Metall koordinieren und die drei bidentaten Teilliganden, die gleich oder verschieden sein können, über eine Brücke der Formel (1) verknüpft sind: 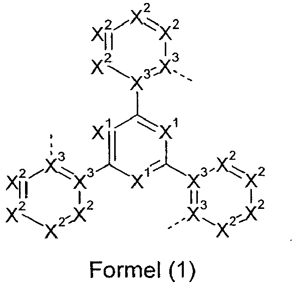 wobei die gestrichelte Bindung die Bindung der bidentaten Teilliganden an diese Struktur darstellt und für die verwendeten Symbole gilt:
X¹ ist bei jedem Auftreten gleich oder verschieden C, welches auch substituiert sein kann, oder N;
X² ist bei jedem Auftreten gleich oder verschieden C, welches auch substituiert sein kann, oder N oder zwei benachbarte Gruppen X² stehen zusammen für N, welches auch substituiert sein kann, O oder S, so dass ein Fünfring entsteht; oder zwei benachbarte Gruppen X² stehen zusammen für C, welches auch substituiert sein kann, oder N, wenn in dem Cyclus eine der Gruppen X³ für N steht, so dass ein Fünfring entsteht; mit der Maßgabe, dass maximal zwei benachbarte Gruppen X² in jedem Ring für N stehen; dabei können gegebenenfalls vorhandene Substituenten auch miteinander oder mit Substituenten, die an X¹ gebunden sind, ein Ringsystem bilden;
X³ ist bei jedem Auftreten in einem Cyclus C oder eine Gruppe X³ steht für N und die andere Gruppe X³ in demselben Cyclus steht für C, wobei die Gruppen X³ in den drei Cyclen unabhängig voneinander gewählt werden können; mit der Maßgabe, dass zwei benachbarte Gruppen X² zusammen für C, welches auch substituiert sein kann, oder N stehen, wenn in dem Cyclus eine der Gruppen X³ für N steht;
dabei können die drei bidentaten Liganden außer durch die Brücke der Formel (1) auch durch eine weitere Brücke zu einem Kryptat geschlossen sein.

2. Metallkomplex nach Anspruch 1, **dadurch gekennzeichnet, dass**, wenn X¹ bzw. X² für ein substituiertes Kohlenstoffatom stehen bzw. wenn zwei benachbarte Gruppen X² für ein substituiertes Stickstoffatom oder ein substituiertes Kohlenstoffatom stehen, der Substituent bevorzugt ausgewählt ist aus den folgenden Substituenten R:
R ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 CAtomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann; dabei können zwei Reste R auch miteinander ein Ringsystem bilden;
R¹ ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer und/oder heteroaromatischer organischer Rest, insbesondere ein Kohlenwasserstoffrest, mit 1 bis 20 C-Atomen, in dem auch ein oder mehrere H-Atome durch F ersetzt sein können.

3. Metallkomplex nach Anspruch 1 oder 2, **dadurch gekennzeichnet, dass** die Gruppe der Formel (1) ausgewählt ist aus den Strukturen der Formeln (2) bis (5), 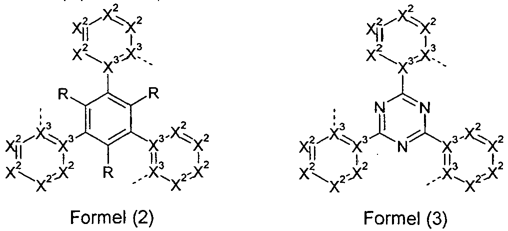 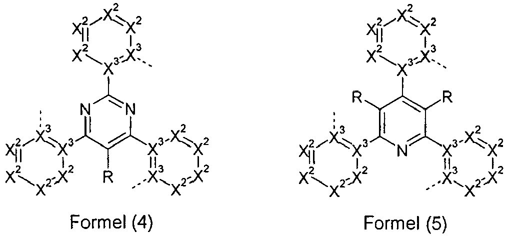 wobei die verwendeten Symbole die in Anspruch 1 und 2 genannten Bedeutungen aufweisen.

4. Metallkomplex nach einem oder mehreren der Ansprüche 1 bis 3, **dadurch gekennzeichnet, dass** das Symbol X³ für C steht und die-Gruppe der Formel (1) ausgewählt ist aus den Formeln (2a) bis (5a): 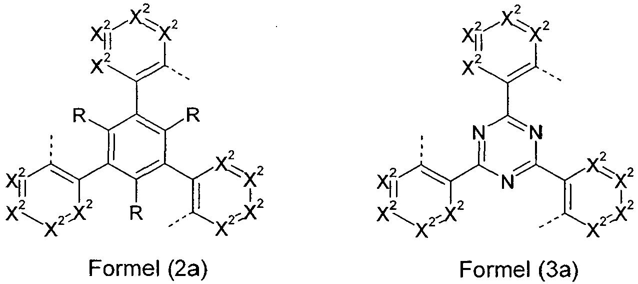 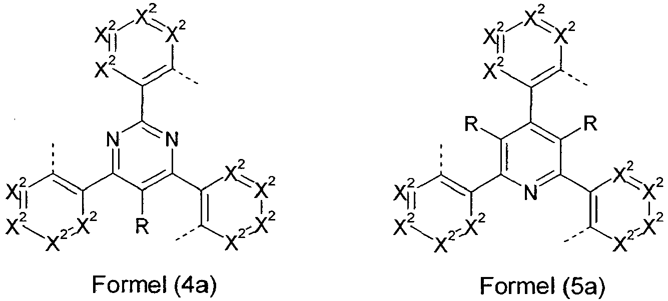 wobei die Symbole die in den Ansprüchen 1 und 2 aufgeführten Bedeutungen aufweisen.

5. Metallkomplex nach einem oder mehreren der Ansprüche 1 bis 4, wobei die bivalenten Arylen- bzw. Heteroarylengruppen in der Einheit der Formel (1) bis (5) gleich oder verschieden bei jedem Auftreten ausgewählt sind aus den Formeln (7) bis (31), 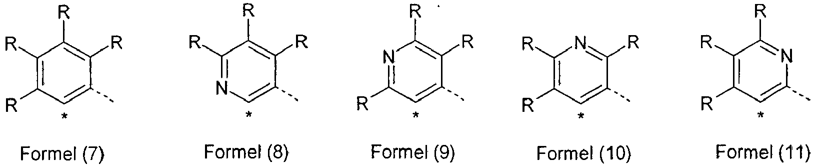 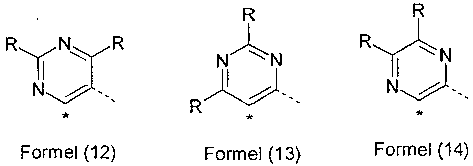 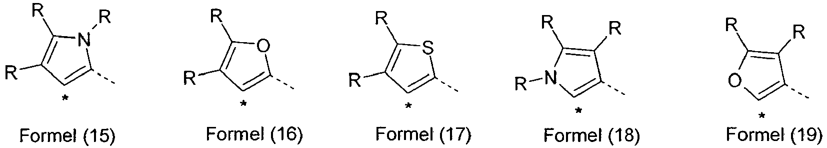 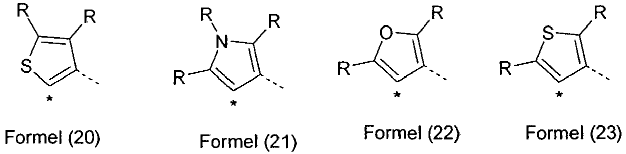 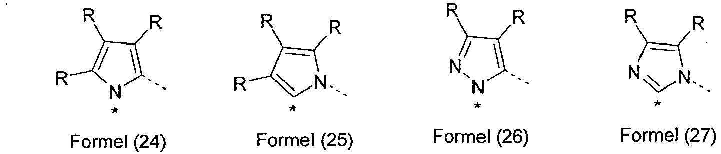 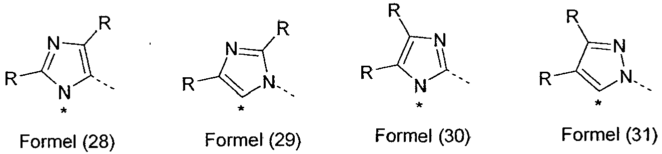 wobei die gestrichelte Bindung jeweils die Position der Verknüpfung mit dem bidentaten Teilliganden darstellt, * die Position der Verknüpfung der Einheit mit der zentralen trivalenten Aryl- bzw. Heteroarylgruppe in Formel (1) bis (5) darstellt und R die in Anspruch 2 angegebenen Bedeutungen aufweist.

6. Metallkomplex nach einem oder mehreren der Ansprüche 1 bis 5, **dadurch gekennzeichnet, dass** die Gruppe der Formel (1) ausgewählt ist aus den Gruppen der Formeln (2b) bis (5b), 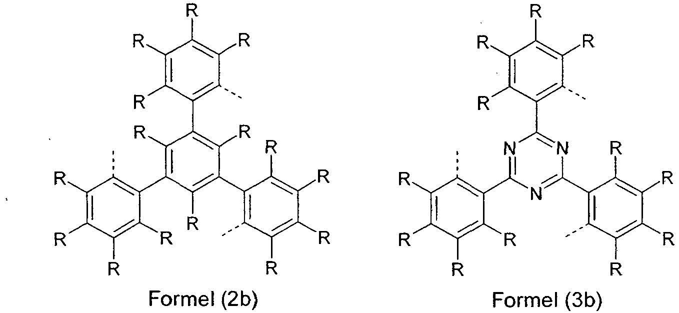 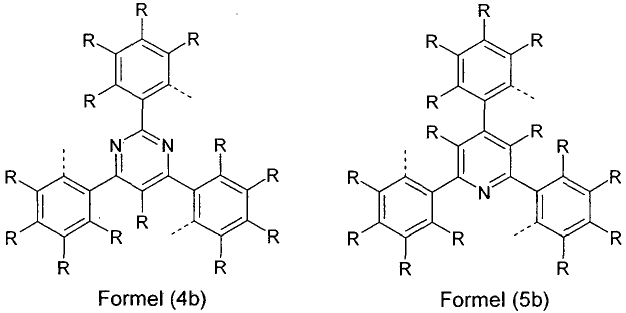 wobei die verwendeten Symbole die in Anspruch 2 genannten Bedeutungen aufweisen.

7. Metallkomplex nach einem oder mehreren der Ansprüche 1 bis 6, **dadurch gekennzeichnet, dass** die drei bidentaten Teilliganden gleich gewählt sind oder dass zwei der bidentaten Teilliganden gleich gewählt sind und der dritte bidentate Teilligand unterschiedlich von den ersten beiden bidentaten Teilliganden ist.

8. Metallkomplex nach einem oder mehreren der Ansprüche 1 bis 7, **dadurch gekennzeichnet, dass** das Metall ausgewählt ist aus der Gruppe bestehend aus Aluminium, Indium, Gallium und Zinn und dass die bidentaten Teilliganden gleich oder verschieden bei jedem Auftreten zwei Stickstoffatome oder zwei Sauerstoffatome oder ein Stickstoffatom und ein Sauerstoffatom als koordinierende Atome aufweisen, oder dass das Metall ausgewählt ist aus der Gruppe bestehend aus Chrom, Molybdän, Wolfram, Rhenium, Ruthenium, Osmium, Rhodium, Iridium, Eisen, Cobalt, Nickel, Palladium, Platin, Kupfer, Silber und Gold und dass die bidentaten Teilliganden gleich oder verschieden bei jedem Auftreten ein Kohlenstoffatom und ein Stickstoffatom oder zwei Kohlenstoffatome oder zwei Stickstoffatome oder zwei Sauerstoffatome oder ein Sauerstoffatom und ein Stickstoffatom als koordinierende Atome aufweisen.

9. Metallkomplex nach einem oder mehreren der Ansprüche 1 bis 8, dadurch gekennzeichhnet, dass das Metall Ir(III) ist und zwei der bidentaten Teilliganden an das Iridium über jeweils ein Kohlenstoffatom und ein Stickstoffatom koordinieren und der dritte der bidentaten Teilliganden an das Iridium über ein Kohlenstoffatom und ein Stickstoffatom oder über zwei Stickstoffatome oder über ein Stickstoffatom und ein Sauerstoffatom oder über zwei Sauerstoffatome koordiniert.

10. Metallkomplex nach einem oder mehreren der Ansprüche 1 bis 9, **dadurch gekennzeichnet, dass** mindestens einer der bidentaten Teilliganden für eine Struktur gemäß den Formeln (L-1), (L-2), (L-3) oder (L-4) steht, 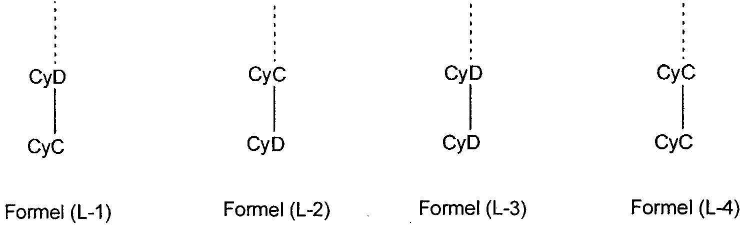 wobei die gestrichelte Bindung die Bindung des Teilliganden an die Brücke der Formeln (1) darstellt und für die weiteren verwendeten Symbole gilt:
CyC ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche in (L-1) und (L-2) über eine kovalente Bindung mit CyD verbunden ist und in (L-4) über eine kovalente Bindung mit einer weiteren Gruppe CyC verbunden ist;
CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche in (L-1) und (L-2) über eine kovalente Bindung mit CyC verbunden ist und in (L-3) über eine kovalente Bindung mit einer weiteren Gruppe CyD verbunden ist;
dabei können mehrere der optionalen Substituenten miteinander ein Ringsystem bilden.

11. Metallkomplex nach Anspruch 10, **dadurch gekennzeichnet, dass** CyC ausgewählt ist aus den Strukturen der Formeln (CyC-1) bis (CyC-19), wobei die Gruppe CyC jeweils an der durch # gekennzeichneten Position an CyD in (L-1) und (L-2) bzw. an CyC in (L-4) bindet und an der durch * gekennzeichneten Position an das Metall koordiniert, 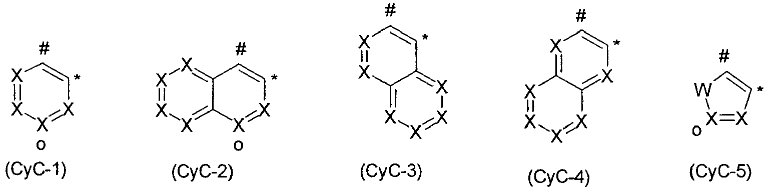 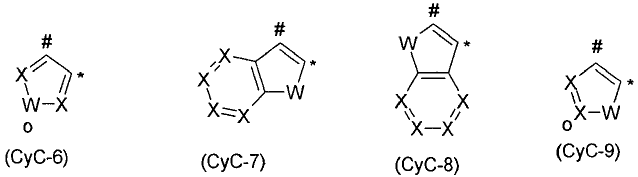 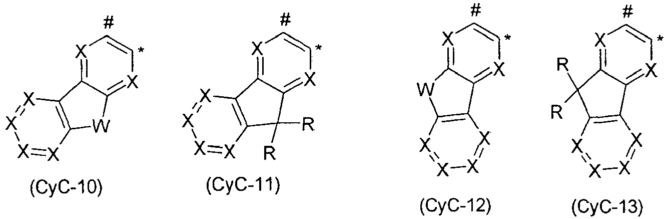 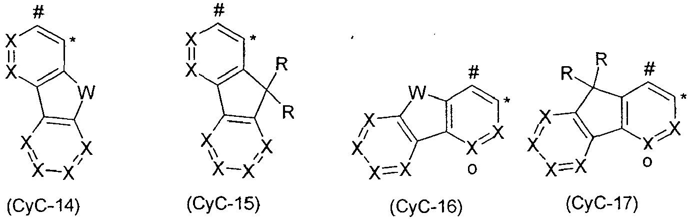 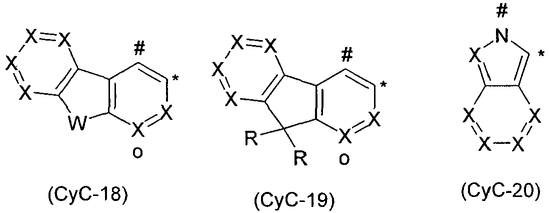 und dass CyD ausgewählt ist aus den Formeln (CyD-1) bis (CyD-14), wobei die Gruppe CyD jeweils an der durch # gekennzeichneten Position an CyC in (L-1) und (L-2) bzw. an CyD in (L-3) bindet und an der durch * gekennzeichneten Position an das Metall koordiniert, 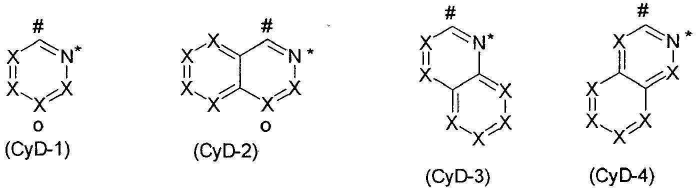 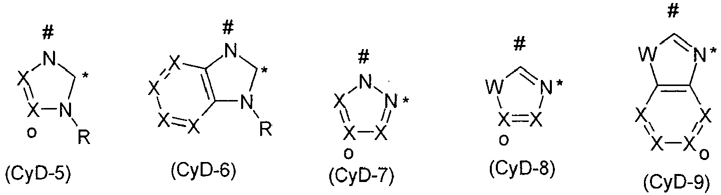 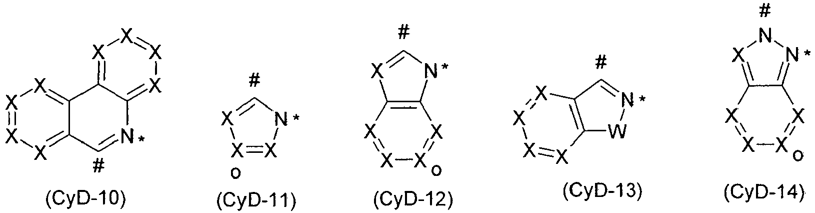 wobei R die in Anspruch 2 genannten Bedeutungen aufweist und für die weiteren verwendeten Symbole gilt:
X ist bei jedem Auftreten gleich oder verschieden CR oder N mit der Maßgabe, dass maximal zwei Symbole X pro Cyclus für N stehen;
W ist bei jedem Auftreten gleich oder verschieden NR, O oder S;
mit der Maßgabe, dass, wenn die Brücke der Formel (1) an CyC gebunden ist, ein Symbol X für C steht und die Brücke der Formel (1) an dieses Kohlenstoffatom gebunden ist und wenn die Brücke der Formel (1) an CyD gebunden ist, ein Symbol X für C steht und die Brücke der Formel (1) an dieses Kohlenstoffatom gebunden ist, wobei die Bindung an die Brücke der Formel (1) bevorzugt über die mit "o" markierte Position erfolgt.

12. Metallkomplex nach einem oder mehreren der Ansprüche 1 bis 11, **dadurch gekennzeichnet, dass** mindestens einer der bidentaten Teilliganden ausgewählt ist aus den Strukturen der Formeln (L-1-1), (L-1-2) und (L-2-1) bis (L-2-3), 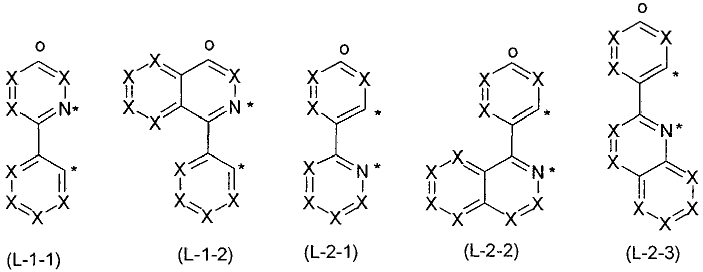 wobei die verwendeten Symbole die in den Ansprüchen 2 und 11 genannten Bedeutungen aufweisen und "o" die Position der Bindung an die Brücke der Formel (1) darstellt;
und/oder dass mindestens einer der bidentaten Teilliganden ausgewählt ist aus den Strukturen der Formeln (L-5) bis (L-32), 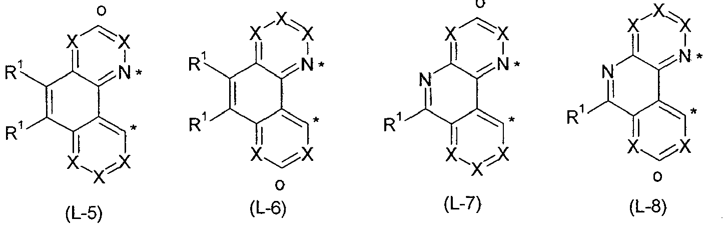 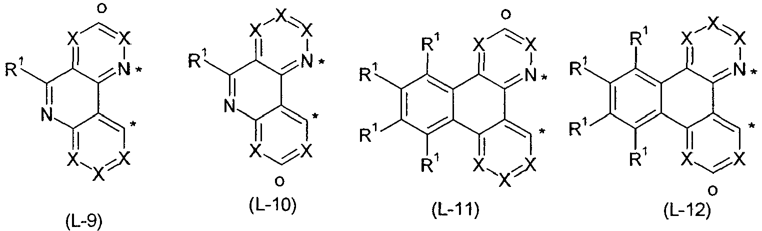 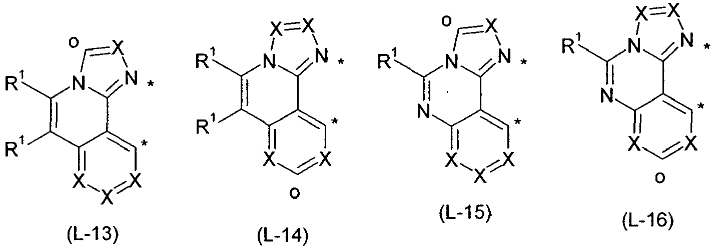 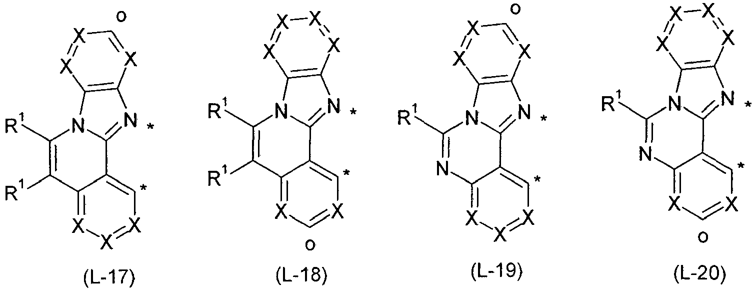 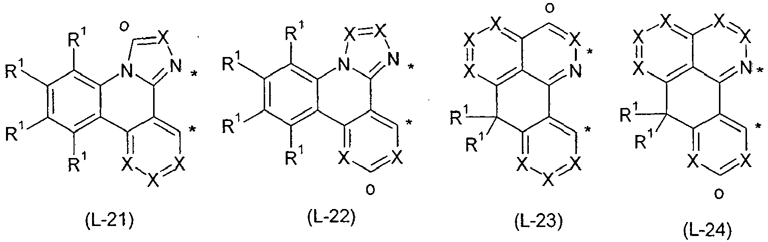 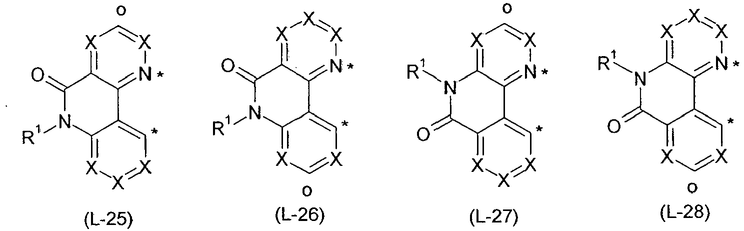 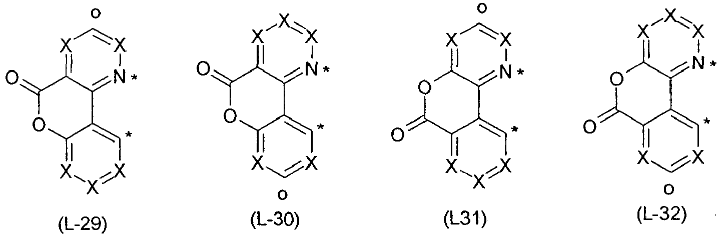 wobei die verwendeten Symbole die in den Ansprüchen 2 und 11 genannten Bedeutungen aufweisen und "o" die Position angibt, an denen dieser Teilligand mit der Gruppe der Formel (1) verknüpft ist;
und/oder dass mindestens einer der bidentaten Teilliganden ausgewählt ist aus den Strukturen der folgenden Formeln (L-33) und (L-34), 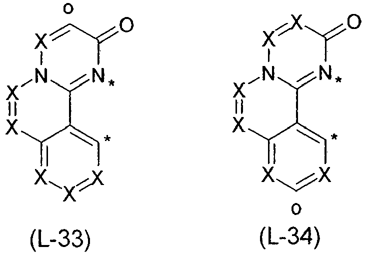 wobei R die in Anspruch 2 genannten Bedeutungen aufweist, * die Position der Koordination an das Metall darstellt, "o" die Position der Verknüpfung des Teilliganden mit der Gruppe der Formel (1) darstellt und für die weiteren verwendeten Symbole gilt:
X ist bei jedem Auftreten gleich oder verschieden CR oder N mit der Maßgabe, dass maximal ein Symbol X pro Cyclus für N steht;
und/oder dass mindestens einer der bidentaten Teilliganden ausgewählt ist aus den Strukturen der folgenden Formeln (L-41) bis (L-44), 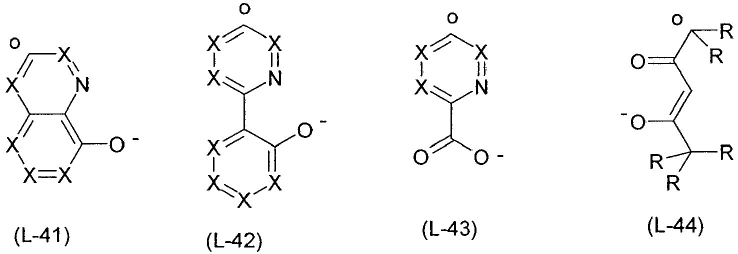 wobei die Teilliganden (L-41) bis (L-43) jeweils über das explizit eingezeichnete Stickstoffatom und das negativ geladene Sauerstoffatom und der Teilligand (L-44) über die beiden Sauerstoffatome an das Metall koordinieren, X die in Anspruch 11 genannten Bedeutungen aufweist und "o" die Position angibt, über die der Teilligand mit der Gruppe der Formel (1) verknüpft ist.

13. Metallkomplex nach einem oder mehreren der Ansprüche 1 bis 12, **dadurch gekennzeichnet, dass** der Metallkomplex zwei Substituenten R und/oder zwei Substituenten R¹ aufweist, die an benachbarte Kohlenstoffatome gebunden sind und die miteinander einen Ring gemäß einer Formeln (43) bis (49) bilden, 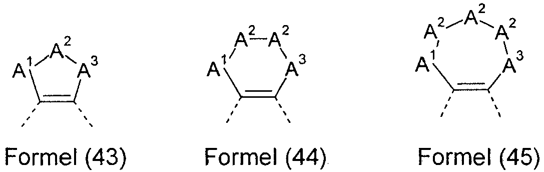 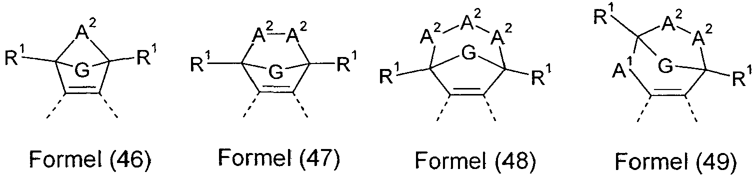 wobei R¹ und R² die in Anspruch 2 genannten Bedeutungen aufweisen, die gestrichelten Bindungen die Verknüpfung der beiden Kohlenstoffatome im Liganden andeuten und weiterhin gilt:
A¹, A³ ist gleich oder verschieden bei jedem Auftreten C(R³)₂, O, S, NR³ oder C(=O);
A² ist C(R¹)₂, O, S, NR³ oder C(=O);
G ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
R³ ist gleich oder verschieden bei jedem Auftreten H, F, eine geradkettige Alkyl- oder Alkoxygruppe mit 1 bis 10 C-Atomen, eine verzweigte oder cyclische Alkyl- oder Alkoxygruppe mit 3 bis 10 CAtomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

14. Oligomer, Polymer oder Dendrimer enthaltend einen oder mehrere Metallkomplexe nach einem oder mehreren der Ansprüche 1 bis 13, wobei statt eines Wasserstoffatoms oder eines Substituenten ein oder mehrere Bindungen des Metallkomplexes zum Polymer, Oligomer oder Dendrimer vorhanden sind.

15. Formulierung, enthaltend mindestens einen Metallkomplex nach einem oder mehreren der Ansprüche 1 bis 13 oder mindestens ein Oligomer, Polymer oder Dendrimer nach Anspruch 14 und mindestens ein Lösemittel.

16. Verwendung eines Metallkomplexes nach einem oder mehreren der Ansprüche 1 bis 13 oder eines Oligomers, Polymers oder Dendrimers nach Anspruch 14 in einer elektronischen Vorrichtung oder als Sauerstoff-Sensibilisator oder als Photoinitiator oder als Photokatalysator.

17. Elektronische Vorrichtung enthaltend mindestens einen Metallkomplex nach einem oder mehreren der Ansprüche 1 bis 13 oder ein Oligomer, Polymer oder Dendrimer nach Anspruch 14, wobei die elektronische Vorrichtung bevorzugt ausgewählt ist aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen, Sauerstoff-Sensoren, Sauerstoff-Sensibilisatoren oder organischen Laserdioden

18. Elektronische Vorrichtung nach Anspruch 17, wobei die elektronische Vorrichtung eine organische Elektrolumineszenzvorrichtung ist, **dadurch gekennzeichnet, dass** der Metallkomplex nach einem oder mehreren der Ansprüche 1 bis 13 als emittierende Verbindung in einer oder mehreren emittierenden Schichten oder als Lochtransportverbindung in einer Lochinjektions- oder Lochtransportschicht oder als Elektronentransportverbindung in einer Elektronentransport- oder Lochblockierschicht eingesetzt wird.

## Claims

1. Monometallic metal complex containing a hexadentatssse tripodal ligand in which three bidentate sub-ligands coordinate to a metal and the three bidentate sub-ligands, which may be the same or different, are joined via a bridge of the formula (1): 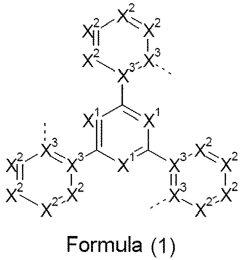 where the dotted bond represents the bond of the bidentate sub-ligands to this structure and the symbols used are as follows:
X¹ is the same or different at each instance and is C which may also be substituted or N;
X² is the same or different at each instance and is C which may also be substituted or N, or two adjacent X² groups together are N which may also be substituted, O or S, so as to form a five-membered ring, or two adjacent X² groups together are C which may also be substituted or N when one of the X³ groups in the cycle is N, so as to form a five-membered ring, with the proviso that not more than two adjacent X² groups in each ring are N; at the same time, any substituents present may also form a ring system with one another or with substituents bonded to X¹;
X³ is C at each instance in one cycle or one X³ group is N and the other X³ group in the same cycle is C, where the X³ groups in the three cycles may be selected independently, with the proviso that two adjacent X² groups together are C which may also be substituted or N when one of the X³ groups in the cycle is N;
at the same time, the three bidentate ligands, apart from by the bridge of the formula (1), may also be ring-closed by a further bridge to form a cryptate.

2. Metal complex according to Claim 1, **characterized in that**, when X¹ and/or X² is a substituted carbon atom and/or when two adjacent X² groups are a substituted nitrogen atom or a substituted carbon atom, the substituent is preferably selected from the following substituents R:
R is the same or different at each instance and is H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, a straight-chain alkyl, alkoxy or thioalkoxy group having 1 to 20 carbon atoms or an alkenyl or alkynyl group having 2 to 20 carbon atoms or a branched or cyclic alkyl, alkoxy or thioalkoxy group having 3 to 20 carbon atoms, where the alkyl, alkoxy, thioalkoxy, alkenyl or alkynyl group may each be substituted by one or more R¹ radicals, where one or more nonadjacent CH₂ groups may be replaced by R¹C=CR¹, C≡C, Si(R¹)₂, C=O, NR¹, O, S or CONR¹, or an aromatic or heteroaromatic ring system which has 5 to 40 aromatic ring atoms and may be substituted in each case by one or more R¹ radicals, or an aryloxy or heteroaryloxy group which has 5 to 40 aromatic ring atoms and may be substituted by one or more R¹ radicals; at the same time, two R radicals together may also form a ring system;
R¹ is the same or different at each instance and is H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², a straight-chain alkyl, alkoxy or thioalkoxy group having 1 to 20 carbon atoms or an alkenyl or alkynyl group having 2 to 20 carbon atoms or a branched or cyclic alkyl, alkoxy or thioalkoxy group having 3 to 20 carbon atoms, where the alkyl, alkoxy, thioalkoxy, alkenyl or alkynyl group may each be substituted by one or more R² radicals, where one or more nonadjacent CH₂ groups may be replaced by R²C=CR², C≡C, Si(R²)₂, C=O, NR², O, S or CONR², or an aromatic or heteroaromatic ring system which has 5 to 40 aromatic ring atoms and may be substituted in each case by one or more R² radicals, or an aryloxy or heteroaryloxy group which has 5 to 40 aromatic ring atoms and may be substituted by one or more R² radicals; at the same time, two or more R¹ radicals together may form a ring system;
R² is the same or different at each instance and is H, D, F or an aliphatic, aromatic and/or heteroaromatic organic radical, especially a hydrocarbyl radical, having 1 to 20 carbon atoms, in which one or more hydrogen atoms may also be replaced by F.

3. Metal complex according to Claim 1 or 2, **characterized in that** the group of the formula (1) is selected from the structures of the formulae (2) to (5) : 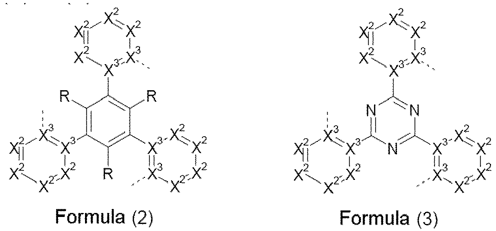 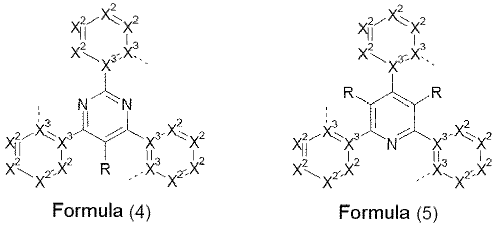 where the symbols used have the definitions given in Claims 1 and 2.

4. Metal complex according to one or more of Claims 1 to 3, **characterized in that** the symbol X³ is C and the group of the formula (1) is selected from the formulae (2a) to (5a) : 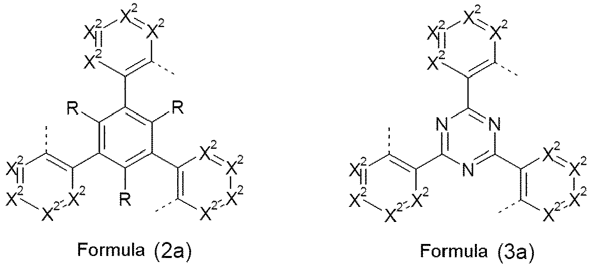 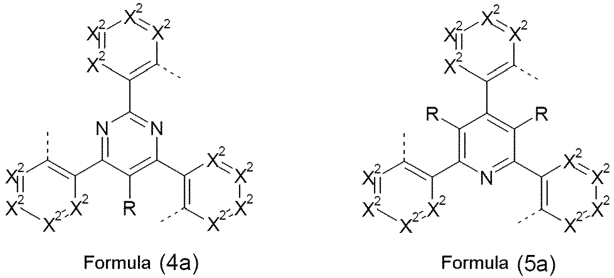 where the symbols have the definitions listed in Claims 1 and 2.

5. Metal complex according to one or more of Claims 1 to 4, wherein the bivalent arylene or heteroarylene groups in the unit of the formula (1) to (5) are the same or different at each instance and are selected from the formulae (7) to (31) : 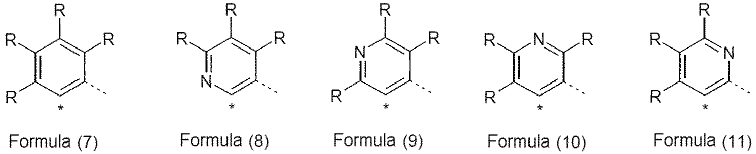 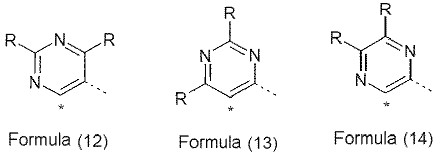 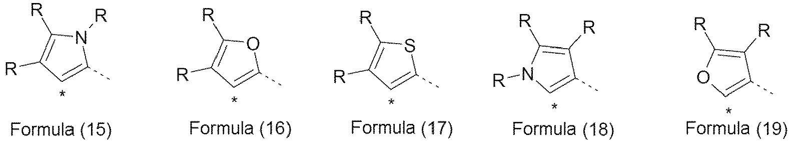 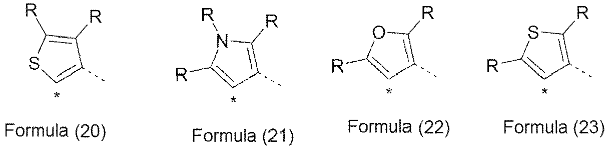 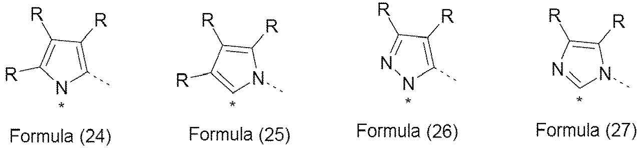 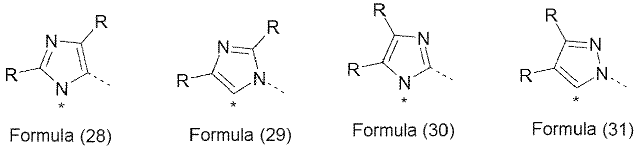 where the dotted bond in each case represents the position of the linkage to the bidentate sub-ligand, * represents the position of the linkage of the unit to the central trivalent aryl or heteroaryl group in formula (1) to (5) and R has the definitions given in Claim 2.

6. Metal complex according to one or more of Claims 1 to 5, **characterized in that** the group of the formula (1) is selected from the groups of the formulae (2b) to (5b) : 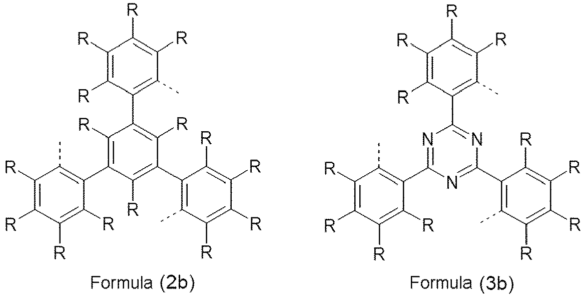 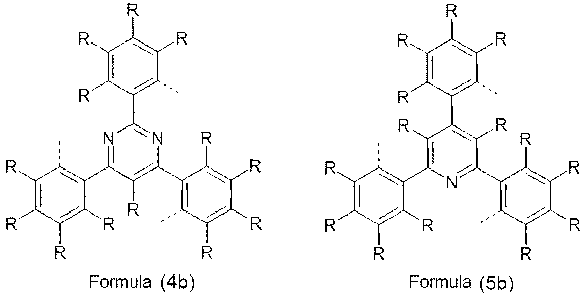 where the symbols used have the definitions given in Claim 2.

7. Metal complex according to one or more of Claims 1 to 6, **characterized in that** the three bidentate sub-ligands are selected identically or **in that** two of the bidentate sub-ligands are selected identically and the third bidentate sub-ligand is different from the first two bidentate sub-ligands.

8. Metal complex according to one or more of Claims 1 to 7, **characterized in that** the metal is selected from the group consisting of aluminium, indium, gallium and tin, and **in that** the bidentate sub-ligands are the same or different at each instance and have two nitrogen atoms or two oxygen atoms or one nitrogen atom and one oxygen atom as coordinating atoms, or **in that** the metal is selected from the group consisting of chromium, molybdenum, tungsten, rhenium, ruthenium, osmium, rhodium, iridium, iron, cobalt, nickel, palladium, platinum, copper, silver and gold, and **in that** the bidentate sub-ligands are the same or different at each instance and have one carbon atom and one nitrogen atom or two carbon atoms or two nitrogen atoms or two oxygen atoms or one oxygen atom and one nitrogen atom as coordinating atoms.

9. Metal complex according to one or more of Claims 1 to 8, **characterized in that** the metal is Ir(III) and two of the bidentate sub-ligands each coordinate to the iridium via one carbon atom and one nitrogen atom and the third of the bidentate sub-ligands coordinates to the iridium via one carbon atom and one nitrogen atom or via two nitrogen atoms or via one nitrogen atom and one oxygen atom or via two oxygen atoms.

10. Metal complex according to one or more of Claims 1 to 9, **characterized in that** at least one of the bidentate sub-ligands is a structure of the formulae (L-1), (L-2), (L-3) or (L-4): 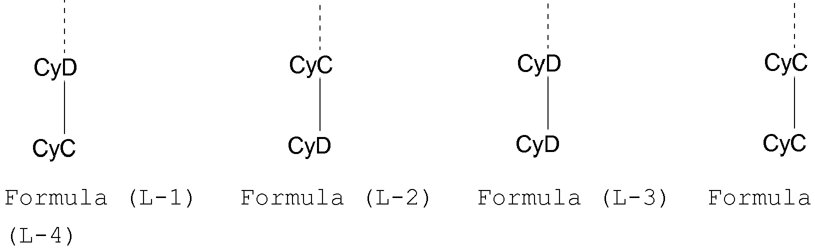 where the dotted bond represents the bond of the sub-ligand to the bridge of the formula (1) and the other symbols used are as follows:
CyC is the same or different at each instance and is a substituted or unsubstituted aryl or heteroaryl group which has 5 to 14 aromatic ring atoms and coordinates to the metal via a carbon atom in each case and which is bonded to CyD in (L-1) and (L-2) via a covalent bond and is bonded to a further CyC group in (L-4) via a covalent bond;
CyD is the same or different at each instance and is a substituted or unsubstituted heteroaryl group which has 5 to 14 aromatic ring atoms and coordinates to the metal via a nitrogen atom or via a carbene carbon atom and which is bonded to CyC in (L-1) and (L-2) via a covalent bond and is bonded to a further CyD group in (L-3) via a covalent bond;
at the same time, two or more of the optional substituents together may form a ring system.

11. Metal complex according to Claim 10, **characterized in that** CyC is selected from the structures of the formulae (CyC-1) to (CyC-19) where the CyC group binds in each case at the position signified by # to CyD in (L-1) and (L-2) and to CyC in (L-4) and at the position signified by * to the metal, 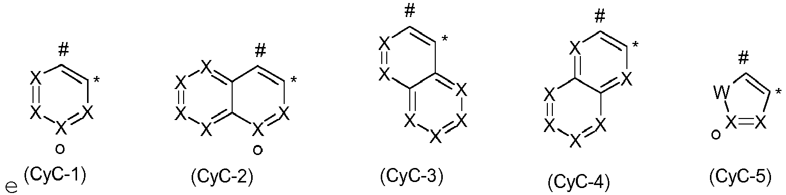 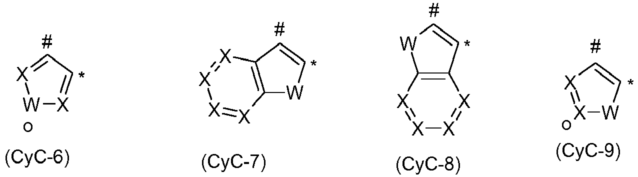 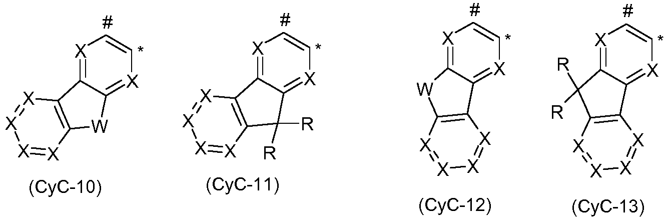 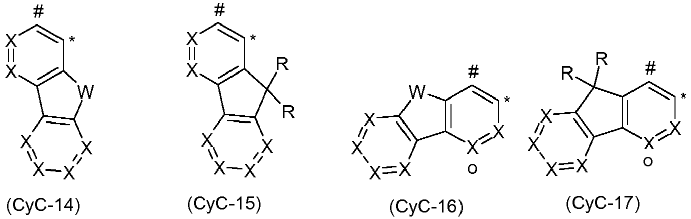 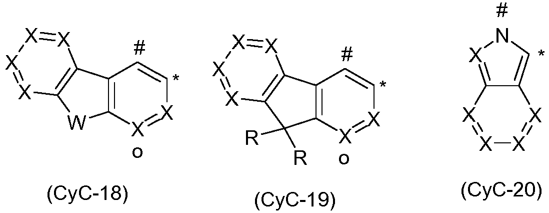 and **in that** CyD is selected from the formulae (CyD-1) to (CyD-14) where the CyD group binds in each case at the position signified by # to CyC in (L-1) and (L-2) and to CyD in (L-3) and at the position signified by * to the metal, 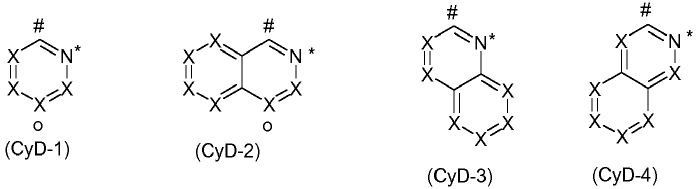 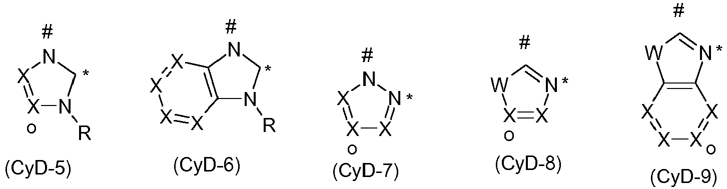 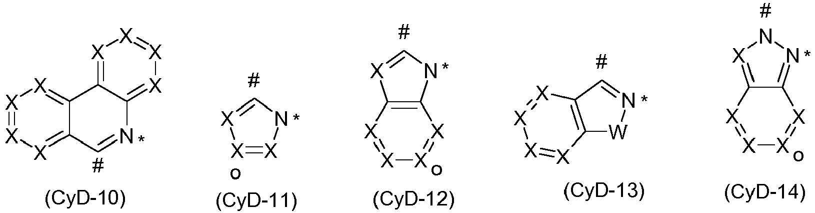 where R has the definitions given in Claim 2 and the other symbols used are as follows:
X is the same or different at each instance and is CR or N, with the proviso that not more than two symbols X per cycle are N;
W is the same or different at each instance and is NR, O or S;
with the proviso that, when the bridge of the formula (1) is bonded to CyC, one X symbol is C and the bridge of the formula (1) is bonded to this carbon atom and, when the bridge of the formula (1) is bonded to CyD, one X symbol is C and the bridge of the formula (1) is bonded to this carbon atom, where the bond to the bridge of the formula (1) is preferably via the position marked by "o".

12. Metal complex according to one or more of Claims 1 to 11, **characterized in that** at least one of the bidentate sub-ligands is selected from the structures of the formulae (L-1-1), (L-1-2) and (L-2-1) to (L-2-3) : 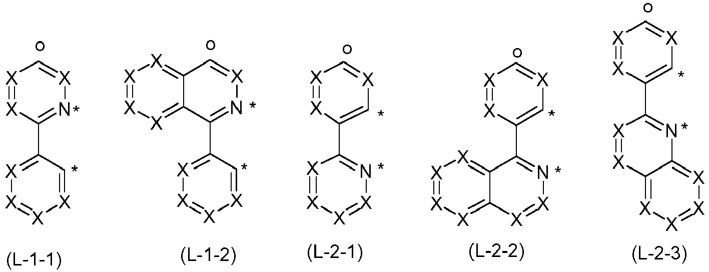 where the symbols used have the definitions given in Claims 2 and 11 and "o" represents the position of the bond to the bridge of the formula (1);
and/or **in that** at least one of the bidentate sub-ligands is selected from the structures of the formulae (L-5) to (L-32): 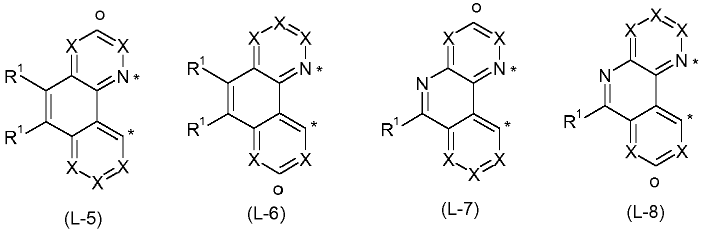 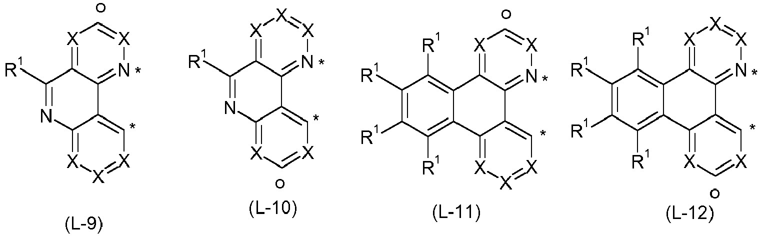 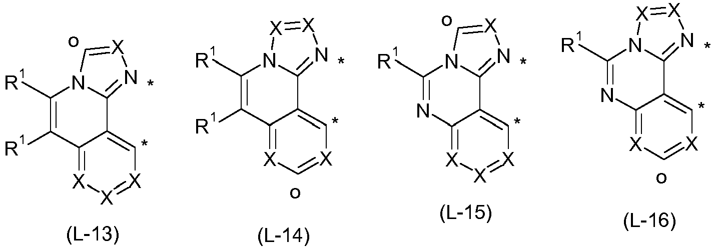 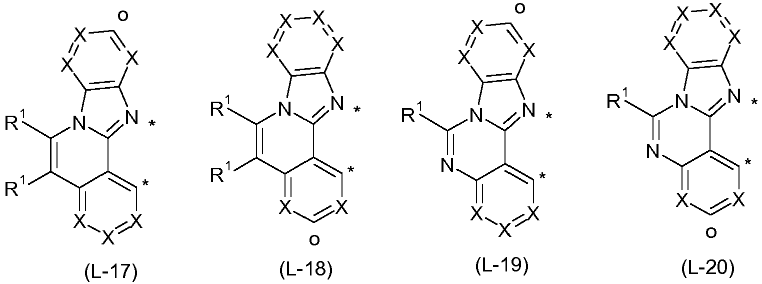 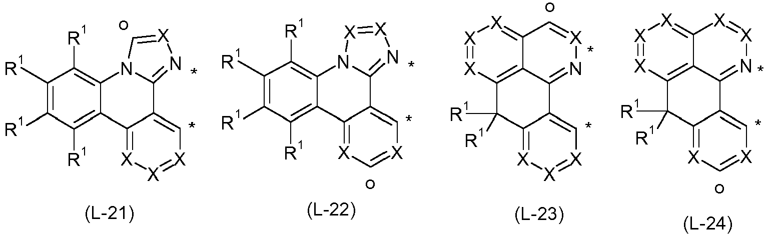 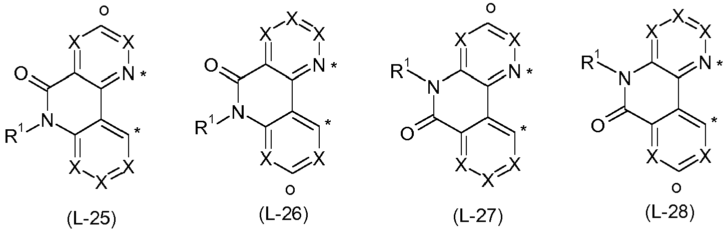 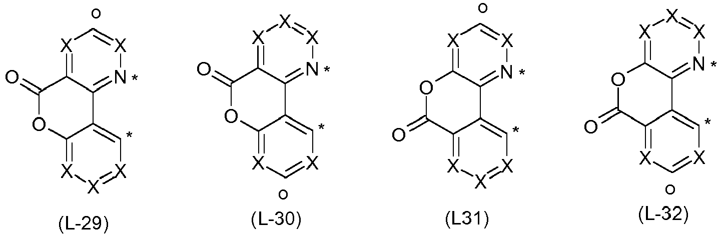 where the symbols used have the definitions given in Claims 2 and 11 and "o" indicates the position at which this sub-ligand is joined to the group of the formula (1) ;
and/or **in that** at least one of the bidentate sub-ligands is selected from the structures of the following formulae (L-33) and (L-34): 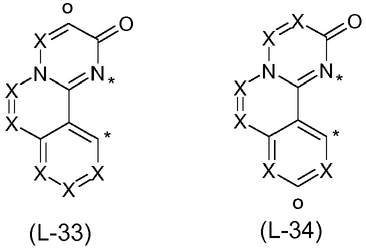
where R has the definitions given in Claim 2, * represents the position of coordination to the metal, "o" represents the position of linkage of the sub-ligand to the group of the formula (1) and the other symbols used are as follows:
X is the same or different at each instance and is CR or N, with the proviso that not more than one X symbol per cycle is N;
and/or **in that** at least one of the bidentate sub-ligands is selected from the structures of the following formulae (L-41) to (L-44): 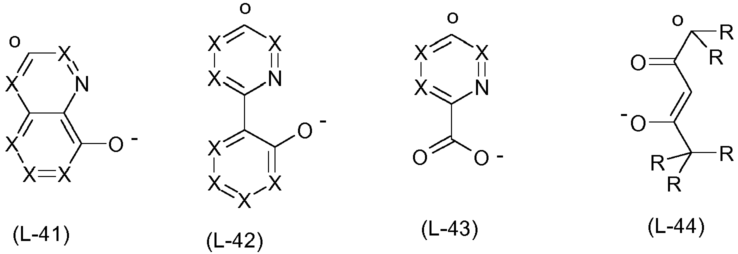 where the sub-ligands (L-41) to (L-43) each coordinate to the metal via the nitrogen atom explicitly shown and the negatively charged oxygen atom, and the sub-ligand (L-44) coordinates via the two oxygen atoms, X has the definitions given in Claim 11 and "o" indicates the position via which the sub-ligand is joined to the group of the formula (1).

13. Metal complex according to one or more of Claims 1 to 12, **characterized in that** the metal complex has two R substituents and/or two R¹ substituents which are bonded to adjacent carbon atoms and together form a ring of one of formulae (43) to (49): 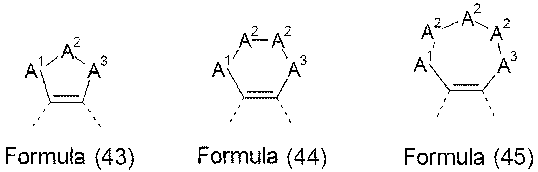 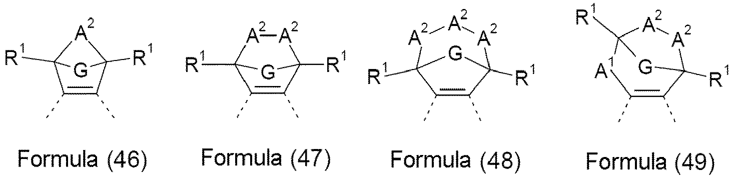
where R¹ and R² have the definitions given in Claim 2, the dotted bonds signify the linkage of the two carbon atoms in the ligand and, in addition:
A¹, A³ is the same or different at each instance and is C(R³)₂, O, S, NR³ or C(=O) ;
A² is C(R¹)₂, O, S, NR³ or C(=O) ;
G is an alkylene group which has 1, 2 or 3 carbon atoms and may be substituted by one or more R² radicals, -CR²=CR²- or an ortho-bonded arylene or heteroarylene group which has 5 to 14 aromatic ring atoms and may be substituted by one or more R² radicals;
R³ is the same or different at each instance and is H, F, a straight-chain alkyl or alkoxy group having 1 to 10 carbon atoms, a branched or cyclic alkyl or alkoxy group having 3 to 10 carbon atoms, where the alkyl or alkoxy group may be substituted in each case by one or more R² radicals, where one or more nonadjacent CH₂ groups may be replaced by R²C=CR², C≡C, Si(R²)₂, C=O, NR², O, S or CONR², or an aromatic or heteroaromatic ring system which has 5 to 24 aromatic ring atoms and may be substituted in each case by one or more R² radicals, or an aryloxy or heteroaryloxy group which has 5 to 24 aromatic ring atoms and may be substituted by one or more R² radicals; at the same time, two R³ radicals bonded to the same carbon atom together may form an aliphatic or aromatic ring system and thus form a spiro system; in addition, R³ with an adjacent R or R¹ radical may form an aliphatic ring system;
with the proviso that no two heteroatoms in these groups are bonded directly to one another and no two C=O groups are bonded directly to one another.

14. Oligomer, polymer or dendrimer containing one or more metal complexes according to one or more of Claims 1 to 13, wherein, rather than a hydrogen atom or a substituent, one or more bonds of the metal complex to the polymer, oligomer or dendrimer are present.

15. Formulation comprising at least one metal complex according to one or more of Claims 1 to 13, or at least one oligomer, polymer or dendrimer according to Claim 14, and at least one solvent.

16. Use of a metal complex according to one or more of Claims 1 to 13, or of an oligomer, polymer or dendrimer according to Claim 14, in an electronic device or as an oxygen sensitizer or as a photoinitiator or as a photocatalyst.

17. Electronic device comprising at least one metal complex according to one or more of Claims 1 to 13 or an oligomer, polymer or dendrimer according to Claim 14, wherein the electronic device is preferably selected from the group consisting of organic electroluminescent devices, organic integrated circuits, organic field-effect transistors, organic thin-film transistors, organic light-emitting transistors, organic solar cells, organic optical detectors, organic photoreceptors, organic field quench devices, light-emitting electrochemical cells, oxygen sensors, oxygen sensitizers and organic laser diodes.

18. Electronic device according to Claim 17, wherein the electronic device is an organic electroluminescent device, **characterized in that** the metal complex according to one or more of Claims 1 to 13 is used as emitting compound in one or more emitting layers or as hole transport compound in a hole injection or hole transport layer or as electron transport compound in an electron transport or hole blocking layer.

## Revendications

1. Complexe métallique monométallique contenant un ligand tripode hexadentate dans lequel trois ligands partiels bidentates coordinent à un métal et les trois ligands partiels bidentates, qui peuvent être identiques ou différents, sont reliés par un pont de formule (1) 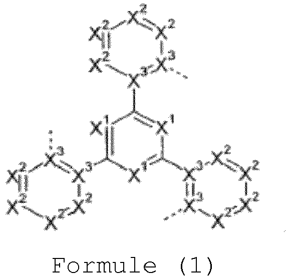 la liaison en pointillé représentant la liaison des ligands partiels bidentates à cette structure et les symboles utilisés valant :
X¹ identique ou différent en chaque occurrence, représentant C, qui peut également être substitué ou représentant N ;
X² identique ou différent en chaque occurrence, représentant C, qui peut également être substitué ou représentant N ou deux groupes adjacents X² représentant ensemble N, qui peut également être substitué, O ou S, de sorte à former un cycle à cinq chaînons ; ou deux groupes X² adjacents représentant ensemble C, qui peut également être substitué, ou représentant N, lorsque dans le cycle un des groupes X³ représente N, de sorte à former un cycle à cinq chaînons ; étant entendu qu'au maximum deux groupes adjacents X² dans chaque cycle représentent N ; des substituants éventuellement présents pouvant également former un système cyclique, ensemble ou avec des substituants liés à X¹ ;
X³ représentant, en chaque occurrence dans un cycle, C ou un groupe X³ représentant N et l'autre groupe X³ dans le même cycle représentant C, les groupes X³ dans les trois cycles pouvant être choisis indépendamment les uns des autres ; étant entendu que deux groupes adjacents X² représentent ensemble C, qui peut également être substitué, ou représentent ensemble N, lorsque dans un cycle un des groupes X³ représente N ;
les trois ligands bidentates pouvant également être refermés, autrement que par le pont de la formule (1), par un autre pont pour former un cryptate.

2. Complexe métallique selon la revendication 1, **caractérisé en ce que** lorsque X¹ et X² représentent un atome de carbone substitué, respectivement lorsque deux groupes X² adjacents représentent un atome d'azote substitué ou un atome de carbone substitué, le substituant est préférablement choisi parmi les substituants R suivants :
R identique ou différent en chaque occurrence représentant H, D, F, Cl, Br, I, N(R¹)₂, CN, NO₂, OH, COOH, C(=O)N(R¹)₂, Si(R1²)₃, B(OR¹)₂, C(=O)R¹, P(=O)(R¹)₂, S(=O)R¹, S(=O)₂R¹, OSO₂R¹, un groupe alkyle, alcoxyle ou thioalcoxyle linéaire comprenant 1 jusqu'à 20 atome(s) de carbone ou un groupe alcényle ou alcynyle comprenant 2 jusqu'à 20 atomes de carbone ou un groupe alkyle, alcoxyle ou thioalcoxyle ramifié ou cyclique comprenant 3 jusqu'à 20 atomes de carbone, le groupe alkyle, alcoxyle, thioalcoxyle, alcényle ou alcynyle pouvant à chaque fois être substitué par un ou plusieurs radical/radicaux R¹, un ou plusieurs groupe(s) CH₂ non adjacents pouvant être remplacé (s) par R¹C=CR¹, C≡C, Si(R¹)₂, C=O, NR¹, O, S ou CONR¹ ou un système cyclique aromatique ou hétéroaromatique comprenant 5 jusqu'à 40 atomes de cycle aromatique, qui peut à chaque fois être substitué par un ou plusieurs radical/radicaux R¹ ou un groupe aryloxyle ou hétéroaryloxyle comprenant 5 jusqu'à 40 atomes de cycle aromatique, qui peut être substitué par un ou plusieurs radical/radicaux R¹ ; deux radicaux R pouvant également former ensemble un système cyclique ;
R¹ identique ou différent en chaque occurrence représentant H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², un groupe alkyle, alcoxyle ou thioalcoxyle linéaire comprenant 1 jusqu'à 20 atome(s) de carbone ou un groupe alcényle ou alcynyle comprenant 2 jusqu'à 20 atomes de carbone ou un groupe alkyle, alcoxyle ou thioalcoxyle ramifié ou cyclique comprenant 3 jusqu'à 20 atomes de carbone, le groupe alkyle, alcoxyle, thioalcoxyle, alcényle ou alcynyle pouvant à chaque fois être substitué par un ou plusieurs radical/radicaux R², un ou plusieurs groupe(s) CH₂ non adjacents pouvant être remplacé(s) par R²C=CR², C≡C, Si(R²)₂, C=O, NR², O, S ou CONR² ou un système cyclique aromatique ou hétéroaromatique comprenant 5 jusqu'à 40 atomes de cycle aromatique, qui peut à chaque fois être substitué par un ou plusieurs radical/radicaux R² ou un groupe aryloxyle ou hétéroaryloxyle comprenant 5 jusqu'à 40 atomes de cycle aromatique, qui peut à chaque fois être substitué par un ou plusieurs radical/radicaux R² ; deux radicaux R¹ pouvant former ensemble un système cyclique ;
R² identique ou différent en chaque occurrence représentant H, D, F ou un radical organique aliphatique, aromatique et/ou hétéroaromatique, en particulier un radical hydrocarboné, comprenant 1 jusqu'à 20 atome(s) de carbone, dans lequel un ou plusieurs atome(s) d'H peut/peuvent être remplacé(s) par F.

3. Complexe métallique selon la revendication 1 ou 2, **caractérisé en ce que** le groupe de formule (1) est choisi parmi les structures des formules (2) jusqu'à (5), 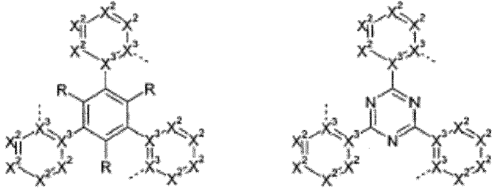 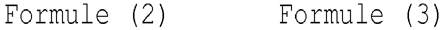 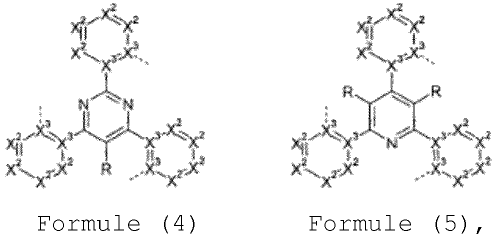 les symboles utilisés présentant les significations indiquées dans la revendication 1 et 2.

4. Complexe métallique selon l'une ou plusieurs des revendications 1 à 3, **caractérisé en ce que** le symbole X³ représente C et le groupe de formule (1) est choisi parmi les formules (2a) jusqu'à (5a) : 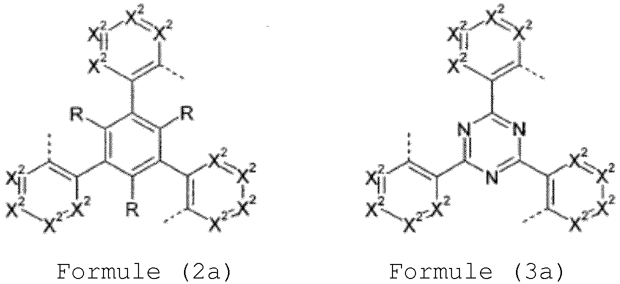 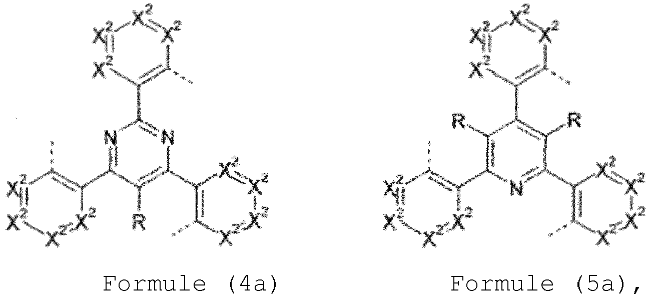 les symboles présentant les significations indiquées dans la revendication 1 et 2.

5. Complexe métallique selon l'une ou plusieurs des revendications 1 à 4, les groupes bivalents arylène et hétéroarylène dans l'unité de formule (1) jusqu'à (5), identiques ou différents en chaque occurrence, étant choisis parmi les formules (7) jusqu'à (31), 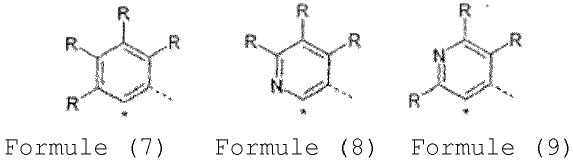 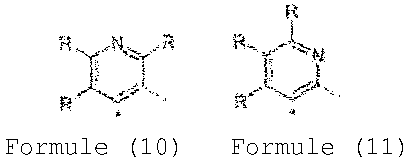 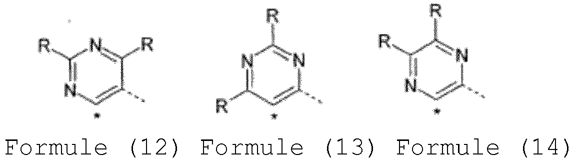 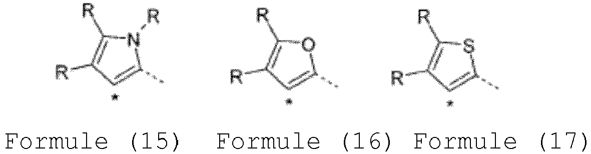 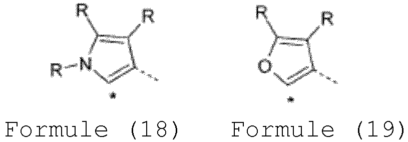 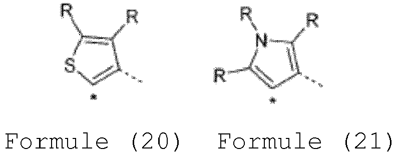 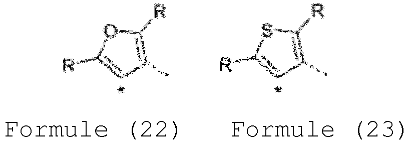 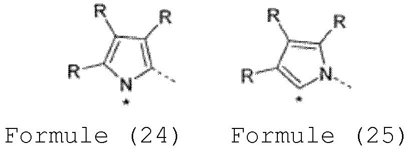 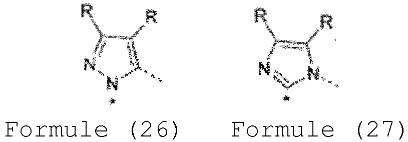 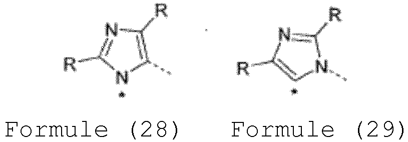 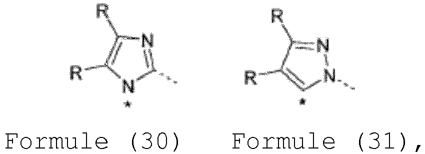 la liaison en pointillé représentant à chaque fois la position de la liaison avec le ligand partiel bidentate, * représentant la position de la liaison de l'unité avec le groupe central trivalent aryle ou hétéroaryle dans la formule (1) jusqu'à (5) et R présentant les significations indiquées dans la revendication 2.

6. Complexe métallique selon l'une ou plusieurs des revendications 1 à 5, **caractérisé en ce que** le groupe de formule (1) est choisi parmi les groupes des formules (2b) jusqu'à (5b), 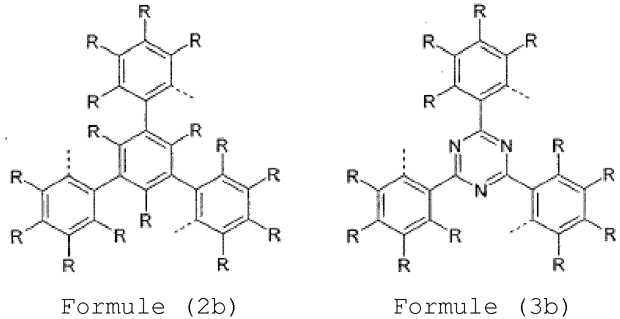 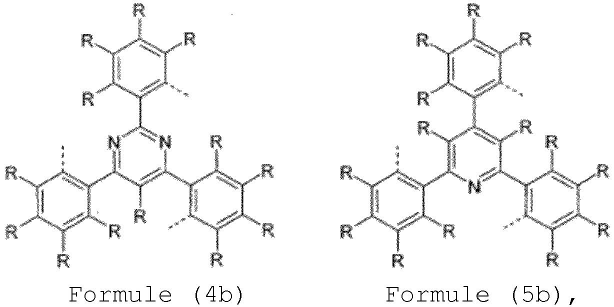 les symboles utilisés présentant les significations indiquées dans la revendication 2.

7. Complexe métallique selon l'une ou plusieurs des revendications 1 à 6, **caractérisé en ce que** les trois ligands partiels bidentates sont identiques ou deux des ligands partiels bidentates sont identiques et le troisième ligand partiel bidentate est différent des deux premiers ligands partiels bidentates.

8. Complexe métallique selon l'une ou plusieurs des revendications 1 à 7, **caractérisé en ce que** le métal est choisi dans le groupe constitué par l'aluminium, l'indium, le gallium et l'étain et **en ce que** les ligands partiels bidentates, identiques ou différents en chaque occurrence, présentent deux atomes d'azote ou deux atomes d'oxygène ou un atome d'azote et un atome d'oxygène en tant qu'atomes coordinants ou **en ce que** le métal est choisi dans le groupe constitué par le chrome, le molybdène, le tungstène, le rhénium, le ruthénium, l'osmium, le rhodium, l'iridium, le fer, le cobalt, le nickel, le palladium, le platine, le cuivre, l'argent et l'or et **en ce que** les ligands partiels bidentates, identiques ou différents en chaque occurrence, présentent un atome de carbone et un atome d'azote ou deux atomes de carbone ou deux atomes d'azote ou deux atomes d'oxygène ou un atome d'oxygène et un atome d'azote en tant qu'atomes coordinants.

9. Complexe métallique selon l'une ou plusieurs des revendications 1 à 8, **caractérisé en ce que** le métal est Ir(III) et deux des ligands partiels bidentates coordinent à l'iridium via à chaque fois un atome de carbone et un atome d'azote et le troisième des ligands partiels bidentate coordine à l'iridium via un atome de carbone et un atome d'azote ou via deux atomes d'azote ou via un atome d'azote et un atome d'oxygène ou via deux atomes d'oxygène.

10. Complexe métallique selon l'une ou plusieurs des revendications 1 à 9, **caractérisé en ce qu'**au moins un des ligands partiels bidentates représente une structure selon les formules (L-1), (L-2), (L-3) ou (L-4), 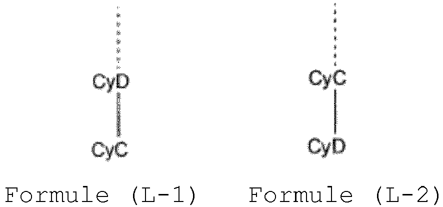 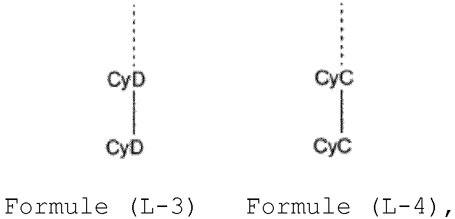 la liaison en pontillé représentant la liaison du ligand partiel aux ponts de la formule (1) et les symboles utilisés valant :
CyC identique ou différent en chaque occurrence représentant un groupe aryle ou hétéroaryle substitué ou non substitué comprenant 5 jusqu'à 14 atomes de cycle aromatique, coordinant au métal à chaque fois via d'un atome de carbone et étant lié à CyD par l'intermédiaire d'une liaison covalente dans (L-1) et (L-2) et étant lié à un autre groupe CyC par l'intermédiaire d'une liaison covalente dans (L-4) ;
CyD identique ou différent en chaque occurrence représentant un groupe hétéroaryle substitué ou non substitué comprenant 5 jusqu'à 14 atomes de cycle aromatique, coordinant au métal via un atome d'azote ou via un atome de carbone de type carbène et étant lié à CyC par l'intermédiaire d'une liaison covalente dans (L-1) et (L-2) et étant lié à un autre groupe CyD via une liaison covalente dans (L-3) ;
plusieurs des substituants éventuels pouvant former ensemble un système cyclique.

11. Complexe métallique selon la revendication 10, **caractérisé en ce que** CyC est choisi parmi les structures des formules (CyC-1) jusqu'à (CyC-19), le groupe CyC étant à chaque fois lié à CyD dans (L-1) et (L-2) ou, selon le cas, à CyC dans (L-4) à la position marquée par # et coordinant au métal à la position marquée par *, 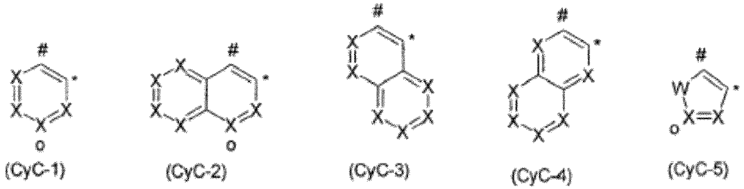 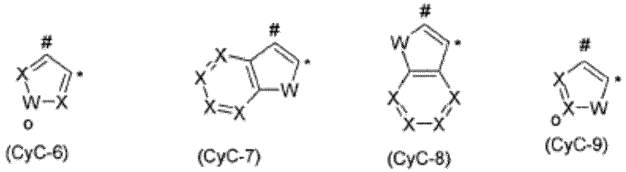 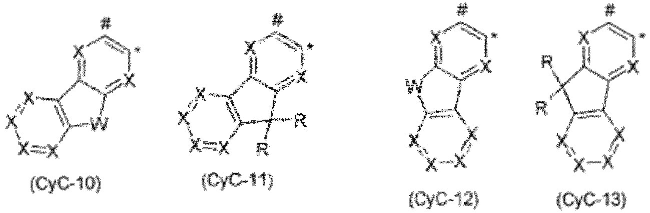 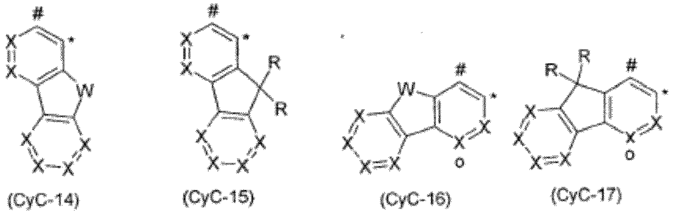 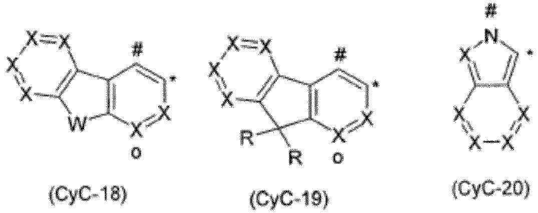 et **en ce que** CyD est choisi parmi les formules (CyD-1) jusqu'à (CyD-14), le groupe CyD étant à chaque fois lié à CyC dans (L-1) et (L-2) ou, selon le cas, à CyD dans (L-3) à la position marquée par # et coordinant au métal à la position marquée par *, 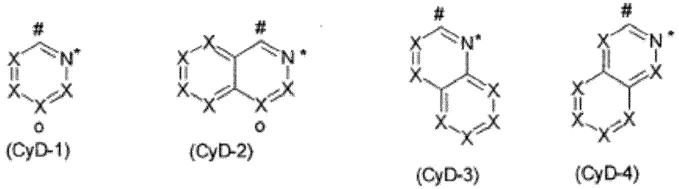 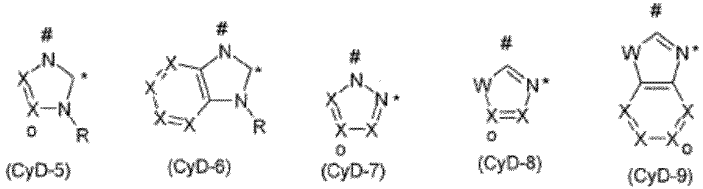 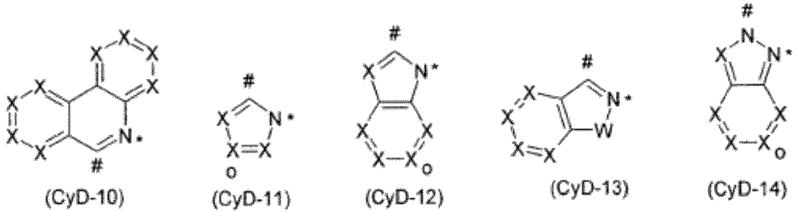 R présentant les significations indiquées dans la revendication 2 et les autres symboles utilisés valant :
X identique ou différent en chaque occurrence représentant CR ou N, étant entendu qu'au maximum deux symboles X par cycle représentent N ;
W identique ou différent en chaque occurrence représentant NR, O ou S ;
étant entendu que lorsque le pont de formule (1) est lié à CyC, un symbole X représente C et le pont de formule (1) est lié à cet atome de carbone et lorsque le pont de formule (1) est lié à CyD, un symbole X représente C et le pont de formule (1) est lié à cet atome de carbone, la liaison au pont de formule (1) ayant préférablement lieu à la position marquée par « o ».

12. Complexe métallique selon l'une ou plusieurs des revendications 1 à 11, **caractérisé en ce qu'**au moins un des ligands partiels bidentates est choisi parmi les structures des formules (L-1-1), (L-1-2) et (L-2-1) jusqu'à (L-2-3), 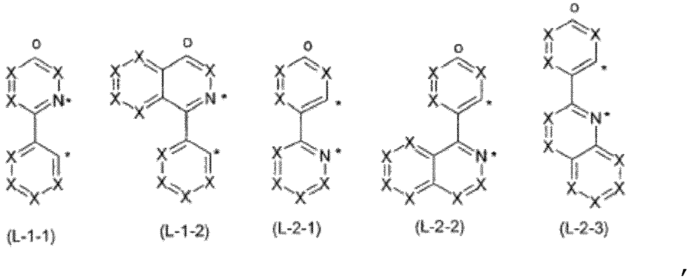 les symboles utilisés présentant les significations indiquées dans les revendications 2 et 11 et « o » représentant la position de la liaison au pont de formule (1) ;
et/ou **en ce qu'**au moins un des ligands partiels bidentates est choisi parmi les structures des formules (L-5) jusqu'à (L-32), 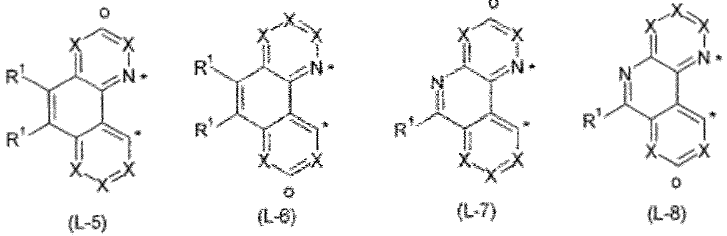 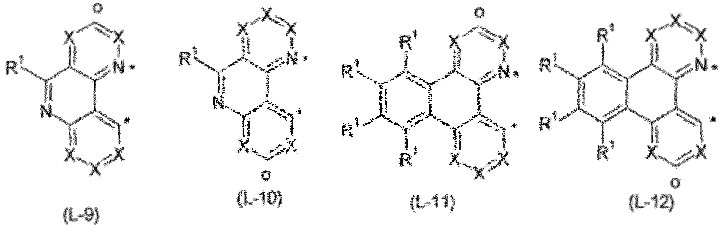 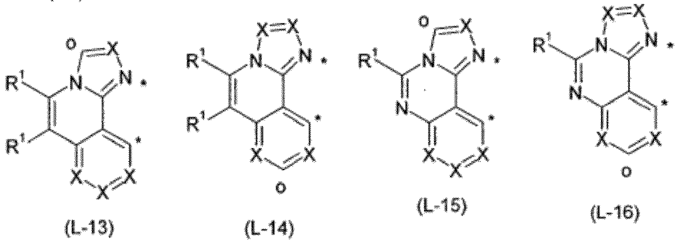 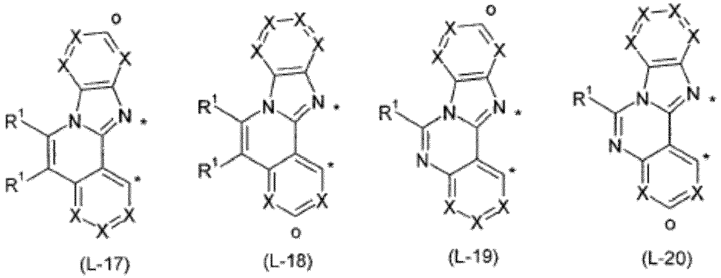 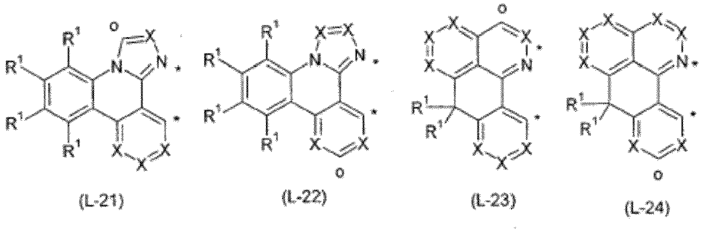 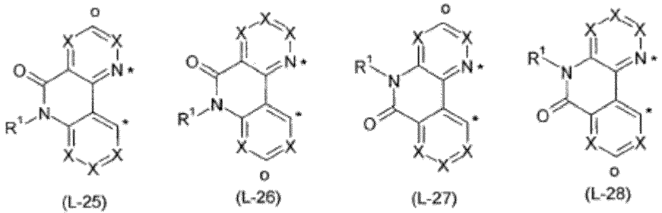 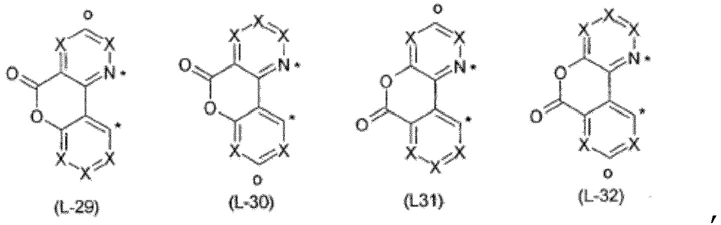 les symboles utilisés présentant les significations indiquées dans les revendications 2 et 11 et « o » indiquant la position à laquelle ce ligand partiels est lié au groupe de formule (1) ;
et/ou au moins un des ligands partiels bidentates est choisi parmi les structures des formules suivantes (L-33) et (L-34), 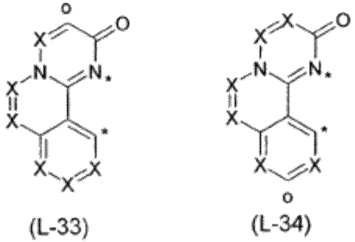 R présentant les significations indiquées dans la revendication 2, * représentant la position de la coordination au métal, « o » représentant la position de la liaison du ligand partiel au groupe de formule (1) et les autres symboles valant :
X identique ou différent en chaque occurrence représentant CR ou N, étant entendu qu'au maximum un symbole X par cycle représente N ;
et/ou **en ce qu'**au moins un des ligands partiels bidentates est choisi parmi les structures des formules suivantes (L-41) jusqu'à (L-44), 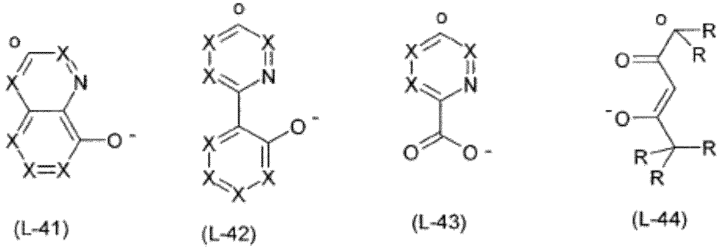 les ligands partiels (L-41) jusqu'à (L-43) coordinant au métal à chaque fois via l'atome d'azote explicitement indiqué et par l'atome d'oxygène chargé négativement et le ligand partiel (L-44) coordinant au métal via les deux atomes d'oxygène, X présentant les significations indiquées dans la revendication 11 et « o » indiquant la position par laquelle le ligand partiel est lié au groupe de formule (1).

13. Complexe métallique selon l'une ou plusieurs des revendications 1 à 12, **caractérisé en ce que** le complexe métallique présente deux substituants R et/ou deux substituants R¹ qui sont liés à des atomes de carbone adjacents et qui forment ensemble un cycle selon l'une des formules (43) jusqu'à (49), 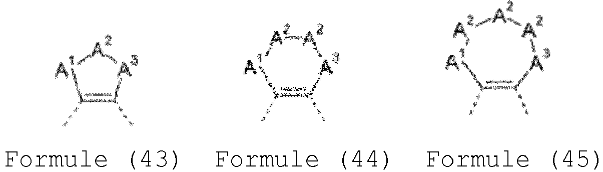 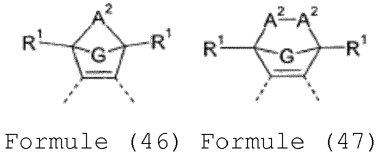 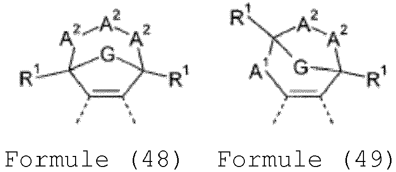 R¹ et R² présentant les significations indiquées dans la revendication 2, les liaisons en pointillé indiquant la liaison des deux atomes de carbone dans le ligand et de plus :
A¹, A³ identiques ou différents en chaque occurrence représentant C(R³)₂, O, S, NR³ ou C(=O) ;
A² représentant C(R¹)₂, O, S, NR³, ou (C=O) ;
G représentant un groupe alkyléne comprenant 1, 2 ou 3 atome(s) de carbone, qui peut être substitué par un ou plusieurs radical/radicaux R², -CR²=CR²- ou un groupe arylène ou hétéroarylène lié en ortho comprenant 5 jusqu'à 14 atomes de cycle aromatique, qui peut être substitué par un ou plusieurs radical/radicaux R² ;
R³ identique ou différent en chaque occurrence représentant H, F, un groupe alkyle ou alcoxyle linéaire comprenant 1 jusqu'à 10 atome(s) de carbone ou un groupe alkyle ou alcoxyle ramifié ou cyclique comprenant 3 jusqu'à 10 atomes de carbone, le groupe alkyle ou alcoxyle pouvant à chaque fois être substitué par un ou plusieurs radical/radicaux R², un ou plusieurs groupe(s) CH₂ non adjacents pouvant être remplacé(s) par R²C=CR², C≡C, Si(R²)₂, C=O, NR², O, S ou CONR², ou un système cyclique aromatique ou hétéroaromatique comprenant 5 jusqu'à 24 atomes de cycle aromatique, qui peut à chaque fois être substitué par un ou plusieurs radical/radicaux R², ou un groupe aryloxyle ou hétéroaryloxyle comprenant 5 jusqu'à 24 atomes de cycle aromatique, qui peut à chaque fois être substitué par un ou plusieurs radical/radicaux R² ; deux radicaux R³ liés au même atome de carbone pouvant également former ensemble un système cyclique aliphatique ou aromatique et ainsi définir un système de type spiro ; R³ peut de plus former un système cyclique aliphatique avec un radical adjacent R ou R¹ ;
étant entendu que dans ces groupes, deux hétéroatomes ne sont pas directement liés l'un à l'autre et que deux groupes C=O ne sont pas directement liés l'un à l'autre.

14. Oligomère, polymère ou dendrimère contenant un ou plusieurs complexe(s) métallique(s) selon l'une ou plusieurs des revendications 1 à 13, une ou plusieurs liaison(s) du complexe métallique au polymère, à l'oligomère ou au dendrimère étant présente(s) à la place d'un atome d'hydrogène ou d'un substituant.

15. Formulation, contenant au moins un complexe métallique selon l'une ou plusieurs des revendications 1 à 13 ou au moins un oligomère, un polymère ou un dendrimère selon la revendication 14 et au moins un solvant.

16. Utilisation d'un complexe métallique selon l'une ou plusieurs des revendications 1 à 13 ou d'un oligomère, d'un polymère ou d'un dendrimère selon la revendication 14 dans un dispositif électronique ou en tant que sensibilisateur d'oxygène ou en tant que photo-initiateur ou en tant que photocatalyseur.

17. Dispositif électronique contenant au moins un complexe métallique selon l'une ou plusieurs des revendication 1 à 13 ou un oligomère, un polymère ou un dendrimère selon la revendication 14, le dispositif électronique étant préférablement choisi dans le groupe constitué par les dispositifs électroluminescents organiques, les circuits imprimés organiques, les transistors à effet de champ, organiques, les transistors en couches minces organiques, les transistors luminescents organiques, les cellules solaires organiques, les détecteurs optiques organiques, les photorécepteurs organiques, les dispositifs d'extinction de champ, organiques, les cellules électrochimiques luminescentes, les détecteurs d'oxygène, les sensibilisateurs d'oxygène ou les diodes à laser, organiques.

18. Dispositif électronique selon la revendication 17, le dispositif électronique étant un dispositif électroluminescent organique, **caractérisé en ce que** le complexe métallique selon l'une ou plusieurs des revendications 1 à 13 est utilisé en tant que composé émetteur dans une ou plusieurs couche (s) émettrice(s) ou en tant que composé de transport de trou dans une couche d'injection de trou ou dans une couche de transport de trou ou en tant que composé de transport d'électrons dans une couche de transport d'électrons ou dans une couche de blocage de trou.
